# EUROPEAN PATENT APPLICATION

(11) **EP 4 106 032 A1**
(43) Date of publication of application: **21.12.2022**
(21) Application number: 22177369.0
(22) Date of filing: 06.06.2022
(51) Int. Cl.: H01L 51/50

(54) **LIGHT-EMITTING DEVICE AND ELECTRONIC APPARATUS INCLUDING THE SAME**

(30) Priority: 08.06.2021 KR 20210074303
(71) Applicant: Samsung Electronics Co., Ltd., Gyeonggi-do, 16677 (KR)
(72) Inventor: KWAK, Seungyeon, 16678 Suwon-si (KR); KANG, Byungjoon, 16678 Suwon-si (KR); KIM, Hyungjun, 16678 Suwon-si (KR); SIM, Myungsun, 16678 Suwon-si (KR); LEE, Kum Hee, 16678 Suwon-si (KR); LEE, Sunghun, 16678 Suwon-si (KR); CHOI, Byoungki, 16678 Suwon-si (KR)
(74) Representative: Elkington and Fife LLP

(57) **Abstract**

Provided are a light-emitting device and an electronic apparatus including the same. The light-emitting device includes a first electrode, a second electrode facing the first electrode, and an emission layer between the first electrode and the second electrode, wherein the first electrode is a reflective electrode, the emission layer includes i) a first emission layer, ii) a second emission layer, or a combination thereof, wherein when the first emission layer and the second emission layer are both present, then the second emission layer is located between the first emission layer and the second electrode, the first emission layer includes a first compound capable of emitting first light having a first spectrum, λP(1) is an emission peak wavelength (nm) of the first spectrum, the second emission layer includes a second compound capable of emitting second light having a second spectrum, λP(2) is an emission peak wavelength (nm) of the second spectrum, the emission layer may emit third light having a third spectrum, λP(3) is an emission peak wavelength (nm) of the third spectrum, λP(1) is less than λP(2), |λP(1) - λP(2)| is greater than 0 nm and less than or equal to 30 nm, and each of |λP(2) - λP(3)| and |λP(3) - λP(1)| is greater than or equal to 0 nm and less than or equal to 30 nm.

## Description

### FIELD OF THE INVENTION

The present disclosure relates to light-emitting devices and electronic apparatuses including the same.

### BACKGROUND OF THE INVENTION

From among light-emitting devices, organic light-emitting devices are self-emissive devices, which have improved characteristics in terms of viewing angles, response time, luminance, driving voltage, and response speed, and produce full-color images.

In an example, an organic light-emitting device may include an anode, a cathode, and an organic layer located between the anode and the cathode and including an emission layer. A hole transport region may be located between the anode and the emission layer, and an electron transport region may be located between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transition from an excited state to a ground state to thereby generate light.

### SUMMARY OF THE INVENTION

Provided are light-emitting devices having a novel emission layer and electronic apparatuses including the same.

Additional aspects will be set forth in part in the description, which follows and, in part, will be apparent from the description, or may be learned by practice of the presented embodiments of the disclosure.

According to an aspect of an embodiment, a light-emitting device includes
a first electrode,
a second electrode facing the first electrode, and
an emission layer between the first electrode and the second electrode, wherein
the first electrode is a reflective electrode,
the emission layer includes i) a first emission layer, and ii) a second emission layer between the first emission layer and the second electrode,
the first emission layer includes a first compound capable of emitting a first light having a first spectrum, and λP(1) is an emission peak wavelength in nm of the first spectrum,
the second emission layer includes a second compound capable of emitting a second light having a second spectrum, and λP(2) is an emission peak wavelength in nm of the second spectrum,
the emission layer emits a third light having a third spectrum, and λP(3) is an emission peak wavelength in nm of the third spectrum,
λP(1) is less than λP(2),
| λP(1) - λP(2)| is greater than 0 nm and less than or equal to about 30 nm,
each of |λP(2) - λP(3)| and |λP(3) - λP(1)| is greater than or equal to 0 nm and less than or equal to about 30 nm,
λP(1) and λP(2) are evaluated from photoluminescence spectra measured for a first film and a second film, respectively,
the first film includes the first compound,
the second film includes the second compound, and
λP(3) is evaluated from an electroluminescence spectrum of the light-emitting device.

According to an aspect of another embodiment, an electronic apparatus includes the light-emitting device.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 shows a schematic cross-sectional view of a light-emitting device according to an exemplary embodiment;
FIG. 2 is a diagram showing a voltage-current density graph of a light-emitting device A and a light-emitting device B manufactured in Evaluation Example 2; and
FIG. 3 is a diagram showing a curve 1 and curves C1 to C3, which are ClEx - luminescence efficiency curves of an OLED 1 and OLEDs C1 to C3, respectively.

### DETAILED DESCRIPTION OF THE EMBODIMENTS

Reference will now be made in detail to embodiments, examples of which are illustrated in the accompanying drawings, wherein like reference numerals refer to like elements throughout the specification. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a," "an," "the," and "at least one" do not denote a limitation of quantity, and are intended to cover both the singular and plural, unless the context clearly indicates otherwise. For example, "an element" has the same meaning as "at least one element," unless the context clearly indicates otherwise.

"Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

A light-emitting device according to an embodiment of the disclosure may include a first electrode, a second electrode facing the first electrode, and an emission layer between the first electrode and the second electrode.

The first electrode may be a reflective electrode.

The emission layer may include i) a first emission layer, and ii) a second emission layer between the first emission layer and the second electrode. In an embodiment, the first emission layer may be in direct contact with the second emission layer.

The first emission layer includes a first compound capable of emitting first light having a first spectrum, λP(1) is an emission peak wavelength (nm) of the first spectrum, the second emission layer includes a second compound capable of emitting second light having a second spectrum, λP(2) is an emission peak wavelength (nm) of the second spectrum, the emission layer may emit third light having a third spectrum, and λP(3) is an emission peak wavelength (nm) of the third spectrum.

λP(1) may be less than λP(2), |λP(1) - λP(2)| may be greater than 0 nm and less than or equal to about 30 nm, and each of |λP(2) - λP(3)| and |λP(3) - λP(1)| may be greater than or equal to 0 nm and less than or equal to about 30 nm.

|λP(1) - λP(2)|, |λP(2) - λP(3)|, and |λP(3) - λP(1)| are absolute values of λP(1) - λP(2), λP(2) - λP(3), and λP(3) - λP(1), respectively.

λP(1) and λP(2) may be evaluated from photoluminescence spectra measured for a first film and a second film, respectively.

In the present specification, the "first film" is a film including the first compound, and the "second film" is a film including the second compound. The first film and the second film may be manufactured using various methods such as any method known in the art, for example, a vacuum deposition method, a coating method, and heating method. The first film and the second film may further include other compounds, for example, a host described in the present specification, in addition to the first compound and the second compound.

For example, a method of evaluating λP(1) and λP(2) may be the same as described in Evaluation Example 1 in the present specification.

λP(3) is evaluated from an electroluminescence spectrum of the light-emitting device. In an embodiment, a method of evaluating λP(3) may be the same as described in Evaluation Example 3 in the present specification.

The third light may be extracted to the outside of the light-emitting device through the second electrode. In an embodiment, the second electrode may be a transparent electrode or a semi-transparent electrode.

A first region may exist between the emission layer and the first electrode of the light-emitting device.

In an embodiment, the first region may be a hole transport region.

In an embodiment, the first electrode may be an anode, and the second electrode may be a cathode.

Because the first electrode of the light-emitting device is a reflective electrode, the third light emitted from the emission layer may vibrate between the first electrode and the second electrode according to the principle of constructive interference, and may be extracted to the outside of the light-emitting device by a microcavity effect through the second electrode.

The microcavity effect for the third light generated from the emission layer has a close relationship with a resonance distance which is a distance between an "interface between the emission layer and the first region (e.g., hole transport region)" and an "interface between the first region (e.g., hole transport region) and the first electrode (e.g., anode)." An external extraction efficiency of light having an emission peak wavelength corresponding to the resonance distance is relatively high due to the microcavity effect, whereas an external extraction efficiency of light having an emission peak wavelength not corresponding to the resonance distance is not substantially affected by the microcavity effect and thus may be relatively low.

The resonance distance as described above may not always be kept constant due to deviations in a manufacturing process when a large number of the light-emitting devices are manufactured. This may cause a deviation in the emission color (i.e., light extracted toward the outside of the light-emitting device among the third light) between manufactured light-emitting devices, that is, a deviation in CIE coordinates (e.g., CIEx) and a deviation in luminescence efficiency. The deviation in luminescence efficiency according to the change in CIEx may be a factor impairing process stability in mass production of light-emitting devices.

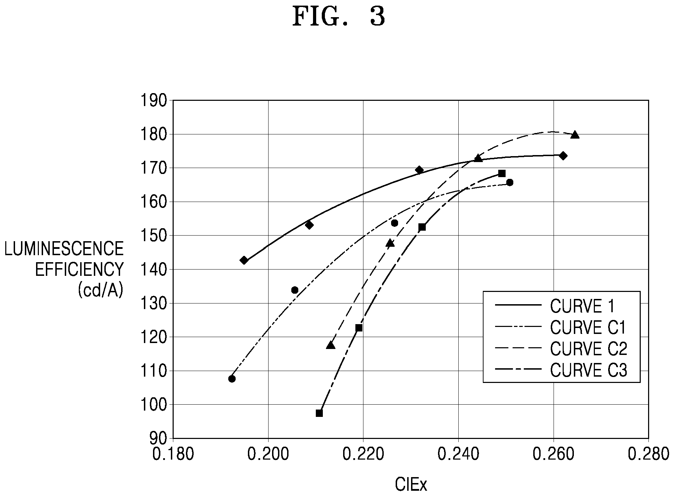

However, as described above, the first emission layer including the first compound having a smaller emission peak wavelength than that of the second compound is arranged closer to the first electrode than the second emission layer including the second compound, thereby reducing a resonance distance of the first light, which is a distance between an "interface between the first emission layer and the first region (e.g., hole transport region)" and an "interface between the first region (e.g., hole transport region) and the first electrode (e.g., anode)" and strengthening the resonance of the first light, and thus, the curvature of a CIEx-luminescence efficiency curve of the light-emitting device may be improved (i.e., becoming gentle) (e.g., see FIG. 3).

As described above, because the curvature of the CIEx-luminescence efficiency curve of the light-emitting device is improved, when the light-emitting device is mass-produced, a luminescence efficiency sensitivity according to emission color may be greatly improved, and thus a process deviation may be improved. Also, because the curvature of the CIEx-luminescence efficiency curve of the light-emitting device is improved, a phenomenon, in which light observed from the side of the light-emitting device (for example, a point shifted by 45° relative to the front) is blue-shifted compared to light observed from the front thereof and thus the light observed from the side of the light-emitting device has a relatively small luminescence efficiency, is substantially prevented, and the light-emitting device may have an excellent side luminance ratio (e.g., a ratio of luminance at a point shifted to the side by 45° relative to luminance at the front).

In an embodiment, |λP(1) - λP(2)| may be greater than 0 nm and less than or equal to about 20 nm.

In an embodiment, |λP(1) - λP(2)| may be greater than 0 nm and less than or equal to about 10 nm.

In an embodiment, each of |λP(2) - λP(3)| and |λP(3) - λP(1)| may be greater than or equal to 0 nm and less than or equal to about 15 nm.

In an embodiment, each of |λP(1) - λP(2)|, |λP(2) - λP(3)| and |λP(3) - λP(1)| may be greater than 0 nm and less than or equal to about 20 nm.

In an embodiment, each of |λP(1) - λP(2)|, |λP(2) - λP(3)|, and |λP(3) - λP(1)| may be greater than 0 nm and less than or equal to about 10 nm.

In an embodiment,
i) λP(1) < λP(2) ≤ λP(3),
ii) λP(1) ≤ λP(3) < λP(2),
iii) λP(1) < λP(3) ≤ λP(2), or
iv) λP(3) ≤ λP(1) < λP(2).

In an embodiment, each of λP(1), λP(2), and λP(3) may be about 500 nm to about 570 nm.

In an embodiment,
i) λP(1) may be about 510 nm to about 530 nm, λP(2) may be about 520 nm to about 540 nm, and λP(3) may be about 500 nm to about 540 nm, or
ii) λP(1) may be about 540 nm to about 560 nm, λP(2) may be about 550 nm to about 570 nm, and λP(3) may be about 540 nm to about 570 nm.

In an embodiment, each of λP(1), λP(2), and λP(3) may be about 570 nm to about 650 nm.

In an embodiment, λP(1) may be about 570 nm to about 630 nm, λP(2) may be about 620 nm to about 650 nm, and λP(3) may be about 570 nm to about 650 nm.

In an embodiment, each of λP(1), λP(2), and λP(3) may be about 400 nm to about 500 nm.

In an embodiment, λP(1) may be about 430 nm to about 480 nm, λP(2) may be about 470 nm to about 500 nm, and λP(3) may be about 400 nm to about 500 nm.

In an embodiment, the light-emitting device may satisfy Condition A:
Condition A
CD(1) < CD(2)
wherein, in Condition A,
CD(1) is a current density in mA/cm² of a first light-emitting device,
CD(2) is a current density in mA/cm² of a second light-emitting device,
CD(1) and CD(2) are evaluated by measuring current densities of the first light-emitting device and the second light-emitting device under the same voltage,
the first light-emitting device includes:
   the first electrode;
   the second electrode facing the first electrode; and
   an emission layer E1 between the first electrode and the second electrode,
   the emission layer E1 of the first light-emitting device includes the first emission layer,
   the emission layer E1 of the first light-emitting device does not include the second emission layer,
the second light-emitting device includes:
   the first electrode;
   the second electrode facing the first electrode; and
   an emission layer E2 between the first electrode and the second electrode,
   the emission layer E2 of the second light-emitting device does not include the first emission layer,
   the emission layer E2 of the second light-emitting device includes the second emission layer, and
   a structure of the first light-emitting device excluding the emission layer E1 and a structure of the second light-emitting device excluding the emission layer E2 are identical to each other.

By satisfying Condition A, when the light-emitting device is driven, an amount of excitons generated in the first emission layer may be greater than an amount of excitons generated in the second emission layer. Thus, the emission of the first light from the first emission layer becomes dominant over the emission of the second light from the second emission layer, and thus, the curvature of the CIEx-luminescence efficiency curve of the light-emitting device may become further improved (i.e., gentle), and the side luminance ratio of the light-emitting device may be further improved.

A detailed example of the first light-emitting device may be understood by referring to a light-emitting device A of Evaluation Example 2 below. A detailed example of the second light-emitting device may be understood by referring to a light-emitting device B of Evaluation Example 2 below.

A fourth light having a fourth spectrum may be extracted to the outside of the light-emitting device through the second electrode of the light-emitting device, and λP(OLED) is an emission peak wavelength (nm) of the fourth spectrum. In an embodiment, λP(OLED) may be evaluated from an electroluminescence spectrum of the light-emitting device.

In an embodiment, λP(3) and λP(OLED) may each independently be about 500 nm to about 570 nm.

In an embodiment, λP(3) and λP(OLED) may each independently be about 500 nm to about 540 nm.

In an embodiment, λP(3) and λP(OLED) may each independently be about 540 nm to about 570 nm.

In an embodiment, the third light and the fourth light may each be green light, yellow-green light, or yellow light.

In an embodiment, λP(3) and λP(OLED) may each independently be 570 nm to 650 nm.

In an embodiment, the third light and the fourth light may each be red light.

In an embodiment, λP(3) and λP(OLED) may each independently be 400 nm to 500 nm.

In an embodiment, the third light and the fourth light may each be blue light.

In an embodiment, the third light and the fourth light may not be white light.

In an embodiment, the third spectrum may include i) a main emission peak having λP(3), and may not include ii) an additional emission peak having an emission peak wavelength of λP(3) + about 50 nm or more or λP(3) - about 50 nm or less.

In an embodiment, the third spectrum may include i) a main emission peak having λP(3), and may not include ii) an additional emission peak having an emission peak wavelength of a red light and/or blue light region.

In an embodiment, the fourth spectrum may include i) a main emission peak having λP(OLED), and may not include ii) an additional emission peak having an emission peak wavelength of λP(OLED) + about 50 nm or more or λP(OLED) - about 50 nm or less.

In an embodiment, the fourth spectrum may include i) a main emission peak having λP(OLED), and may not include ii) an additional emission peak having an emission peak wavelength of red light and/or blue light region.

In an embodiment, the first compound may be an organometallic compound including a transition metal (e.g., iridium, platinum, osmium, etc.). In an embodiment, the first light may be phosphorescent light.

In an embodiment, the second compound may be an organometallic compound including a transition metal (e.g., iridium, platinum, osmium, etc.). In an embodiment, the second light may be phosphorescent light.

Each of the first compound and the second compound may include one transition metal.

Each of the first compound and the second compound may be electrically neutral.

In an embodiment, the first compound and the second compound may each independently be an organometallic compound including platinum or an organometallic compound including iridium.

In an embodiment, the first compound and the second compound may each be an organometallic compound including iridium, and the first compound and the second compound may be different from each other.

In an embodiment, the first compound and the second compound may each be a heteroleptic organometallic compound including iridium.

In an embodiment, the first compound and the second compound may each independently be:
i) an organometallic compound including platinum and a tetradentate ligand bonded to the platinum; or
ii) an organometallic compound including iridium and a first ligand, a second ligand, and a third ligand, each bonded to the iridium.

In an embodiment, the organometallic compound including platinum and a tetradentate ligand bonded to the platinum may be an organometallic compound including a) a chemical bond between a carbon atom of the tetradentate ligand and the platinum and b) a chemical bond between an oxygen (O) atom of the tetradentate ligand and the platinum.

In an embodiment, the organometallic compound including platinum and a tetradentate ligand bonded to the platinum may be an organometallic compound including a) a chemical bond between a carbon atom of the tetradentate ligand and the platinum and b) a chemical bond between a sulfur (S) atom of the tetradentate ligand and the platinum.

In an embodiment, a) the first ligand, the second ligand, and the third ligand may be identical to one another, b) the first ligand and the second ligand may be identical to each other, and the second ligand and the third ligand may be different from each other, or c) the first ligand, the second ligand, and the third ligand may be different from one another, and
the first ligand, the second ligand, and the third ligand may each be:
a bidentate ligand bonded to the iridium through two nitrogen atoms;
a bidentate ligand bonded to the iridium through a nitrogen atom and a carbon atom; or
a bidentate ligand bonded to the iridium through two carbon atoms.

In an embodiment, the first ligand, the second ligand, and the third ligand may each be a bidentate ligand bonded to the iridium through a nitrogen atom and a carbon atom.

In an embodiment, the first compound and the second compound may each independently be an organometallic compound represented by Formula 1 or an organometallic compound represented by Formula 2:

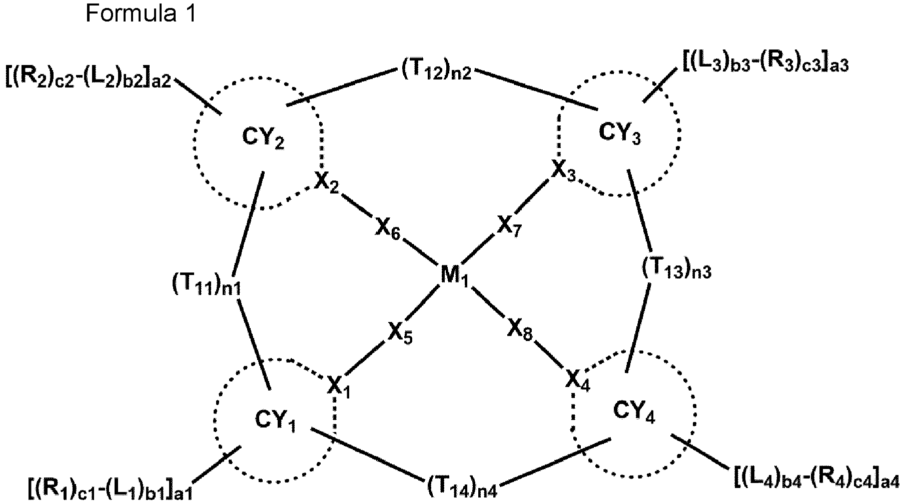

Formula 2 M₂(L₁₁)ₙ₁₁(L₁₂)ₙ₁₂(L₁₃)ₙ₁₃

wherein, M₁ in Formula 1 is platinum (Pt), and M₂ in Formula 2 is iridium (Ir).

L₁₁ in Formula 2 may be a ligand represented by Formula 2-1, L₁₂ may be a ligand represented by Formula 2-2, and L₁₃ may be a ligand represented by Formula 2-1 or 2-2: 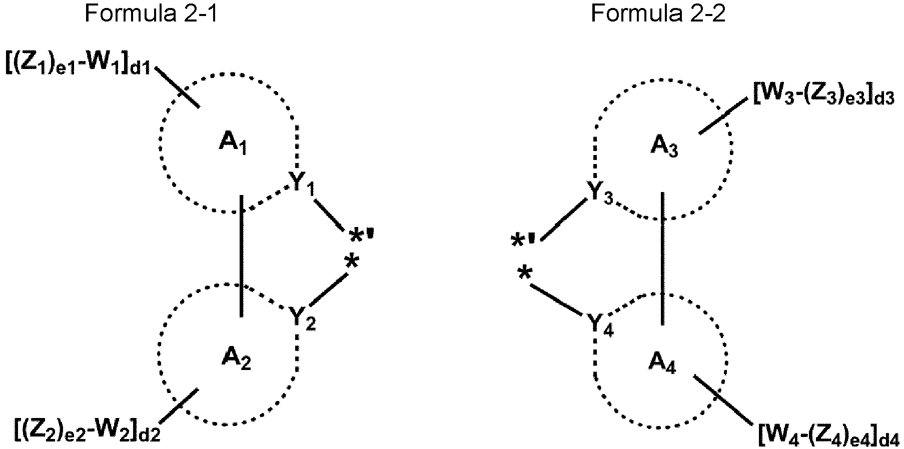 wherein, Formulae 2-1 and 2-2 are the same as described in the present specification.
L₁₁ and L₁₂ in Formula 2 may be different from each other.
n11 to n13 in Formula 2 may each indicate numbers of L₁₁ to L₁₃, respectively, wherein n11, n12, and n13 may each independently be 0, 1, 2, or 3, and the sum of n11, n12, and n13 may be 3.

In an embodiment, in Formula 2, n11 may be 1, 2, or 3, and n12 and n13 may each independently be 0, 1, or 2.

In an embodiment, in Formula 2, n12 may be 1, 2, or 3, and n11 and n13 may each independently be 0, 1, or 2.

In an embodiment, n11 may be 1, n12 may be 2, and n13 may be 0.

In an embodiment, n11 may be 2, n12 may be 1, and n13 may be 0.

In an embodiment, n11 may be 3, and n12 and n13 may each be 0.

In an embodiment, n12 may be 3, and n11 and n13 may each be 0.

The organometallic compound represented by Formula 2 may be a heteroleptic complex or a homoleptic complex.

In an embodiment, the organometallic compound represented by Formula 2 may be a heteroleptic complex.

X₁ to X₄ and Y₁ to Y₄ in Formulae 1, 2-1, and 2-2 may each independently be C or N.

In an embodiment, at least one of X₁ to X₄ in Formula 1 may be C.

In an embodiment, X₁ in Formula 1 may be C.

In an embodiment, in Formula 1, i) X₁ and X₃ may each be C, and X₂ and X₄ may each be N, or ii) X₁ and X₄ may each be C, and X₂ and X₃ may each be N.

In an embodiment, in Formulae 2-1 and 2-2, Y₁ and Y₃ may each be N, and Y₂ and Y₄ may each be C.

X₅ to X₈ in Formula 1 may each independently be a chemical bond, O, S, N(R'), C(R')(R"), or C(=O), wherein at least one of X₅ to X₈ may not be a chemical bond. R' and R" are each the same as described in the present specification.

In an embodiment, X₅ in Formula 1 may not be a chemical bond.

In an embodiment, X₅ in Formula 1 may be 0 or S.

In an embodiment, in Formula 1, X₅ may be O or S, and X₆ to X₈ may each be a chemical bond.

Regarding Formula 1, two of a bond between X₅ or X₁ and M₁, a bond between X₆ or X₂ and M₁, a bond between X₇ or X₃ and M₁, and a bond between X₈ or X₄ and M₁ may each be a coordinate bond, and the other two may each be a covalent bond.

In an embodiment, a bond between X₂ and M₁ in Formula 1 may be a coordinate bond.

In an embodiment, regarding Formula 1, a bond between X₅ or X₁ and M₁ and a bond between X₃ and M₁ may each be a covalent bond, and a bond between X₂ and M₁ and a bond between X₄ and M₁ may each be a coordinate bond.

Ring CY₁ to ring CY₄ and ring A₁ to ring A₄ in Formulae 1, 2-1, and 2-2 may each independently be a C₅-C₃₀ carbocyclic group or a C₁-C₃₀ heterocyclic group.

In an embodiment, in Formula 1, ring CY₁, ring CY₃, and ring CY₄ may each not be a benzimidazole group.

In an embodiment, ring CY₁ to ring CY₄ and ring A₁ to ring A₄ in Formulae 1, 2-1, and 2-2 may each independently be i) a first ring, ii) a second ring, iii) a condensed ring in which two or more first rings are condensed with each other, iv) a condensed ring in which two or more second rings are condensed with each other, or v) a condensed ring in which at least one first ring and at least one second ring are condensed with each other,
the first ring may be a cyclopentane group, a cyclopentene group, a cyclopentadiene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a piperidine group, a cyclohexane group, a cyclohexene group, a benzene group, a pyridine group, a pyrimidine group, a pyrazine group, a pyridazine group, or a triazine group.

In an embodiment, ring CY₁ to ring CY₄ and ring A₁ to ring A₄ in Formulae 1, 2-1, and 2-2 may each independently be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a pyrrole group, a furan group, a thiophene group, a silole group, a borole group, a phosphole group, a germole group, a selenophene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluorene-9-one group, a dibenzothiophene 5,5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, an imidazole group, a triazole group, an oxazole group, an iso-oxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a pyridinopyrrole group, a pyridinopyrazole group, a pyridinoimidazole group, a pyridinooxazole group, a pyridinoisoxazole group, a pyridinothiazole group, a pyridinoisothiazole group, a pyridinooxadiazole group, a pyridinothiadiazole group, a pyrimidinopyrrole group, a pyrimidinopyrazole group, a pyrimidinoimidazole group, a pyrimidinooxazole group, a pyrimidinoisoxazole group, a pyrimidinothiazole group, a pyrimidinoisothiazole group, a pyrimidinooxadiazole group, a pyrimidinothiadiazole group, a naphthopyrrole group, a naphthopyrazole group, a naphthoimidazole group, a naphthooxazole group, a naphthoisoxazole group, a naphthothiazole group, a naphthoisothiazole group, a naphthooxadiazole group, a naphthothiadiazole group, a phenanthrenopyrrole group, a phenanthrenopyrazole group, a phenanthrenoimidazole group, a phenanthrenooxazole group, a phenanthrenoisoxazole group, a phenanthrenothiazole group, a phenanthrenoisothiazole group, a phenanthrenooxadiazole group, a phenanthrenothiadiazole group, a 5,6,7,8-tetrahydroisoquinoline group, a 5,6,7,8-tetrahydroquinoline group, an adamantane group, a norbornane group, a norbornene group, a benzene group condensed with a cyclohexane group, a benzene group condensed with a norbornane group, a pyridine group condensed with a cyclohexane group, or a pyridine group condensed with a norbornane group.

In an embodiment, ring CY₁ and ring CY₃ in Formula 1 may each independently be:
a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each condensed with a cyclohexane group, a cyclohexene group, a norbornane group, a piperidine group, or any combination thereof.

In an embodiment, ring CY₂ in Formula 1 may be:
an imidazole group, a benzimidazole group, a pyridine group, a pyrimidine group, a pyridazine group, a pyrazine group, a triazine group, a quinoline group, an isoquinoline group, a quinoxaline group, or a quinazoline group; or
an imidazole group, a benzimidazole group, a pyridine group, a pyrimidine group, a pyridazine group, a pyrazine group, a triazine group, a quinoline group, an isoquinoline group, a quinoxaline group, or a quinazoline group, each condensed with a cyclohexane group, a cyclohexene group, a norbornane group, a benzene group, a pyridine group, a pyrimidine group, or any combination thereof.

In an embodiment, ring CY₄ in Formula 1 may be:
a pyridine group, a pyrimidine group, a pyridazine group, a pyrazine group, a triazine group, a quinoline group, an isoquinoline group, a quinoxaline group, a quinazoline group, an azadibenzofuran group, an azadibenzothiophene group, an azadibenzoselenophene group, an azacarbazole group, an azafluorene group, or an azadibenzosilole group; or
a pyridine group, a pyrimidine group, a pyridazine group, a pyrazine group, a triazine group, a quinoline group, an isoquinoline group, a quinoxaline group, a quinazoline group, an azadibenzofuran group, an azadibenzothiophene group, an azadibenzoselenophene group, an azacarbazole group, an azafluorene group, or an azadibenzosilole group, each condensed with a cyclohexane group, a cyclohexene group, a norbornane group, a benzene group, a pyridine group, a pyrimidine group, or any combination thereof.

Ring A₁ and ring A₃ in Formulae 2-1 and 2-2 may be different from each other.

In an embodiment, a Y₁-containing monocyclic group in ring A₁, a Y₂-containing monocyclic group in ring A₂, and a Y₄-containing monocyclic group in ring A₄ may each be a 6-membered ring.

In an embodiment, a Y₃-containing monocyclic group in ring A₃ may be a 6-membered ring.

In an embodiment, a Y₃-containing monocyclic group in ring A₃ may be a 5-membered ring.

In an embodiment, a Y₁-containing monocyclic group in ring A₁ may be a 6-membered ring, and a Y₃-containing monocyclic group in ring A₃ may be a 5-membered ring.

In an embodiment, ring A₁ and ring A₃ in Formulae 2-1 and 2-2 may each independently be i) an A group, ii) a polycyclic group in which two or more A groups are condensed with each other, or iii) a polycyclic group in which at least one A group and at least one B group are condensed with each other,
the A group may be a pyridine group, a pyrimidine group, a pyridazine group, a pyrazine group, or a triazine group, and
the B group may be a cyclohexane group, a cyclohexene group, a norbornane group, a benzene group, a furan group, a thiophene group, a selenophene group, a pyrrole group, a cyclopentadiene group, or a silole group.

In an embodiment, in Formula 2-2, ring A₃ may be i) a C group, ii) a polycyclic group in which two or more C groups are condensed with each other, or iii) a polycyclic group in which at least one C group and at least one D group are condensed with each other,
the C group may be a pyrrole group, a pyrazole group, an imidazole group, a triazole group, an oxazole group, an isoxazole group, a thiazole group, or an isothiazole group, and
the D group may be a cyclohexane group, a cyclohexene group, a norbornane group, a benzene group, a furan group, a thiophene group, a selenophene group, a cyclopentadiene group, a silole group, a pyridine group, a pyrimidine group, a pyridazine group, a pyrazine group, or a triazine group. In an embodiment, ring A₁ in Formula 2-1 may be:
   a pyridine group, a pyrimidine group, a pyridazine group, or a pyrazine group; or
   a pyridine group, a pyrimidine group, a pyridazine group, or a pyrazine group, each condensed with a cyclohexane group, a norbornane group, a benzene group, or any combination thereof.

In an embodiment, ring A₃ in Formula 2-2 may be:
a pyridine group, a pyrimidine group, a pyridazine group, or a pyrazine group;
a pyridine group, a pyrimidine group, a pyridazine group, or a pyrazine group, each condensed with a cyclohexane group, a norbornane group, a benzene group, or any combination thereof; or
an imidazole group, a benzimidazole group, a naphthoimidazole group, a phenanthrenoimidazole group, a pyridoimidazole group, an oxazole group, a benzoxazole group, a naphthooxazole group, a phenanthrenooxazole group, a pyridooxazole group, a thiazole group, a benzothiazole group, a naphthothiazole group, a phenanthrenothiazole group, or a pyridothiazole group.

In an embodiment, ring A₂ and ring A₄ in Formulae 2-1 and 2-2 may be different from each other.

In an embodiment, ring A₂ and ring A₄ in Formulae 2-1 and 2-2 may each independently be i) an E group, ii) a polycyclic group in which two or more E groups are condensed with each other, or iii) a polycyclic group in which at least one E group and at least one F group are condensed with each other,
the E group may be a benzene group, a pyridine group, a pyrimidine group, a pyridazine group, a pyrazine group, or a triazine group, and
the F group may be a furan group, a thiophene group, a selenophene group, a pyrrole group, a cyclopentadiene group, a silole group, a pyrazole group, an imidazole group, an oxazole group, a thiazole group, an isoxazole group, or an isothiazole group.

In an embodiment, ring A₂ in Formula 2-1 may be a polycyclic group in which two or more E groups and at least one F group are condensed with each other.

In an embodiment, ring A₄ in Formula 2-2 may be a polycyclic group in which two or more E groups and at least one F group are condensed with each other.

In an embodiment, ring A₂ in Formula 2-1 may be:
a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each condensed with a cyclohexane group, a norbornane group, a benzene group, or any combination thereof.

In an embodiment, ring A₄ in Formula 2-2 may be:
a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or a dibenzosilole group; or
a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or a dibenzosilole group, each condensed with a benzene group, a pyridine group, a pyrimidine group, a pyridazine group, a pyrazine group, a cyclohexane group, a norbornane group, a furan group, a thiophene group, a selenophene group, a pyrrole group, a cyclopentadiene group, a silole group, a pyrazole group, an imidazole group, an oxazole group, a thiazole group, an isoxazole group, an isothiazole group, or any combination thereof.

T₁₁ to T₁₄ in Formula 1 may each independently be a single bond, a double bond, *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', *-Se-*', *-O-*', *-C(=O)-*', *-S(=O)-*', *-S(=O)2-*', *-C(R₅ₐ)=*', *=C(R₅ₐ)-*', *-C(R₅ₐ)=C(R_{5b})-*', *-C(=S)-*', *-C=C-*', a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

In an embodiment, T₁₁ and T₁₂ in Formula 1 may be a single bond, and T₁₃ may be a single bond, *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', or *-O-*'.

n1 to n4 in Formula 1 indicate numbers of T₁₁ to T₁₄, respectively, and may each independently be 0 or 1, wherein three or more of n1 to n4 may each be 1. That is, an organometallic compound represented by Formula 1 may have a tetradentate ligand.

When n1 in Formula 1 is 0, T₁₁ may not exist (i.e., ring CY₁ and ring CY₂ are not connected to each other), when n2 is 0, T₁₂ may not exist (i.e., ring CY₂ and ring CY₃ are not connected to each other), when n3 is 0, T₁₃ may not exist (i.e., ring CY₃ and ring CY₄ are not connected to each other), and when n4 is 0, T₁₄ may not exist (i.e., ring CY₄ and ring CY₁ are not connected to each other).

In an embodiment, n1 to n3 in Formula 1 may each be 1, and n4 may be 0.

L₁ to L₄ and W₁ to W₄ in Formulae 1, 2-1, and 2-2 may each independently be a single bond, a C₁-C₂₀ alkylene group that is unsubstituted or substituted with at least one R₁₀ₐ, a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

In an embodiment, L₁ to L₄ and W₁ to W₄ in Formulae 1, 2-1, and 2-2 may each independently be:
a single bond; or
a C₁-C₂₀ alkylene group, a cyclopentene group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an iso-oxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group, each unsubstituted or substituted with at least one R₁₀ₐ.

In an embodiment, L₁ to L₄ and W₁ to W₄ in Formulae 1, 2-1, and 2-2 may each independently be:
a single bond; or
a benzene group, a naphthalene group, a pyridine group, a fluorene group, a carbazole group, a dibenzofuran group, or a dibenzothiophene group, each unsubstituted or substituted with at least one R₁₀ₐ.

In an embodiment, L₁ to L₄ and W₁ to W₄ in Formulae 1, 2-1, and 2-2 may each independently be:
a single bond; or
a C₁-C₂₀ alkylene group, a benzene group, a naphthalene group, a dibenzofuran group, or a dibenzothiophene group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof.

b1 to b4 in Formula 1 indicate number of L₁ to L₄, respectively, and may each independently be an integer from 1 to 10. When b1 is 2 or more, two or more of L₁(s) may be identical to or different from each other, when b2 is 2 or more, two or more of L₂(s) may be identical to or different from each other, when b3 is 2 or more, two or more of L₃(s) may be identical to or different from each other, and when b4 is 2 or more, two or more of L₄(s) may be identical to or different from each other. In an embodiment, b1 to b4 may each independently be 1, 2, or 3.

R₁ to R₄, R₅ₐ, R_{5b}, R', R", and Z₁ to Z₄ in Formulae 1, 2-1, and 2-2 may each independently be hydrogen, deuterium, -F, -CI, -Br, -I, -SFs, a hydroxyl group, a cyano group, a nitro group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), - P(=O)(Q₈)(Q₉), or -P(Q₈)(Q₉). Q₁ to Q₉ are each the same as described in the present specification.

In an embodiment, R₁ to R₄, R₅ₐ, R_{5b}, R', R", and Z₁ to Z₄ in Formulae 1, 2-1, and 2-2 may each independently be:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SFs, a C₁-C₂₀ alkyl group, a C₂-C₂₀ alkenyl group, a C₁-C₂₀ alkoxy group, or a C₁-C₂₀ alkylthio group;
a C₁-C₂₀ alkyl group, a C₂-C₂₀ alkenyl group, a C₁-C₂₀ alkoxy group, or a C₁-C₂₀ alkylthio group, each substituted with deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group (e.g., a bicyclo[2.2.1]heptyl group), a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₁-C₂₀ alkyl group, a fluorinated C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a deuterated phenyl group, a fluorinated phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or any combination thereof; or
-N(Q₁)(Q₂), -Si(Q₃)(Q₄)(Q₅), -Ge(Q3)(Q4)(Q5), -B(Q6)(Q7), - P(=O)(Q₃)(Q₉), or -P(Q₈)(Q₉),
wherein Q₁ to Q₉ may each independently be:
   deuterium, -F, -CH₃, -CD₃, -CD₂H, -CDH₂, -CH₂CH₃, -CH₂CD₃, - CH₂CD₂H, -CH₂CDH₂, -CHDCH₃, -CHDCD₂H, -CHDCDH₂, -CHDCD₃, - CD₂CD₃, -CD₂CD₂H, -CD₂CDH₂, -CF₃, -CF₂H, -CFH₂, -CH₂CF₃, -CH₂CF₂H, - CH₂CFH₂, -CHFCH₃, -CHFCF₂H, -CHFCFH₂, -CHFCF₃, -CF₂CF₃, -CF₂CF₂H, or -CF₂CFH₂; or
   an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, -F, a C₁-C₁₀ alkyl group, a phenyl group, or any combination thereof.

In an embodiment, R₁ to R₄, R₅ₐ, R_{5b}, R', R", and Z₁ to Z₄ in Formulae 1, 2-1, and 2-2 may each independently be:
hydrogen, deuterium, -F, or a cyano group;
a C₁-C₂₀ alkyl group that is unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof;
a C₃-C₁₀ cycloalkyl group, a C₁-C₁₀ a heterocycloalkyl group, a phenyl group, a biphenyl group, a naphthyl group, a pyridinyl group, a fluorenyl group, a carbazolyl group, a dibenzofuranyl group, or a dibenzothiophenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₁-C₂₀ alkoxy group, a deuterated C₁-C₂₀ alkoxy group, a fluorinated C₁-C₂₀ alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof; or
-Si(Q3)(Q4)(Q5) or -Ge(Q3)(Q4)(Q5).

In an embodiment, e1 and d1 in Formula 2-1 may each not be 0, and at least one of Z₁(s) may be a deuterated C₁-C₂₀ alkyl group, -Si(Q₃)(Q₄)(Q₅), or - Ge(Q₃)(Q₄)(Q₅). Q₃ to Q₅ are each the same as described in the present specification.

In an embodiment, Q₃ to Q₅ may each independently be:
a C₁-C₆₀ alkyl group unsubstituted or substituted with deuterium, a C₁-C₆₀ alkyl group, a C₆-C₆₀ aryl group, or any combination thereof; or
a C₆-C₆₀ aryl group unsubstituted or substituted with deuterium, a C₁-C₆₀ alkyl group, a C₆-C₆₀ aryl group, or any combination thereof.

In an embodiment, Q₃ to Q₅ may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or any combination thereof.

In an embodiment, Q₃ to Q₅ may be identical to each other.

In an embodiment, two or more of Q₃ to Q₅ may be different from each other.

In an embodiment, the organometallic compound represented by Formula 2 may satisfy at least one of Condition (1) to Condition (8):
Condition (1)
   e1 and d1 in Formula 2-1 are each not 0, and at least one Z₁(s) includes deuterium;
Condition (2)
   e2 and d2 in Formula 2-1 are each not 0, and at least one Z₂(s) includes deuterium;
Condition (3)
   e3 and d3 in Formula 2-2 are each not 0, and at least one Z₃(s) includes deuterium;
Condition (4)
   e4 and d4 in Formula 2-2 are each not 0, and at least one Z₄(s) includes deuterium;
Condition (5)
   e1 and d1 in Formula 2-1 are each not 0, and at least one Z₁(s) includes a fluoro; group
Condition (6)
   e2 and d2 in Formula 2-1 are each not 0, and at least one Z₂(s) includes a fluoro group;
Condition (7)
   e3 and d3 in Formula 2-2 are each not 0, and at least one Z₃(s) includes a fluoro group;
Condition (8)
   e4 and d4 in Formula 2-2 are each not 0, and at least one Z₄(s) includes a fluoro group.

In an embodiment, R₁ to R₄, R₅ₐ, R_{5b}, R', R", and Z₁ to Z₄ in Formulae 1, 2-1, and 2-2 may each independently be hydrogen, deuterium, -F, -CH₃, -CD₃, -CD₂H, - CDH₂, -CF₃, -CF₂H, -CFH₂, a C₂-C₁₀ alkenyl group, a C₁-C₁₀ alkoxy group, a C₁-C₁₀ alkylthio group, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-227, a group represented by one of Formulae 9-201 to 9-227 in which at least one hydrogen is substituted with deuterium, a group represented by one of Formulae 9-201 to 9-227 in which at least one hydrogen is substituted with -F, a group represented by one of Formulae 10-1 to 10-129, a group represented by one of Formulae 10-1 to 10-129 in which at least one hydrogen is substituted with deuterium, a group represented by one of Formulae 10-1 to 10-129 in which at least one hydrogen is substituted with -F, a group represented by one of Formulae 10-201 to 10-350, a group represented by one of Formulae 10-201 to 10-350 in which at least one hydrogen is substituted with deuterium, a group represented by one of Formulae 10-201 to 10-350 in which at least one hydrogen is substituted with -F, -Si(Q₃)(Q₄)(Q₅), or -Ge(Q₃)(Q₄)(Q₅) (where Q₃ to Q₅ are each the same as described in the present specification):

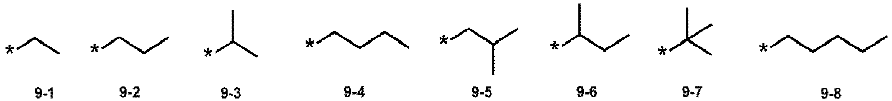

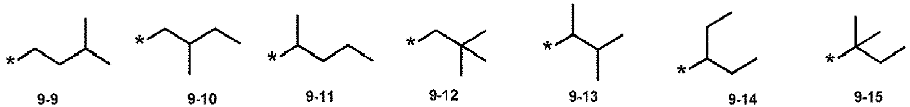

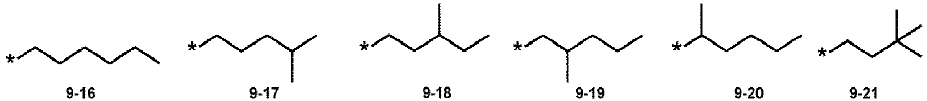

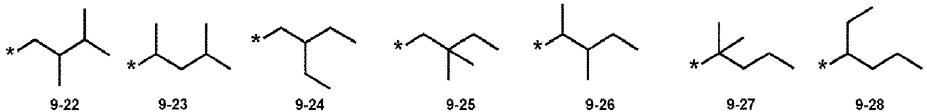

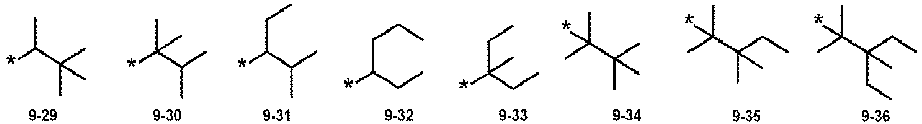

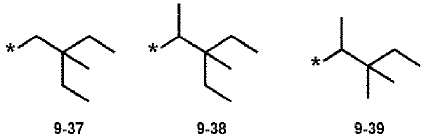

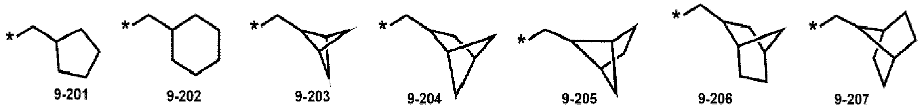

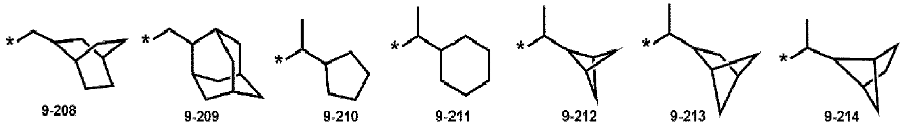

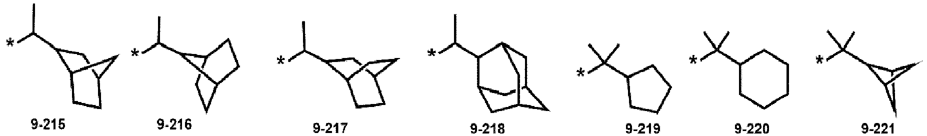

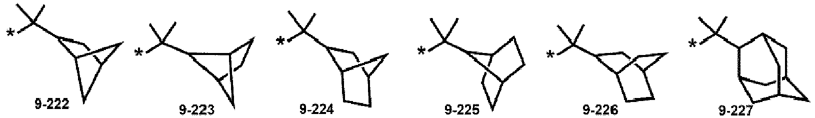

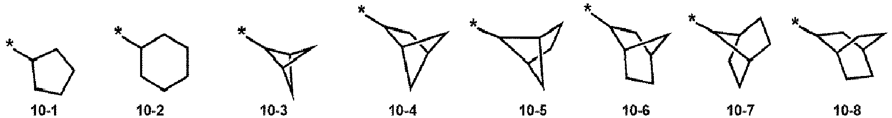

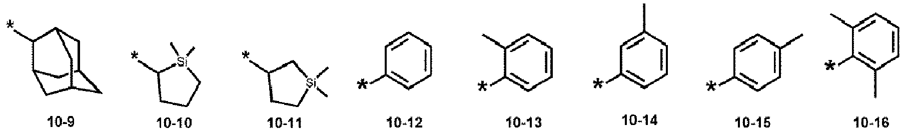

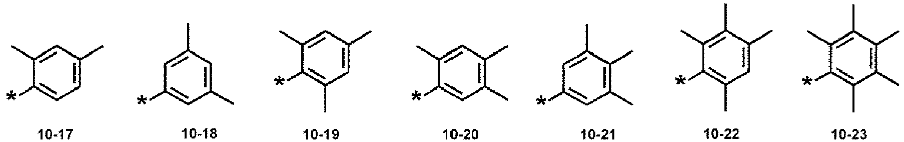

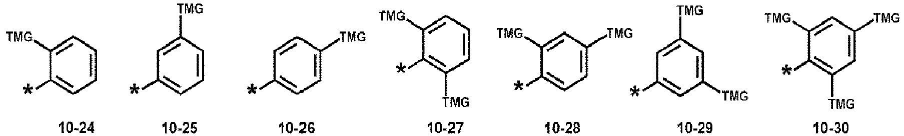

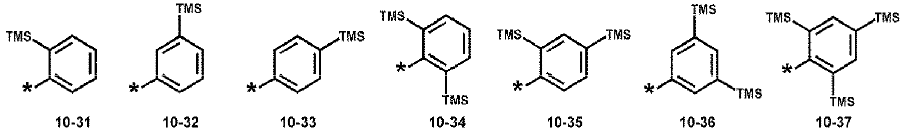

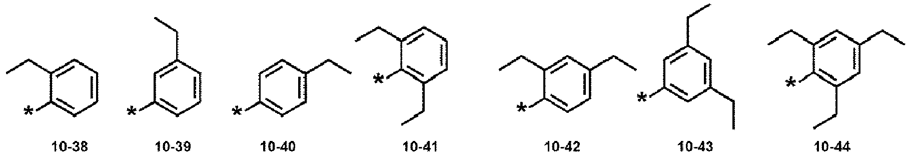

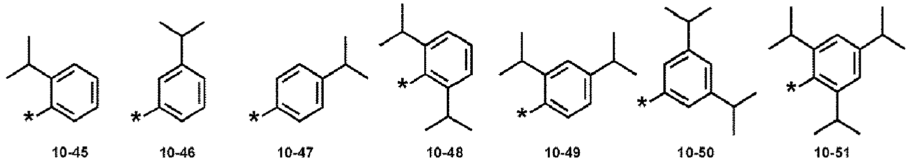

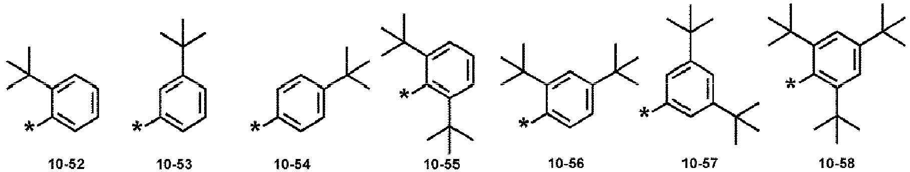

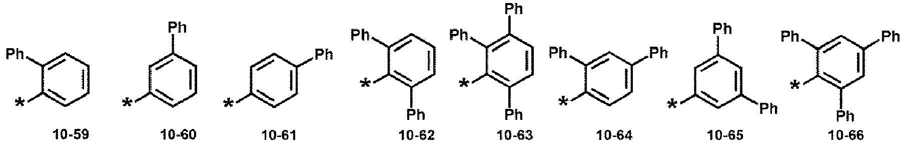

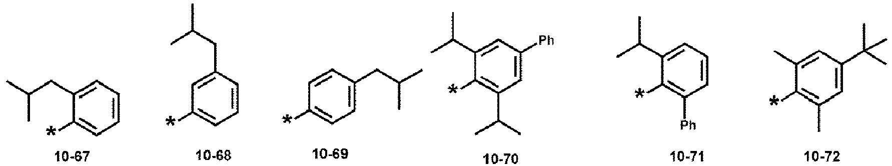

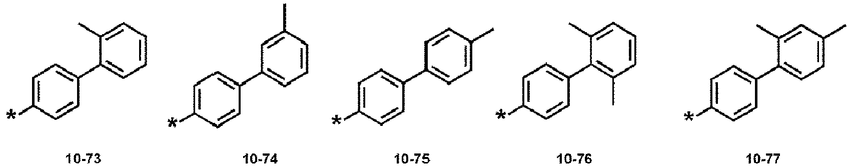

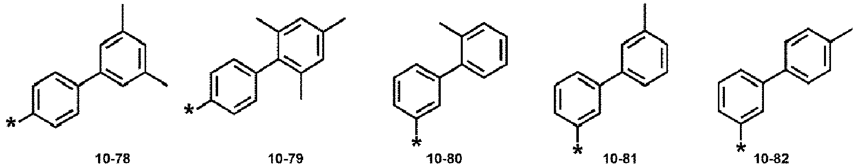

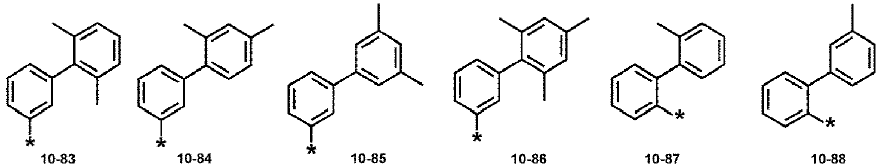

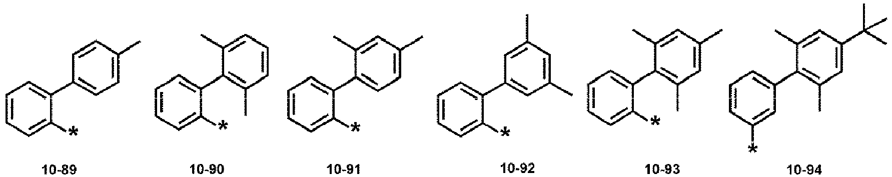

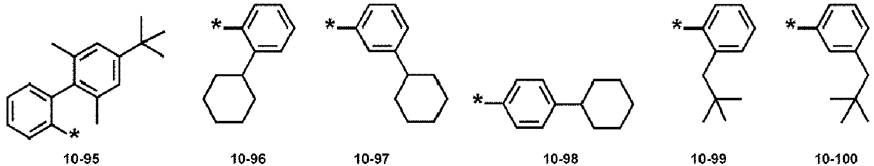

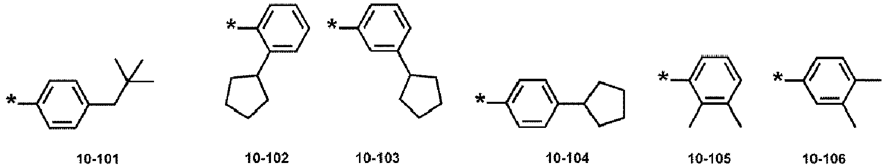

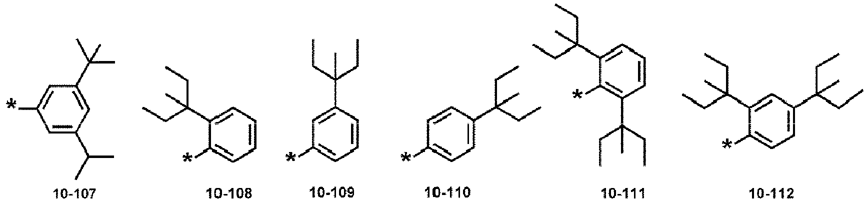

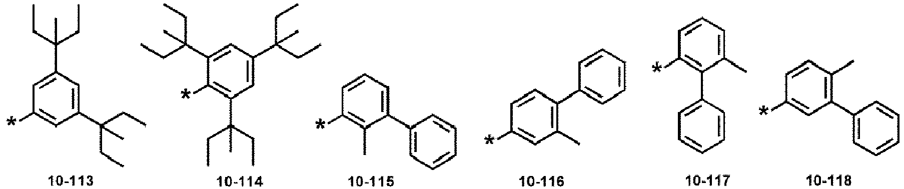

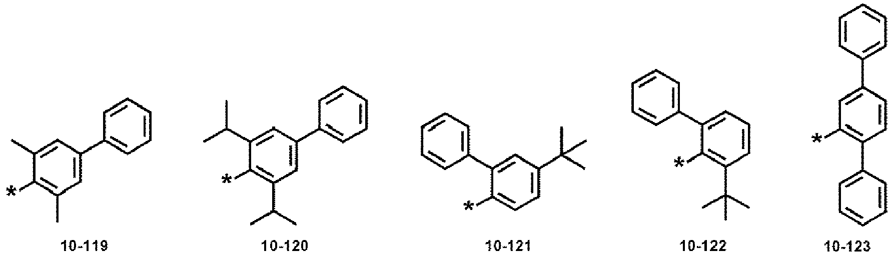

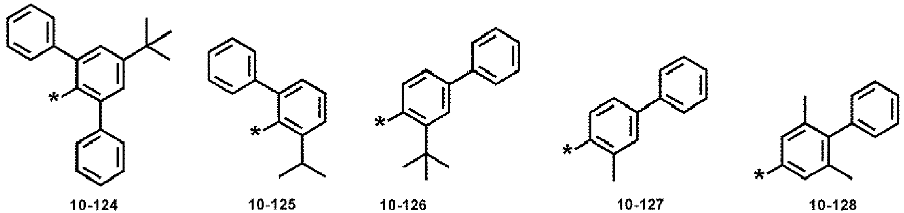

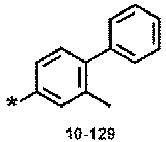

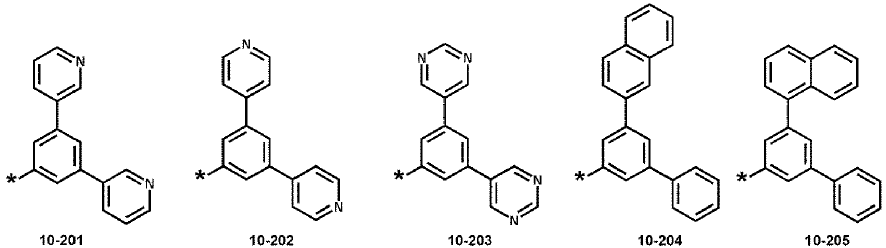

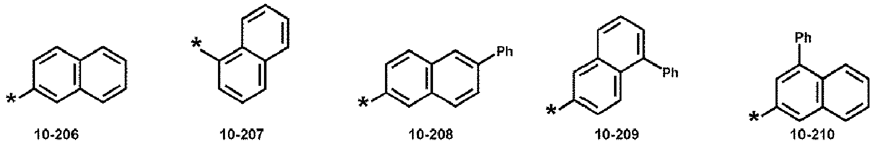

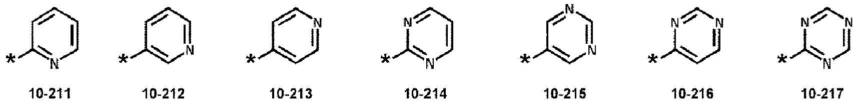

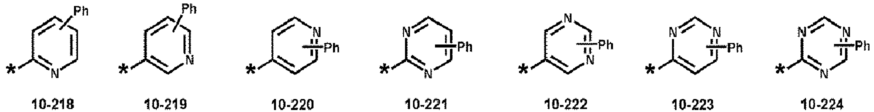

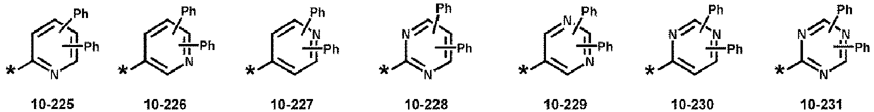

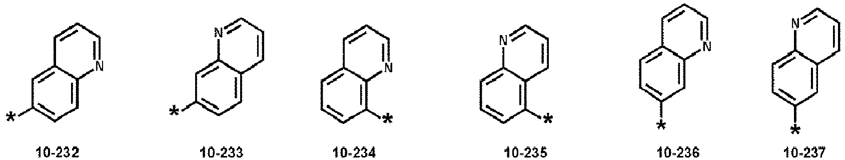

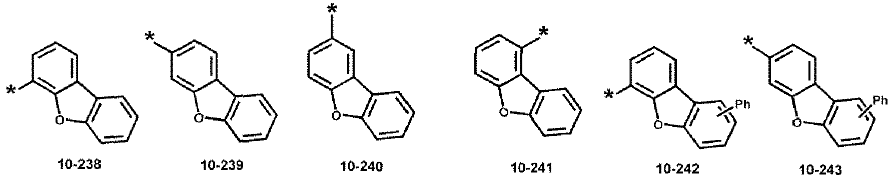

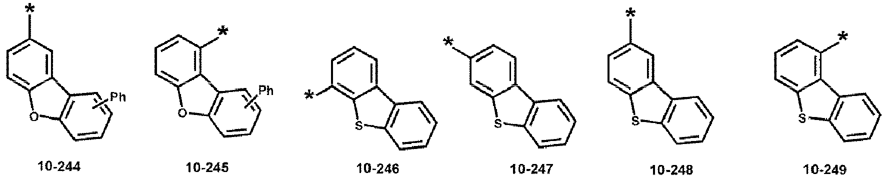

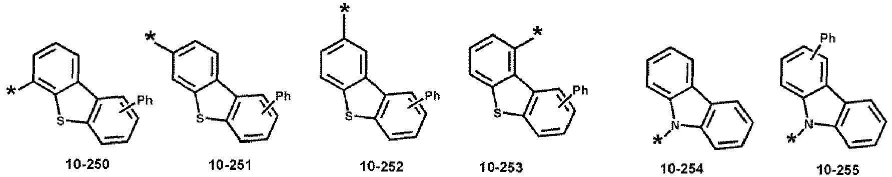

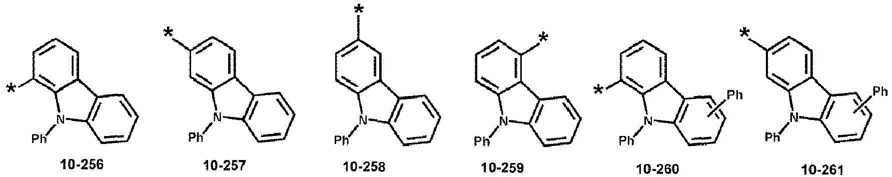

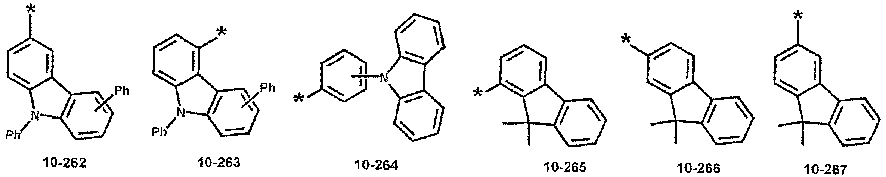

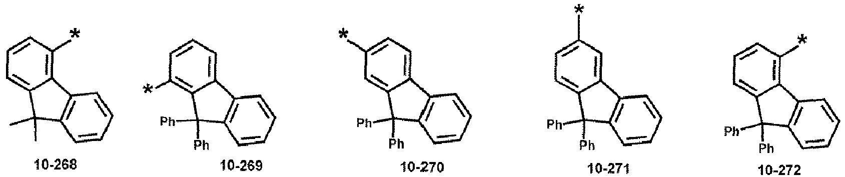

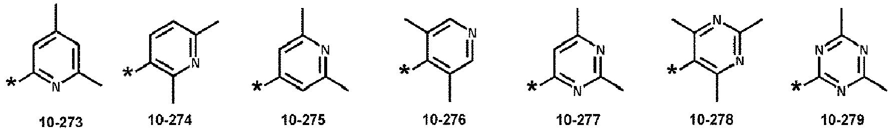

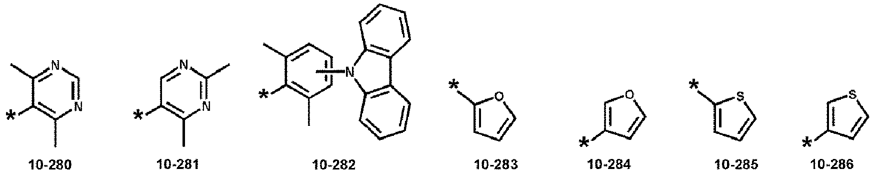

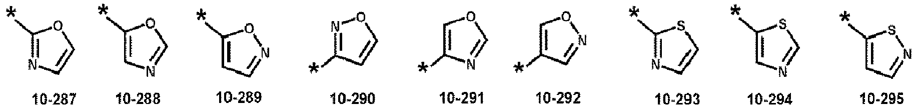

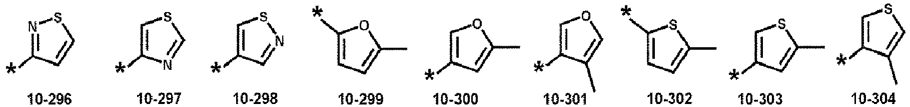

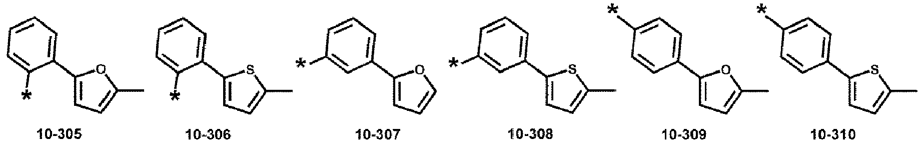

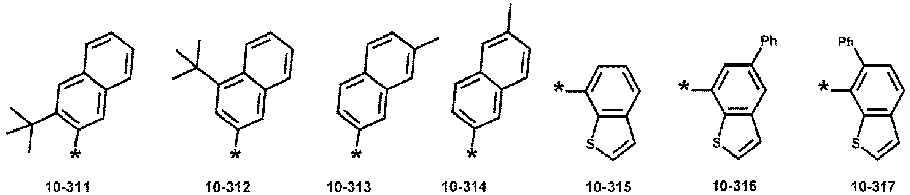

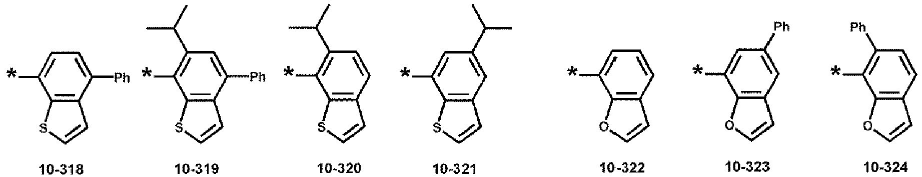

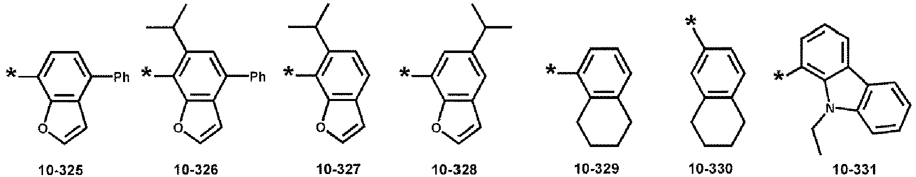

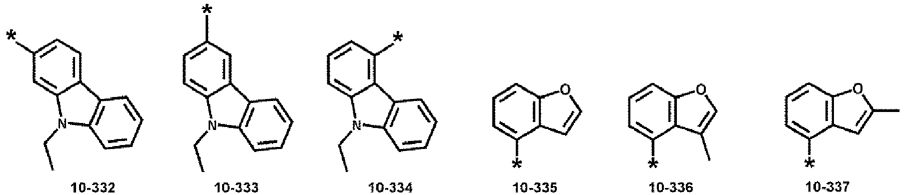

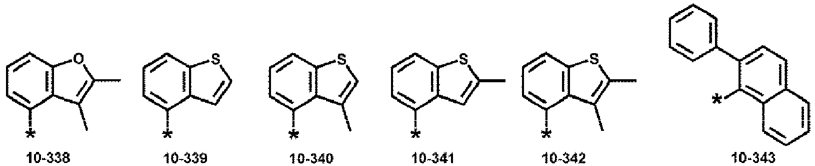

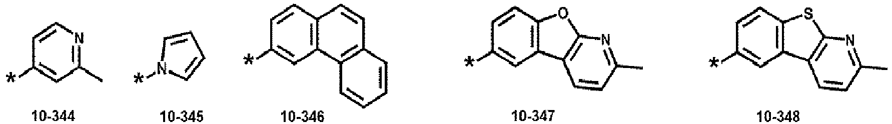

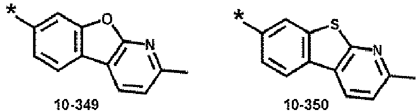

In Formulae 9-1 to 9-39, 9-201 to 9-227, 10-1 to 10-129, and 10-201 to 10-350, * indicates a binding site to a neighboring atom, Ph is a phenyl group, TMS is a trimethylsilyl group, and TMG is a trimethylgermyl group.

The "group represented by one of Formulae 9-1 to 9-39 in which at least one hydrogen is substituted with deuterium" and the "group represented by one of Formulae 9-201 to 9-227 in which at least one hydrogen is substituted with deuterium" may be, for example, a group represented by one of Formulae 9-501 to 9-514 and 9-601 to 9-636:

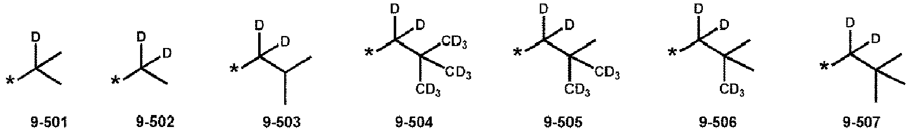

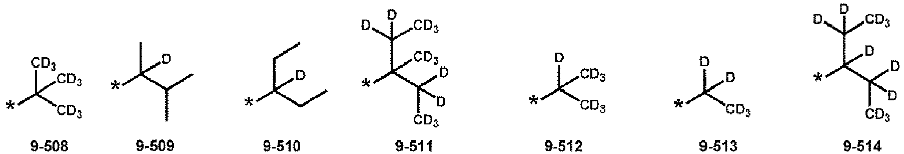

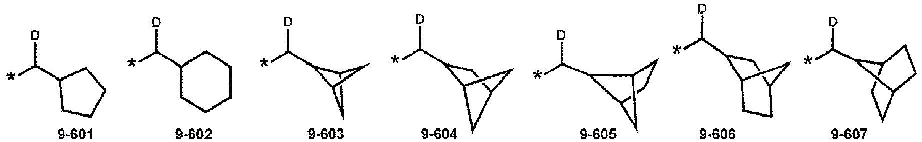

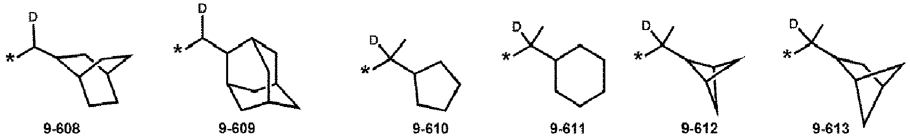

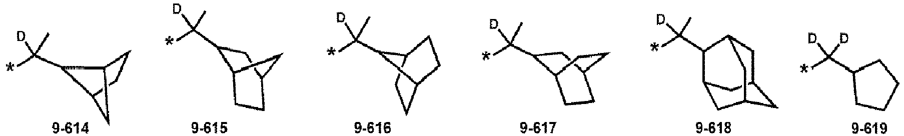

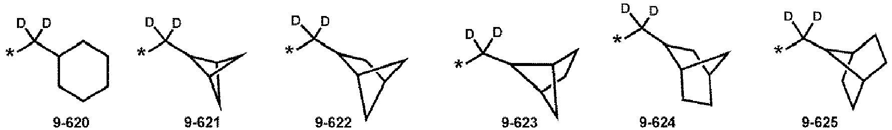

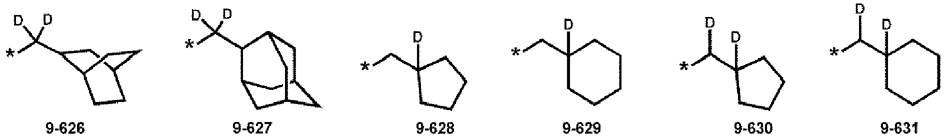

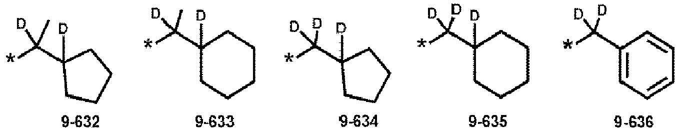

The "group represented by one of Formulae 9-1 to 9-39 in which at least one hydrogen is substituted with -F" and the "group represented by one of Formulae 9-201 to 9-227 in which at least one hydrogen is substituted with -F" may be, for example, a group represented by one of Formulae 9-701 to 9-710:

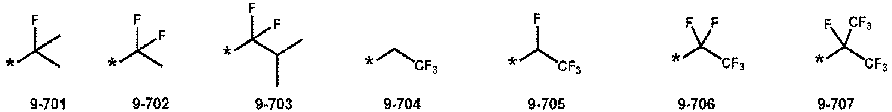

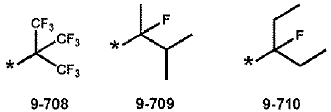

The "group represented by one of Formulae 10-1 to 10-129 in which at least one hydrogen is substituted with deuterium" and the "group represented by one of

Formulae 10-201 to 10-350 in which at least one hydrogen is substituted with deuterium" may be, for example, a group represented by one of Formulae 10-501 to 10-553:

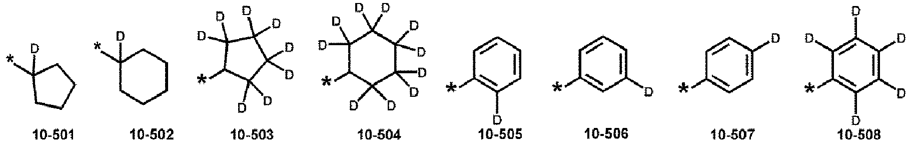

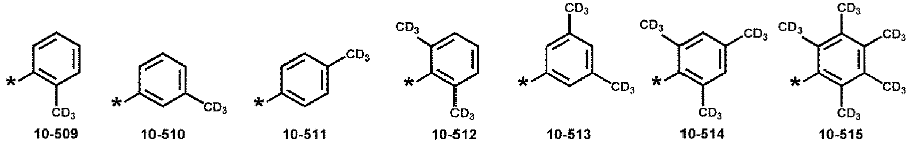

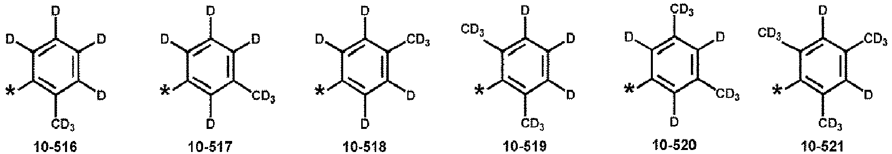

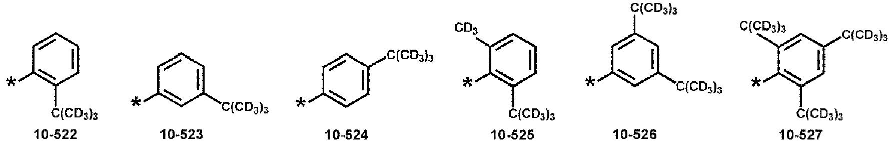

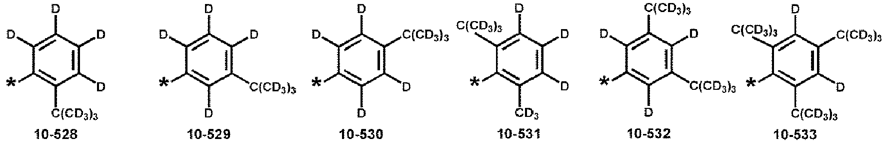

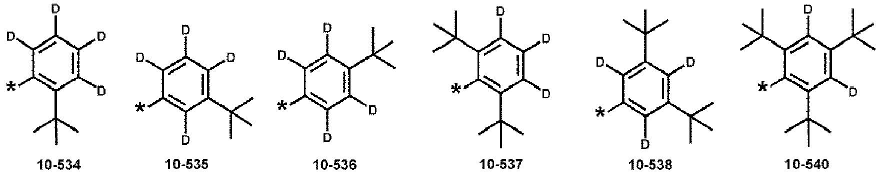

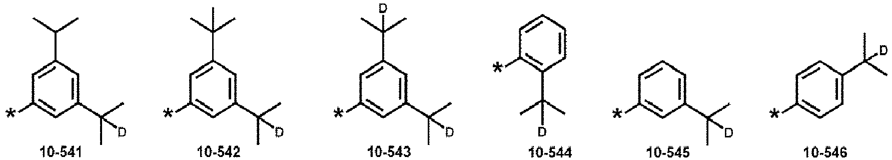

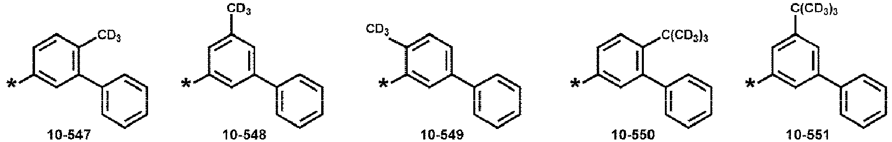

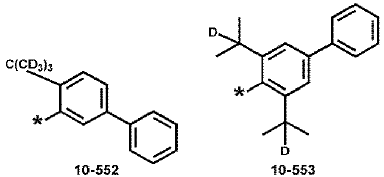

The "group represented by one of Formulae 10-1 to 10-129 in which at least one hydrogen is substituted with -F" and the "group represented by one of Formulae 10-201 to 10-350 in which at least one hydrogen is substituted with -F" may be, for example, a group represented by one of Formulae 10-601 to 10-617:

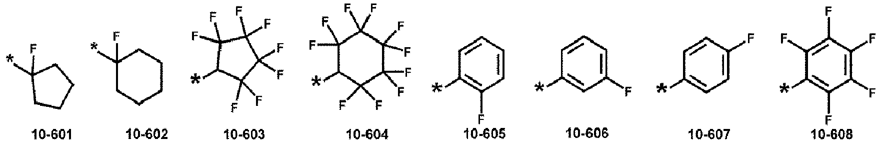

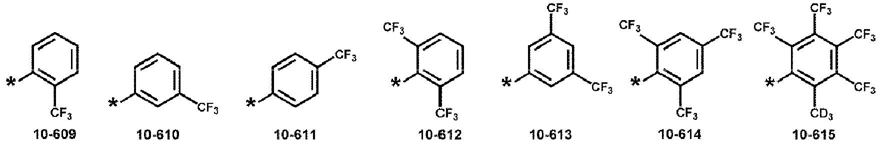

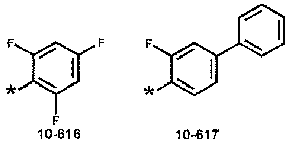

c1 to c4, a1 to a4, e1 to e4, and d1 to d4 in Formulae 1, 2-1, and 2-2 indicate numbers of R₁ to R₄, a group represented by *-[(L₁)_{b1}-(R₁)_{c1}], a group represented by *-[(L₂)_{b2}-(R₂)_{c2}], a group represented by *-[(L₃)_{b3}-(R₃)_{c3}], a group represented by *-[(L4)b4-(R4)c4], Z₁ to Z₄, a group represented by *-[W₁-(Z₁)ₑ₁], a group represented by *-[W₂-(Z₂)ₑ₂], a group represented by *-[W₃-(Z₃)ₑ₃], and a group represented by *-[W₄-(Z₄)ₑ₄], respectively, and may each independently be an integer from 0 to 20. When c1 is 2 or more, two or more of R₁(s) may be identical to or different from each other, when c2 is 2 or more, two or more of R₂(s) may be identical to or different from each other, when c3 is 2 or more, two or more of R₃(s) may be identical to or different from each other, when c4 is 2 or more, two or more of R₄(s) may be identical to or different from each other, when a1 is 2 or more, two or more of groups represented by *-[(L₁)_{b1}-(R₁)_{c1}] may be identical to or different from each other, when a2 is 2 or more, two or more of groups represented by *-[(L₂)_{b2}-(R₂)_{c2}] may be identical to or different from each other, when a3 is 2 or more, two or more of groups represented by *-[(L₃)_{b3}-(R₃)_{c3}] may be identical to or different from each other, when a4 is 2 or more, two or more of groups represented by *-[(L₄)_{b4}-(R₁)_{c4}] may be identical to or different from each other, when e1 is 2 or more, two or more of Z₁(s) may be identical to or different from each other, when e2 is 2 or more, two or more of Z₂(s) may be identical to or different from each other, when e3 is 2 or more, two or more of Z₃(s) may be identical to or different from each other, when e4 is 2 or more, two or more of Z₄(s) may be identical to or different from each other, when d1 is 2 or more, two or more of groups represented by *-[W₁-(Z₁)ₑ₁] may be identical to or different from each other, when d2 is 2 or more, two or more of groups represented by *-[W₂-(Z₂)ₑ₂] may be identical to or different from each other, when d3 is 2 or more, two or more of groups represented by *-[W₃-(Z₃)ₑ₃] may be identical to or different from each other, and when d4 is 2 or more, two or more of groups represented by *-[W₄-(Z₄)ₑ₁] may be identical to or different from each other. In an embodiment, c1 to c4, a1 to a4, e1 to e4, and d1 to d4 in Formulae 1, 2-1, and 2-2 may each independently be 0, 1, 2, or 3.

In an embodiment, the first compound and the second compound may each not be tris[2-phenyl pyridine]iridium.

In an embodiment, in Formula 2-1, a case where Y₁ is N, ring A₁ is a pyridine group, Y₂ is C, ring A₂ is a benzene group, and d1 and d2 are each 0 may be excluded.

In Formulae 1, 2-1, and 2-2, at least one of i) two or more of a plurality of R₁(s), ii) two or more of a plurality of R₂(s), iii) two or more of a plurality of R₃(s), iv) two or more of a plurality of R₄(s), v) R₅ₐ and R_{5b}, vi) two or more of a plurality of Z₁(s), vii) two or more of a plurality of Z₂(s), viii) two or more of a plurality of Z₃(s), ix) two or more of a plurality of Z₄(s), x) two or more of R₁ to R₄, R₅ₐ, and R_{5b}, and xi) two or more of Z₁ to Z₄ may each optionally bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ.

R₁₀ₐ may be the same as described in connection with R₁.

* and *' in the present specification each indicate a binding site to a neighboring atom, unless otherwise stated.

In an embodiment, in Formula 1, n1 may not be 0, n4 may be 0, and a group represented by 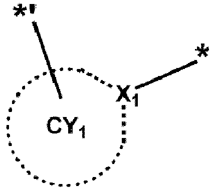 may be a group represented by one of Formulae CY1(1) to CY1 (23): 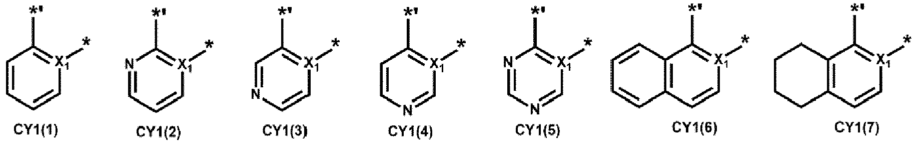 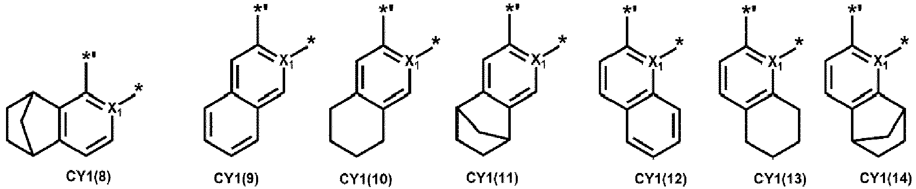 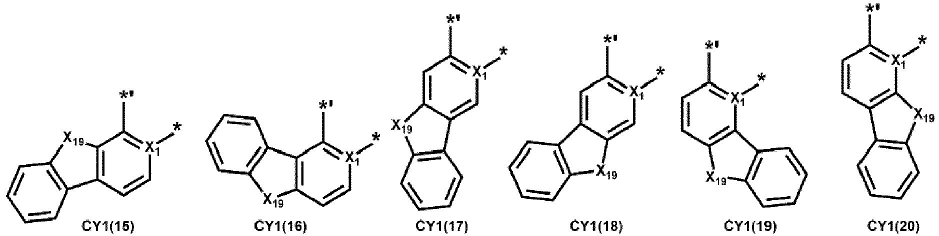 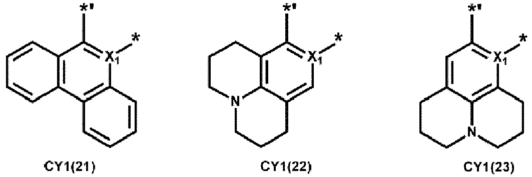 wherein, in Formulae CY1(1) to CY1(23),
X₁ is the same as described in the present specification,
X₁₉ may be O, S, Se, N(R₁₉ₐ), C(R₁₉a)(R_{19b}), or Si(R₁₉ₐ)(R_{19b}),
R₁₉ₐ and R_{19b} are each the same as described in connection with R₁ in the present specification,
* indicates a binding site to X₅ in Formula 1, and
*' indicates a binding site to T₁₁ in Formula 1.

In an embodiment, in Formula 1, n1 may be 1, n4 may be 0, and a group
represented by 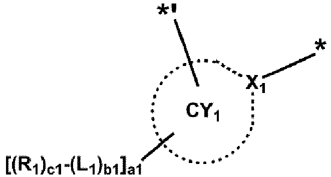 may be a group represented by one of Formulae CY1-1 to CY1-18: 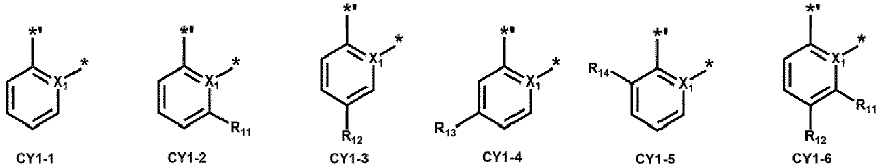 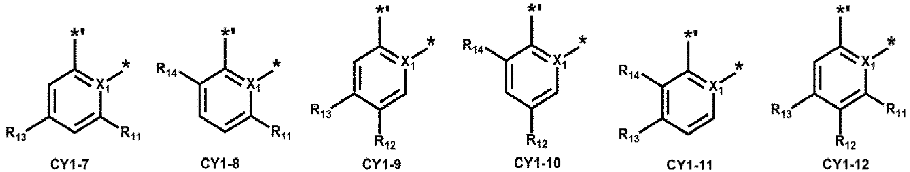 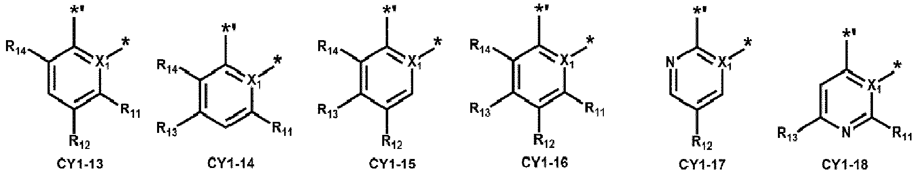 wherein, in Formulae CY1-1 to CY1-18,
X₁ is the same as described above,
R₁₁ to R₁₄ are each the same as described in connection with R₁ in the present specification, wherein R₁₁ to R₁₄ are each not hydrogen,
* indicates a binding site to X₅ in Formula 1, and
*' indicates a binding site to T₁₁ in Formula 1.

In an embodiment, in Formula 1, n1 and n2 may each be 1, and ring CY₂ may be a group represented by Formula CY2A or CY2B: 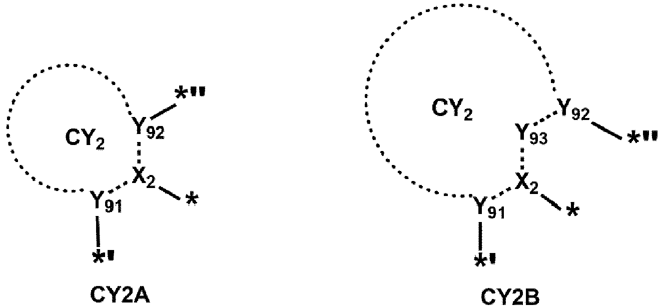 wherein, in Formulae CY2A and CY2B,
X₂ and ring CY₂ are each the same as described in the present specification,
Y₉₁ to Y₉₃ may each independently be O, S, N, C, or Si,
a bond between X₂ and Y₉₁, a bond between X₂ and Y₉₂, a bond between X₂ and Y₉₃, and a bond between Y₉₂ and Y₉₃ are each a chemical bond,
*' indicates a binding site to T₁₁ in Formula 1,
* indicates a binding site to M₁ in Formula 1, and
* indicates a binding site to T₁₂ in Formula 1.

In an embodiment, in Formula 1, n1 and n2 may each not be 0, and a group represented by 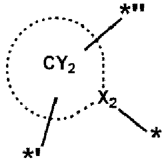 may be a group represented by one of Formulae CY2(1) to CY2(21): 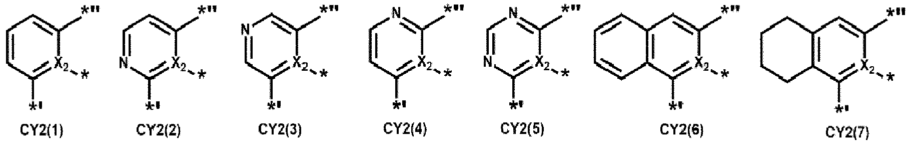 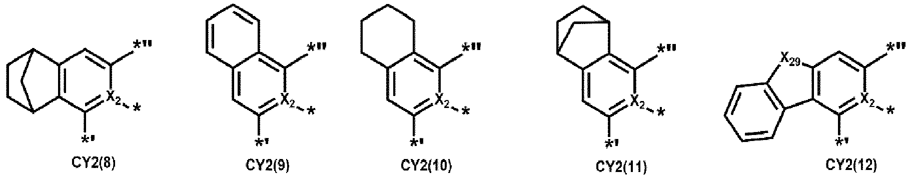 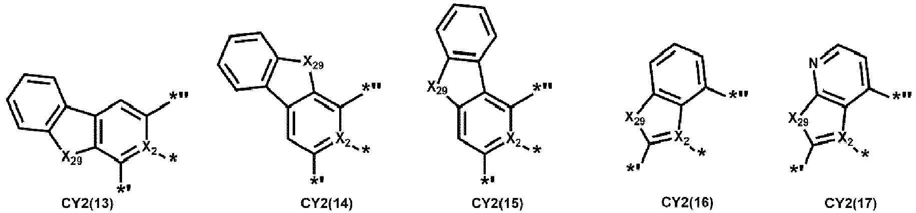 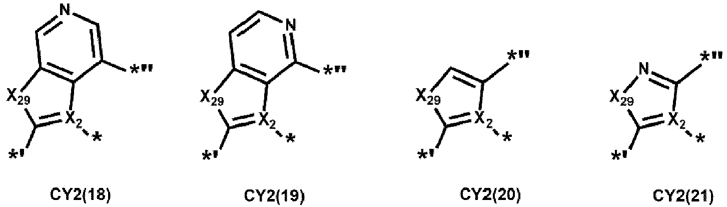 wherein, in Formulae CY2(1) to CY2(21),
X₂ is the same as described in the present specification,
X29 may be O, S, N-[(L2)b2-(R2)c2], C(R29a)(R29b), or Si(R29a)(R29b),
L₂, b2, R₂, and c2 are each the same as described in the present specification,
R₂₉ₐ and R_{29b} are each the same as described in connection with R₂ in the present specification,
*' indicates a binding site to T₁₁ in Formula 1,
* indicates a binding site to M₁ in Formula 1, and
*" is a binding site to T₁₂ in Formula 1.

In an embodiment, in Formula 1, n1 and n2 may each be 1, and a group represented by 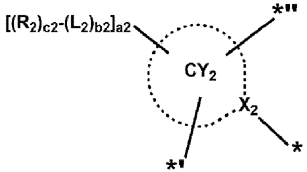 may be a group represented by one of Formulae CY2-1 to CY2-16: 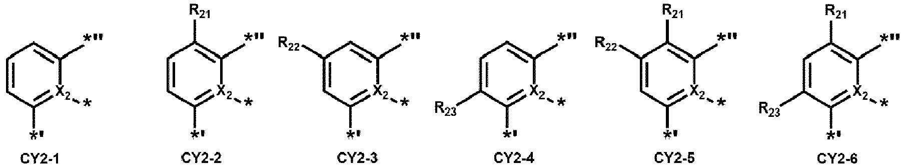 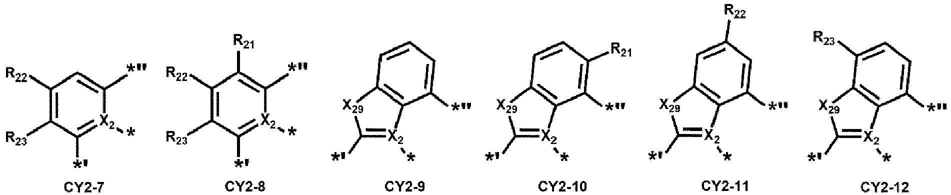 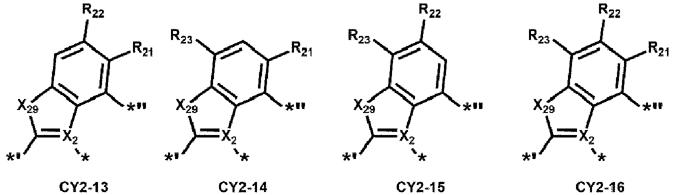 wherein, in Formulae CY2-1 to CY2-16,
X₂ is the same as described in the present specification,
X29 may be O, S, N-[(L2)b2-(R2)c2], C(R29a)(R29b), or Si(R29a)(R29b),
L₂, b2, R₂, and c2 are each the same as described in the present specification,
R₂₁ to R₂₃, R₂₉ₐ, and R_{29b} are each the same as described in connection with R₂ in the present specification, wherein R₂₁ to R₂₃ are each not hydrogen,
*' indicates a binding site to T₁₁ in Formula 1,
* indicates a binding site to M₁ in Formula 1, and
*" is a binding site to T₁₂ in Formula 1.

In an embodiment, in Formula 1,
n1 and n2 may each be 1,
a group represented by 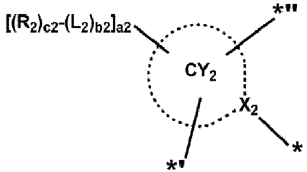 may be a group represented by one of Formulae CY2-9 to CY2-16,
X₂₉ in Formulae CY2-9 to CY2-16 may be N-[(L₂)_{b2}-(R₂)_{c2}],
L₂ may be a benzene group unsubstituted or substituted with at least one R₁₀ₐ,
b2 may be 1 or 2,
c2 may be 1 or 2, and
when c2 is 1, R₂ may be a phenyl group unsubstituted or substituted with deuterium, a C₁-C₂₀ alkyl group, or a combination thereof; and when c2 is 2, a) one of two R₂(s) may be a phenyl group substituted or unsubstituted with deuterium, a C₁-C₂₀ alkyl group, a phenyl group, a deuterated phenyl group, a (C₁-C₂₀ alkyl)phenyl group, or any combination thereof, and b) the other R₂ may be a C₄-C₂₀ alkyl group or a deuterated C₁-C₂₀ alkyl group, each unsubstituted or substituted with a C₃-C₁₀ cycloalkyl group.

In an embodiment, in Formula 1, n2 and n3 may each not be 0, and a group represented by 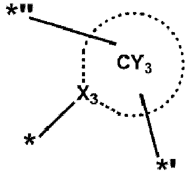 may be a group represented by one of Formulae CY3(1) to CY3(15): 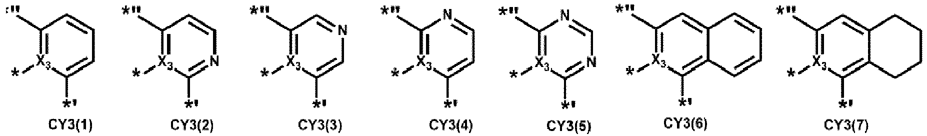 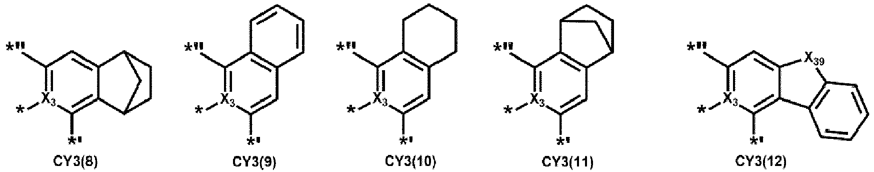 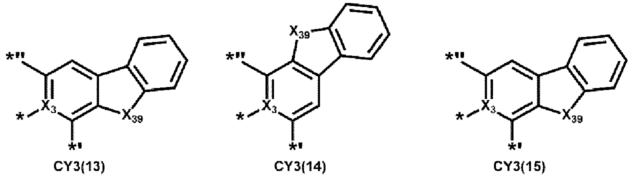 wherein, in Formulae CY3(1) to CY3(15),
X₃ is the same as described in the present specification,
X39 may be O, S, N(Z39a), C(R39a)(R39b), or Si(R39a)(R39b),
R₃₉ₐ and R_{39b} are each the same as described in connection with R₃ in the present specification,
*" indicates a binding site to T₁₂ in Formula 1,
* indicates a binding site to M₁ in Formula 1, and
*' indicates a binding site to T₁₃ in Formula 1.

In an embodiment, in Formula 1, n2 and n3 may each be 1, and a group represented by 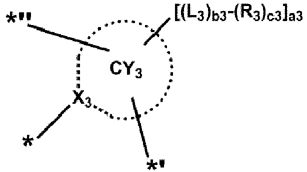 may be a group represented by one of Formulae CY3-1 to CY3-13: 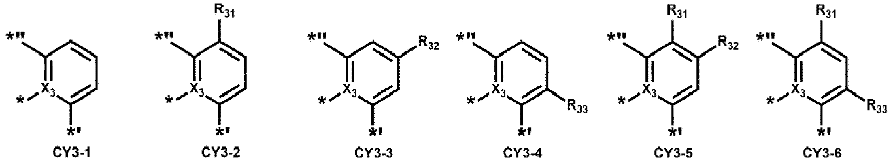 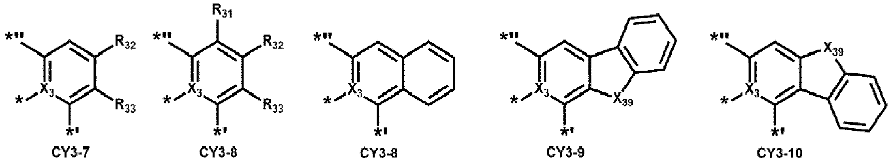 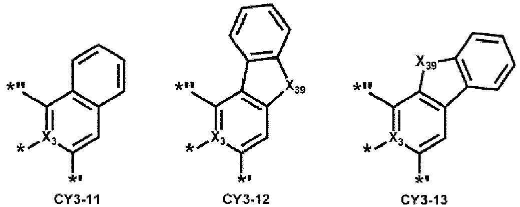 wherein, in Formulae CY3-1 to CY3-13,
X₃ is the same as described in the present specification,
X39 may be O, S, N-[(L3)b3-(R3)c3], C(R39a)(R39b), or Si(R39a)(R39b),
L₃, b3, R₃, and c3 are each the same as described in the present specification,
R₃₁ to R₃₃, R₃₉ₐ, and R_{39b} are each the same as described in connection with R₃ in the present specification, wherein R₃₁ to R₃₃ are each not hydrogen,
*" indicates a binding site to T₁₂ in Formula 1,
* indicates a binding site to M₁ in Formula 1, and
*' indicates a binding site to T₁₃ in Formula 1.

In an embodiment, in Formula 1, n3 may not be 0, n4 may be 0, and a group represented by 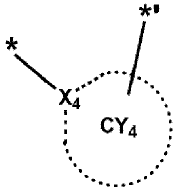 may be a group represented by one of Formulae CY4(1) to CY4(20): 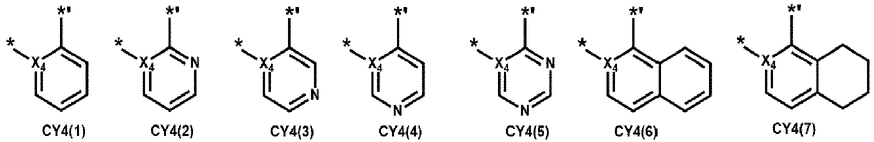 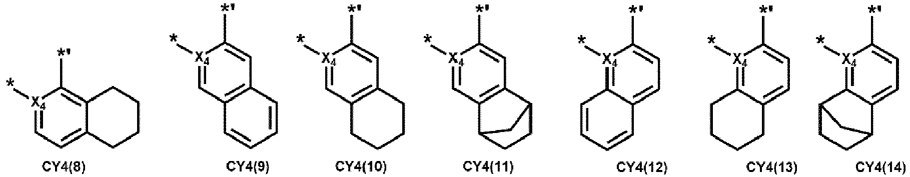 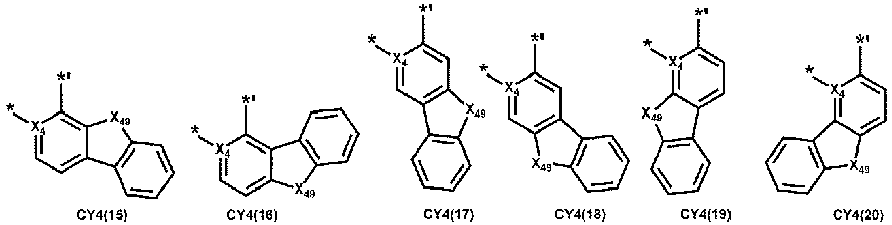 wherein, in Formulae CY4(1) to CY4(20),
X₄ is the same as described in the present specification,
X49 may be O, S, N(R49a), C(R49a)(R49b), or Si(R49a)(R49b),
R₄₉ₐ and R_{49b} are each the same as described in connection with R₄ in the present specification,
*' indicates a binding site to T₁₃ in Formula 1, and
* is a binding site to M₁ in Formula 1.

In an embodiment, in Formula 1, n3 may be 1, n4 may be 0, and a group represented by 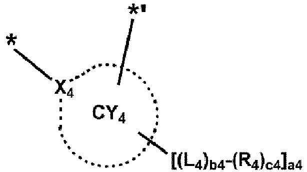 may be a group represented by one of Formulae CY4-1 to CY4-16: 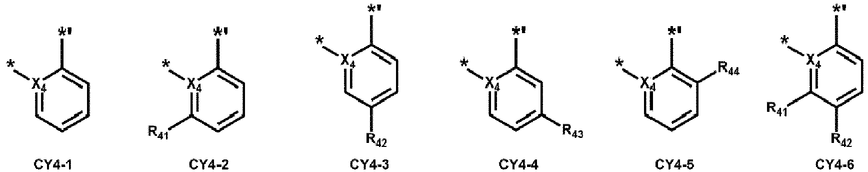 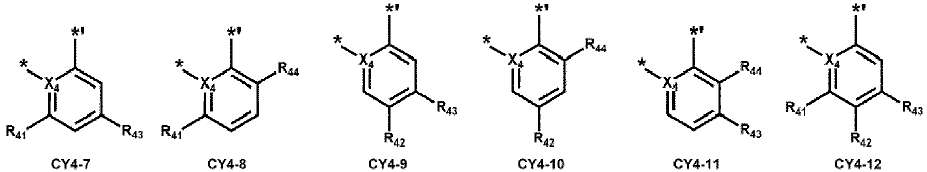 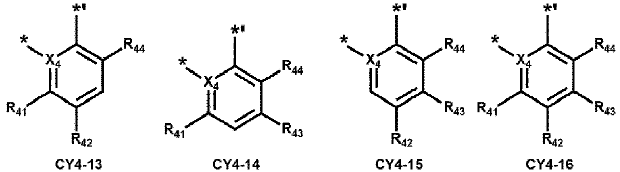 wherein, in Formulae CY4-1 to CY4-16,
X₄ is the same as described in the present specification,
R₄₁ to R₄₄ are each the same as described in connection with R₄ in the present specification, wherein R₄₁ to R₄₄ are each not hydrogen,
*' indicates a binding site to T₁₃ in Formula 1, and
* is a binding site to M₁ in Formula 1.

In an embodiment, the organometallic compound represented by Formula 1 may be a compound represented by one of Formulae 1-1 to 1-3: 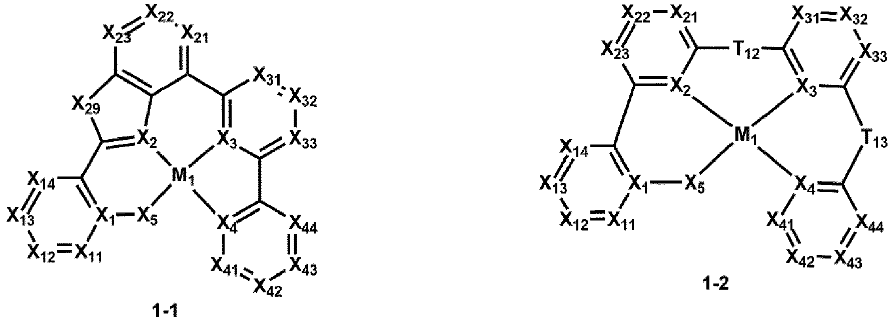 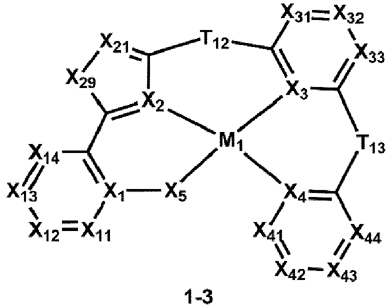 wherein, in Formulae 1-1 to 1-3,
M₁, X₁ to Xs, T₁₂, and T₁₃ are each the same as described in the present specification,
X₁₁ may be N or C(R₁₁), X₁₂ may be N or C(R₁₂), X₁₃ may be N or C(R₁₃), and X₁₄ may be N or C(R₁₄),
R₁₁ to R₁₄ are each the same as described in connection with R₁ in the present specification,
two or more of R₁₁ to R₁₄ may optionally be bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
X₂₁ may be N or C(R₂₁), X₂₂ may be N or C(R₂₂), and X₂₃ may be N or C(R23),
X29 may be O, S, N-[(L2)b2-(R2)c2], C(R29a)(R29b), or Si(R29a)(R29b),
L₂, b2, R₂, and c2 are each the same as described in the present specification,
R₂₁ to R₂₃, R₂₉ₐ, and R_{29b} are each the same as described in connection with R₂ in the present specification,
two or more of R₂₁ to R₂₃ may optionally be bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
X₃₁ may be N or C(R₃₁), X₃₂ may be N or C(R₃₂), and X₃₃ may be N or C(R33),
R₃₁ to R₃₃ are each the same as described in connection with R₃ in the present specification,
two or more of R₃₁ to R₃₃ may optionally be bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
X₄₁ may be N or C(R₄₁), X₄₂ may be N or C(R₄₂), X₄₃ may be N or C(R₄₃), and X₄₄ may be N or C(R₄₄),
R₄₁ to R₄₄ are each the same as described in connection with R₄ in the present specification,
two or more of R₄₁ to R₄₄ may optionally be bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ.

In an embodiment,
Y₁ in Formula 2-1 may be N, and a group represented by 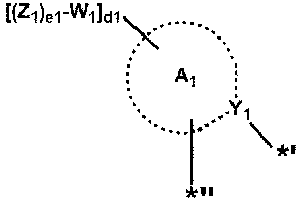 in Formula 2-1 may be a group represented by one of Formulae A1-1 to A1-3: 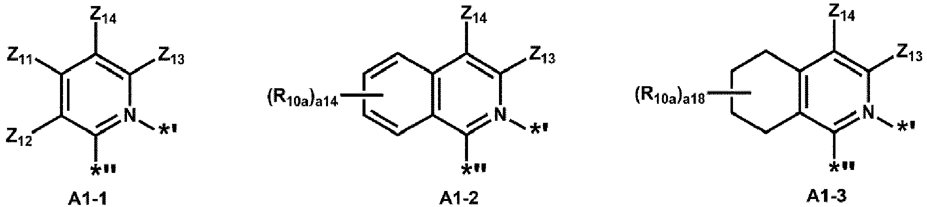 wherein, in Formulae A1-1 to A1-3,
Z₁₁ to Z₁₄ are each the same as described in connection with Z₁ in the present specification,
R₁₀ₐ is the same as described in the present specification,
a14 may be an integer from 0 to 4,
a18 may be an integer from 0 to 8,
*' indicates a binding site to M₂ in Formula 2, and
*" indicates a binding site to ring A₂.

For example, at least one of Z₁₁, Z₁₂, and Z₁₄ (for example, Z₁₄) in Formulae A1-1 to A1-3 may be:
a C₁-C₂₀ alkyl group that is unsubstituted or substituted with deuterium, -F, a phenyl group, or any combination thereof;
-Si(Q₃)(Q₄)(Q₅); or
-Ge(Q3)(Q4)(Q5).

In an embodiment,
Y₃ in Formula 2-2 may be N, and
a group represented by 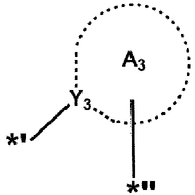 in Formula 2-2 may be a group represented by one of Formulae NR1 to NR48: 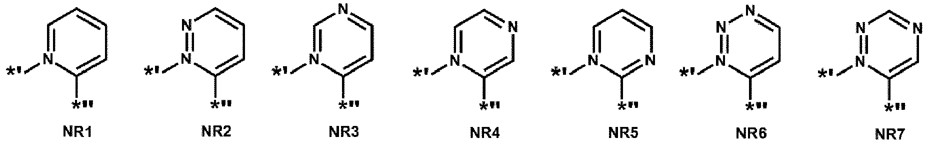 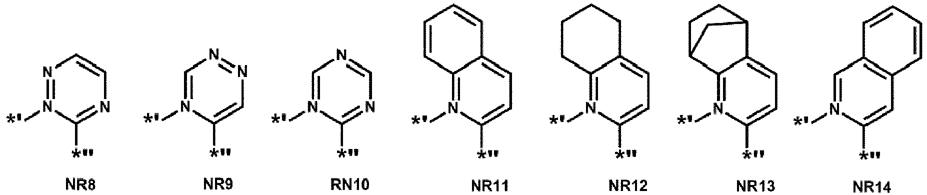 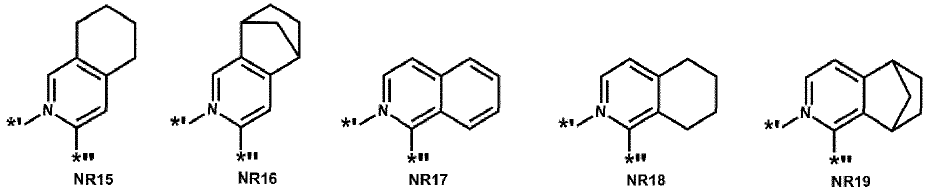 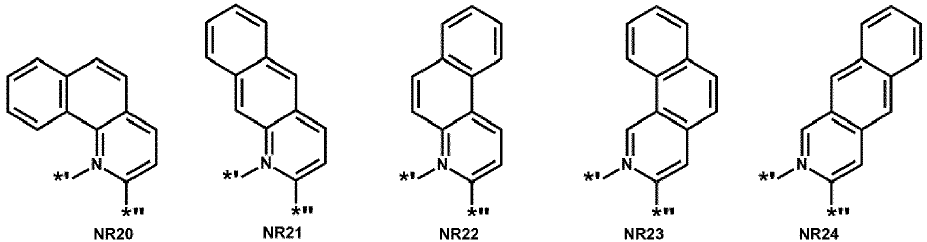 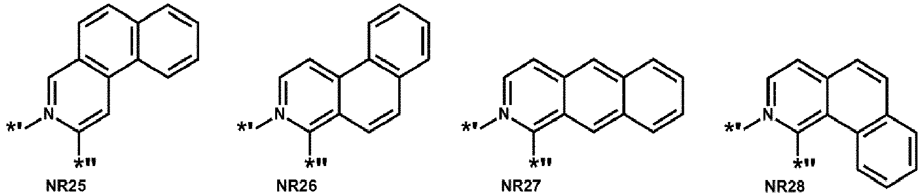 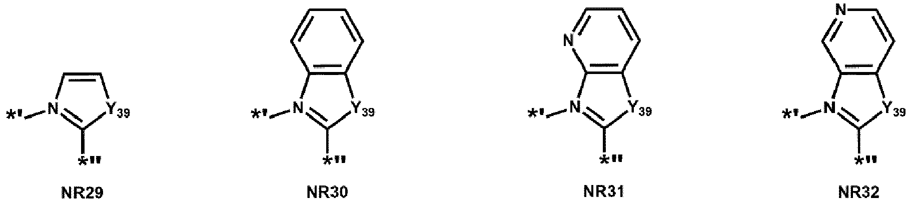 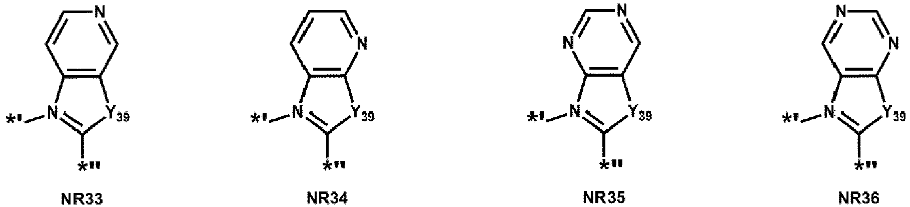 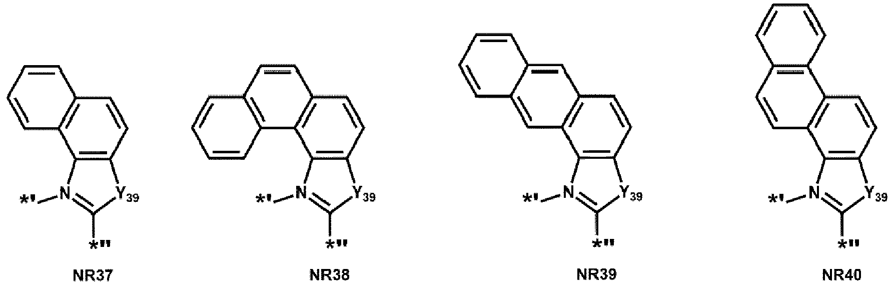 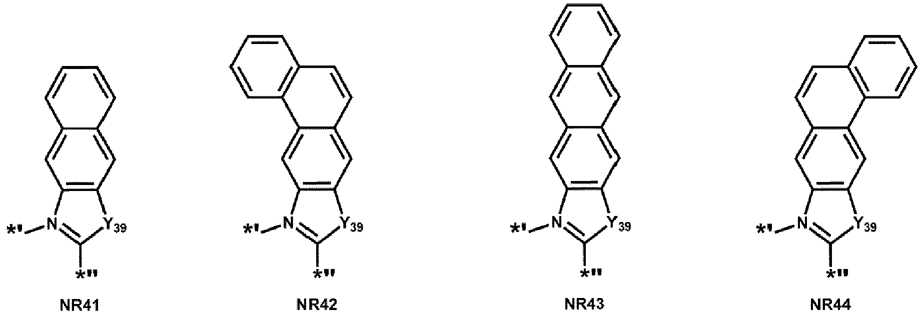 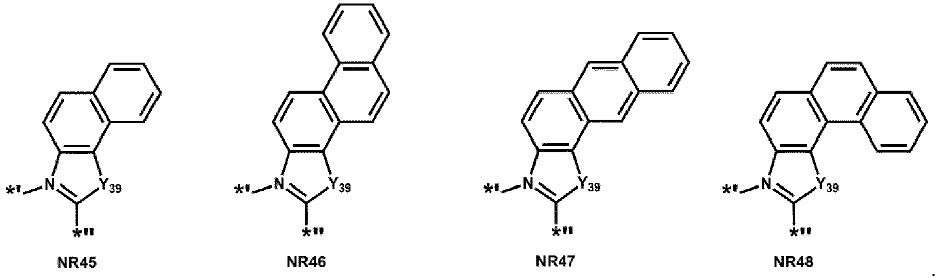 wherein, in Formulae NR1 to NR48,
Y₃₉ may be O, S, Se, N-[W₃-(Z₃)ₑ₃], C(Z₃₉ₐ)(Z_{39b}), or Si(Z₃₉ₐ)(Z_{39b}),
W₃, Z₃, and e3 are each the same as described in the present specification, and Z₃₉ₐ and Z_{39b} are each the same as described in connection with Z₃ in the present specification,
*' indicates a binding site to M₂ in Formula 2, and
*" indicates a binding site to ring A₄.

In an embodiment,
Y₂ and Y₄ in Formulae 2-1 and 2-2 may each be C, and
a group represented by 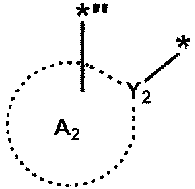 in Formula 2-1 and a group represented by 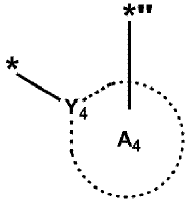 in Formula 2-2 may each independently be a group represented by one of Formulae CR1 to CR29: 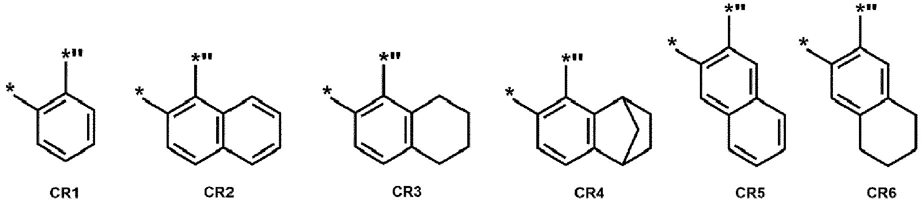 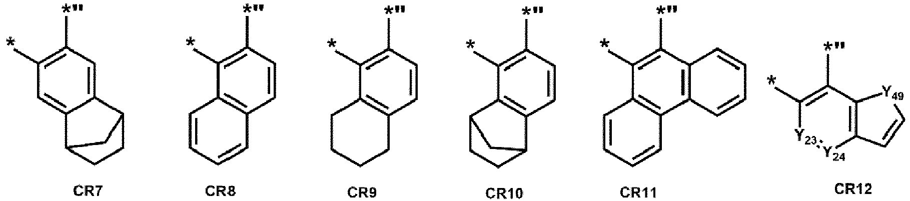 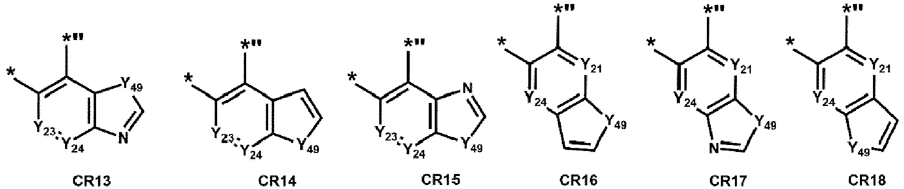 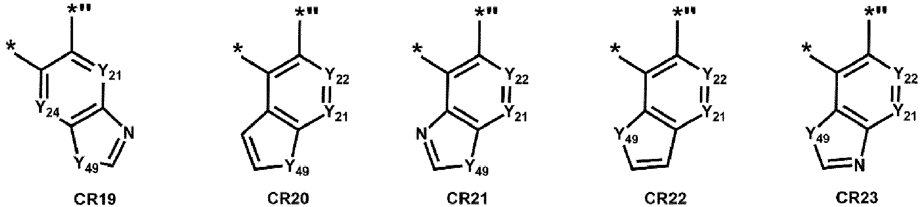 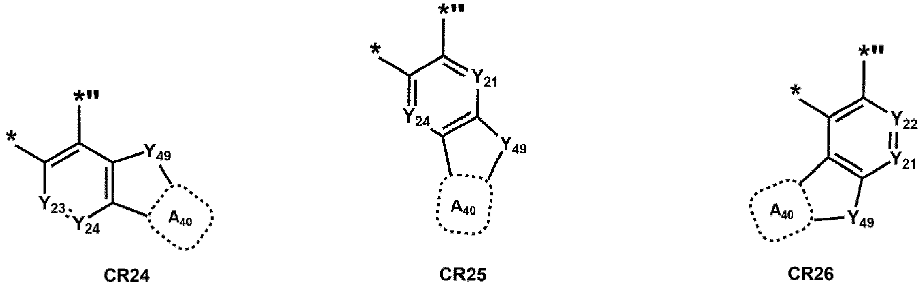 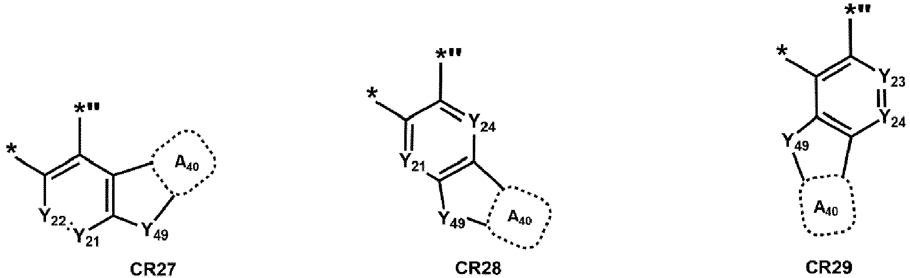 wherein, in Formulae CR1 to CR29,
Y49 may be O, S, Se, N-[W2-(Z2)e2], N-[W4-(Z4)e4], C(Z29a)(Z29b), C(Z49a)(Z49b), Si(Z29a)(Z29b), or Si(Z49a)(Z49b),
W₂, W₄, Z₂, Z₄, e2, and e4 are each the same as described in the present specification, Z₂₉ₐ and Z_{29b} are each the same as described in connection with Z₂ in the present specification, and Z₄₉ₐ and Z_{49b} are each the same as described in connection with Z₄ in the present specification,
Y₂₁ to Y₂₄ may each independently be N or C,
ring A₄₀ may be a C₅-C₃₀ carbocyclic group or a C₁-C₃₀ heterocyclic group (for example, a benzene group, a naphthalene group, a phenanthrene group, a pyridine group, a pyrimidine group, a pyrazine group, a pyridazine group, a quinoline group, an isoquinoline group, a benzoquinoline group, a benzoisoquinoline group, a quinoxaline group, a benzoquinoxaline group, a quinazoline group, or a benzoquinazoline group),
* indicates a binding site to M₂ in Formula 2, and
*" indicates a binding site to ring A₁ or ring A₃.

In an embodiment,
a group represented by 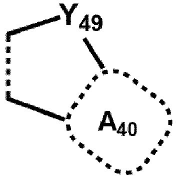 in Formulae CR24 to CR29 may be a group represented by one of Formulae CR(1) to CR(13): 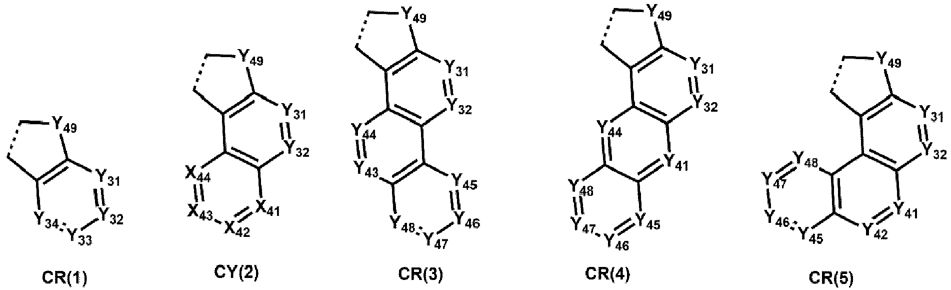 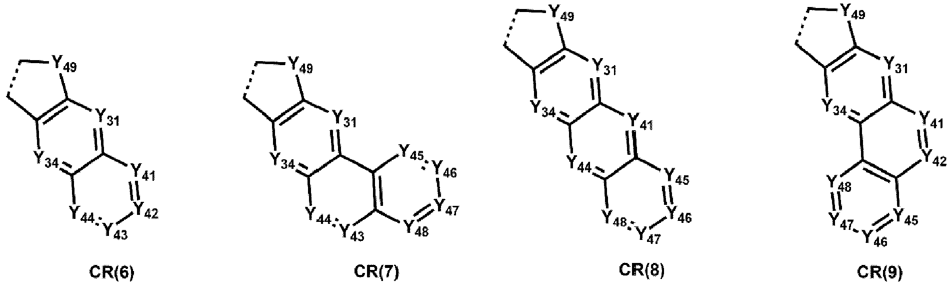 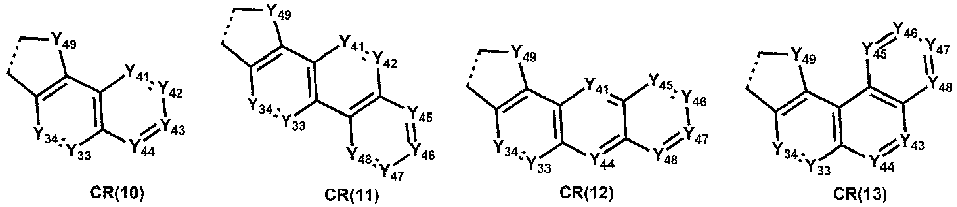 wherein, in Formulae CR(1) to CR(13),
Y₄₉ is the same as described in the present specification, and
Y₃₁ to Y₃₄ and Y₄₁ to Y₄₈ may each independently be C or N.

In an embodiment, the first compound may include at least one deuterium.

In an embodiment, the second compound may include at least one deuterium.

For example, the first compound and the second compound may each independently be selected from compounds of Group 1-1 to Group 1-4 and compounds of Group 2-1 to Group 2-5:
Group 1-1 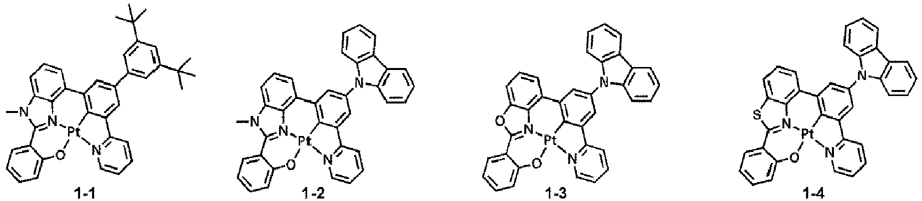 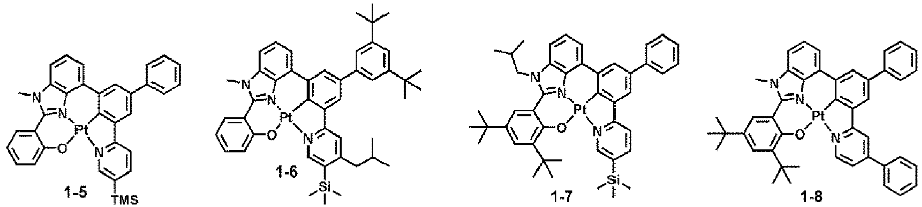 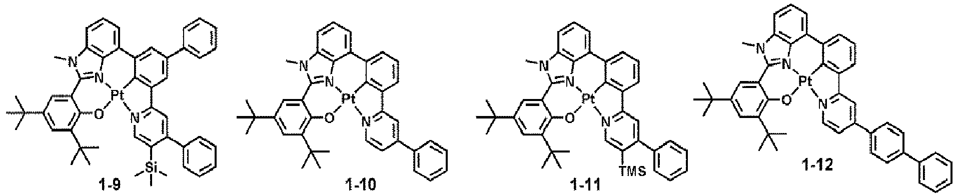 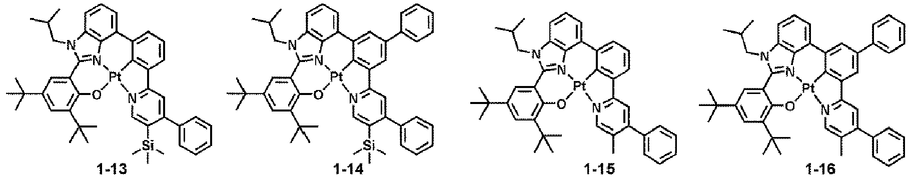 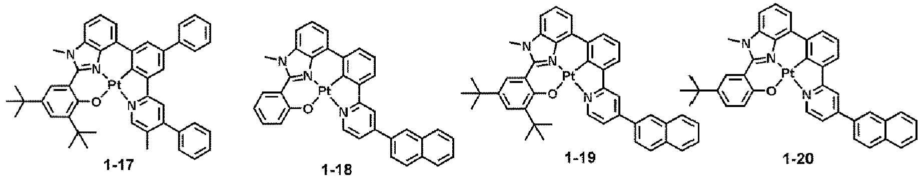 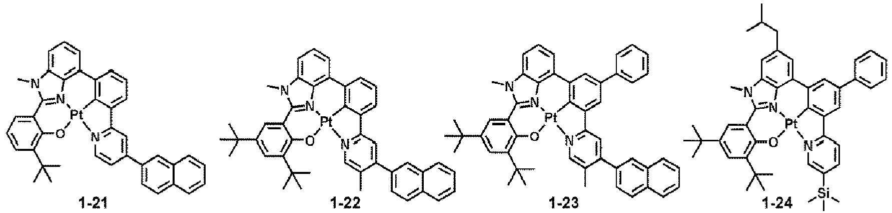 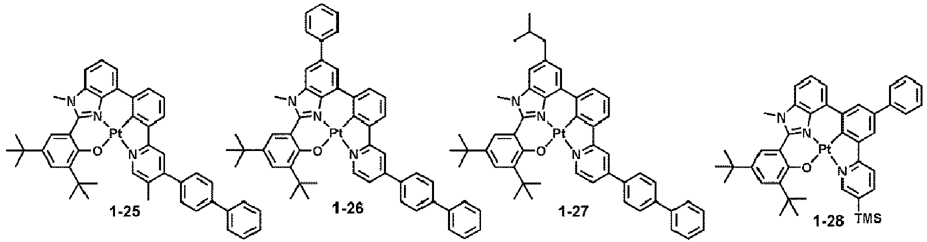 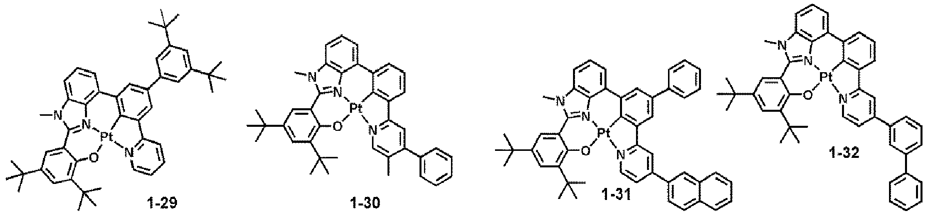 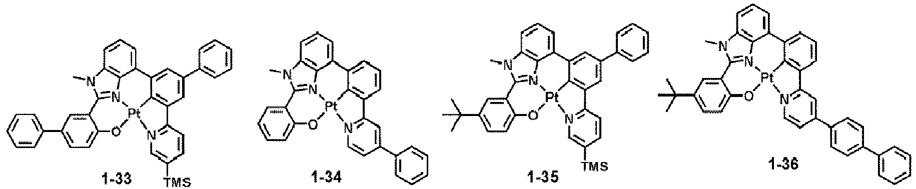 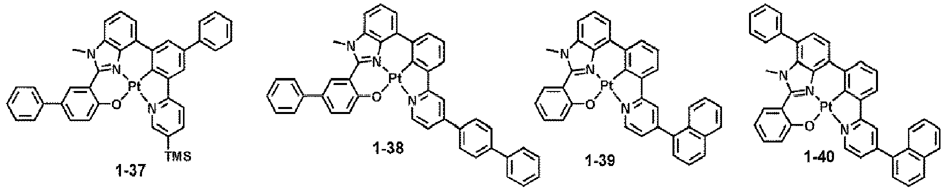 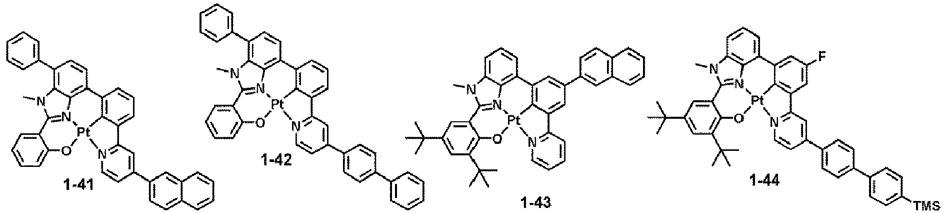 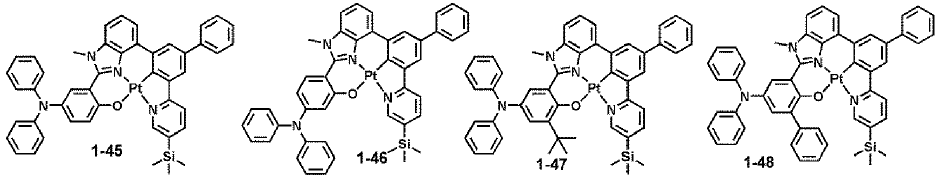 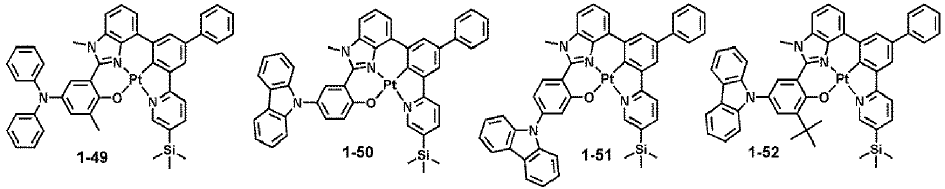 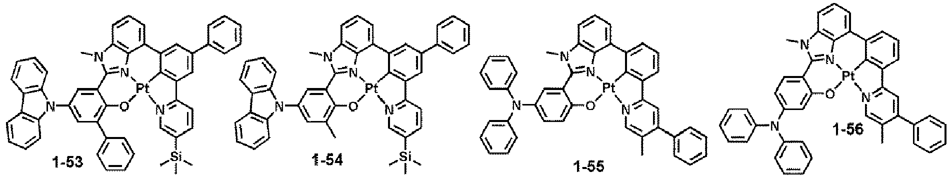 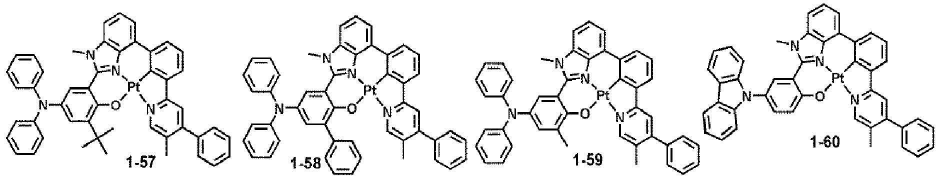 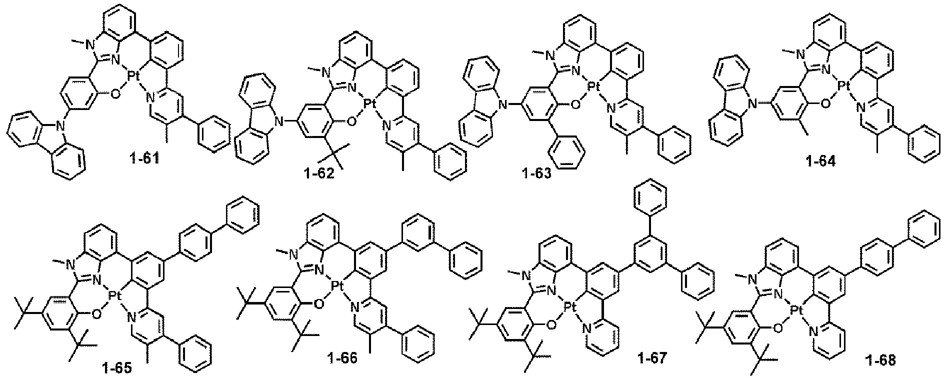 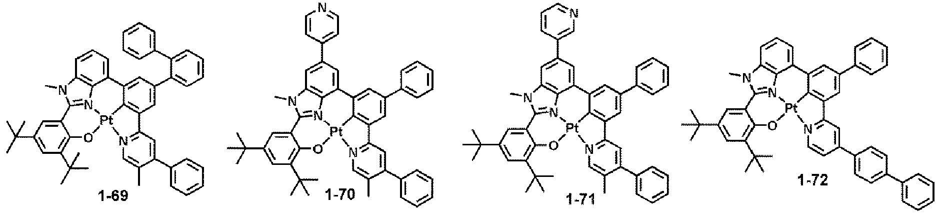 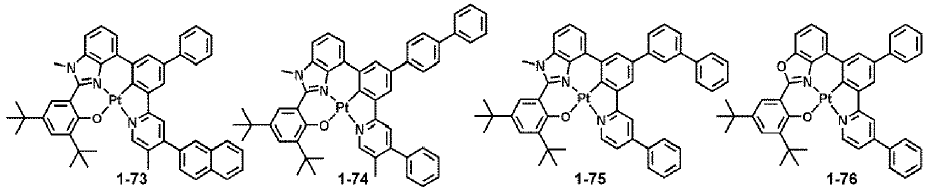 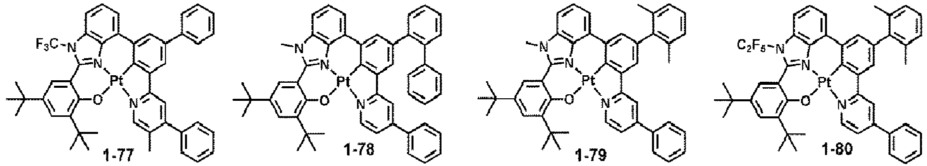 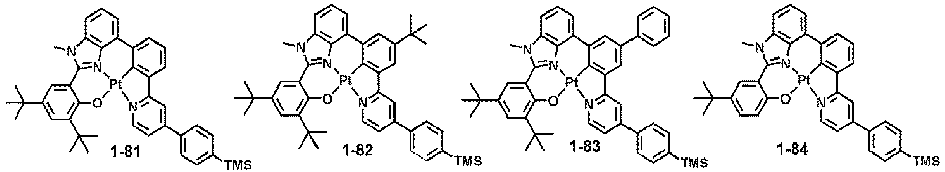 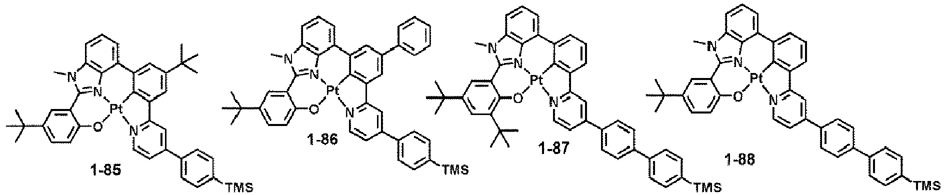 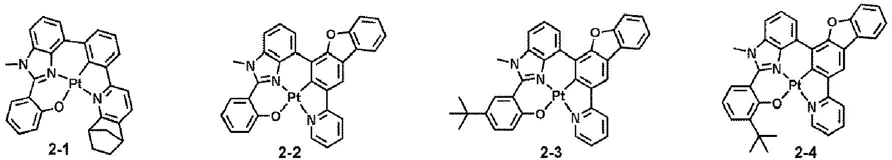 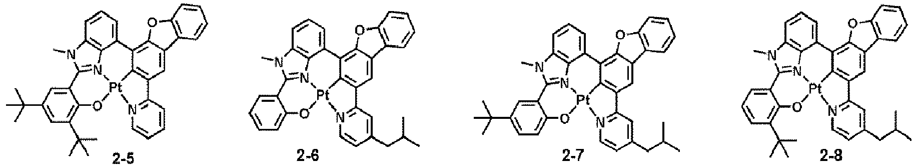 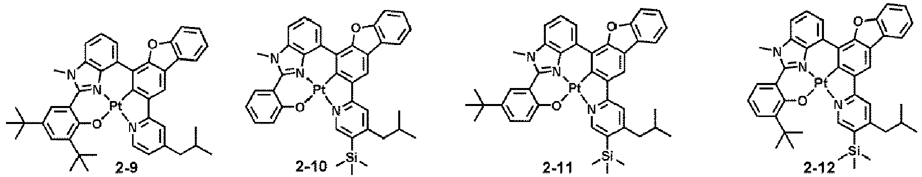 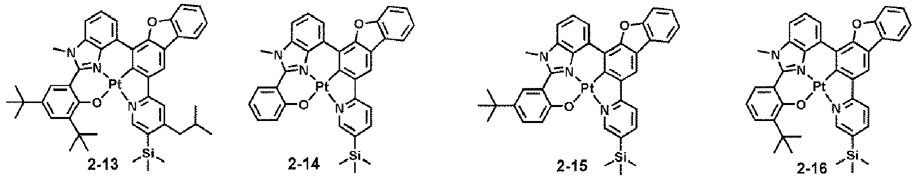 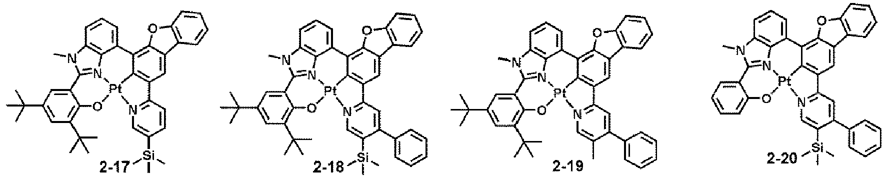 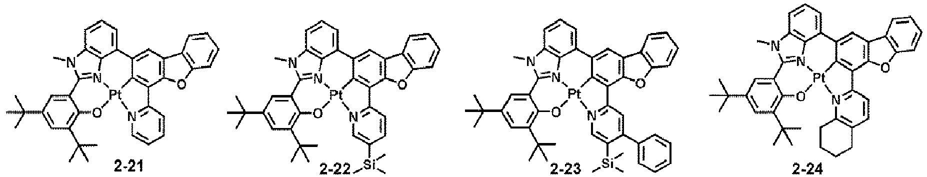 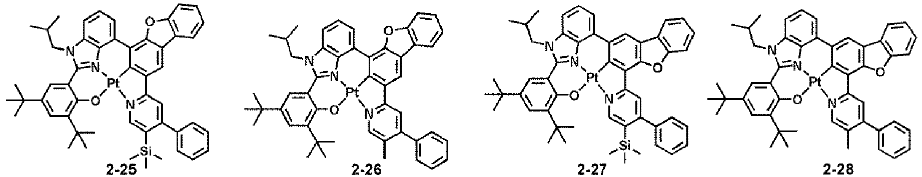 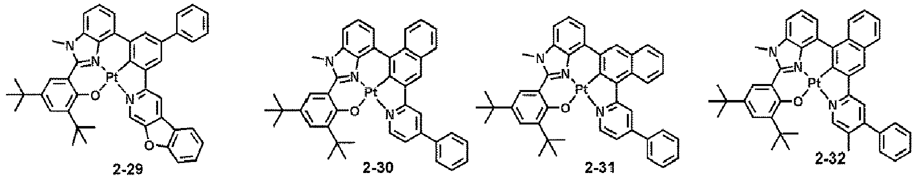 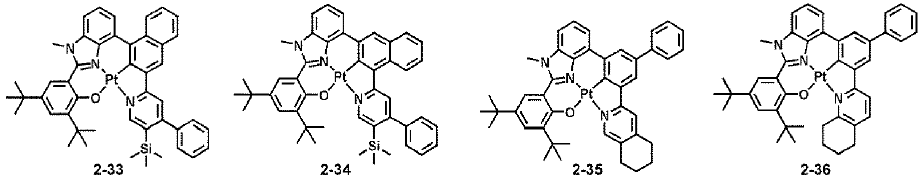 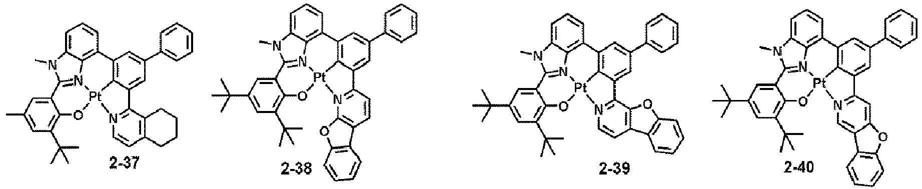 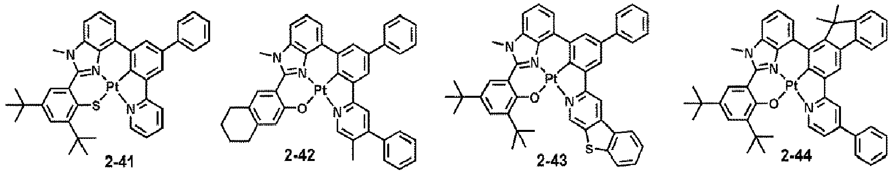 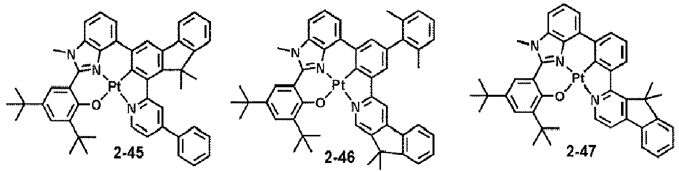 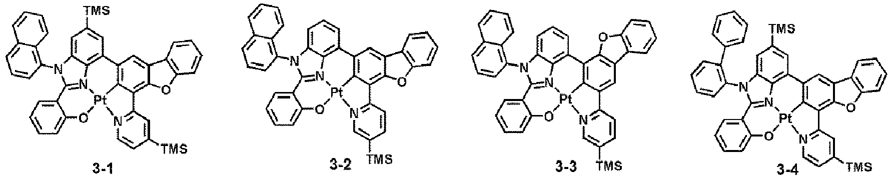 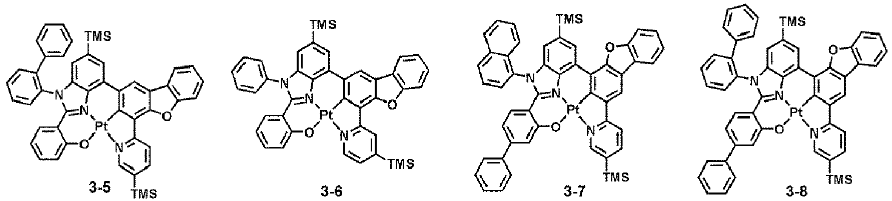 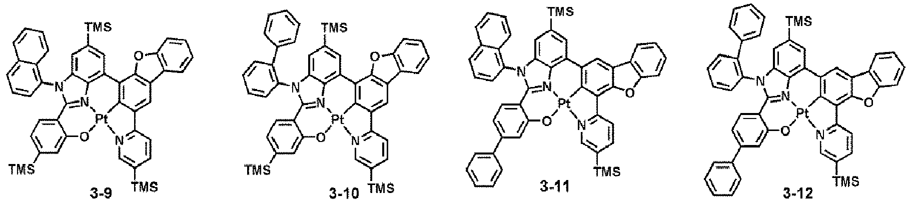 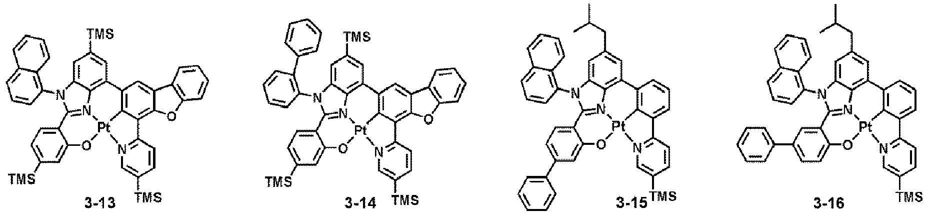 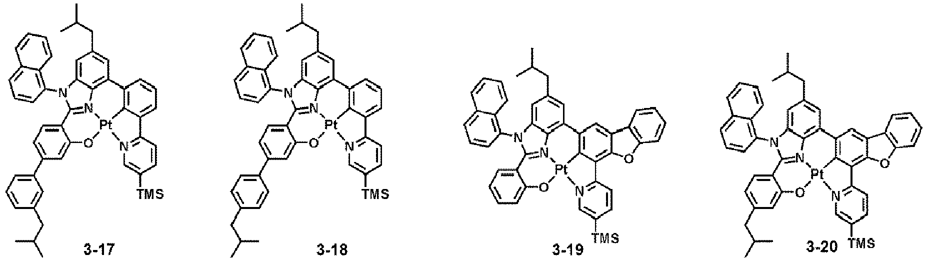 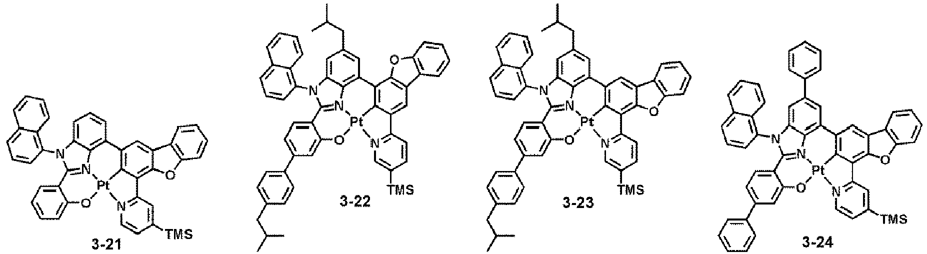 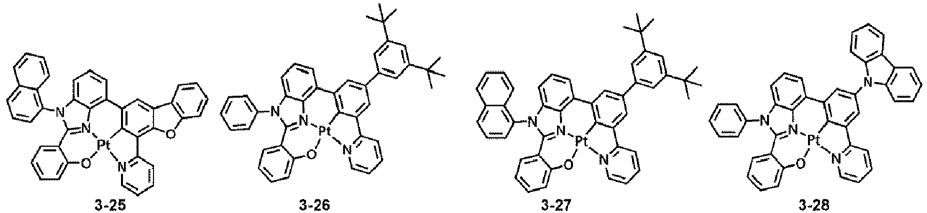 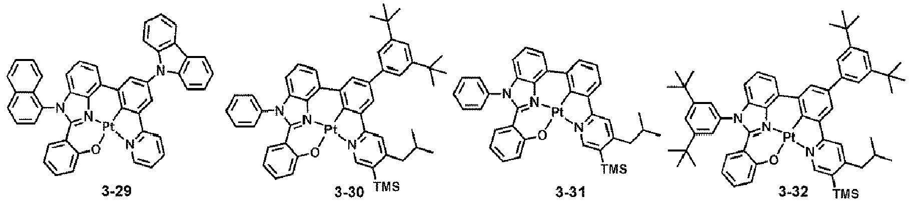 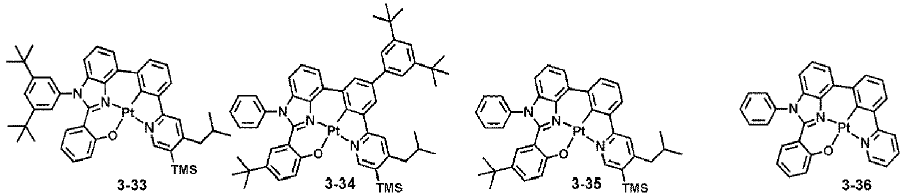 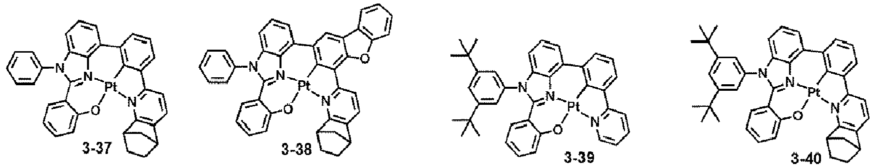 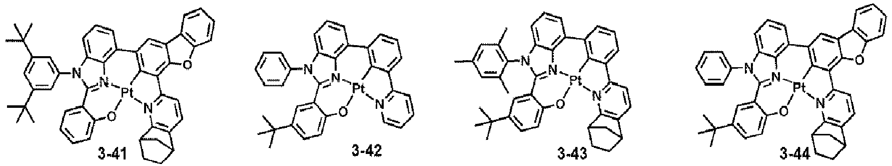 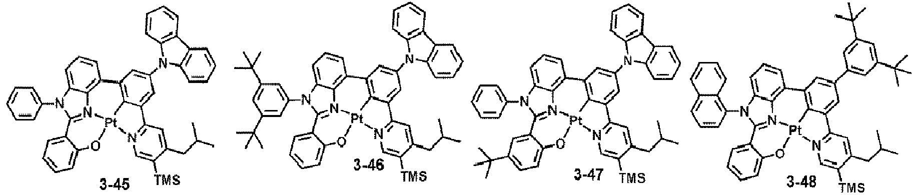 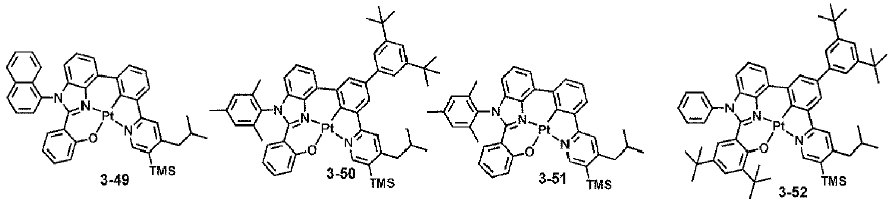 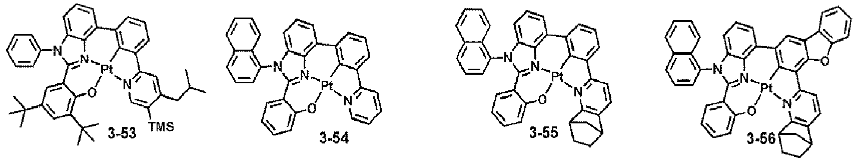 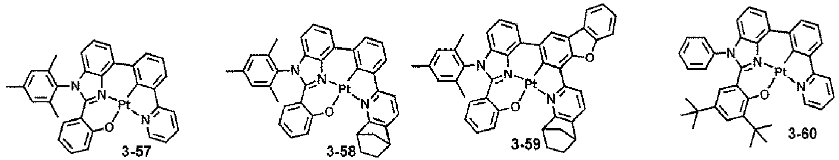 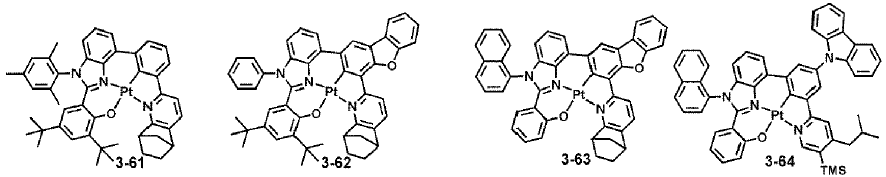 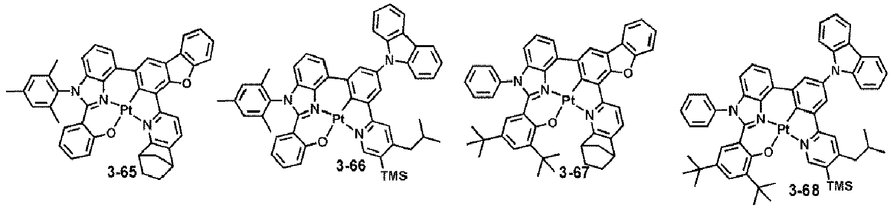 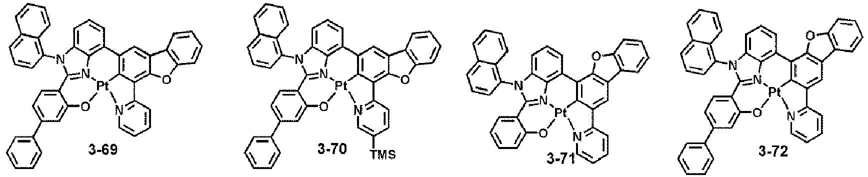 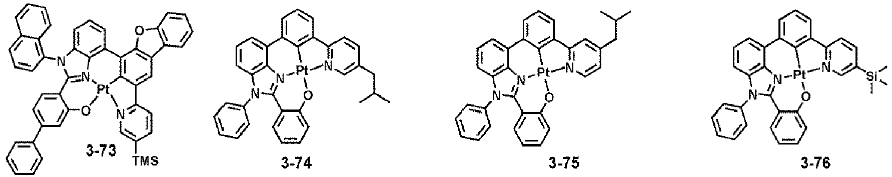 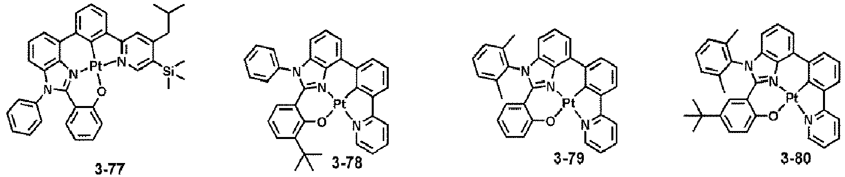 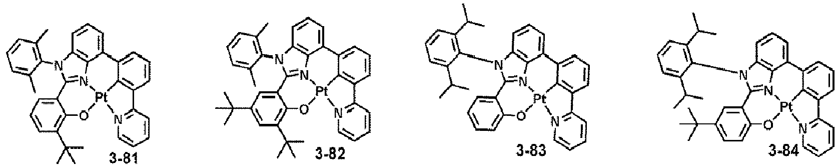 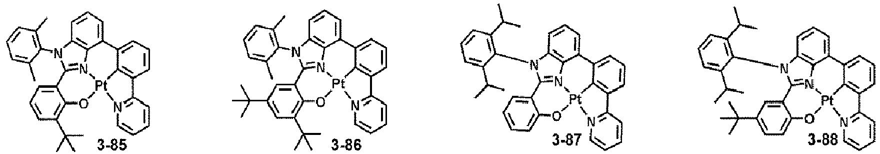 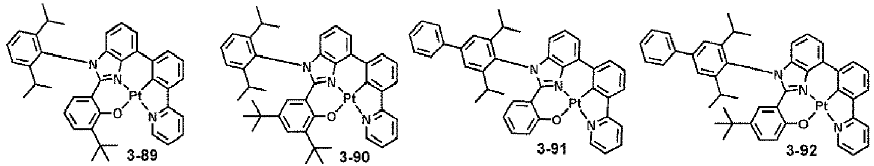 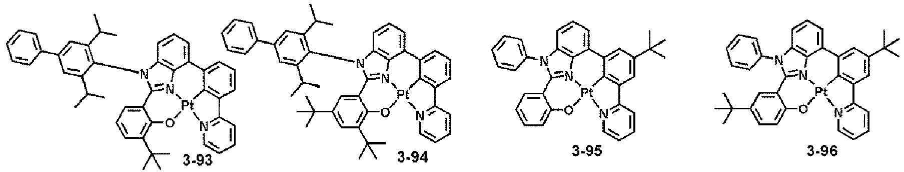 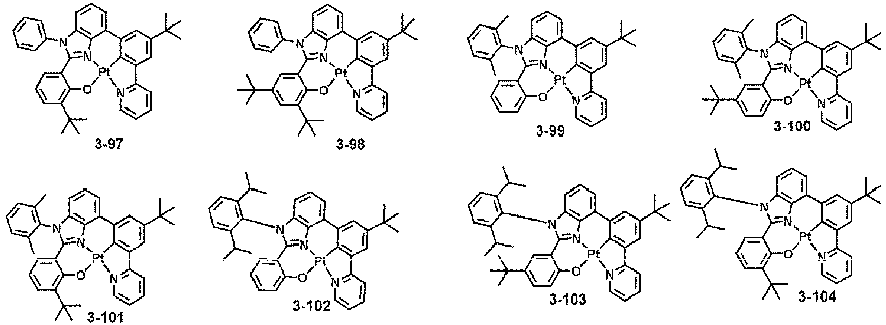 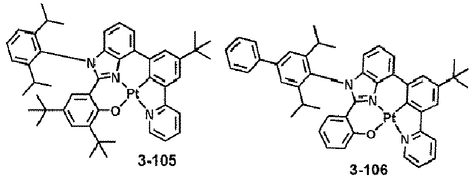 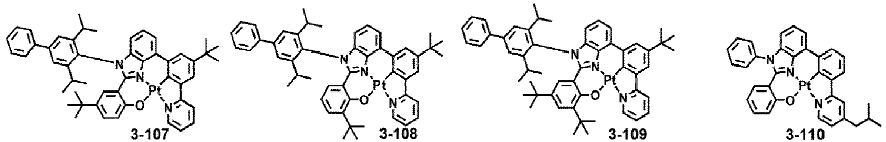 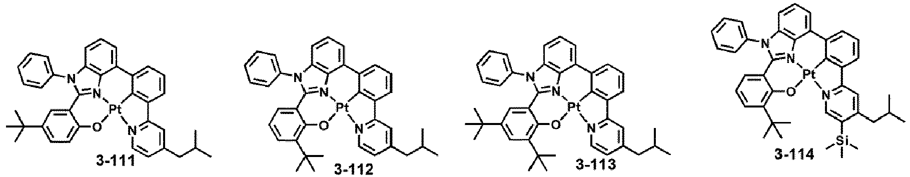 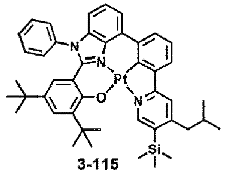 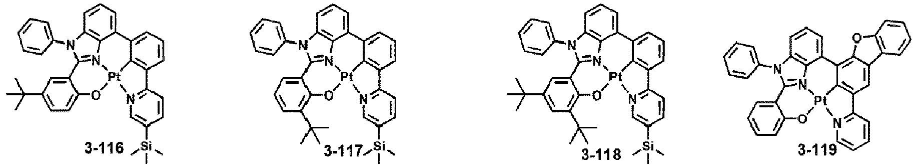 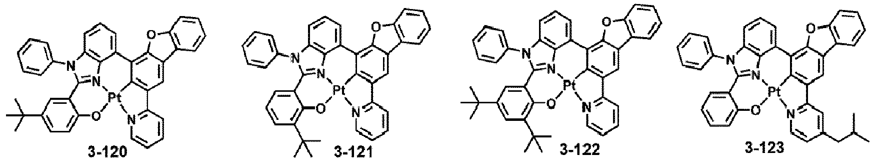 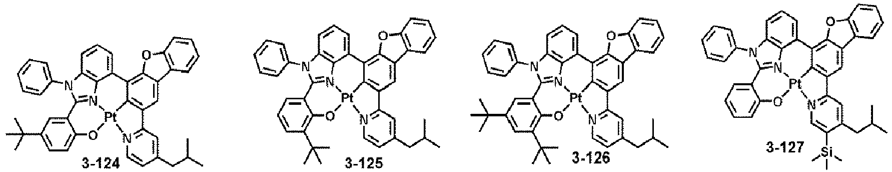 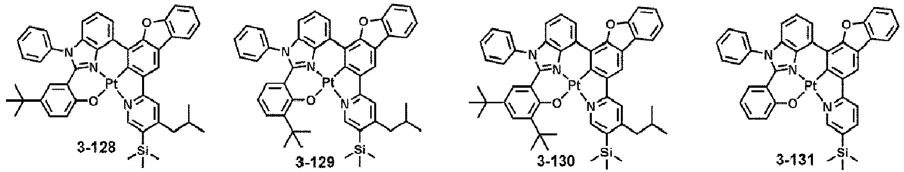 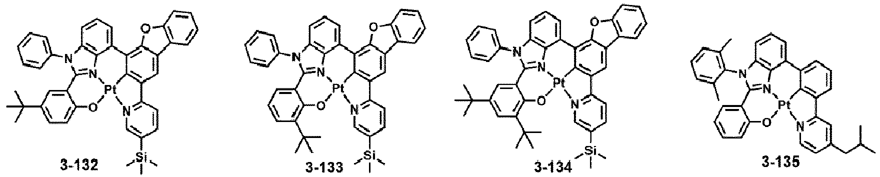 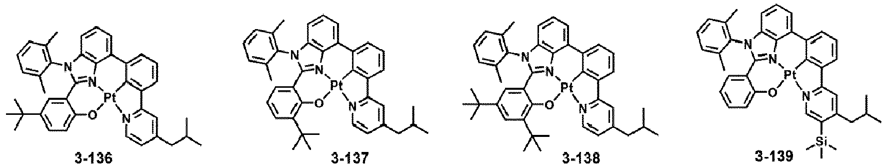 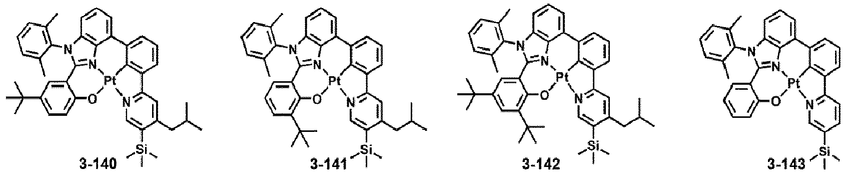 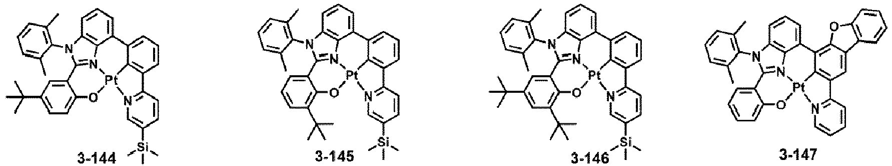 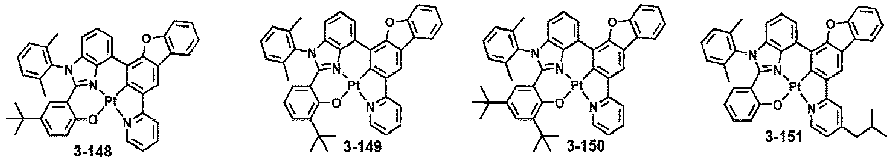 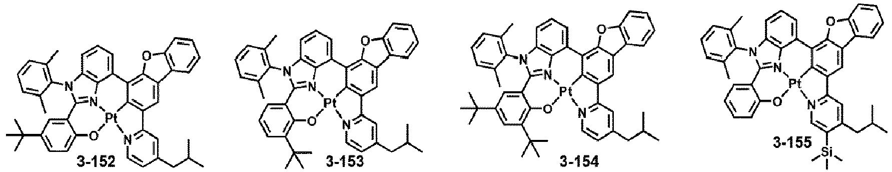 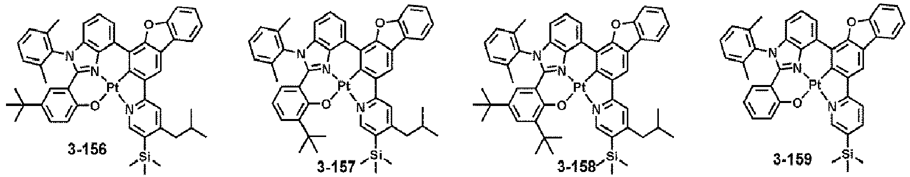 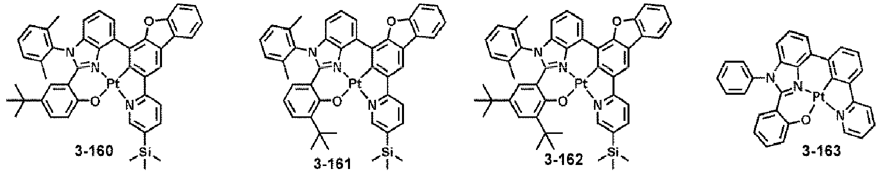 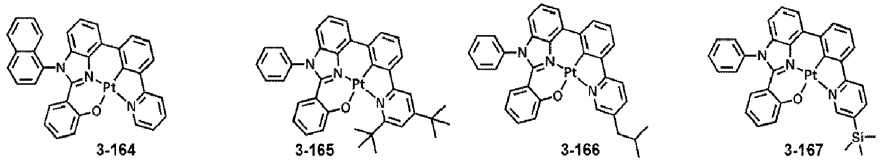 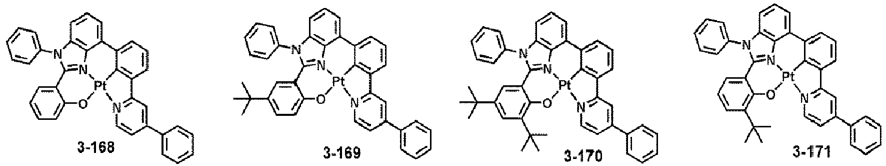 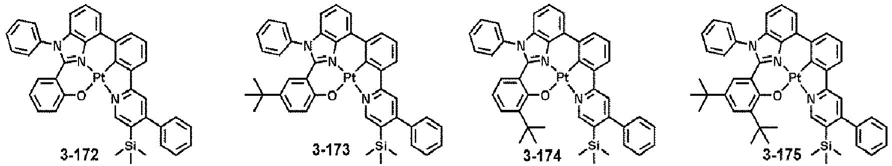 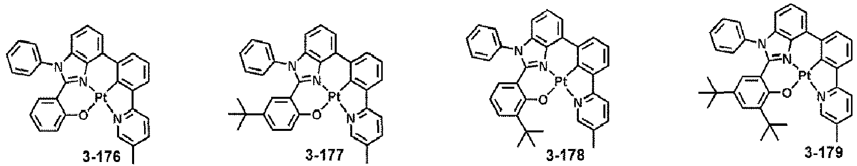 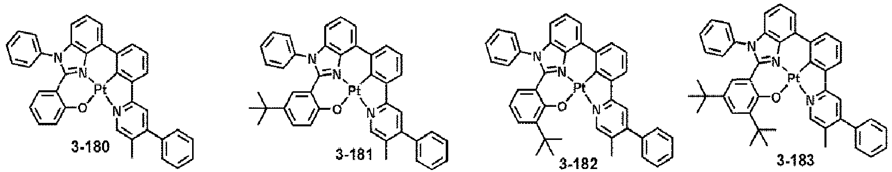 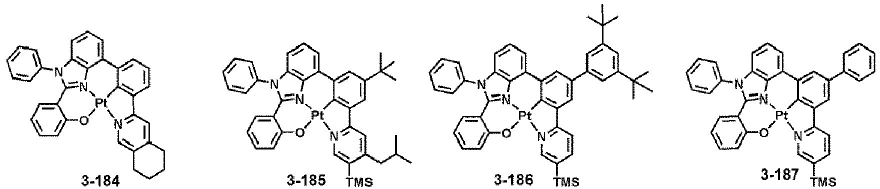 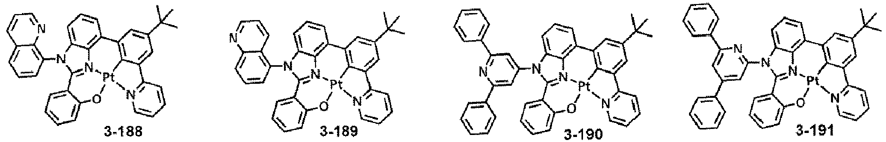 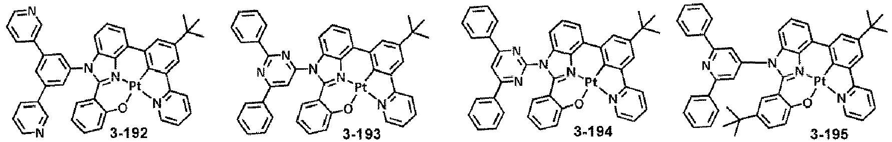 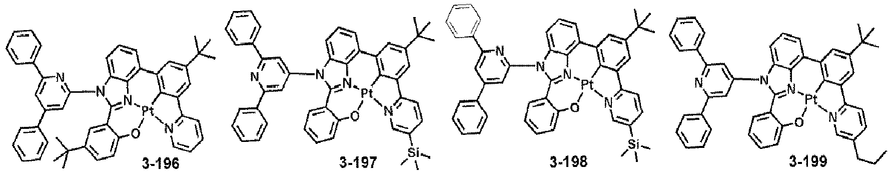 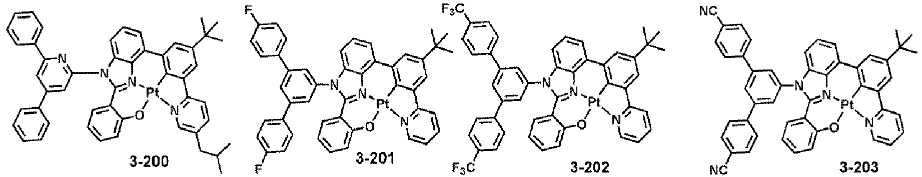 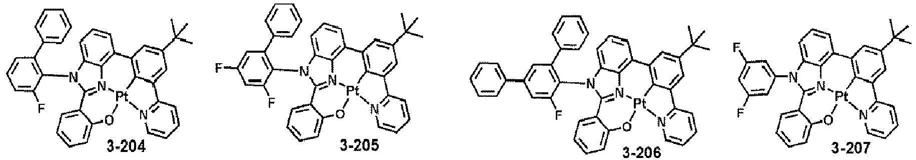 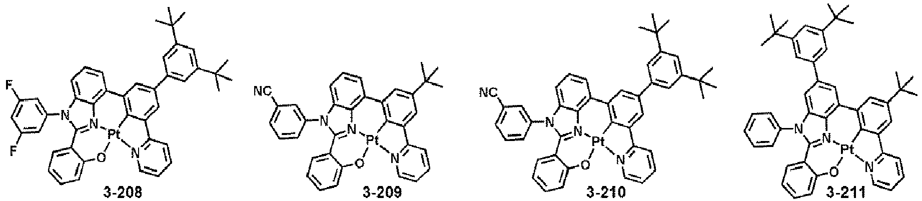 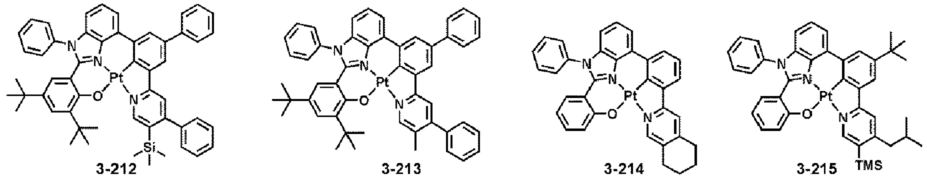 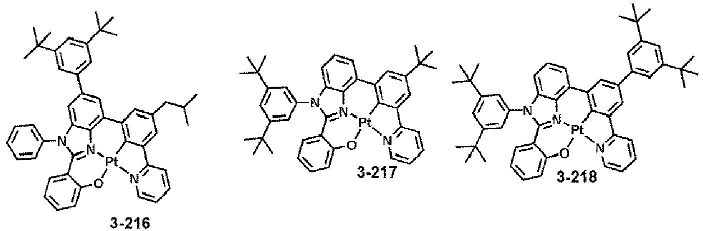 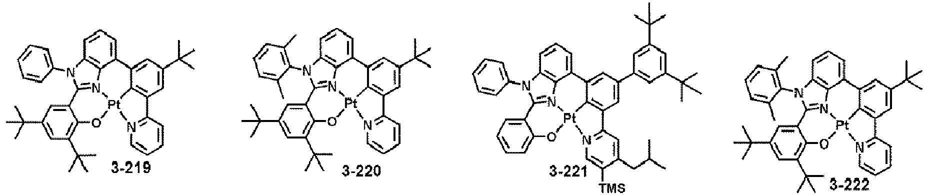 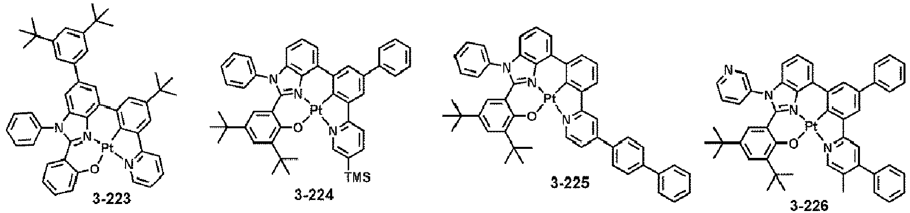 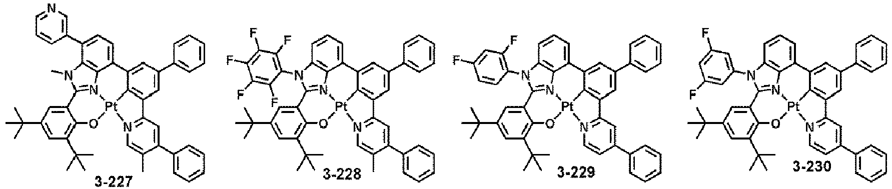 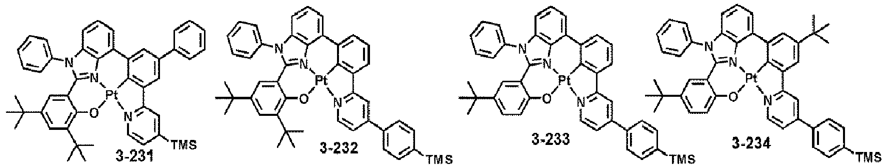 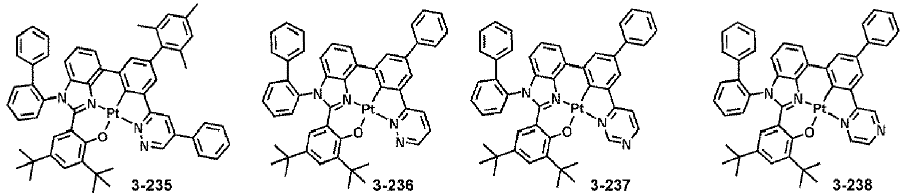 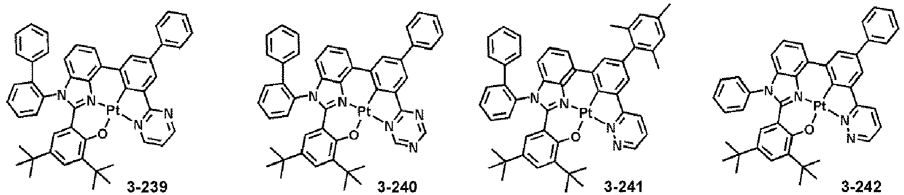 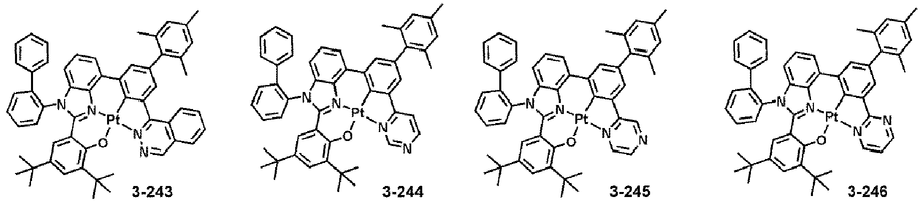 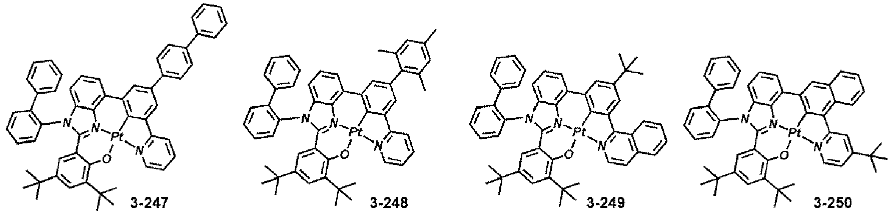 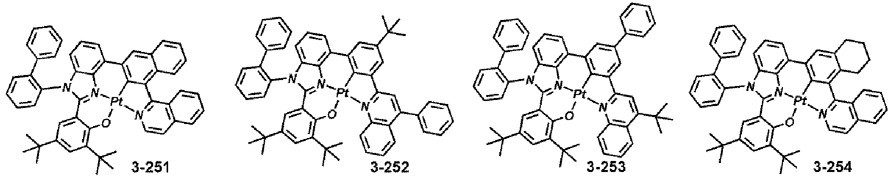 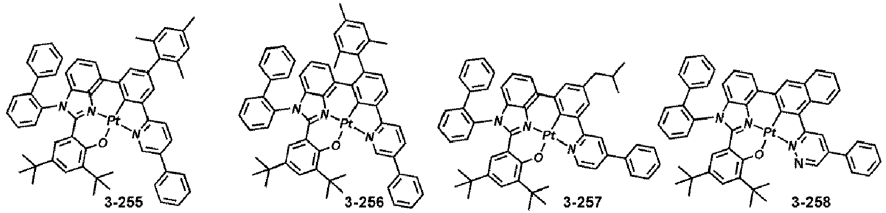 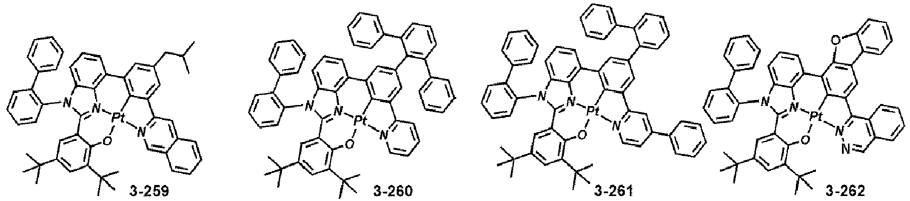 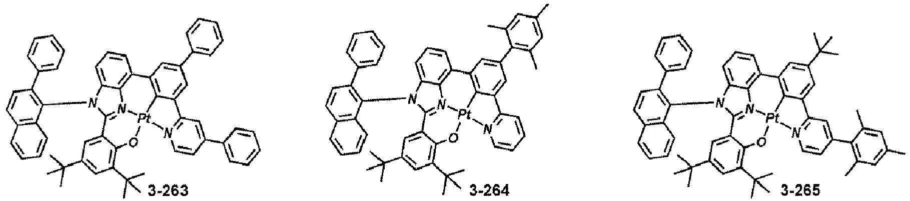 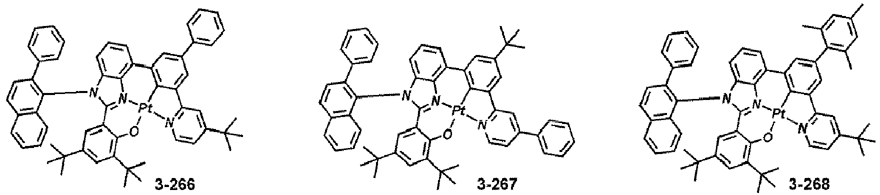 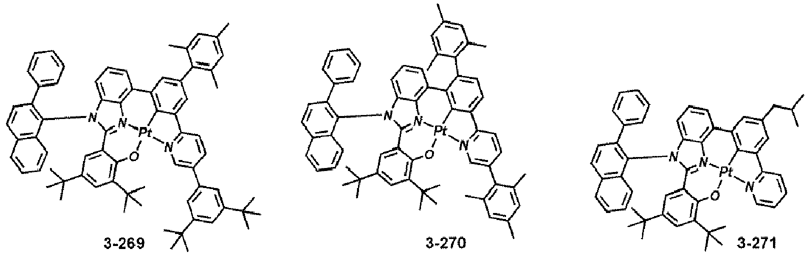 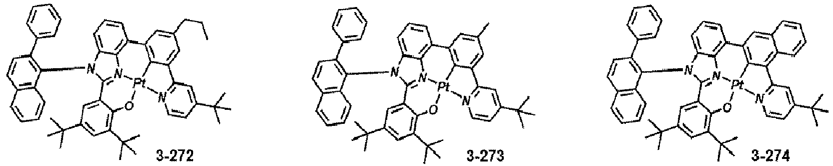 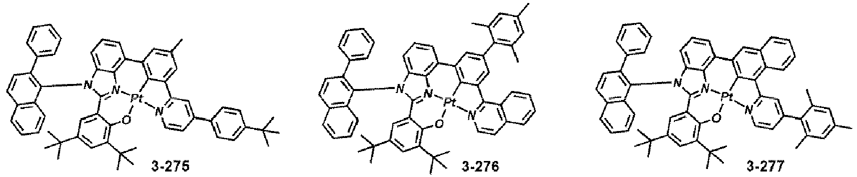 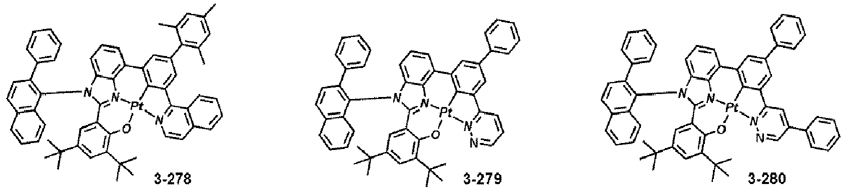 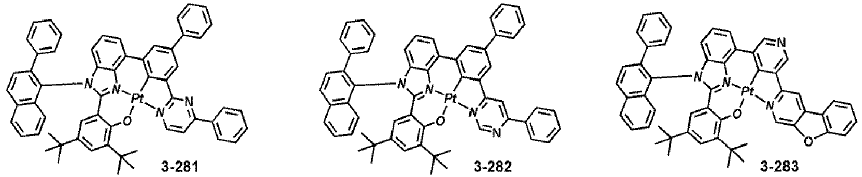 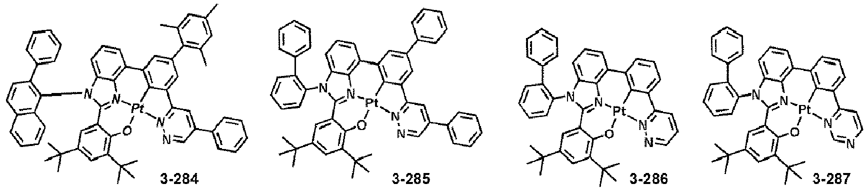 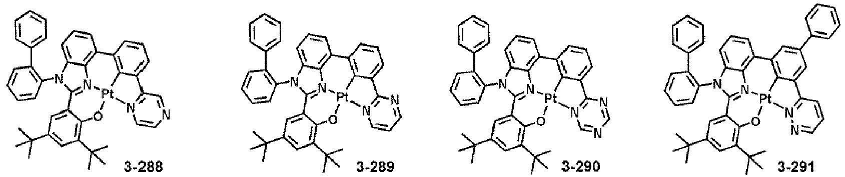 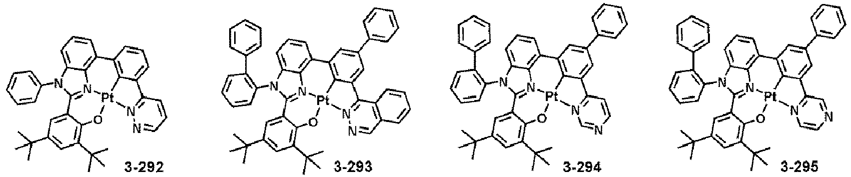 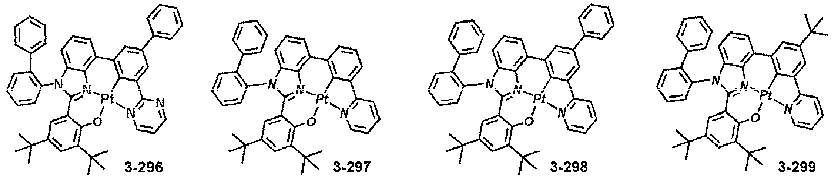 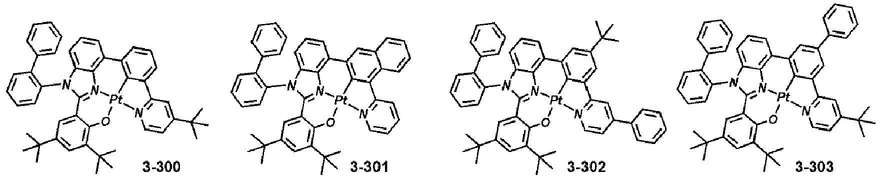 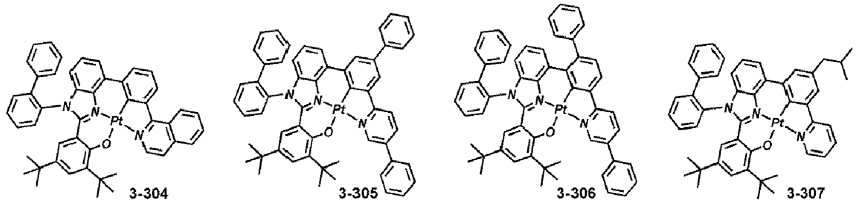 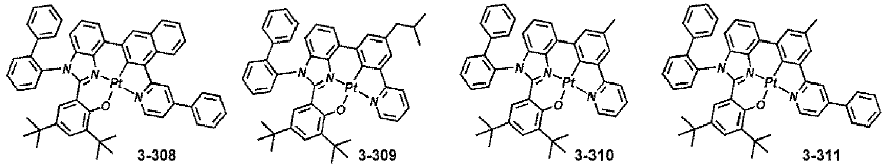 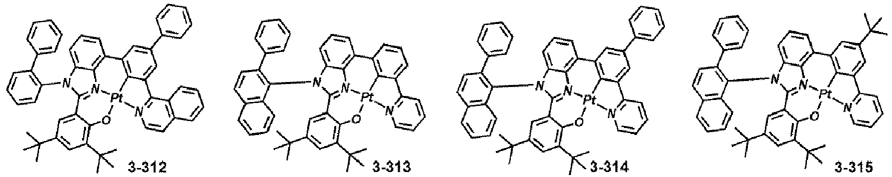 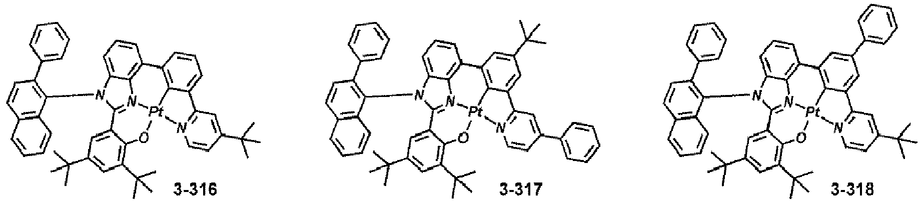 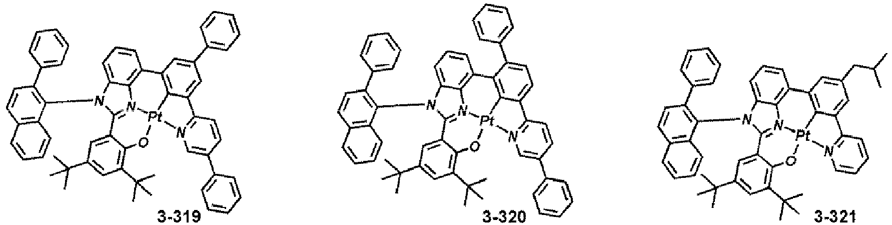 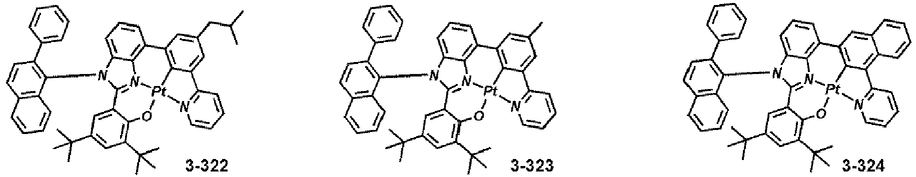 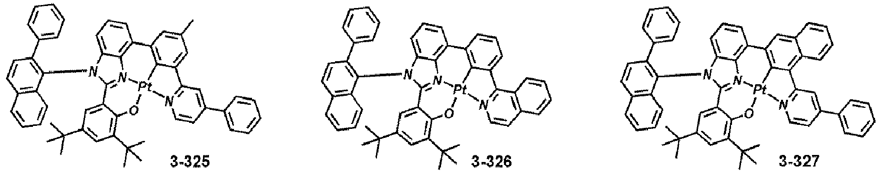 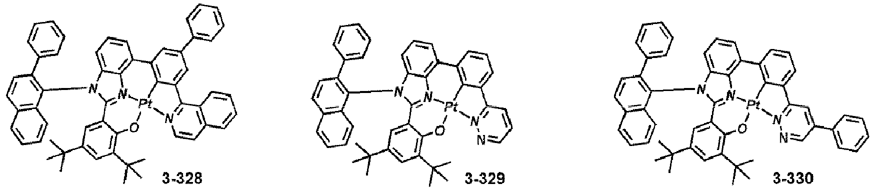 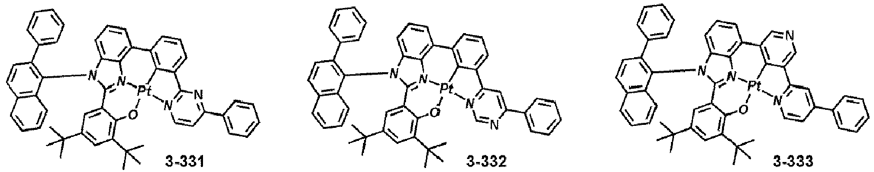 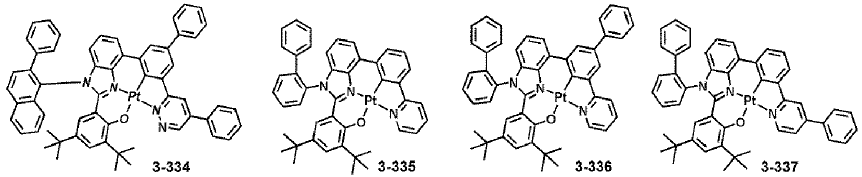 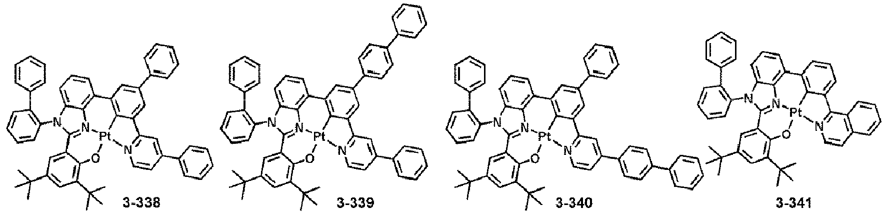 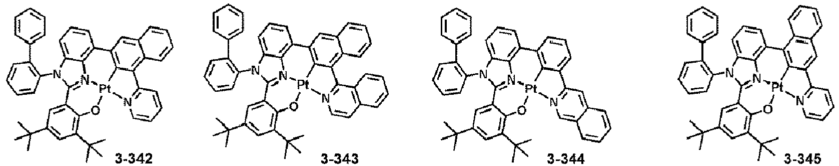 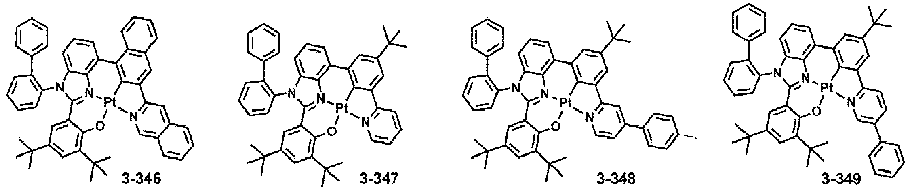 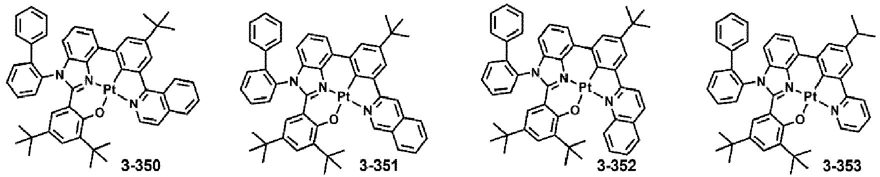 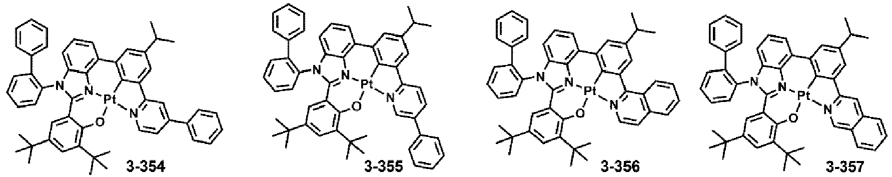 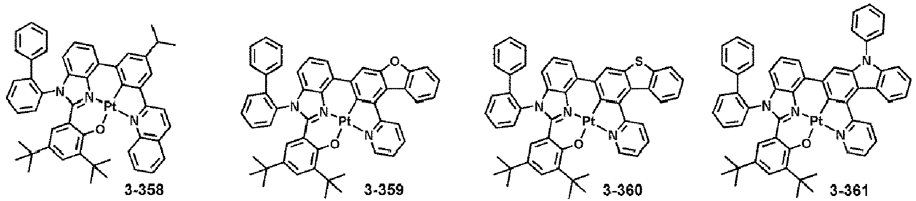 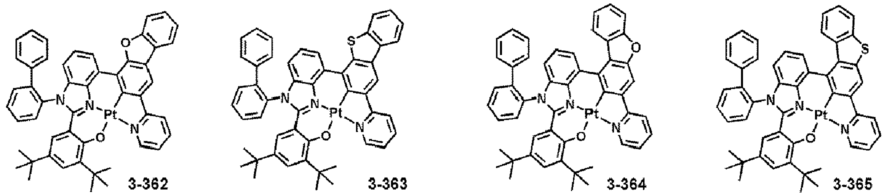 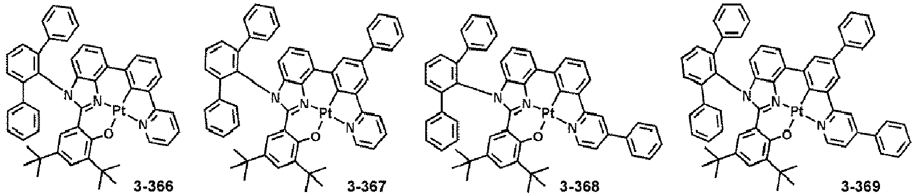 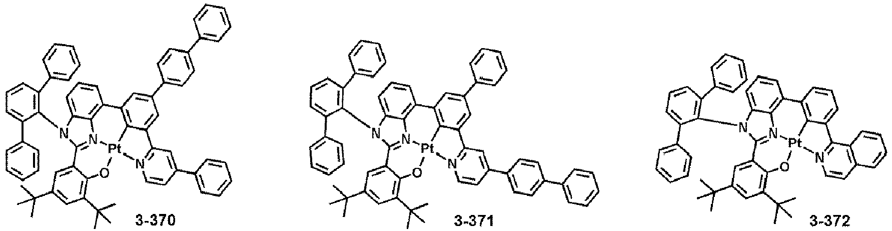 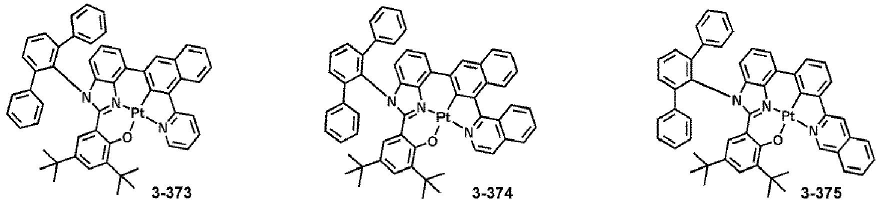 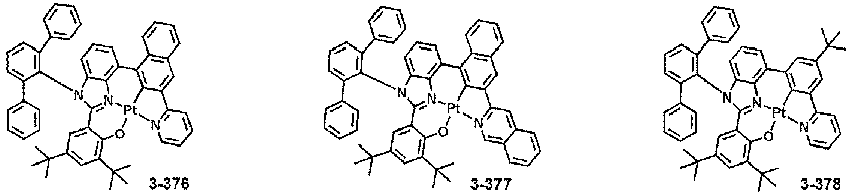 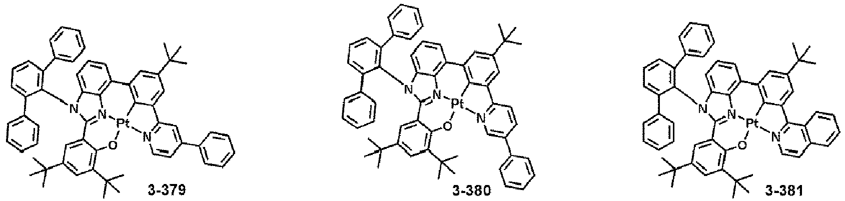 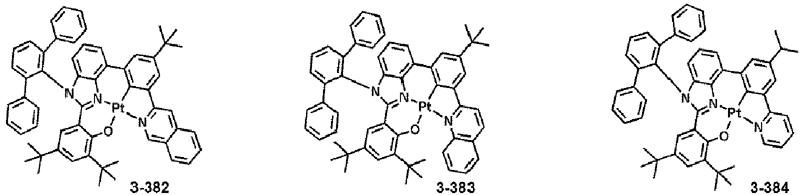 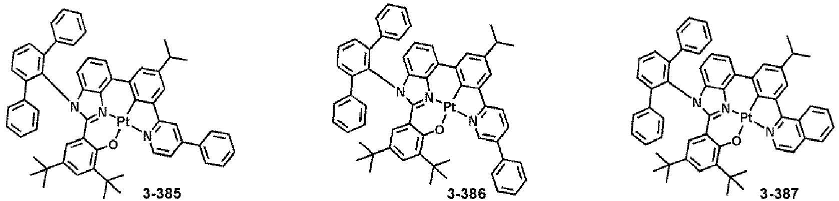 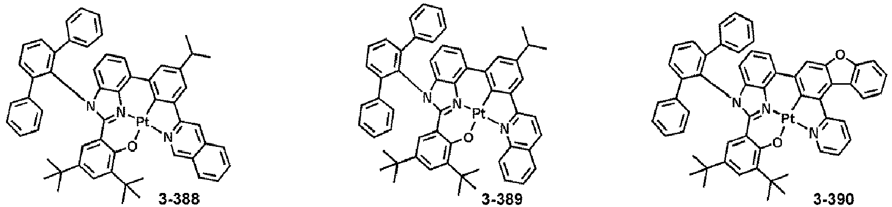 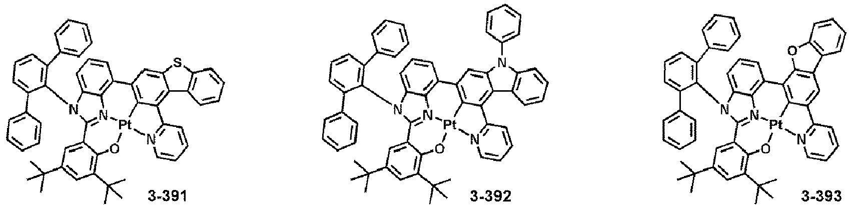 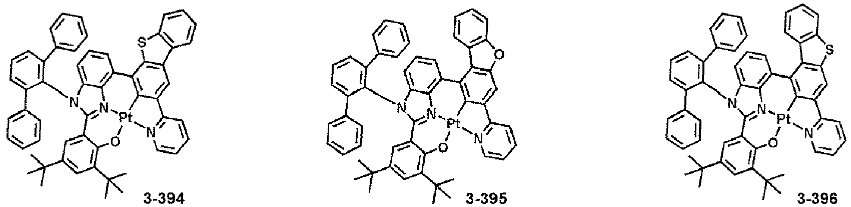 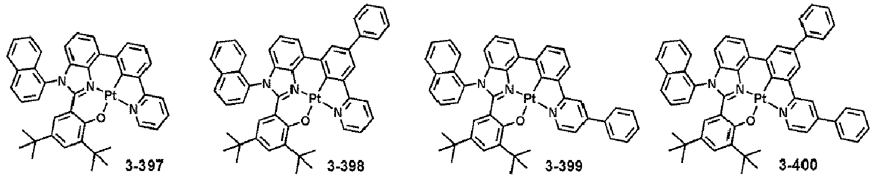 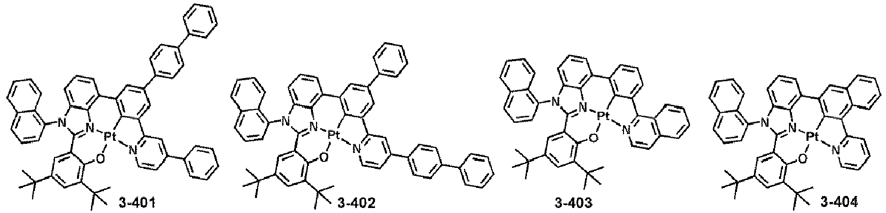 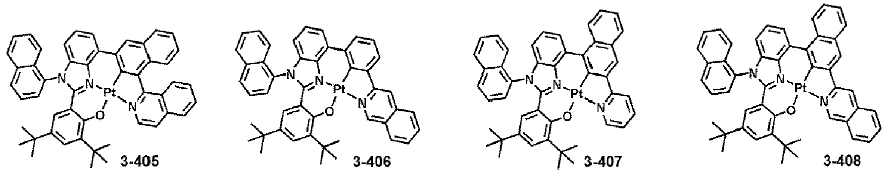 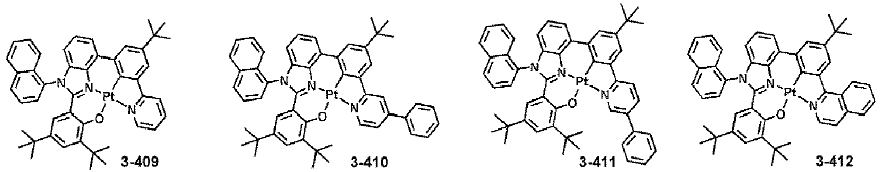 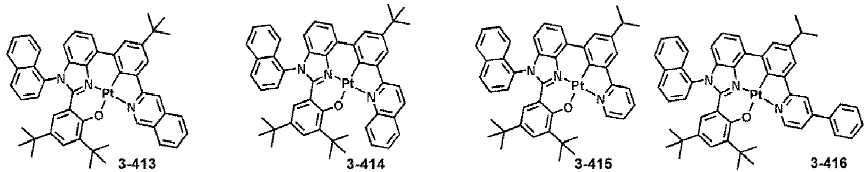 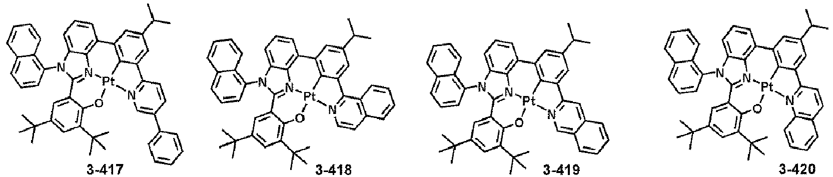 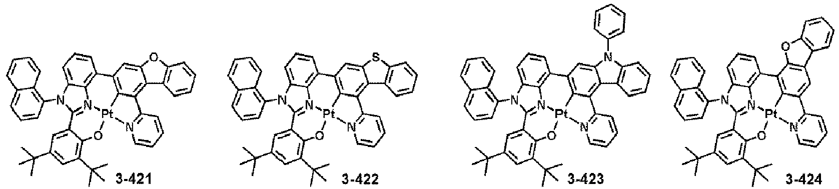 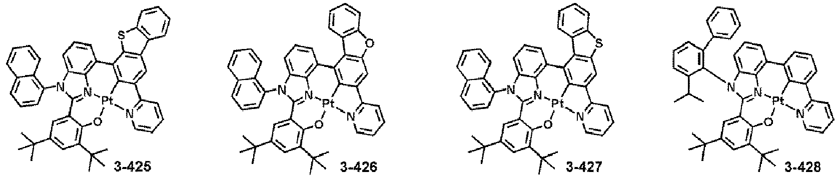 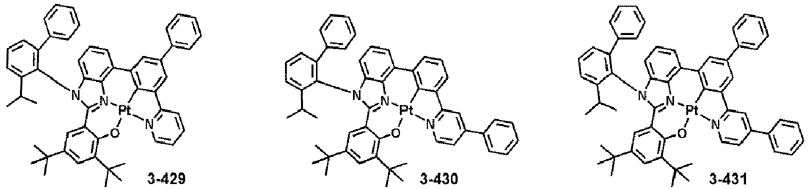 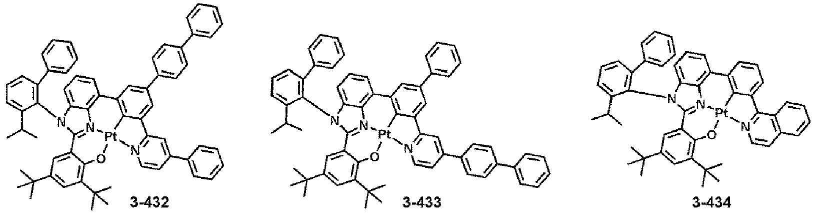 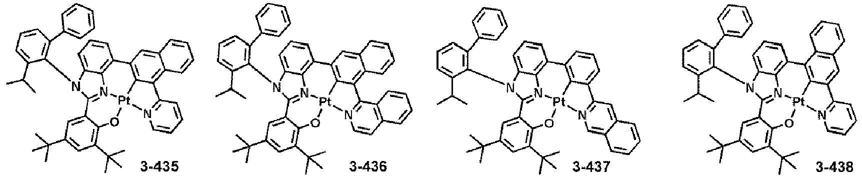 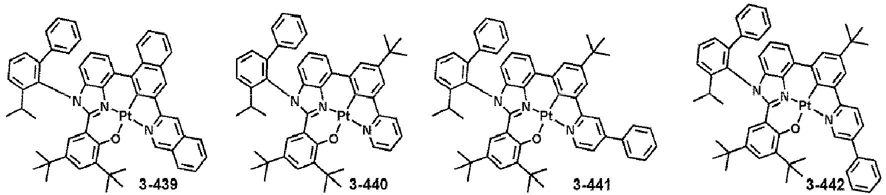 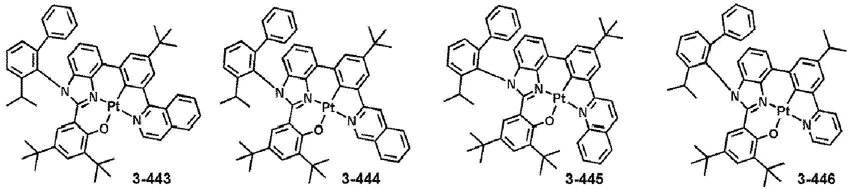 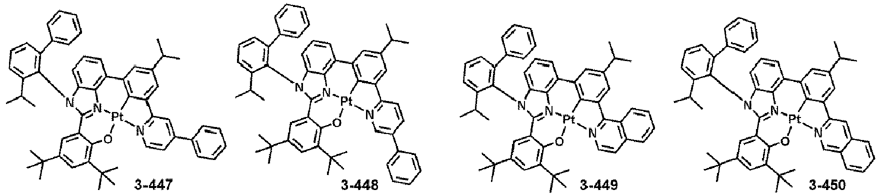 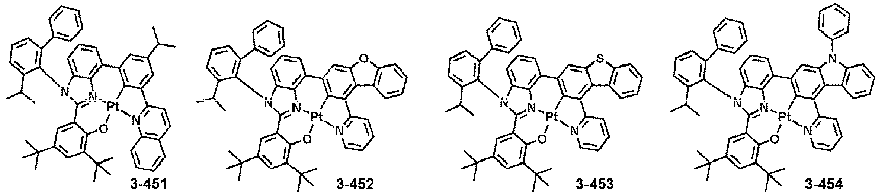 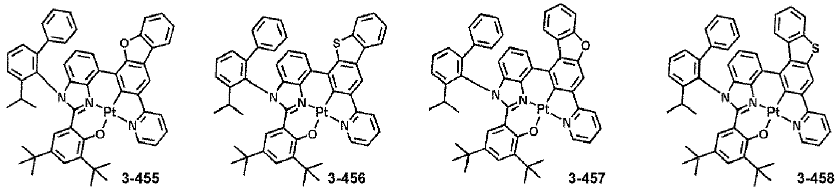 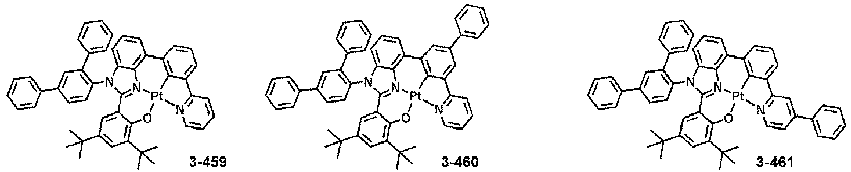 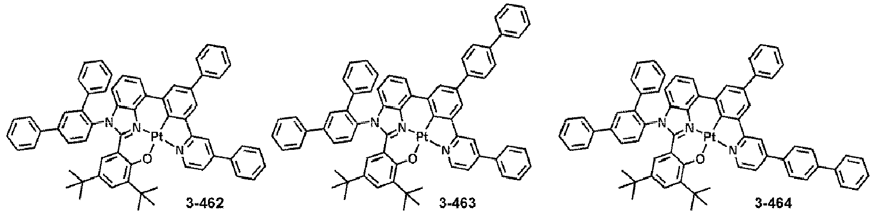 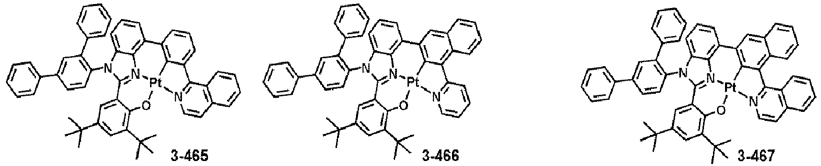 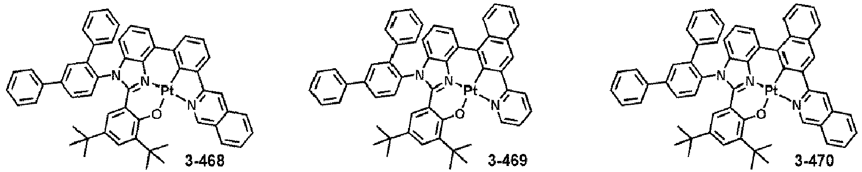 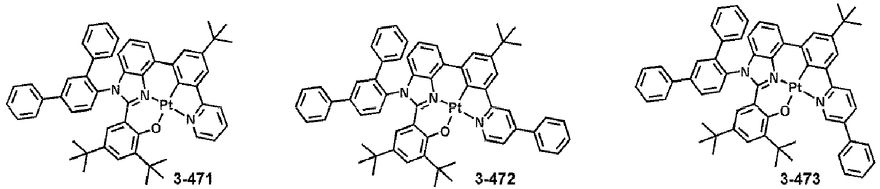 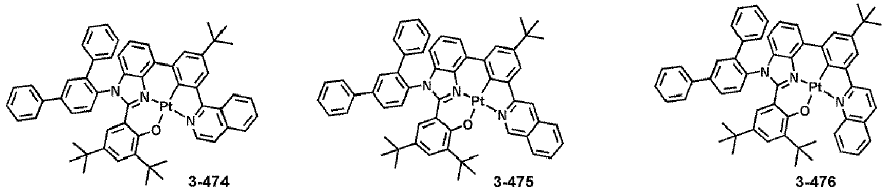 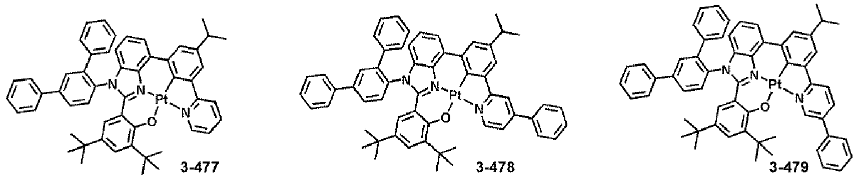 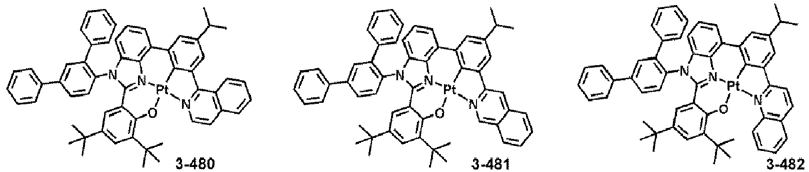 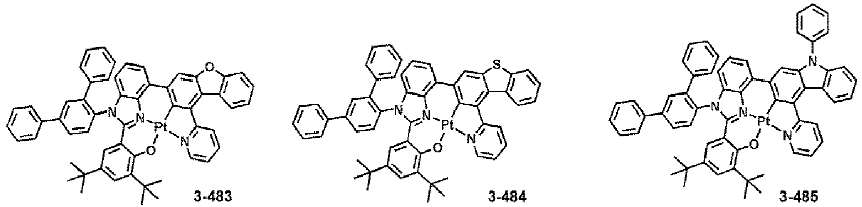 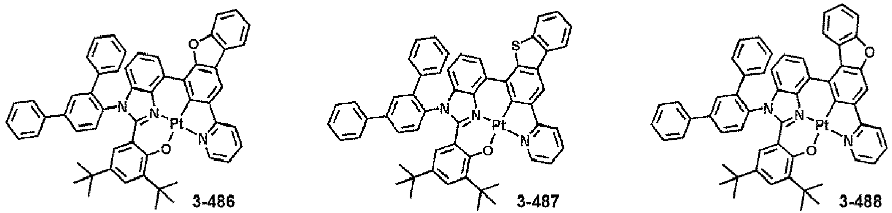 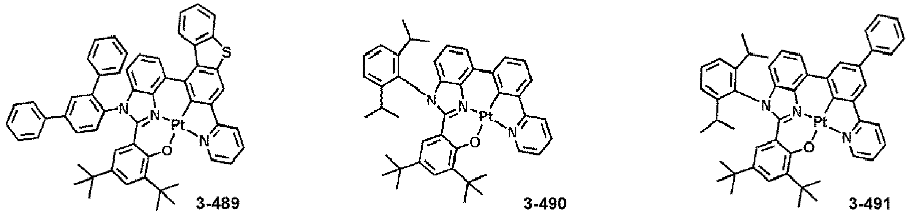 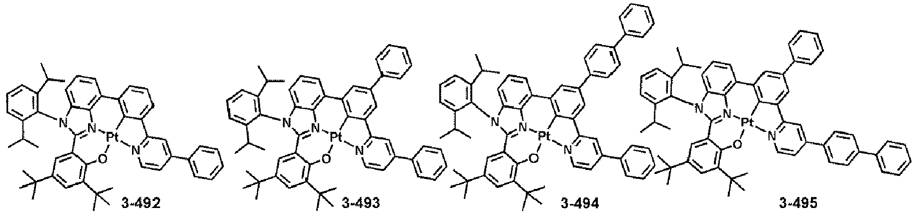 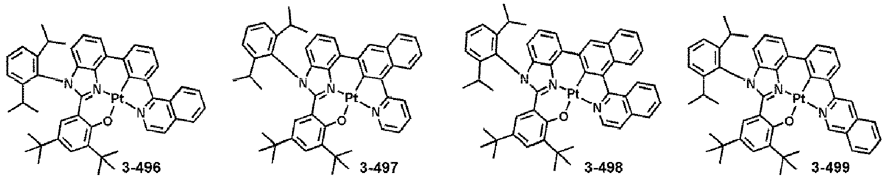 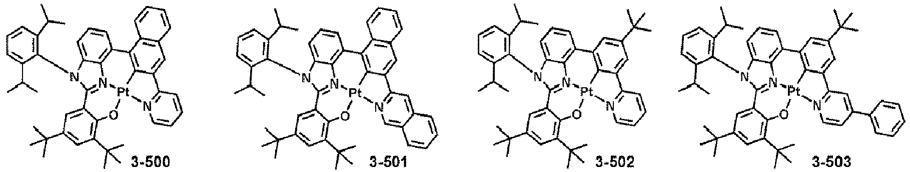 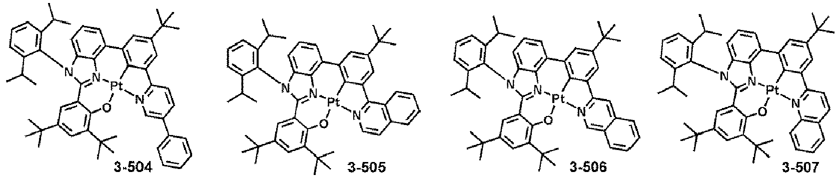 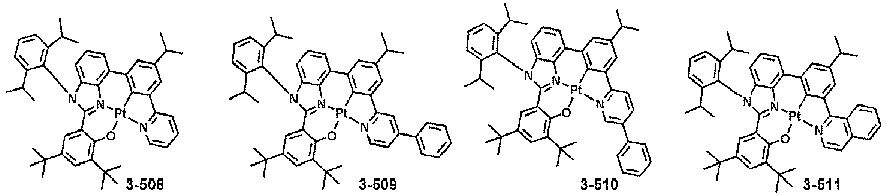 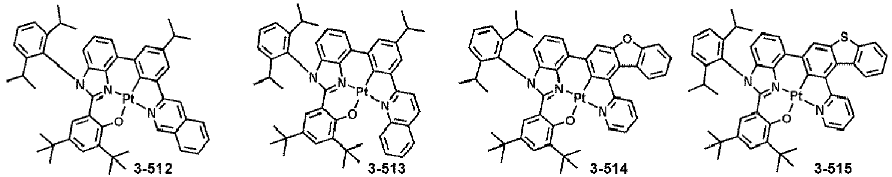 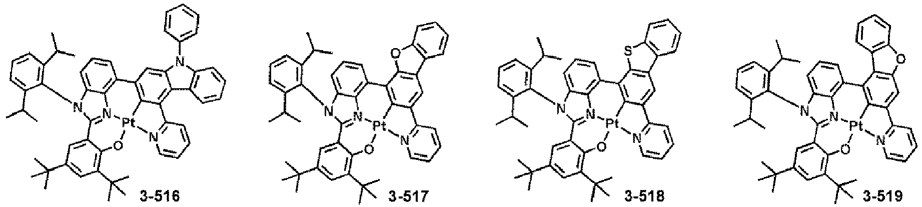 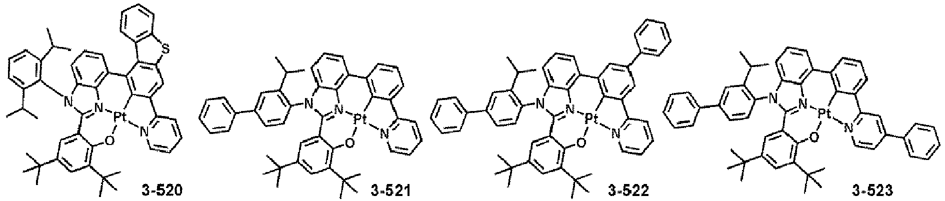 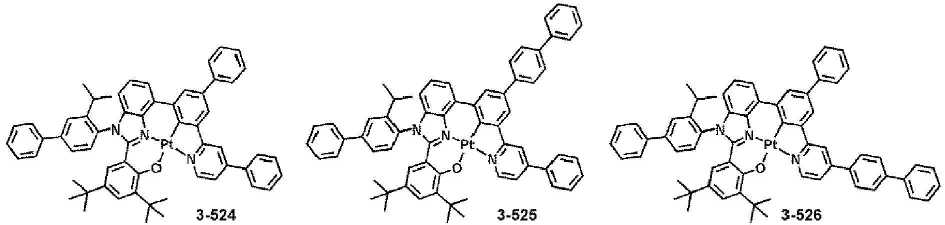 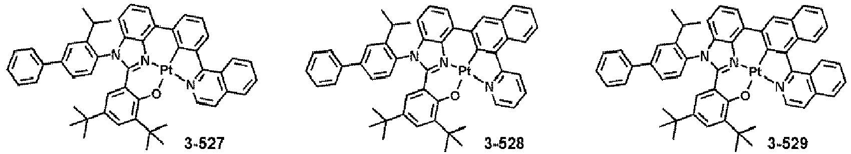 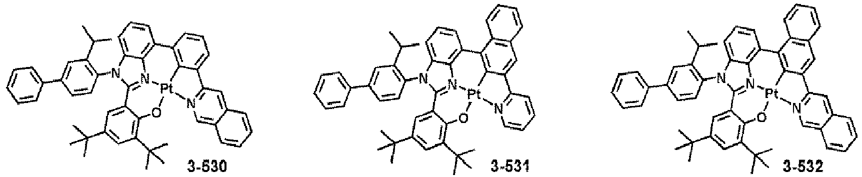 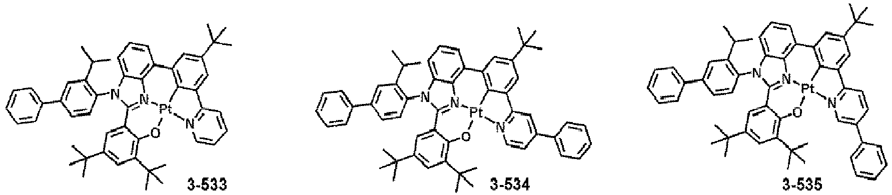 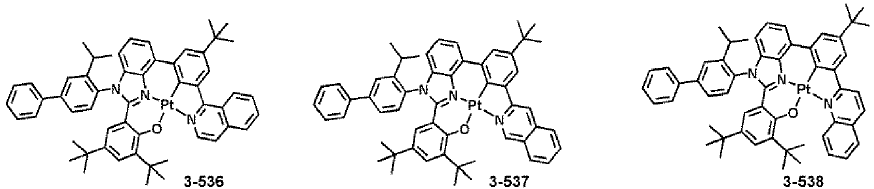 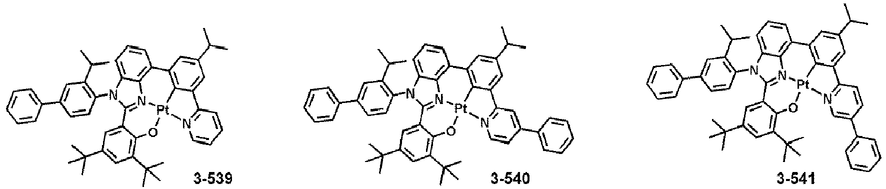 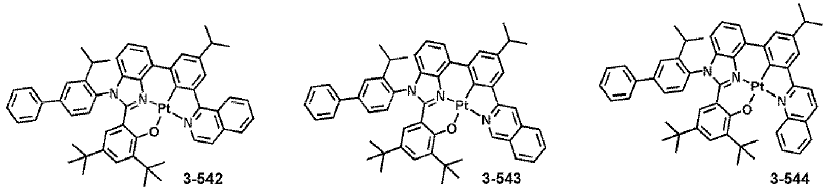 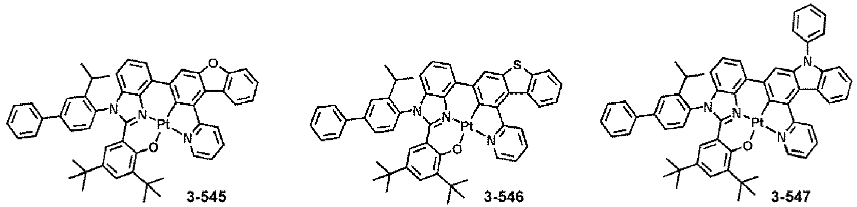 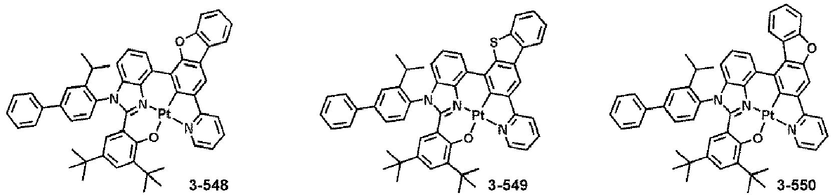 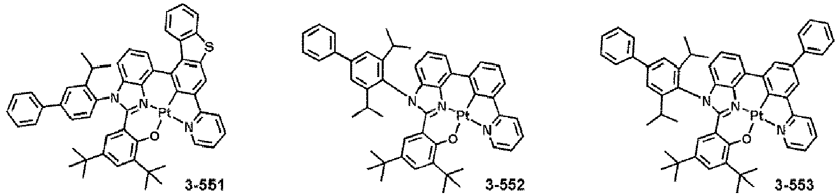 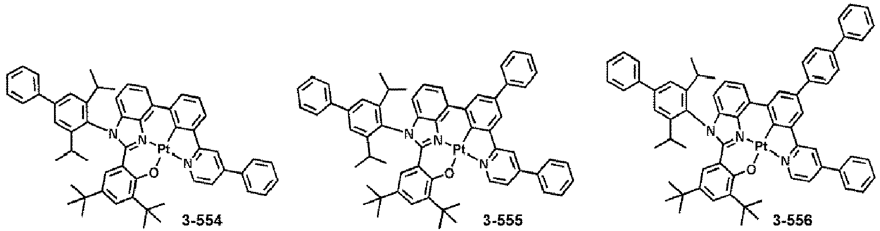 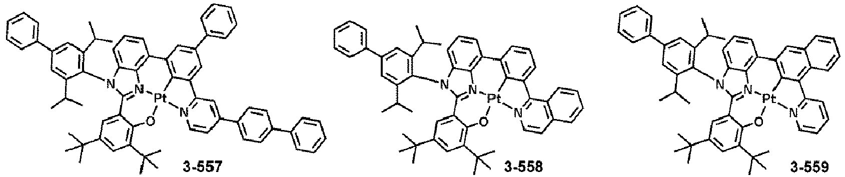 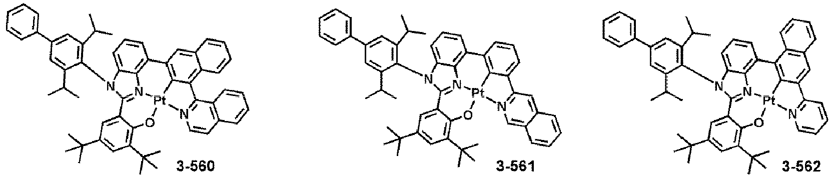 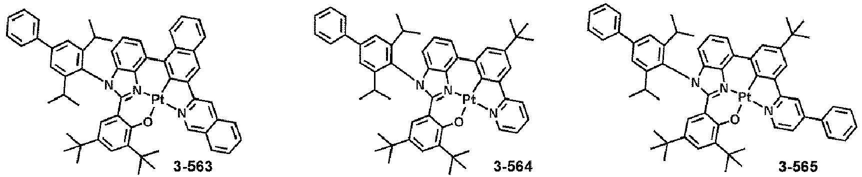 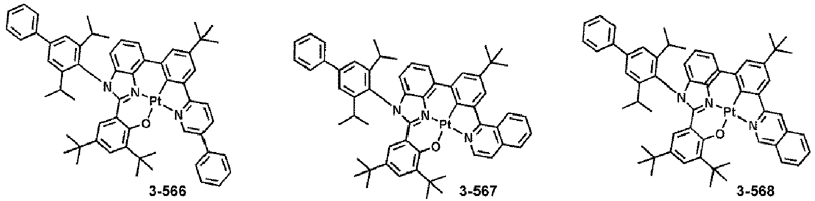 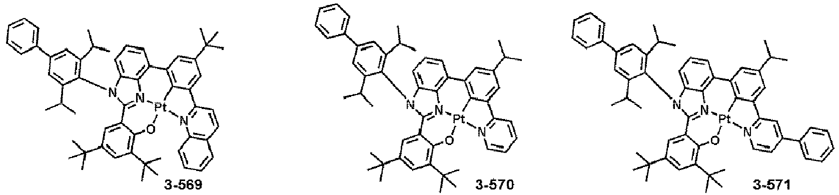 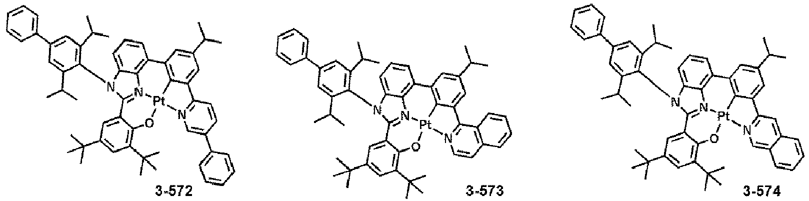 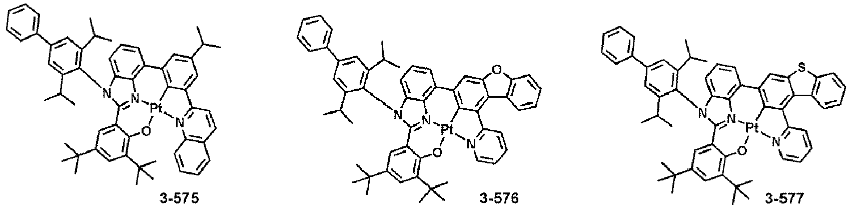 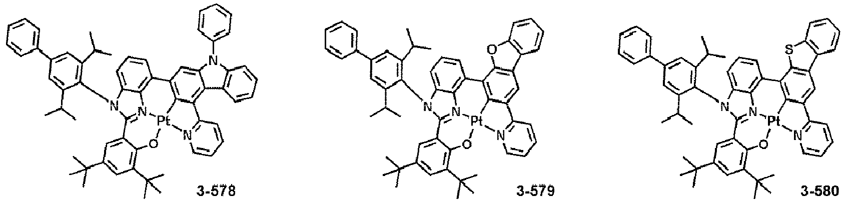 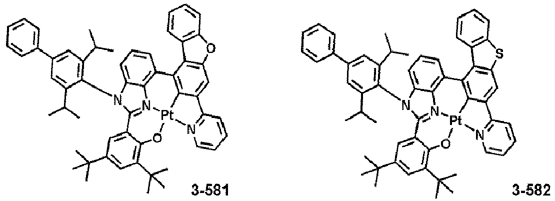
Group 1-2 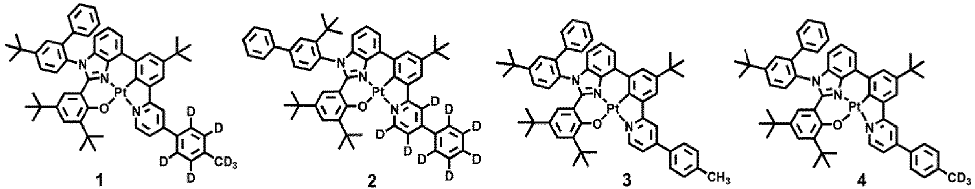 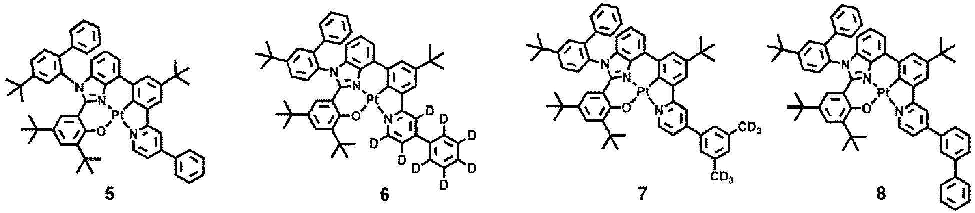 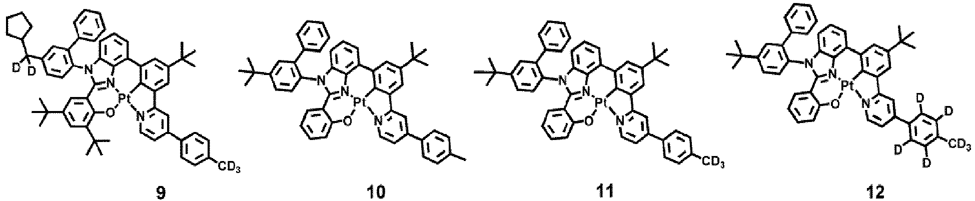 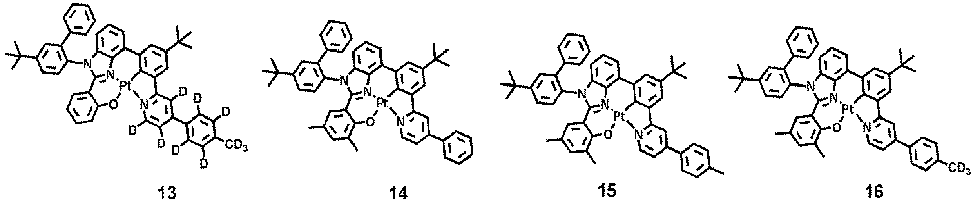 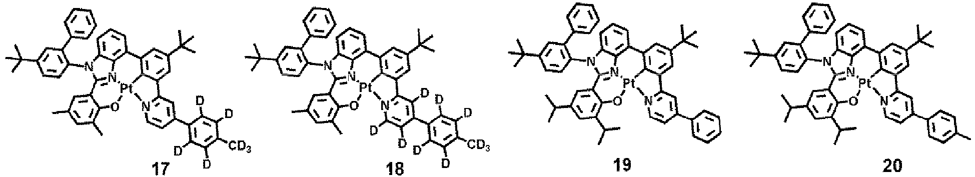 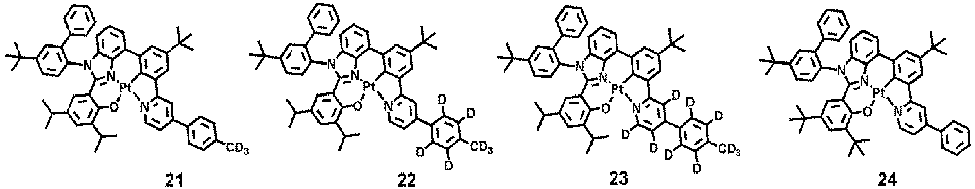 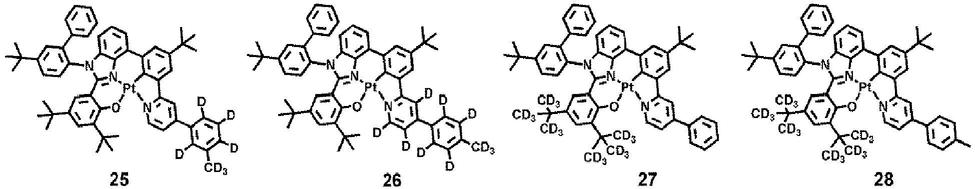 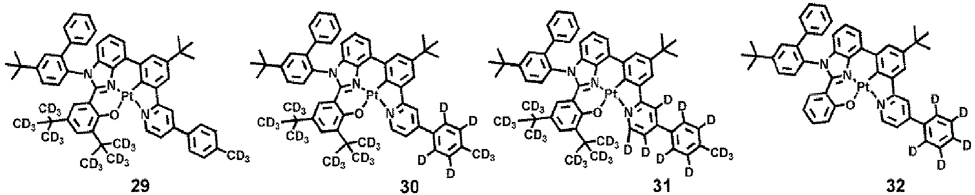 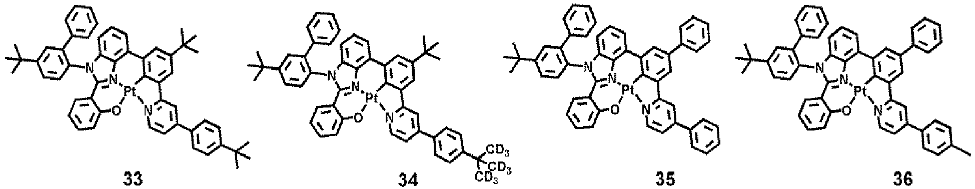 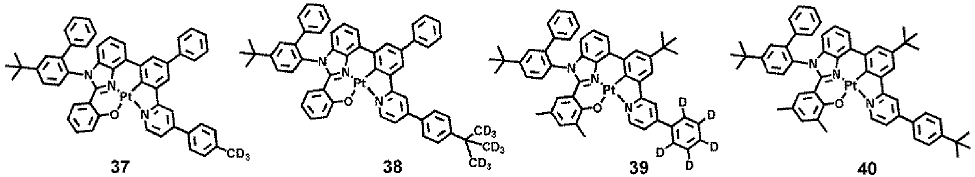 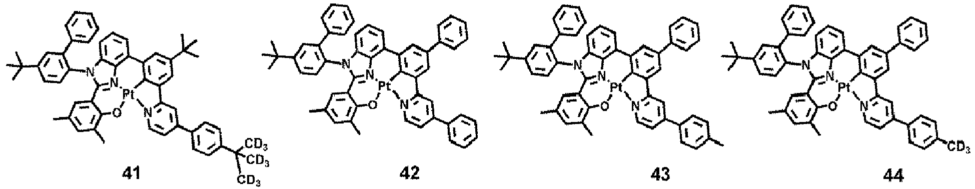 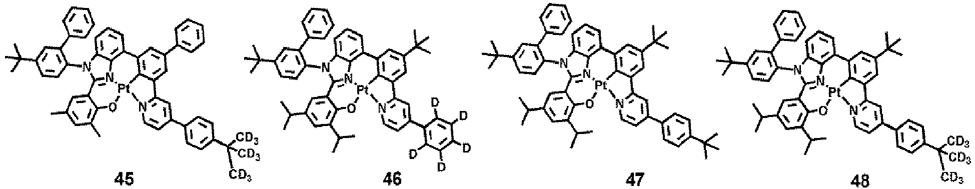 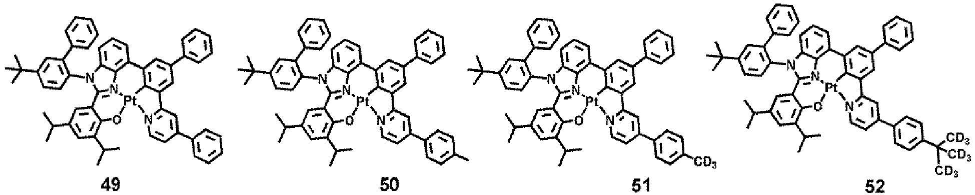 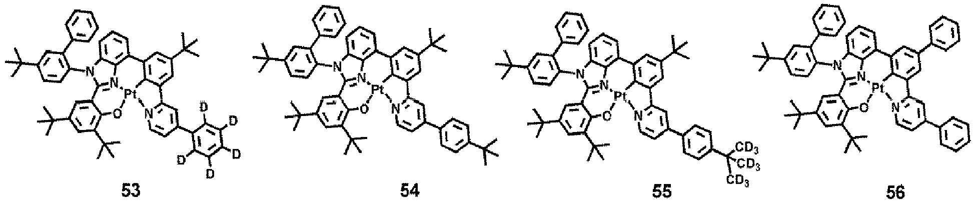 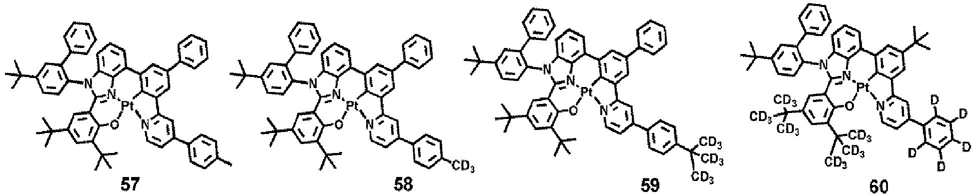 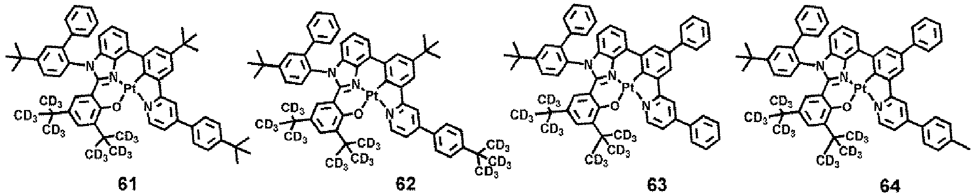 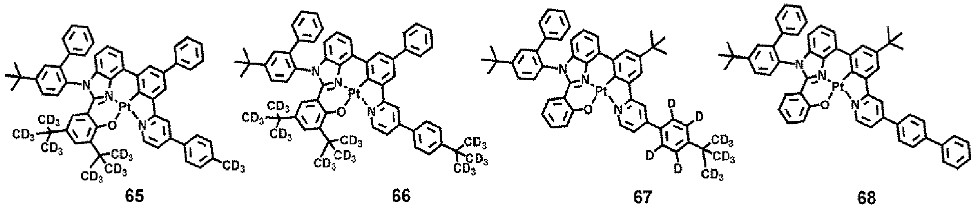 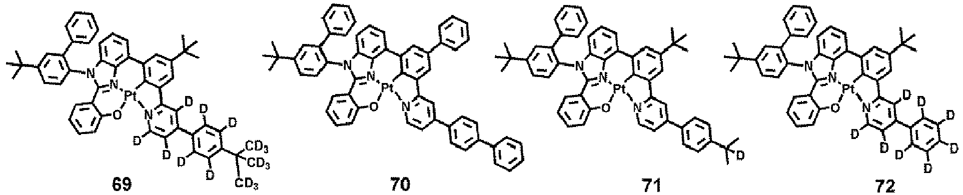 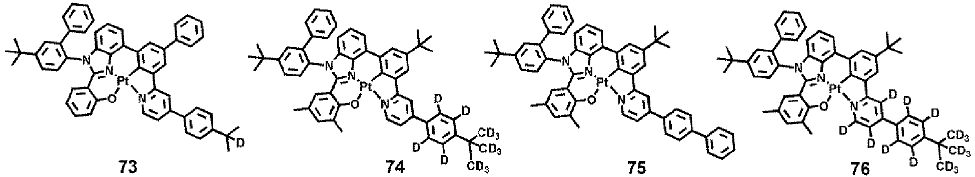 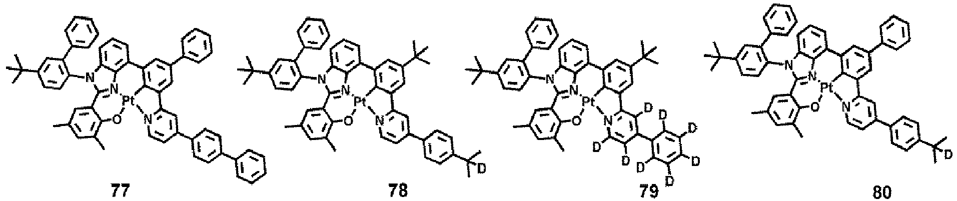 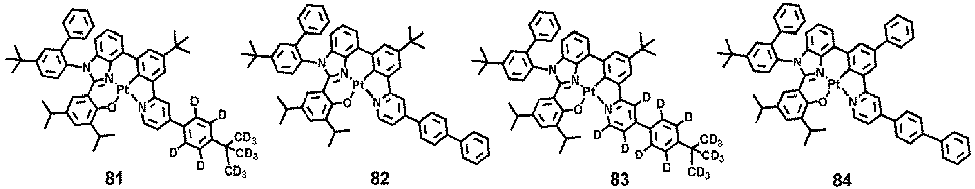 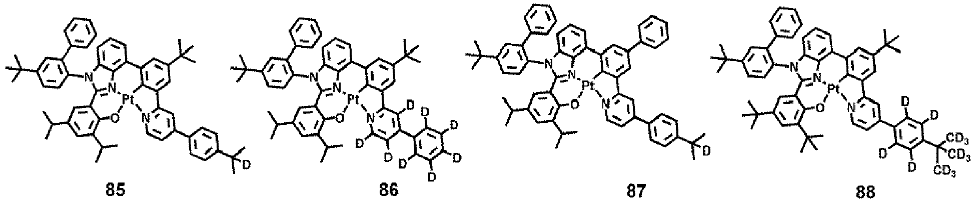 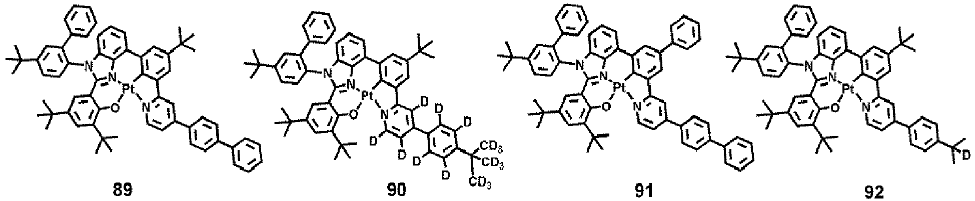 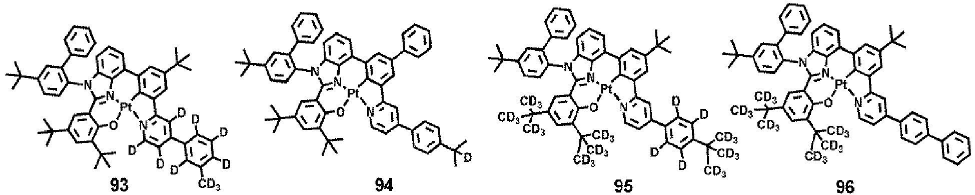 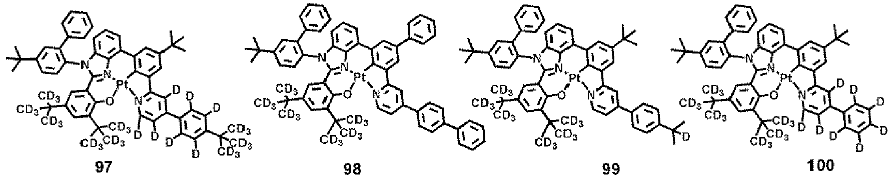 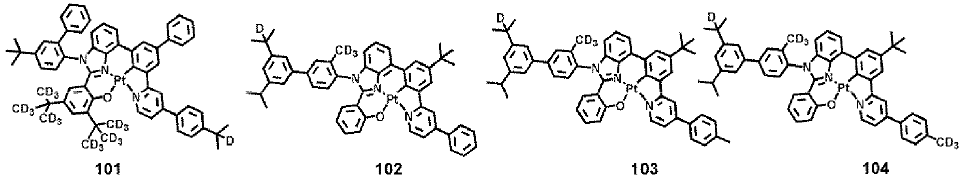 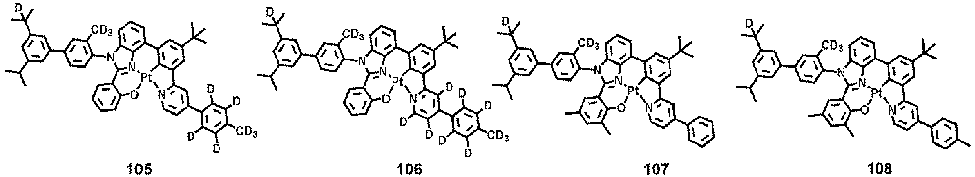 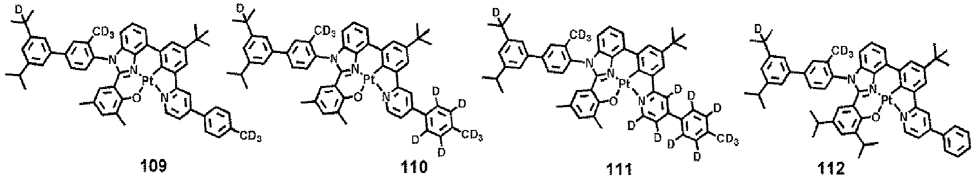 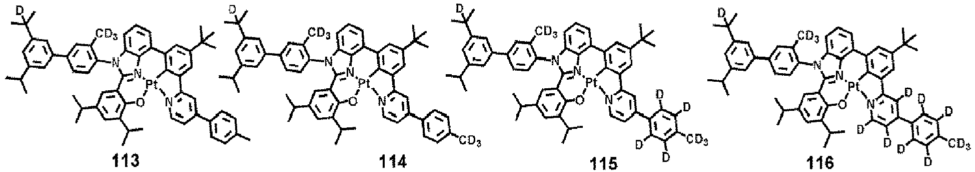 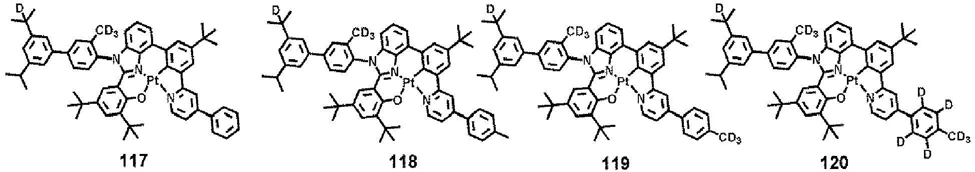 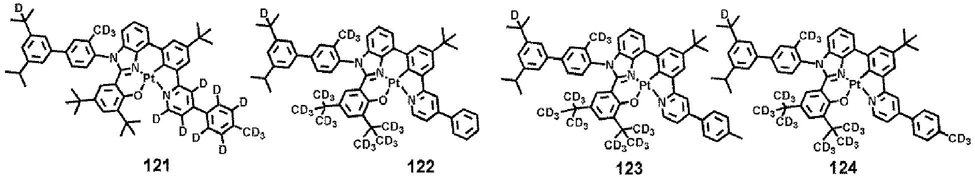 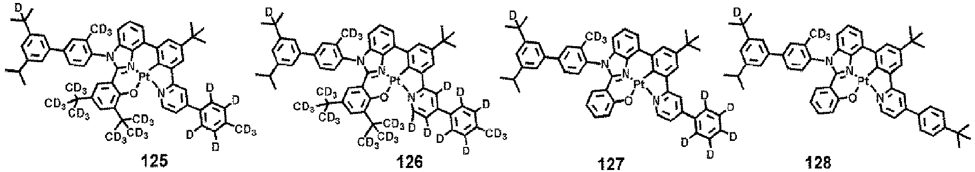 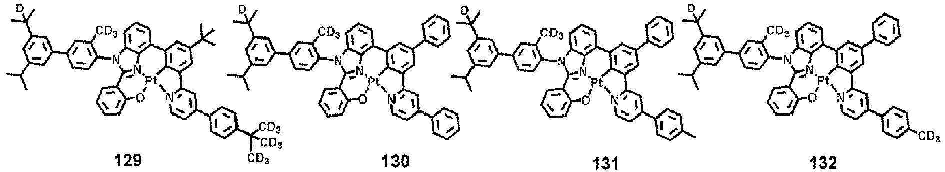 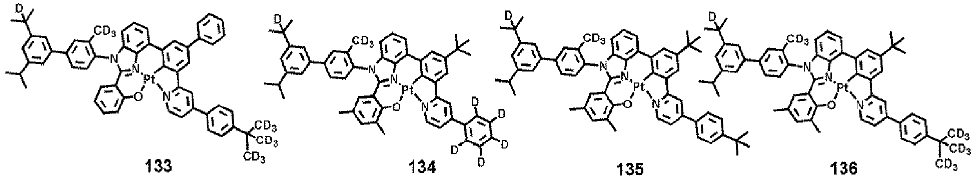 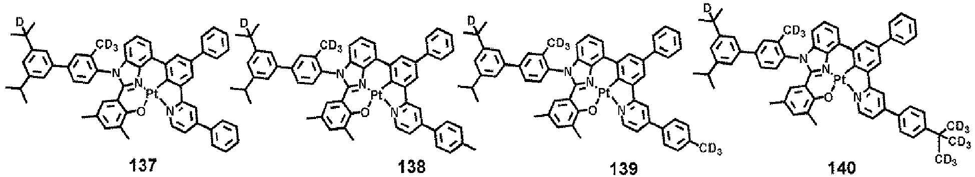 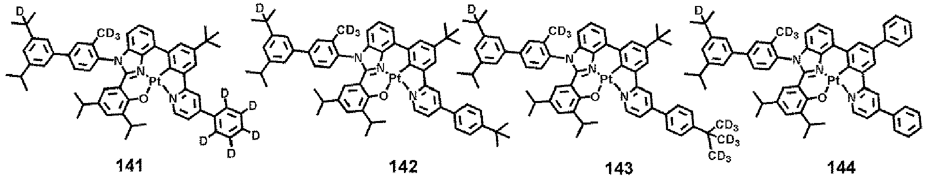 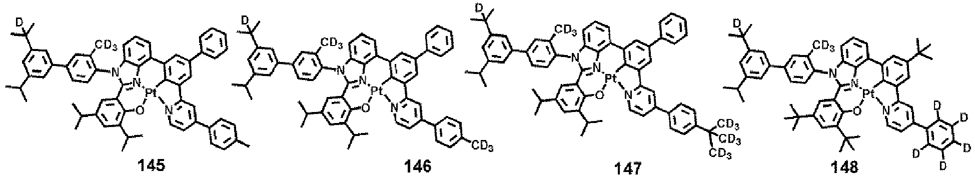 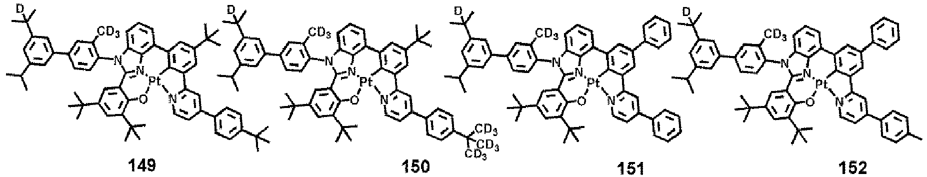 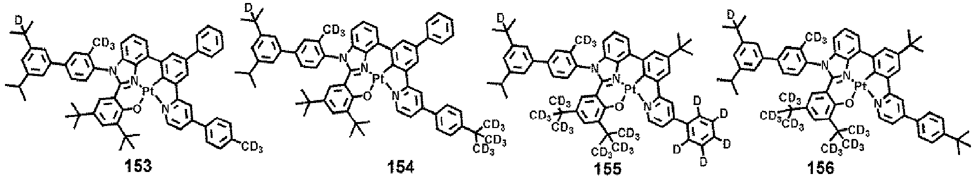 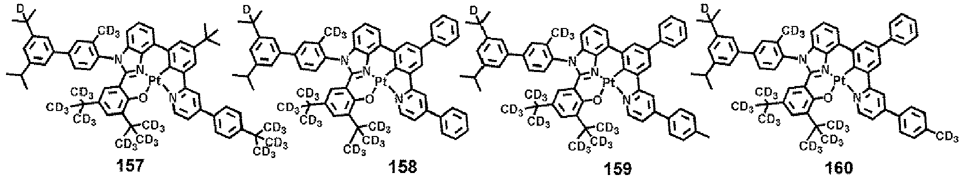 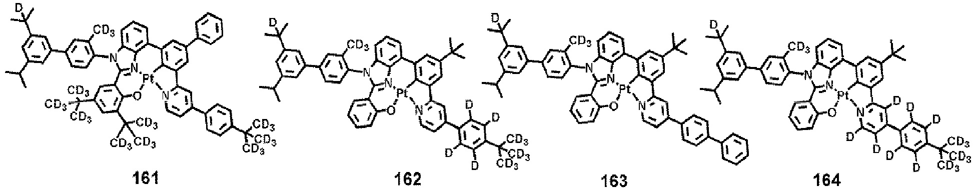 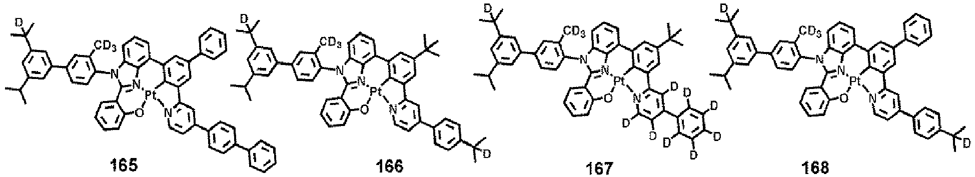 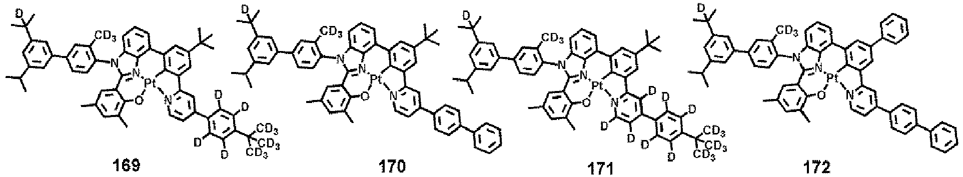 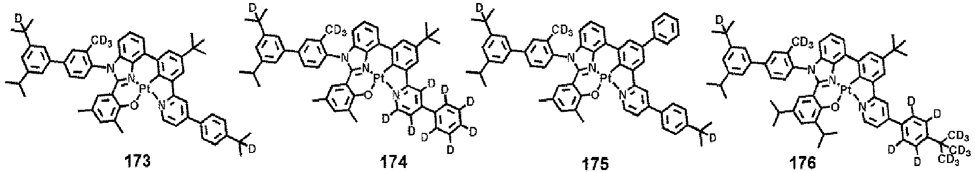 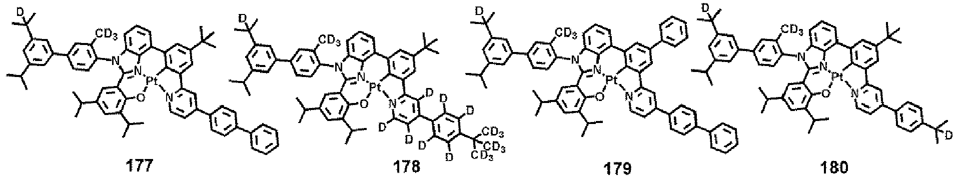 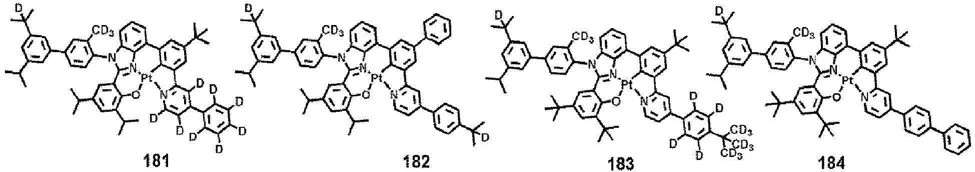 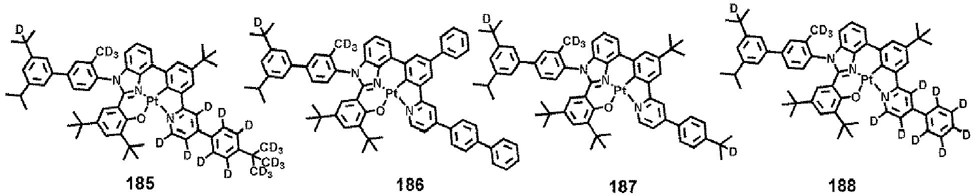 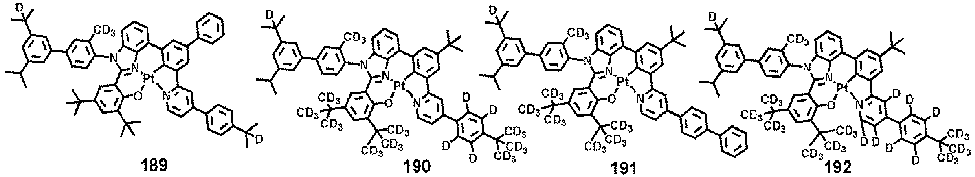 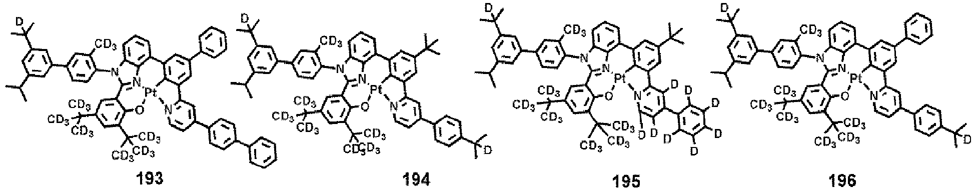 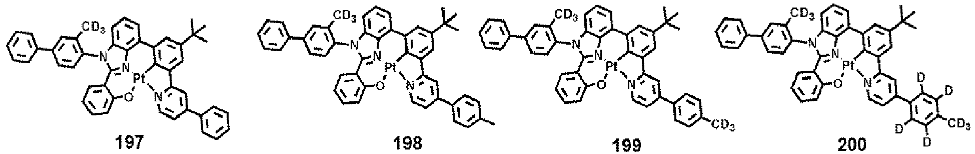 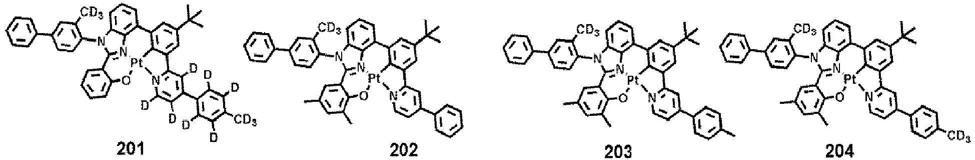 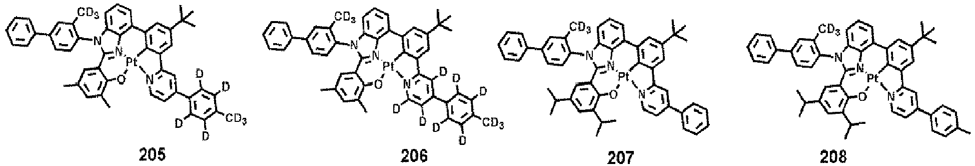 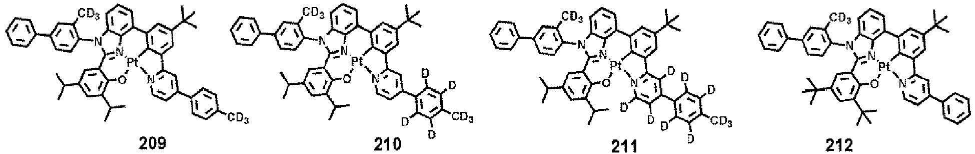 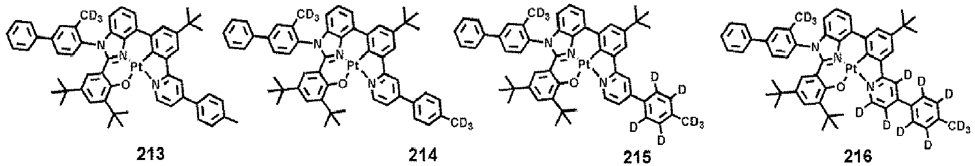 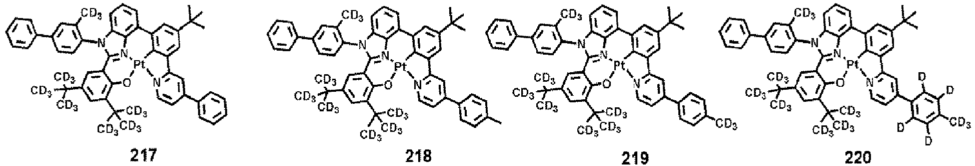 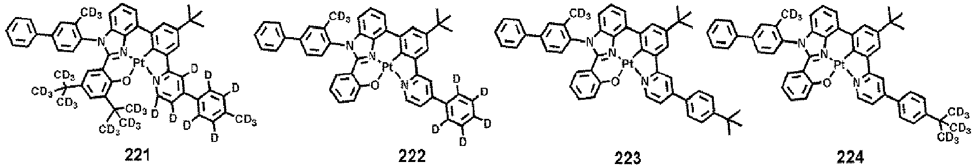 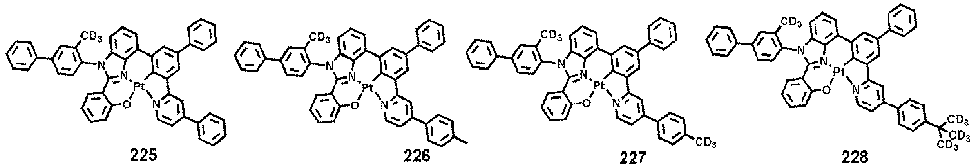 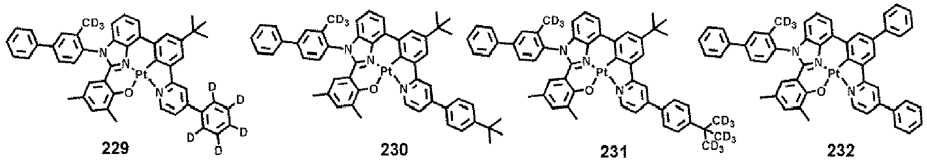 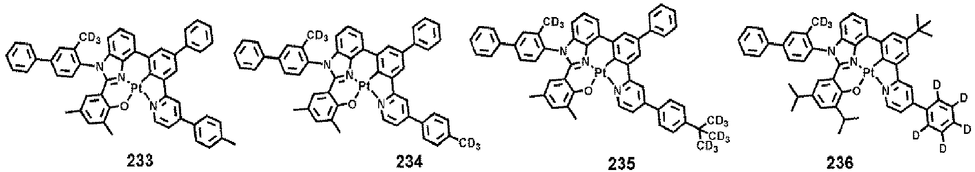 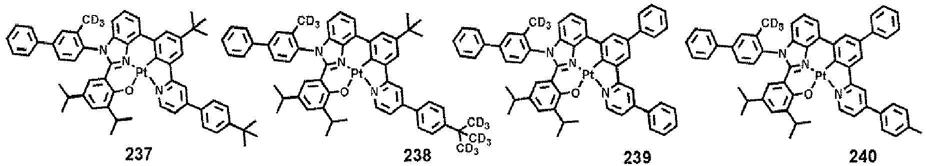 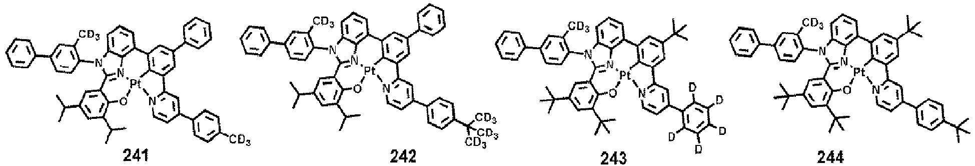 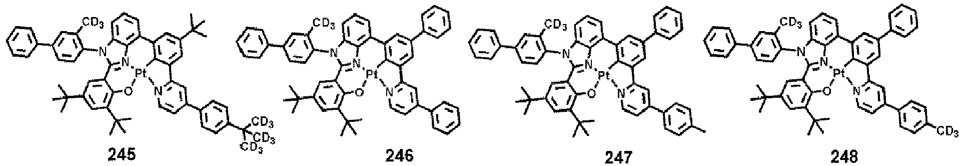 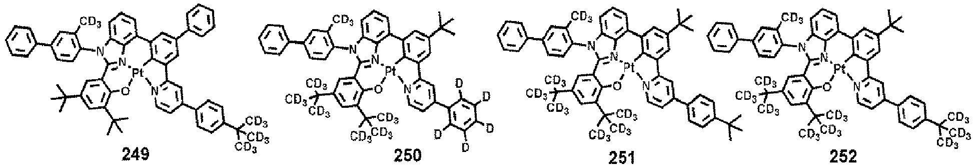 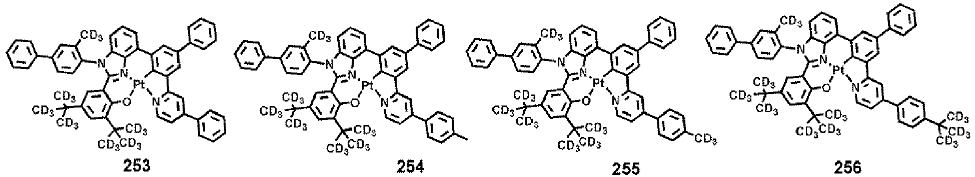 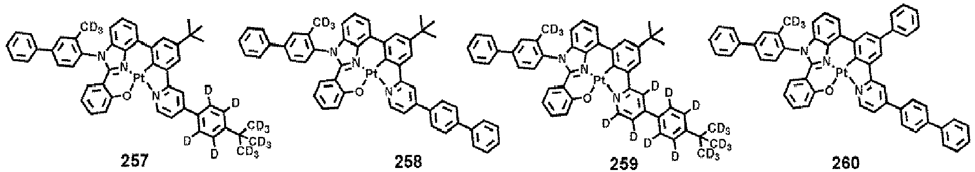 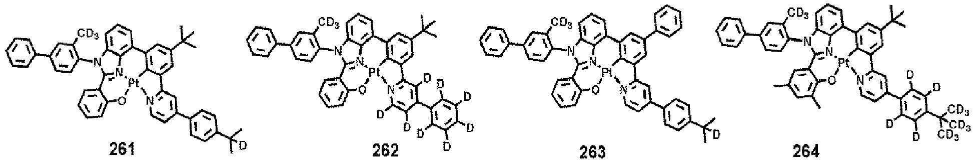 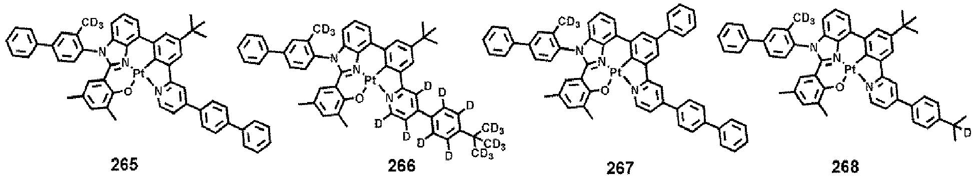 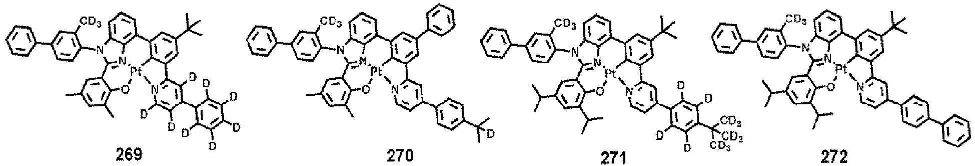 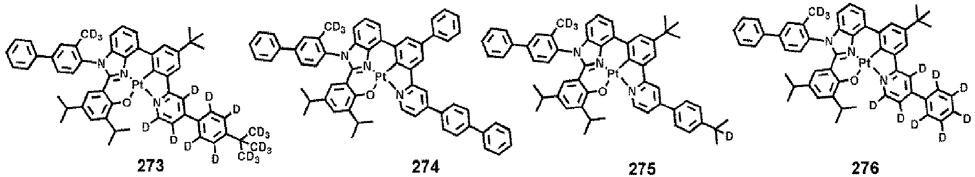 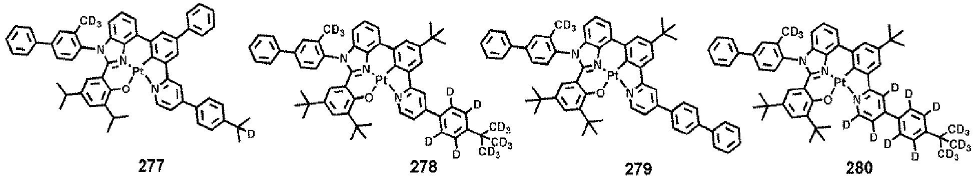 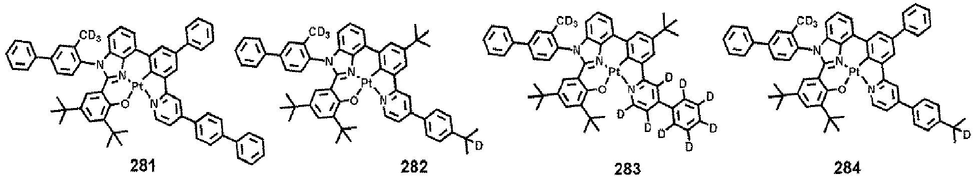 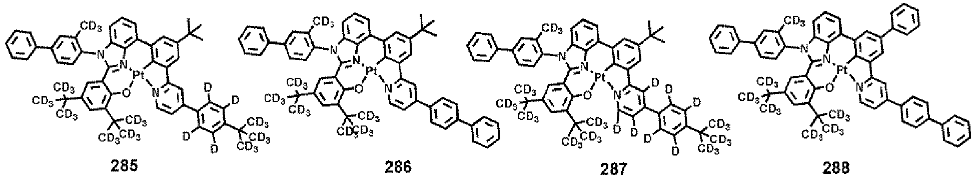 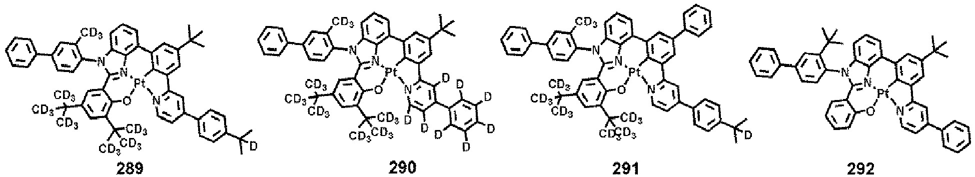 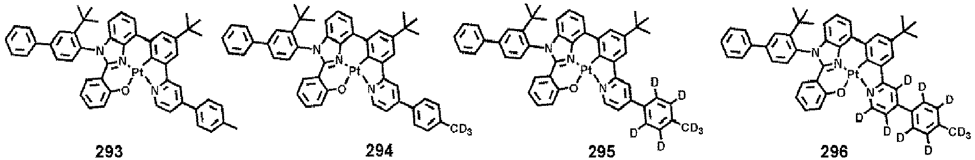 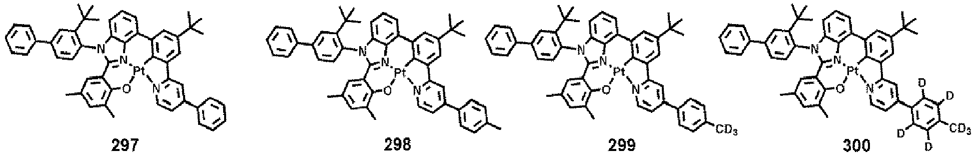 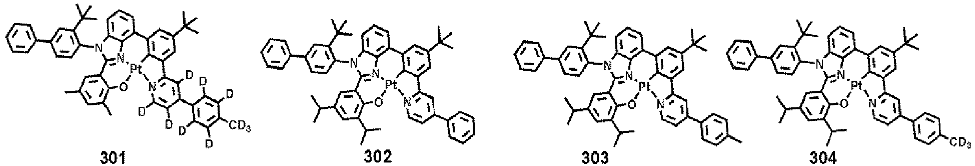 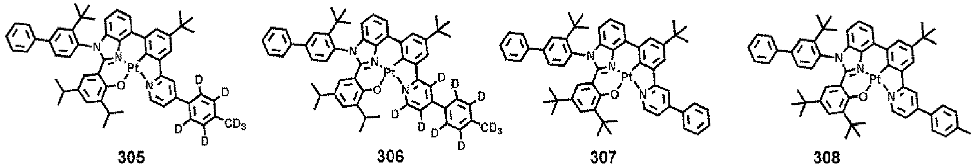 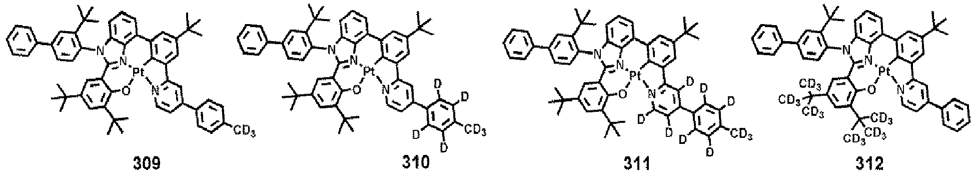 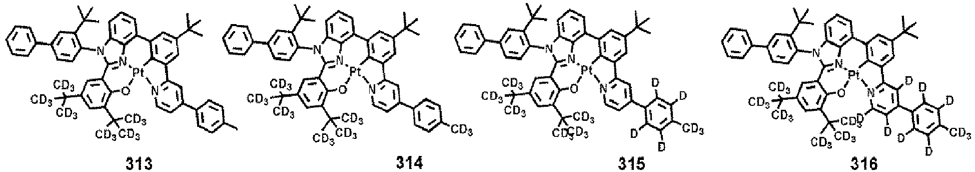 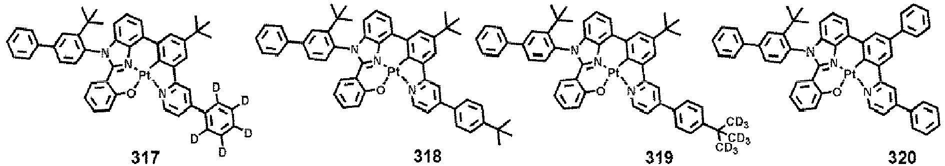 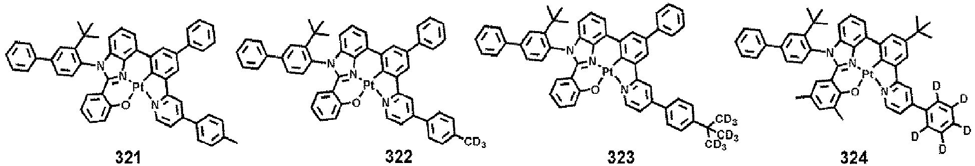 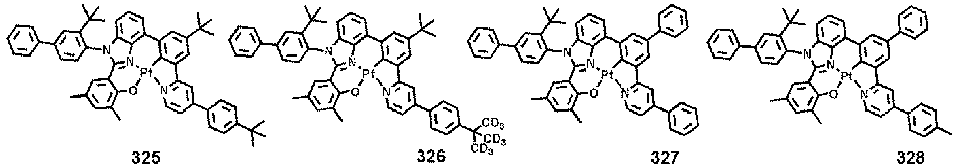 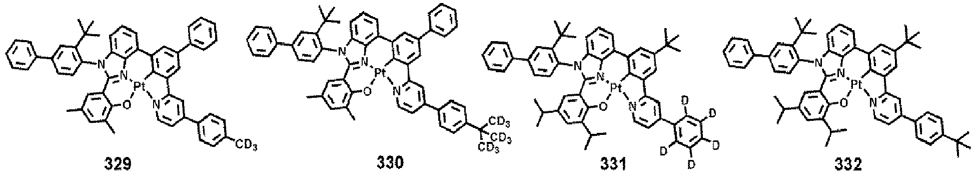 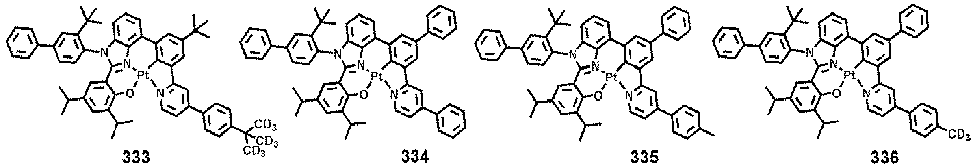 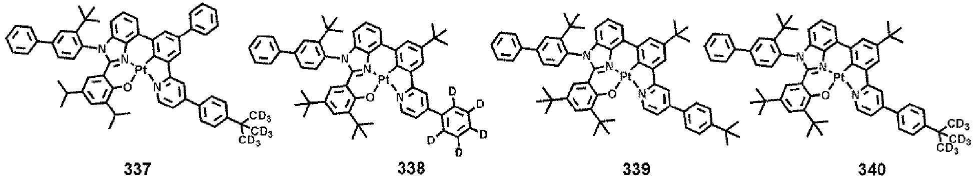 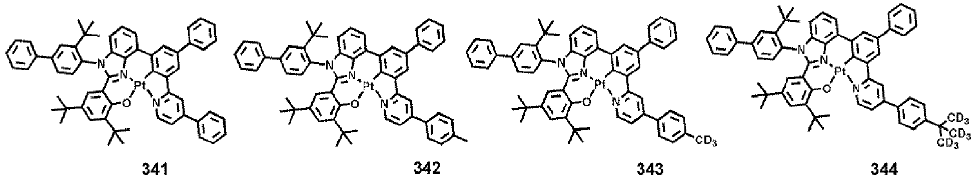 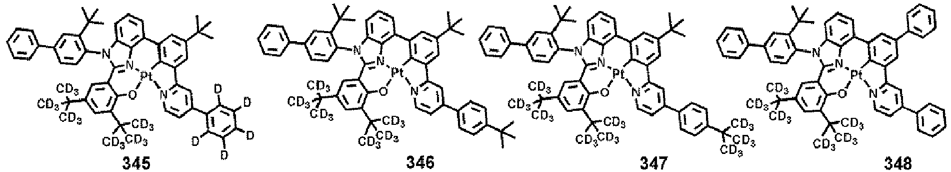 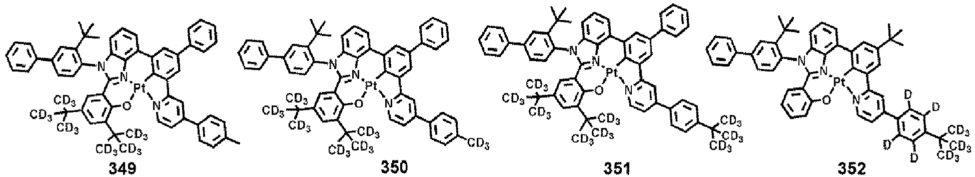 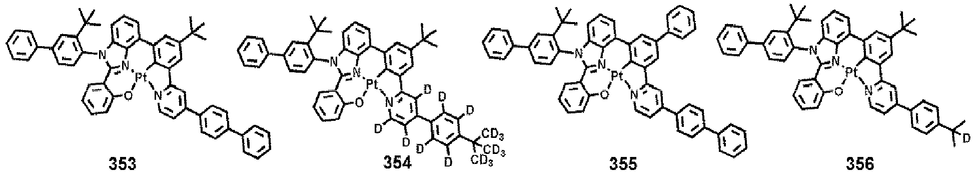 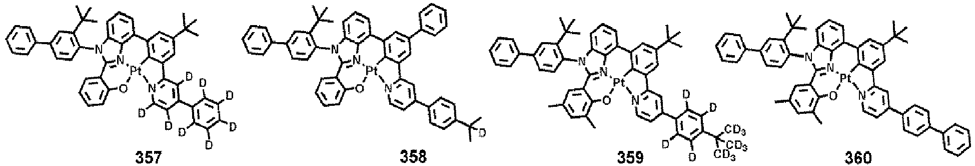 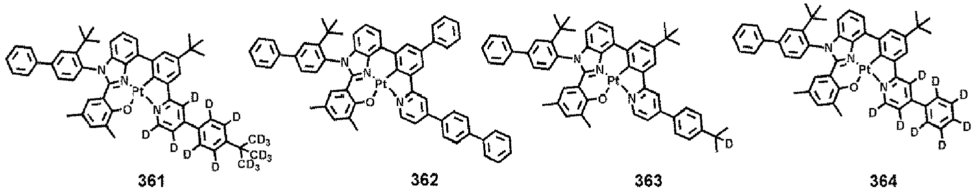 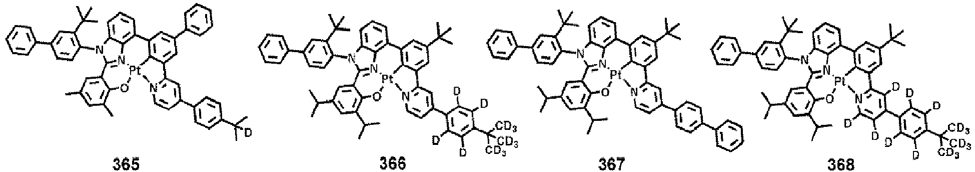 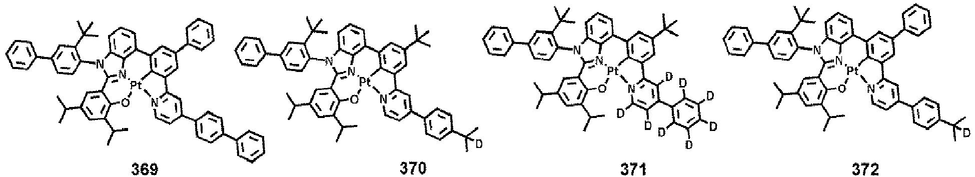 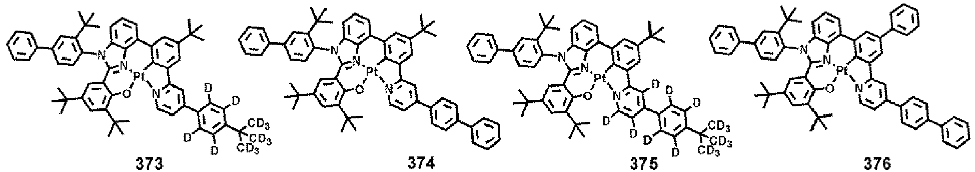 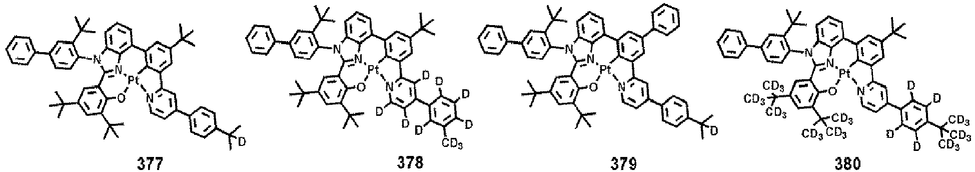 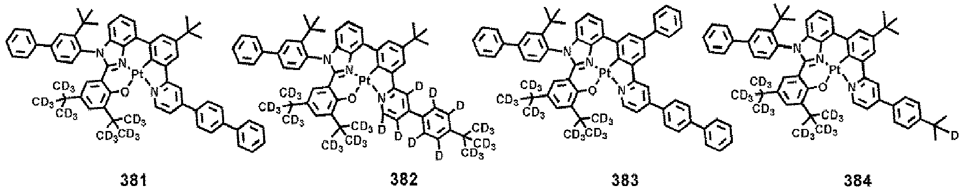 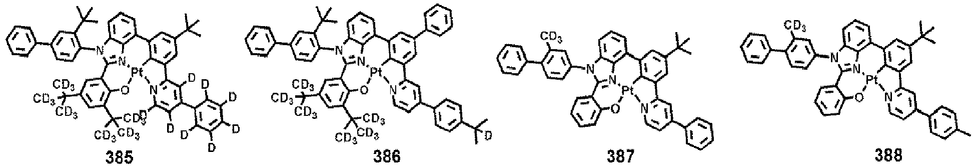 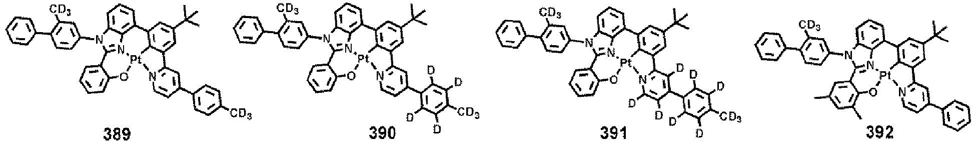 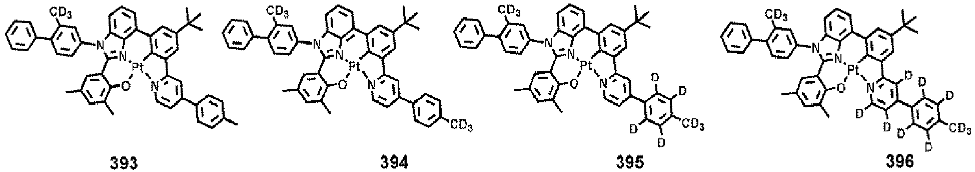 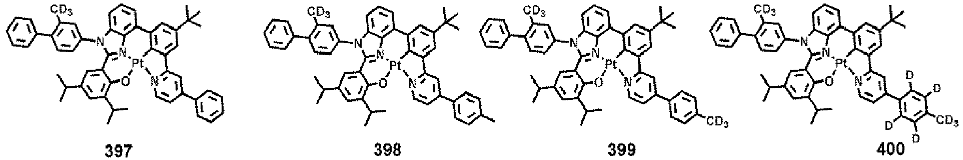 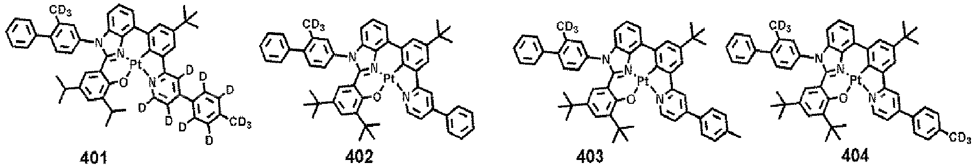 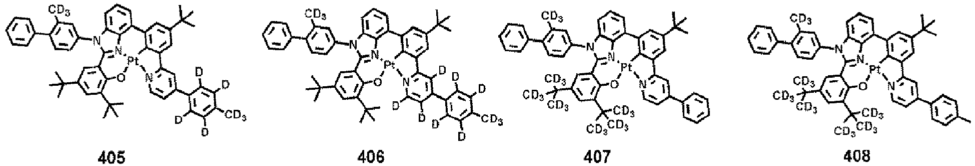 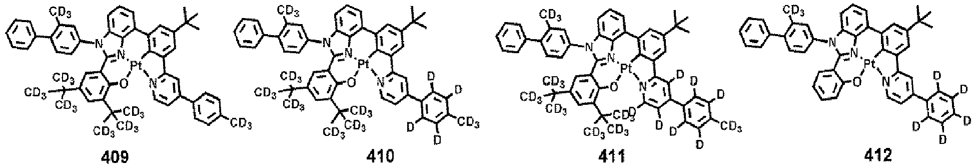 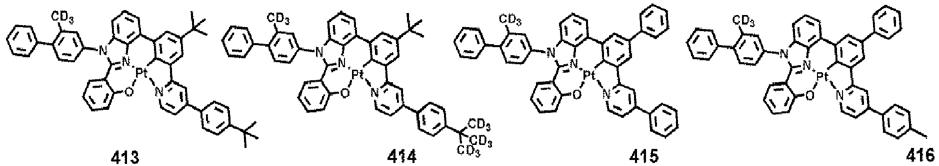 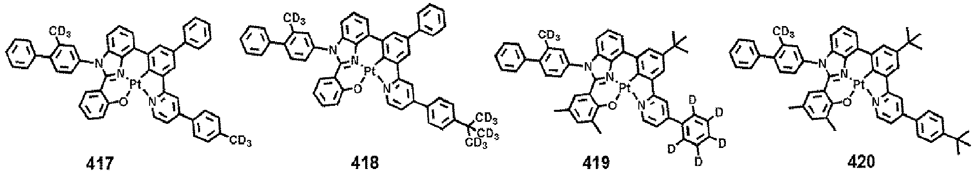 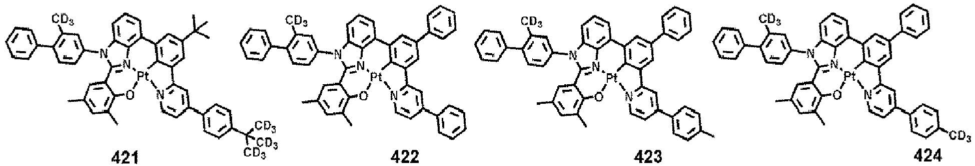 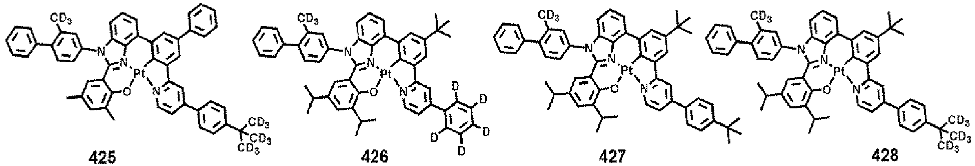 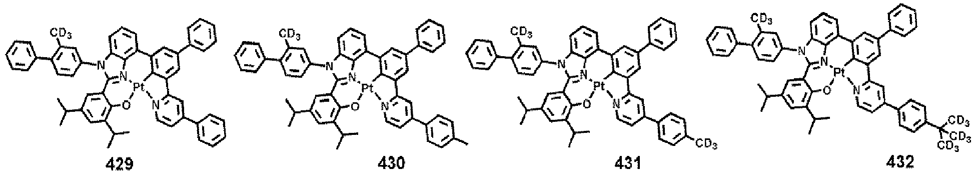 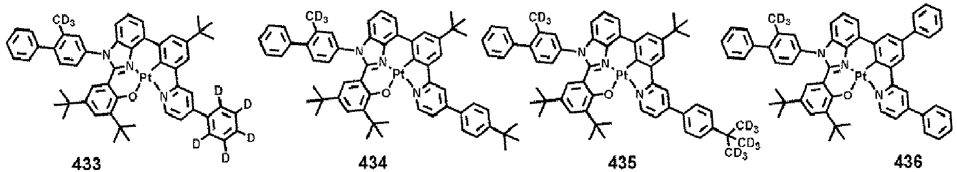 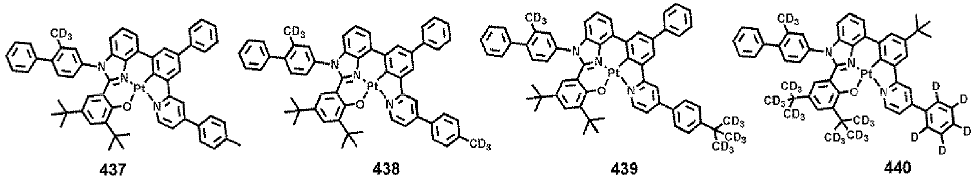 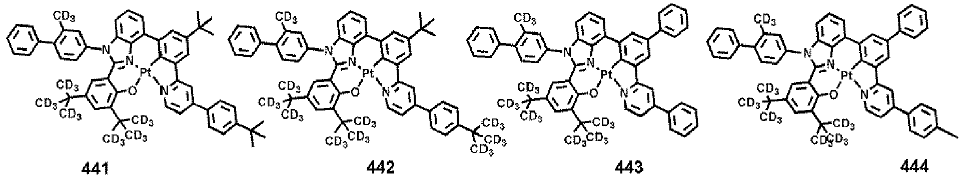 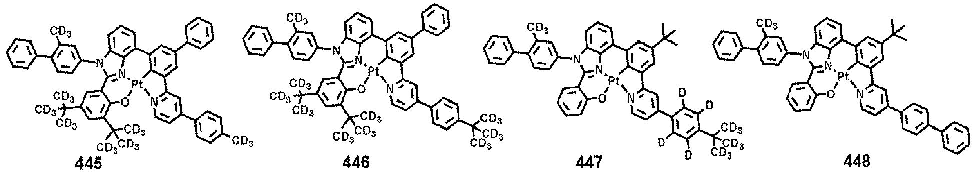 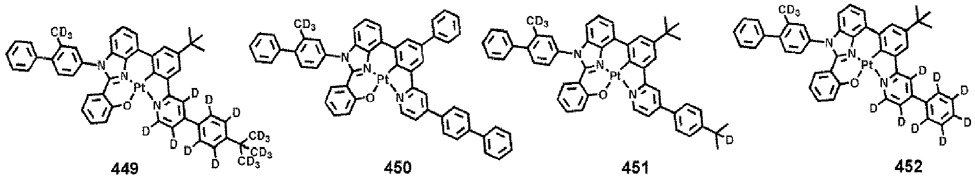 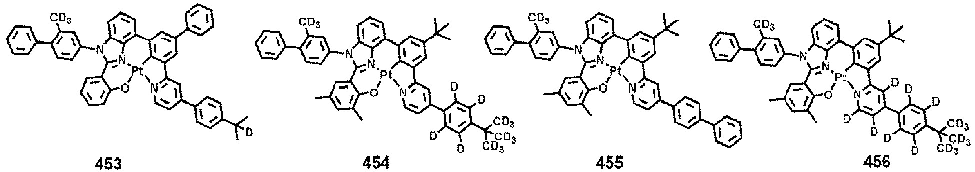 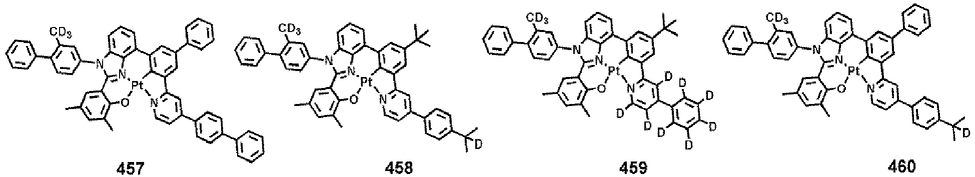 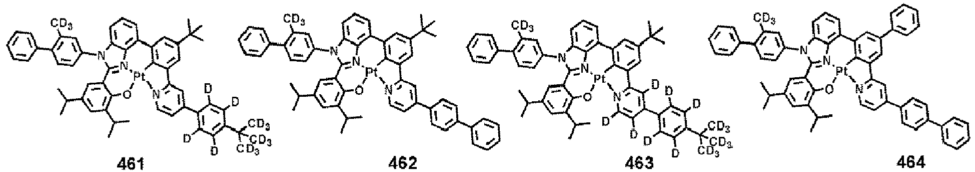 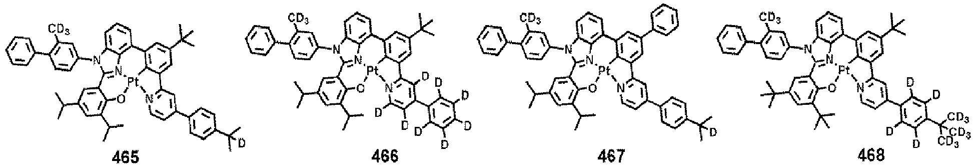 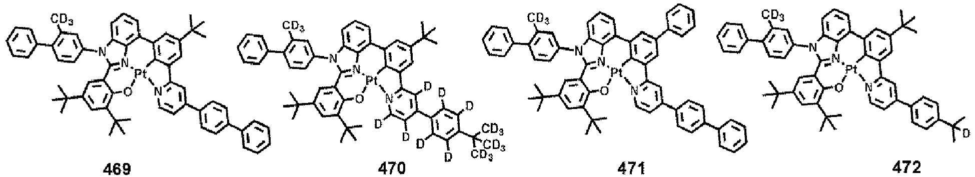 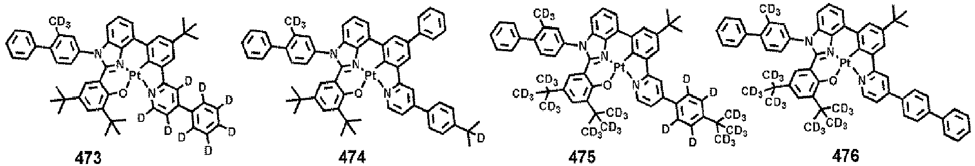 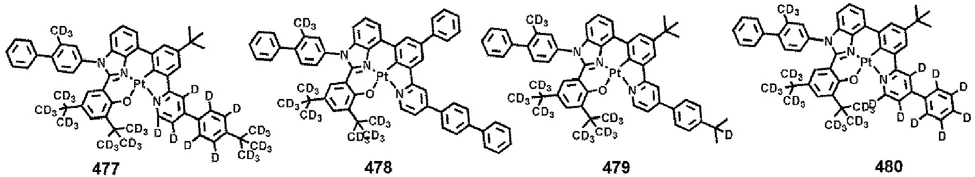 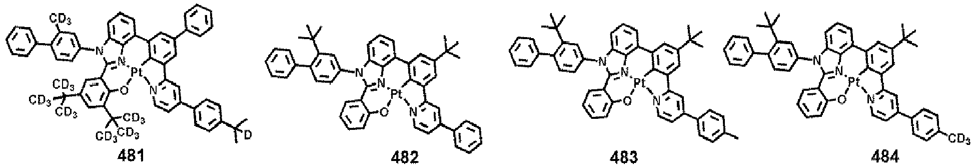 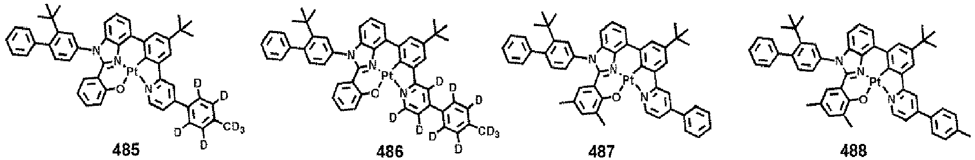 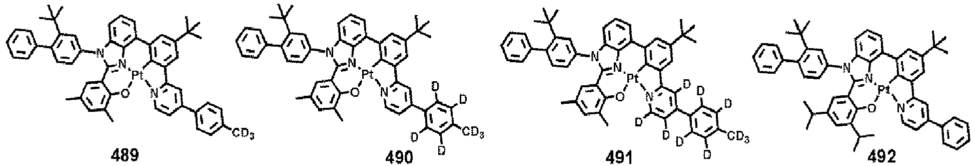 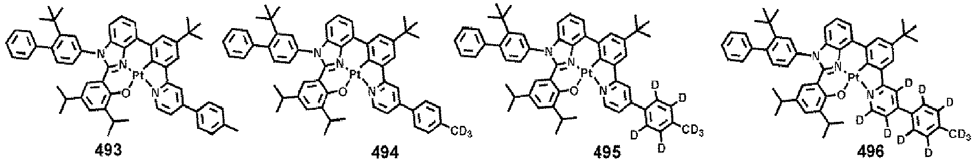 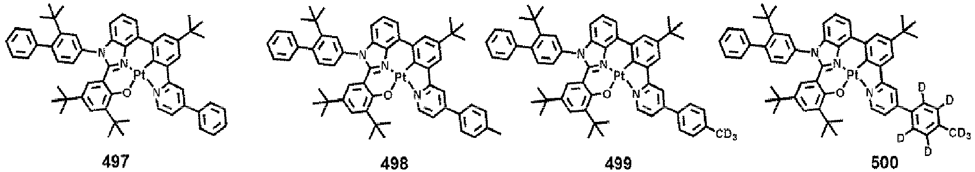 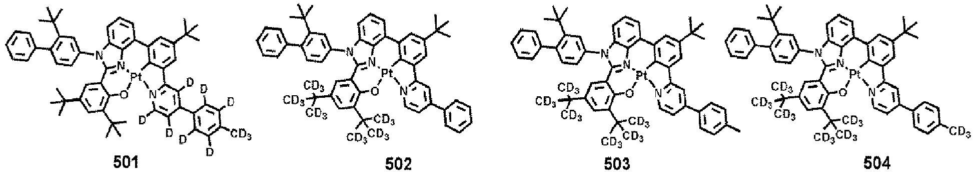 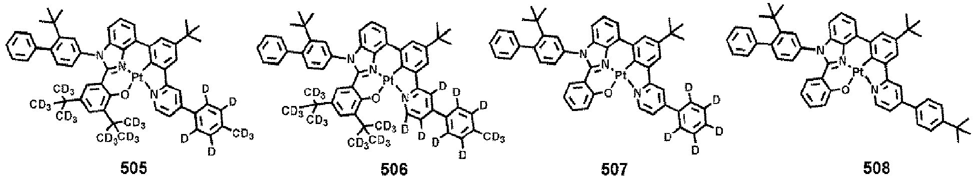 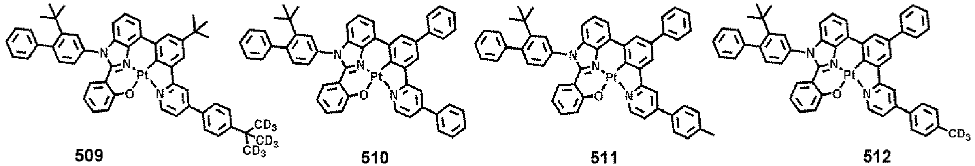 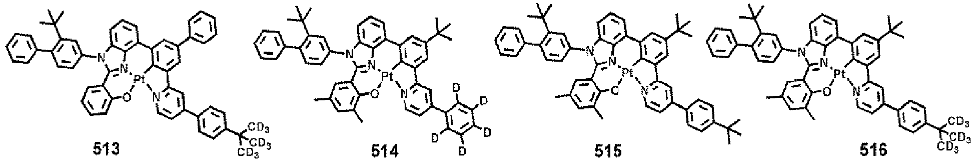 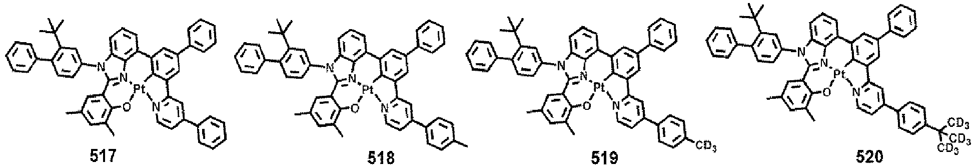 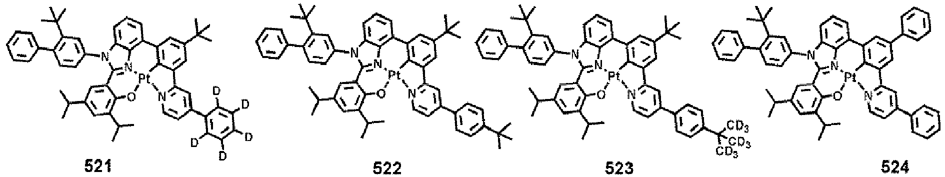 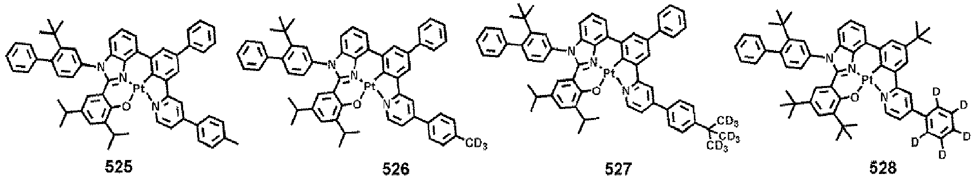 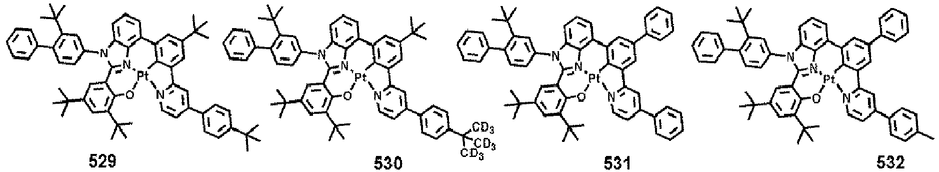 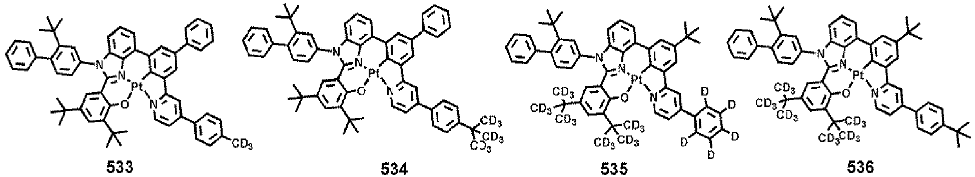 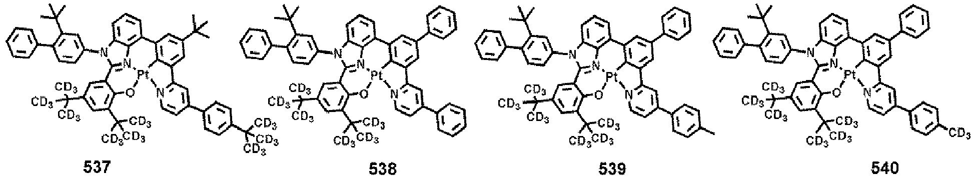 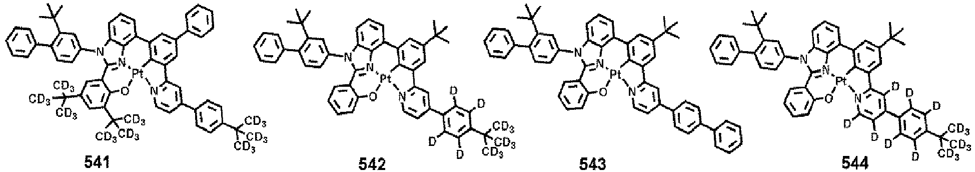 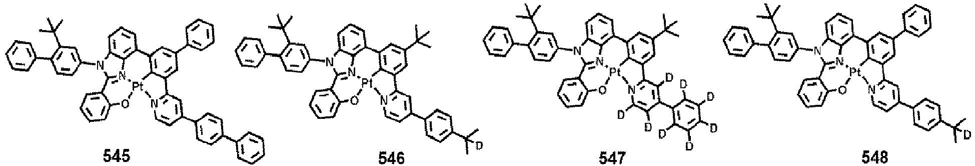 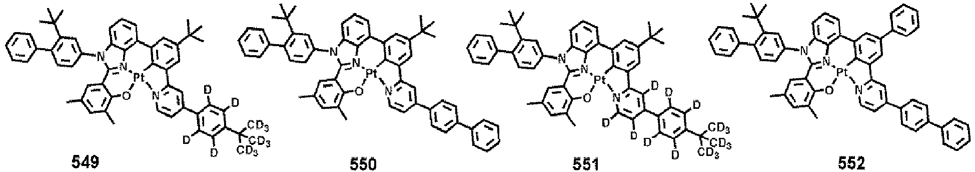 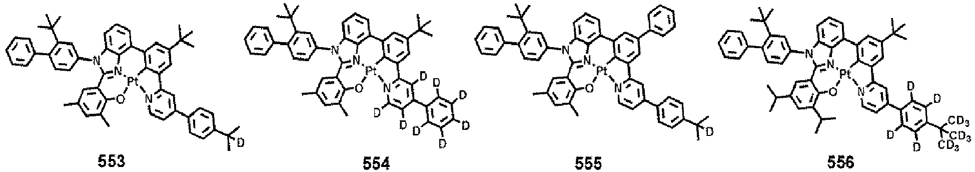 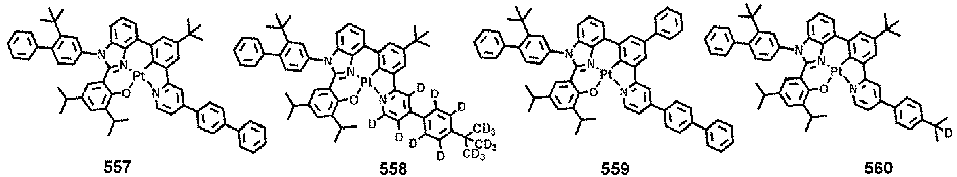 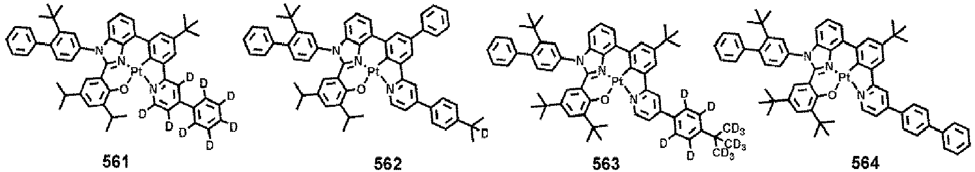 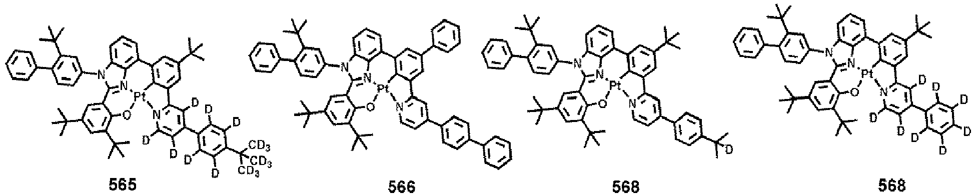 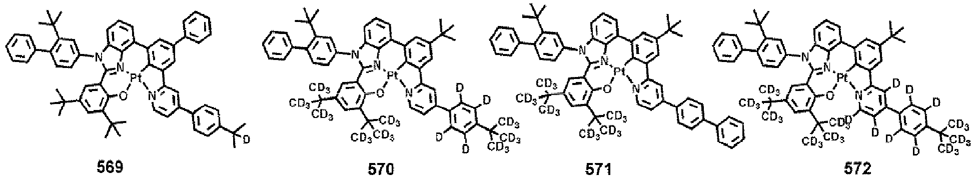 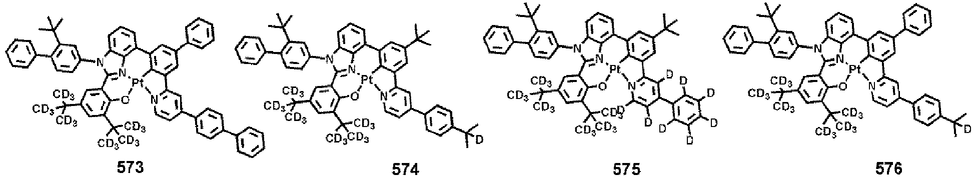 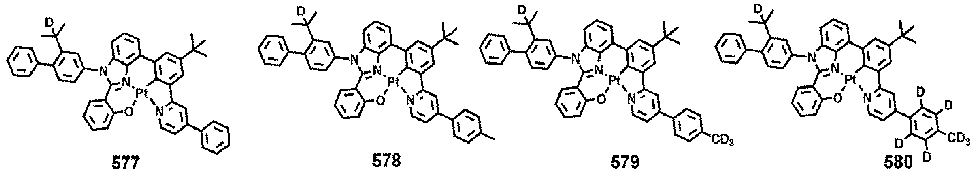 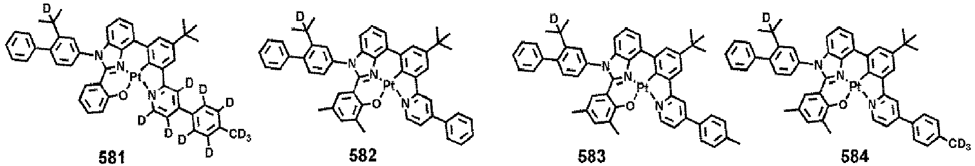 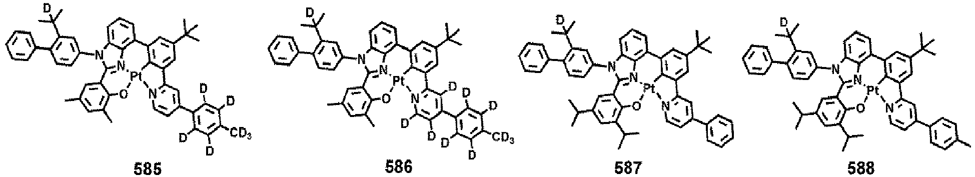 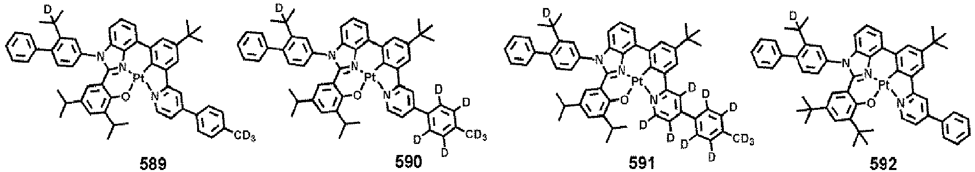 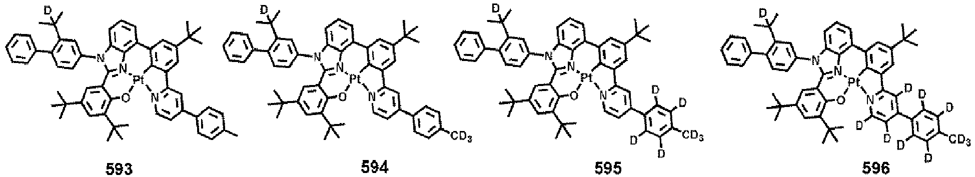 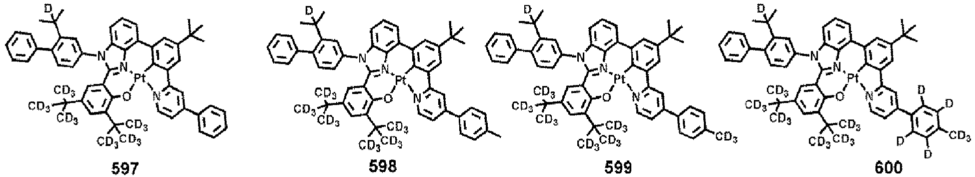 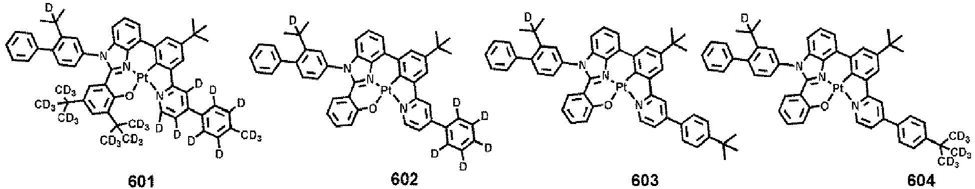 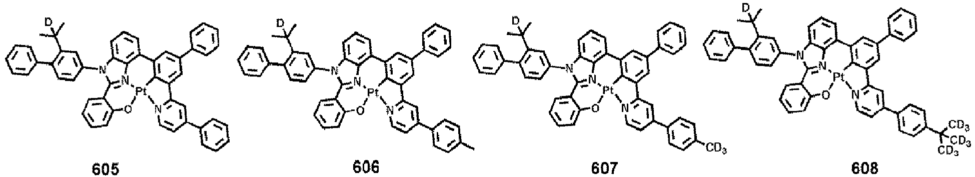 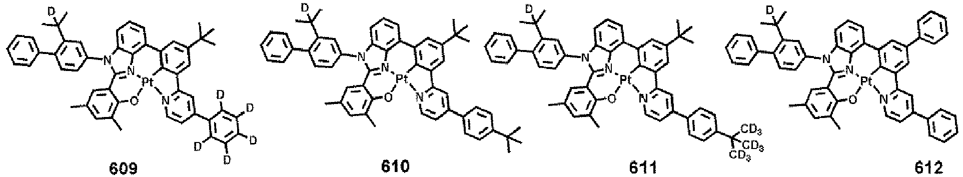 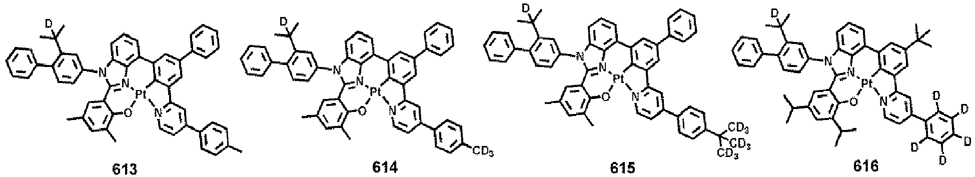 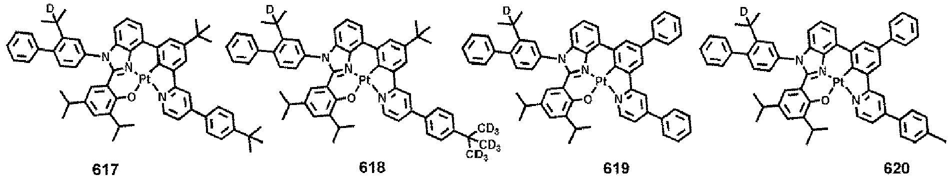 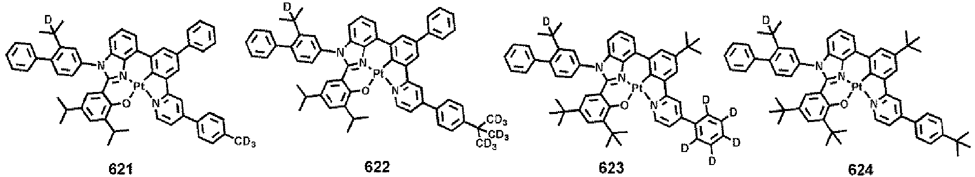 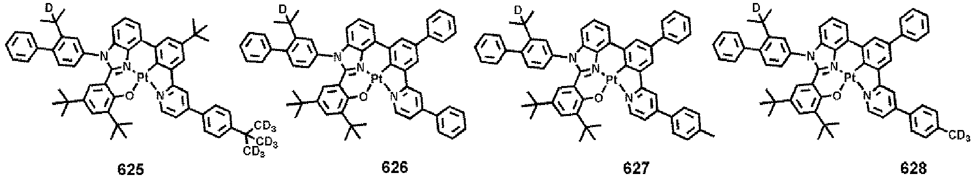 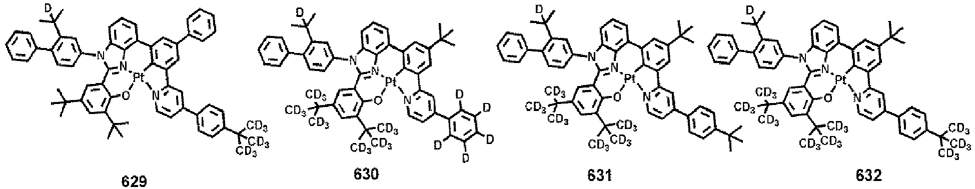 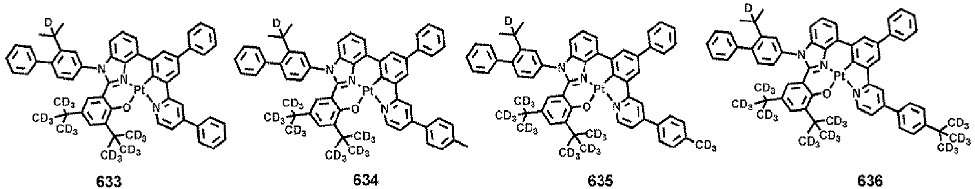 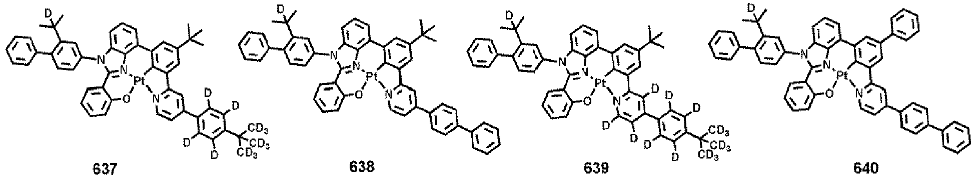 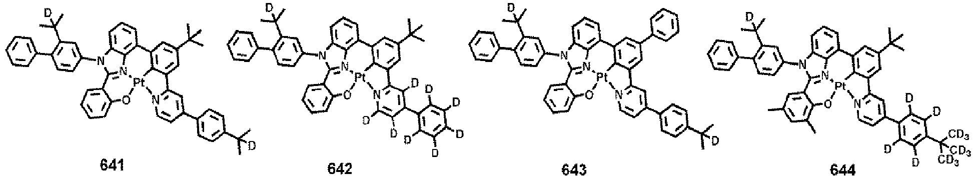 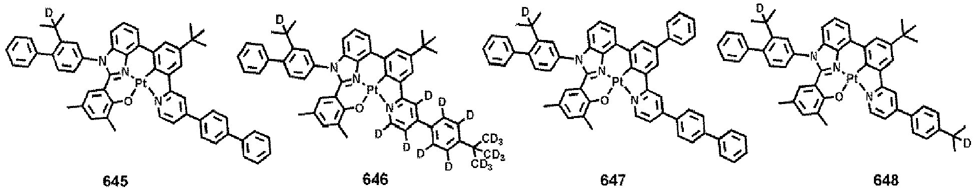 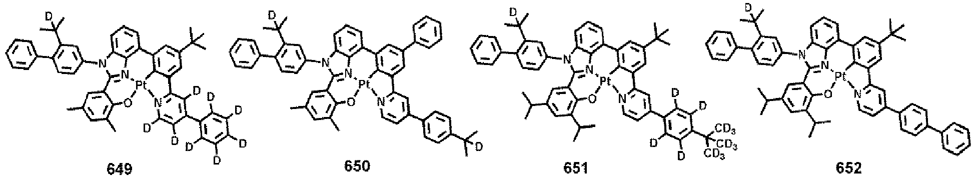 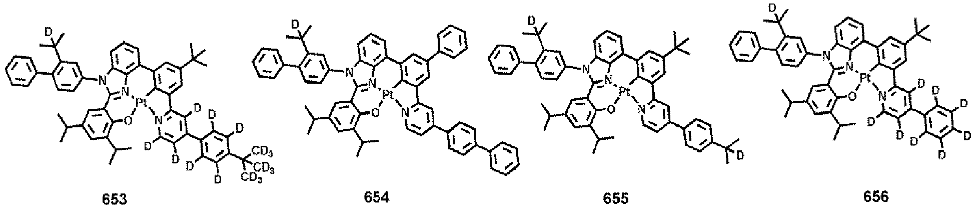 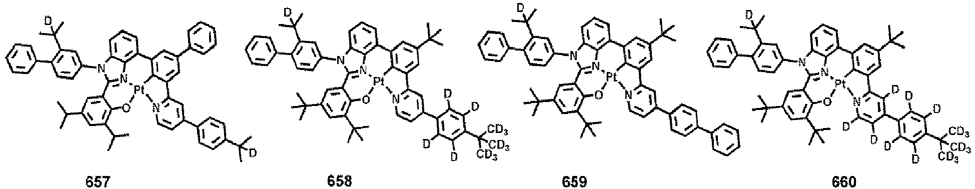 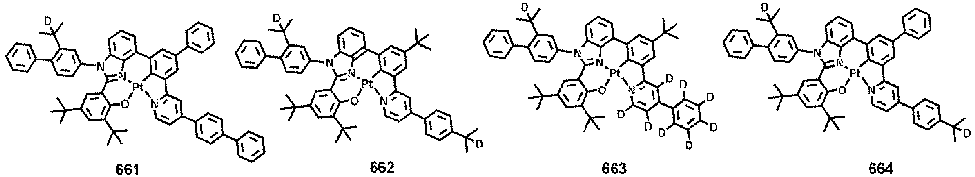 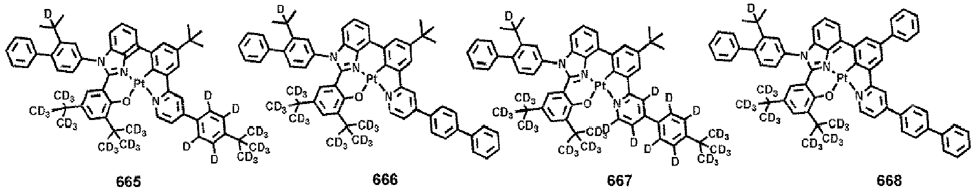 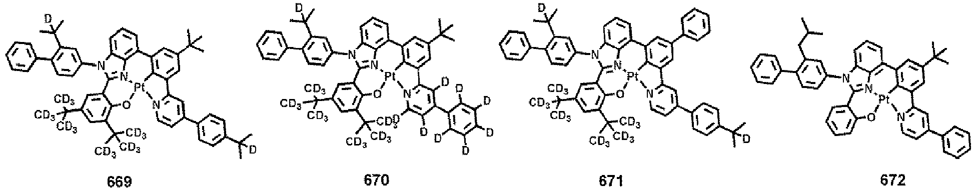 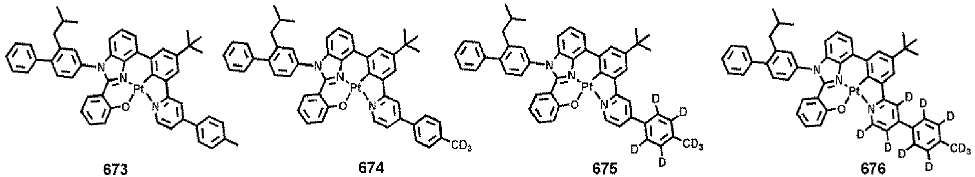 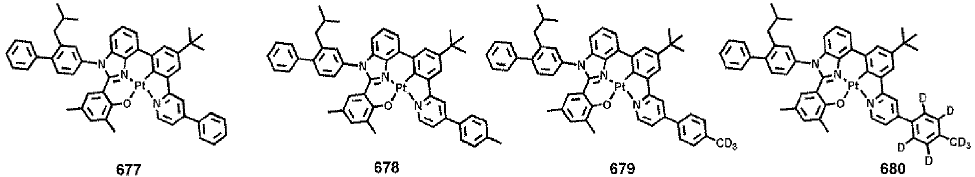 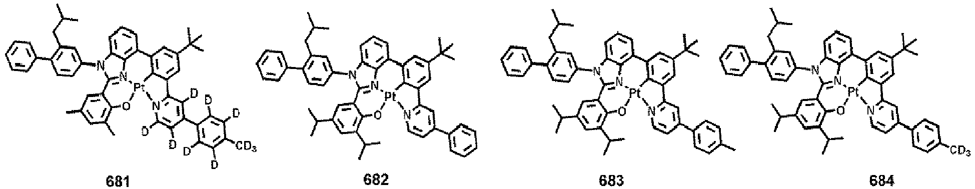 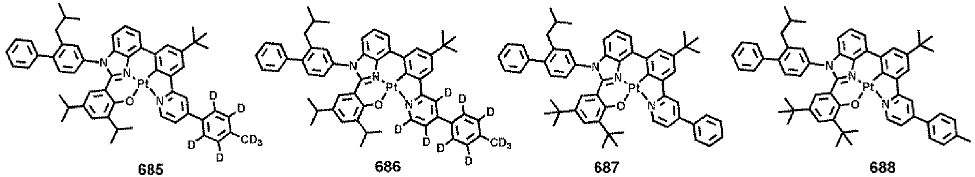 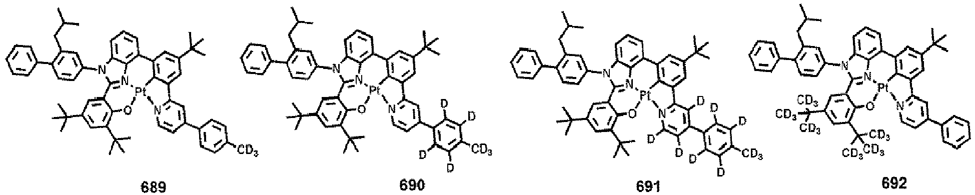 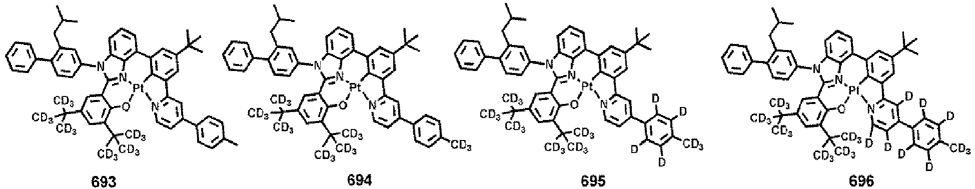 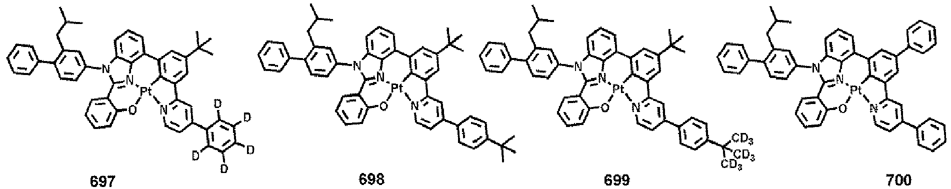 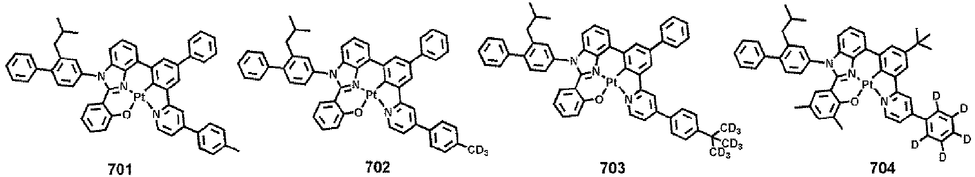 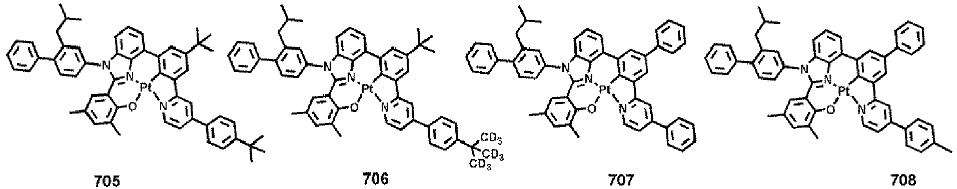 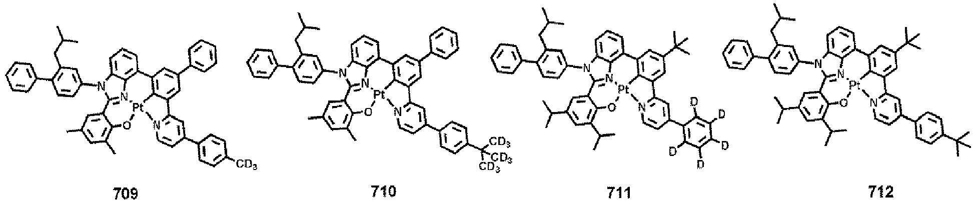 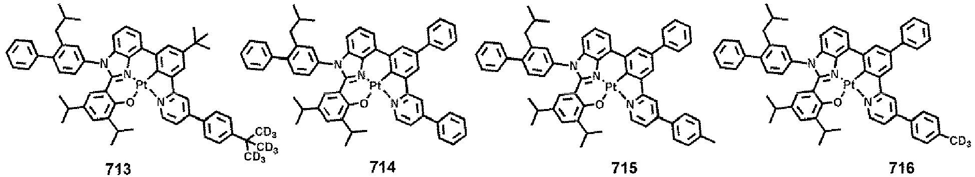 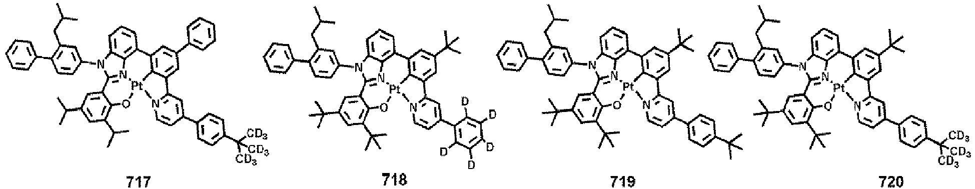 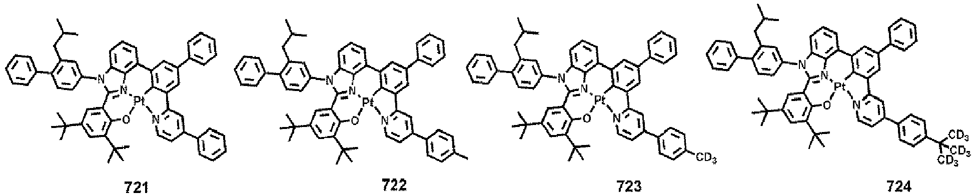 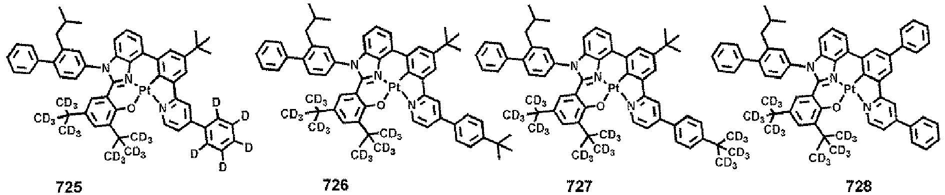 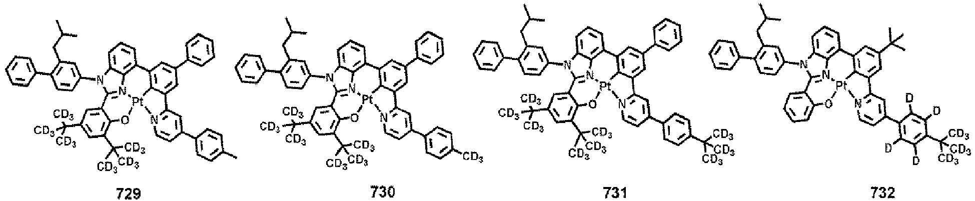 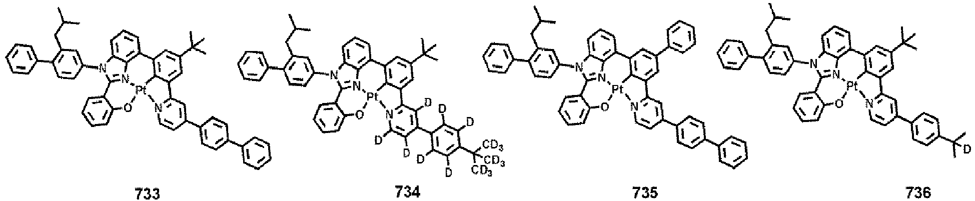 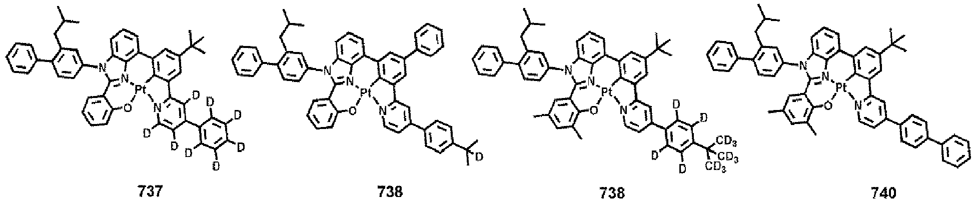 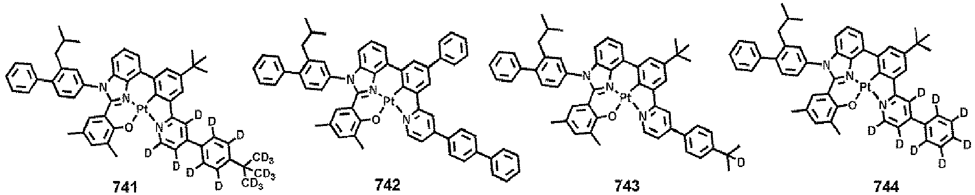 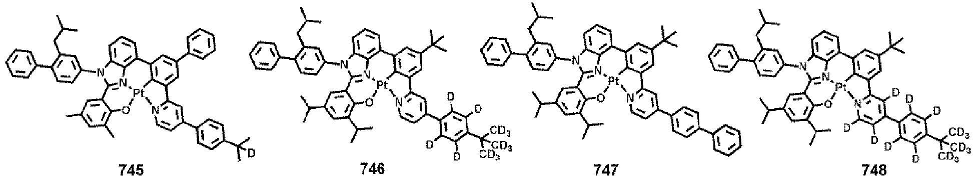 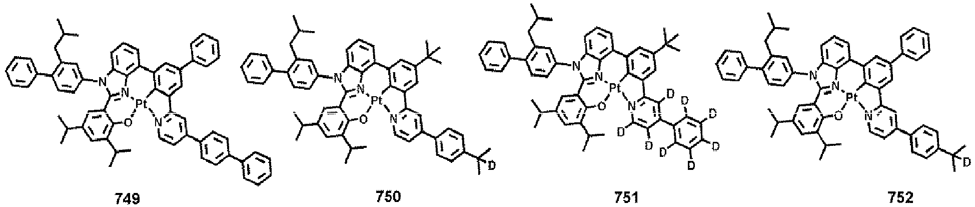 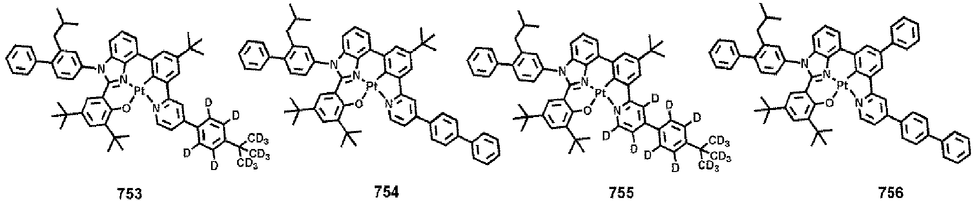 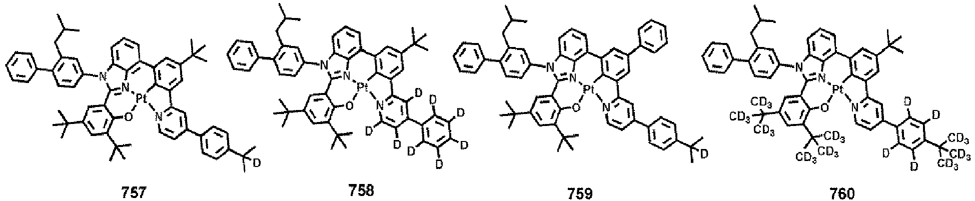 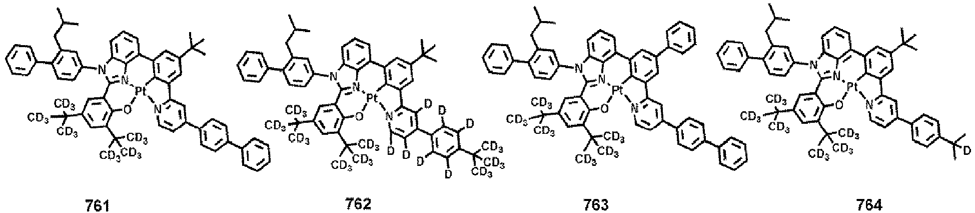 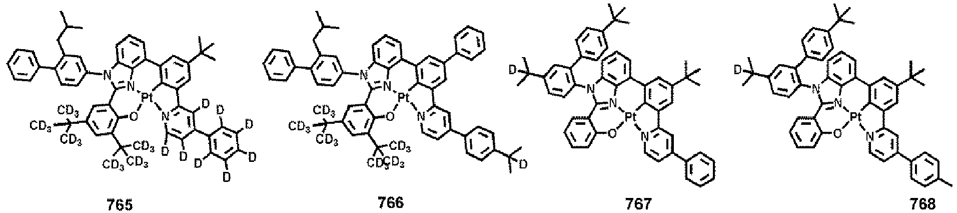 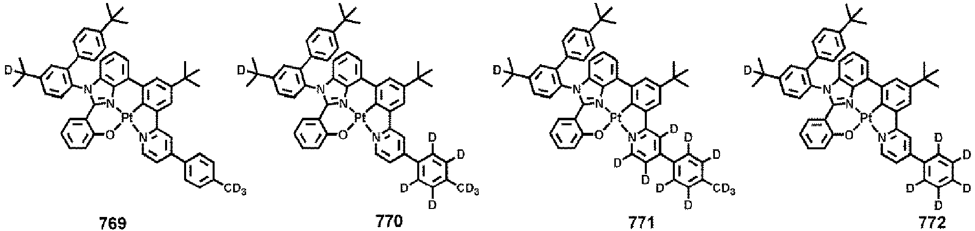 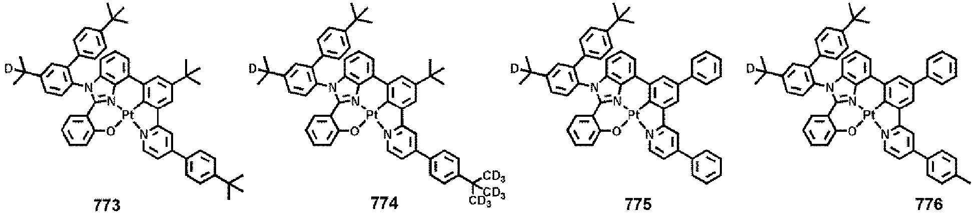 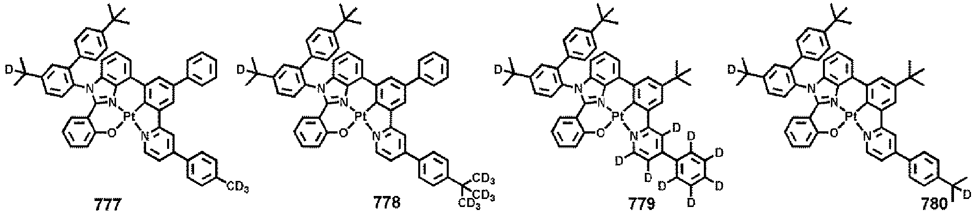 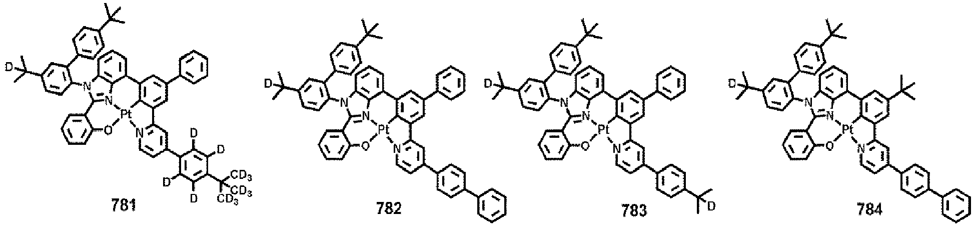 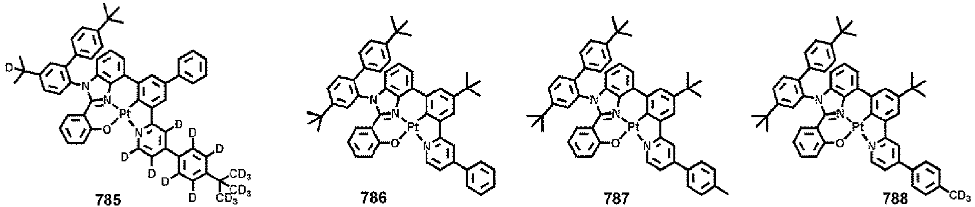 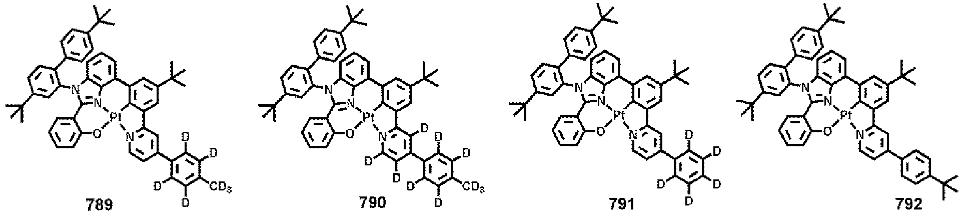 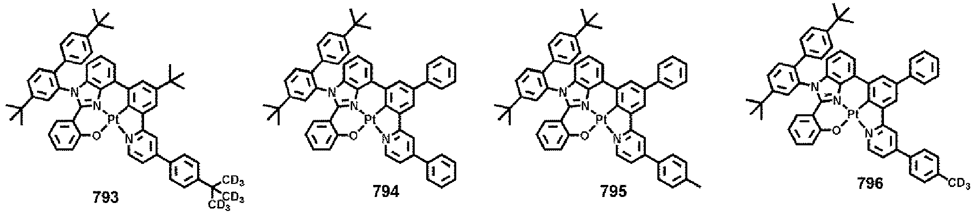 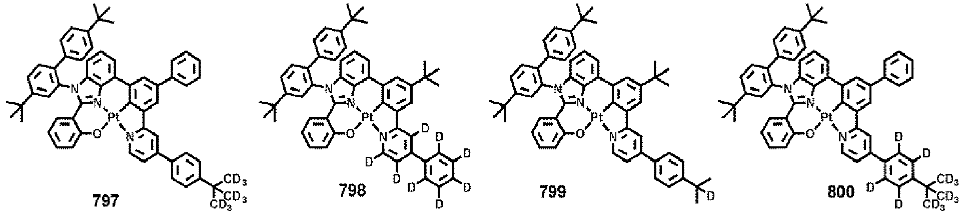 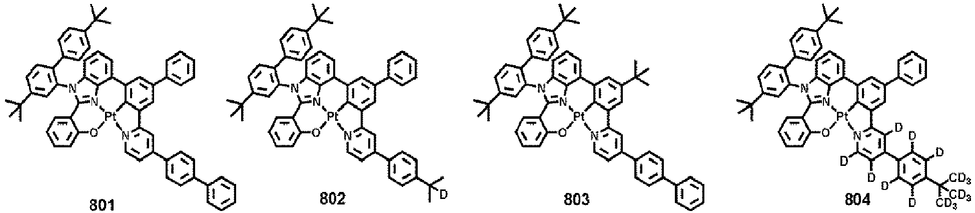 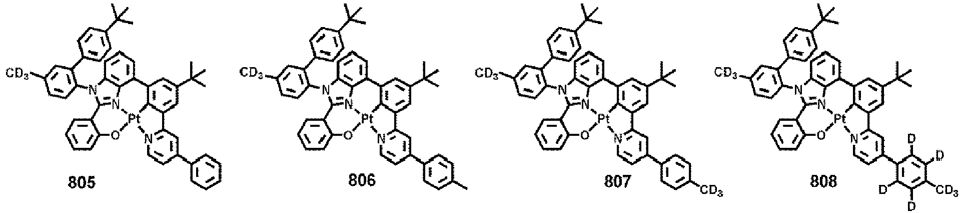 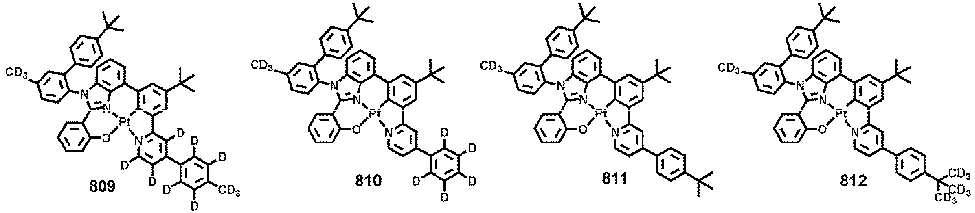 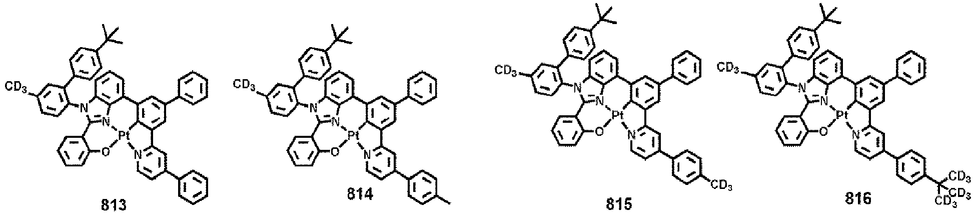 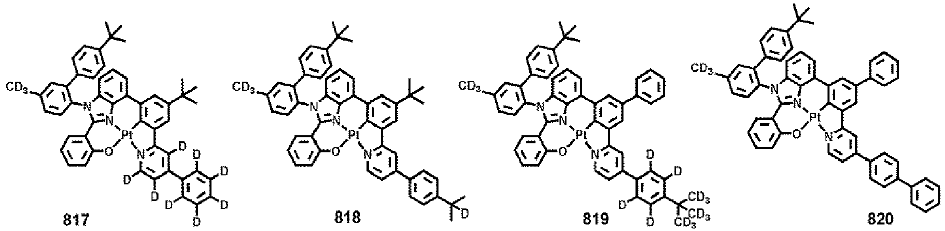 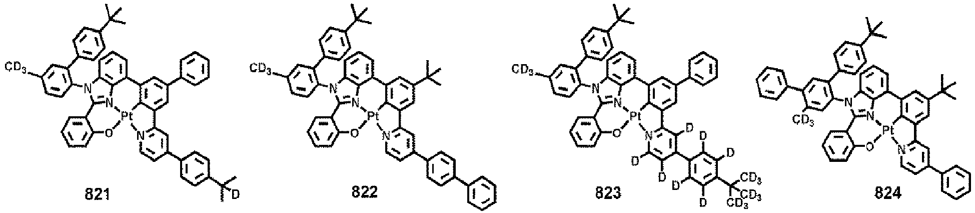 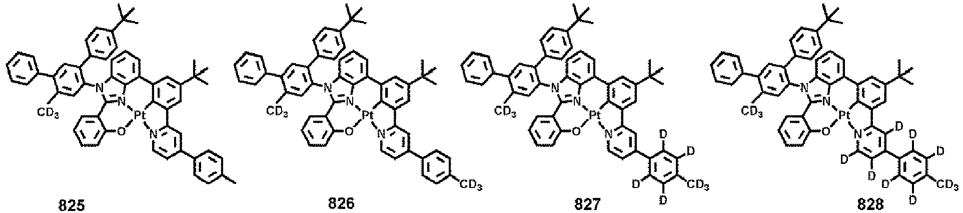 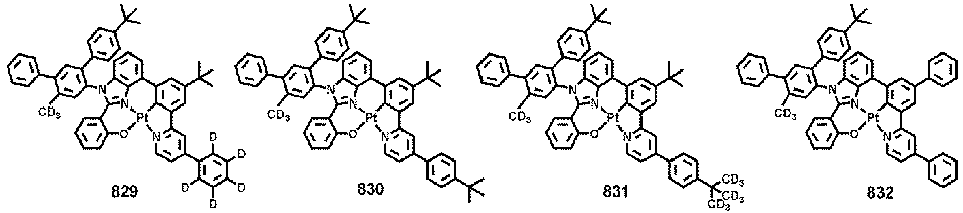 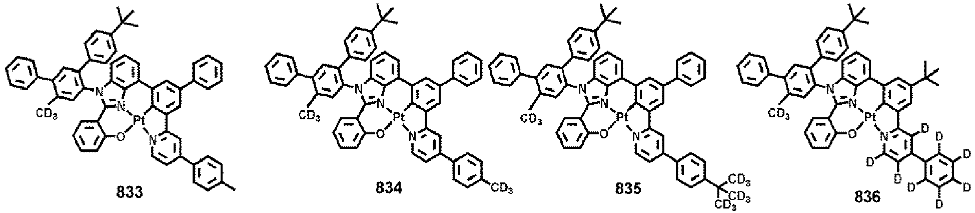 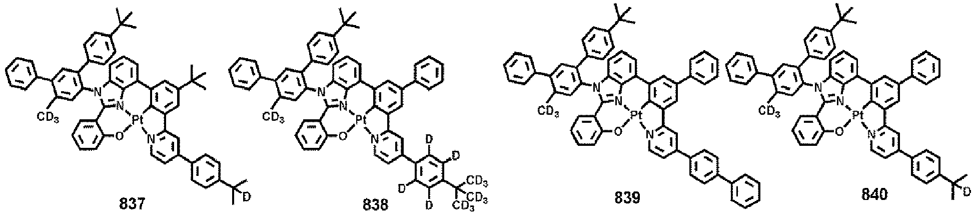 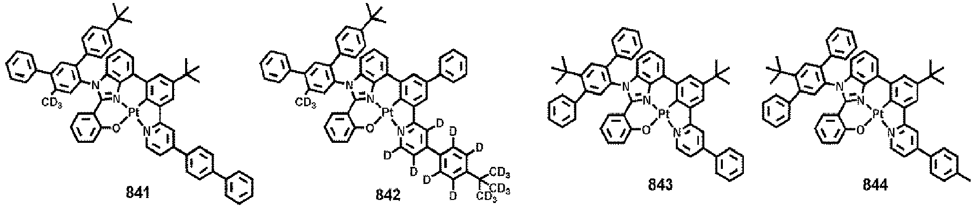 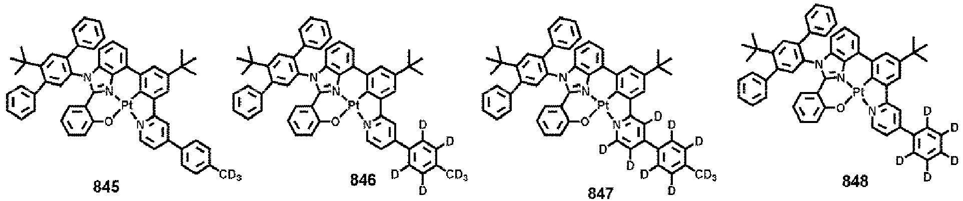 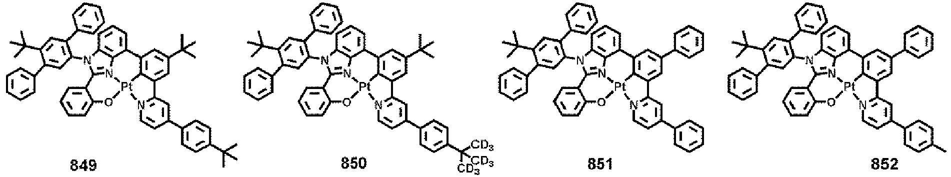 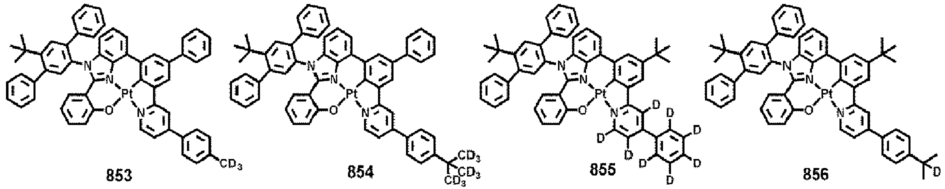 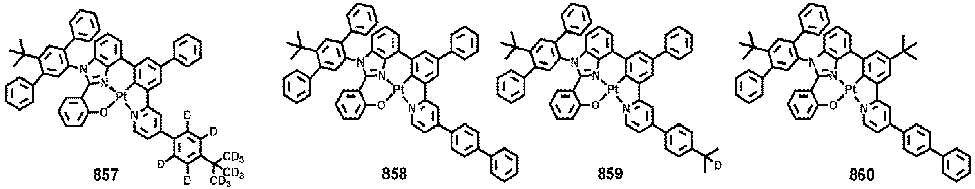 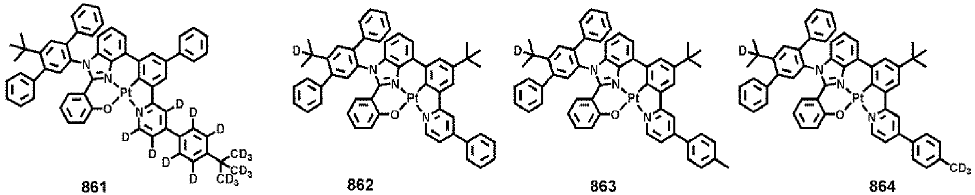 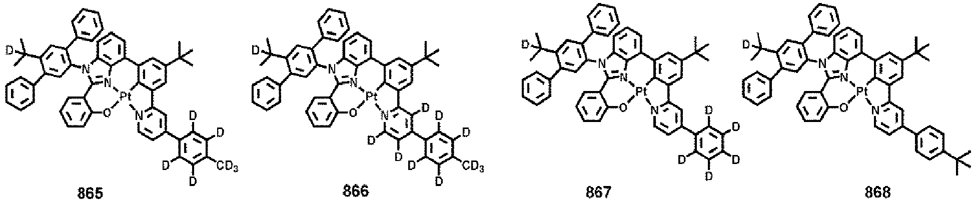 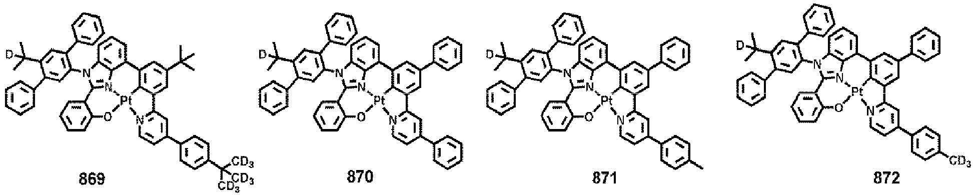 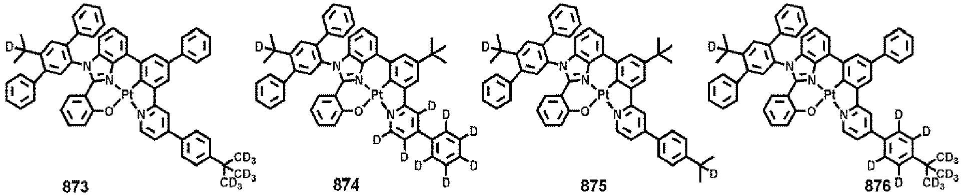 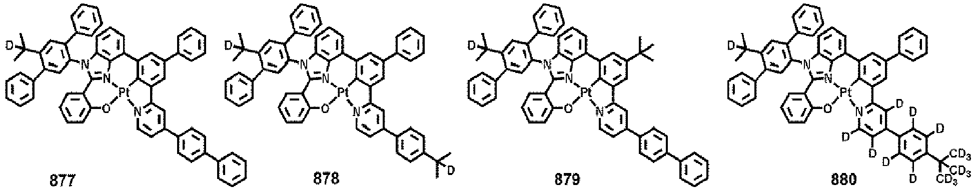 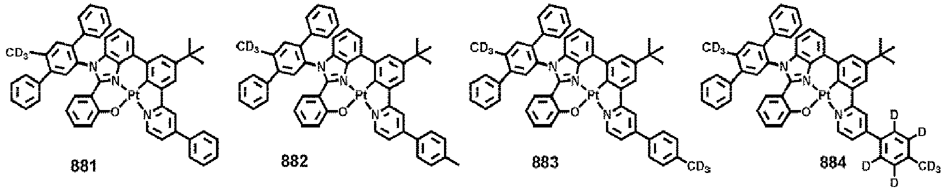 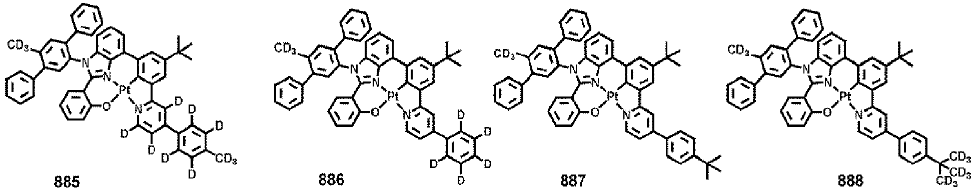 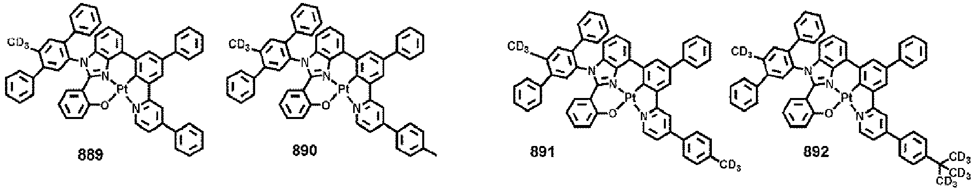 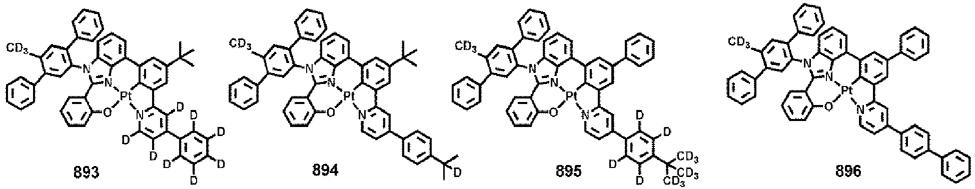 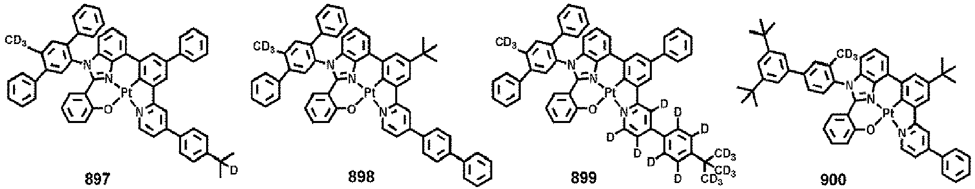 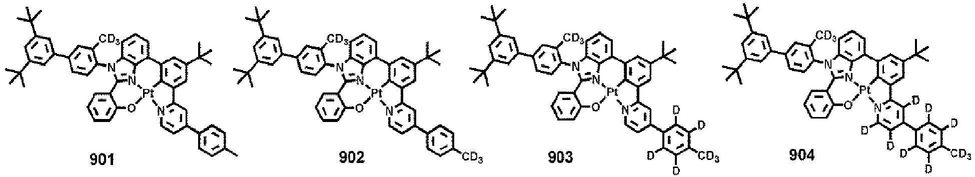 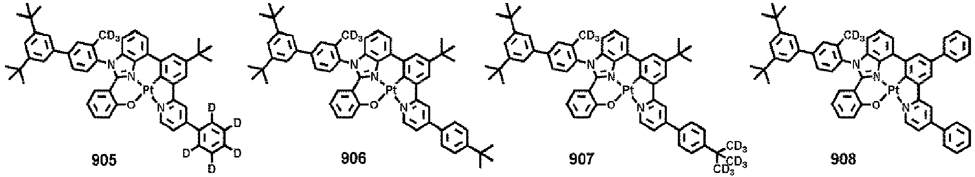 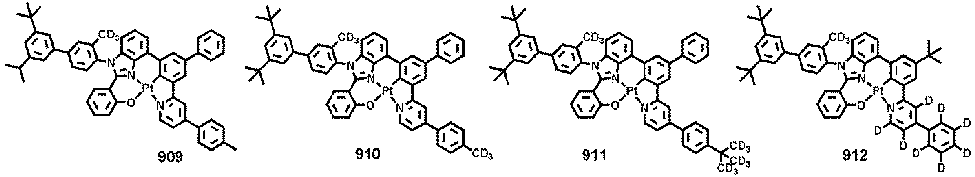 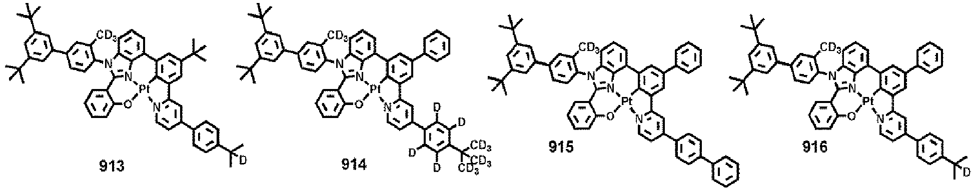 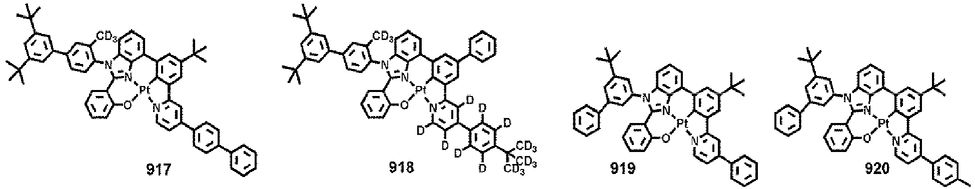 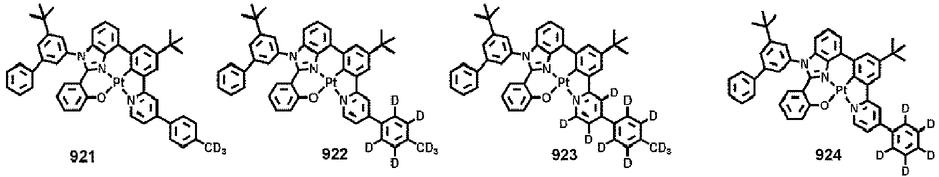 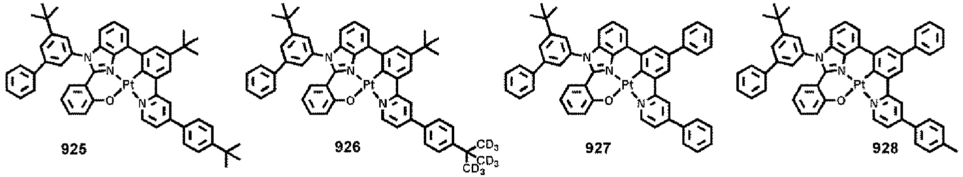 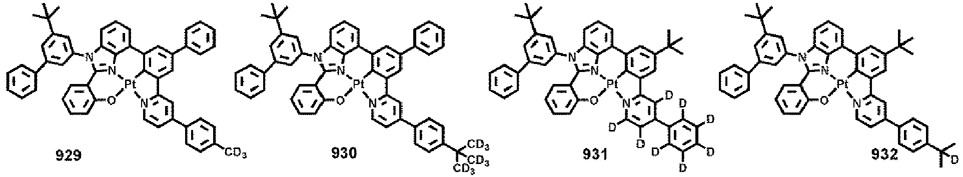 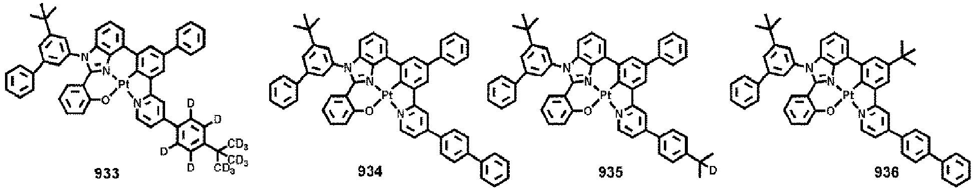 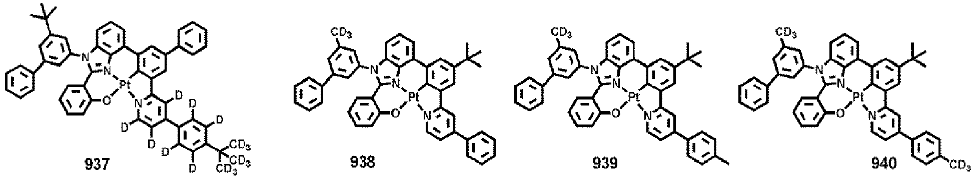 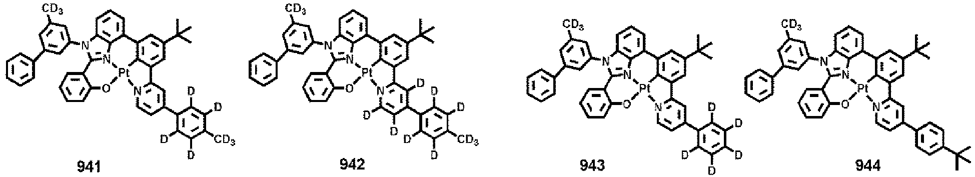 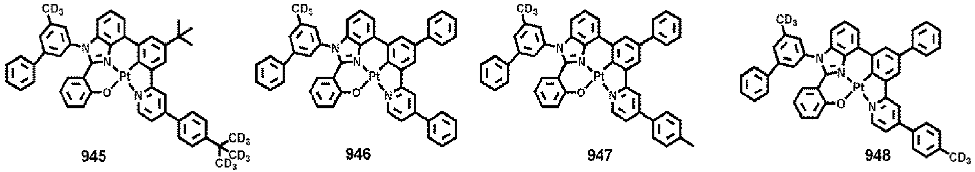 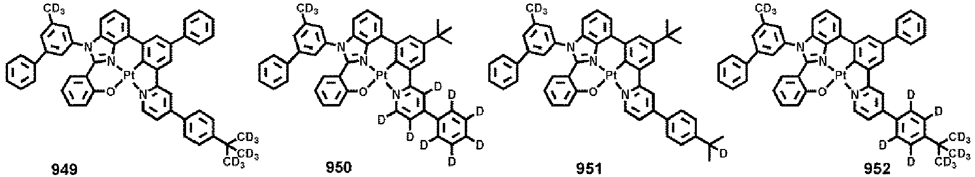 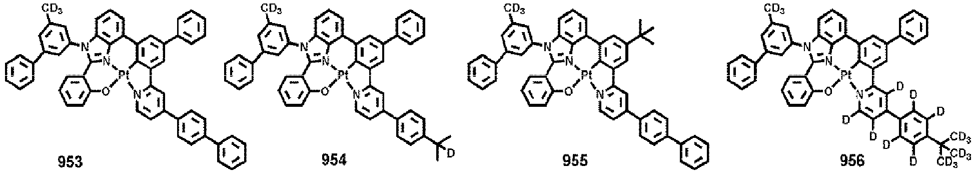 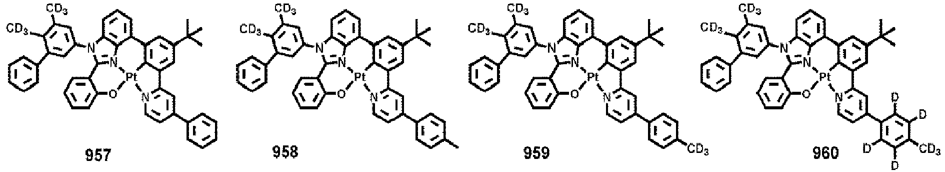 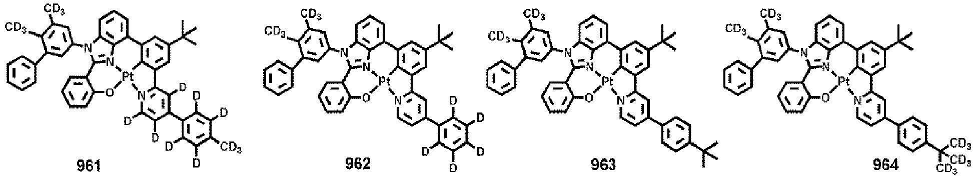 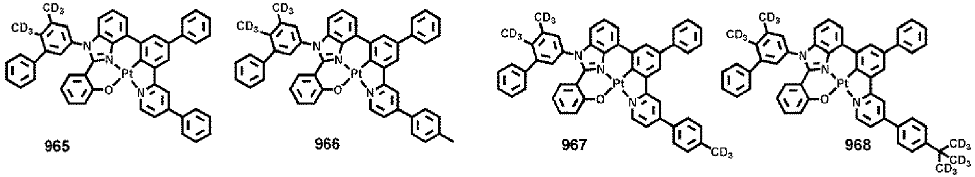 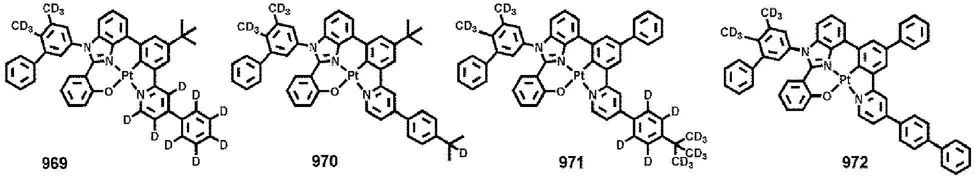 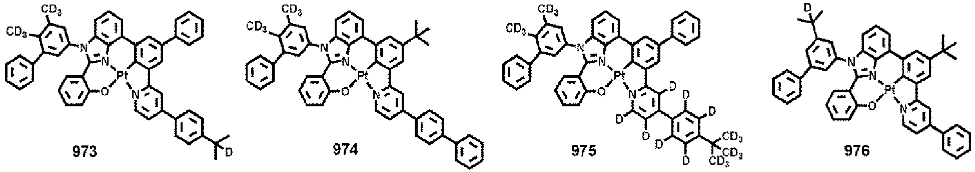 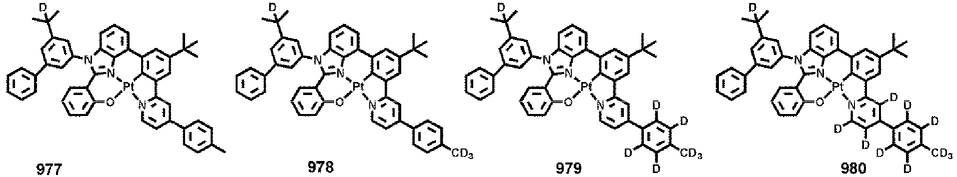 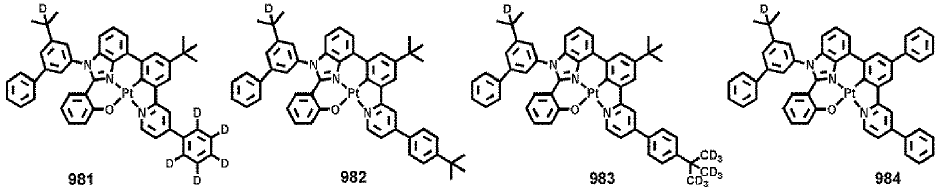 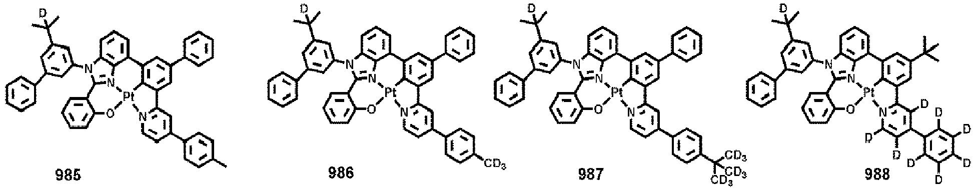 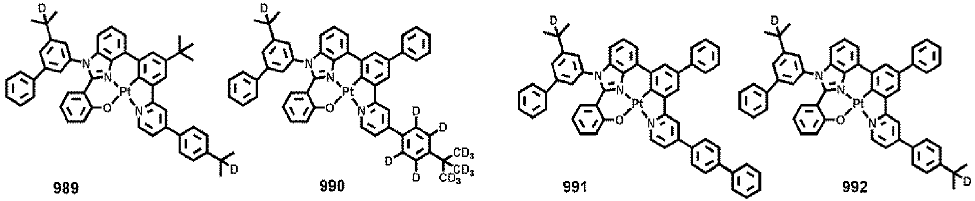 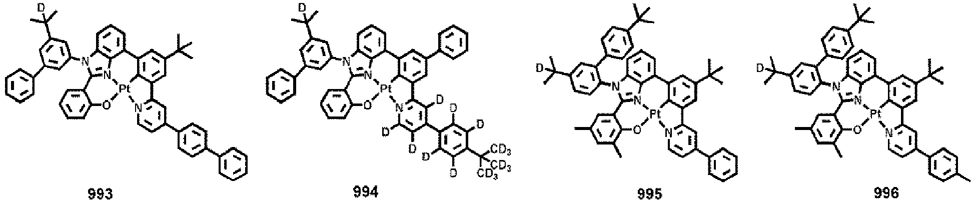 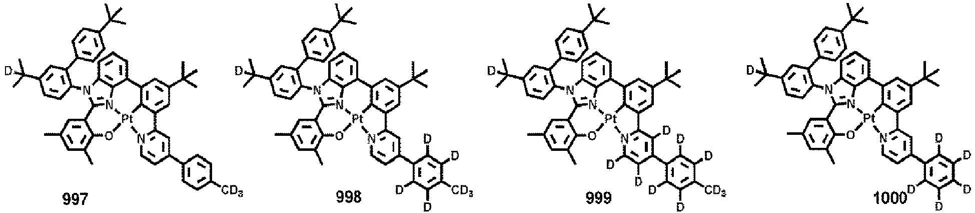 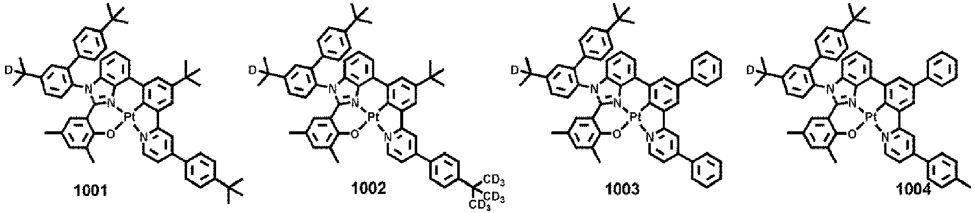 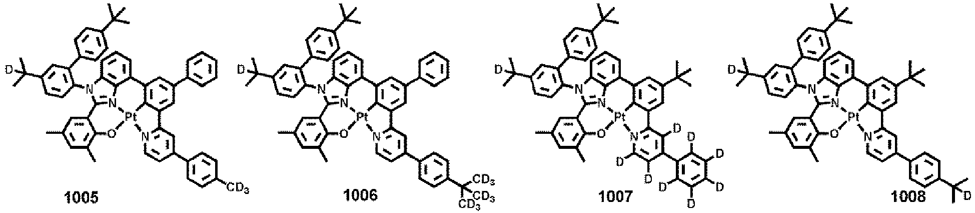 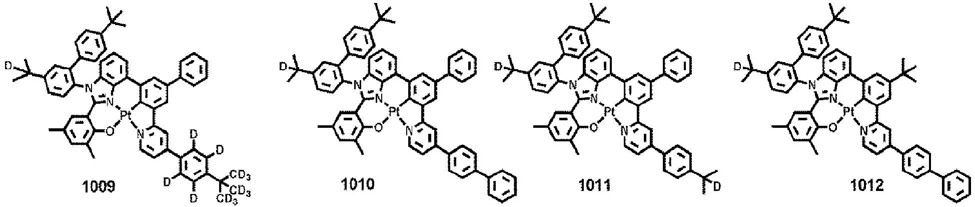 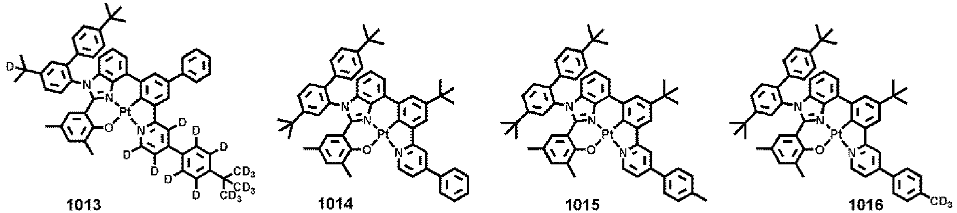 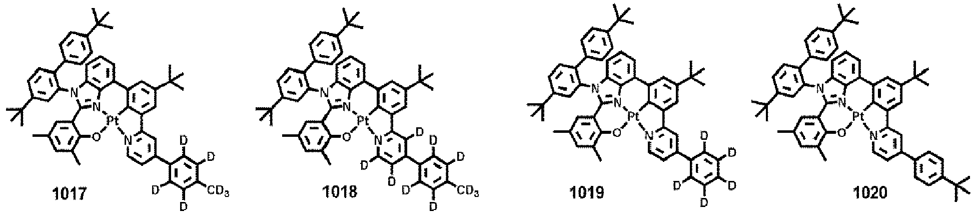 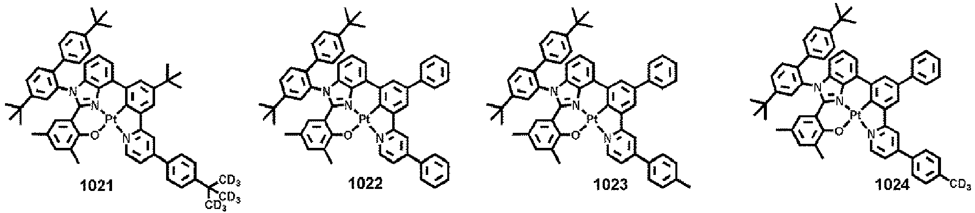 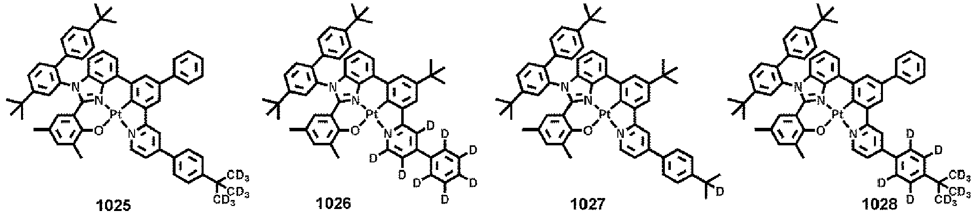 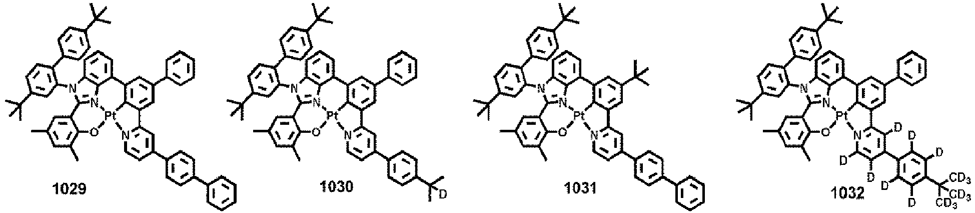 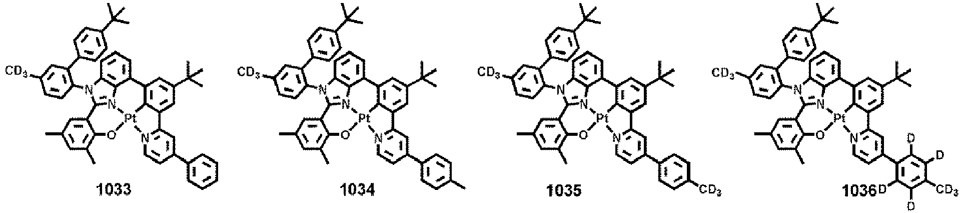 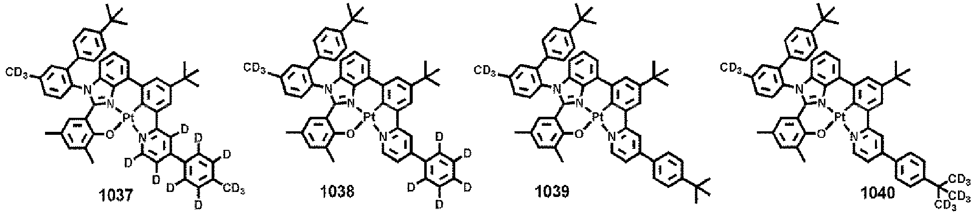 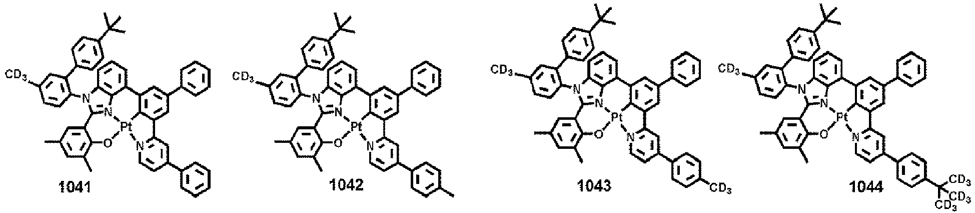 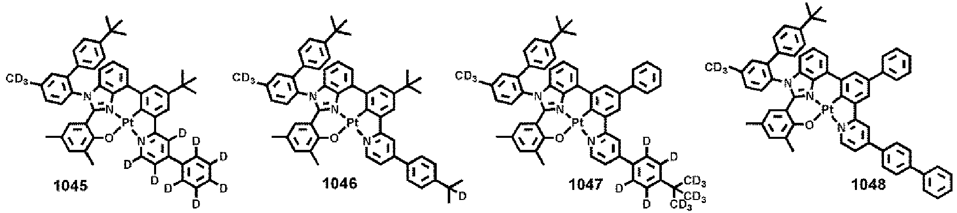 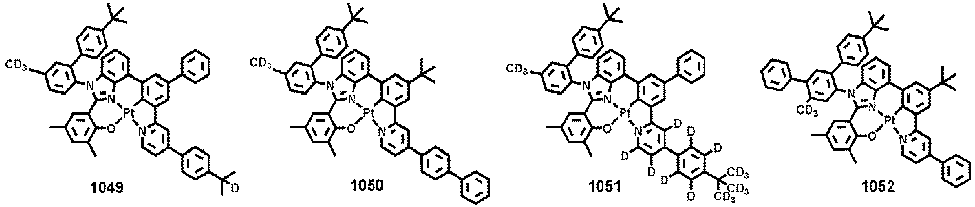 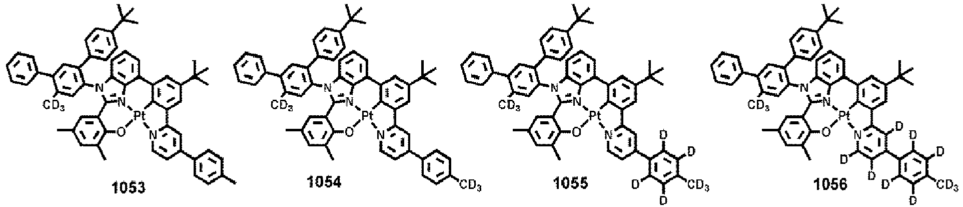 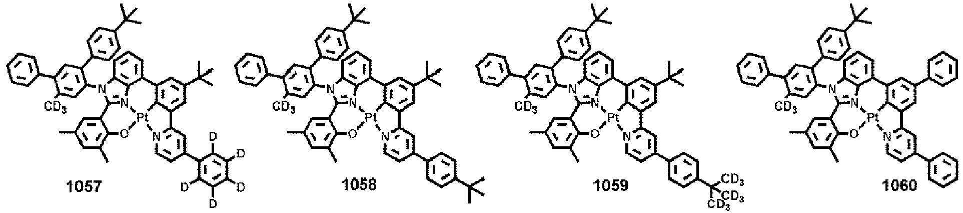 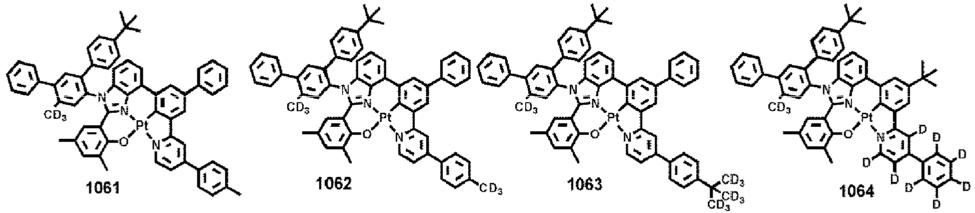 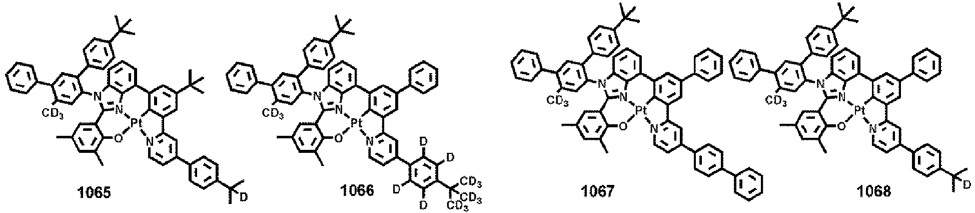 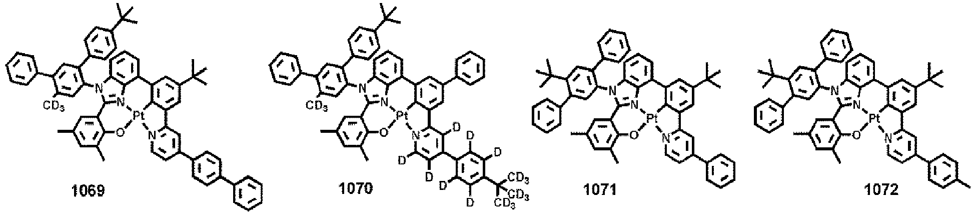 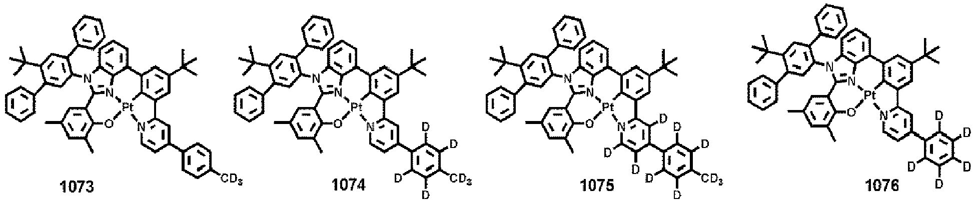 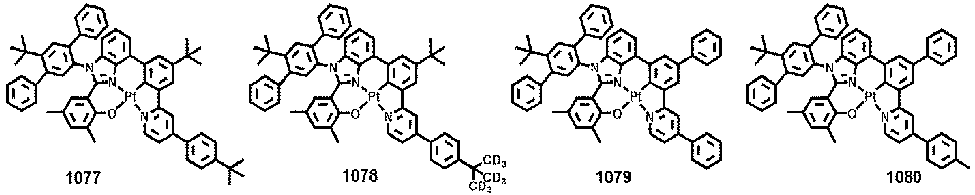 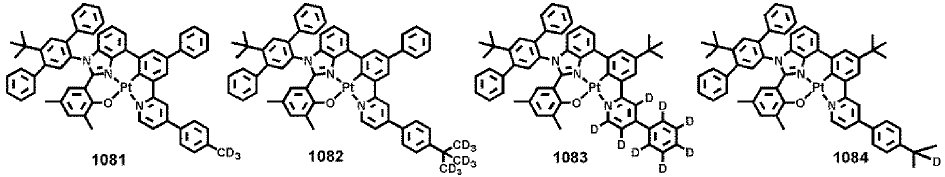 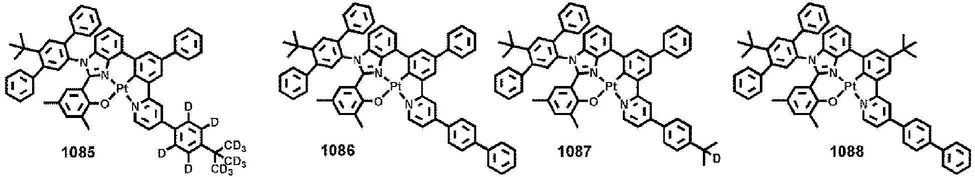 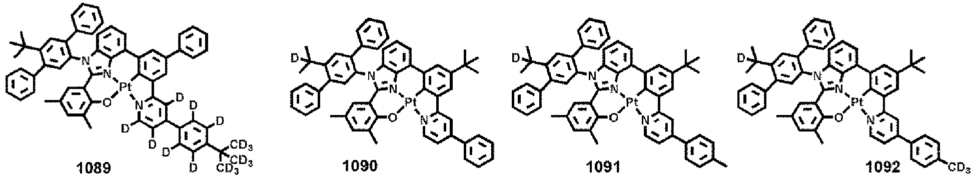 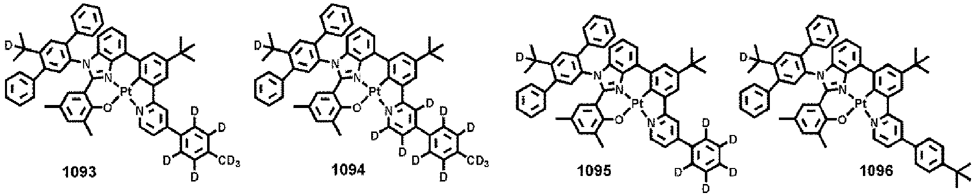 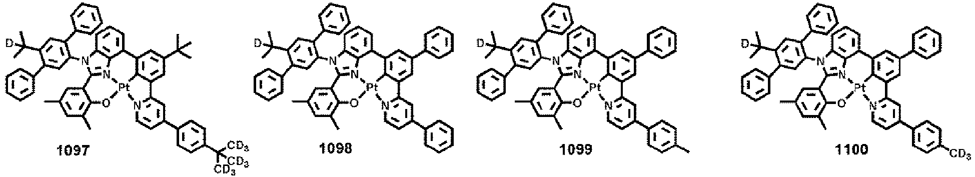 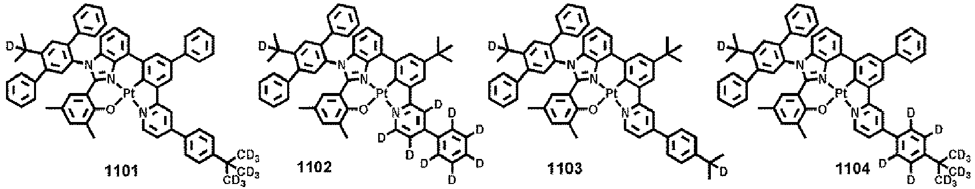 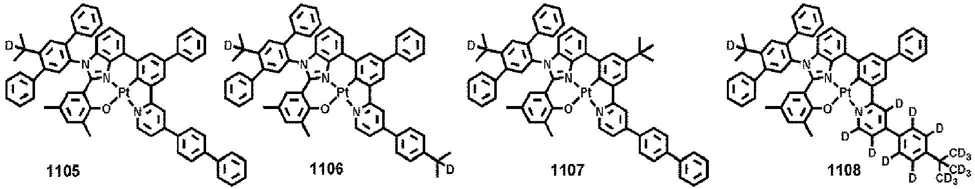 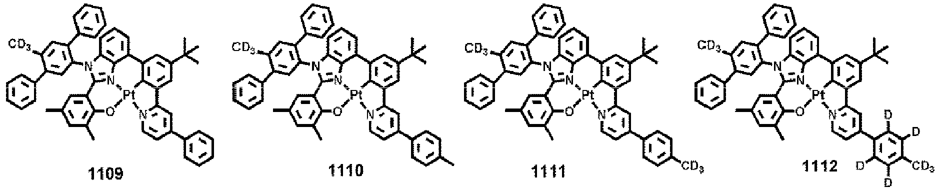 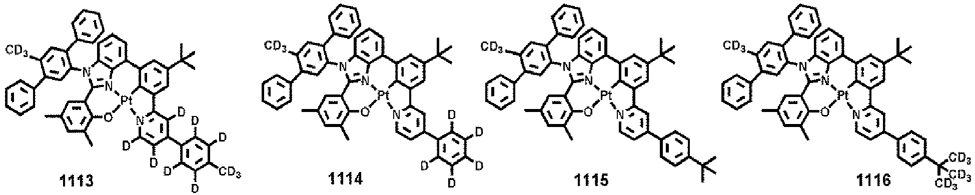 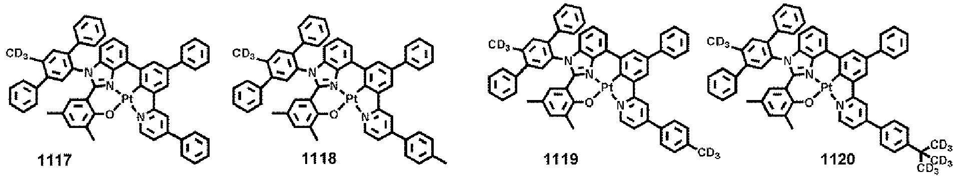 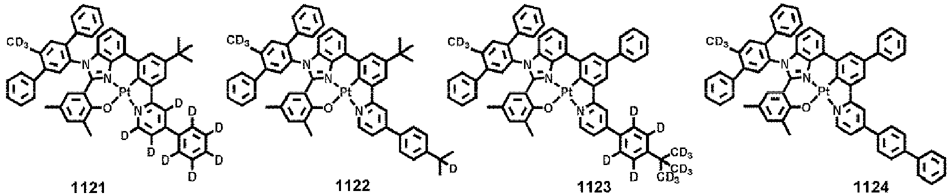 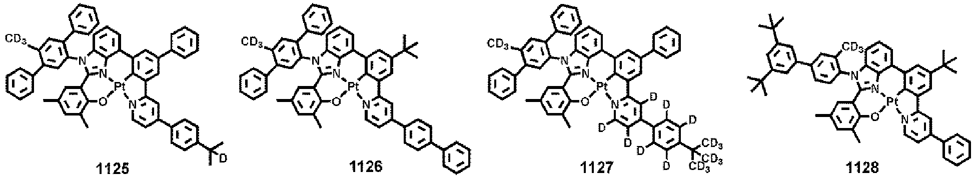 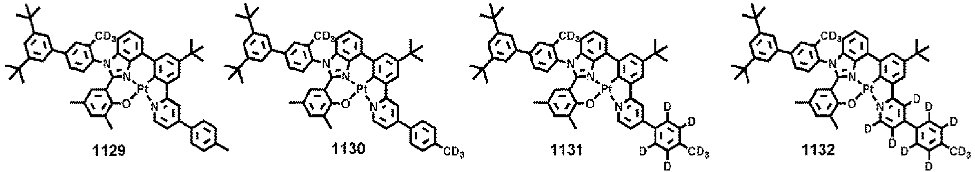 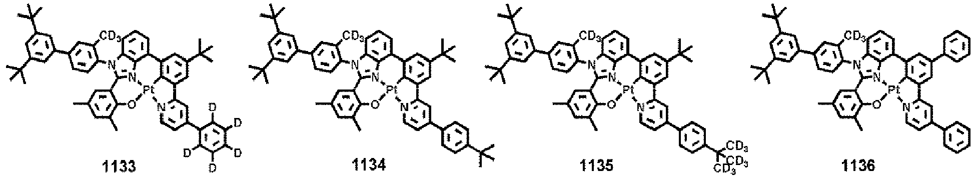 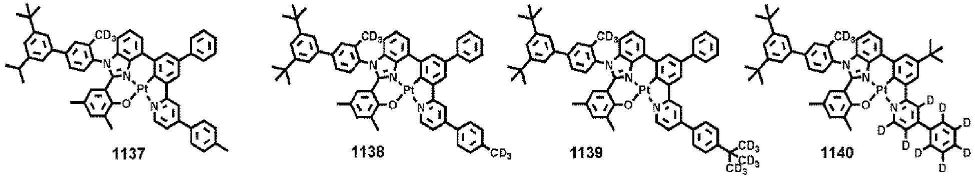 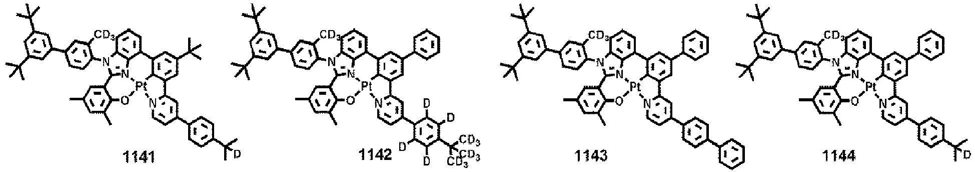 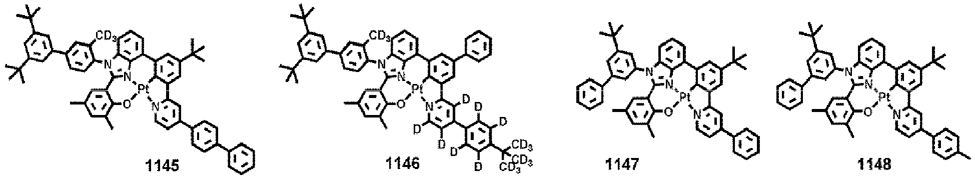 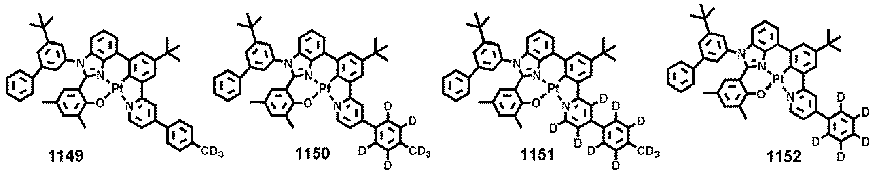 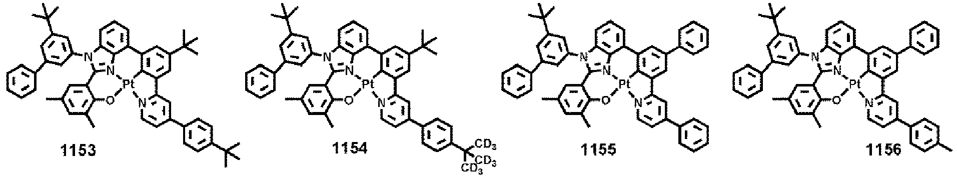 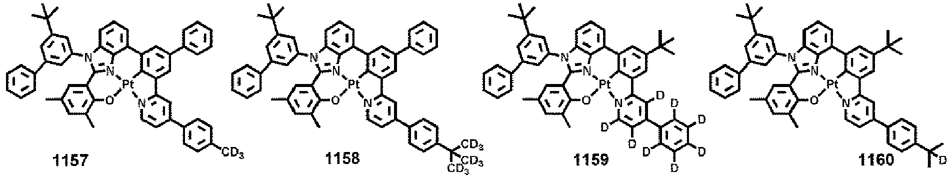 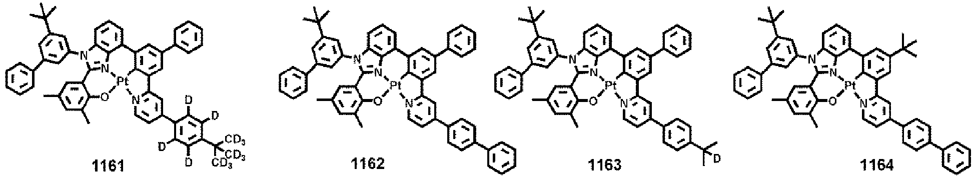 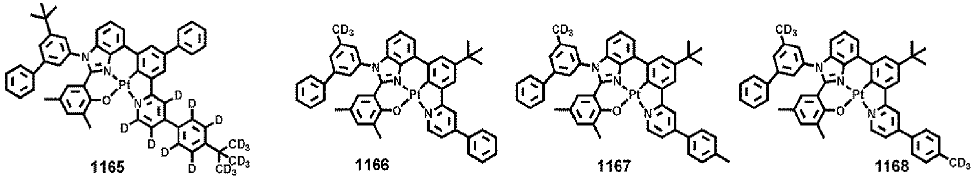 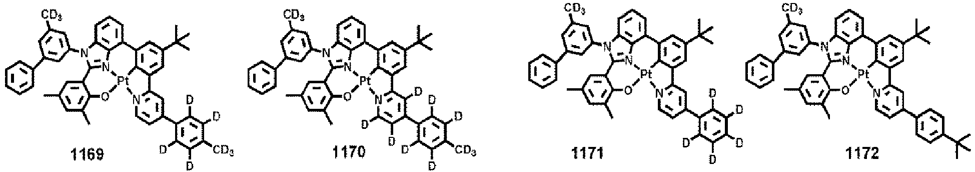 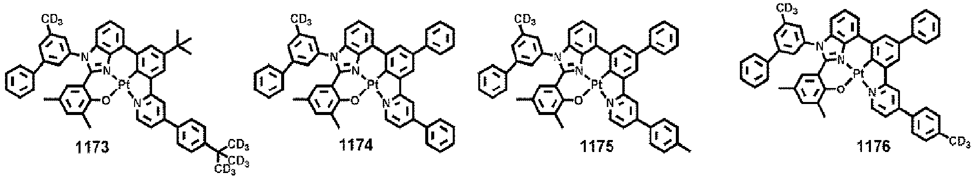 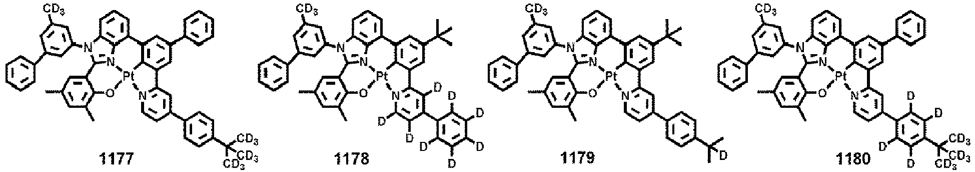 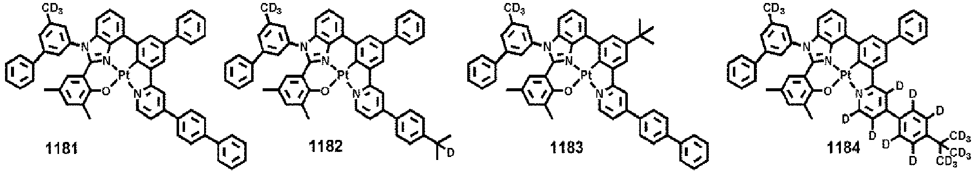 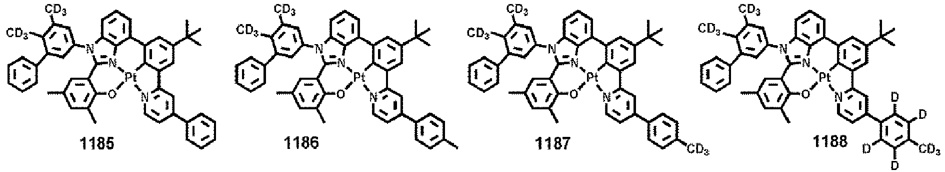 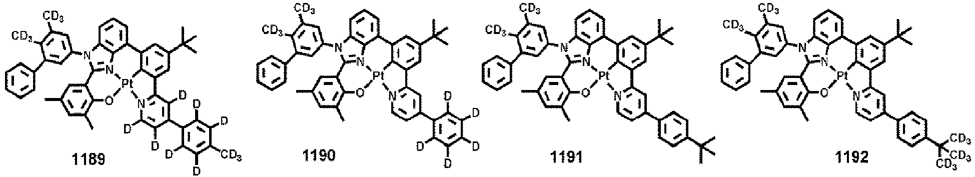 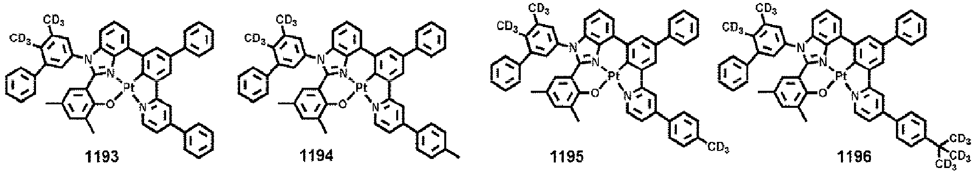 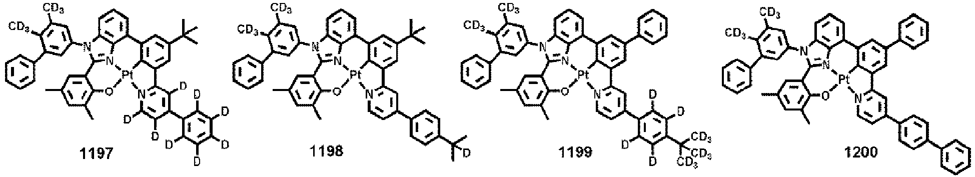 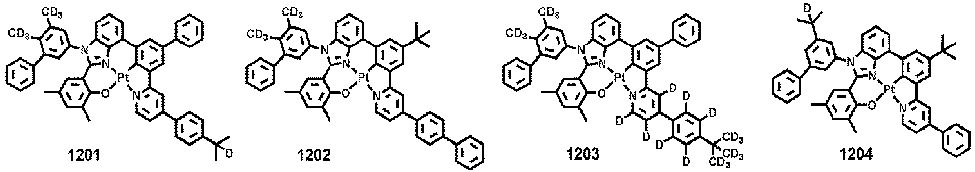 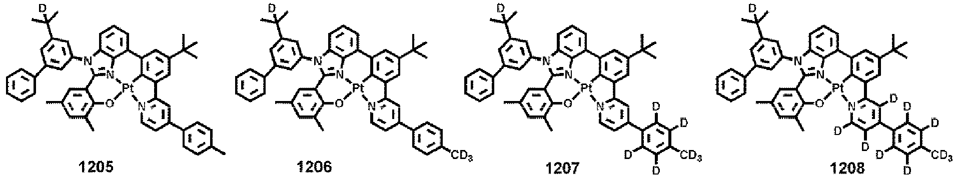 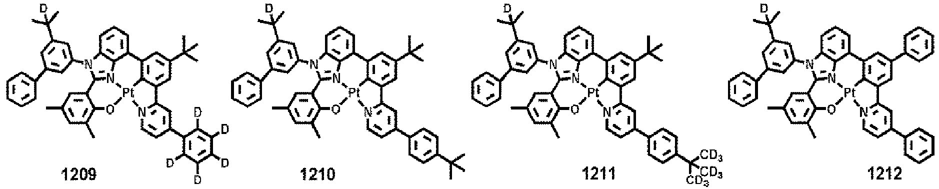 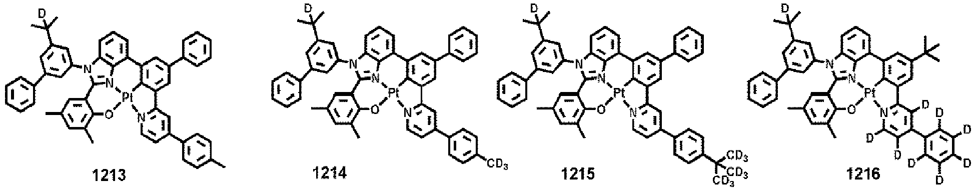 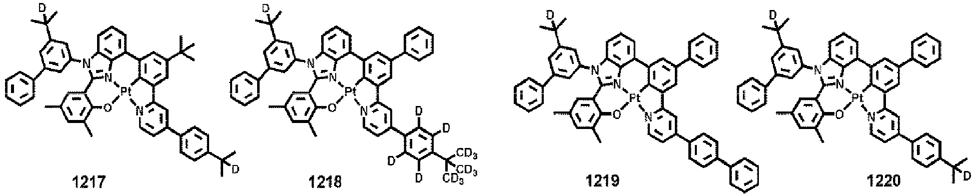 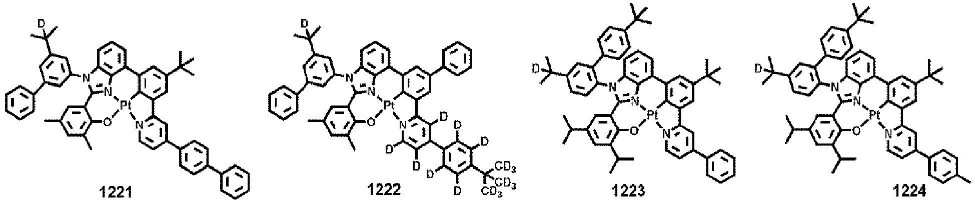 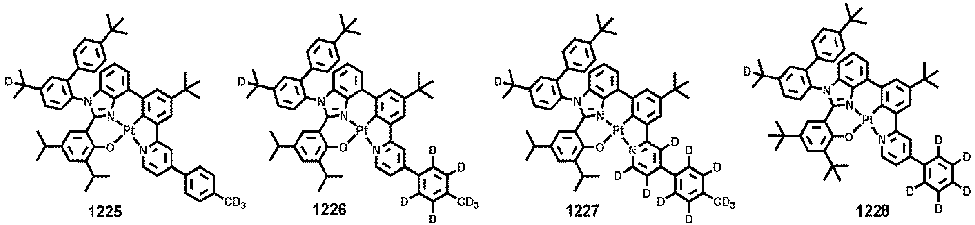 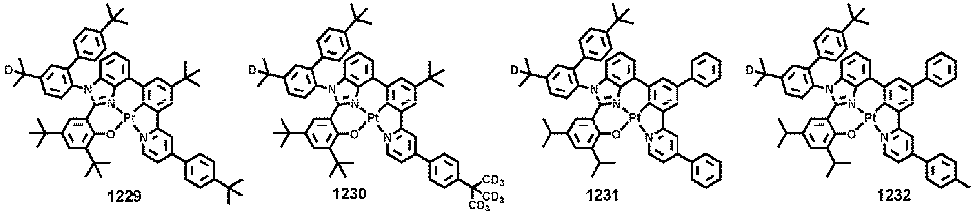 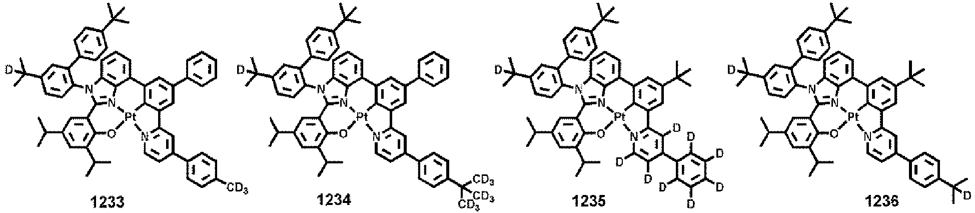 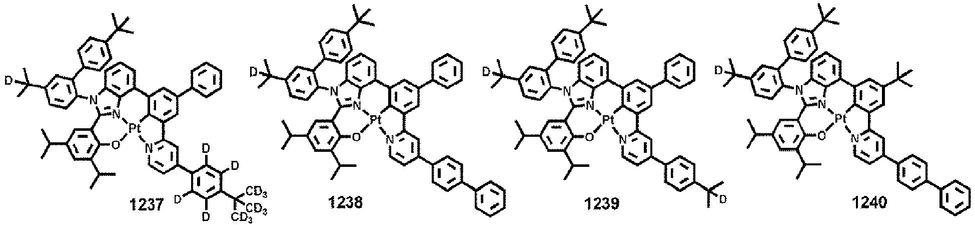 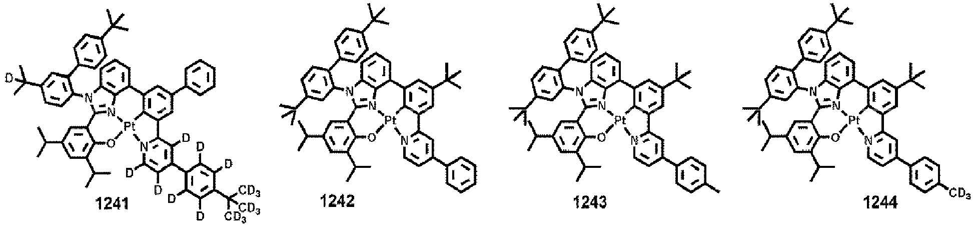 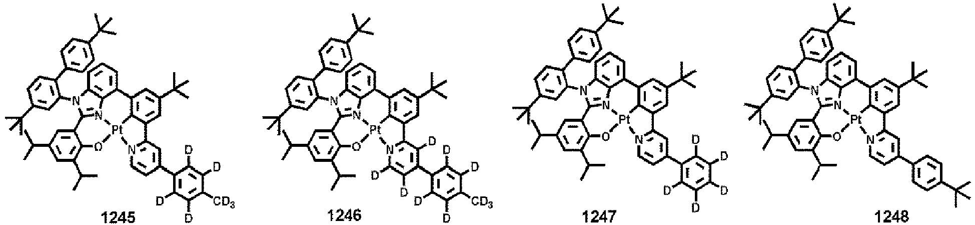 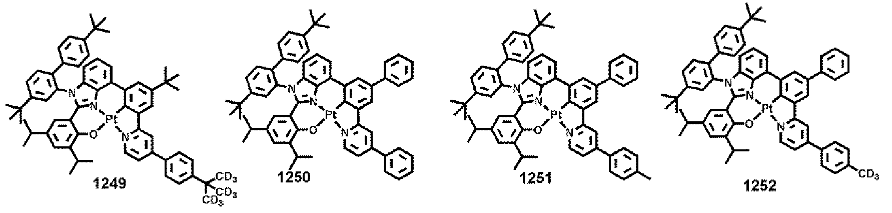 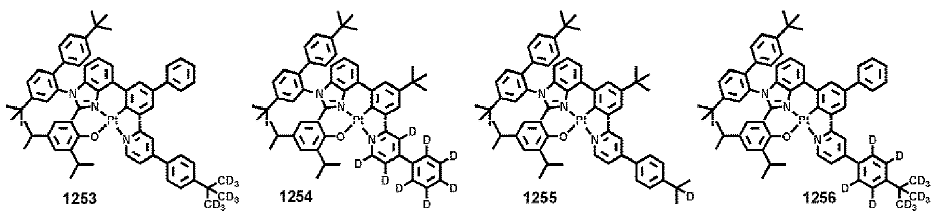 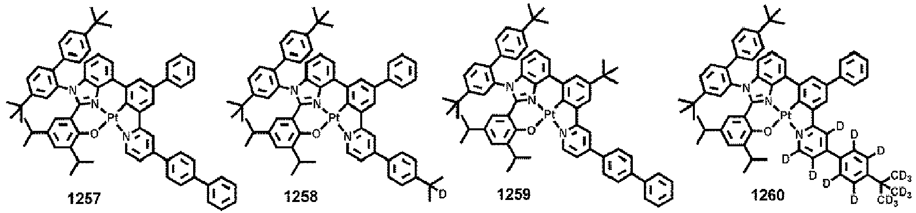 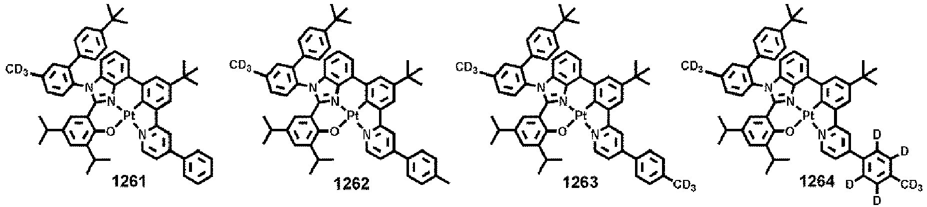 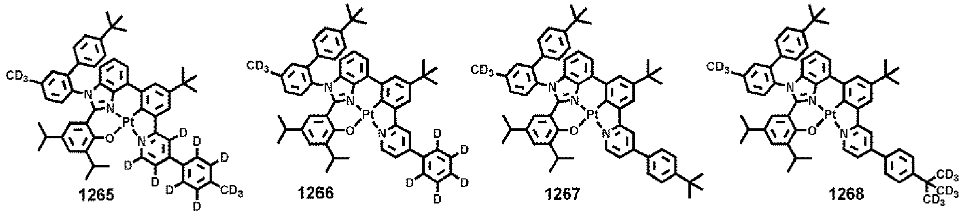 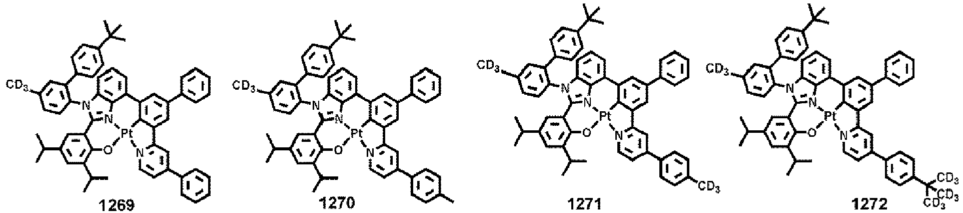 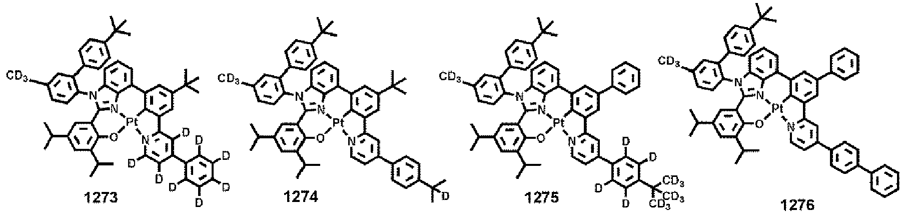 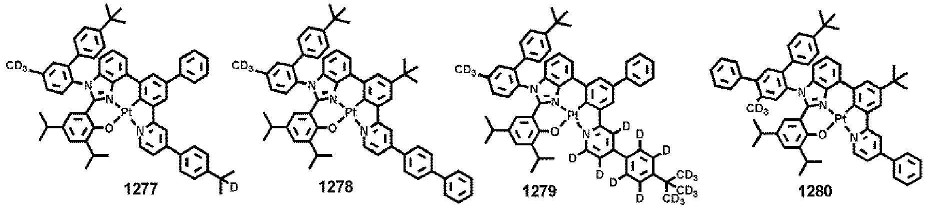 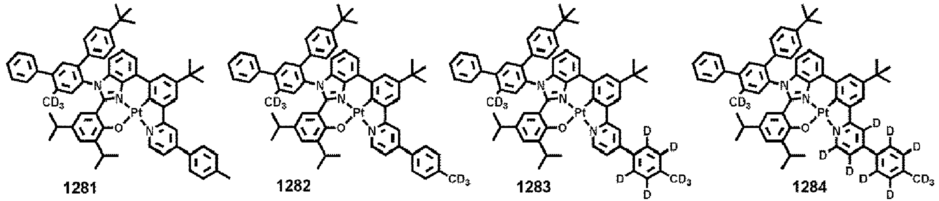 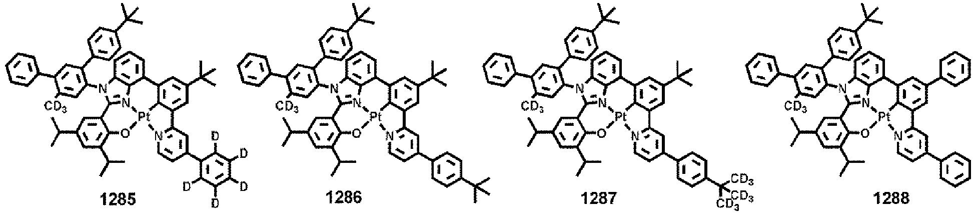 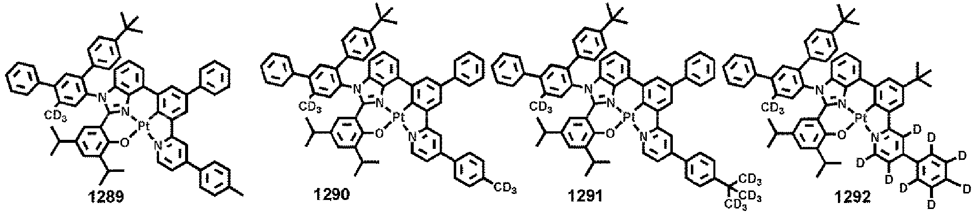 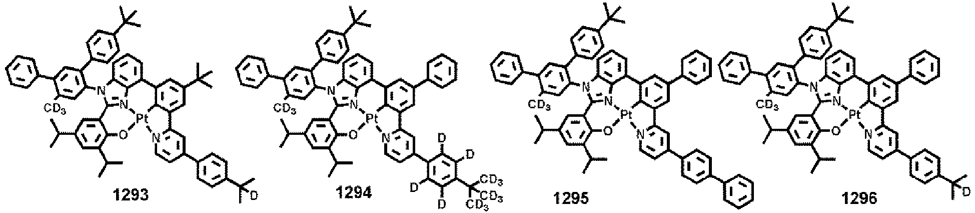 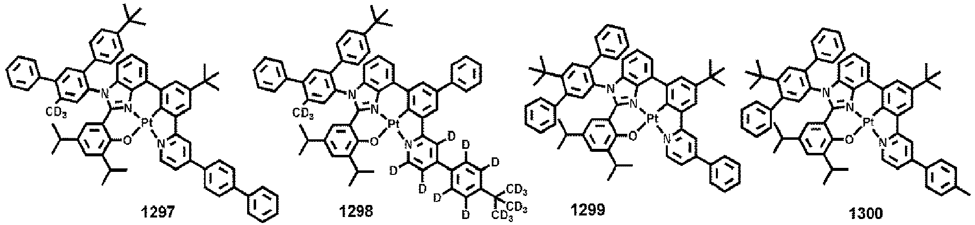 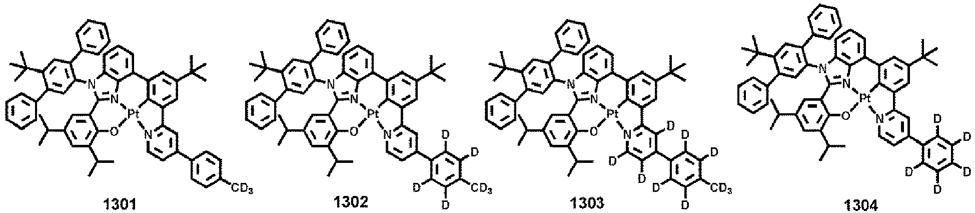 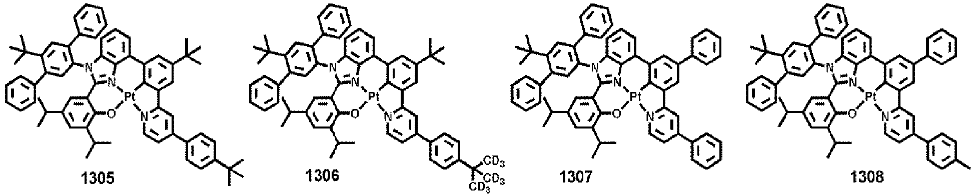 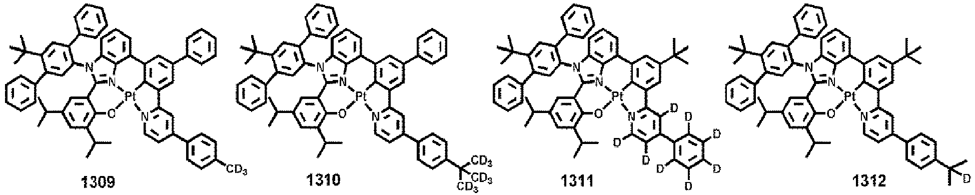 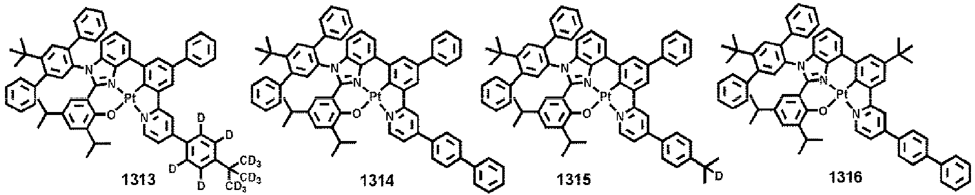 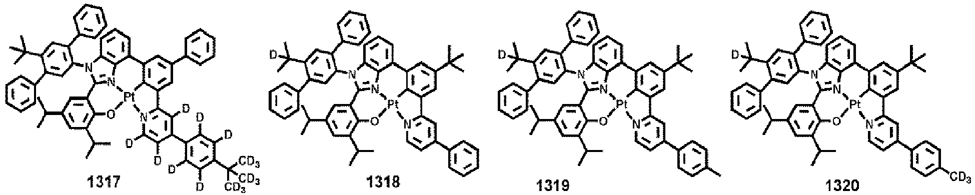 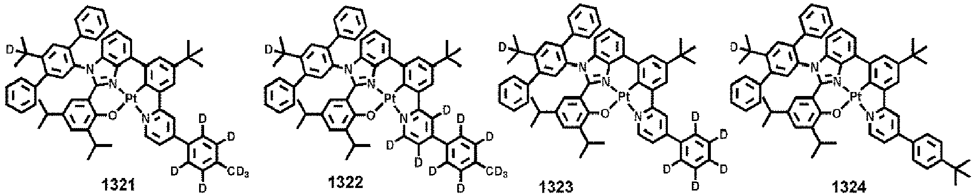 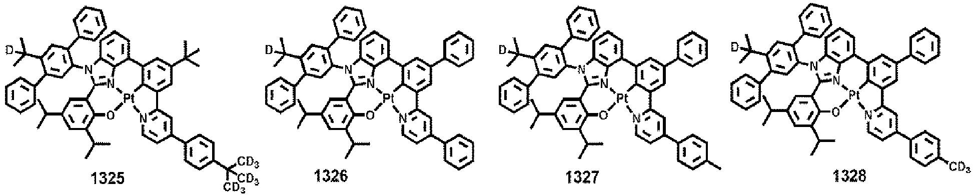 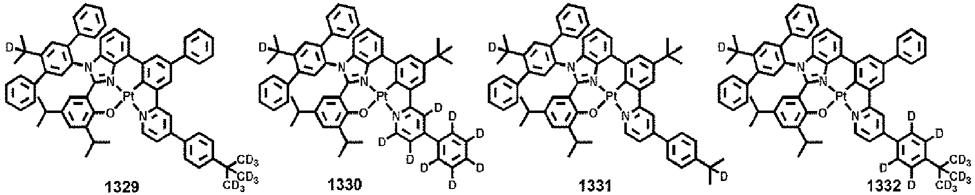 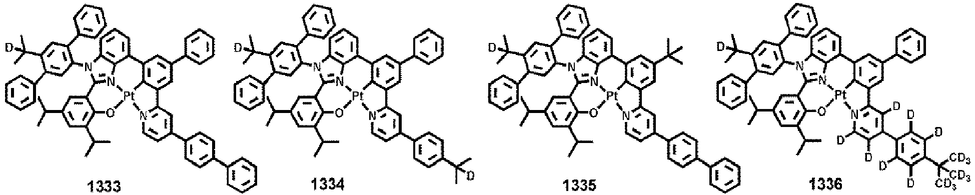 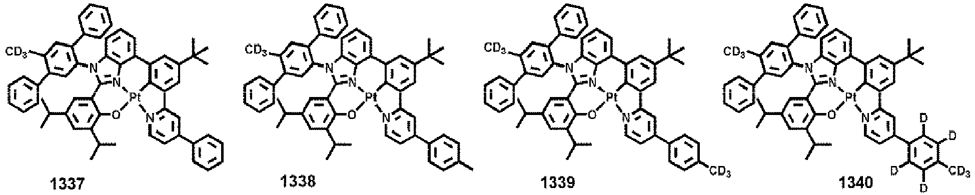 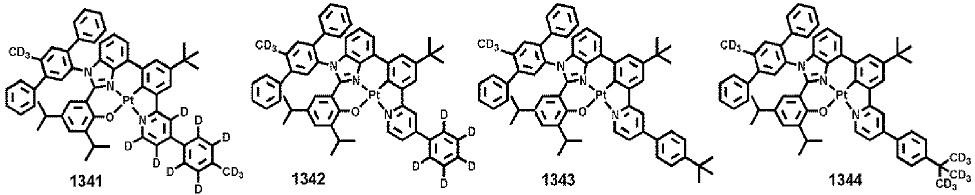 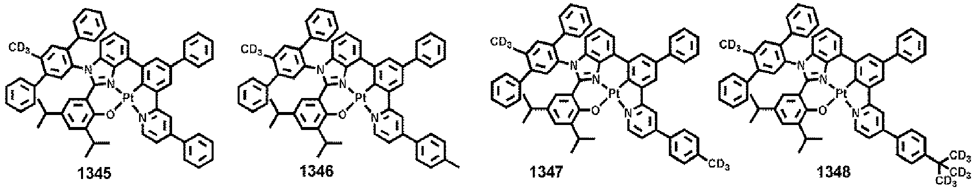 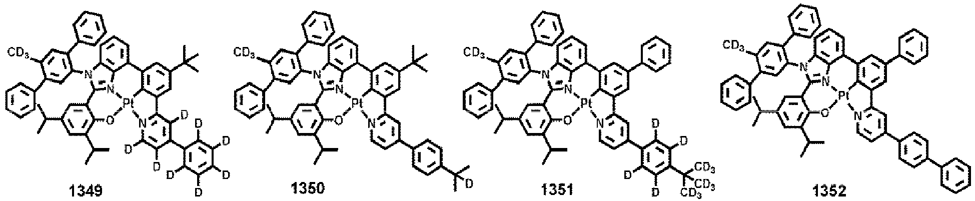 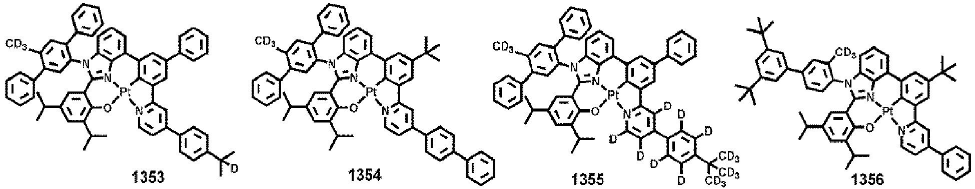 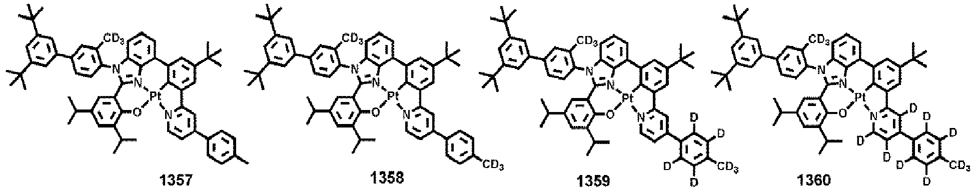 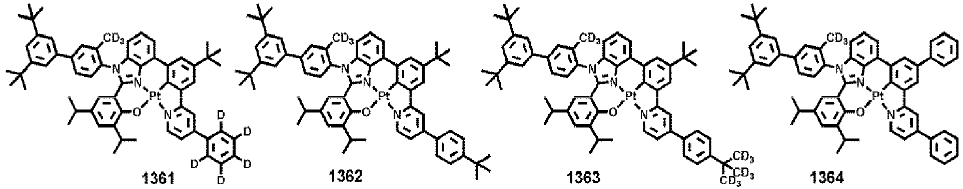 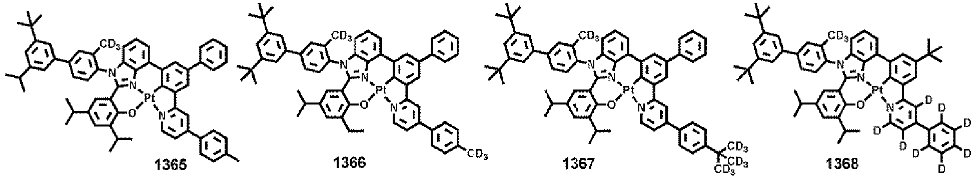 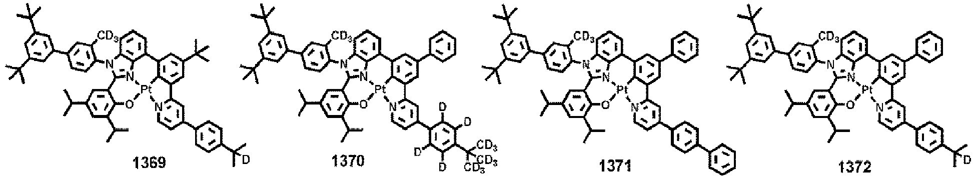 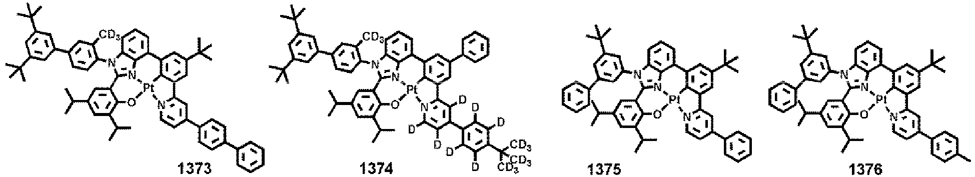 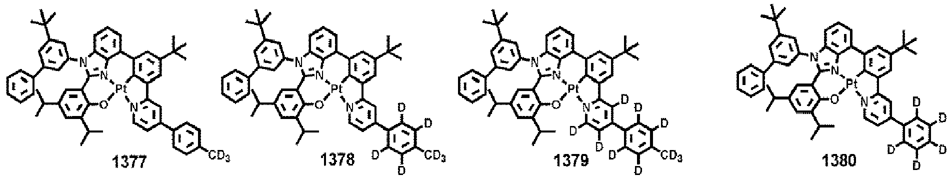 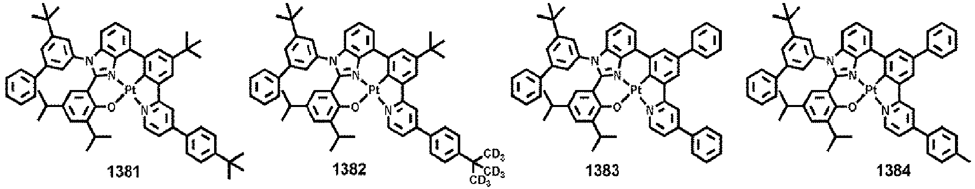 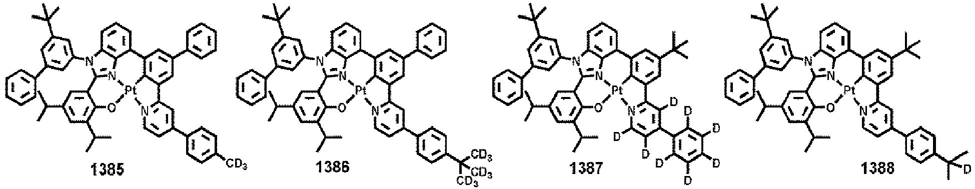 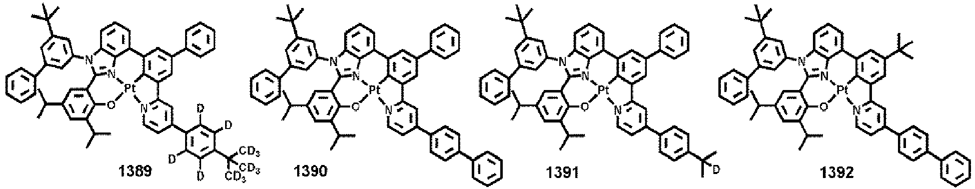 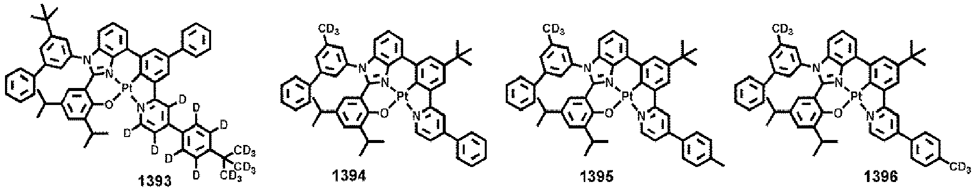 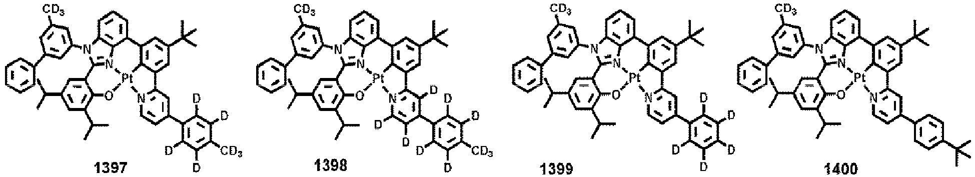 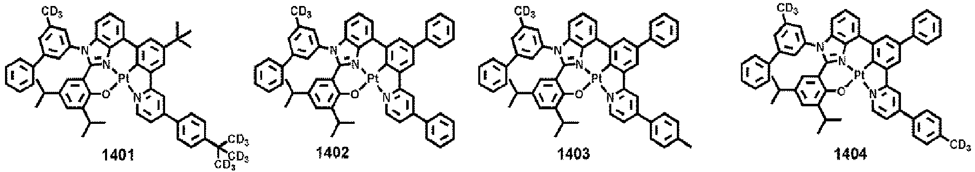 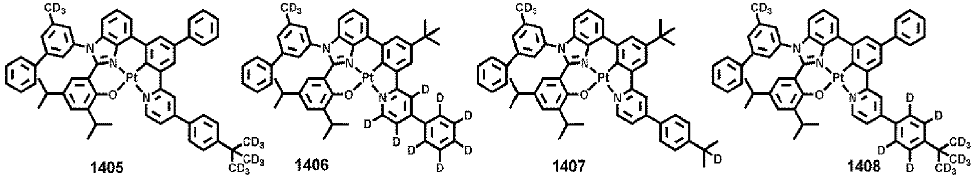 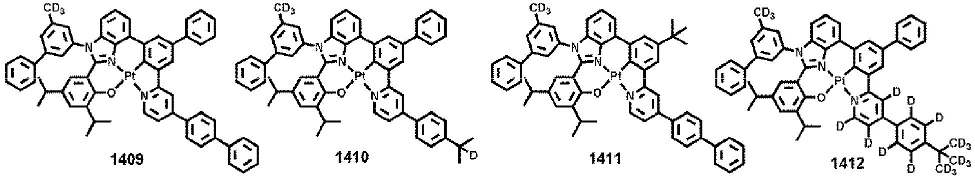 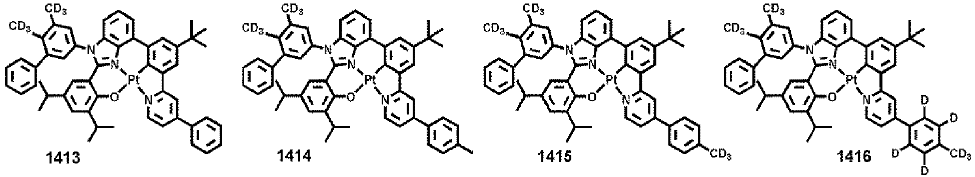 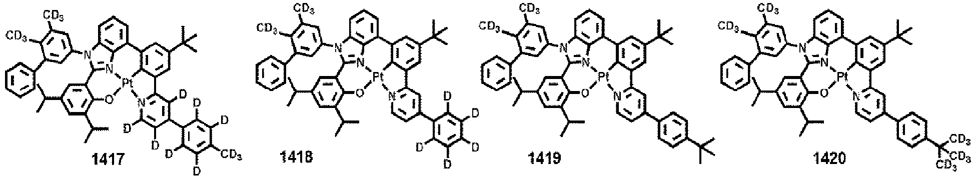 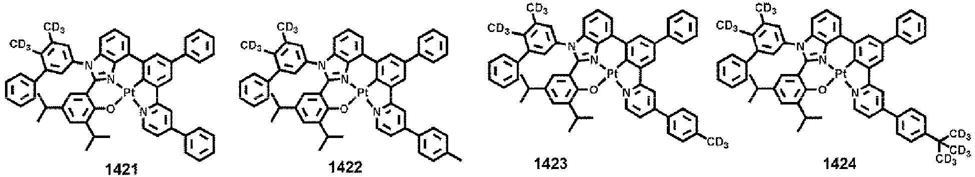 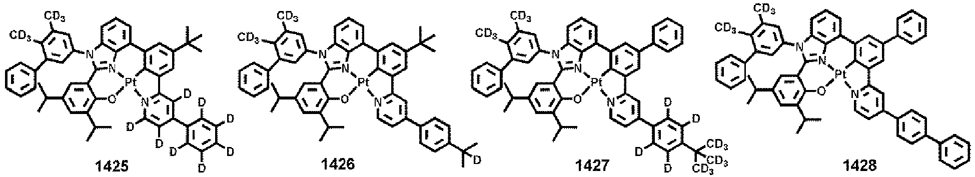 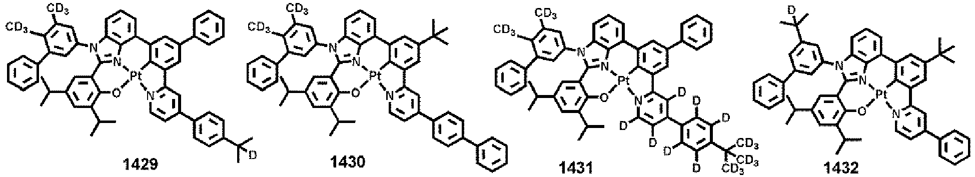 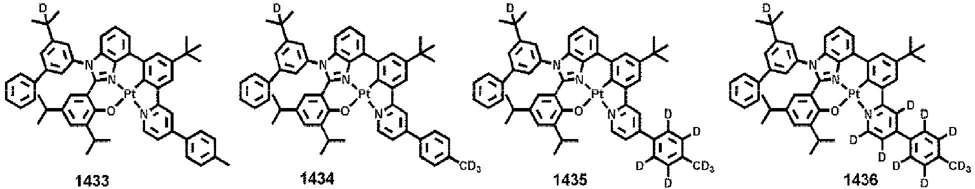 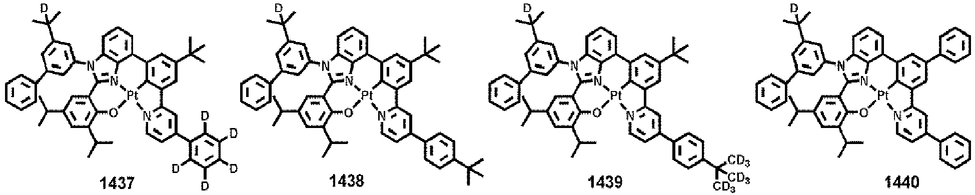 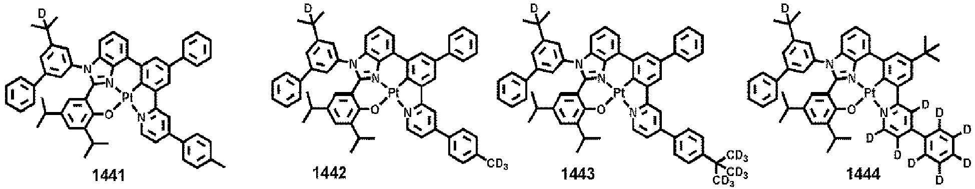 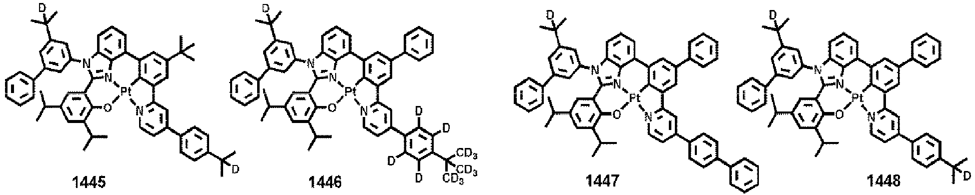 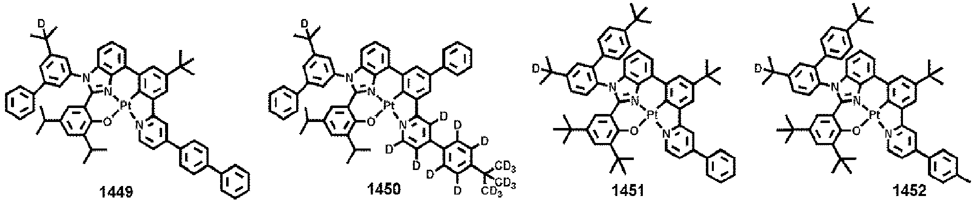 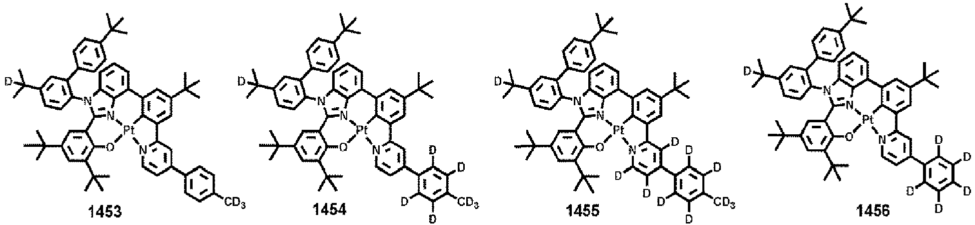 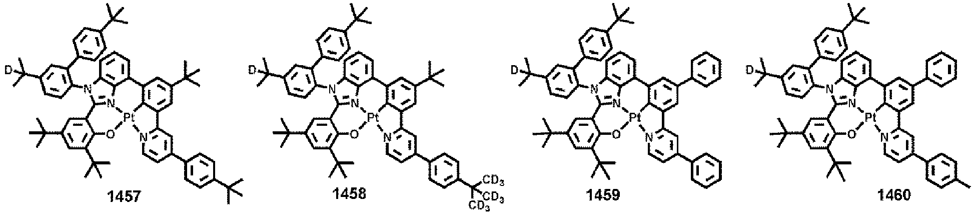 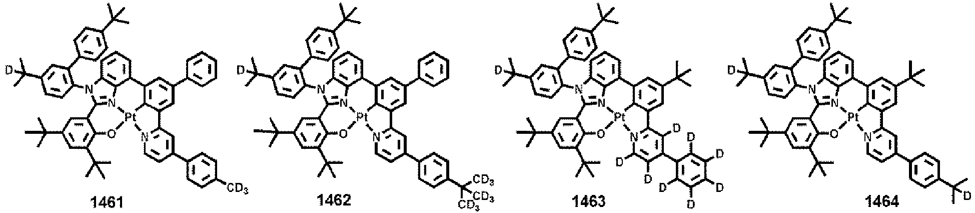 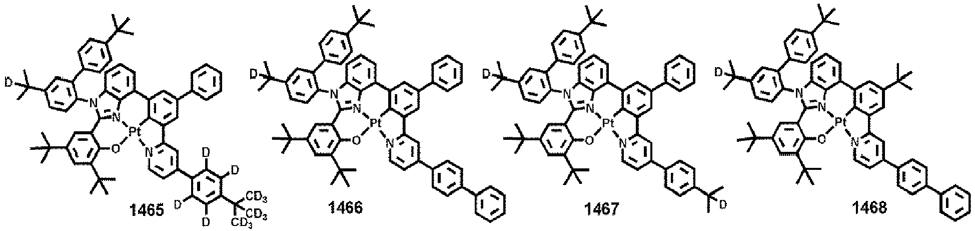 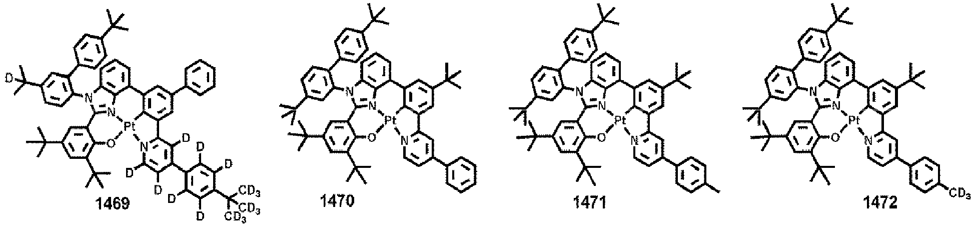 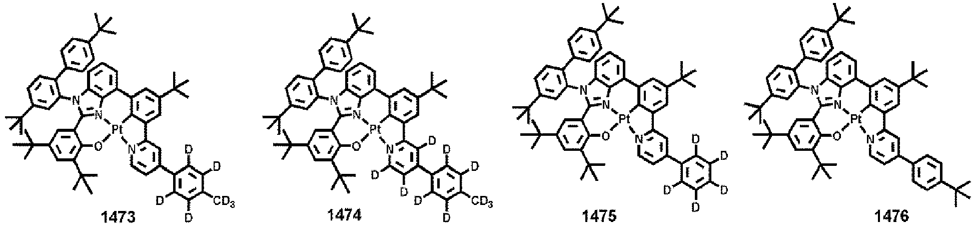 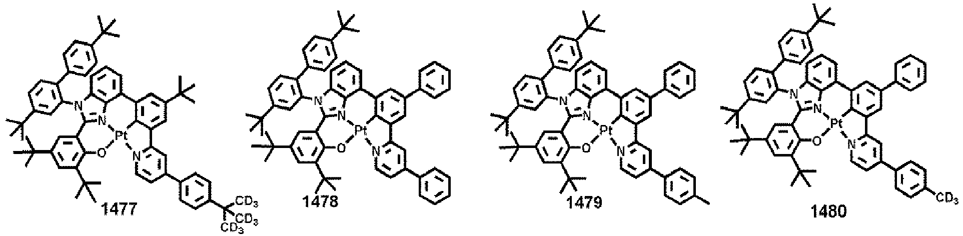 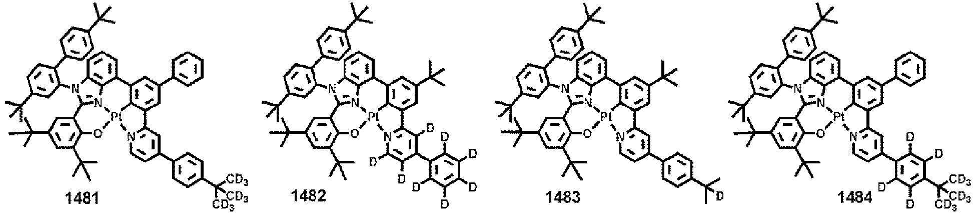 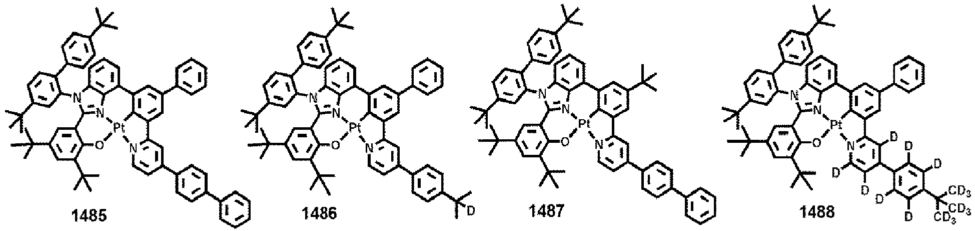 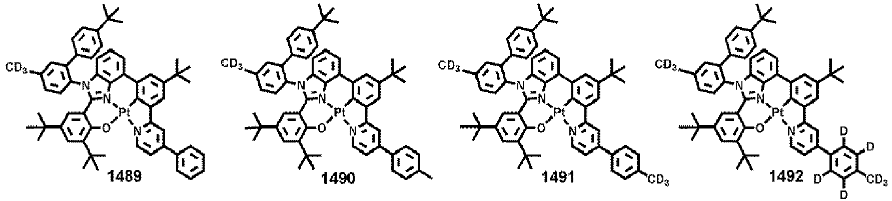 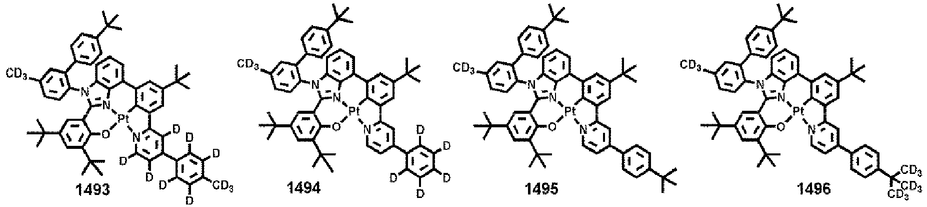 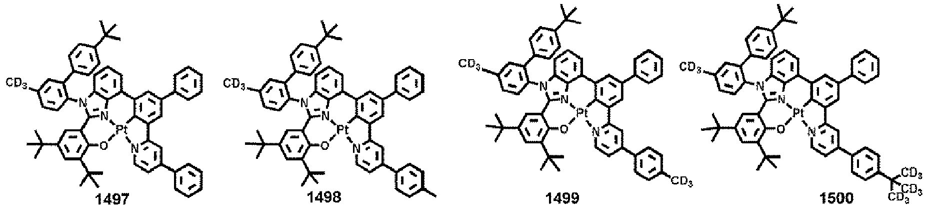 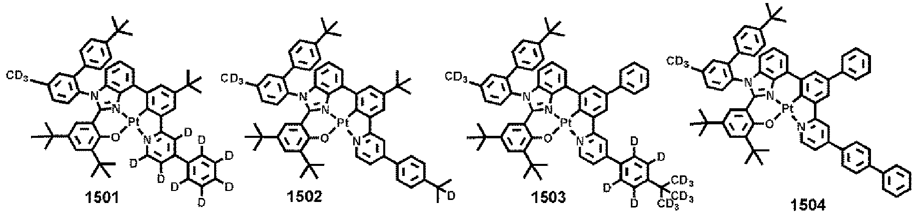 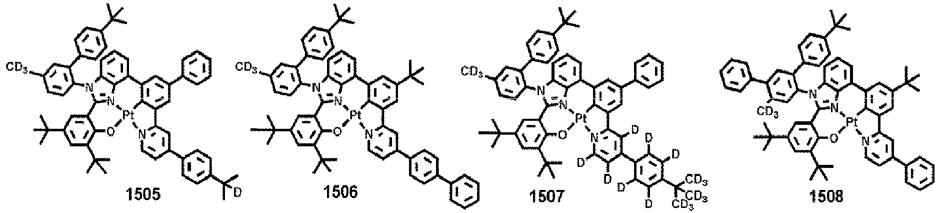 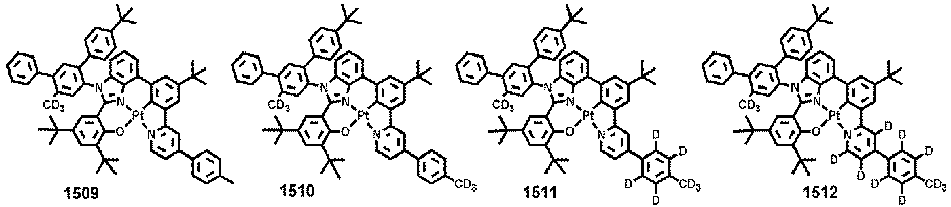 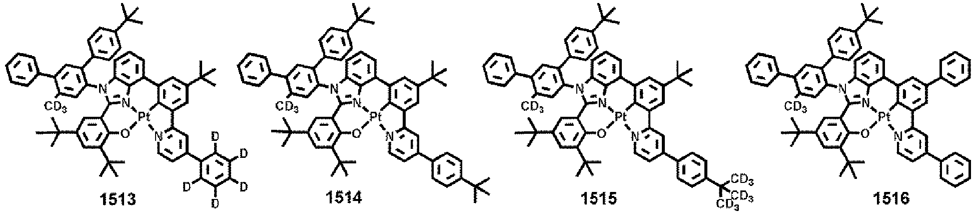 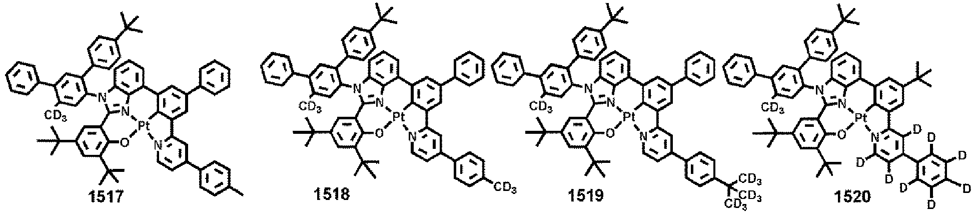 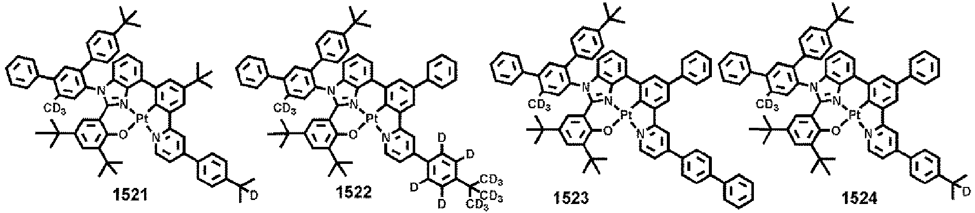 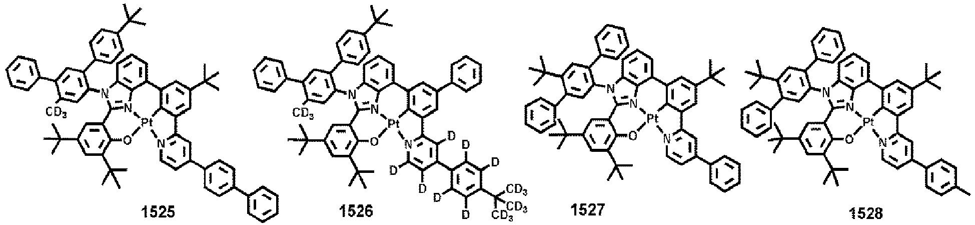 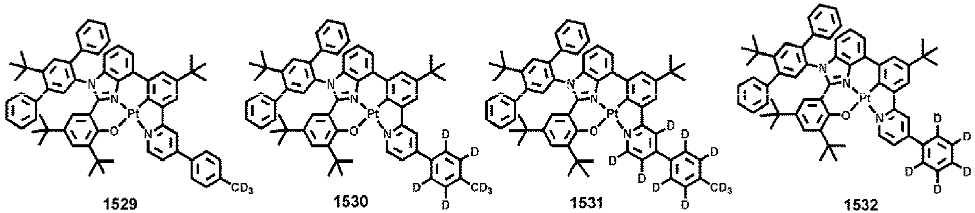 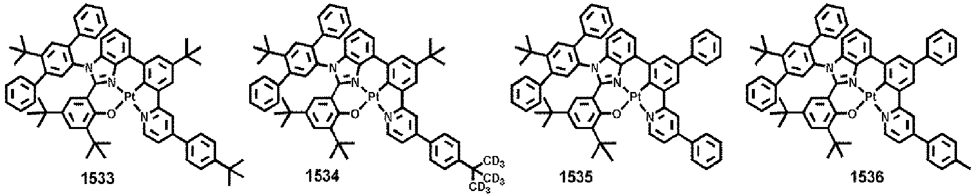 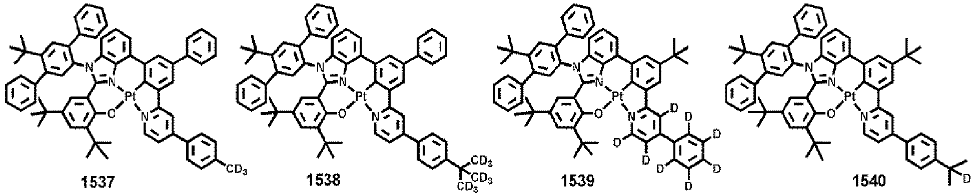 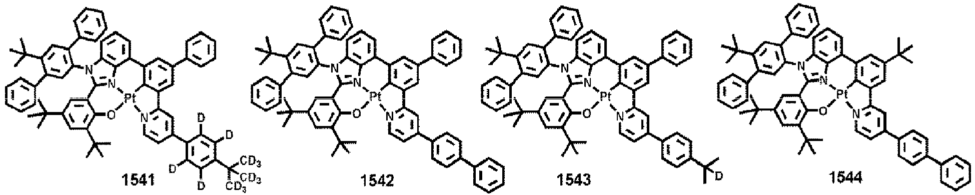 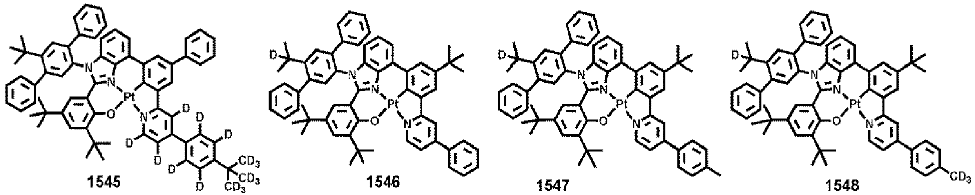 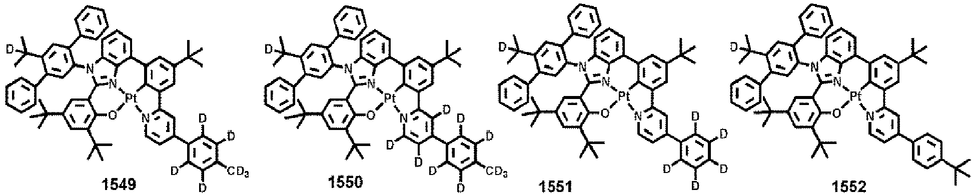 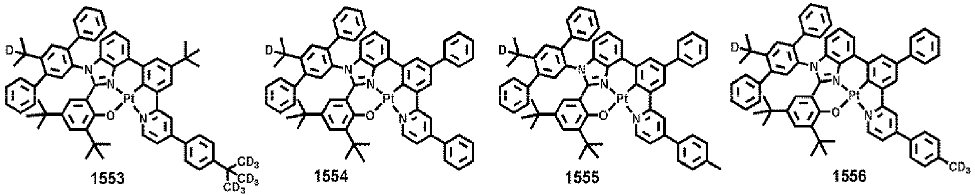 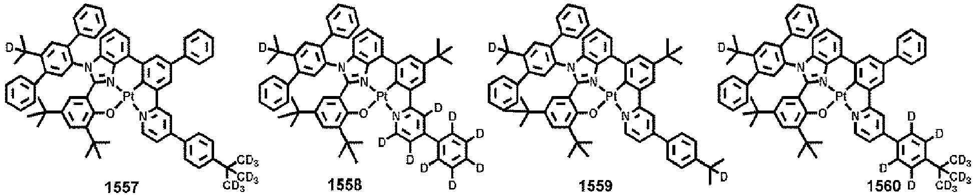 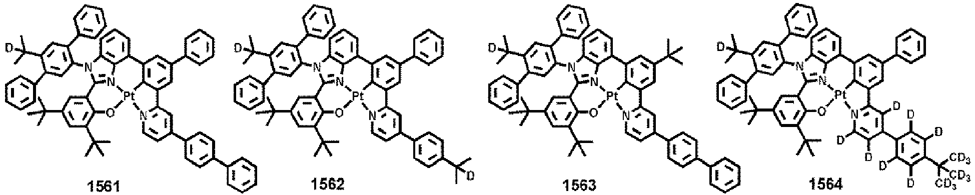 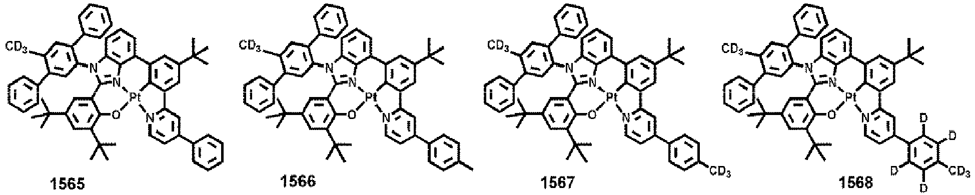 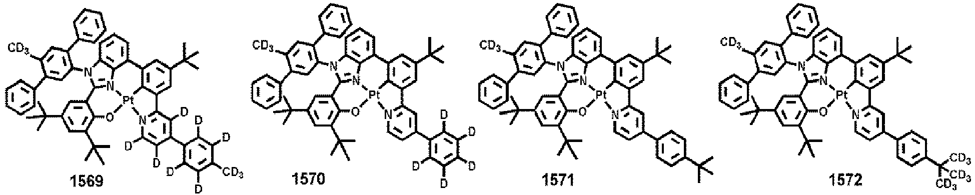 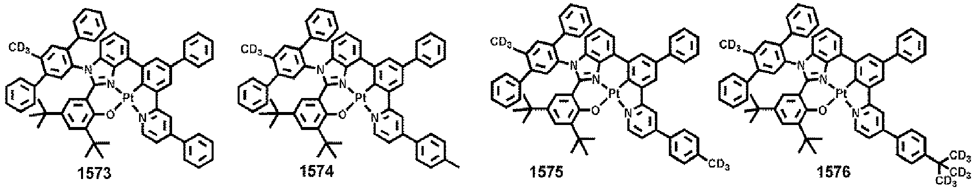 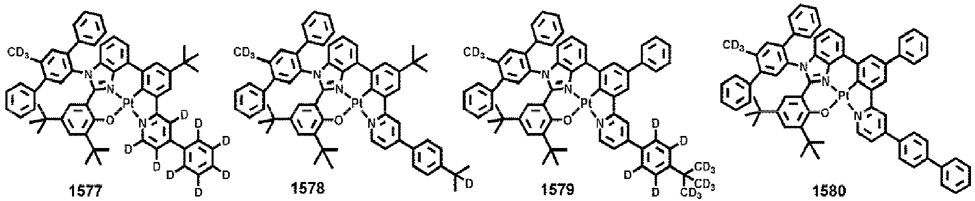 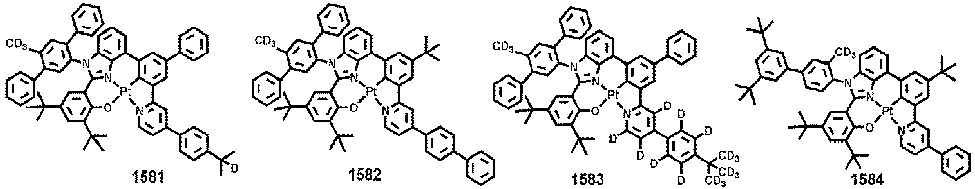 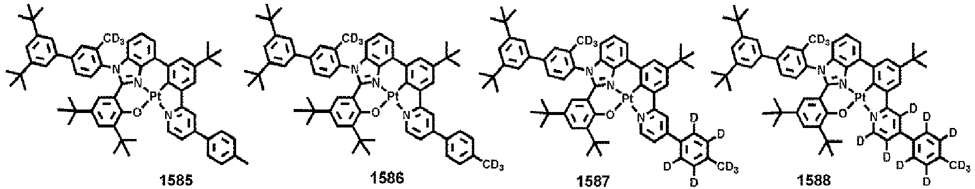 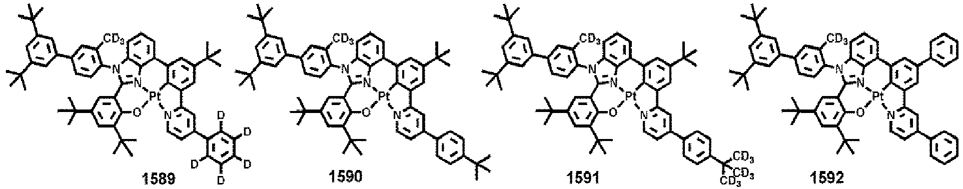 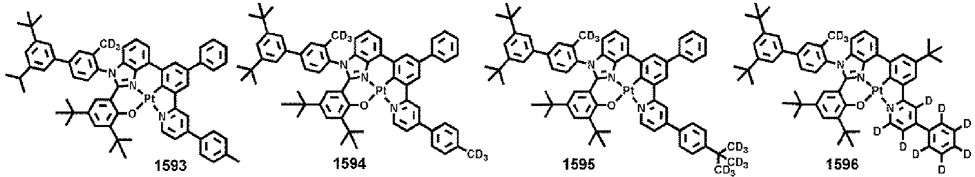 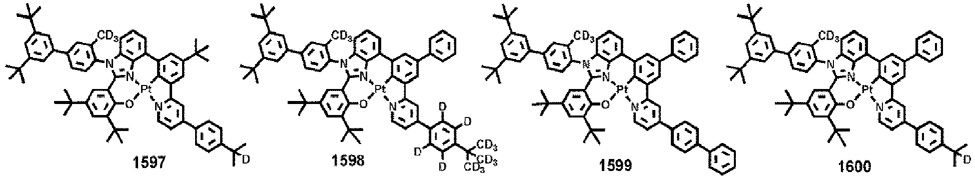 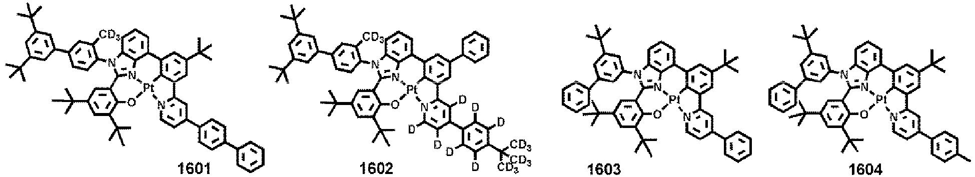 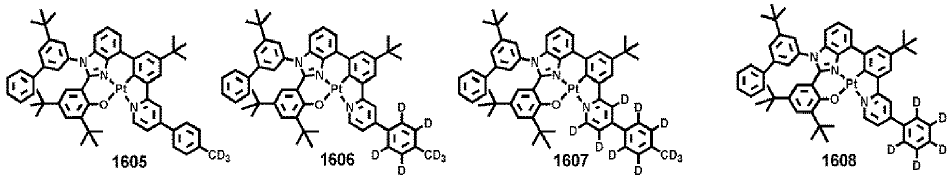 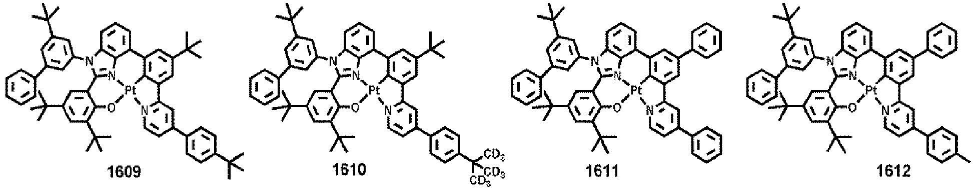 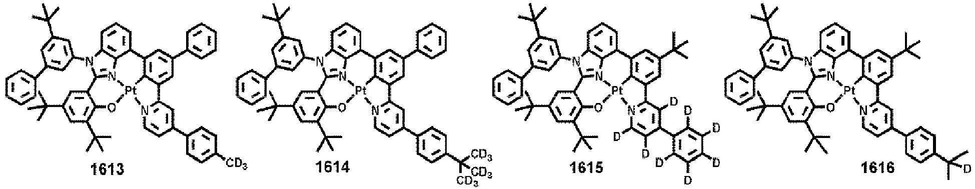 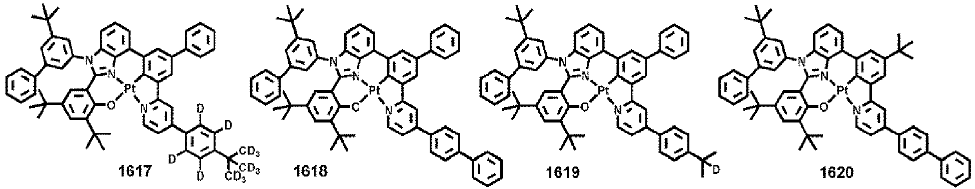 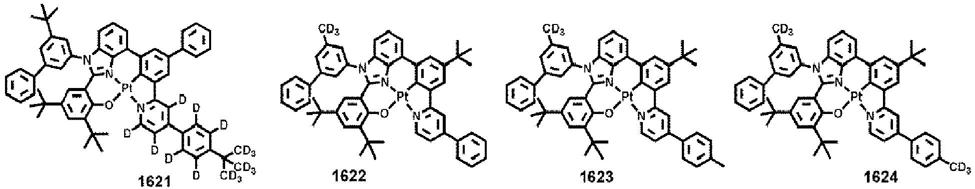 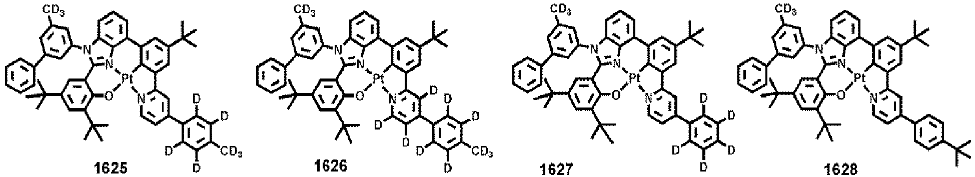 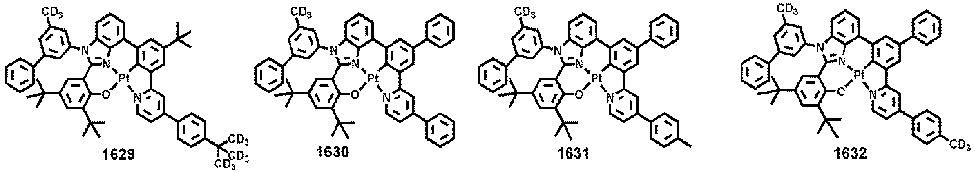 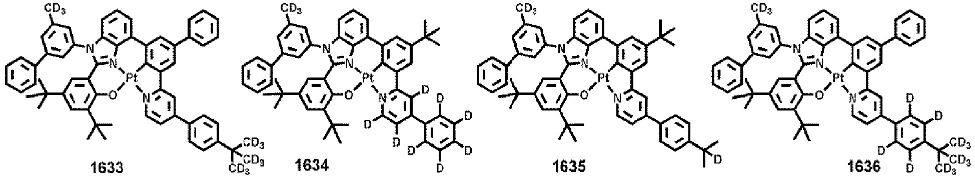 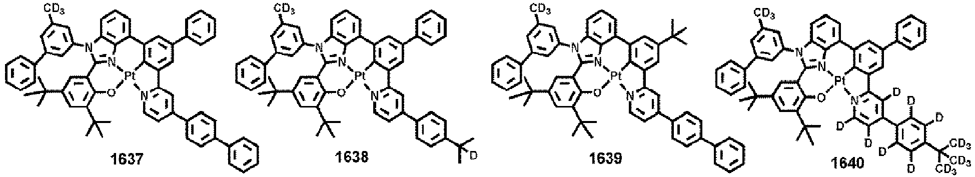 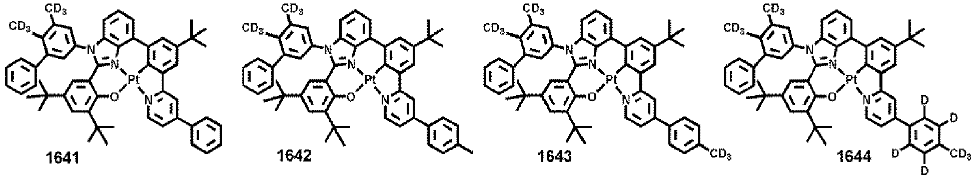 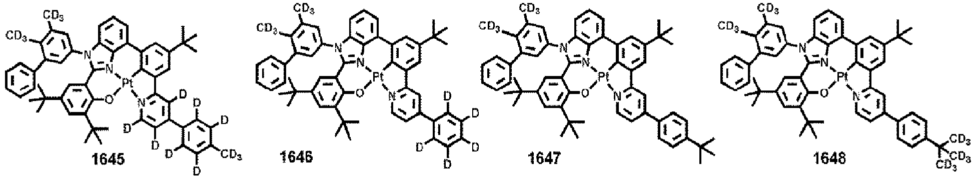 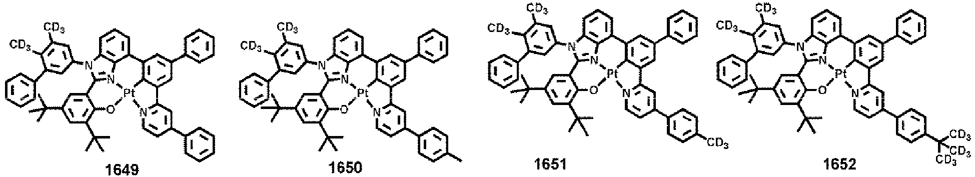 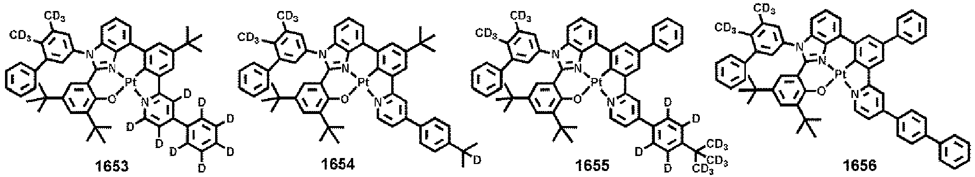 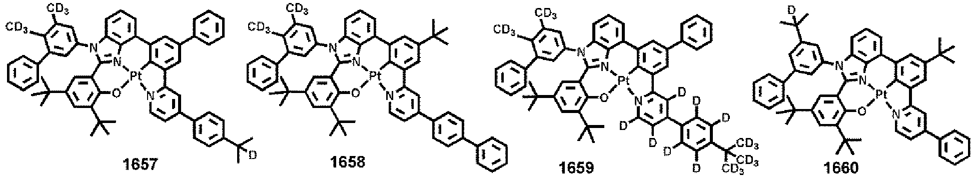 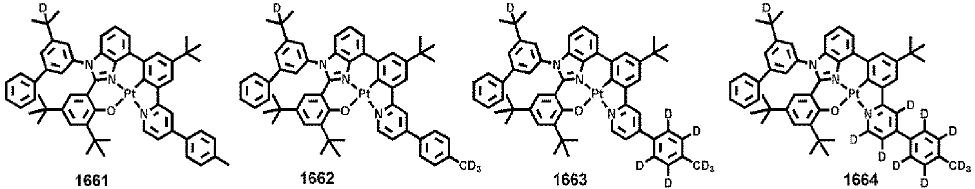 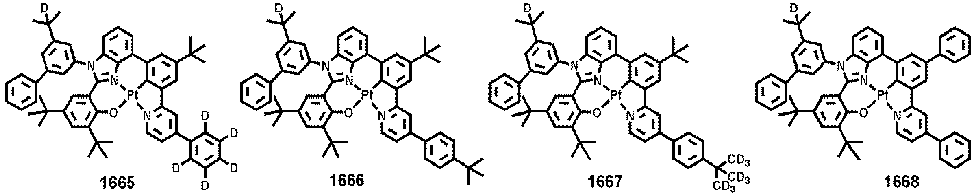 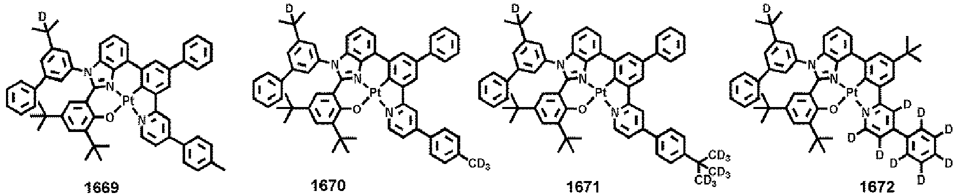 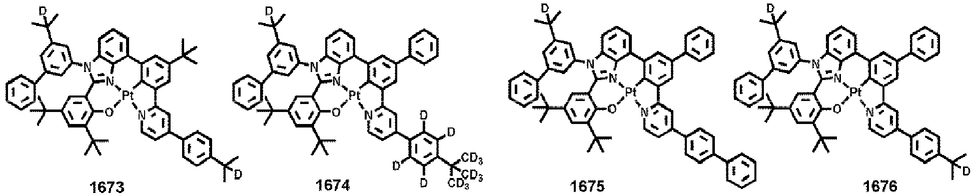 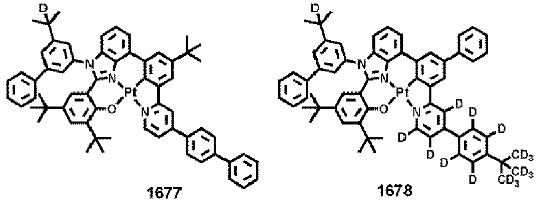 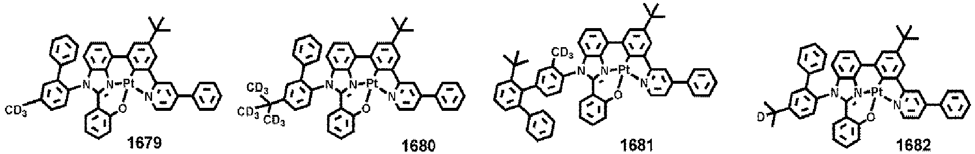 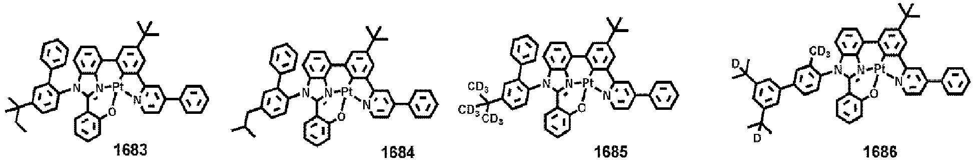 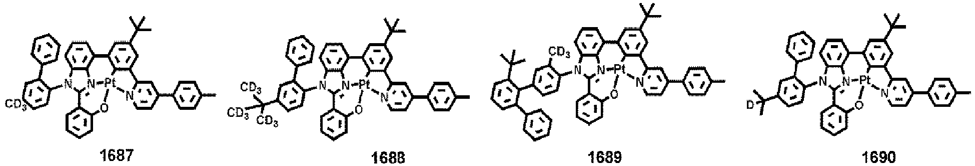 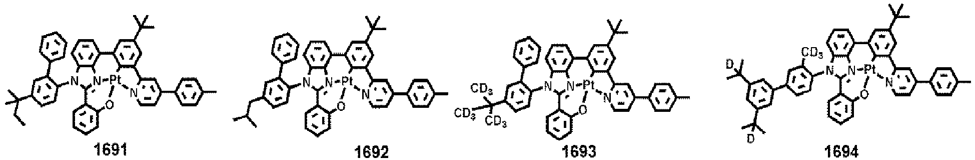 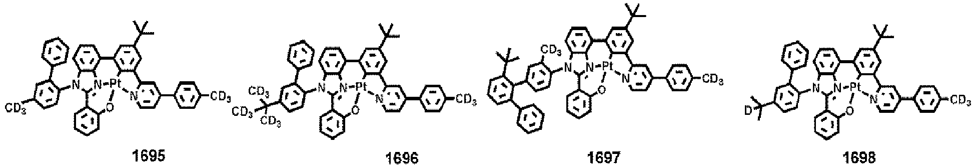 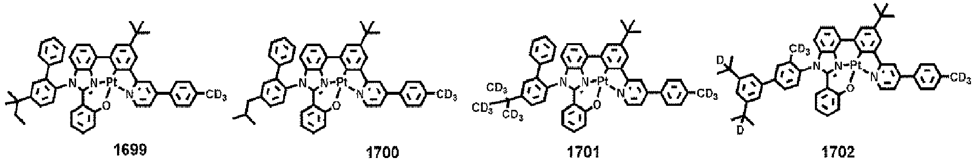 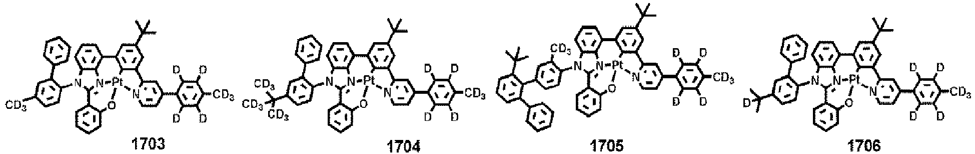 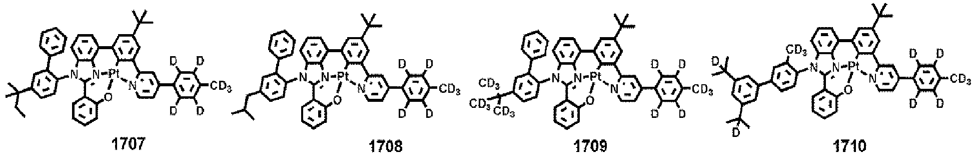 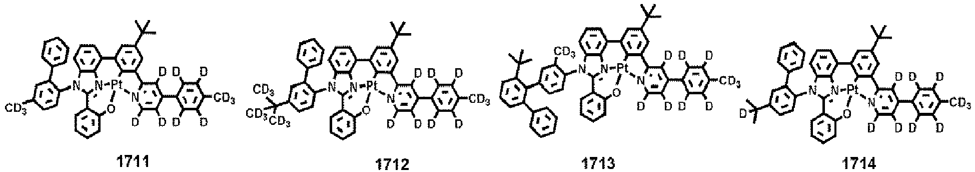 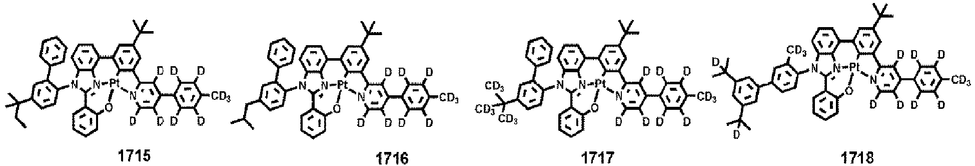 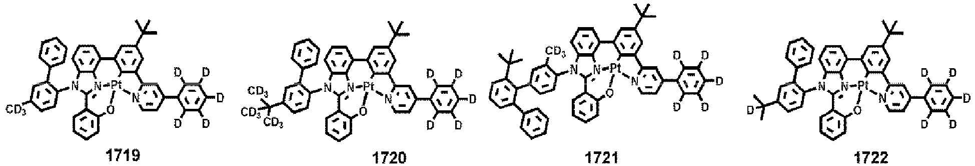 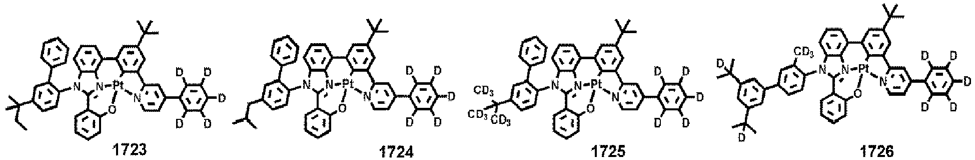 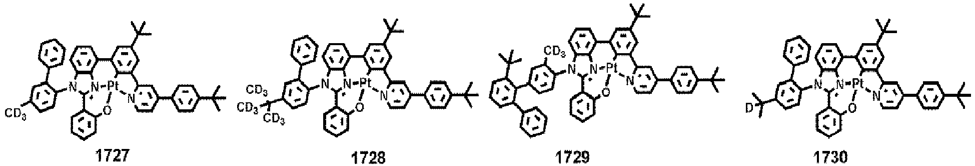 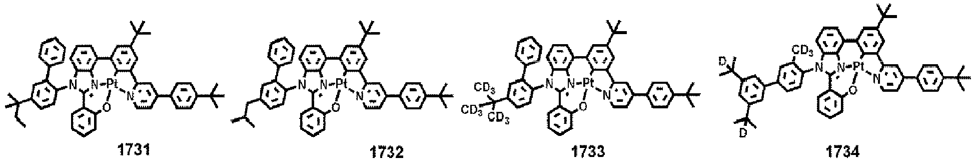 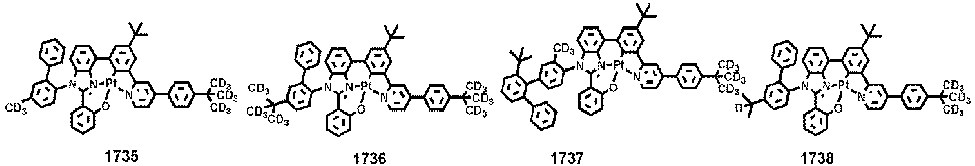 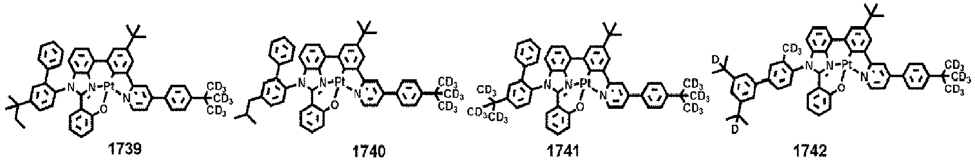 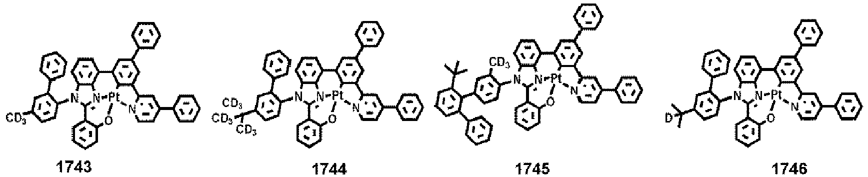 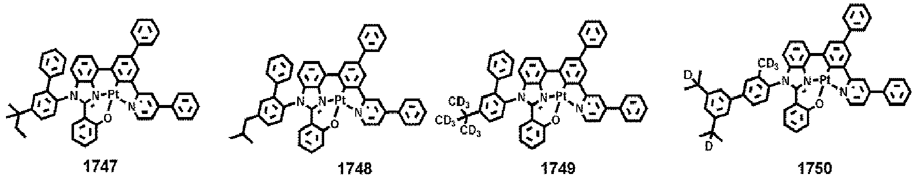 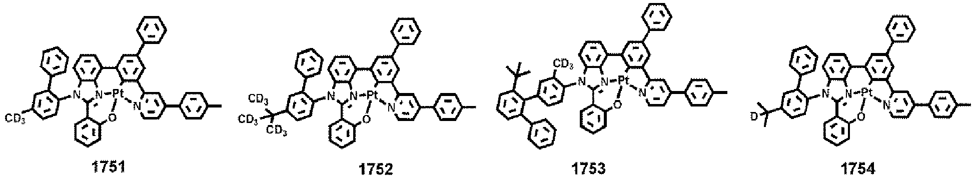 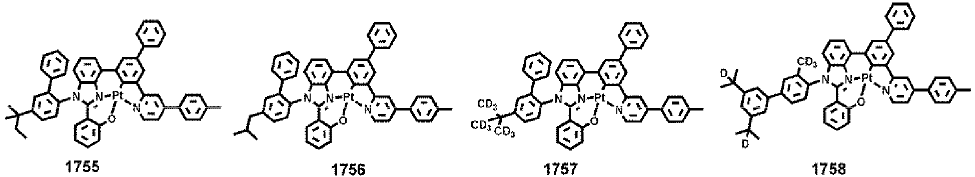 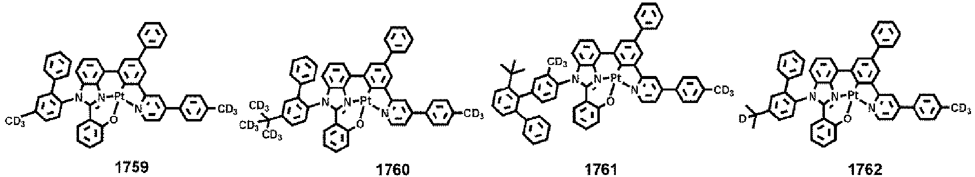 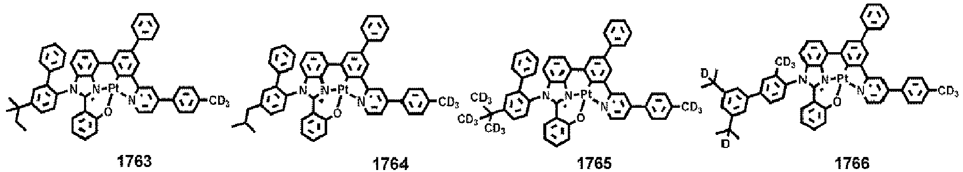 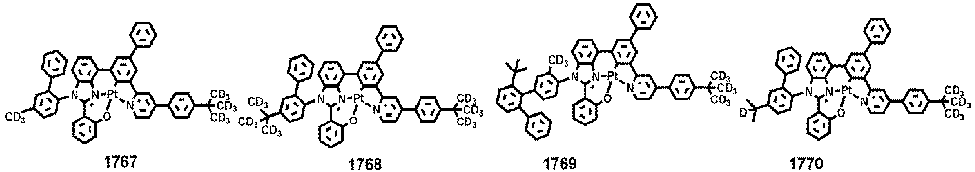 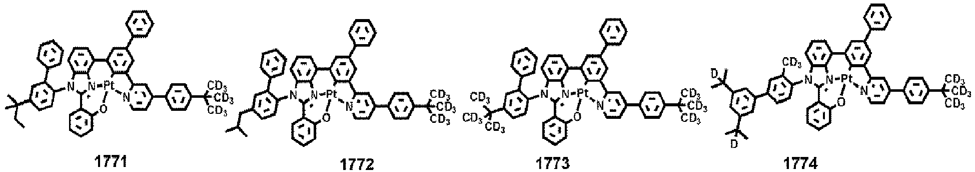 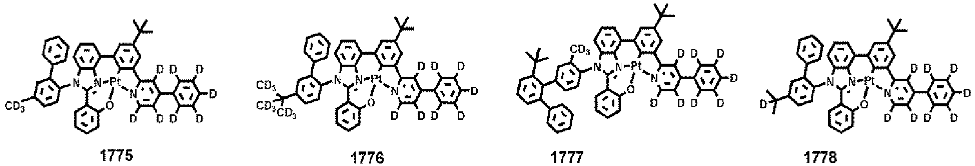 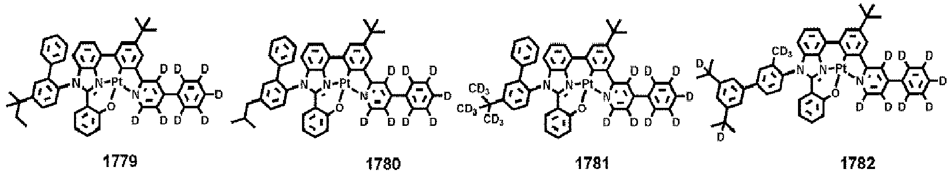 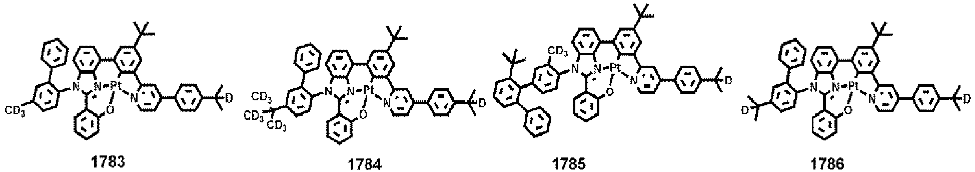 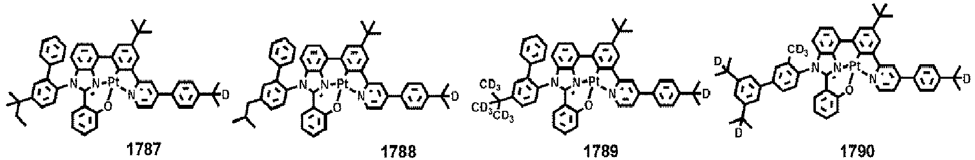 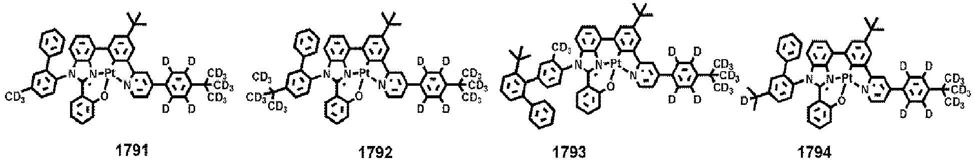 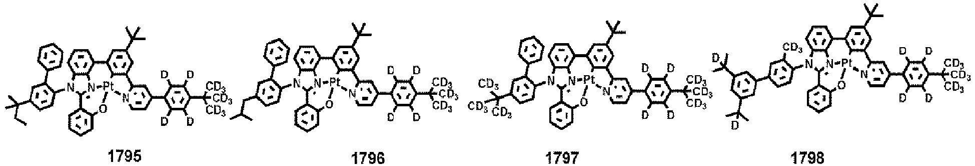 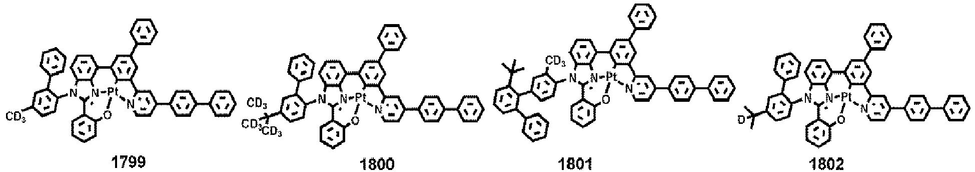 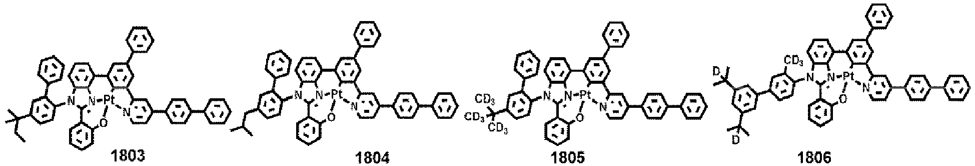 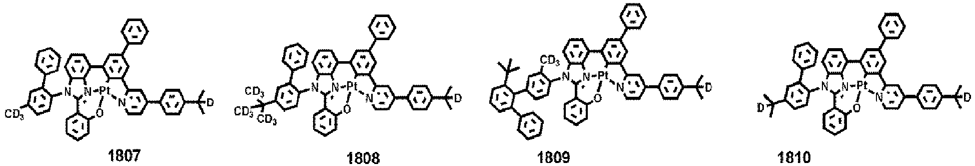 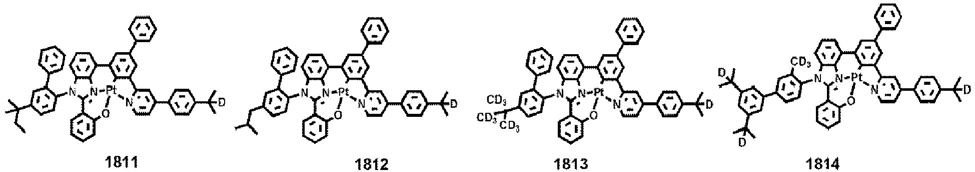 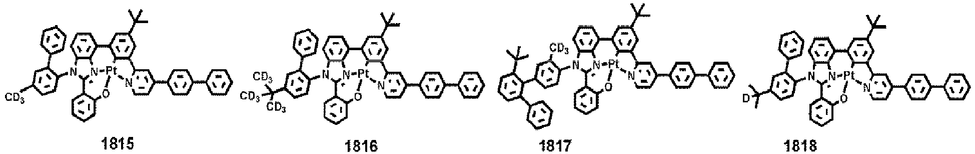 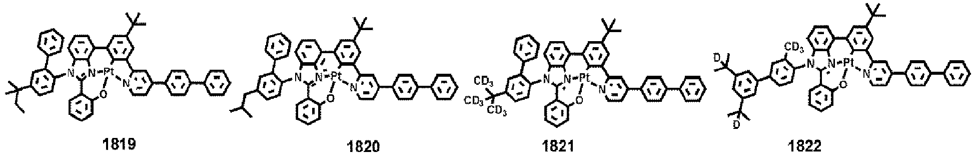 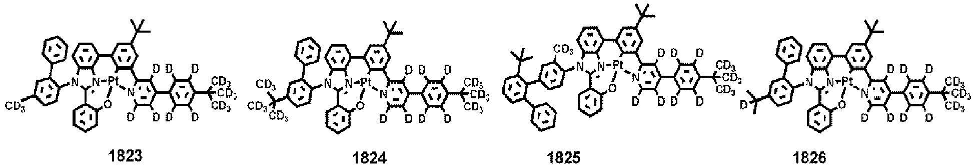 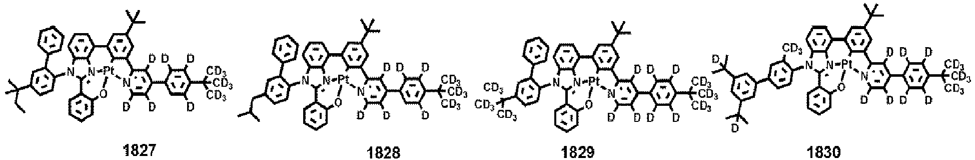 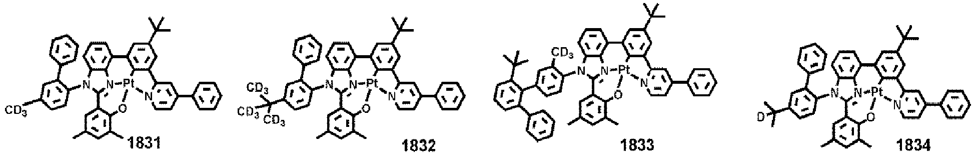 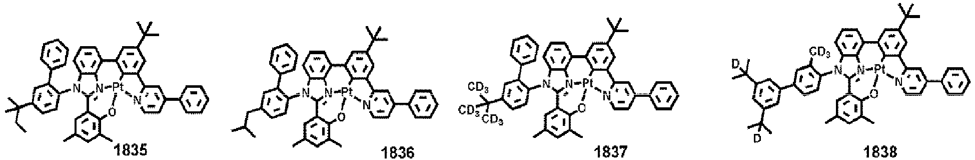 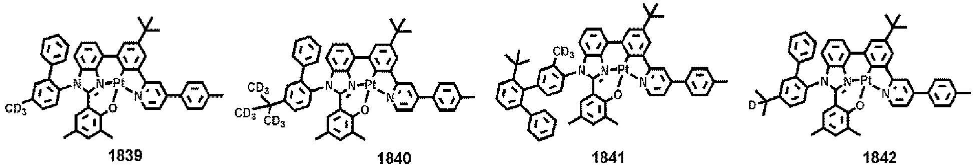 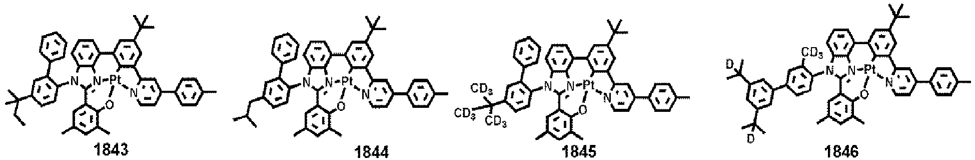 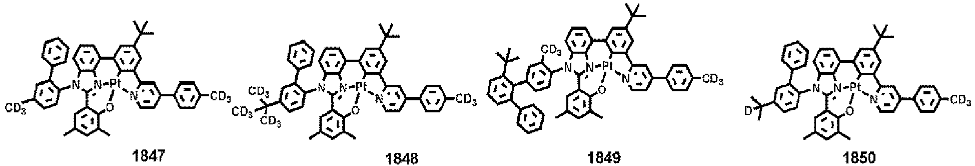 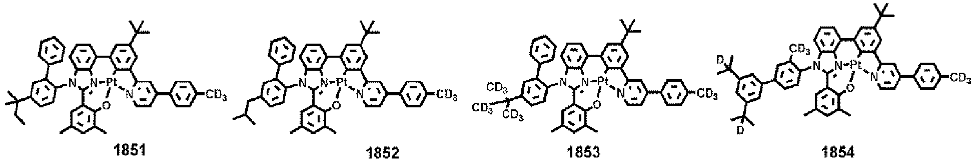 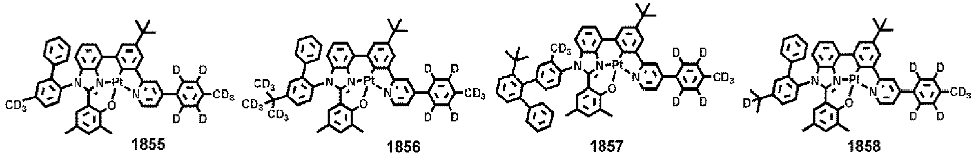 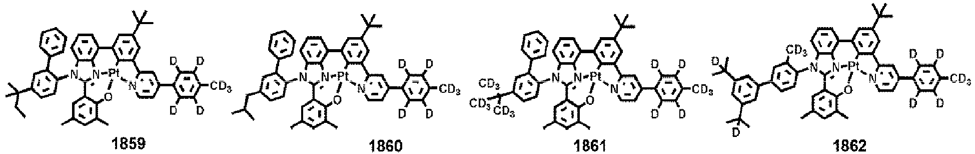 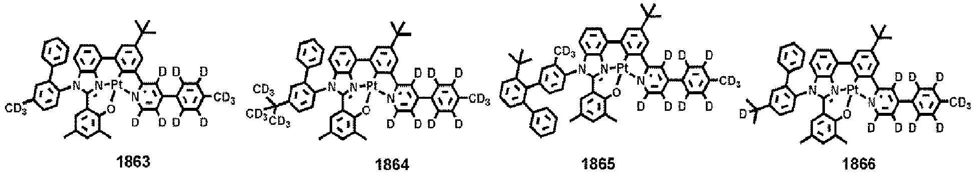 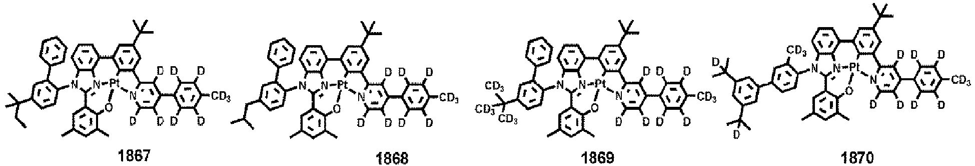 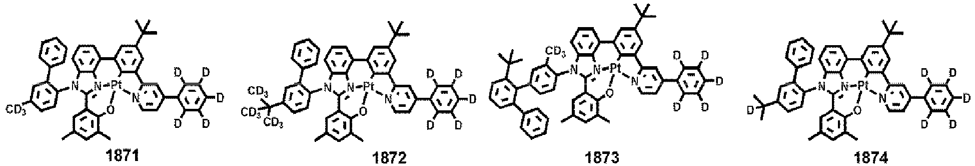 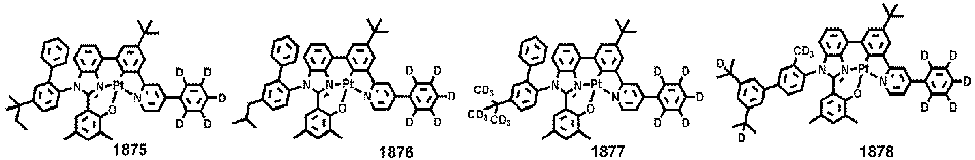 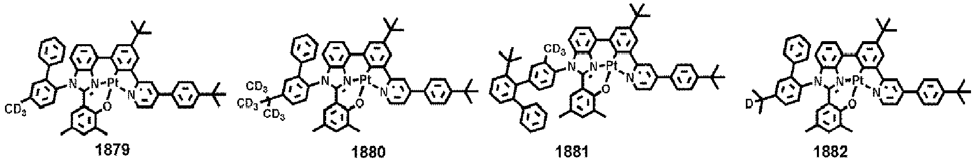 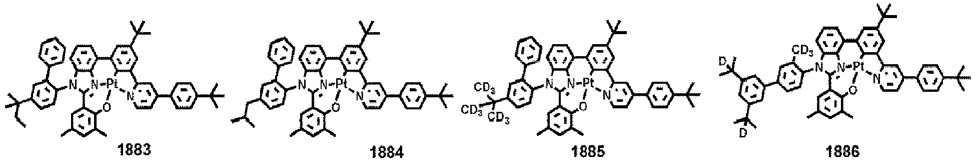 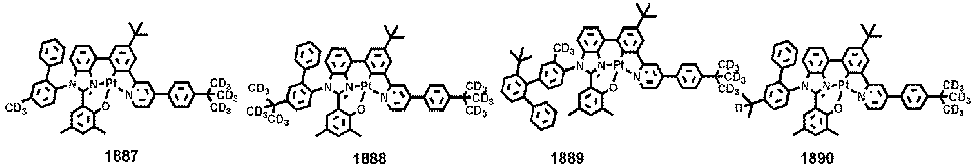 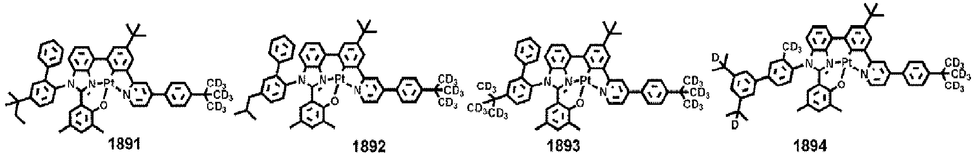 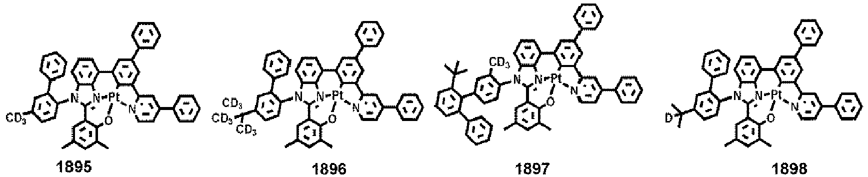 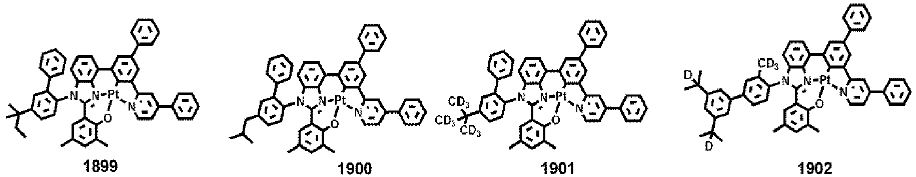 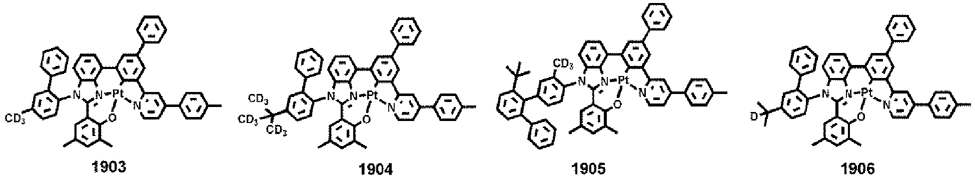 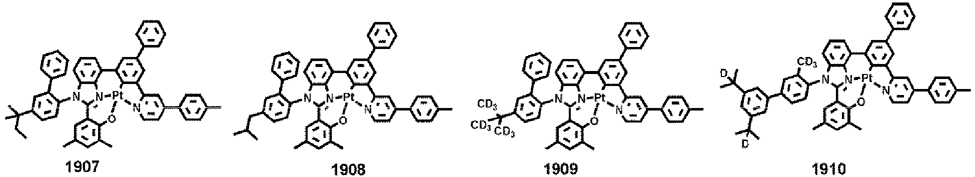 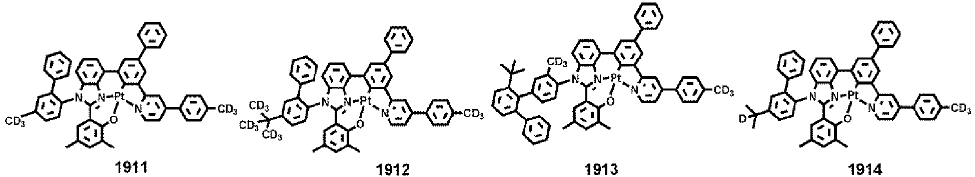 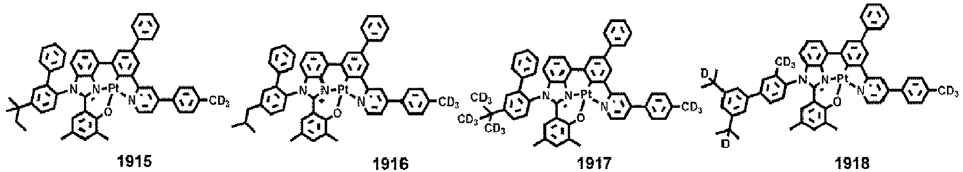 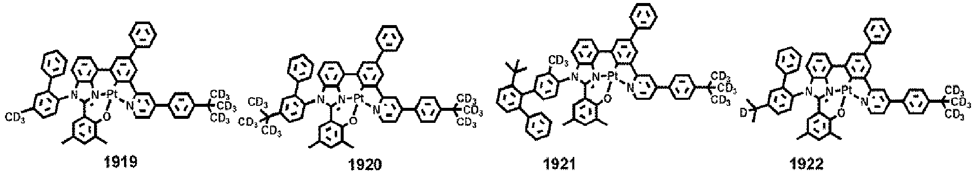 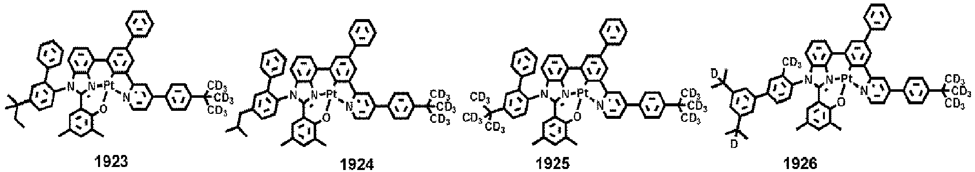 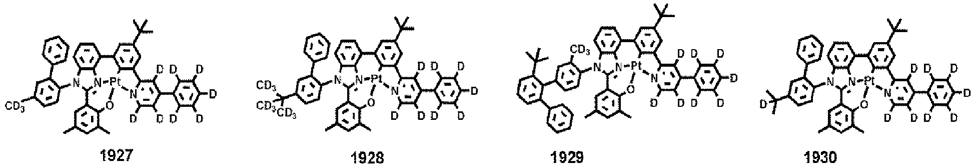 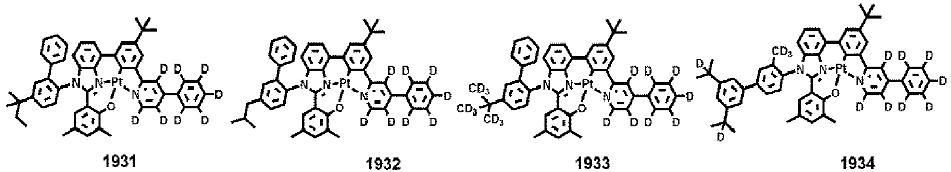 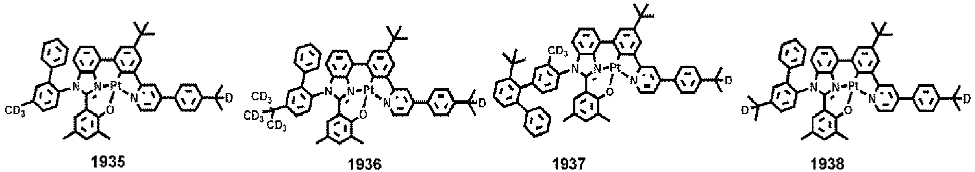 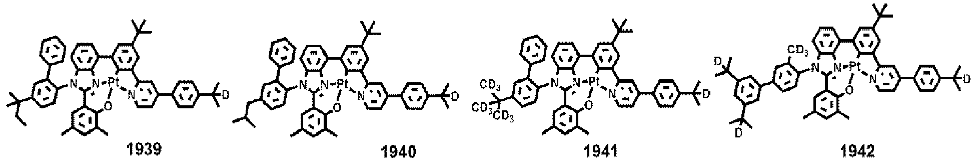 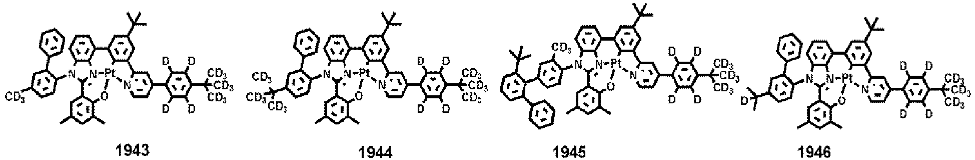 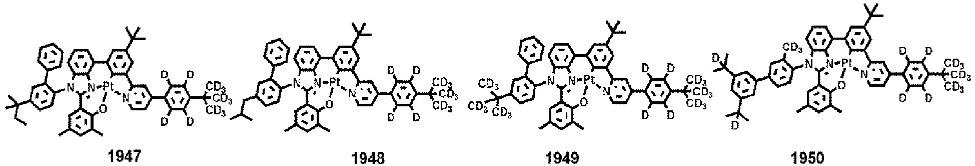 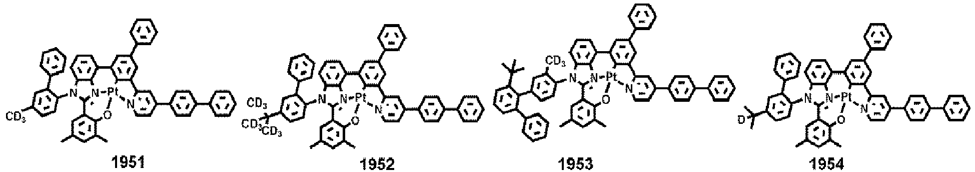 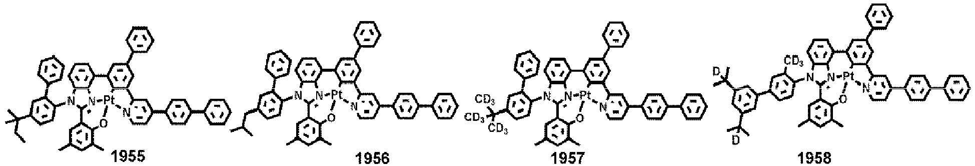 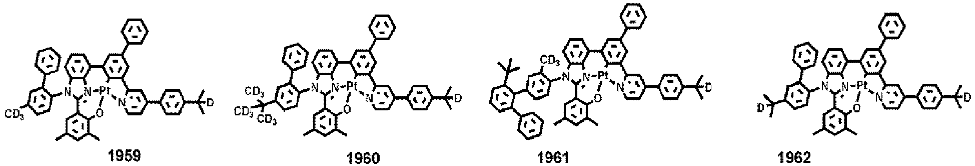 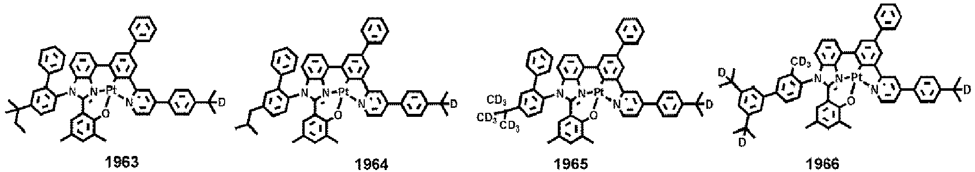 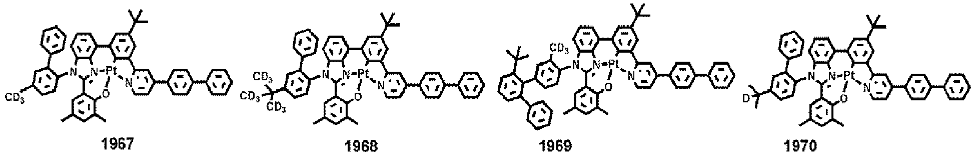 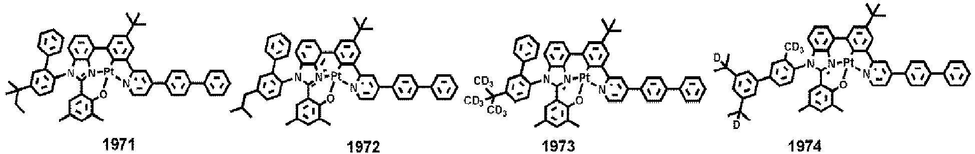 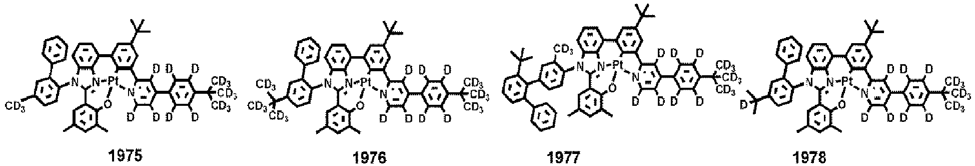 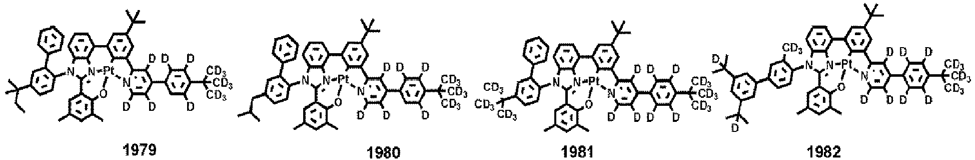 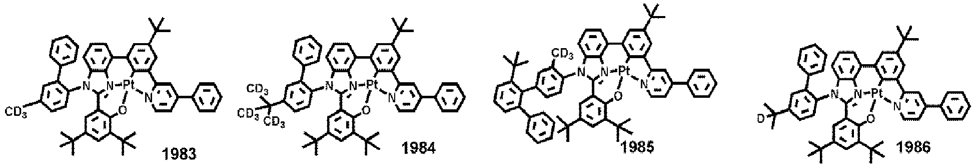 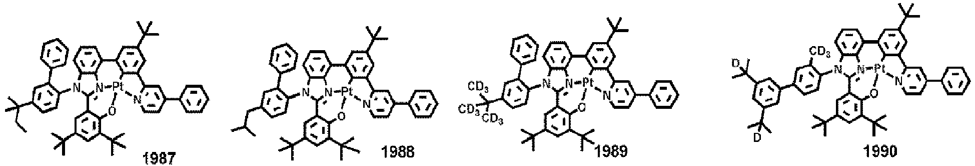 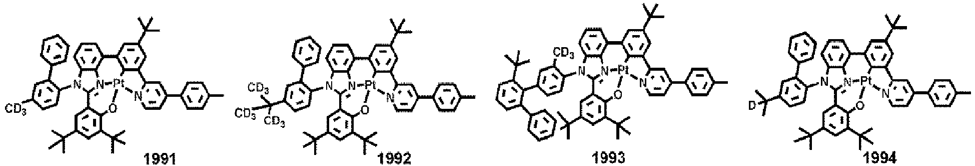 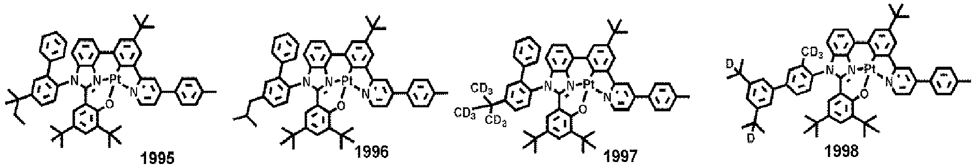 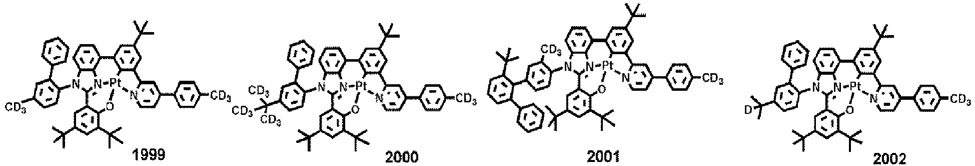 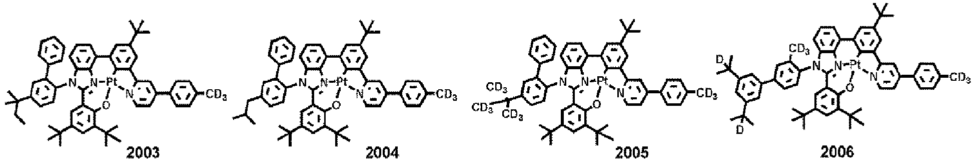 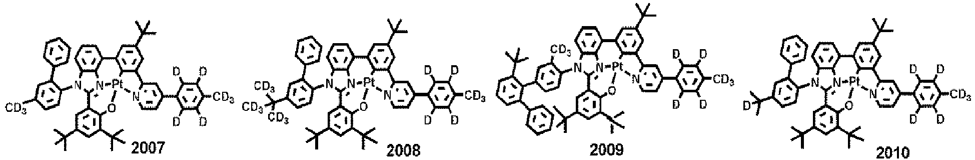 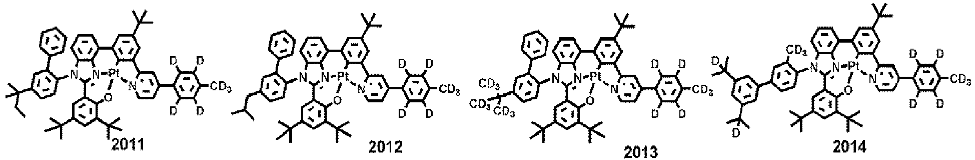 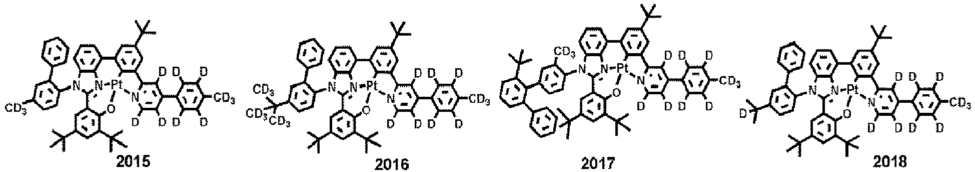 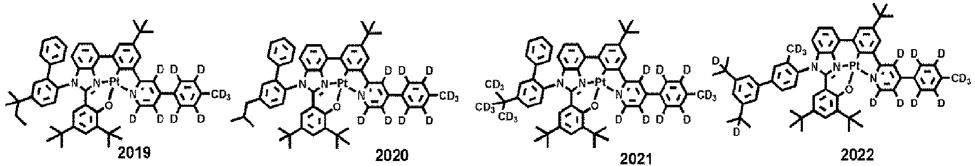 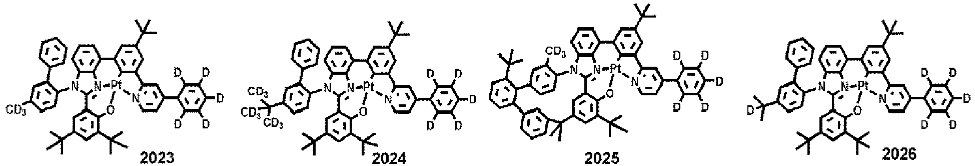 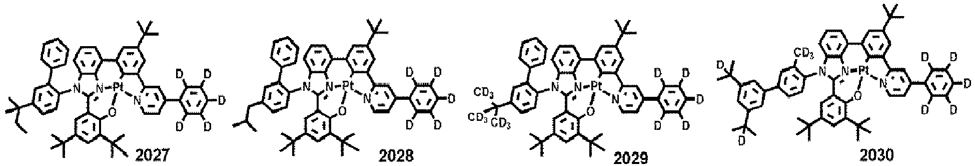 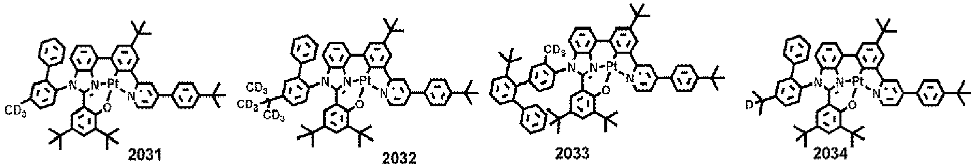 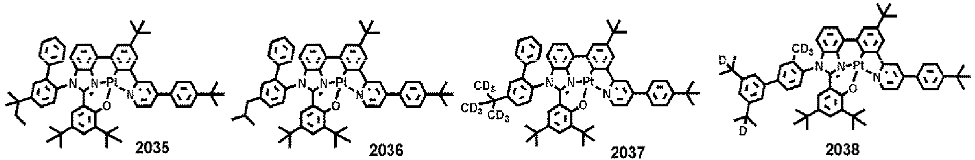 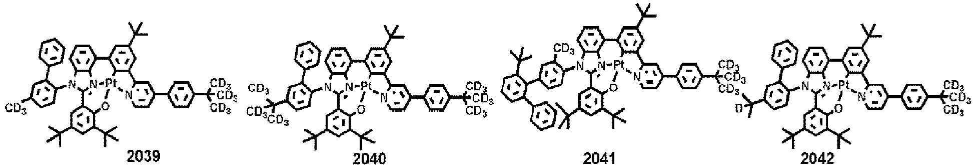 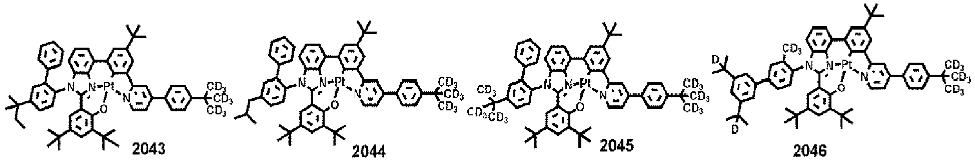 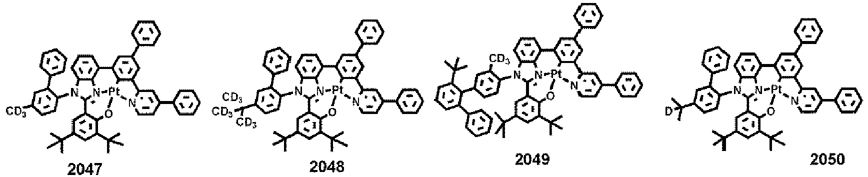 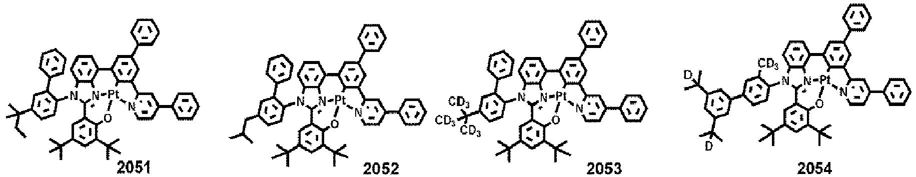 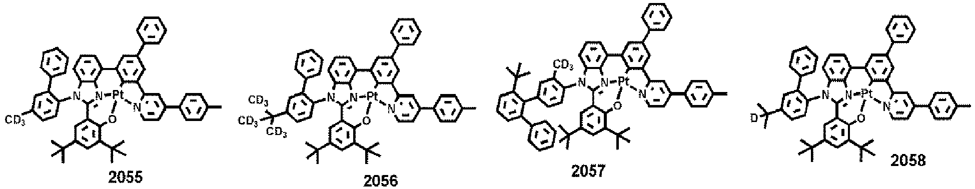 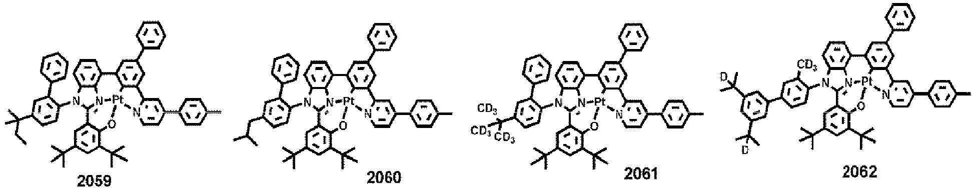 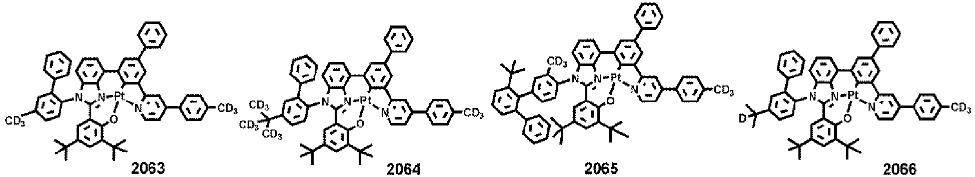 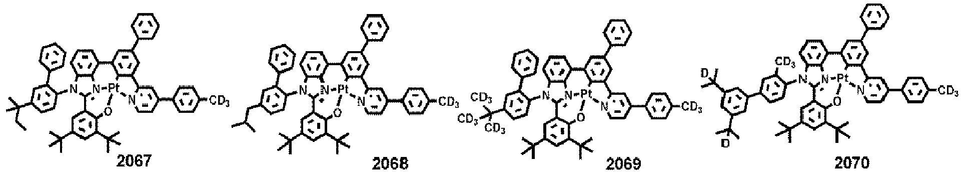 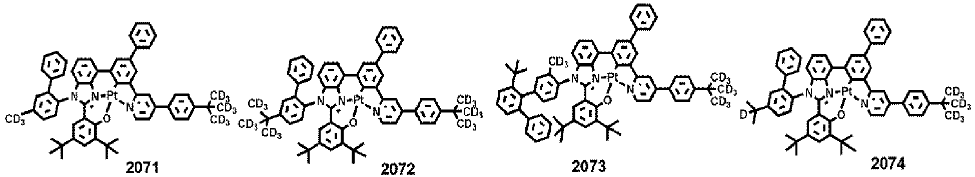 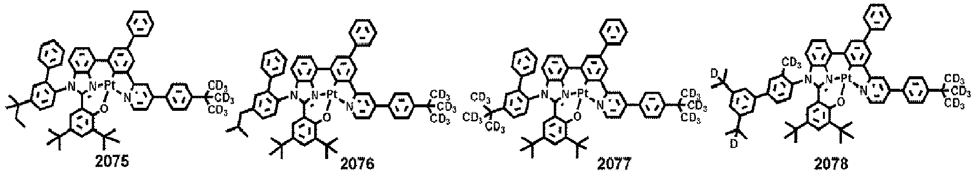 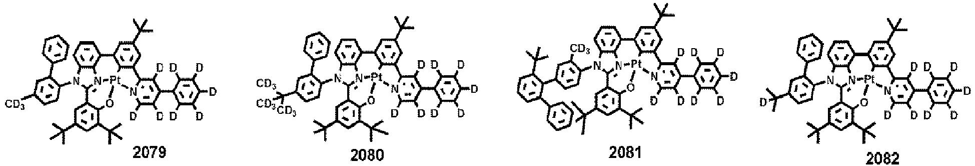 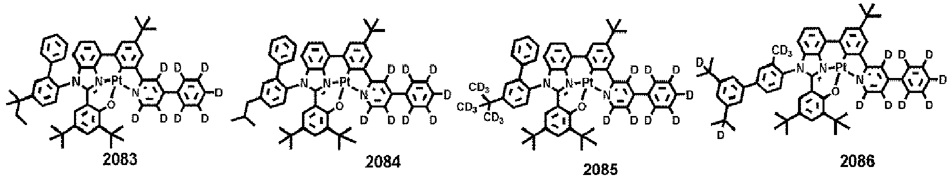 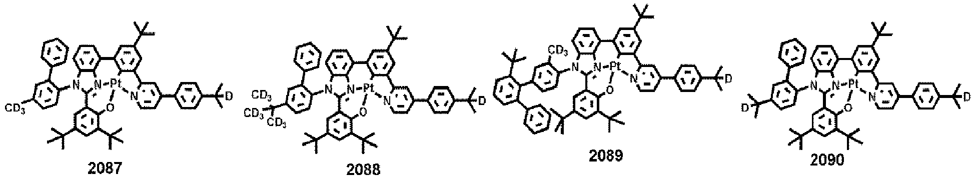 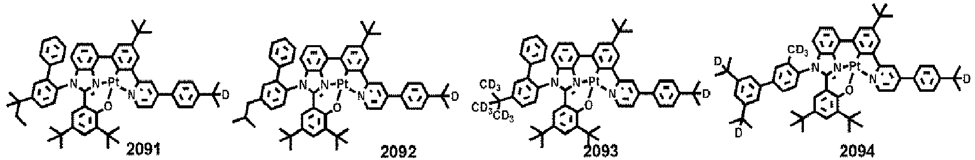 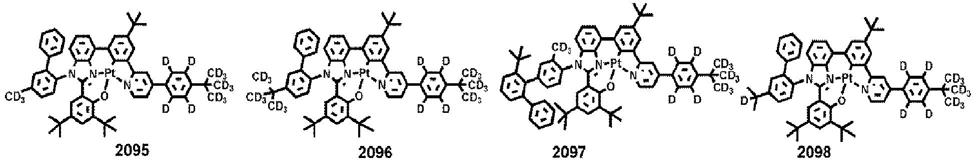 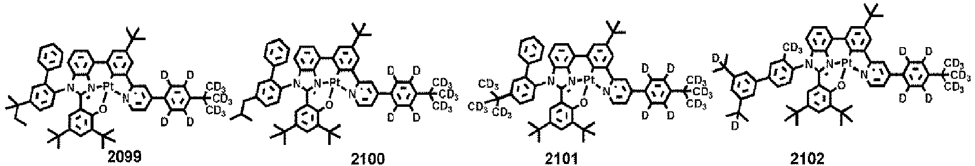 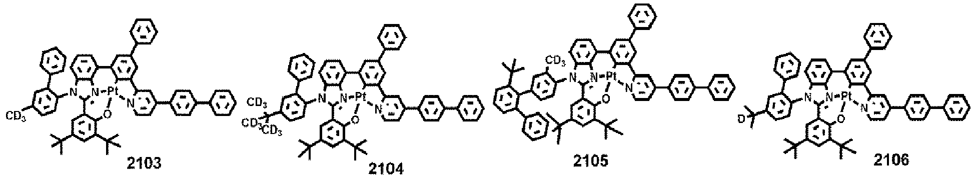 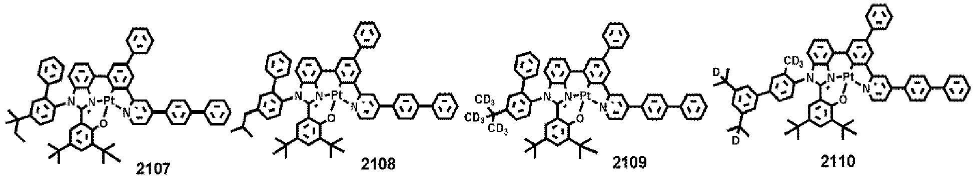 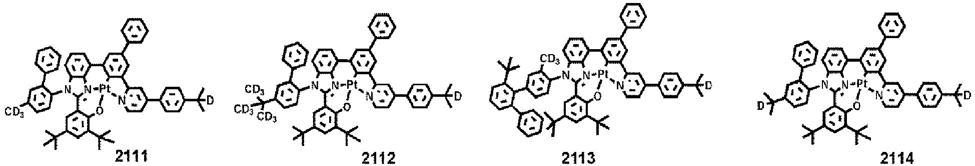 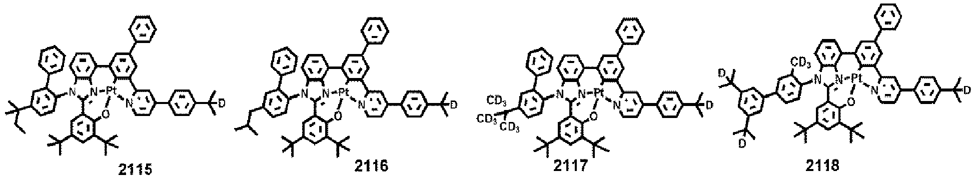 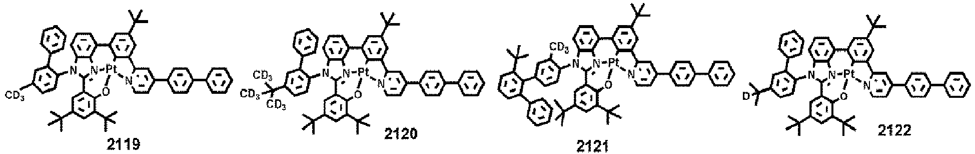 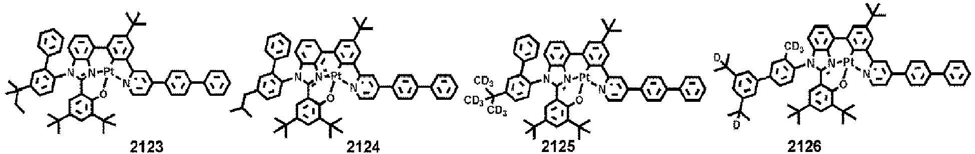 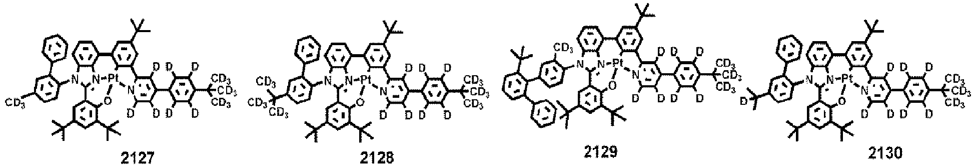 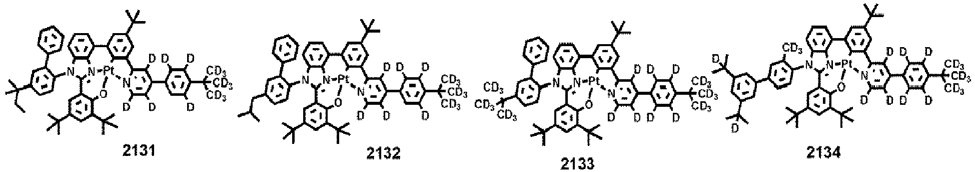 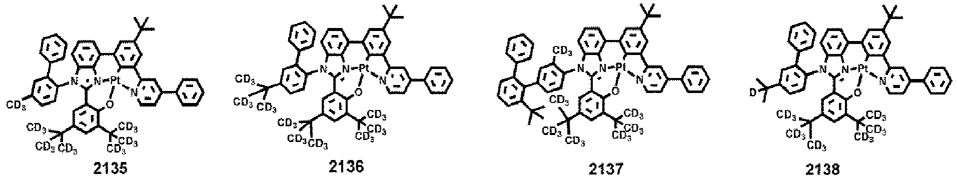 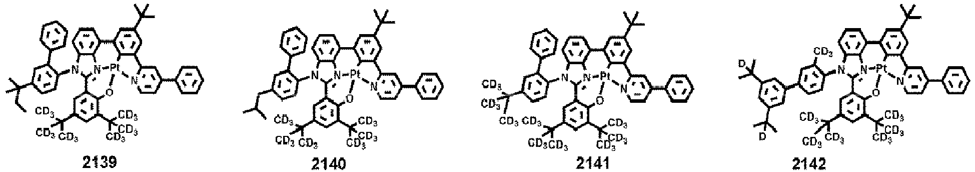 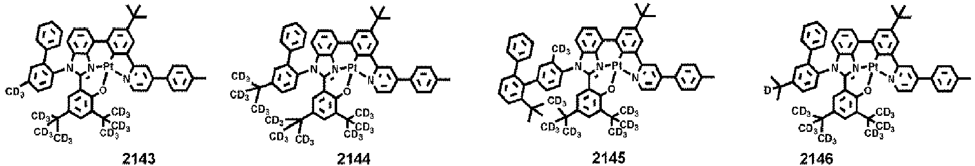 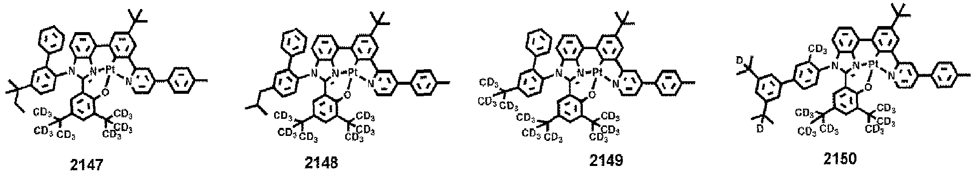 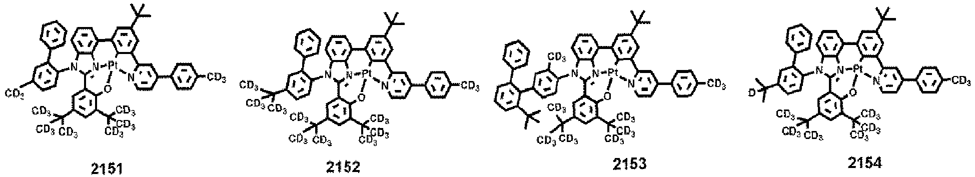 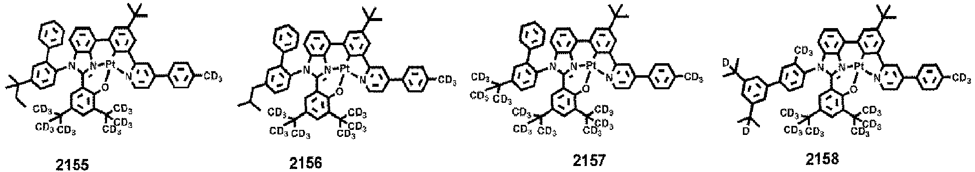 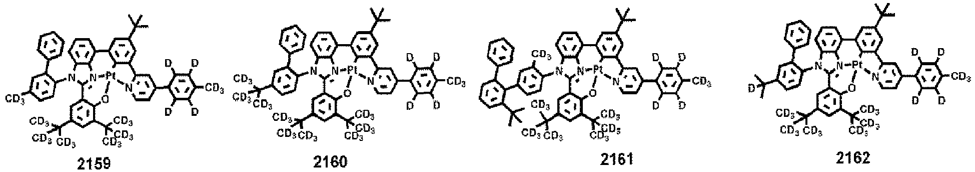 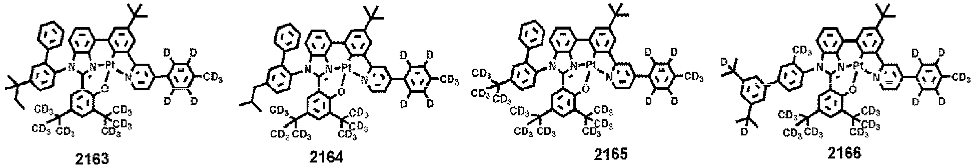 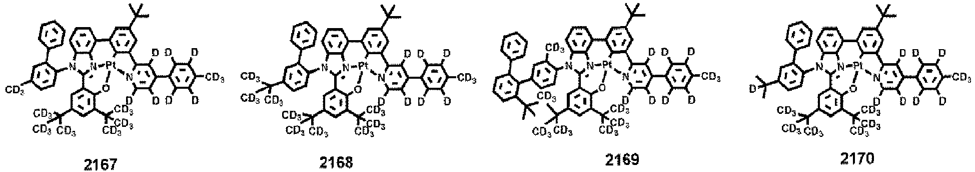 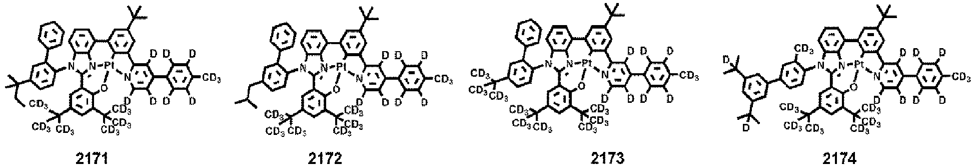 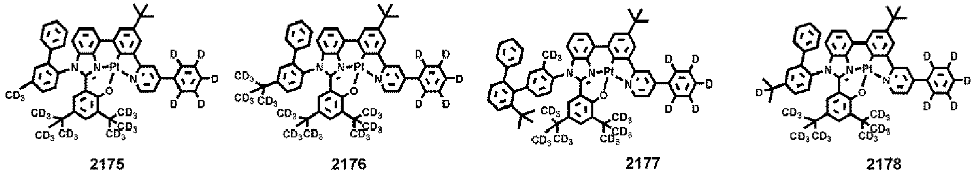 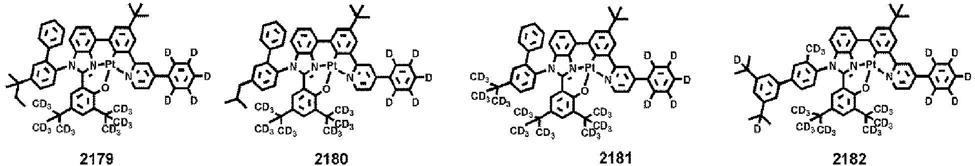 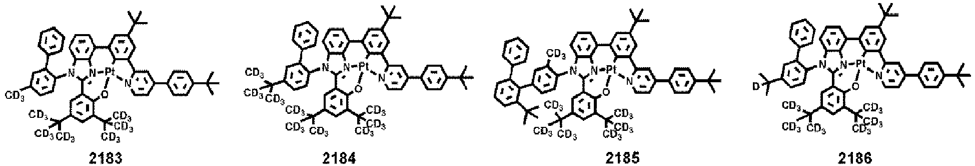 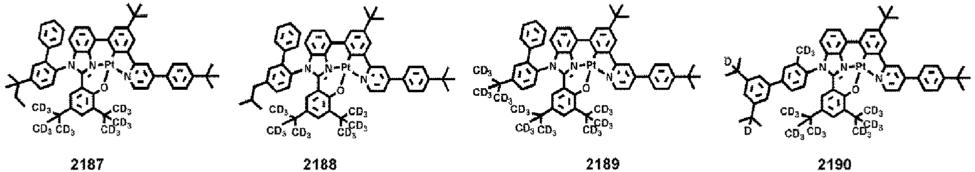 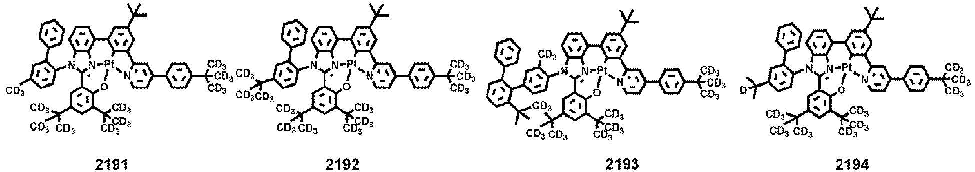 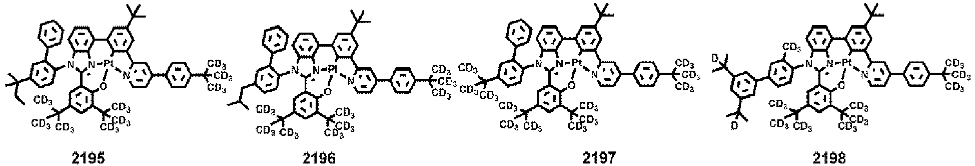 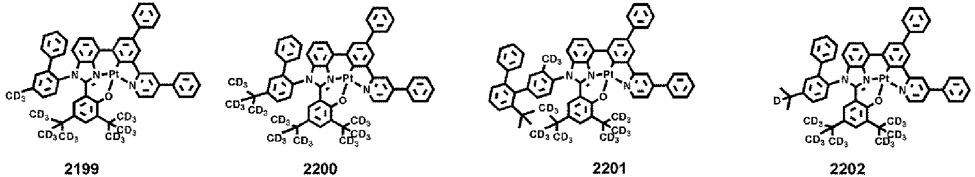 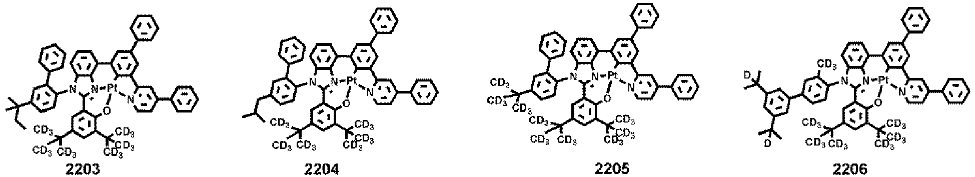 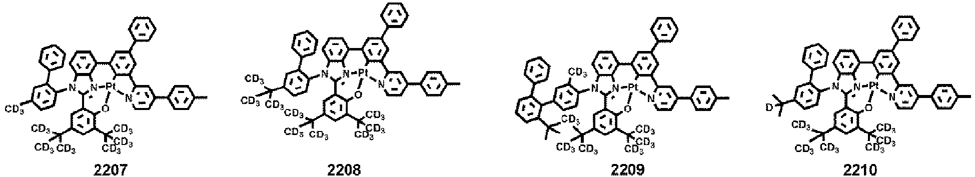 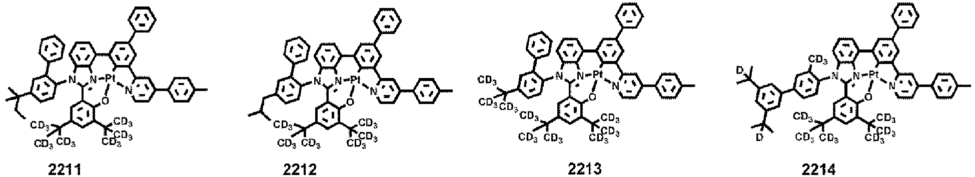 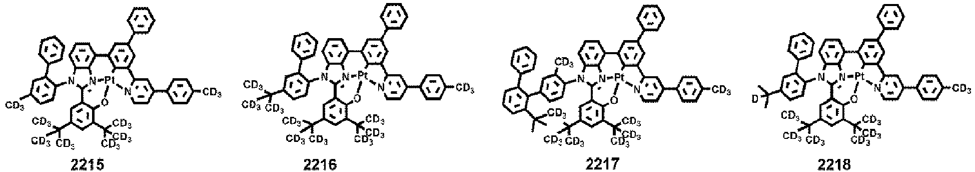 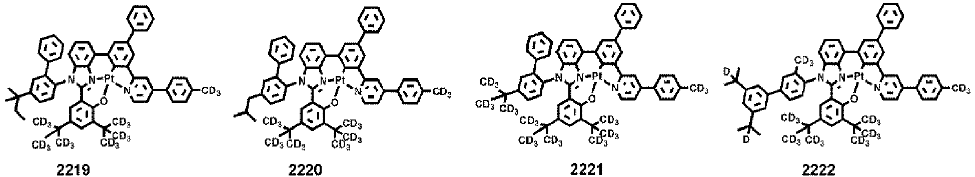 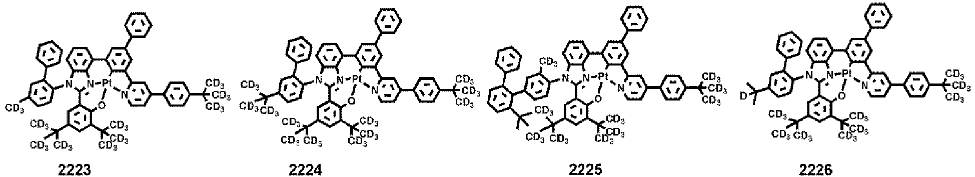 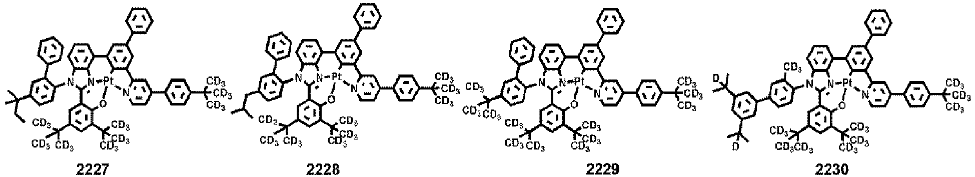 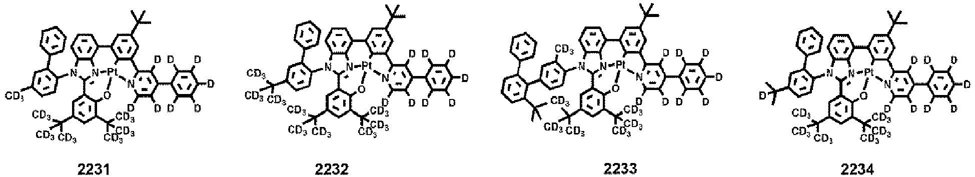 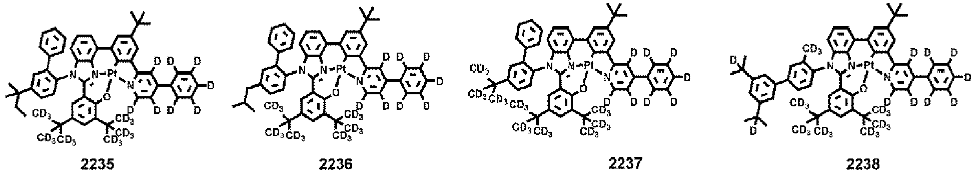 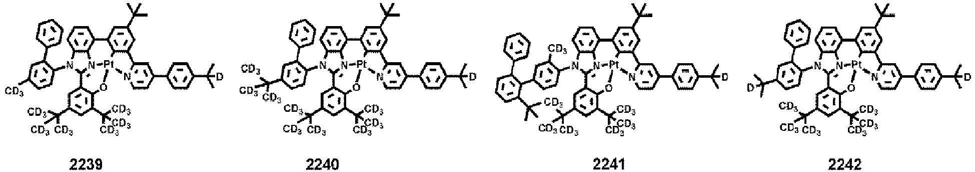 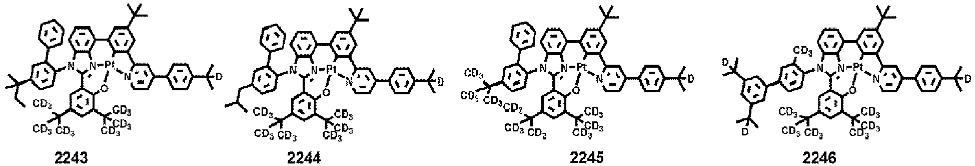 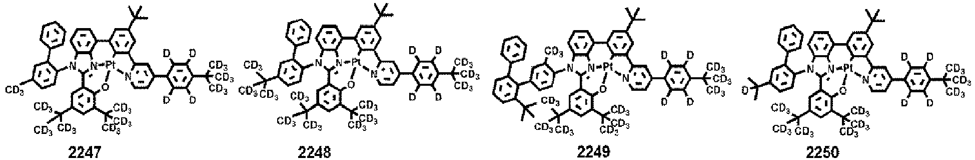 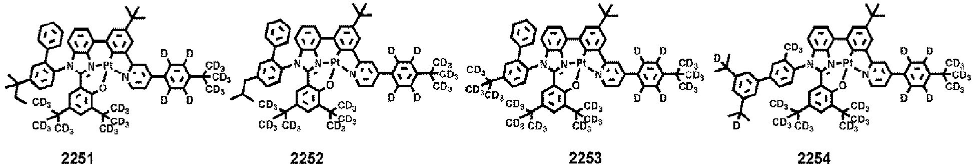 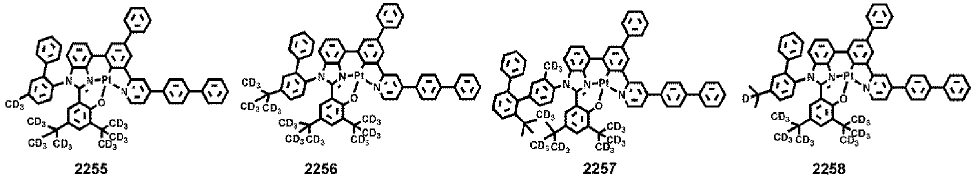 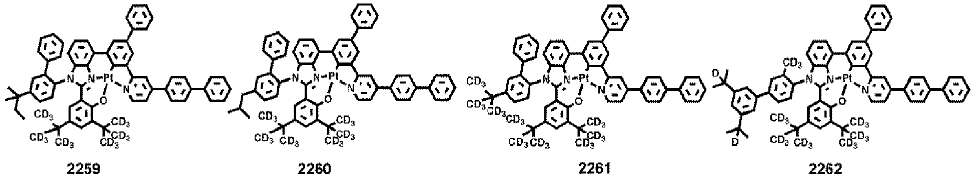 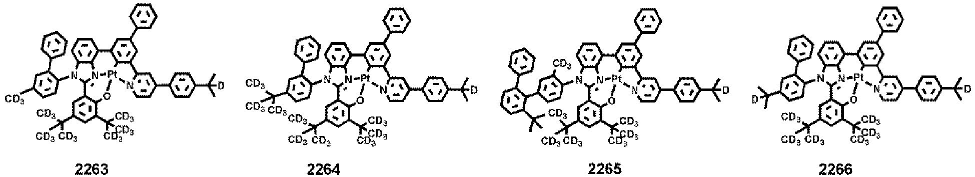 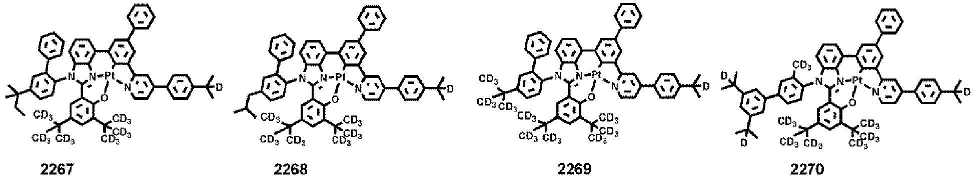 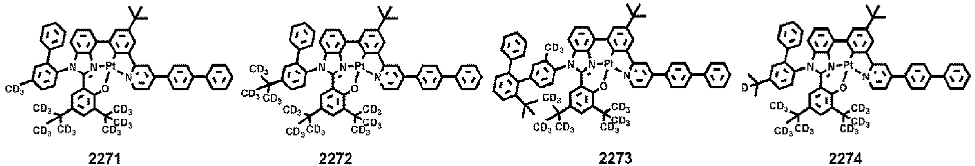 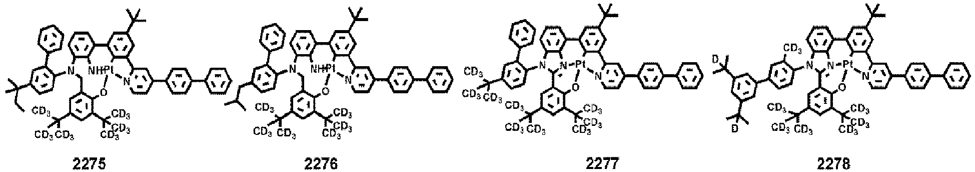 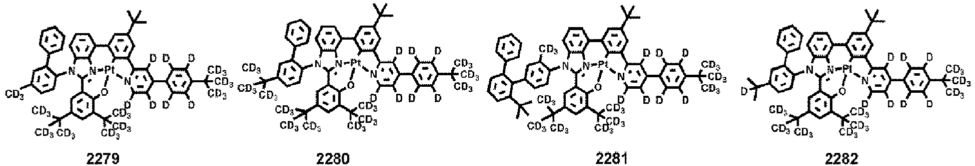 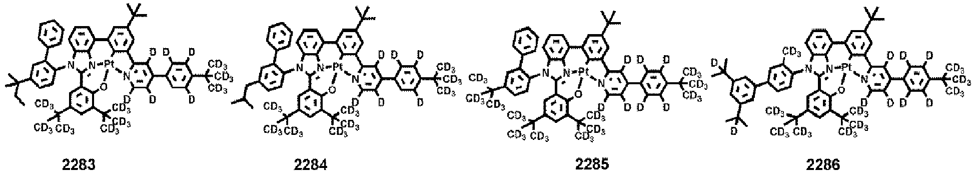 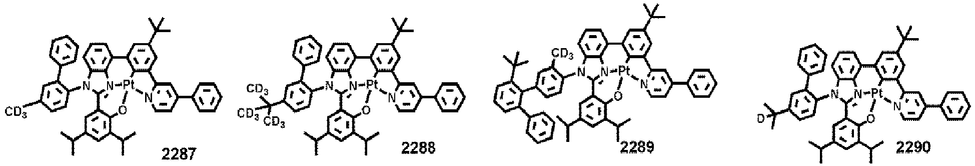 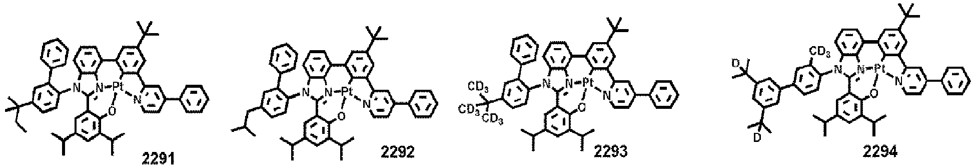 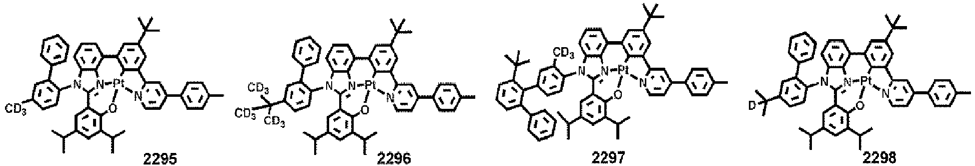 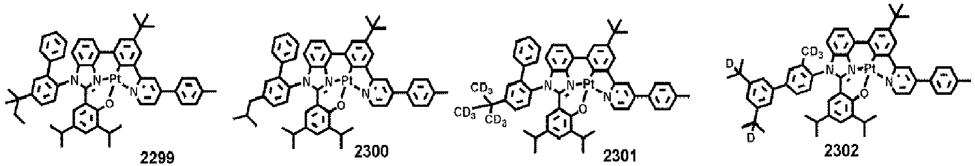 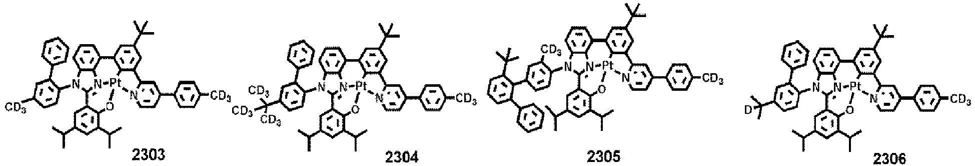 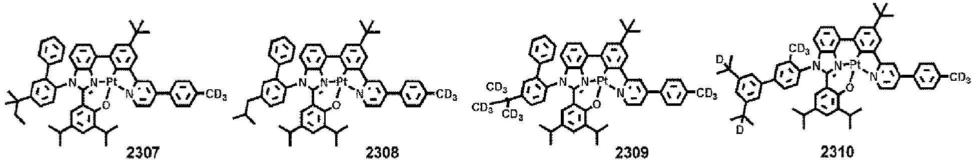 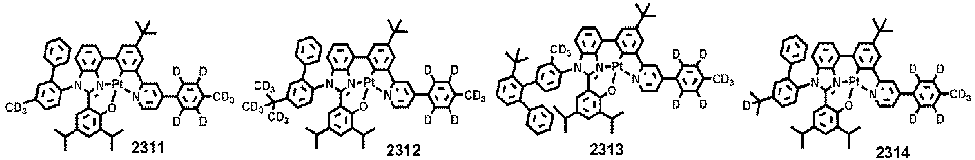 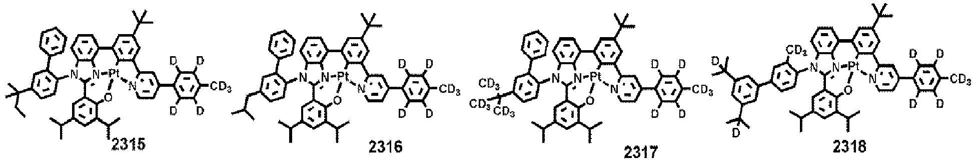 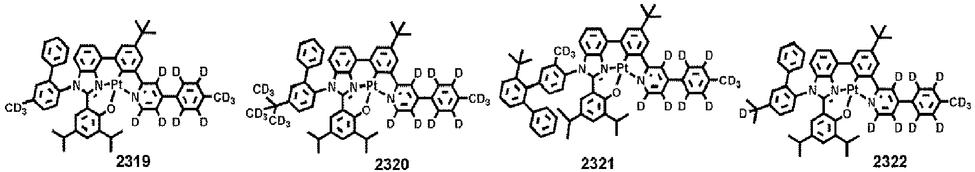 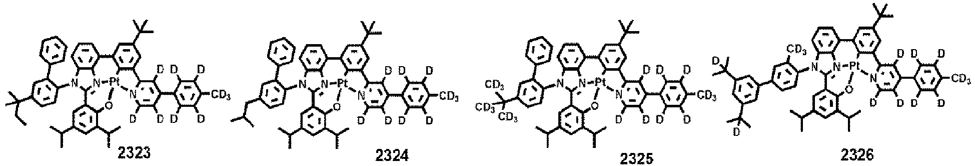 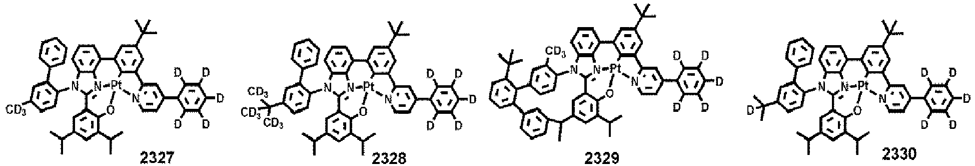 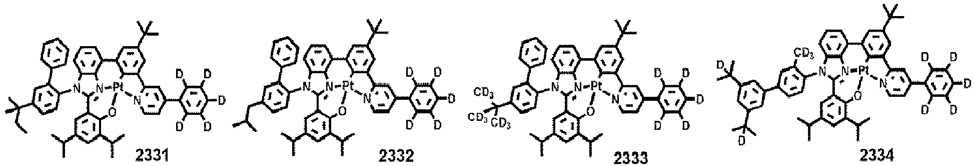 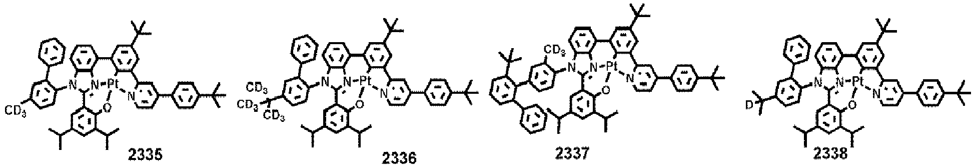 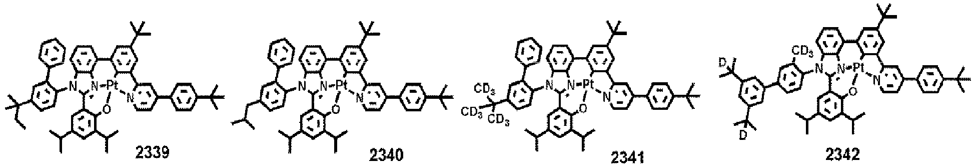 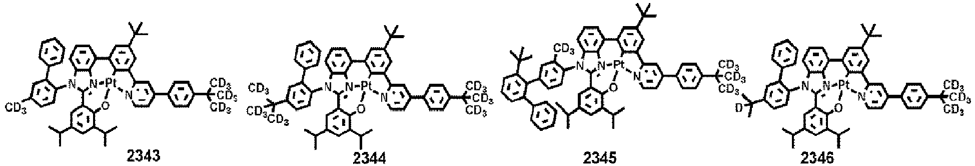 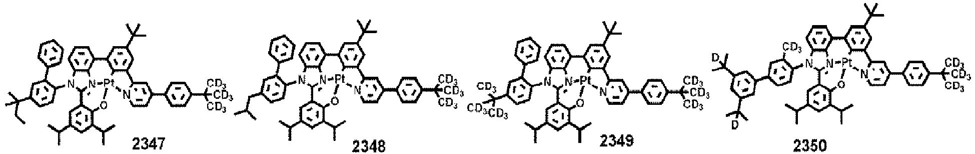 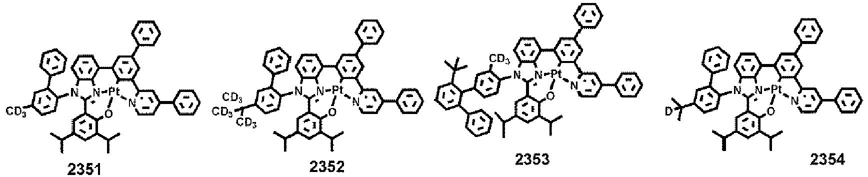 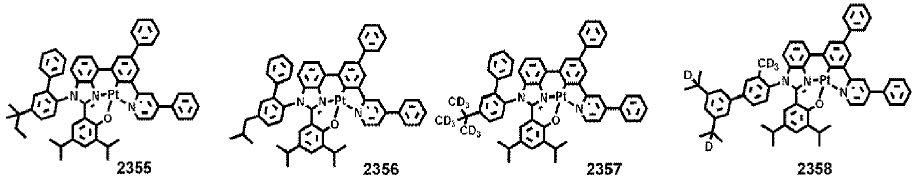 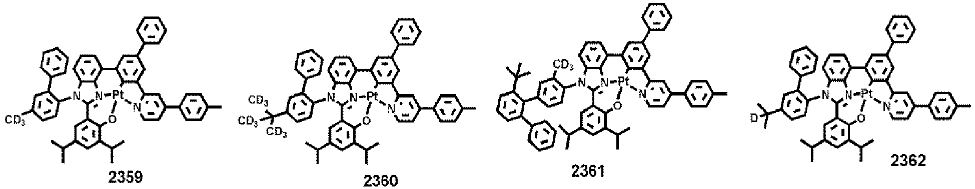 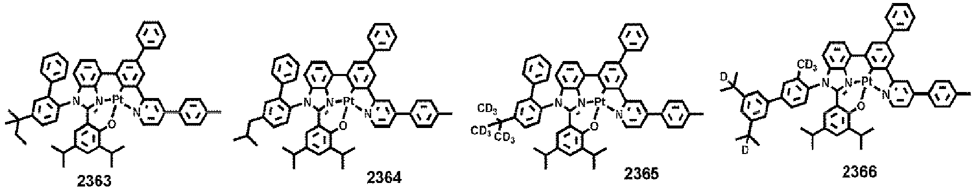 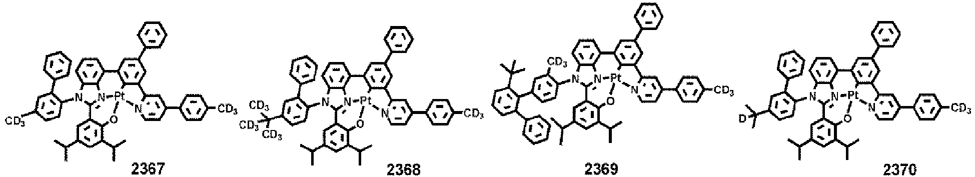 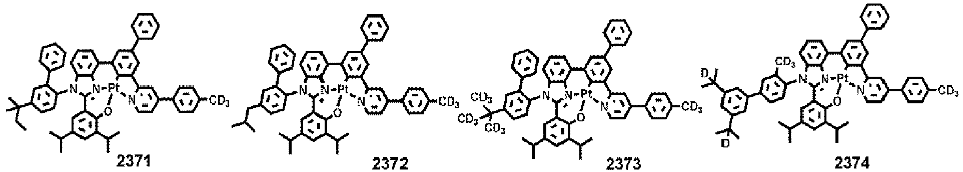 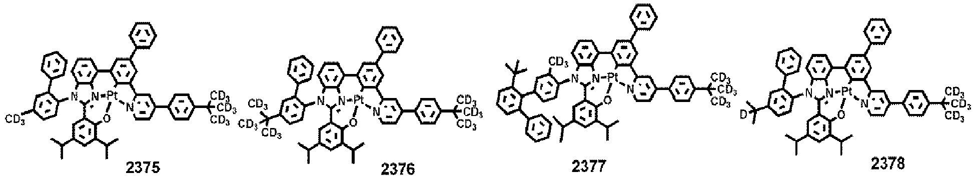 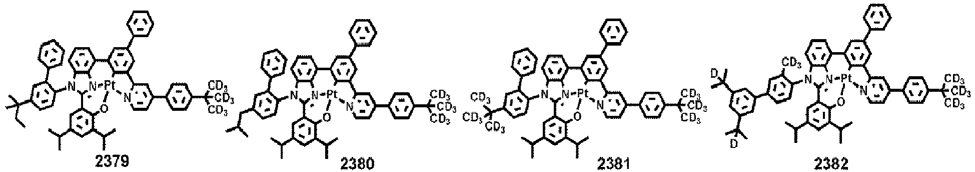 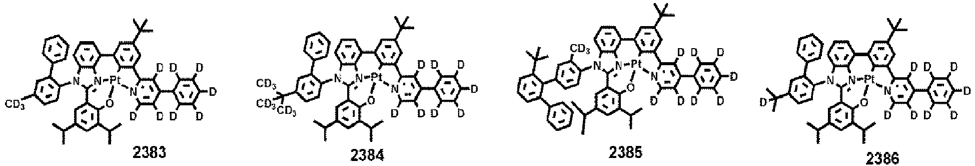 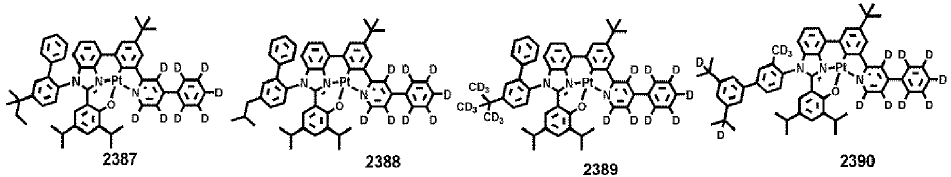 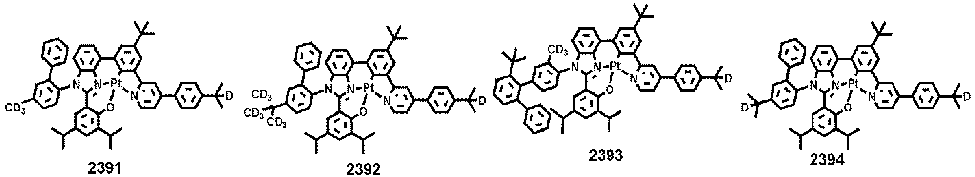 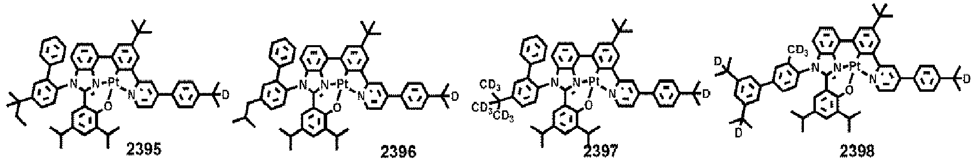 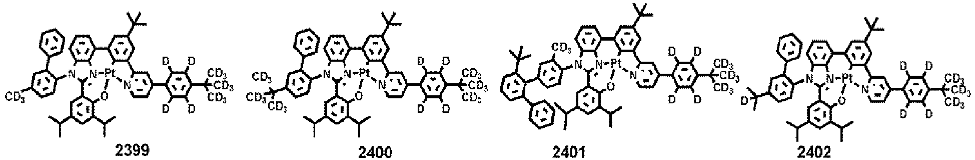 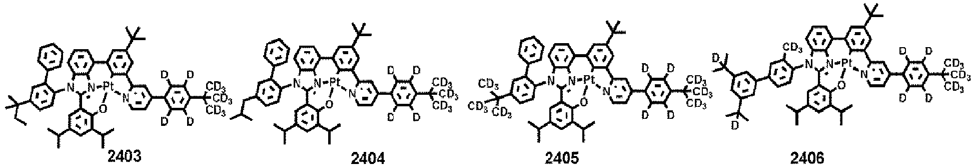 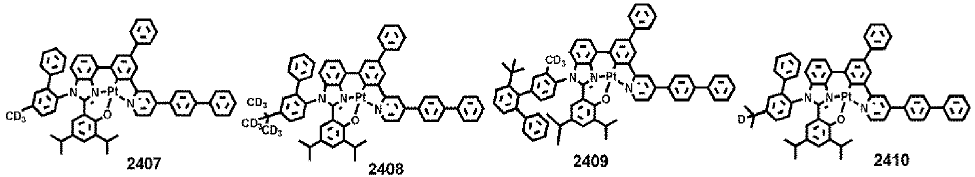 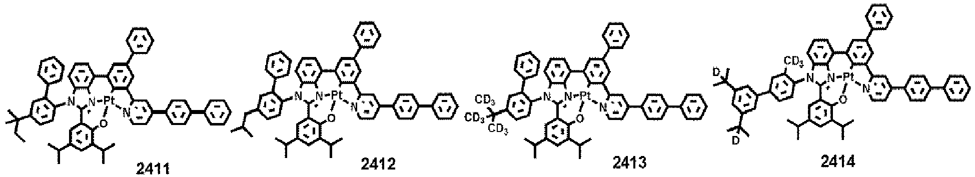 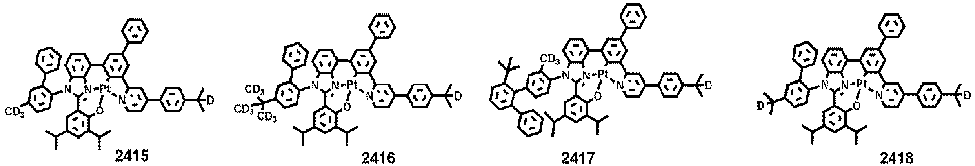 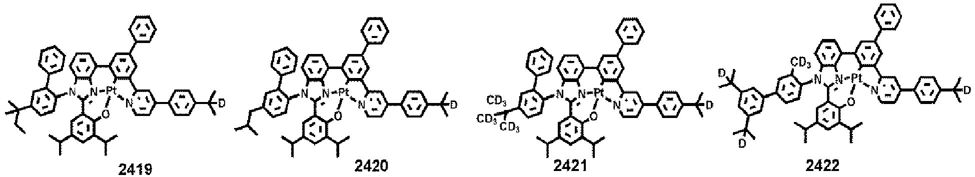 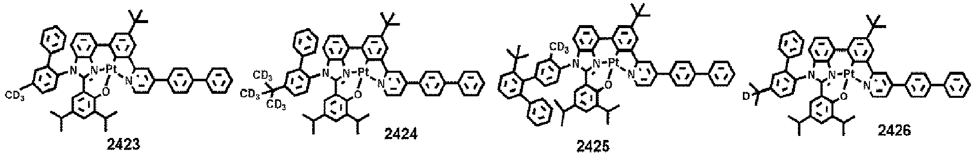 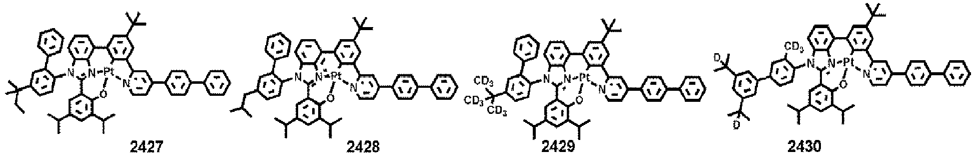 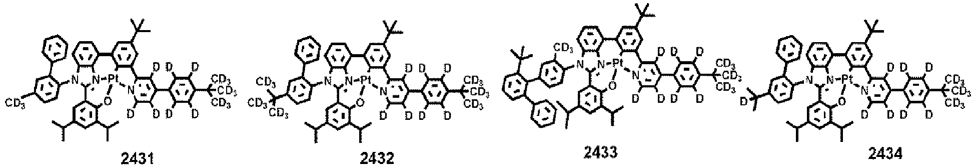 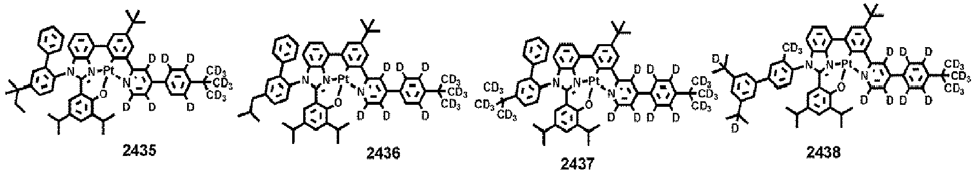 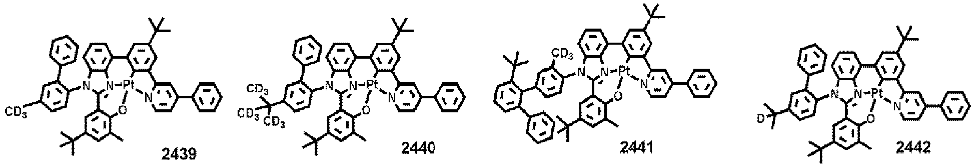 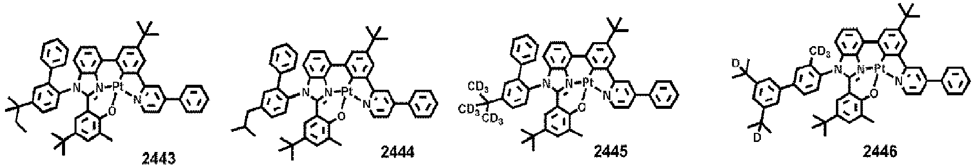 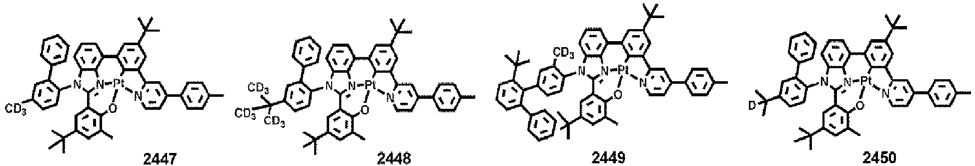 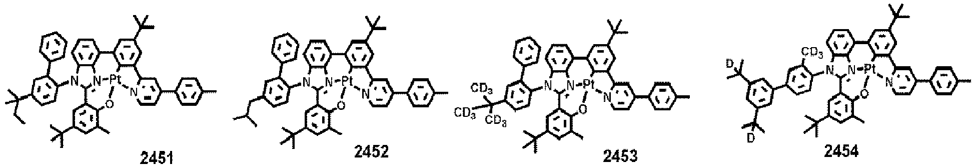 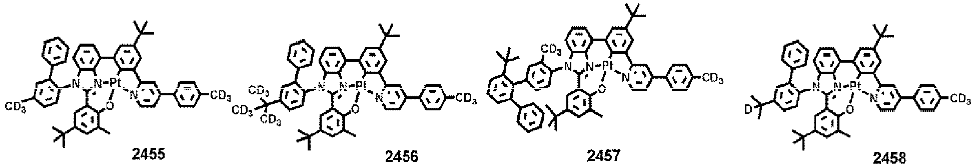 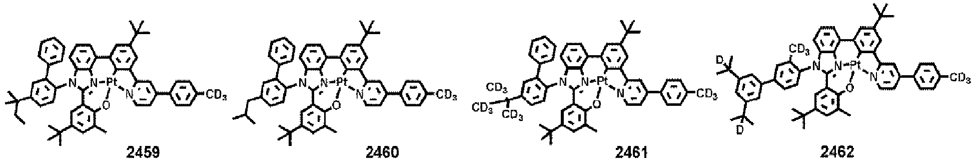 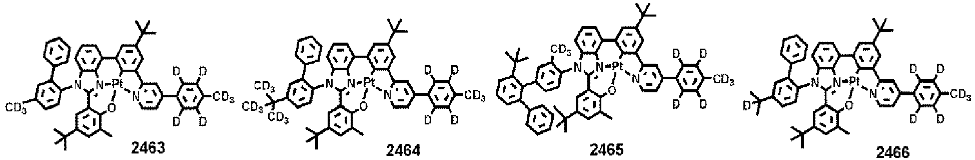 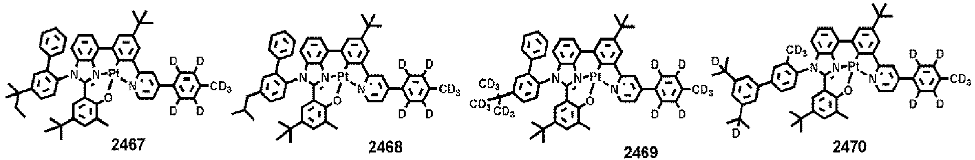 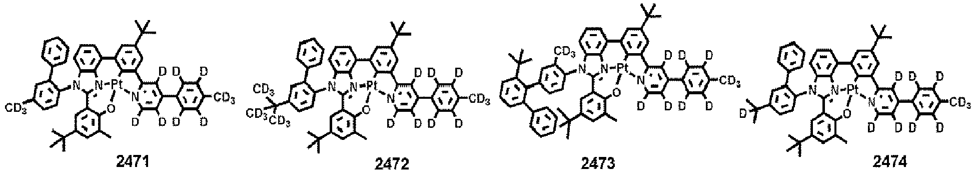 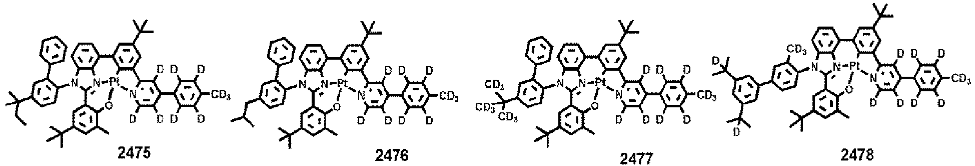 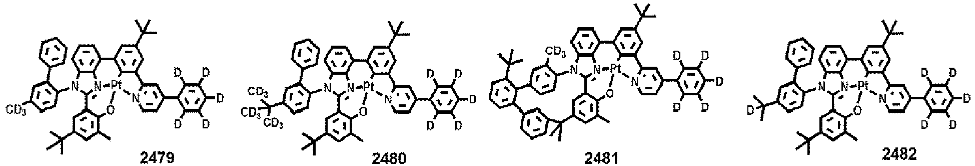 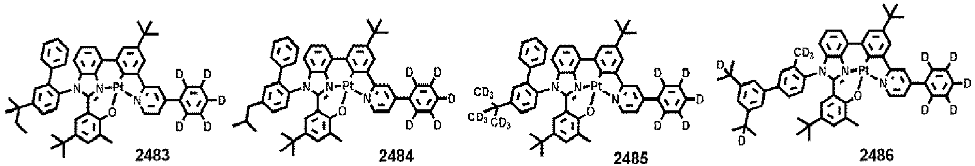 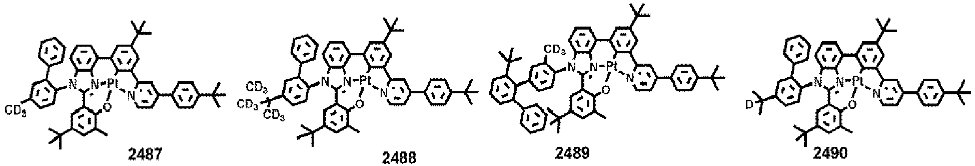 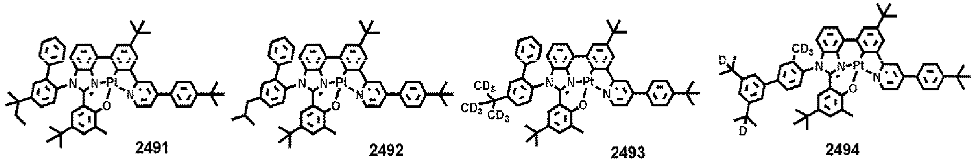 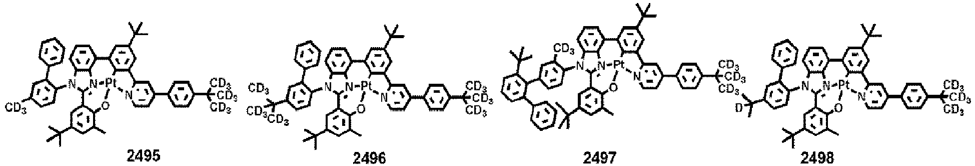 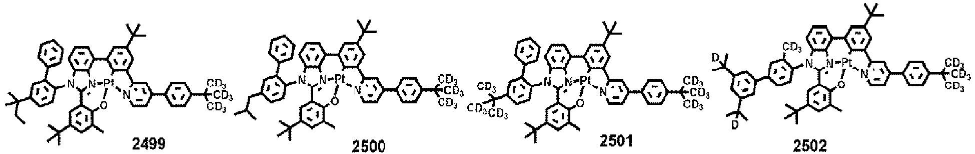 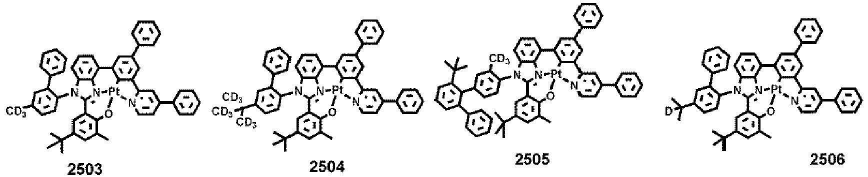 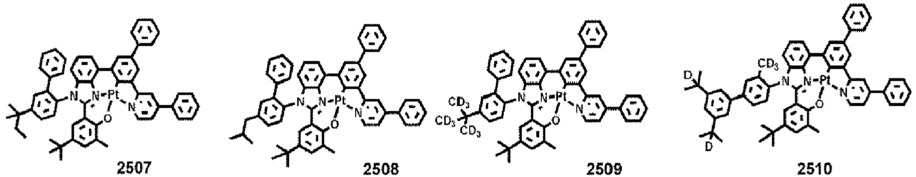 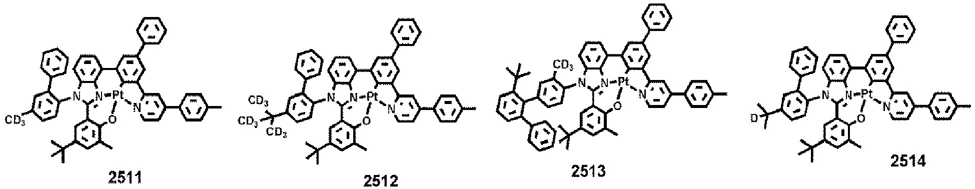 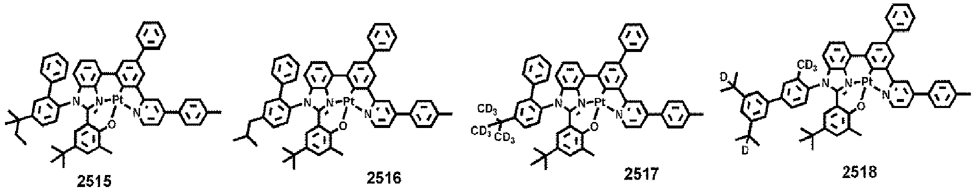 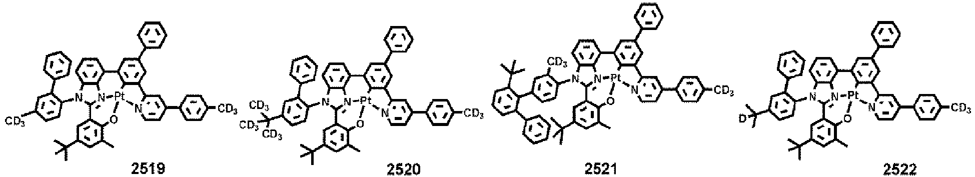 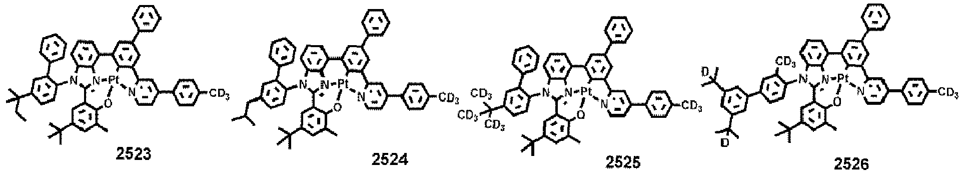 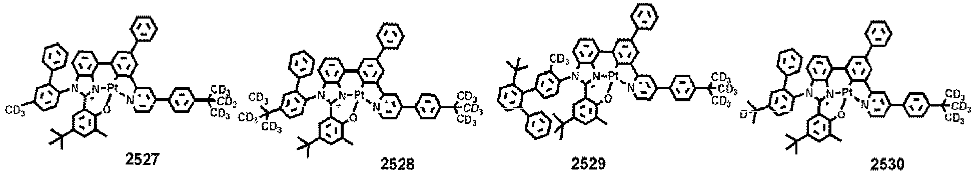 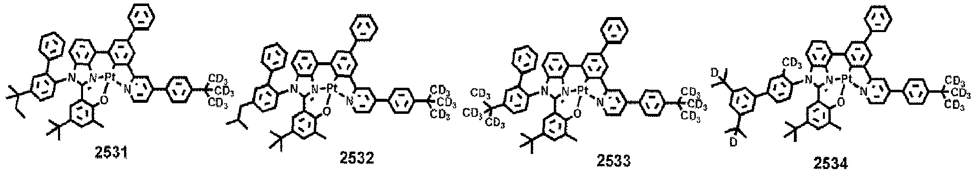 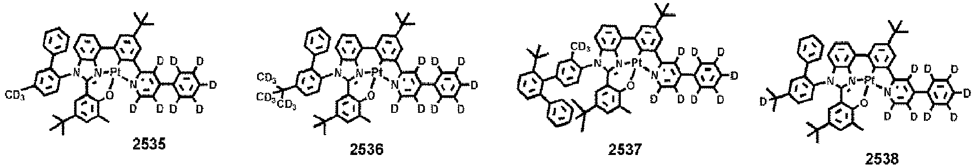 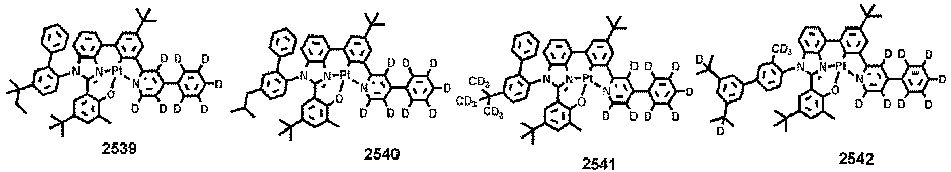 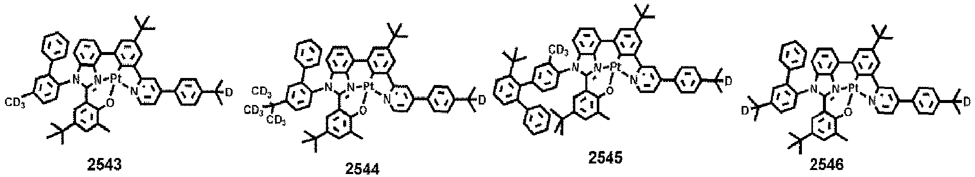 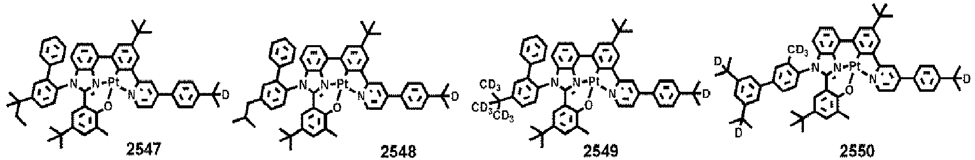 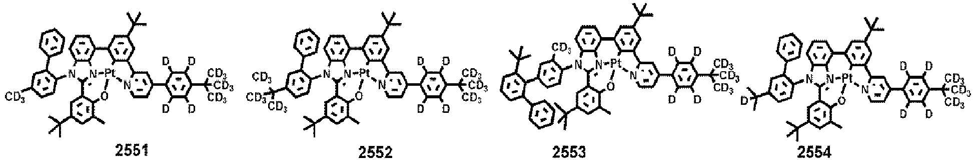 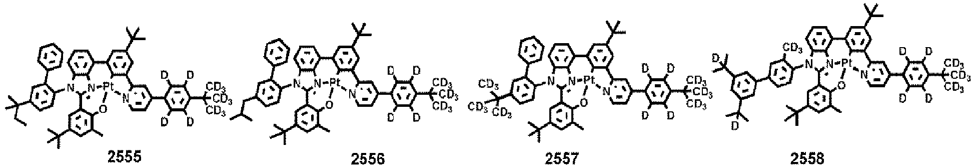 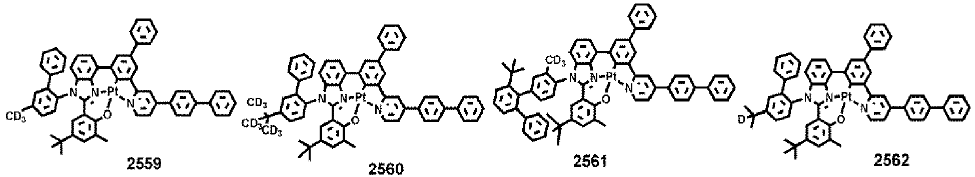 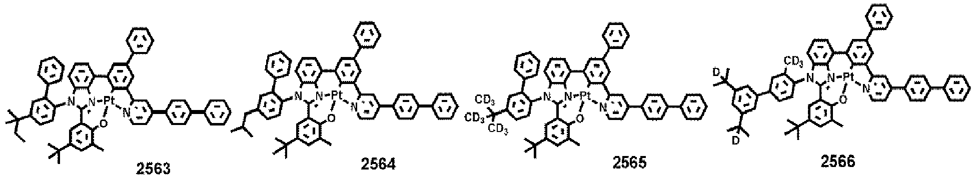 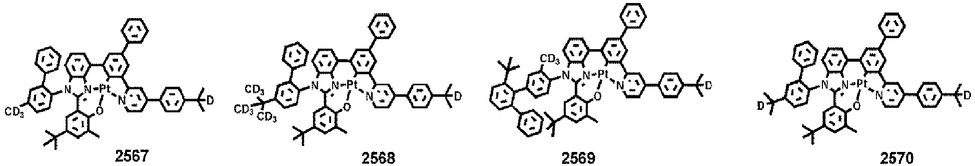 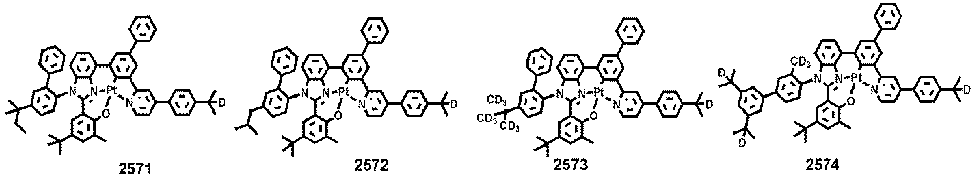 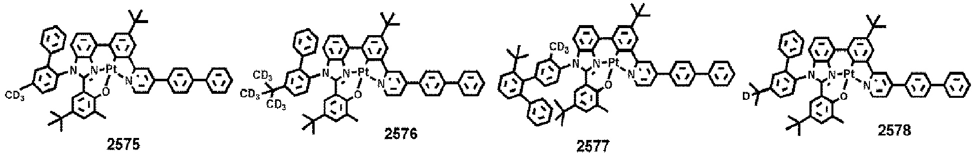 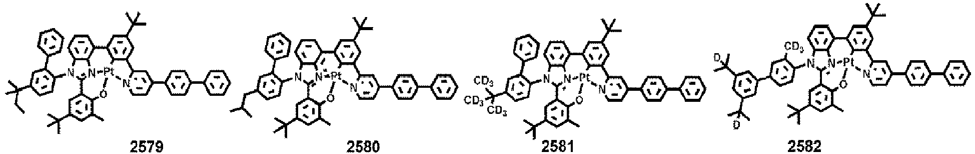 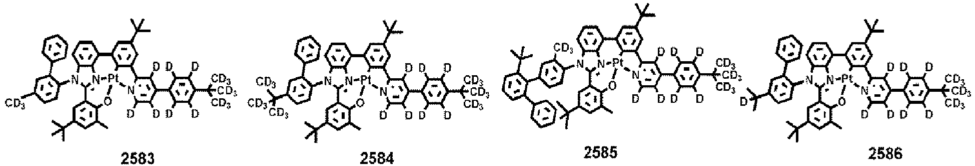 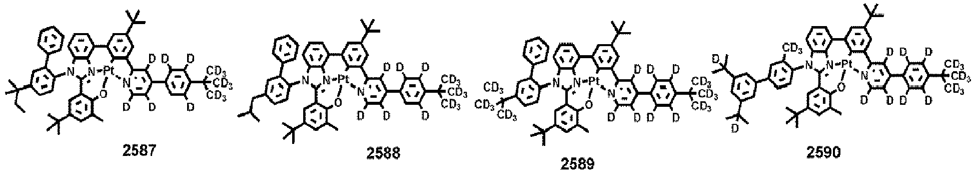 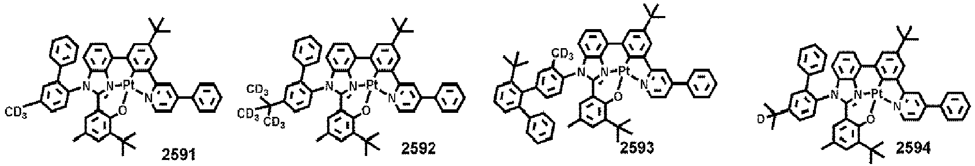 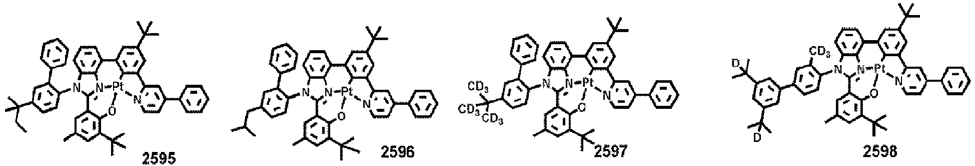 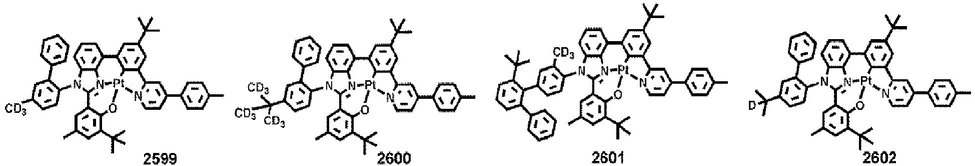 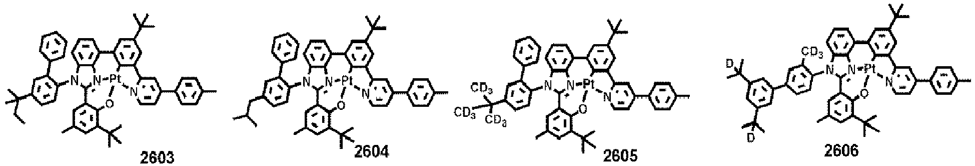 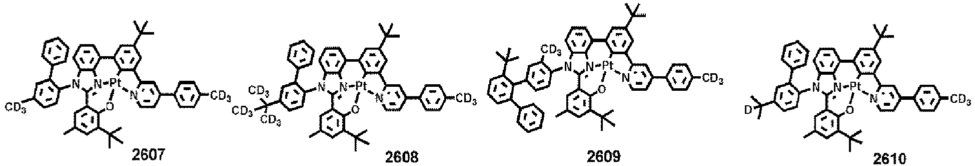 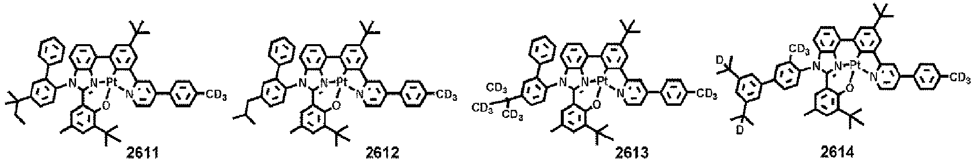 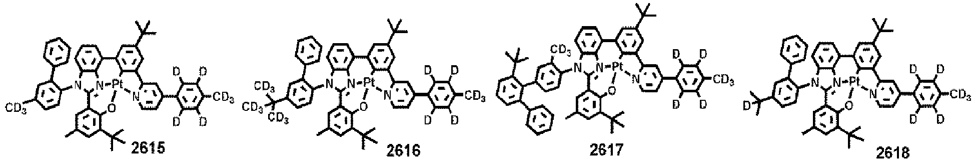 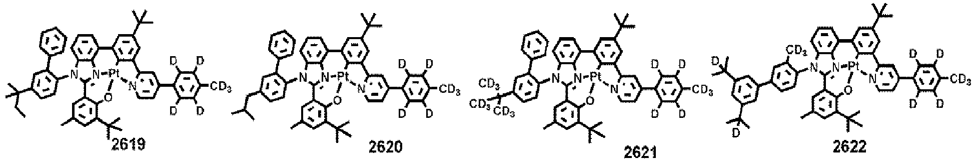 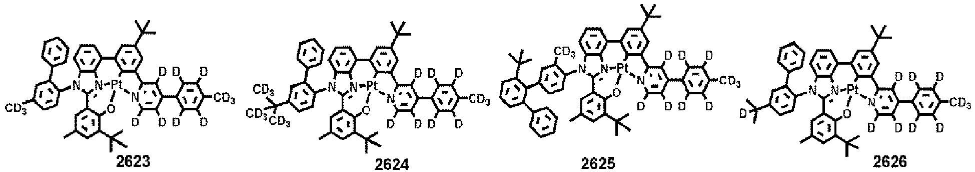 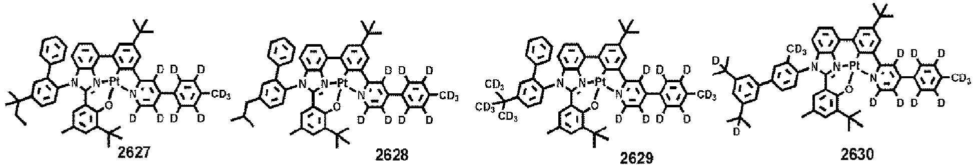 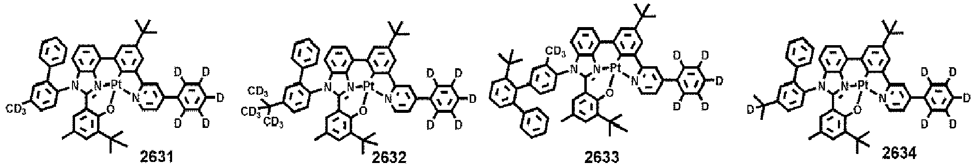 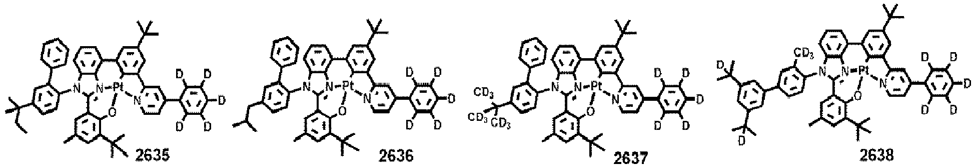 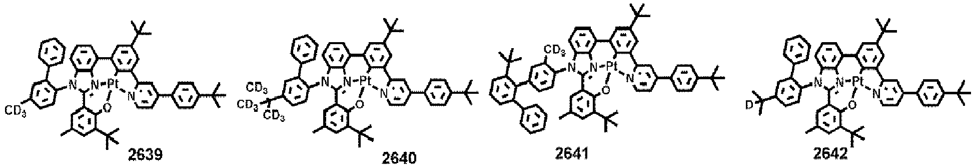 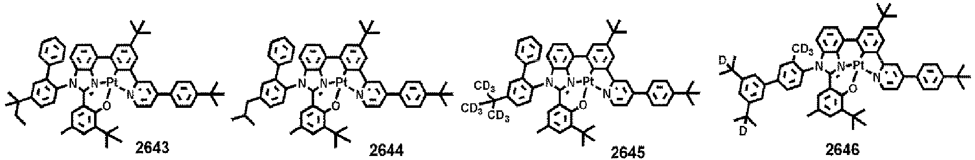 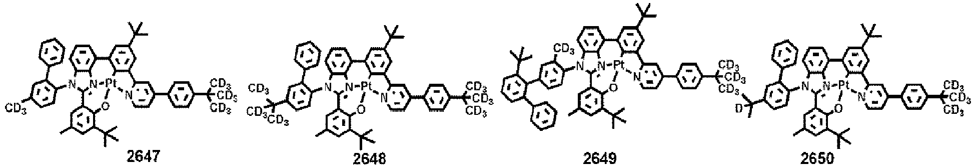 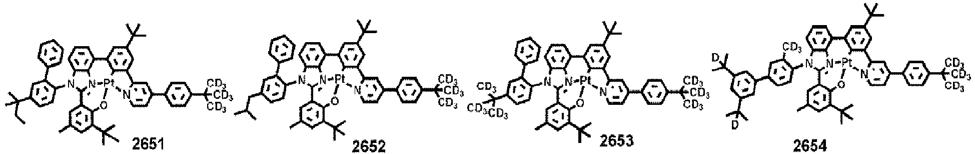 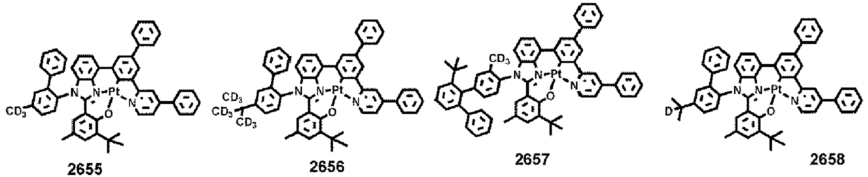 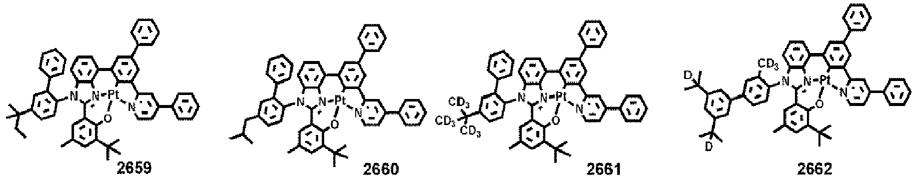 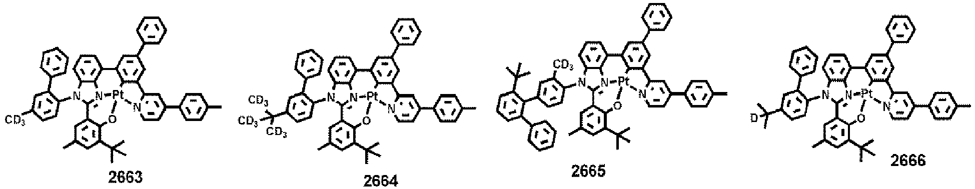 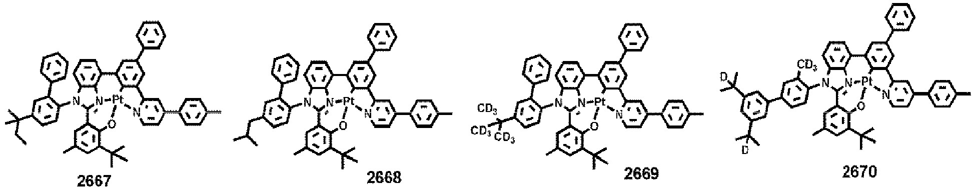 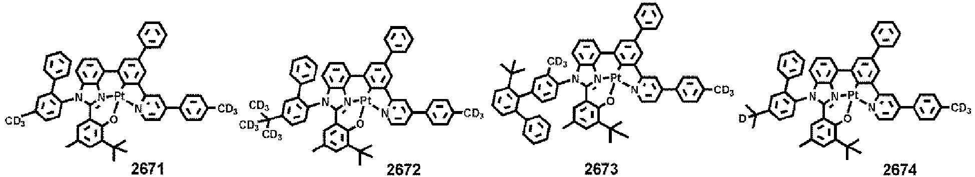 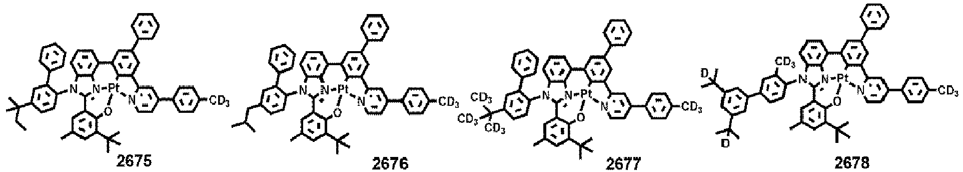 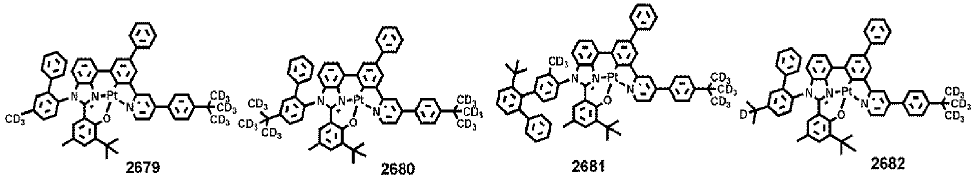 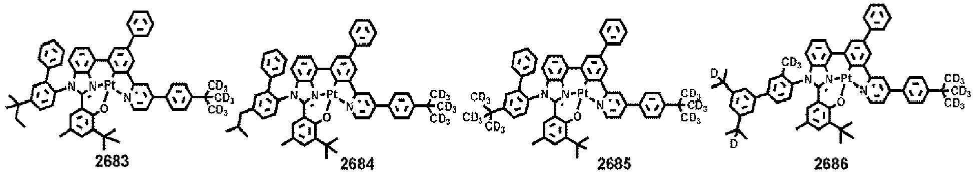 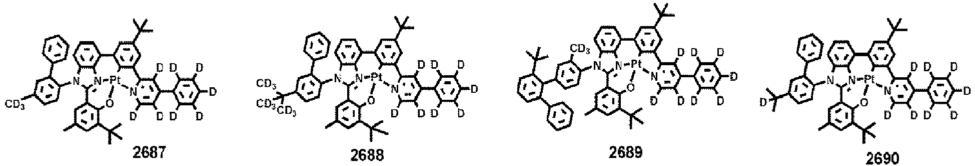 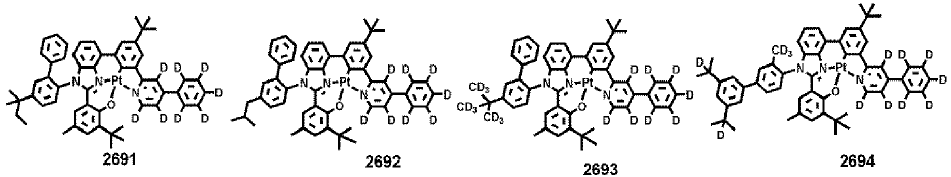 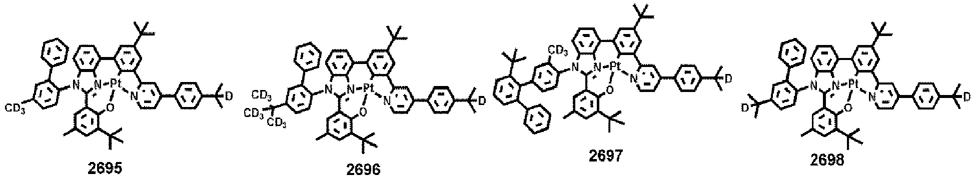 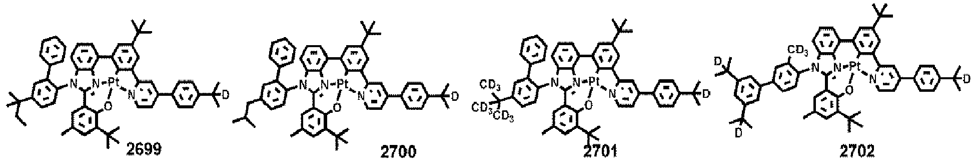 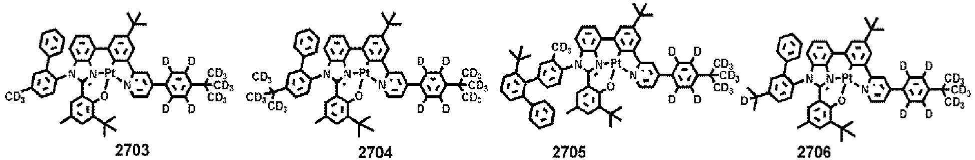 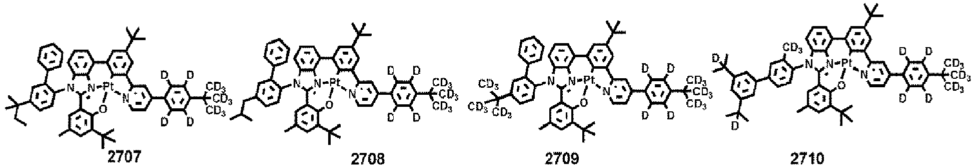 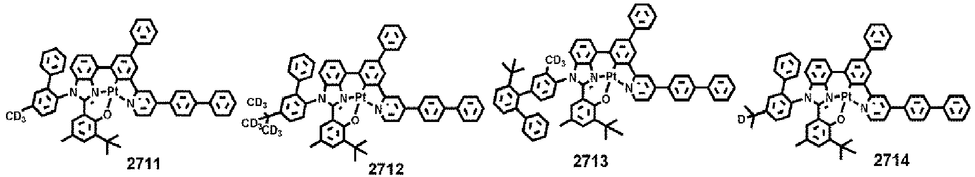 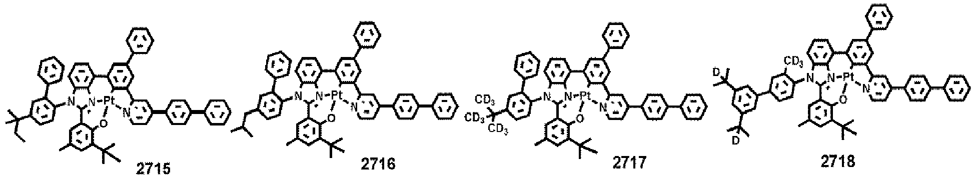 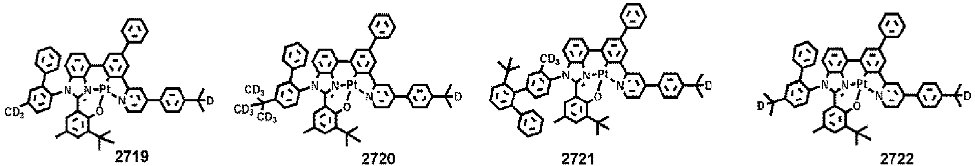 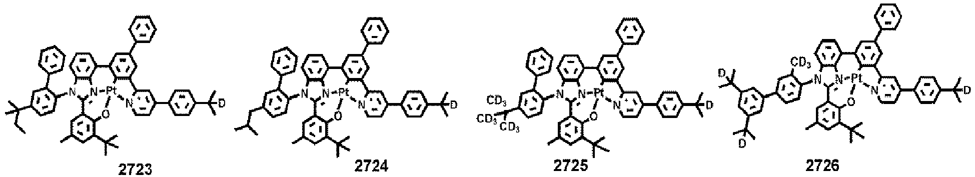 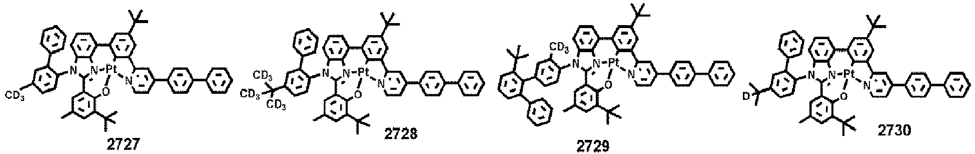 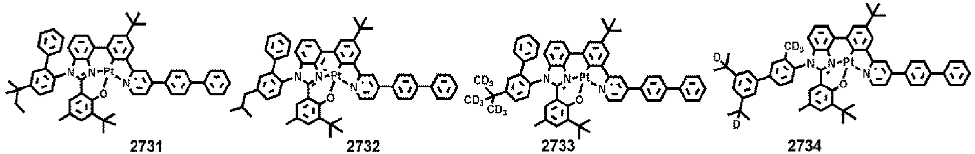 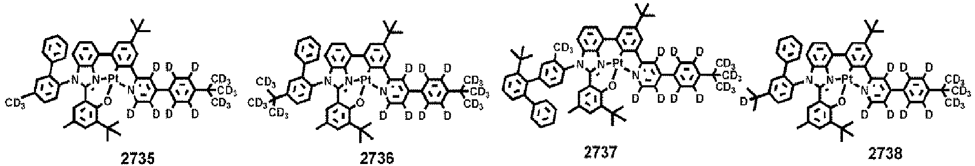 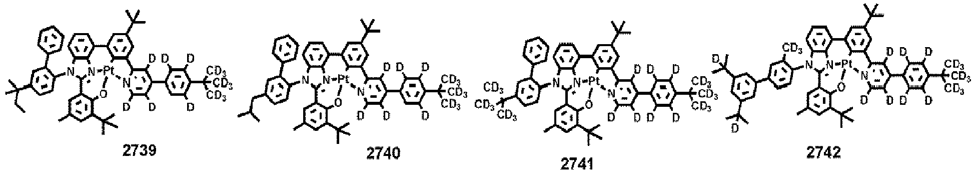 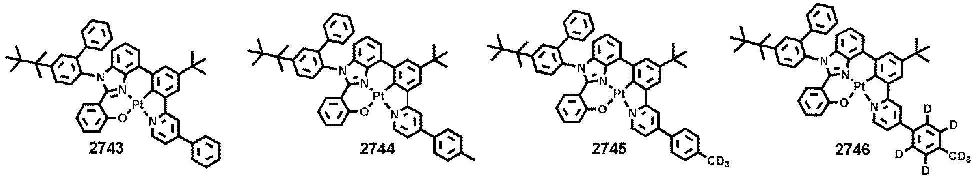 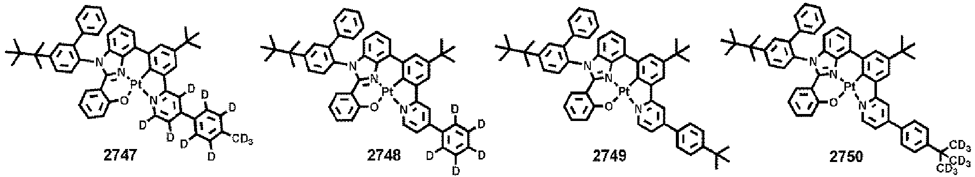 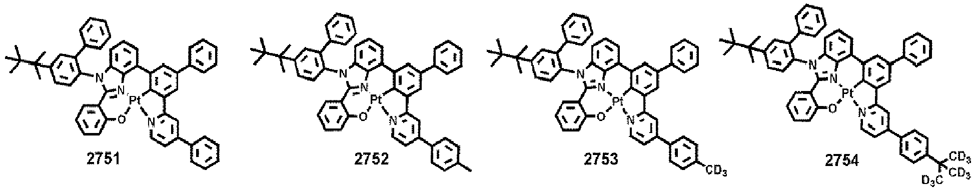 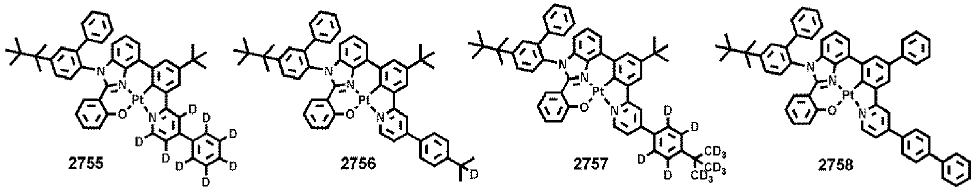 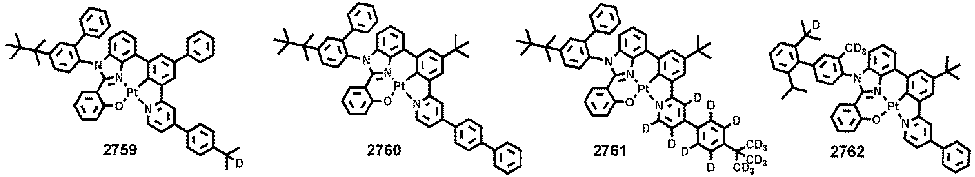 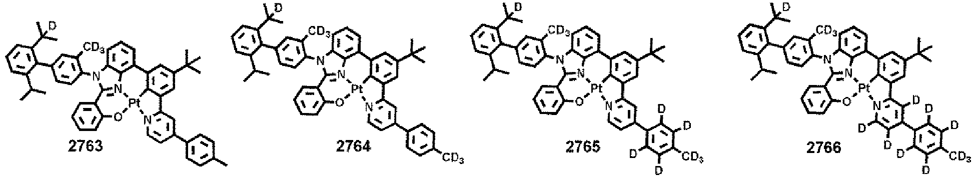 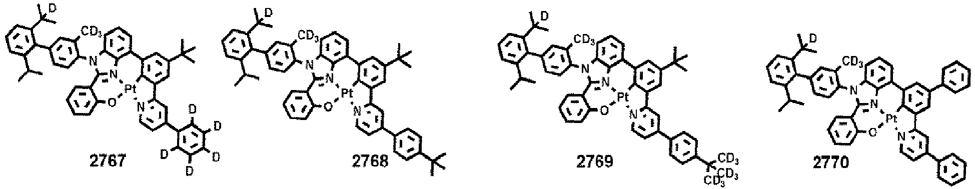 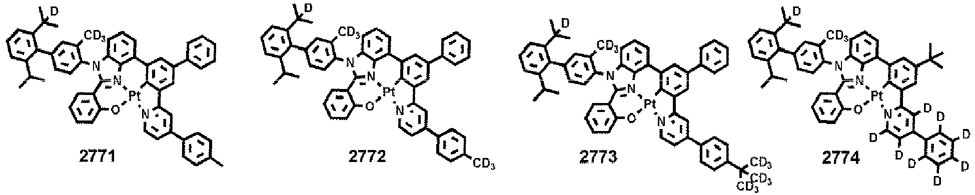 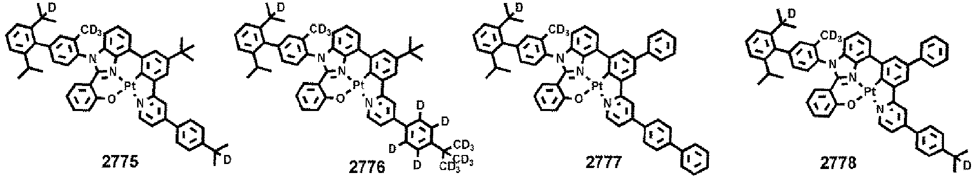 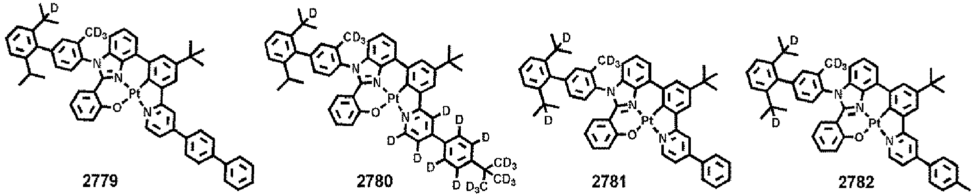 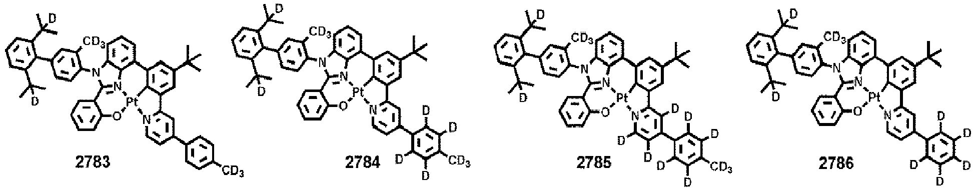 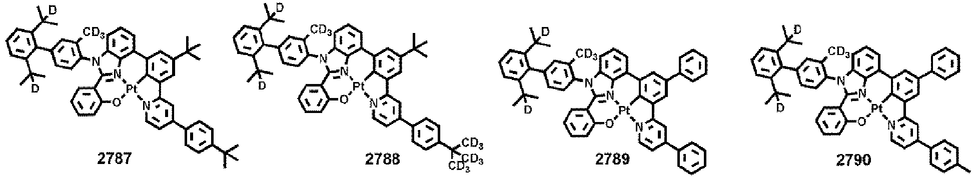 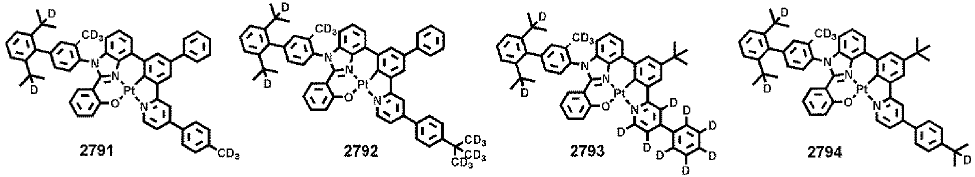 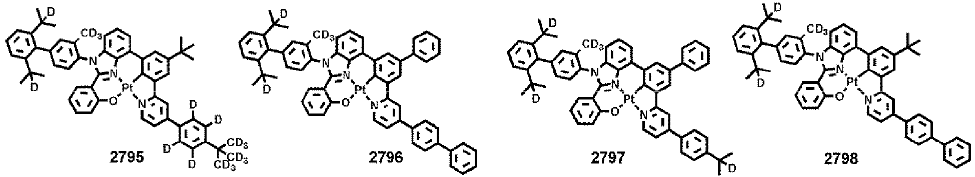 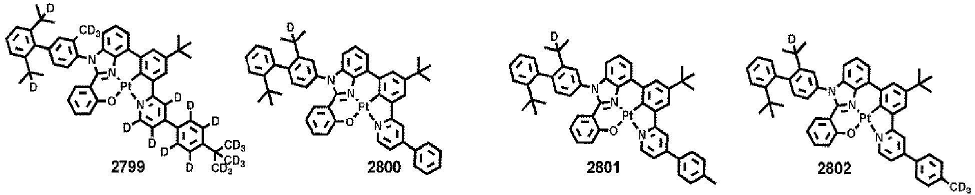 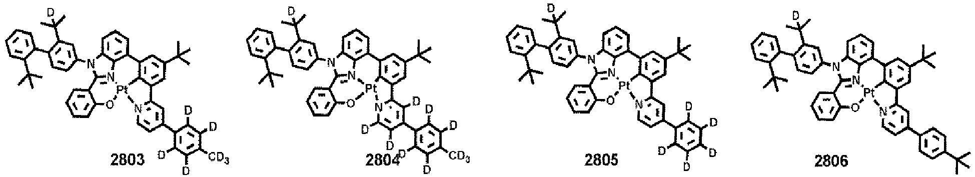 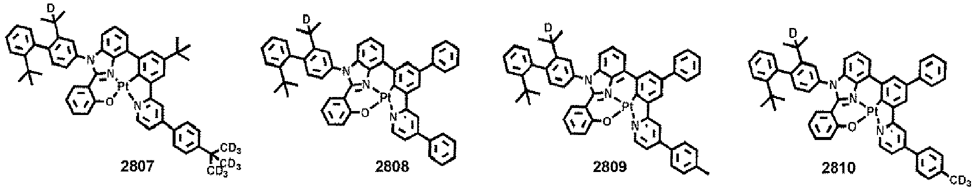 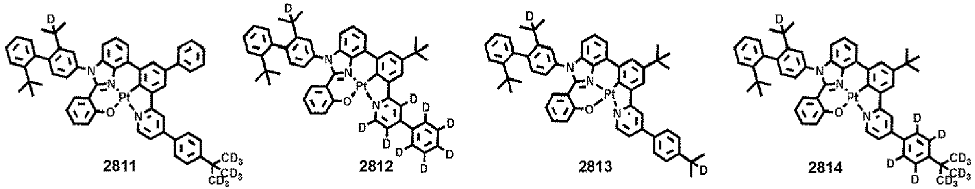 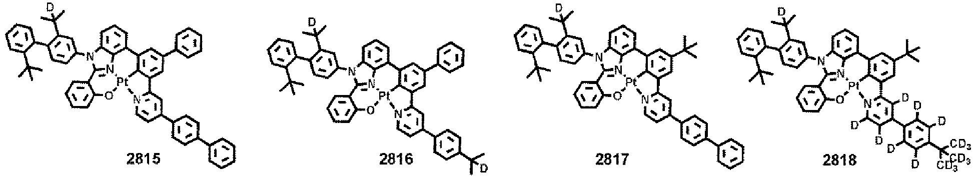 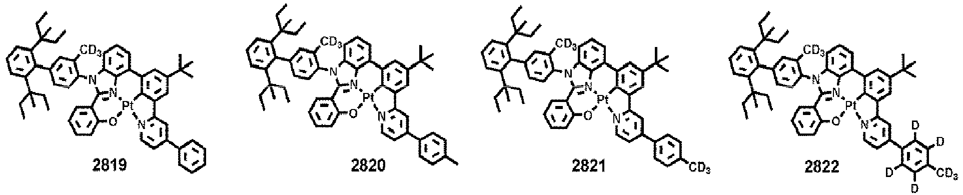 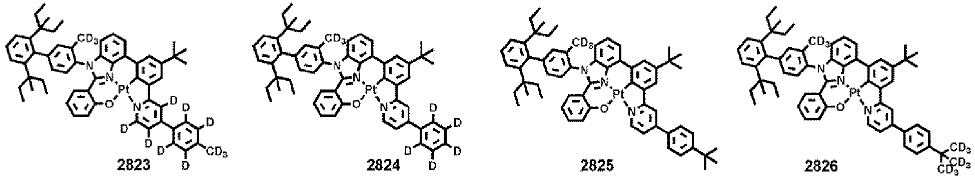 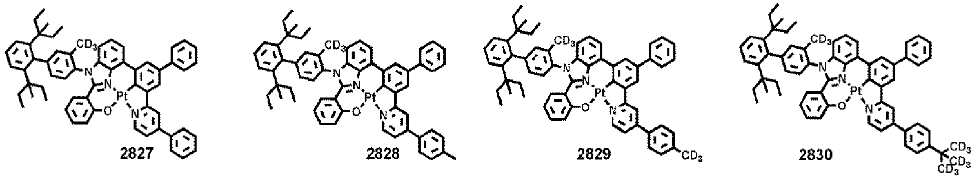 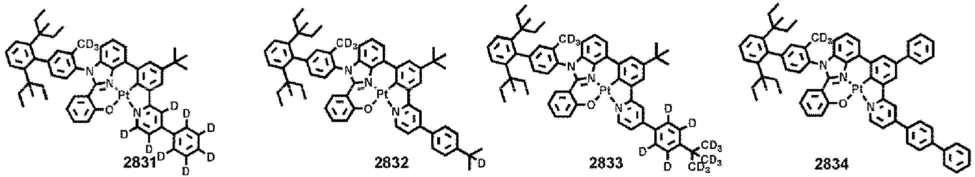 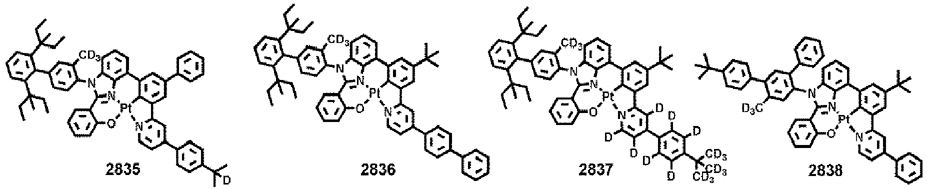 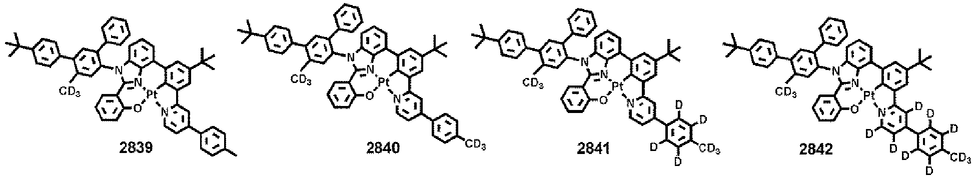 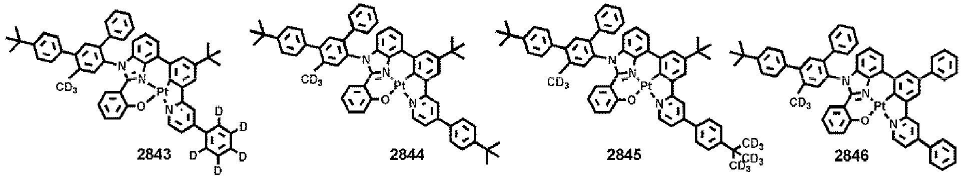 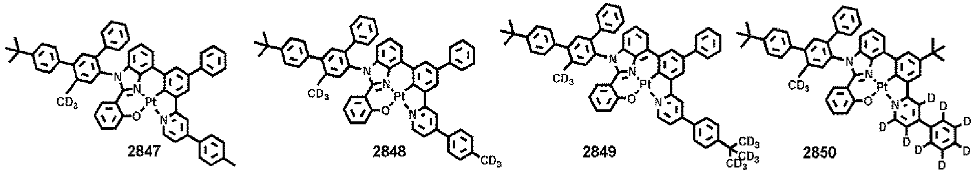 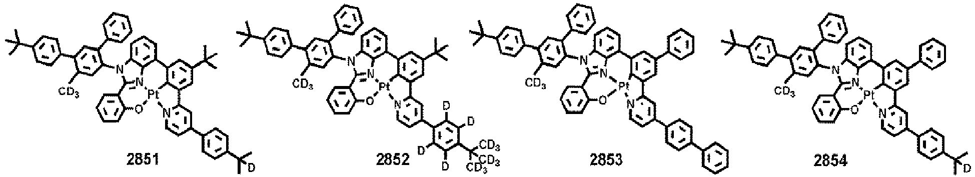 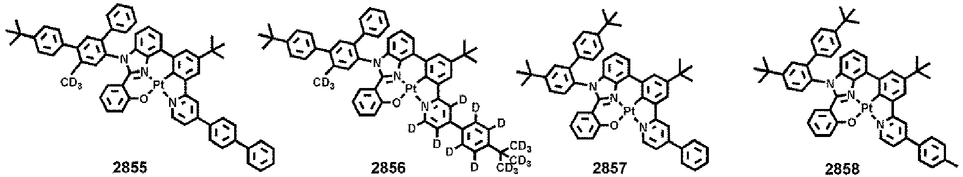 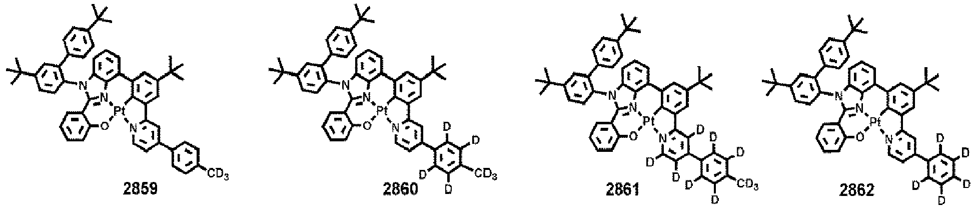 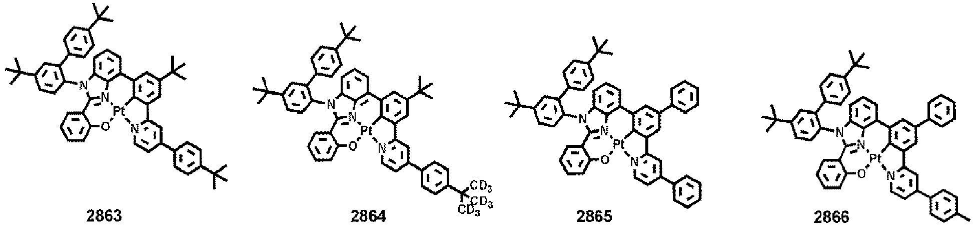 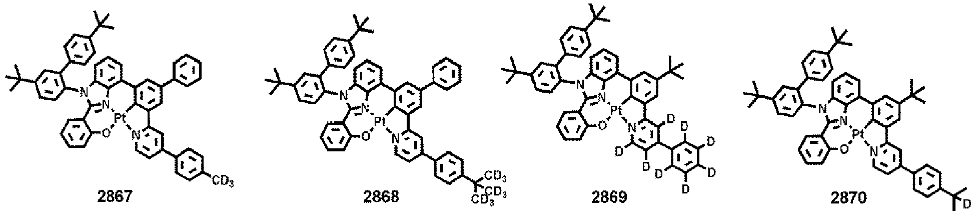 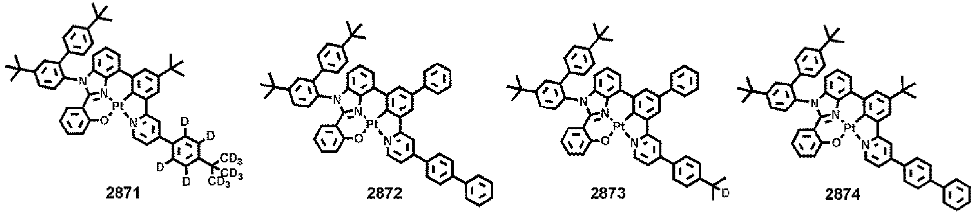 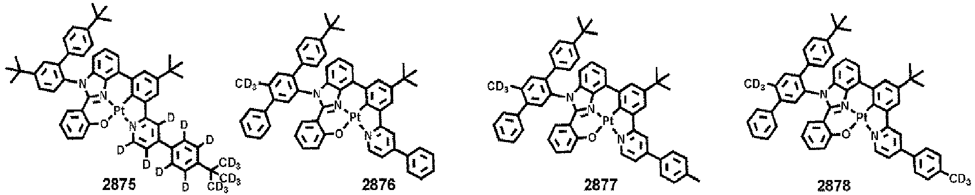 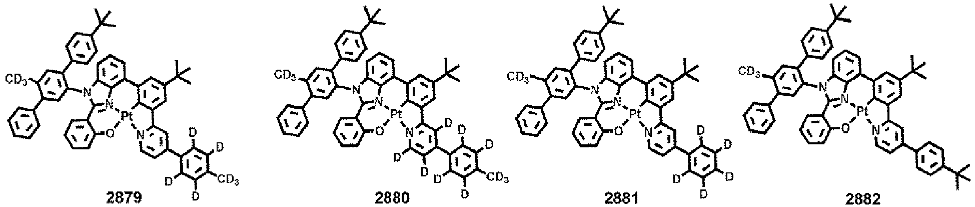 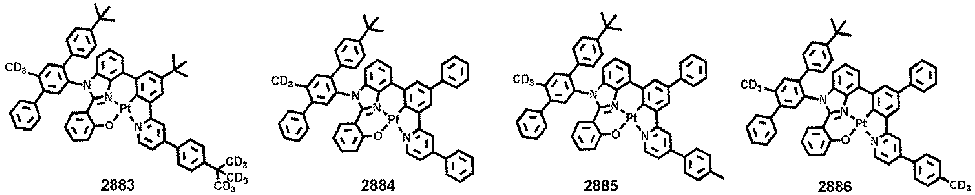 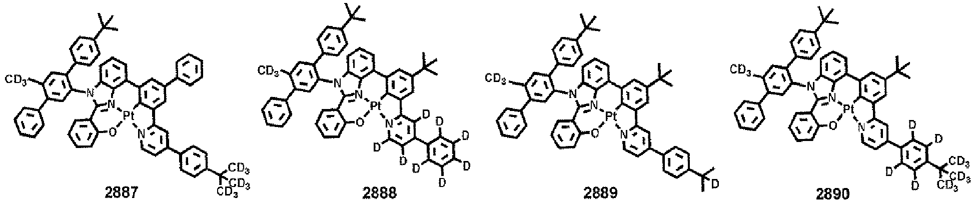 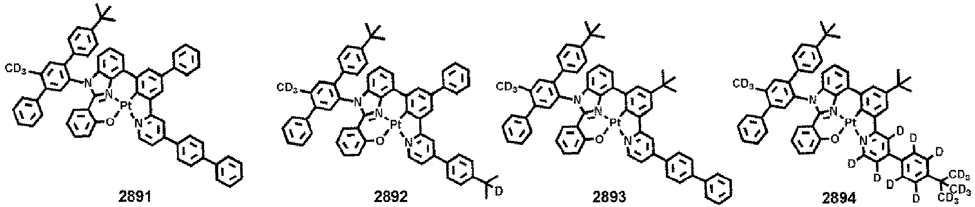 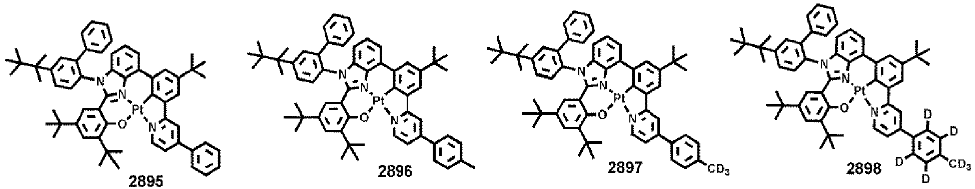 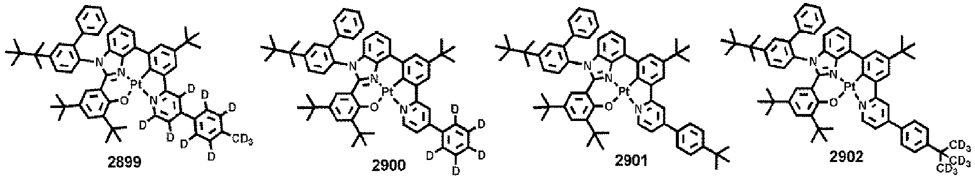 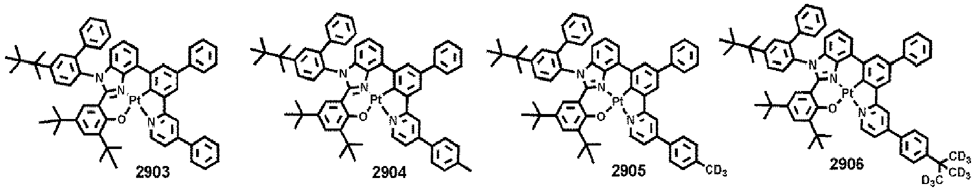 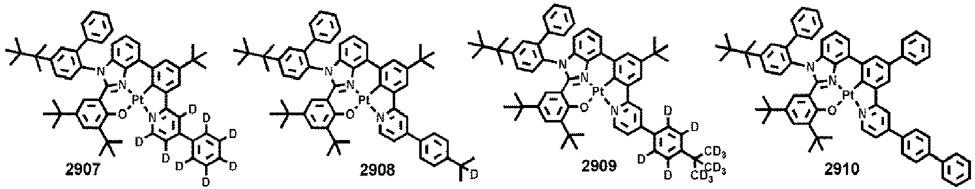 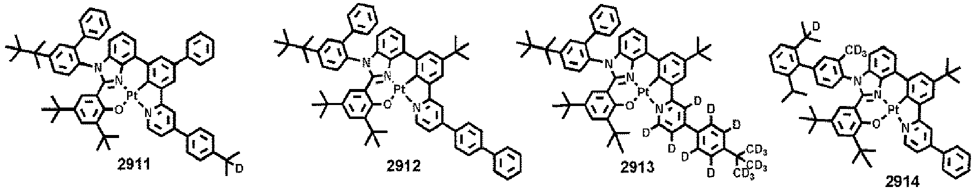 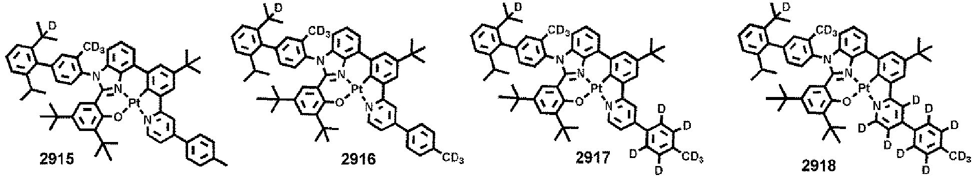 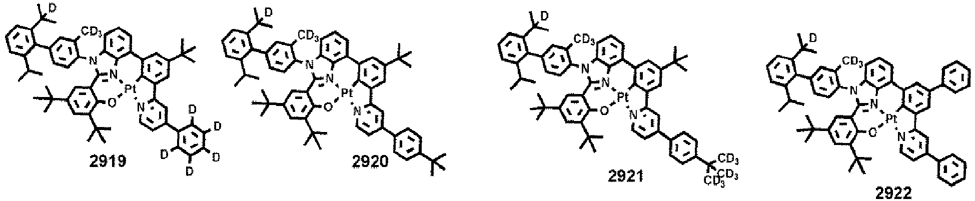 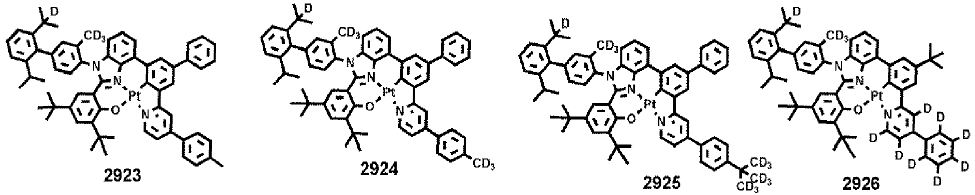 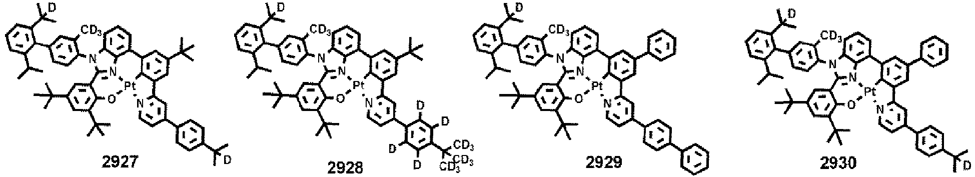 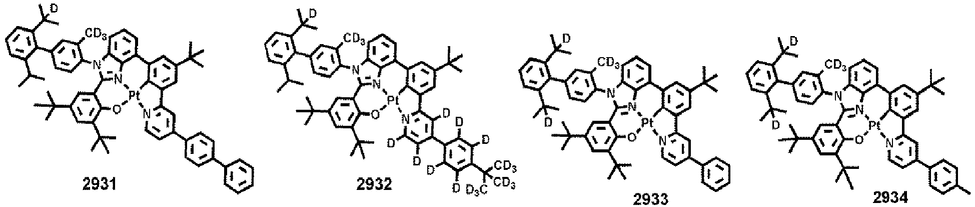 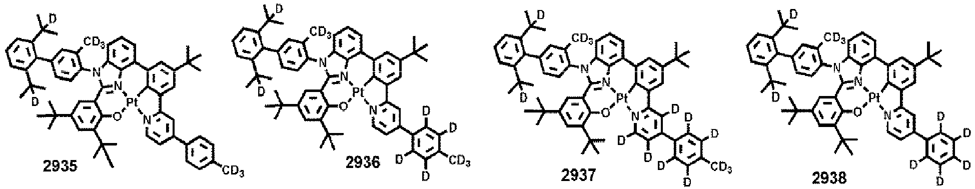 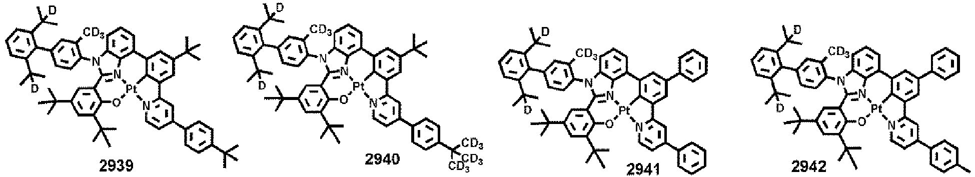 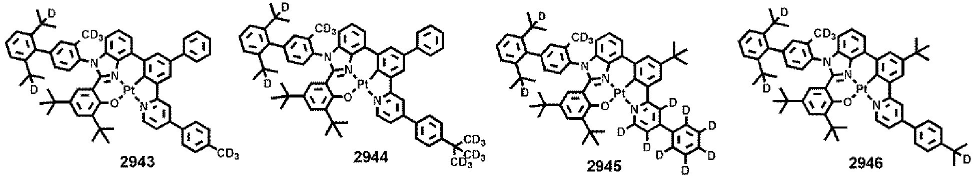 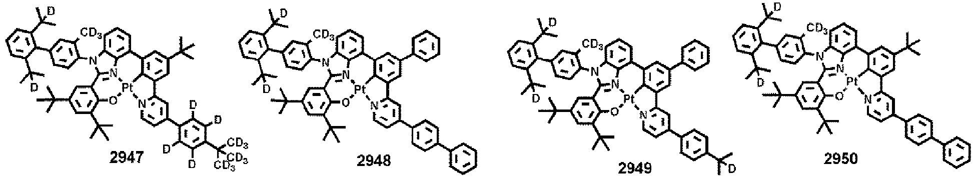 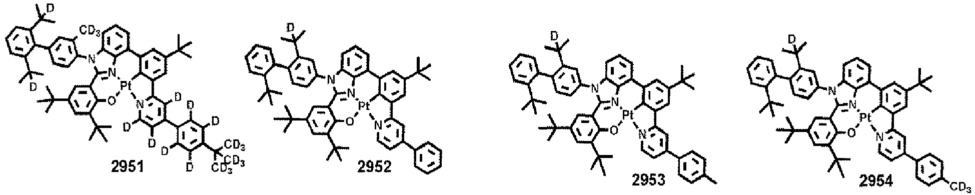 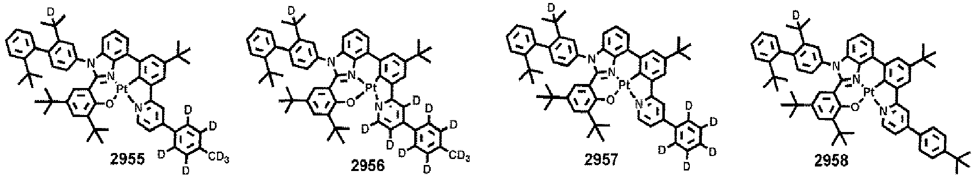 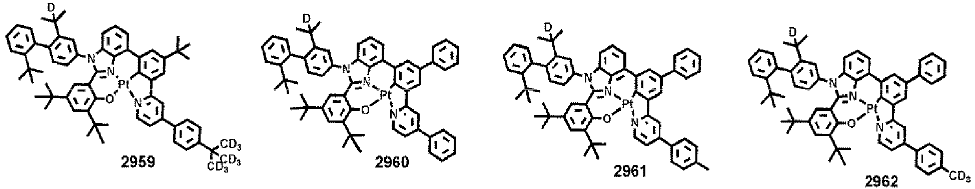 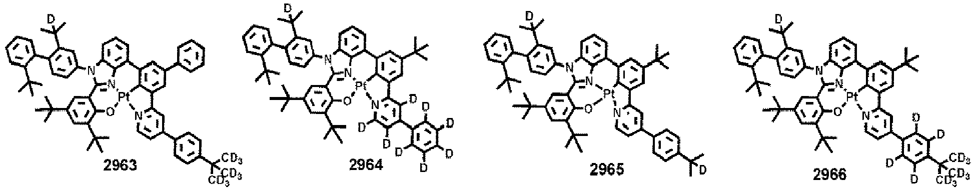 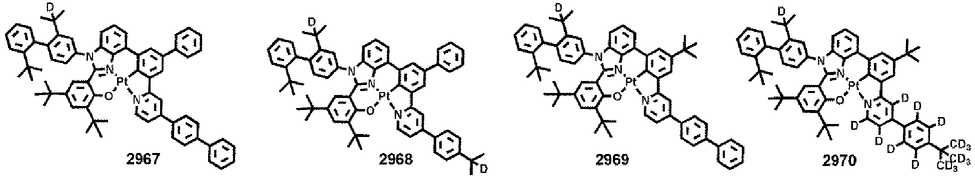 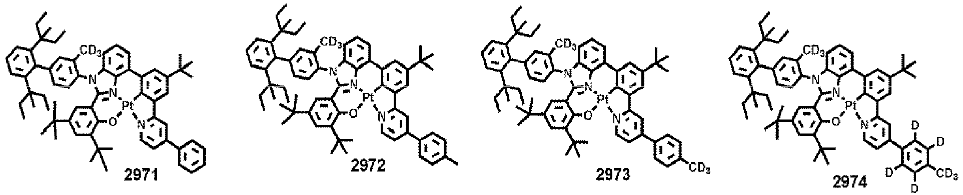 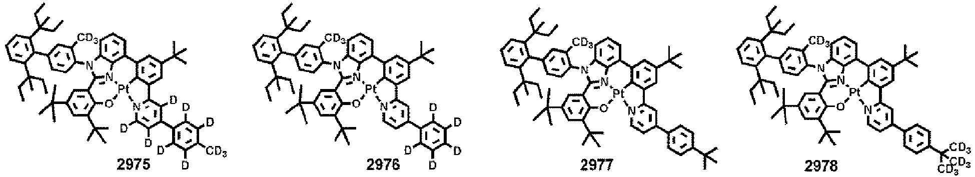 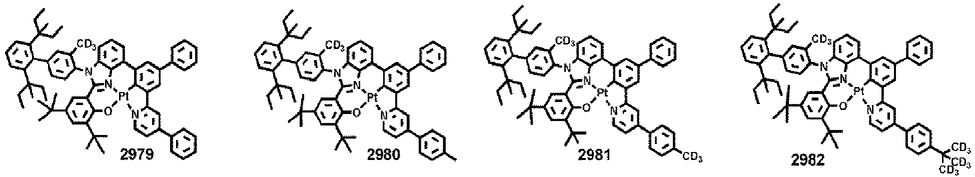 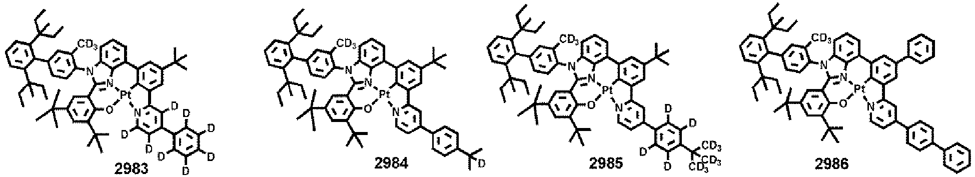 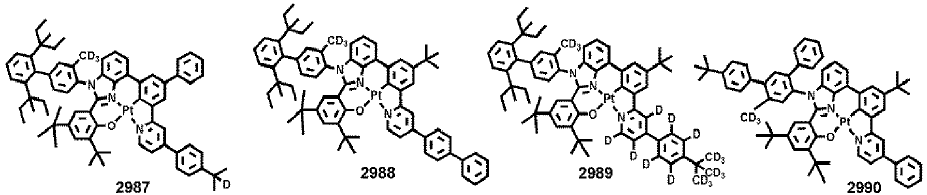 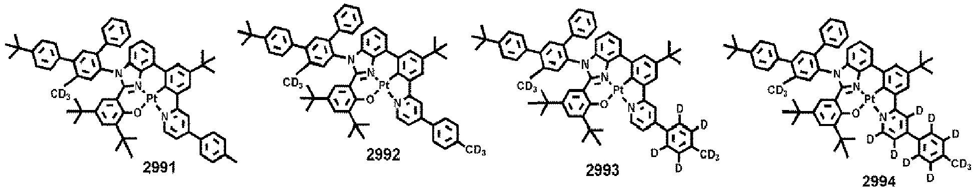 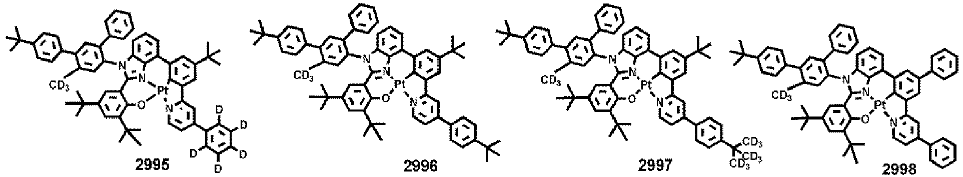 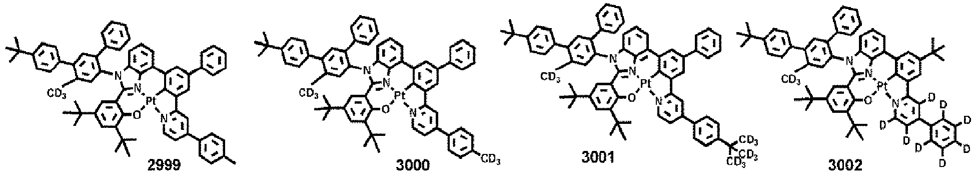 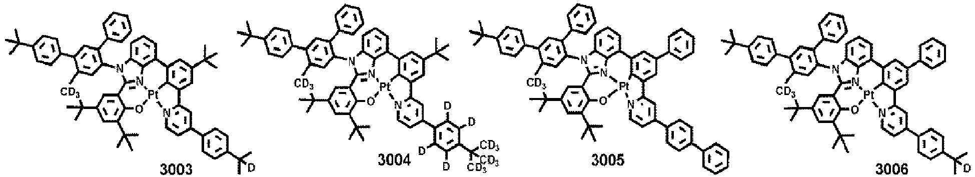 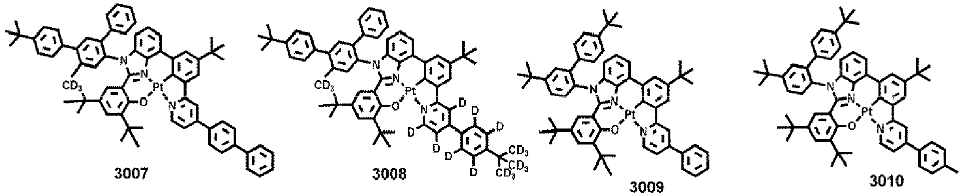 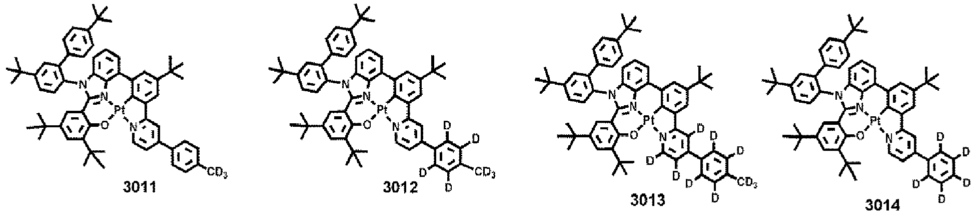 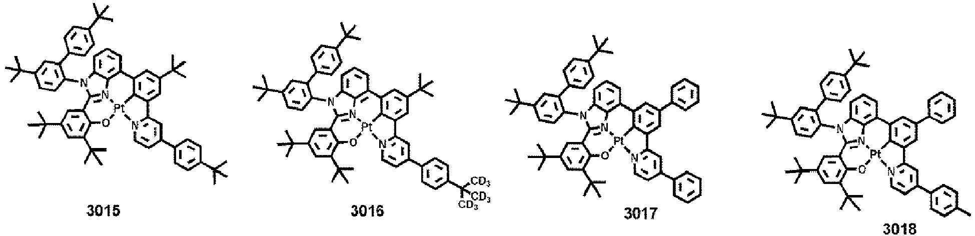 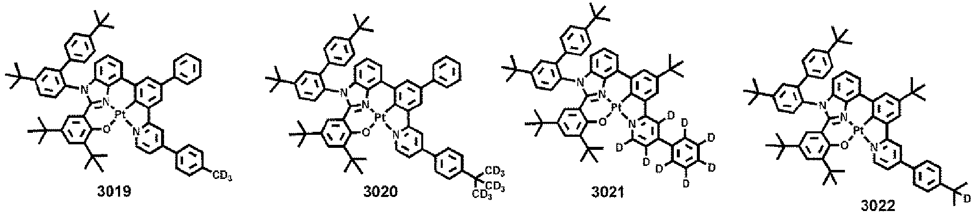 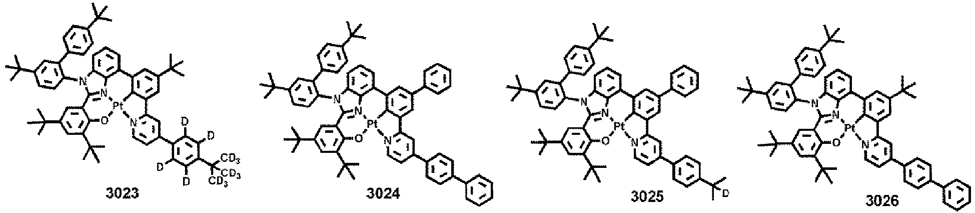 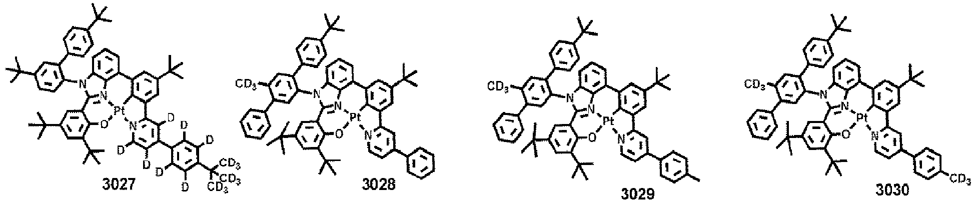 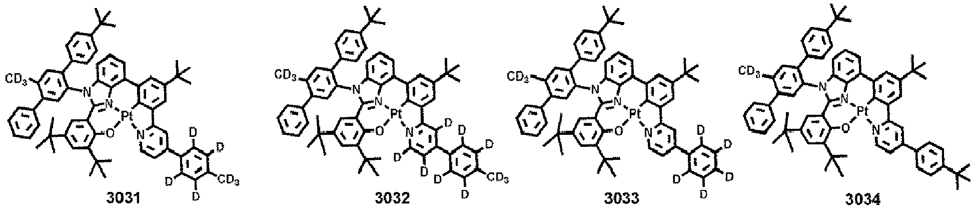 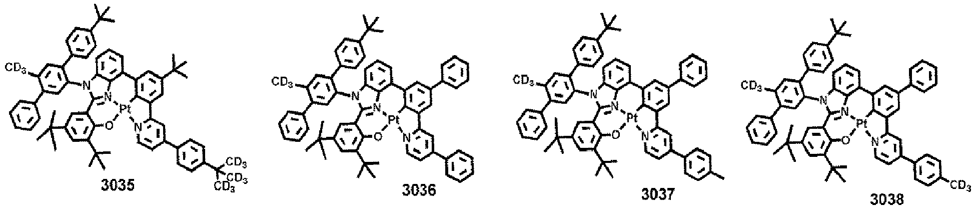 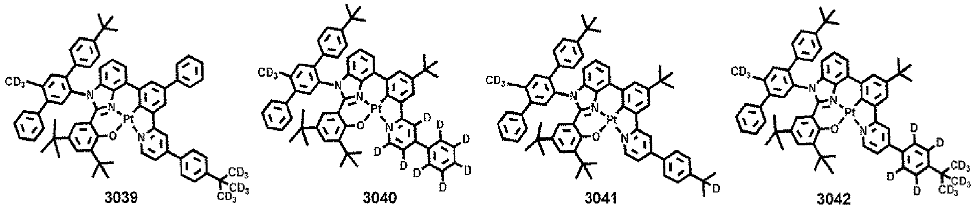 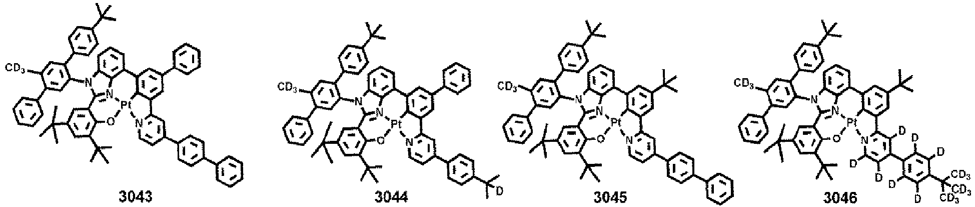 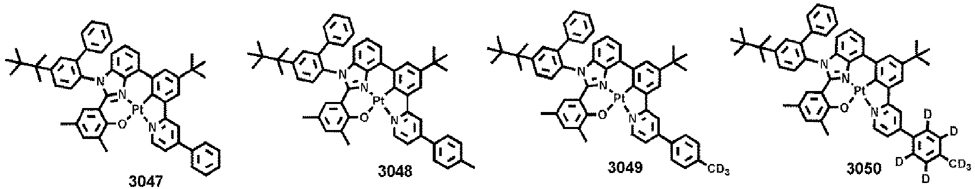 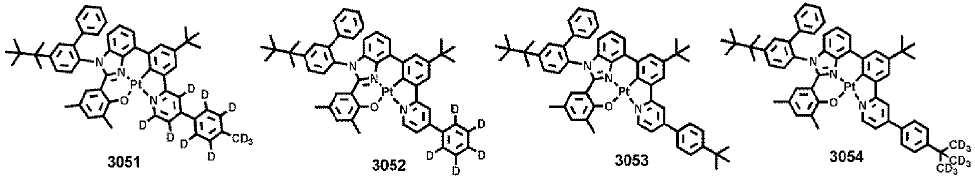 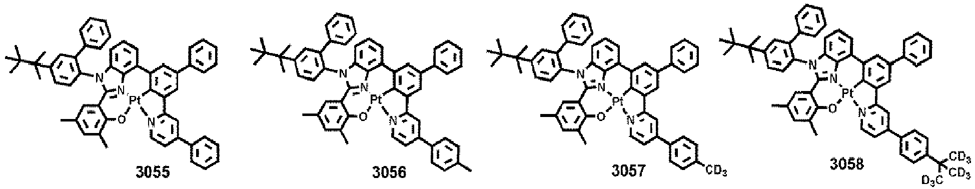 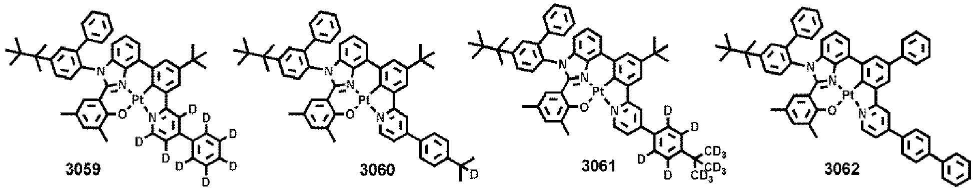 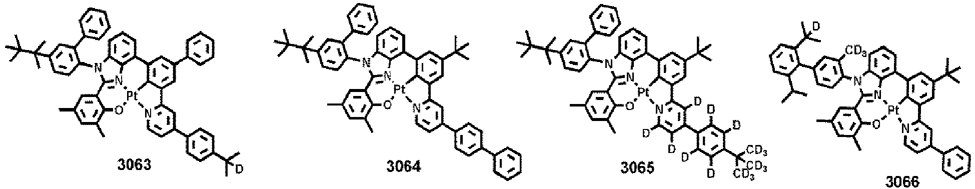 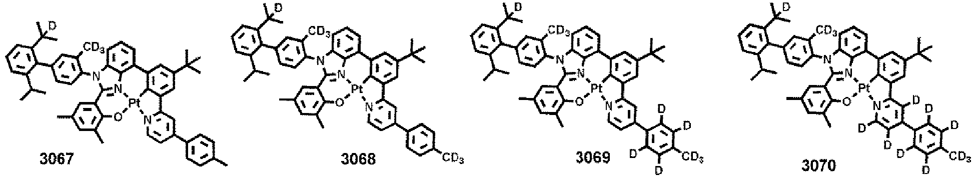 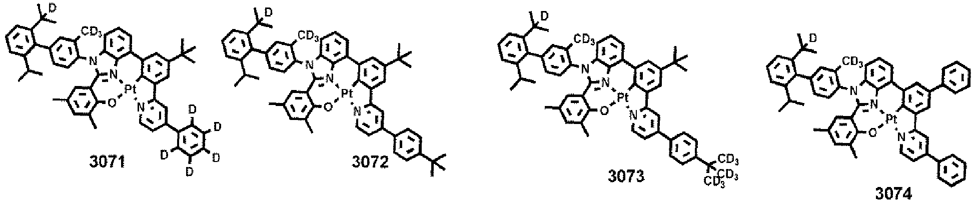 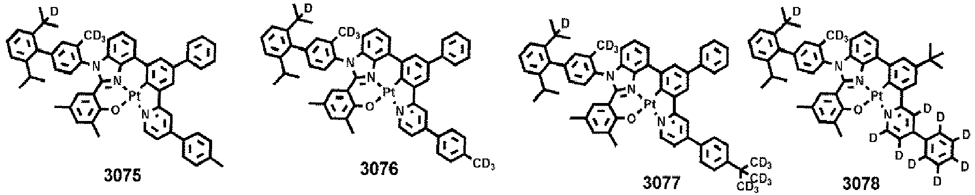 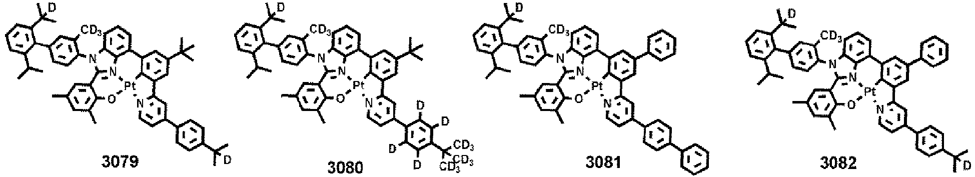 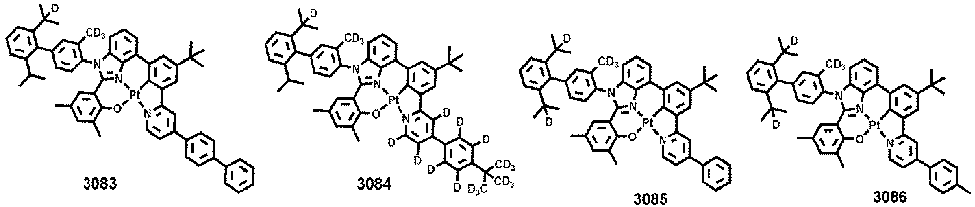 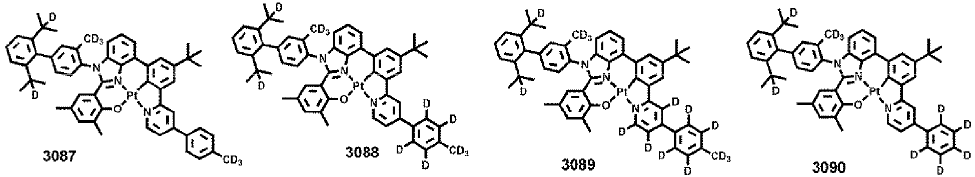 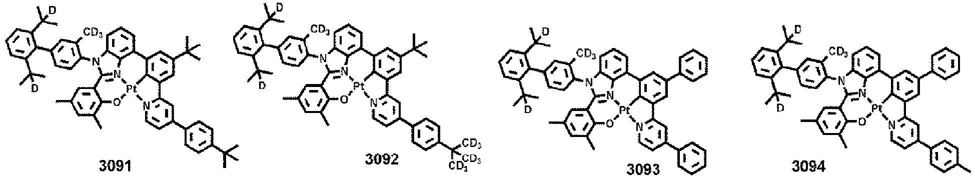 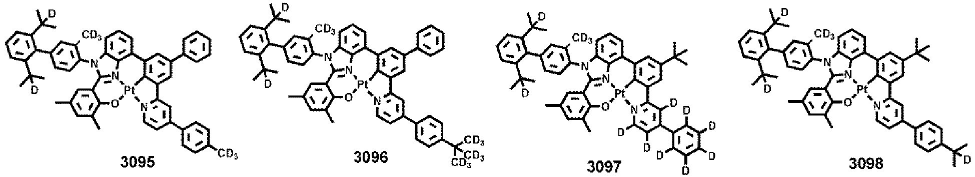 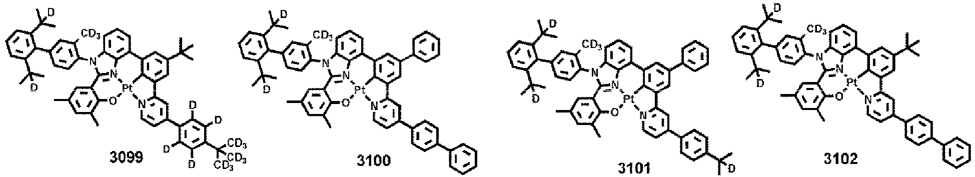 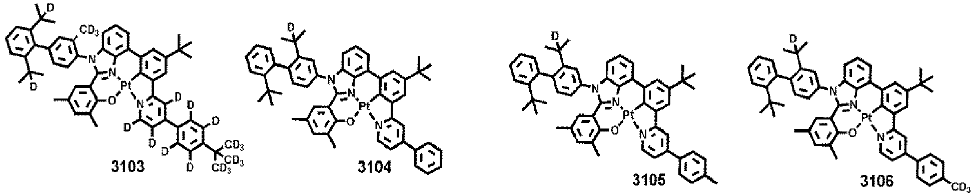 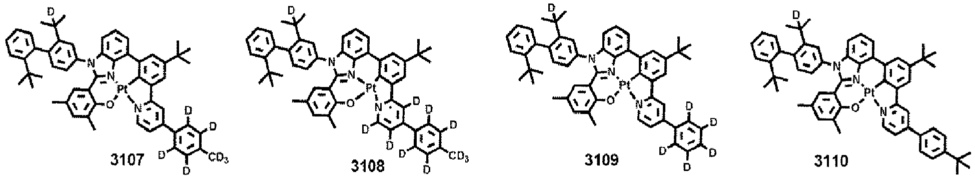 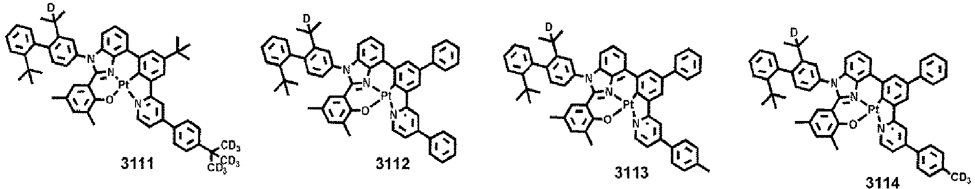 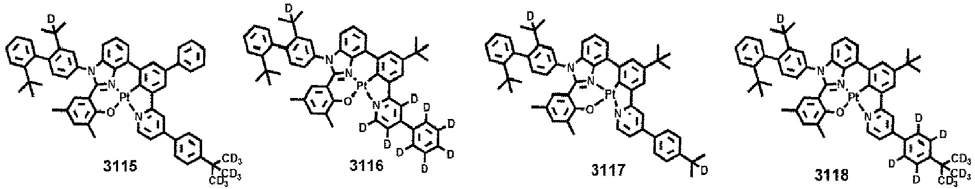 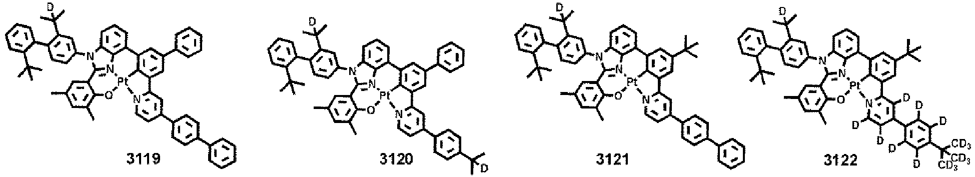 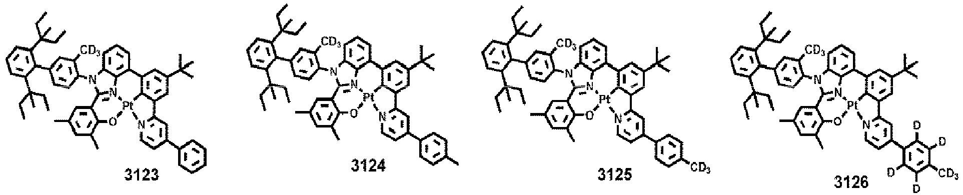 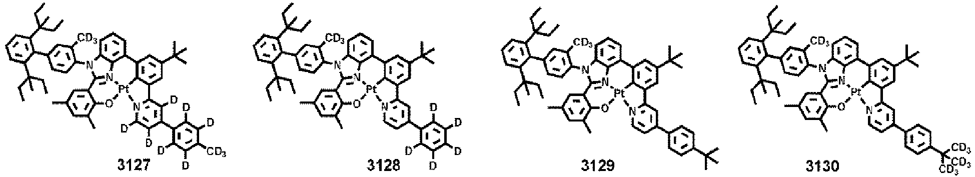 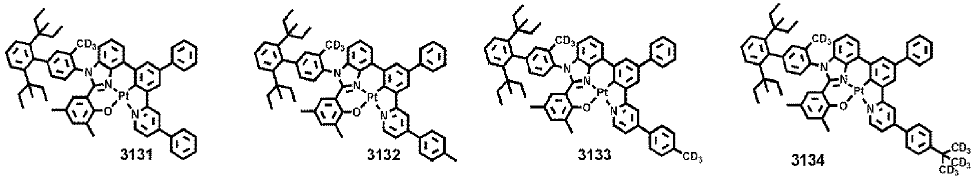 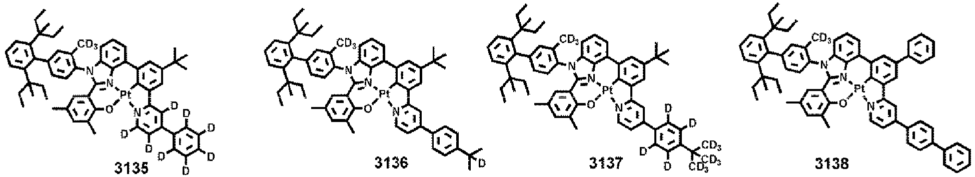 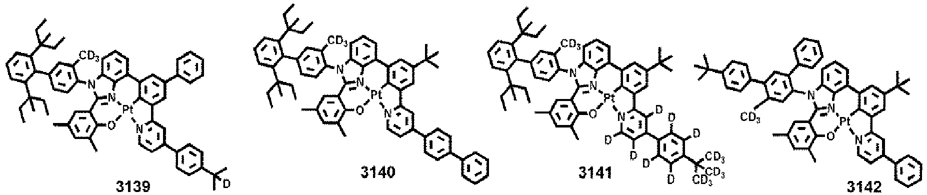 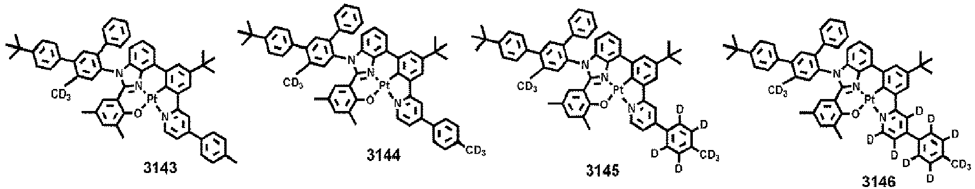 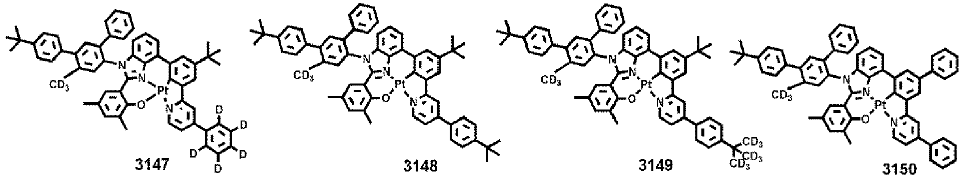 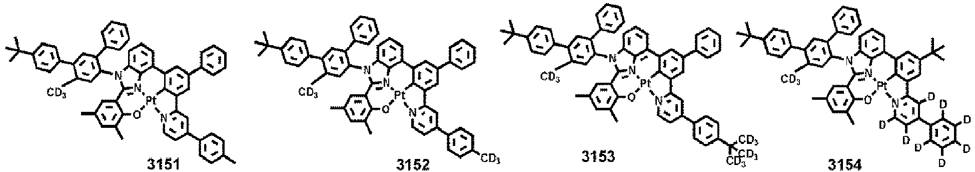 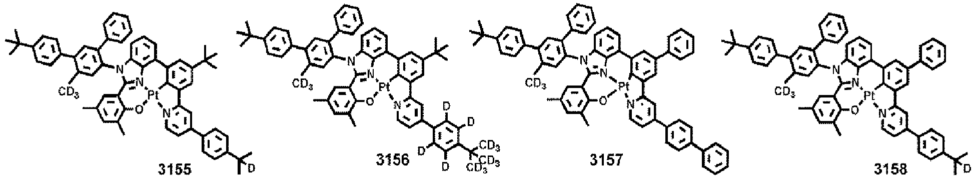 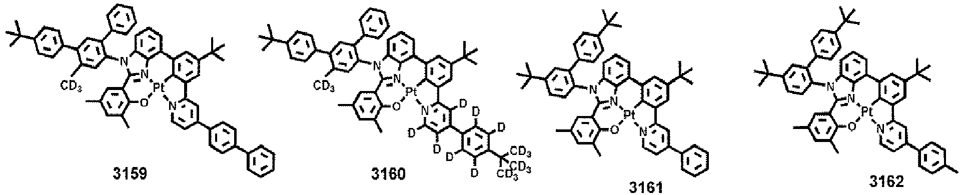 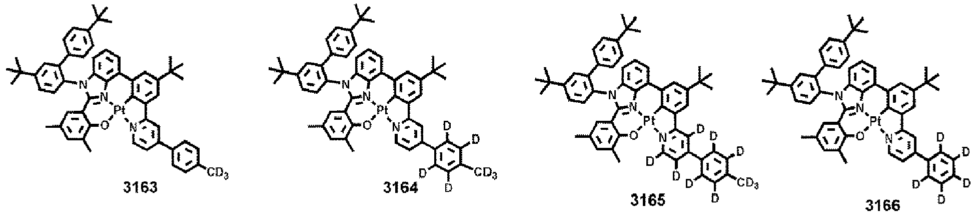 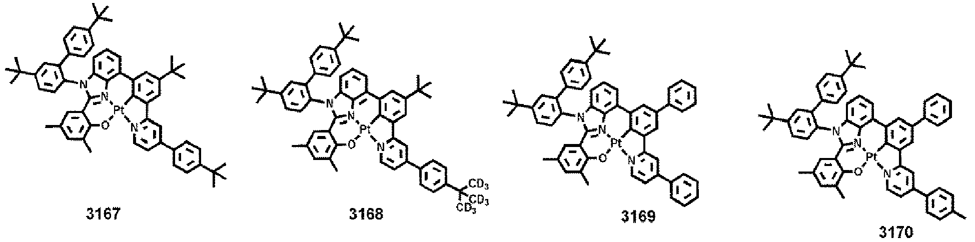 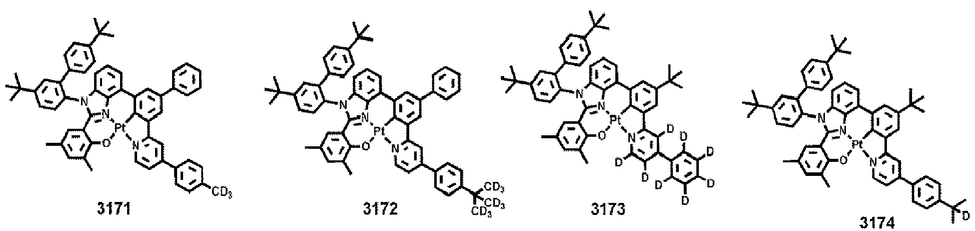 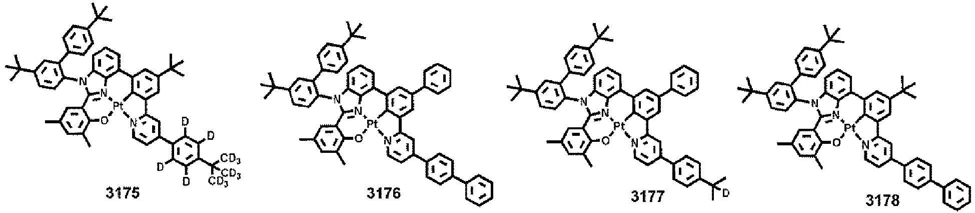 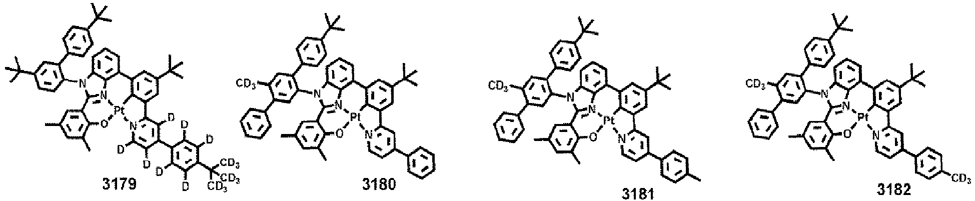 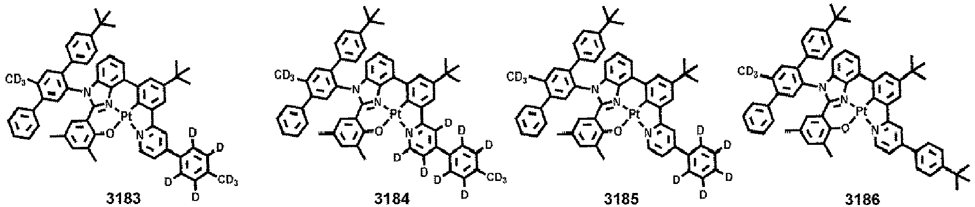 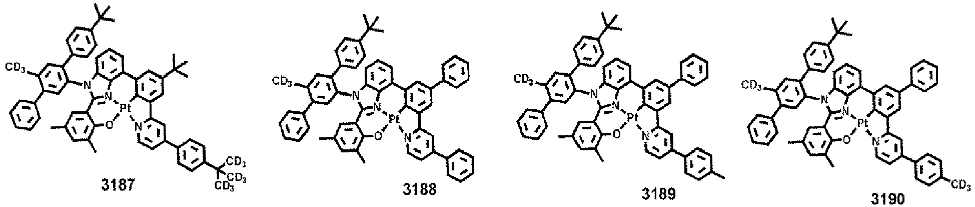 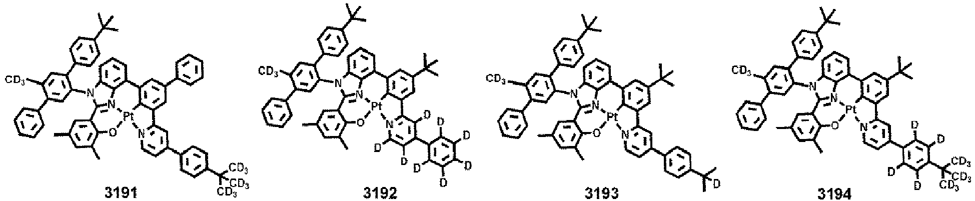 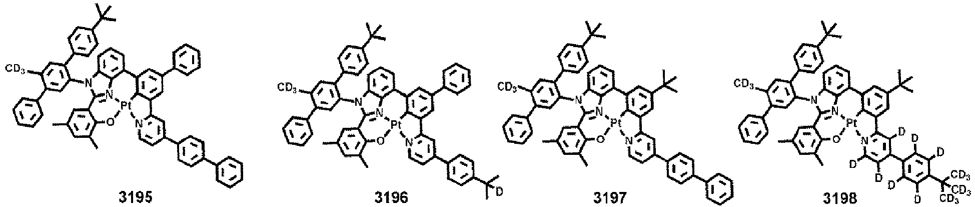 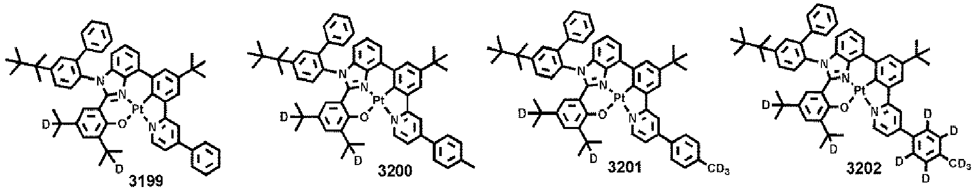 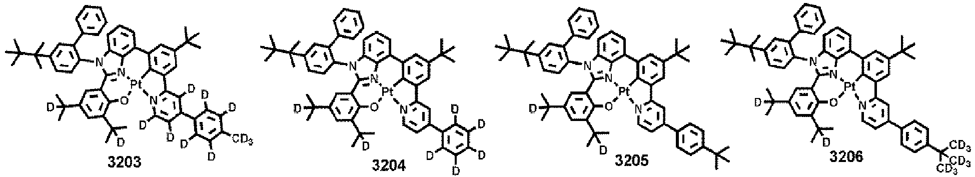 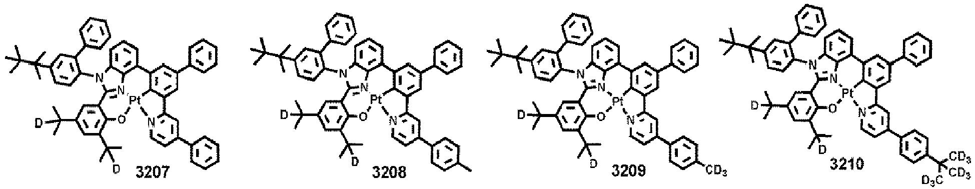 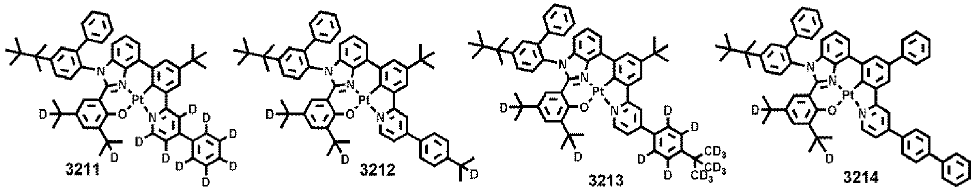 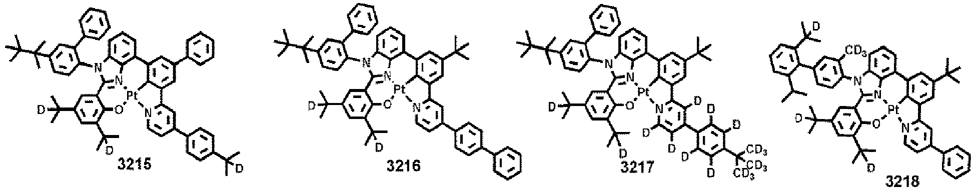 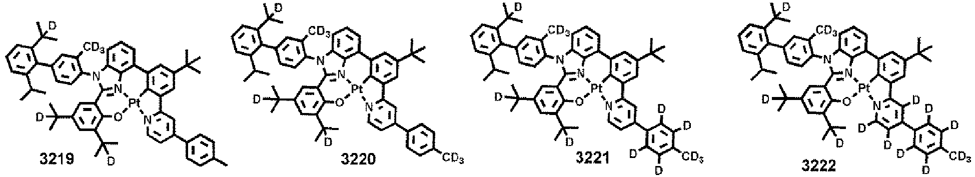 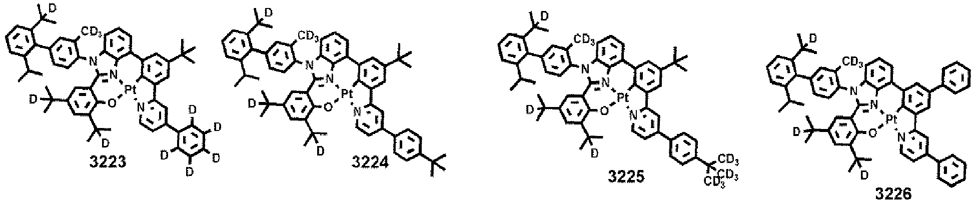 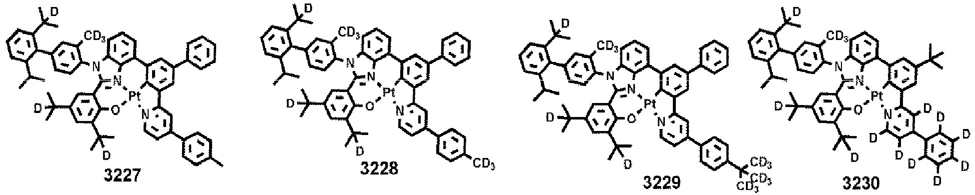 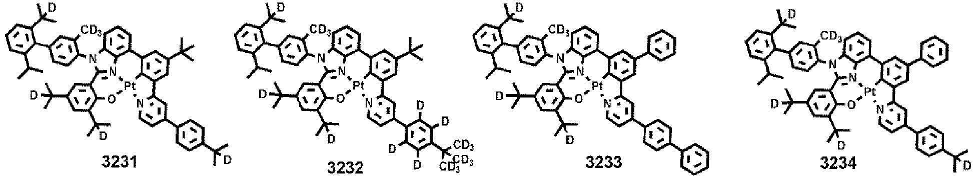 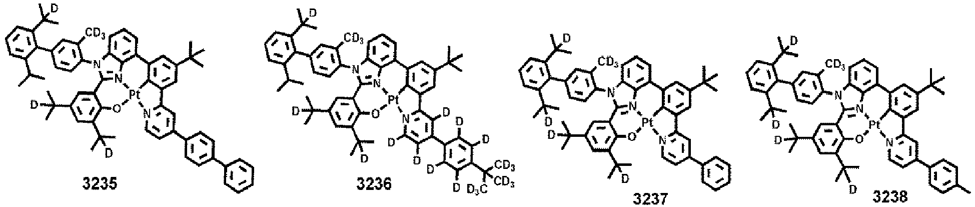 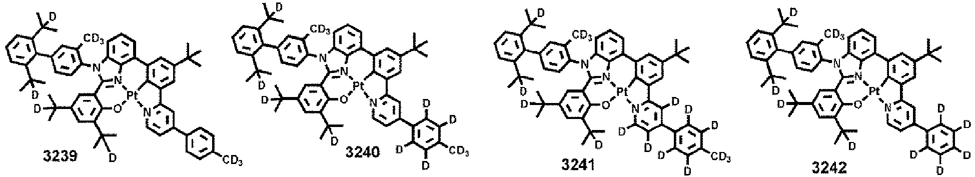 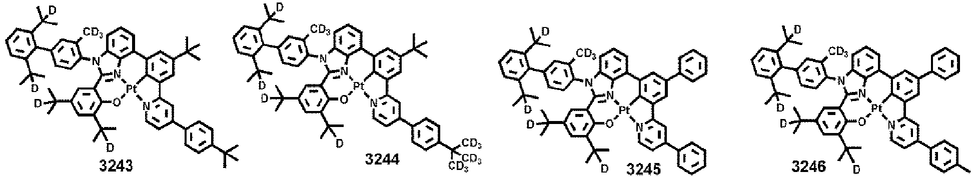 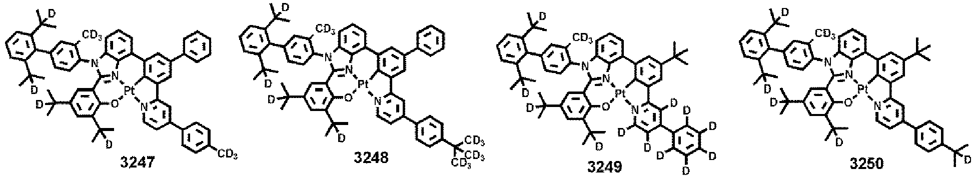 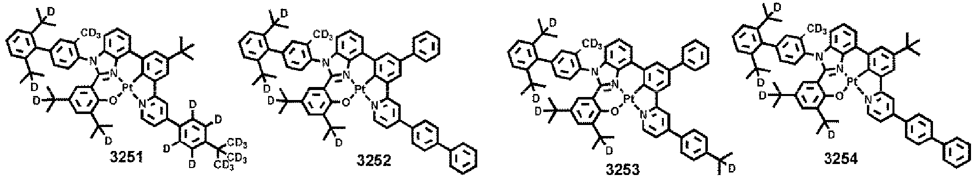 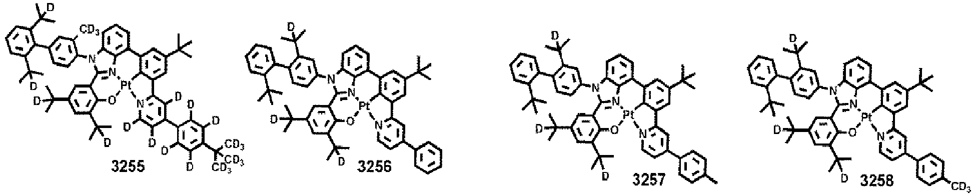 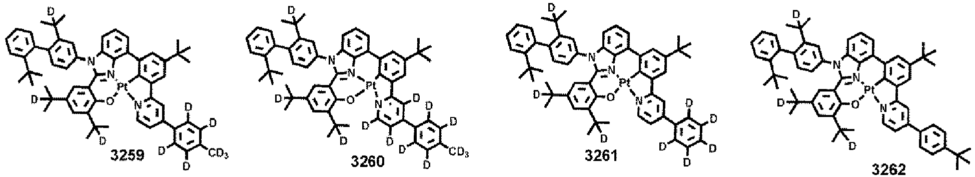 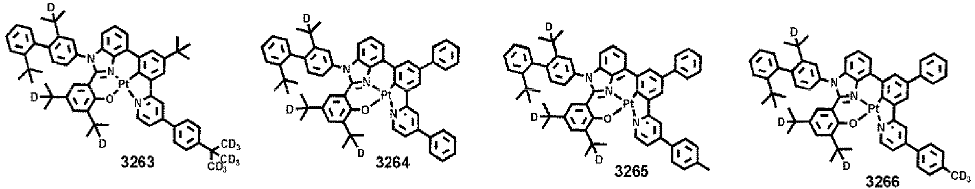 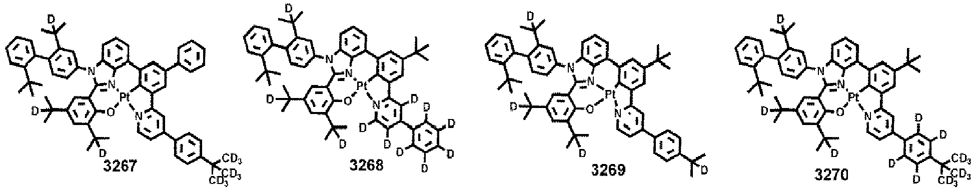 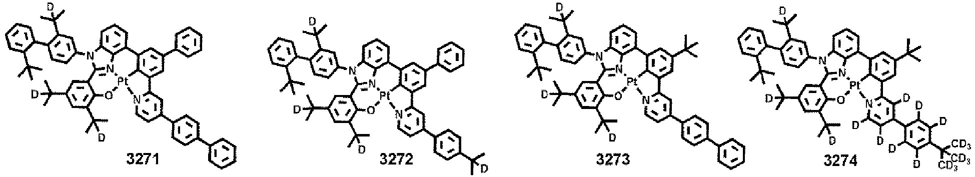 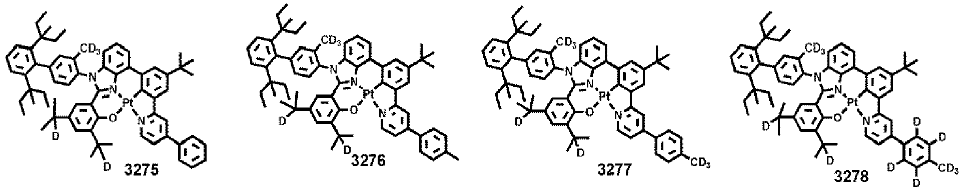 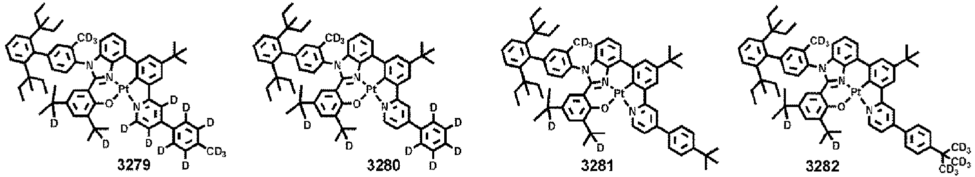 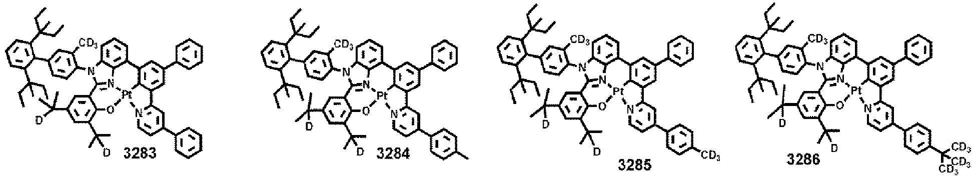 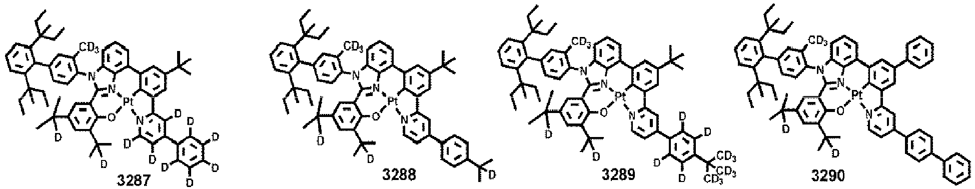 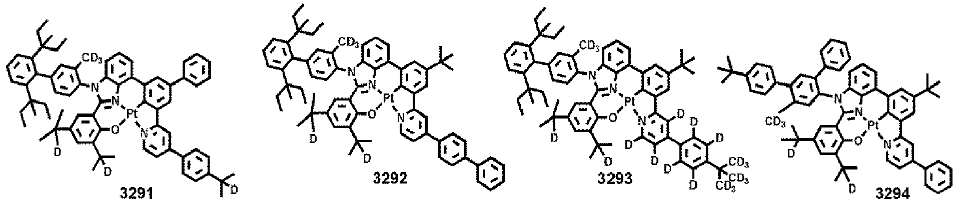 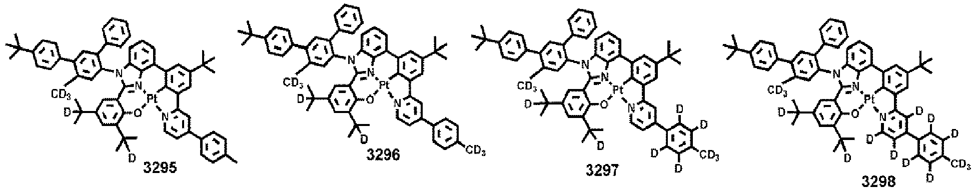 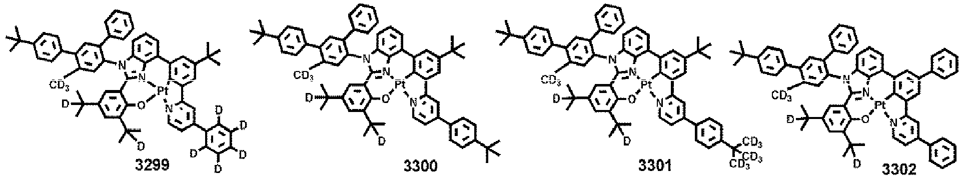 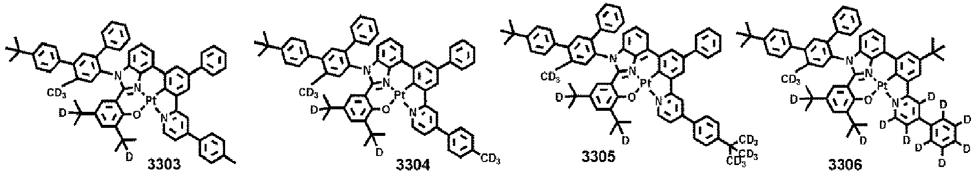 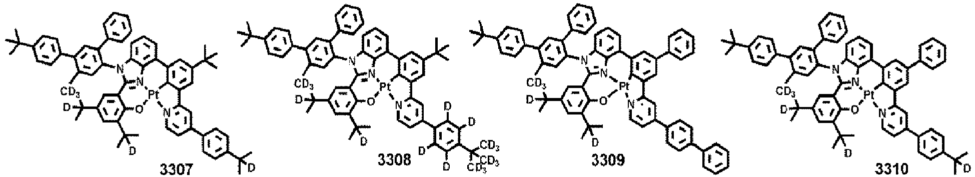 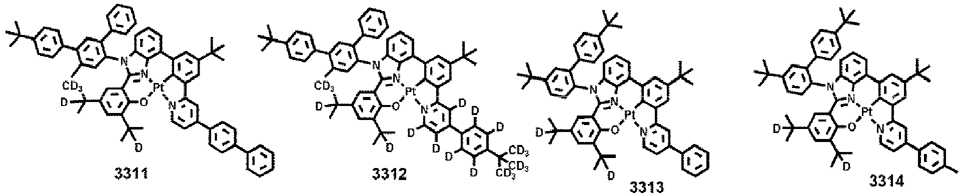 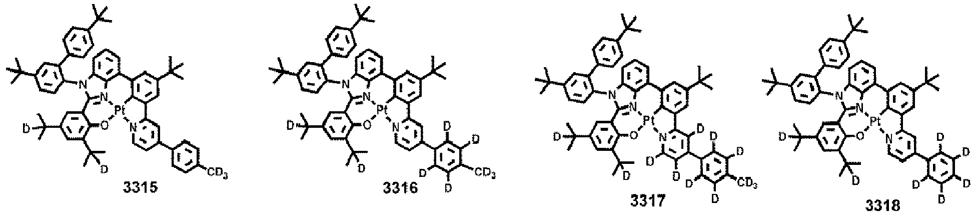 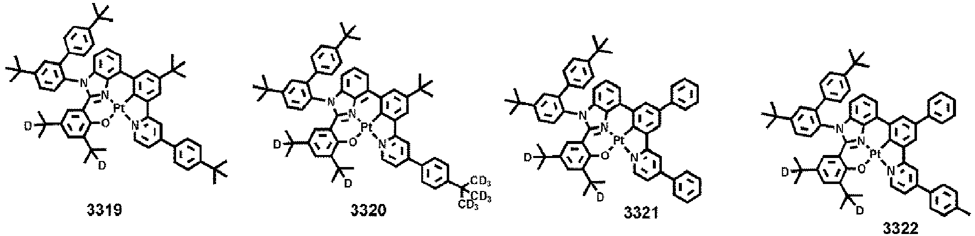 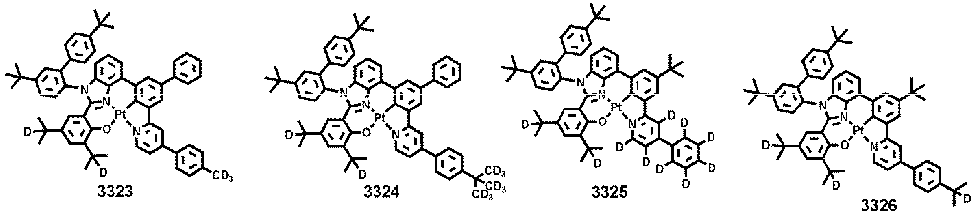 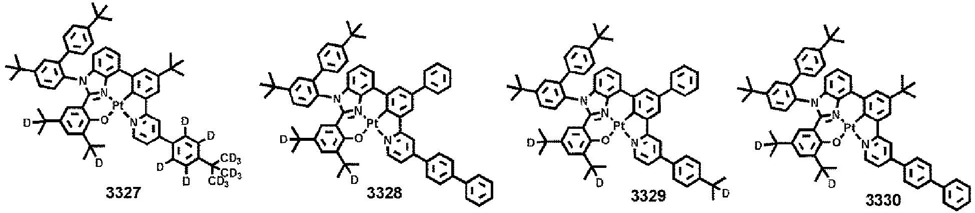 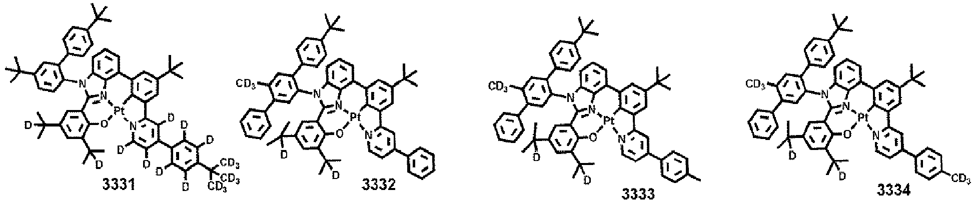 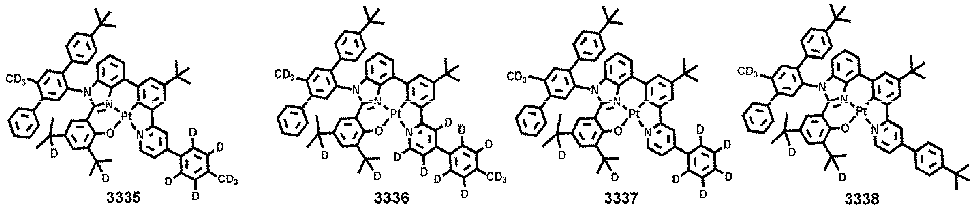 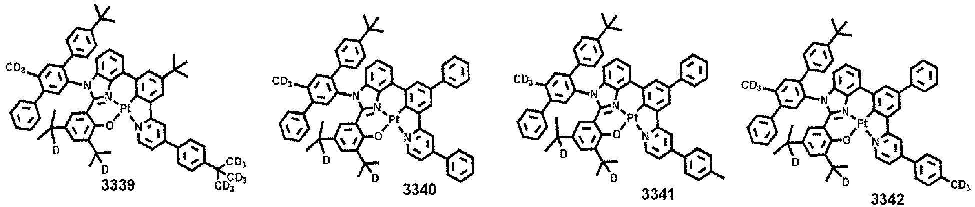 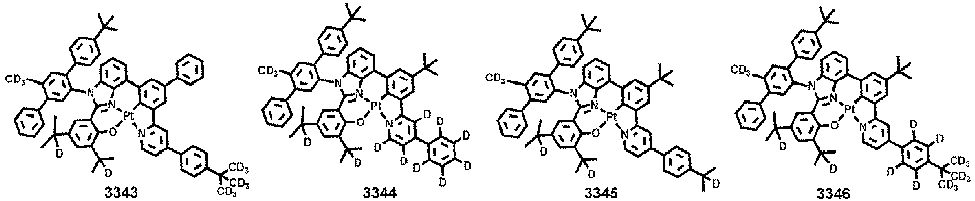 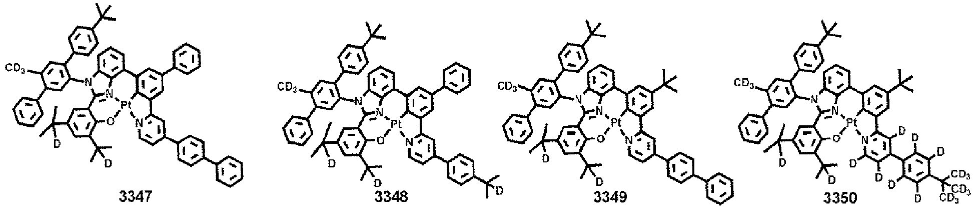 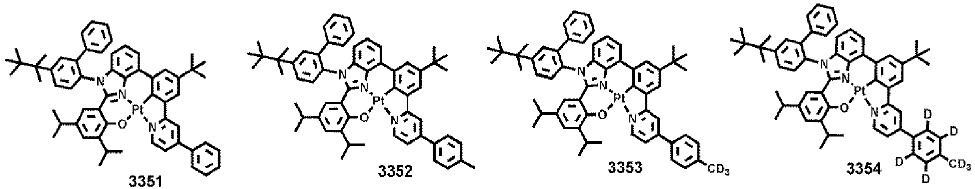 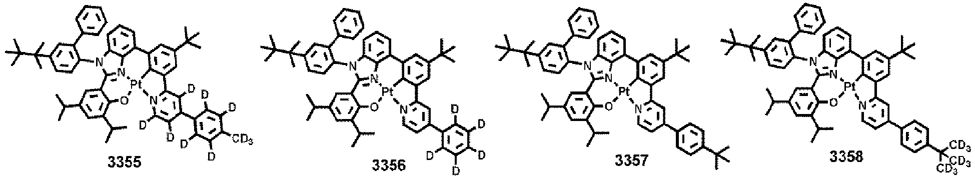 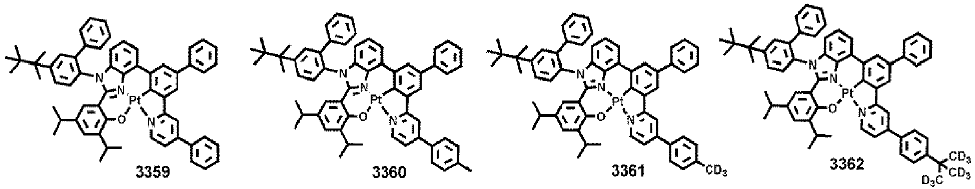 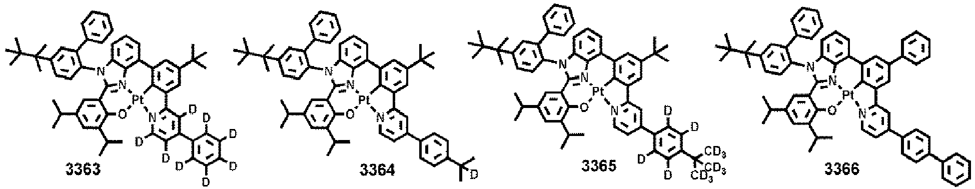 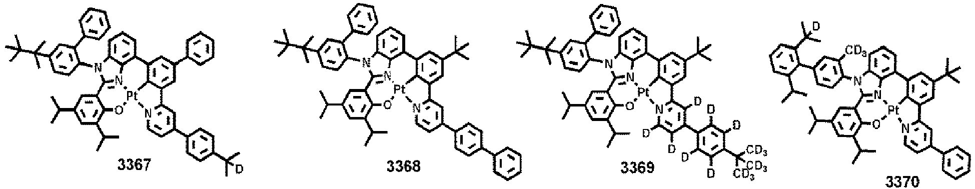 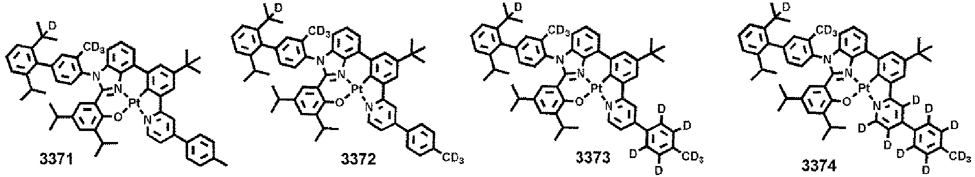 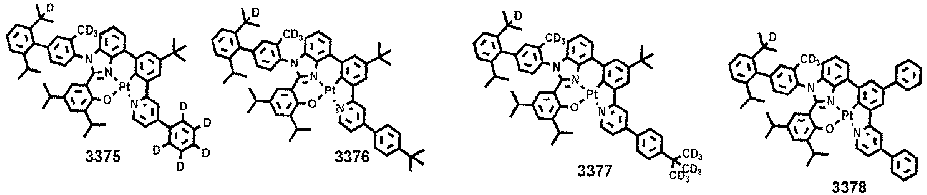 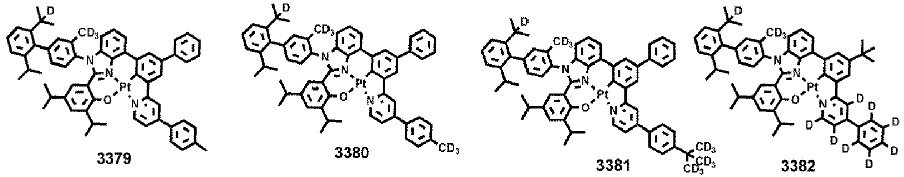 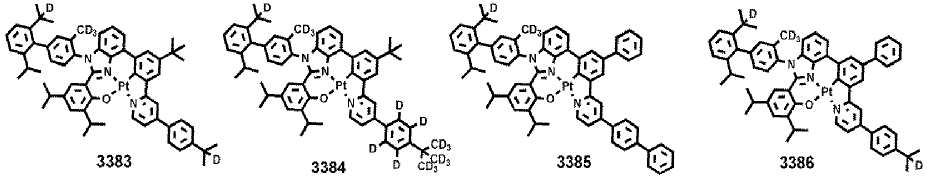 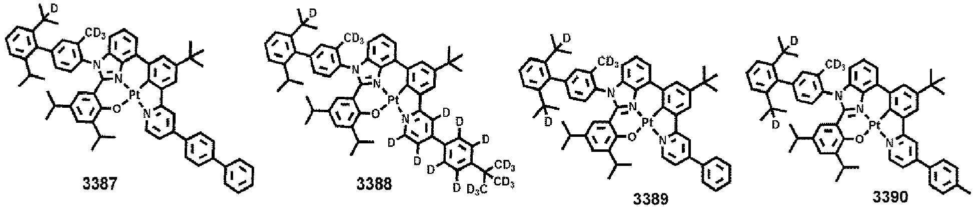 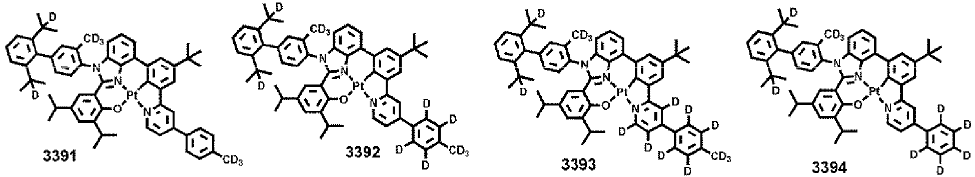 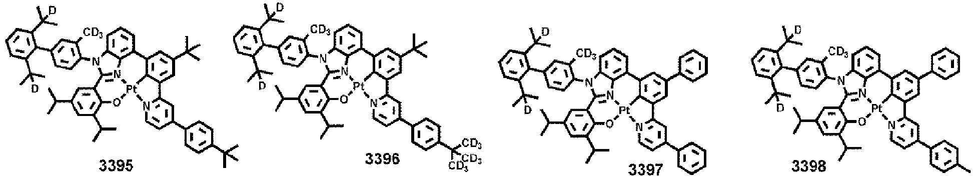 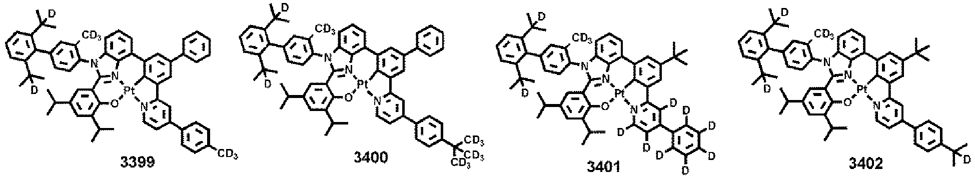 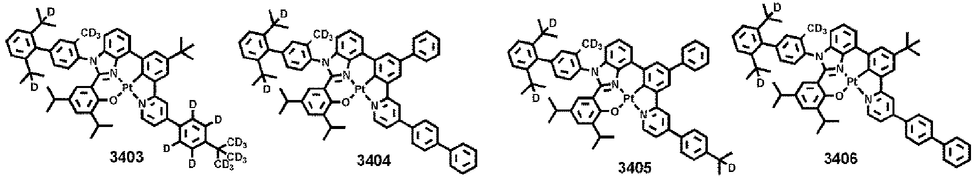 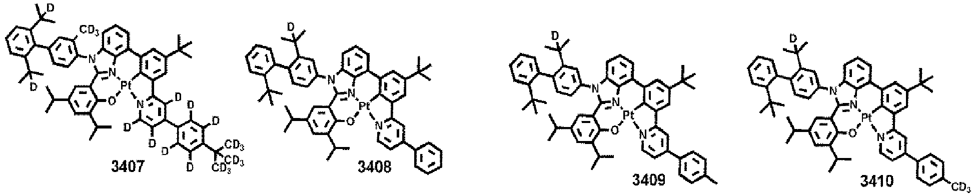 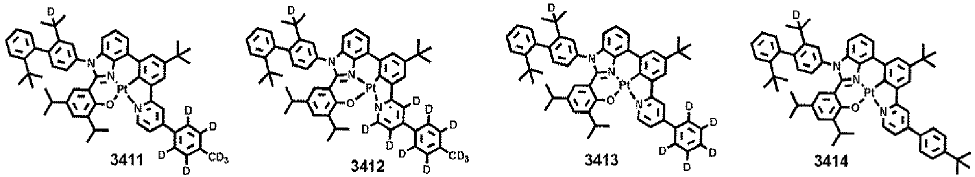 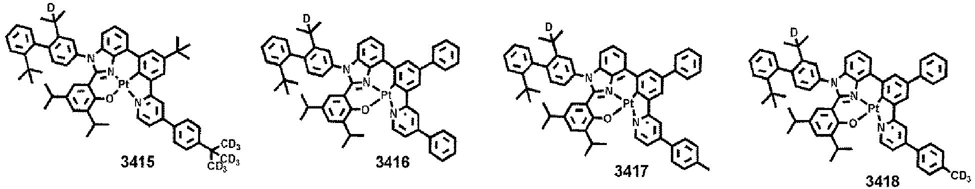 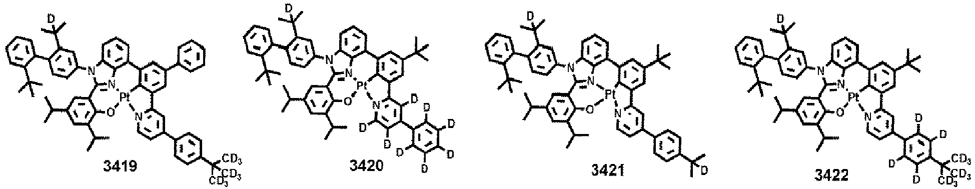 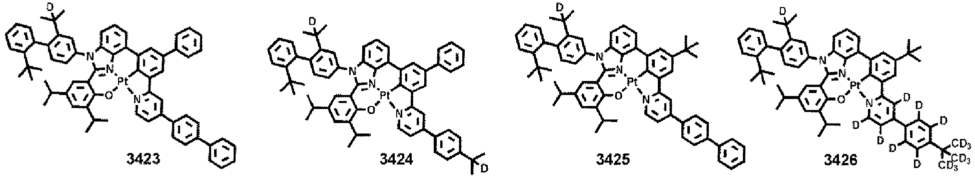 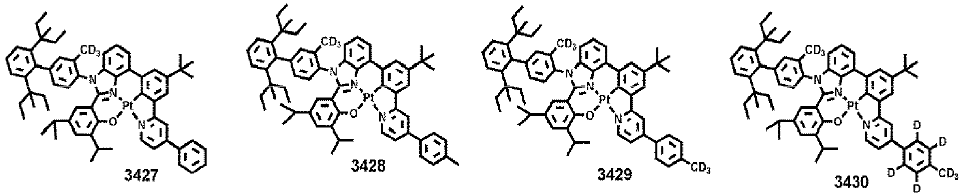 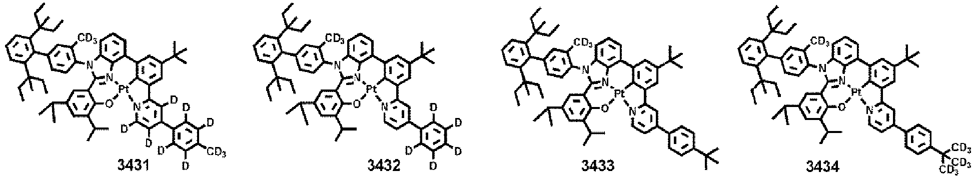 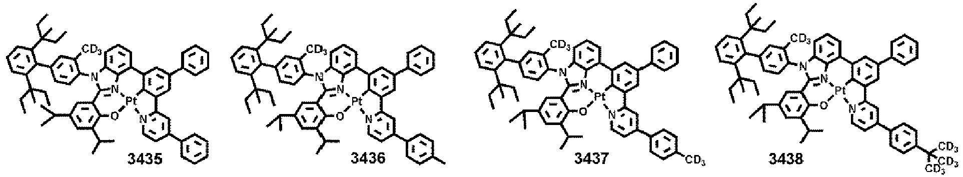 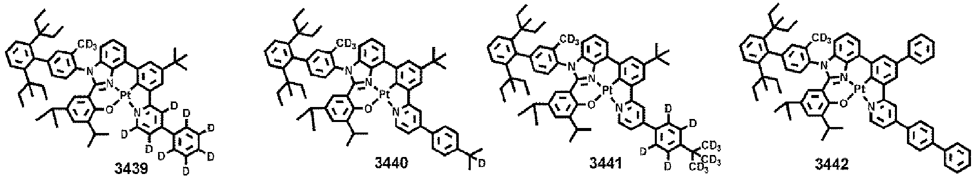 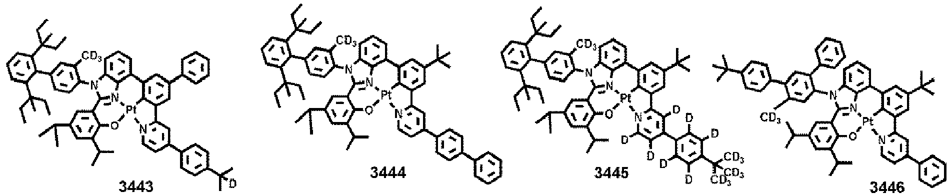 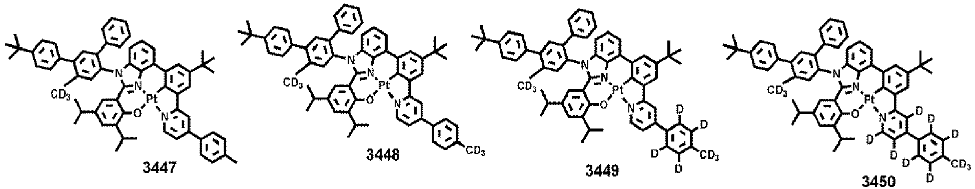 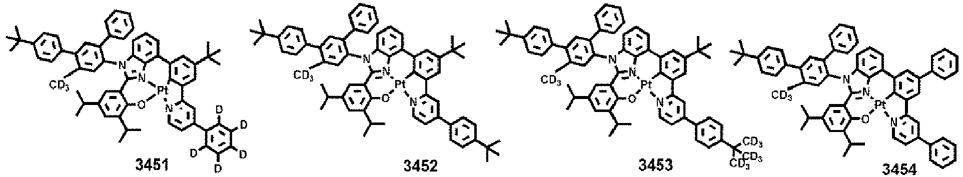 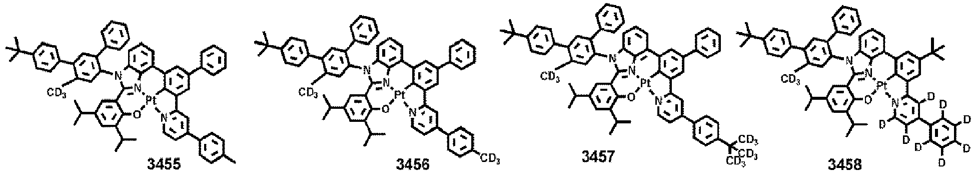 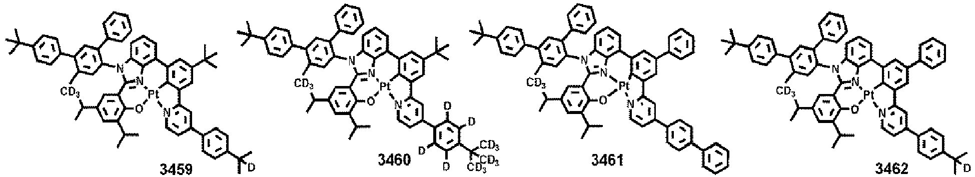 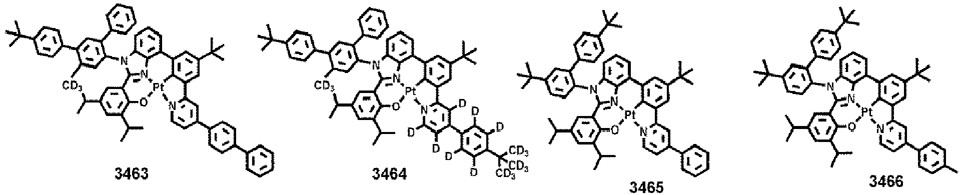 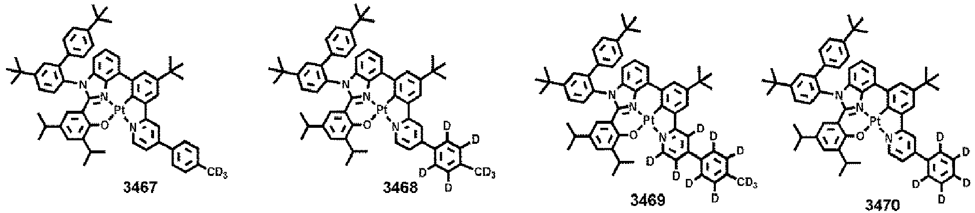 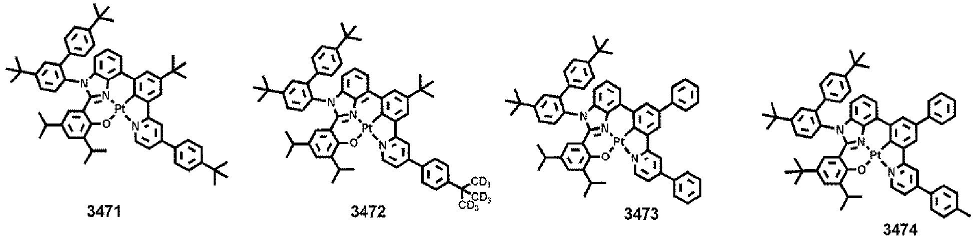 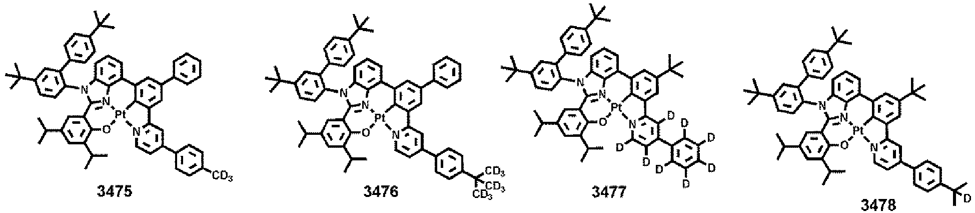 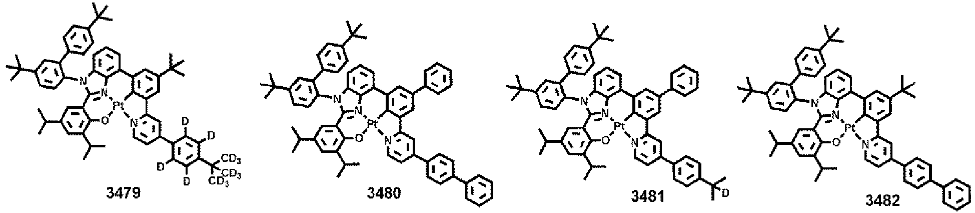 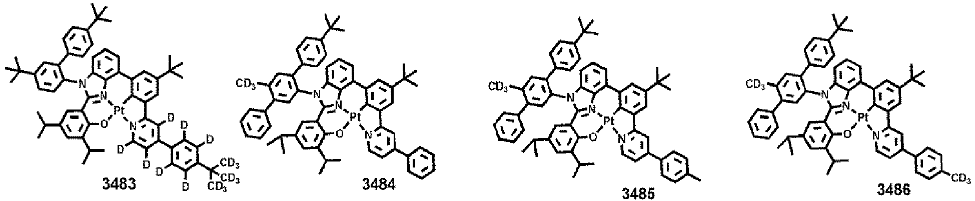 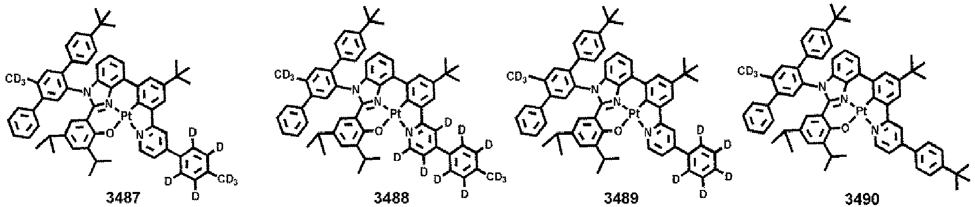 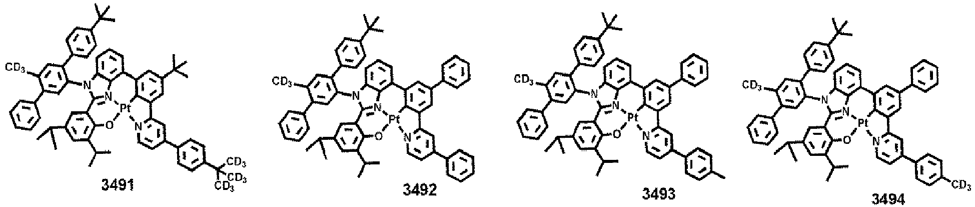 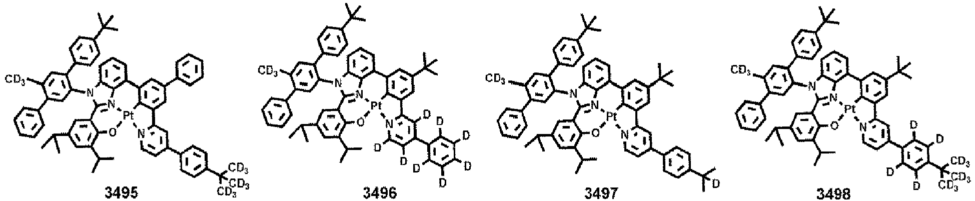 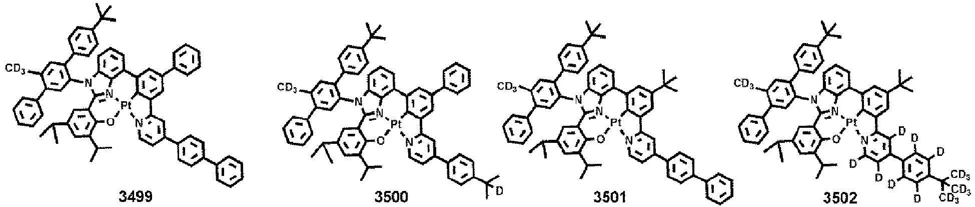 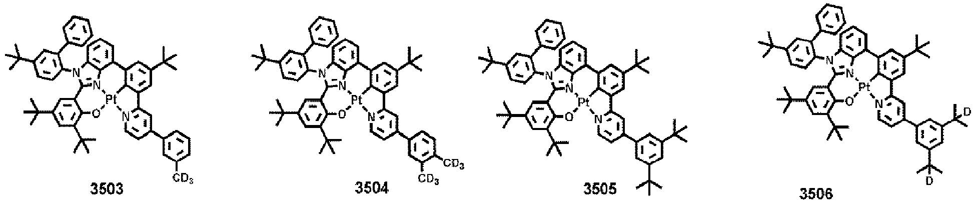 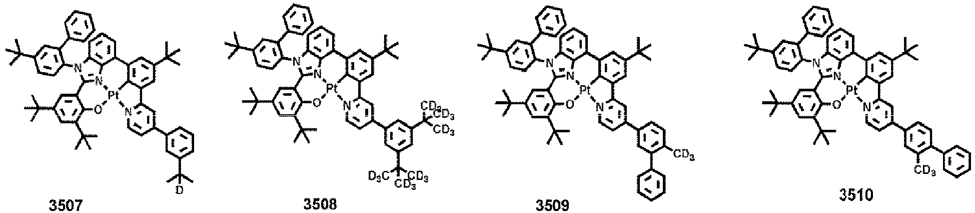 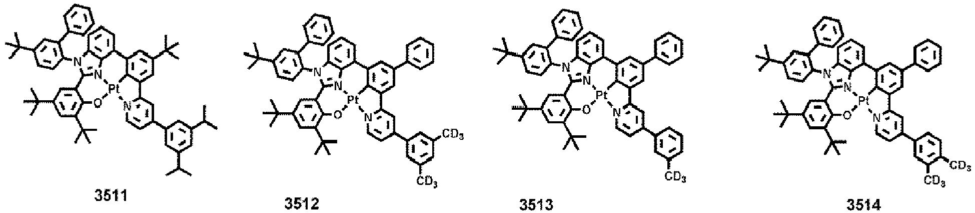 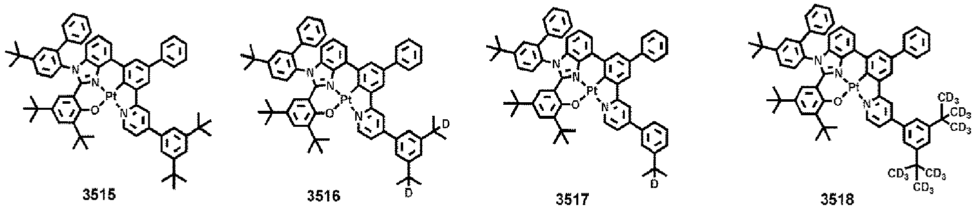 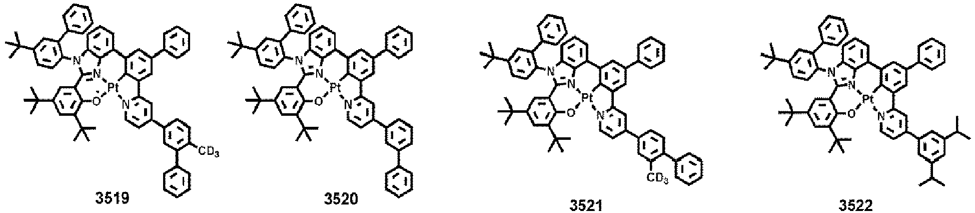 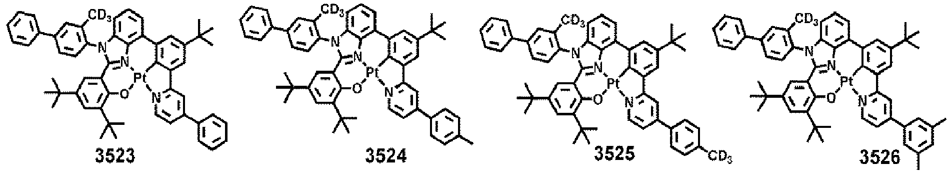 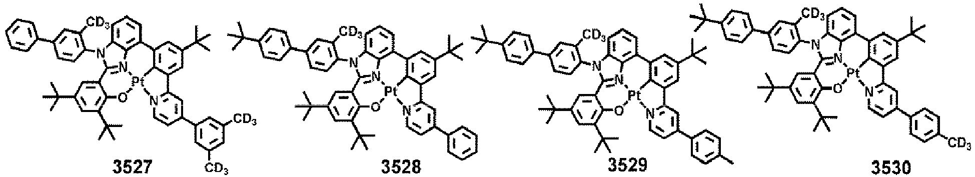 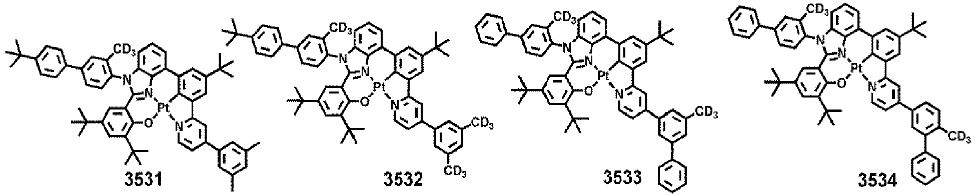 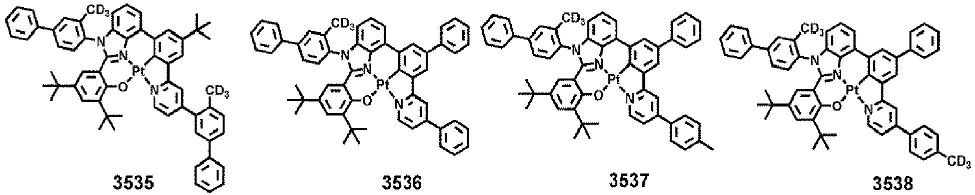 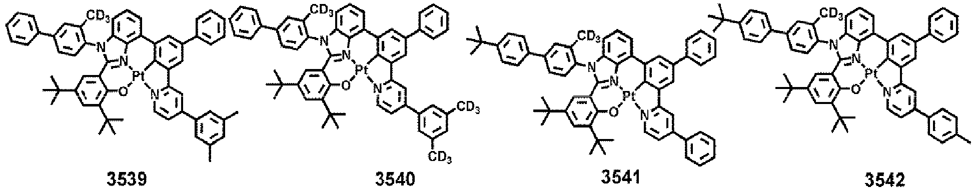 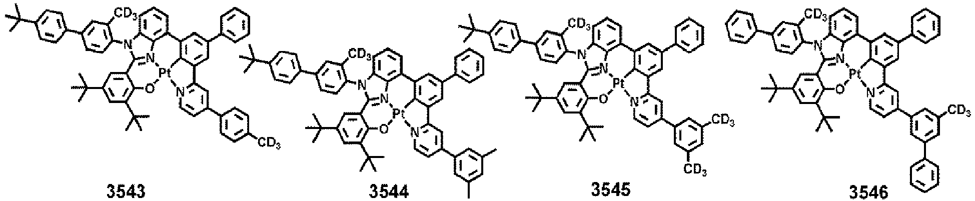 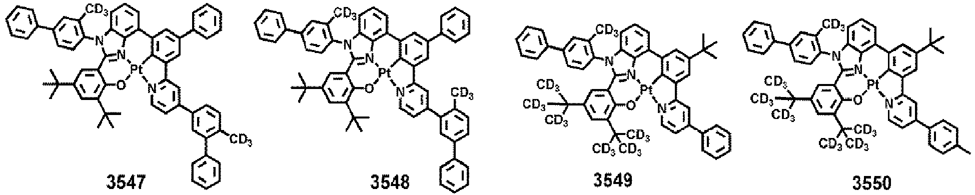 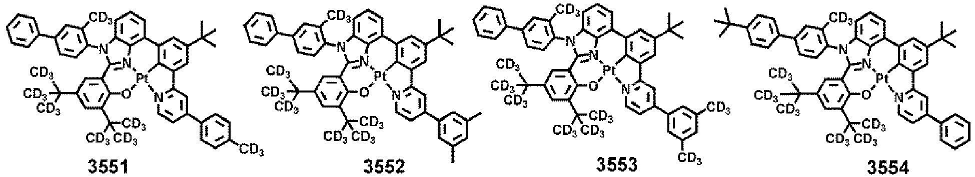 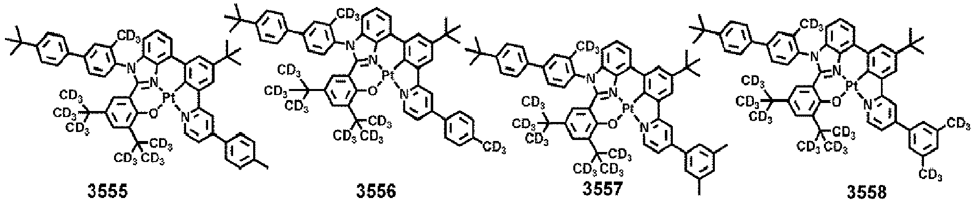 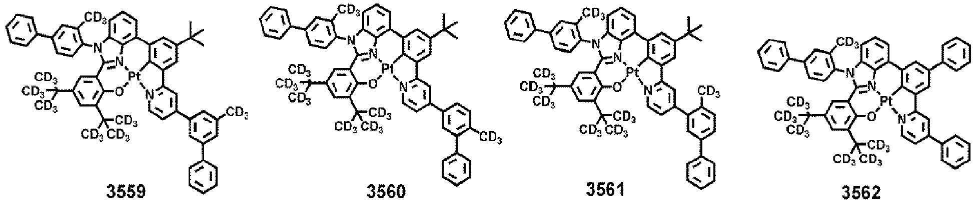 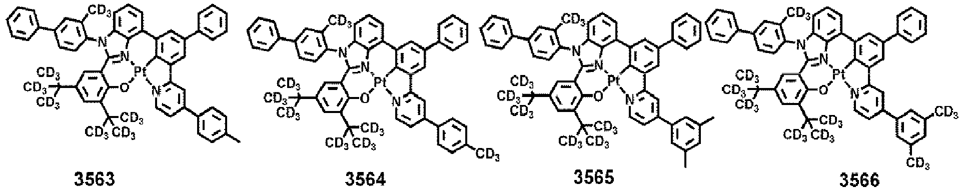 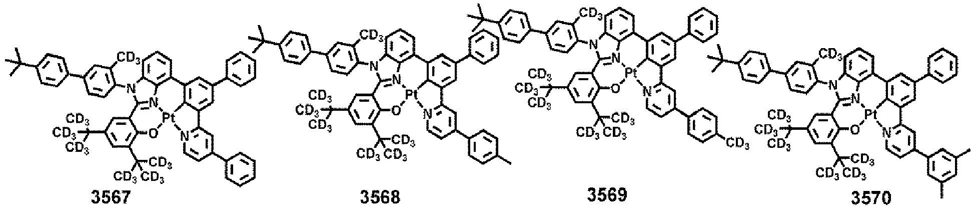 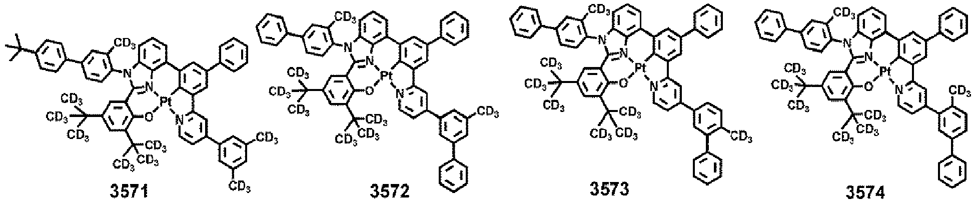 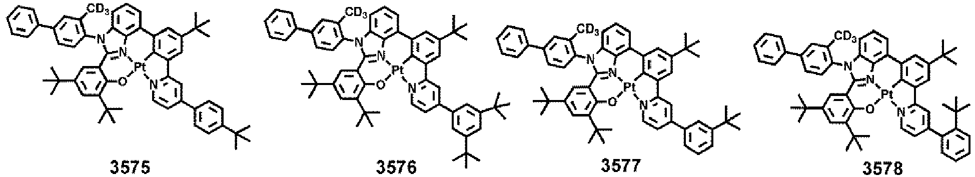 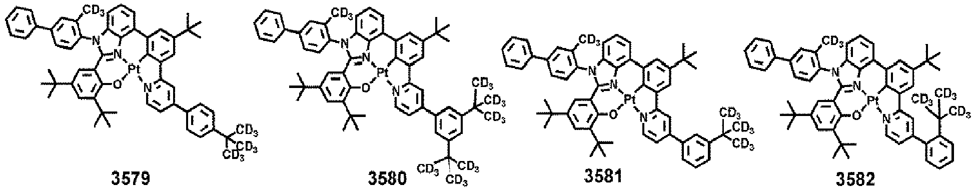 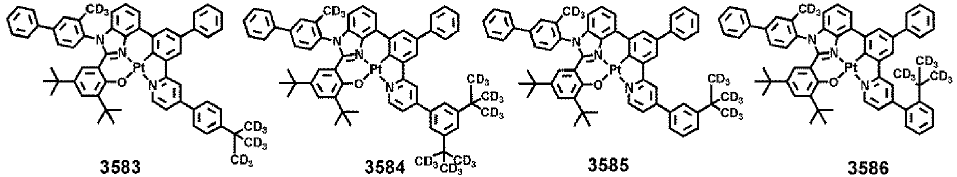 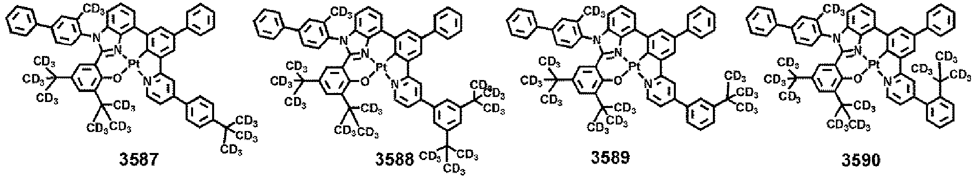 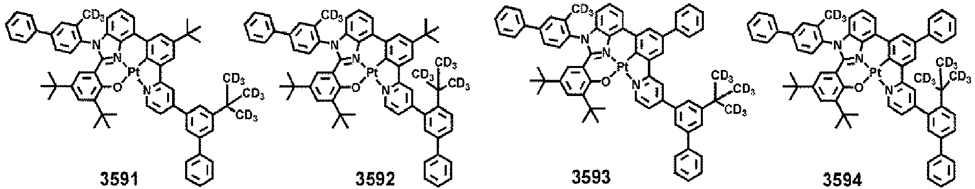 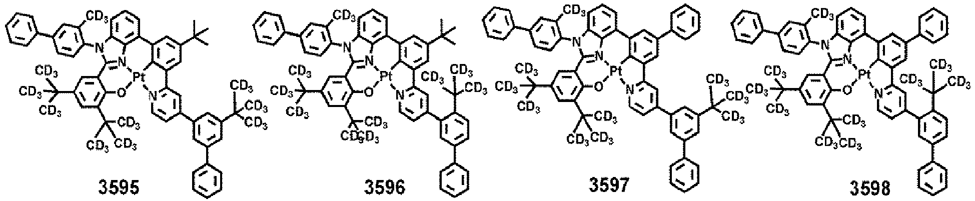 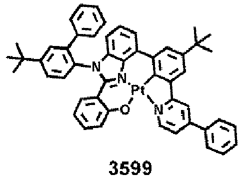
Group 1-3 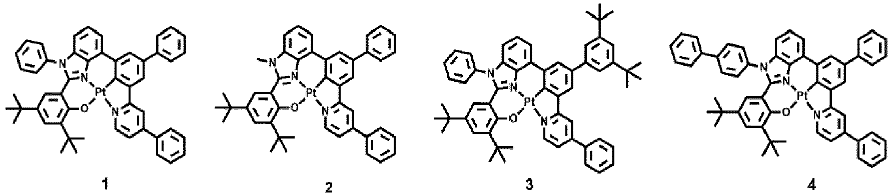 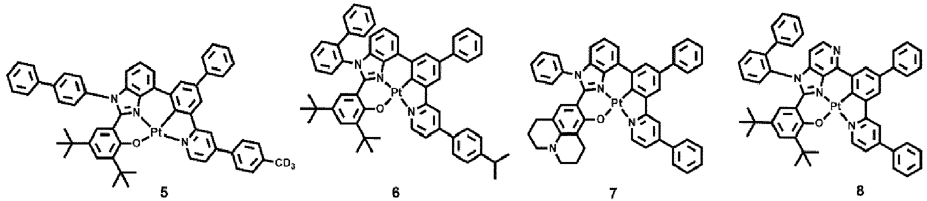 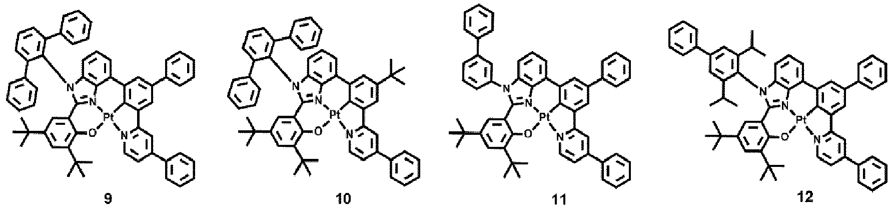 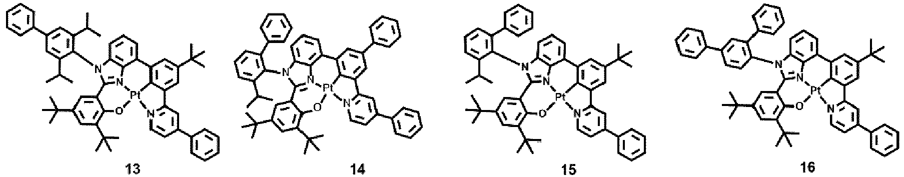 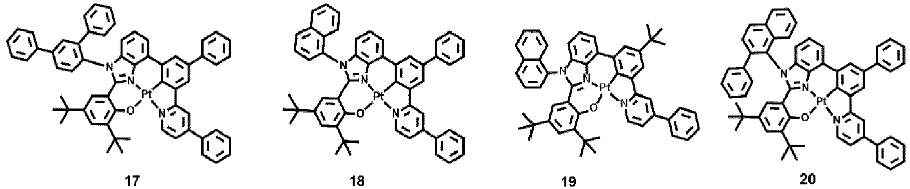 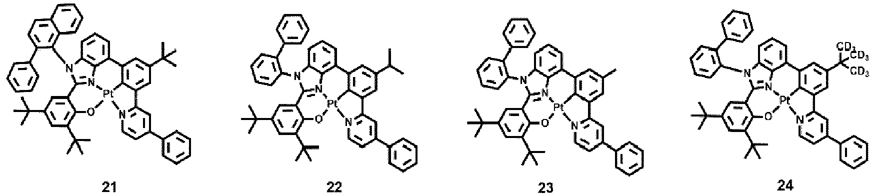 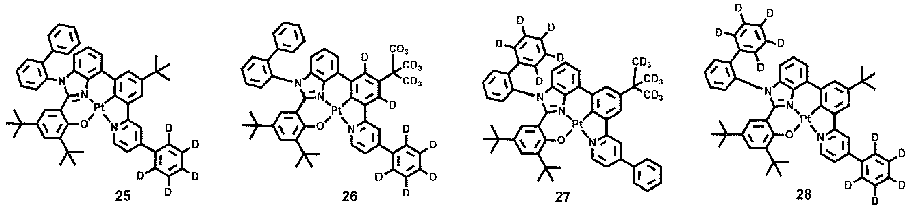 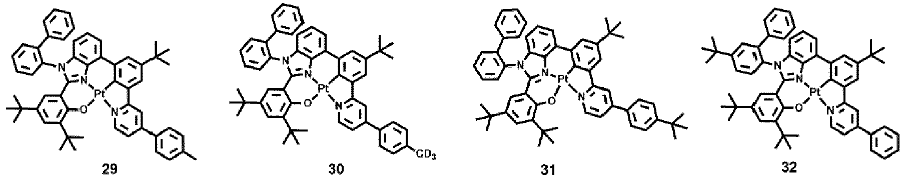 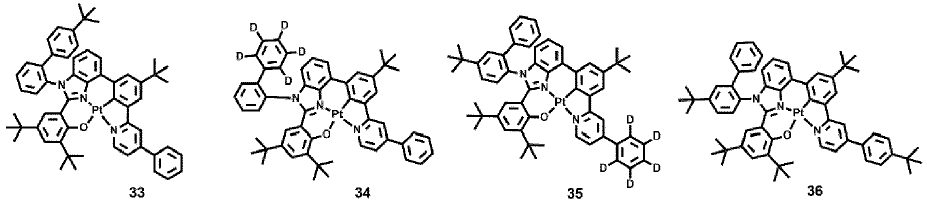 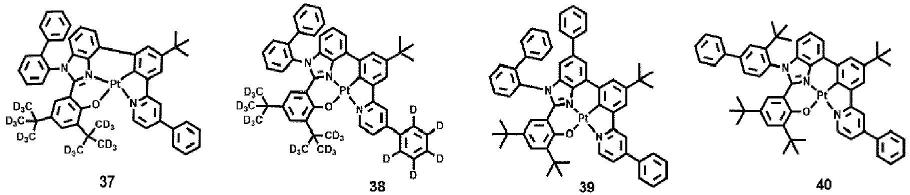 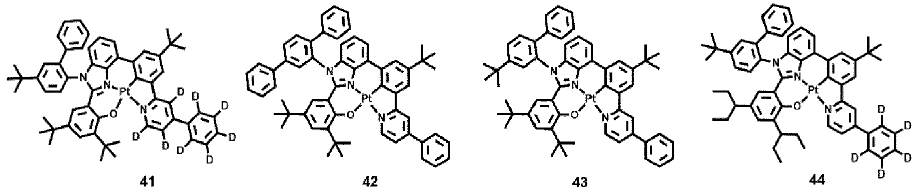 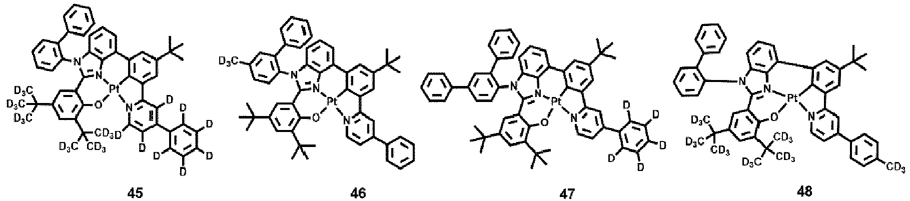 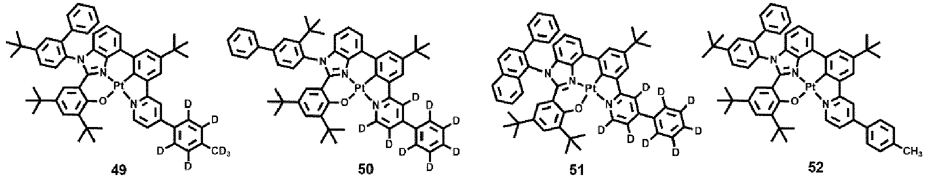 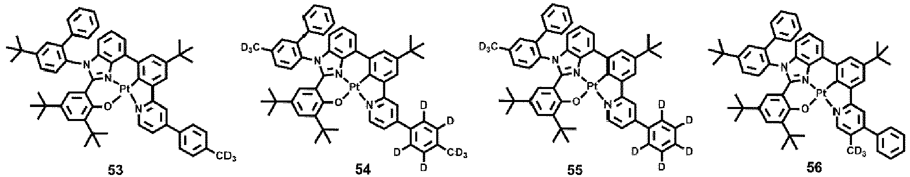 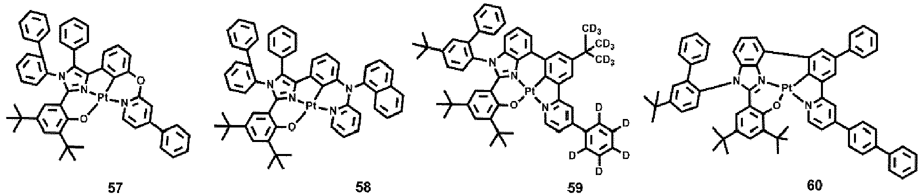 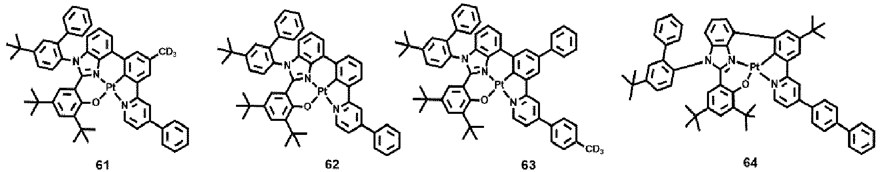 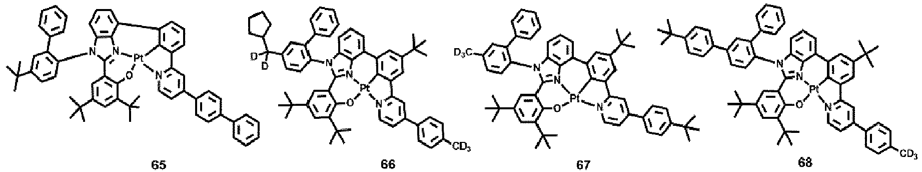 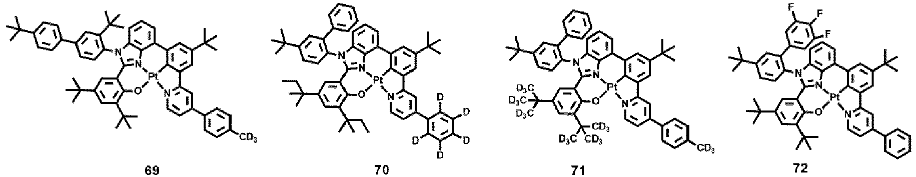 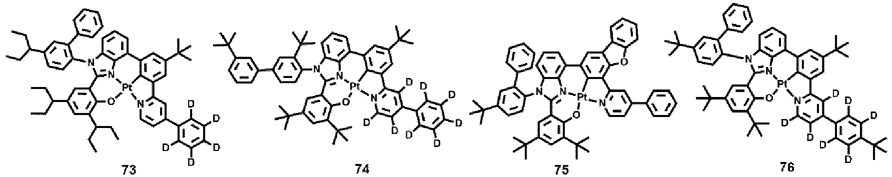 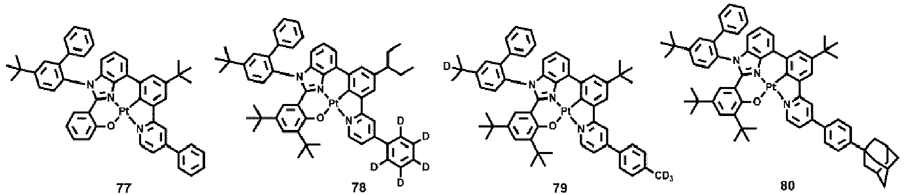 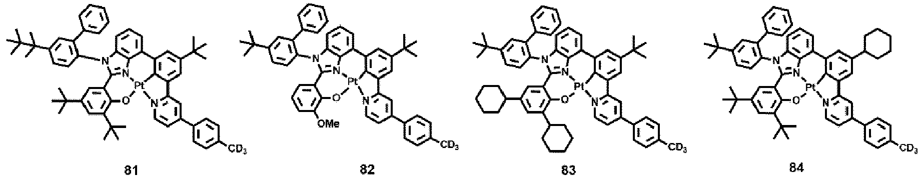 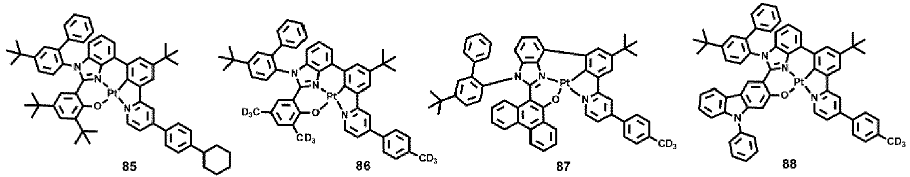 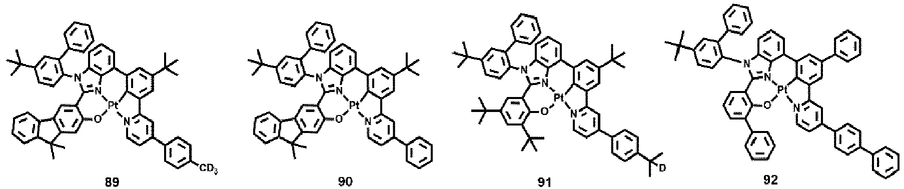 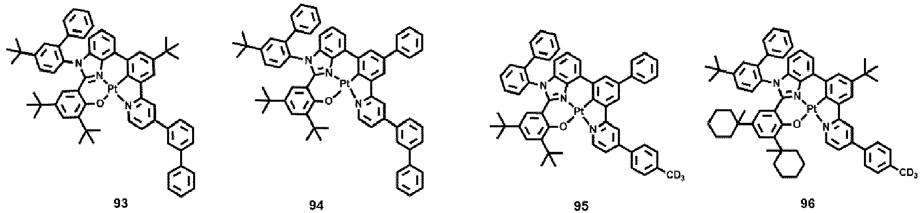 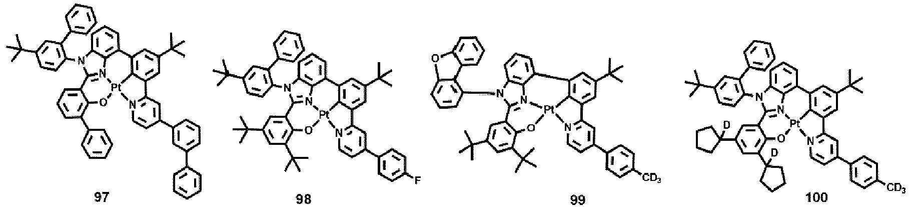 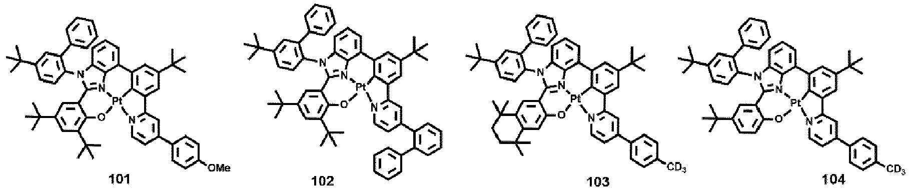 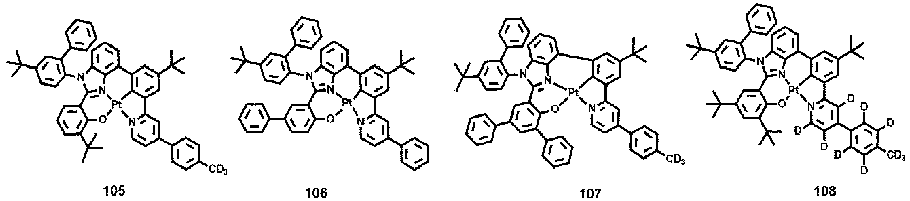 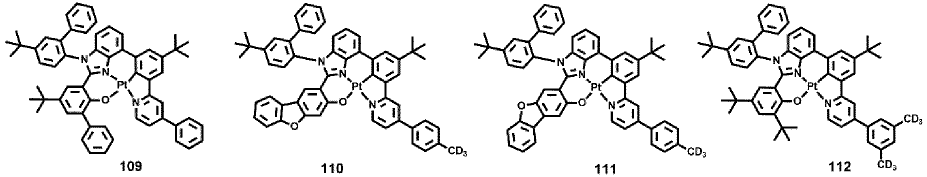 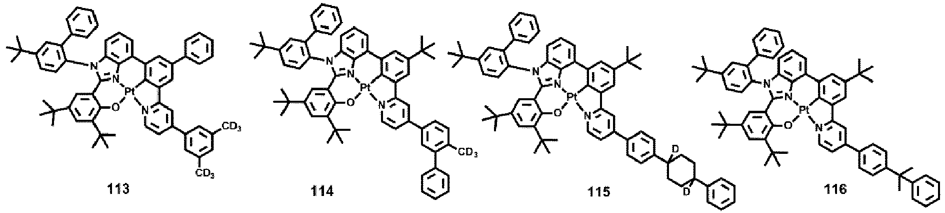 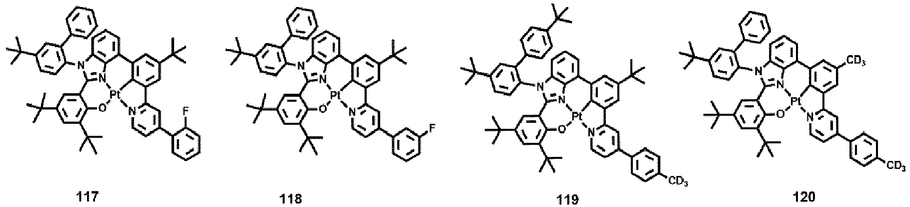 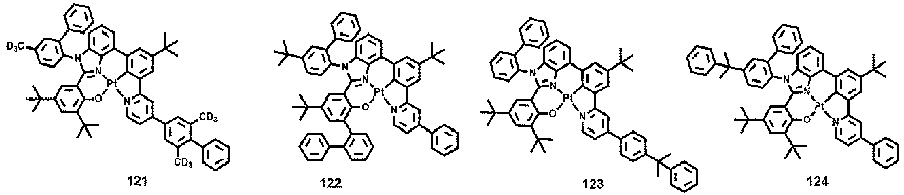 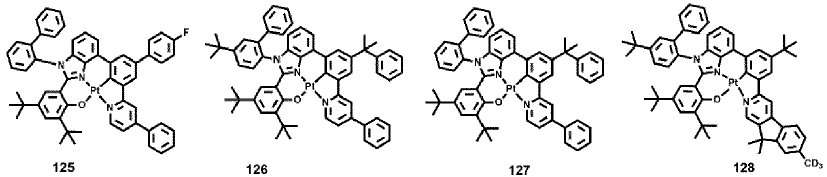 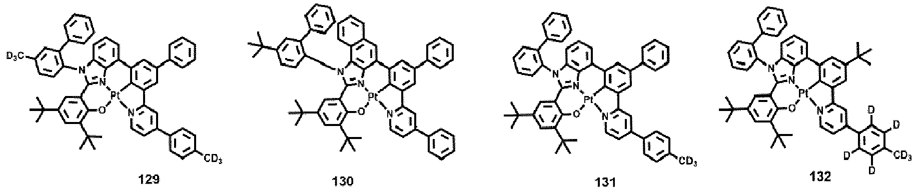
Group 1-4 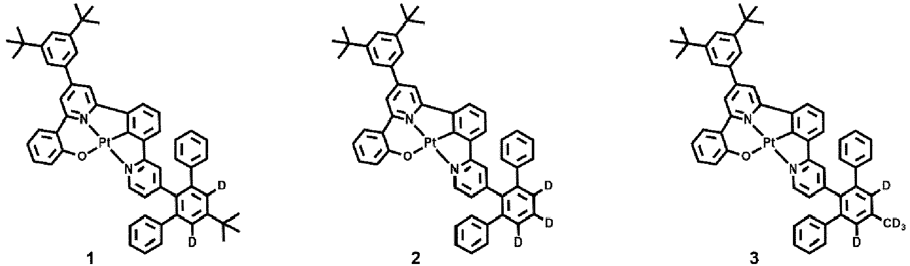
Group 2-1 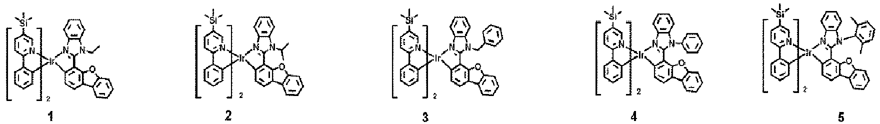 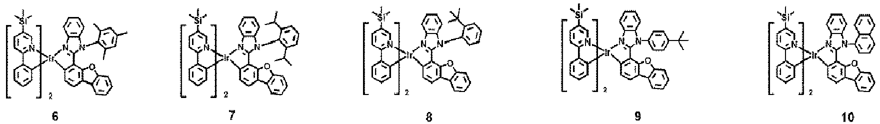 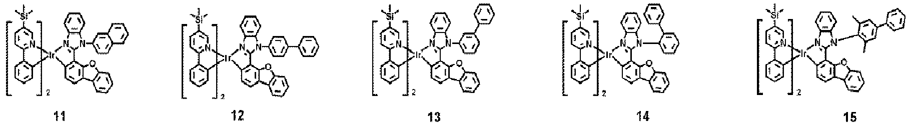 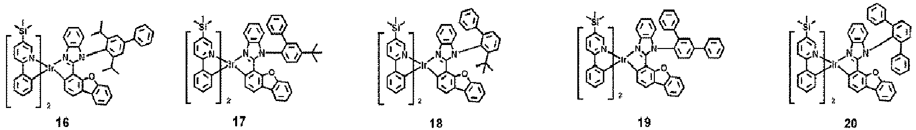 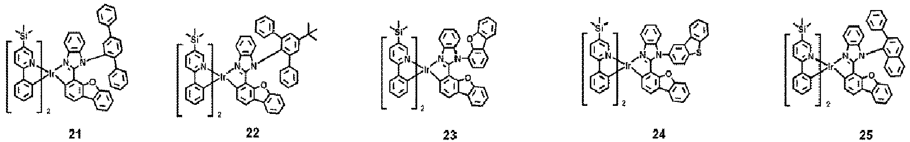 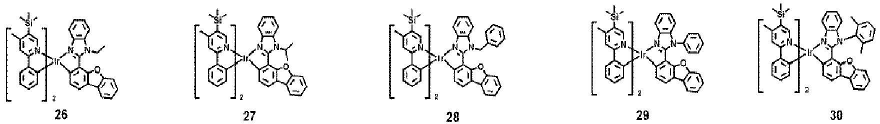 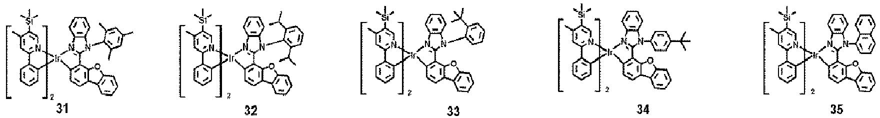 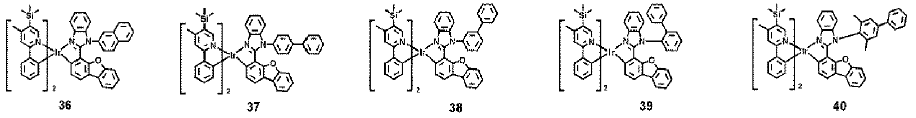 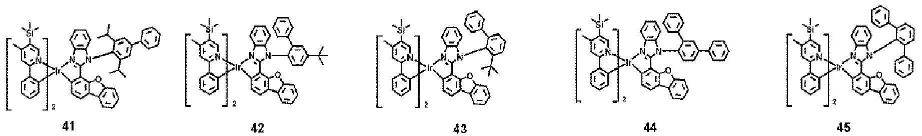 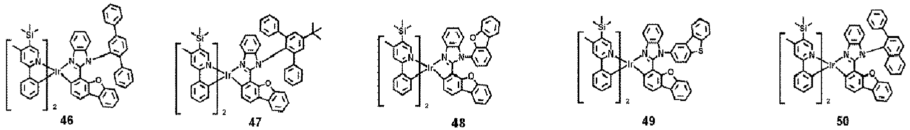 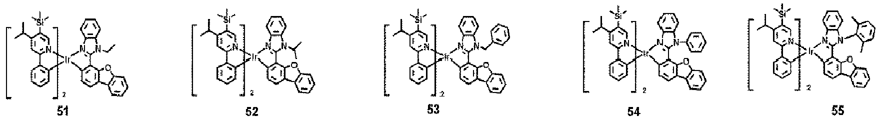 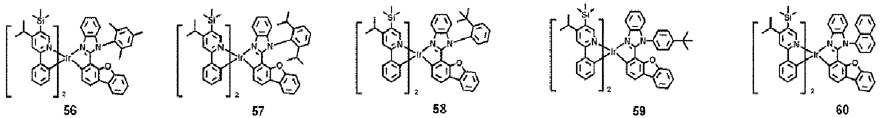 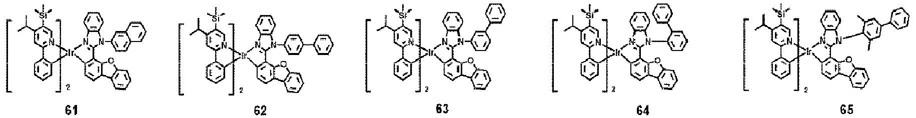 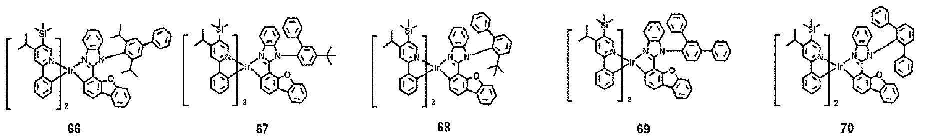 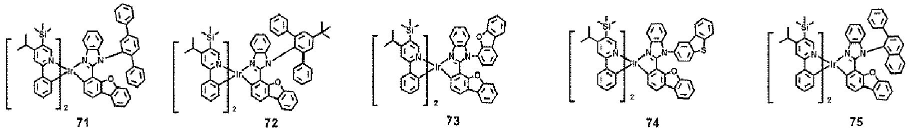 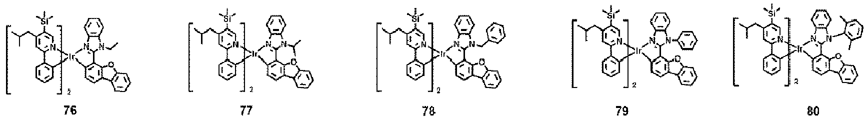 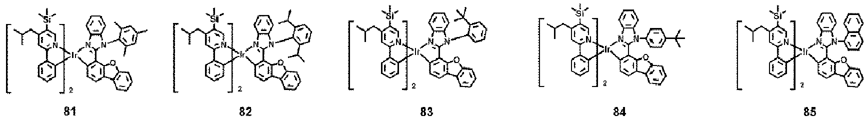 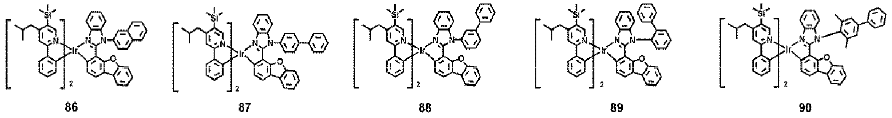 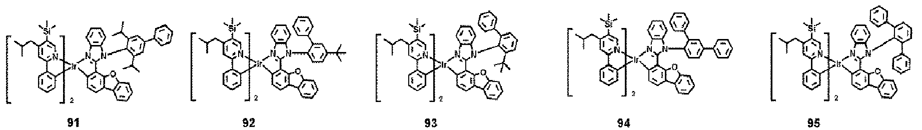 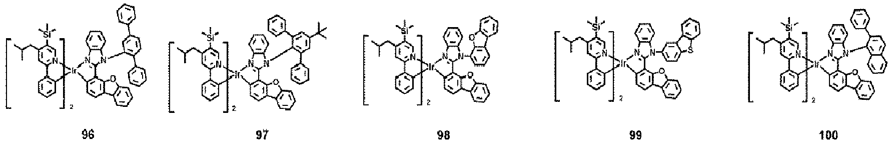 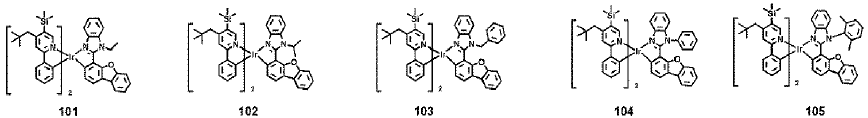 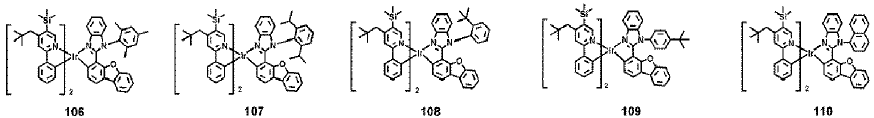 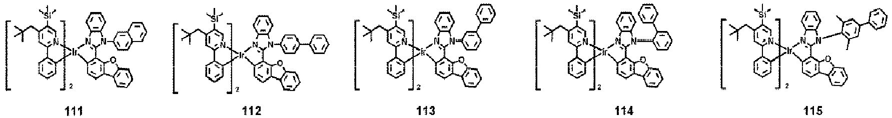 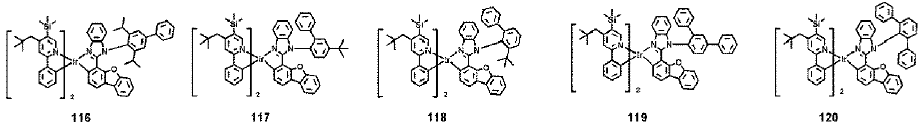 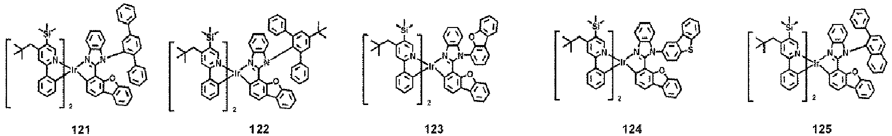 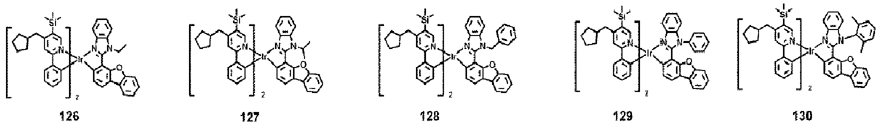 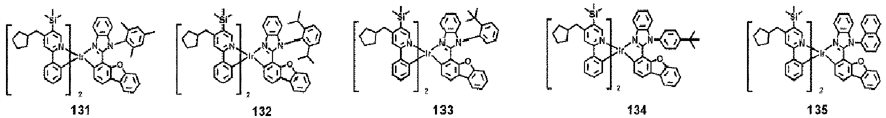 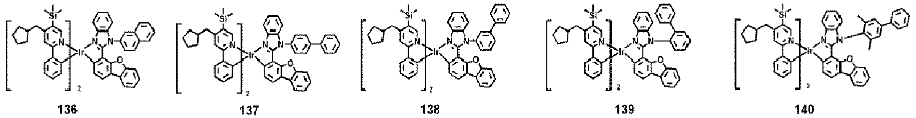 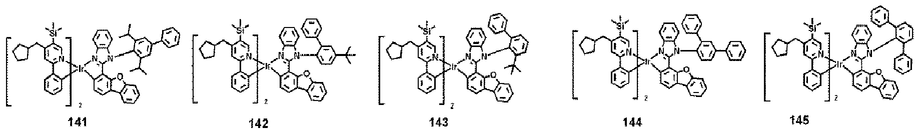 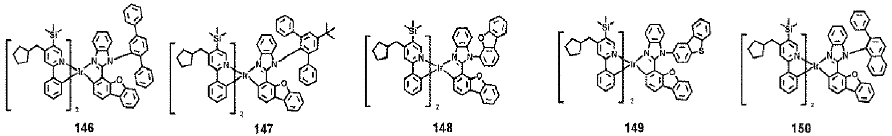 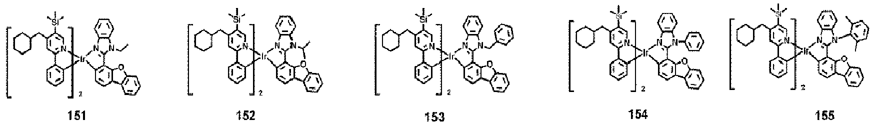 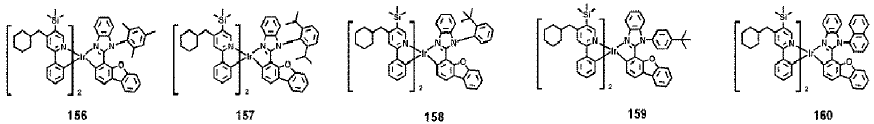 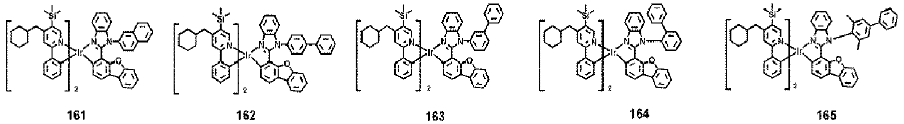 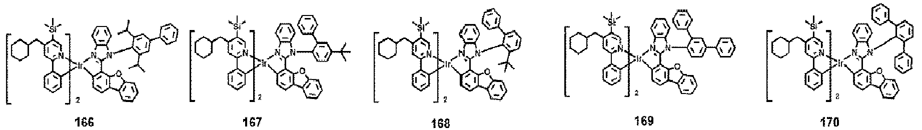 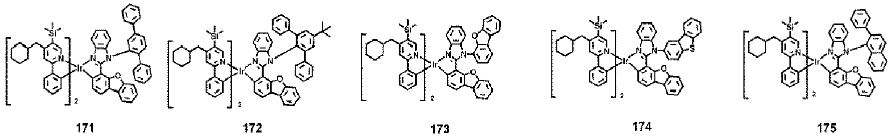 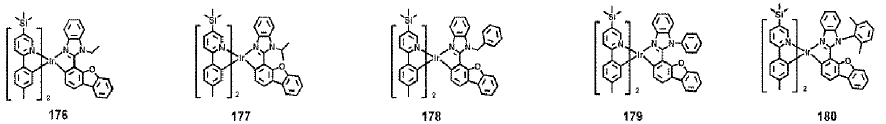 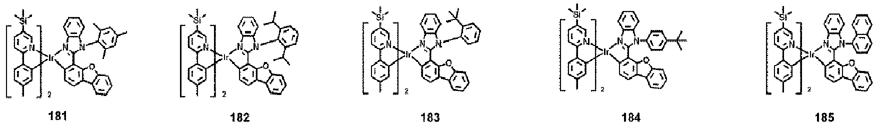 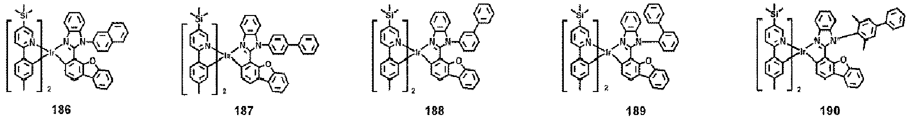 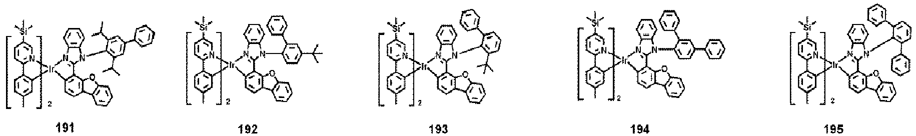 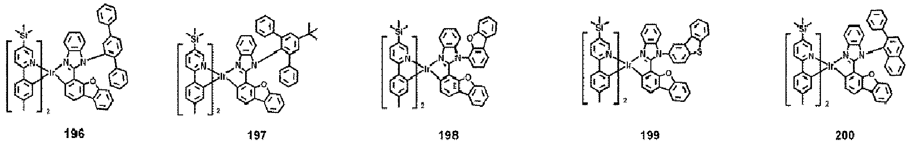 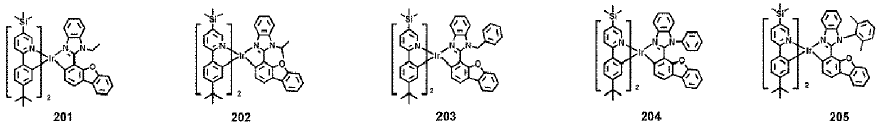 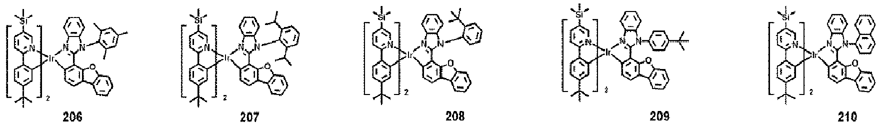 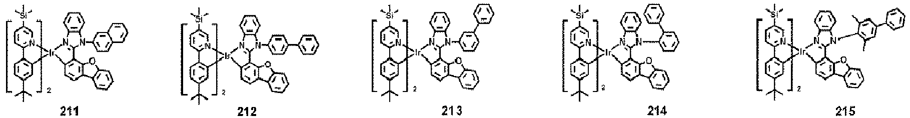 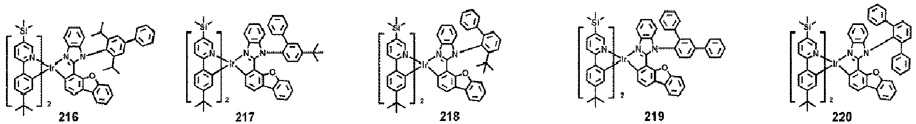 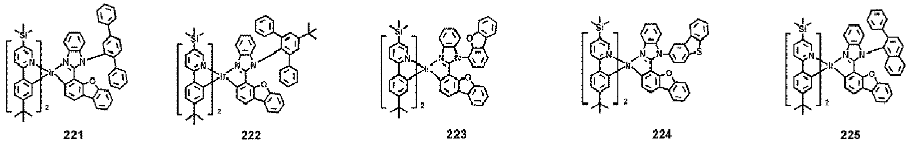 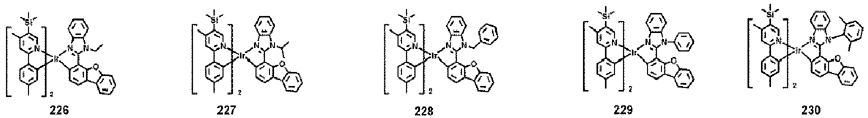 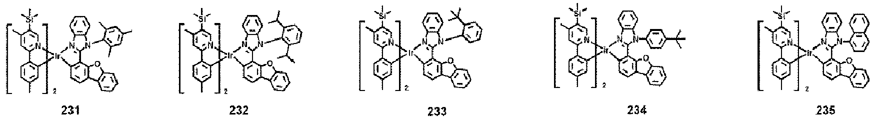 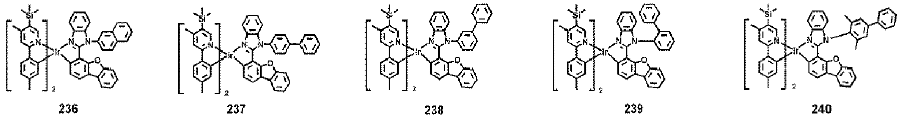 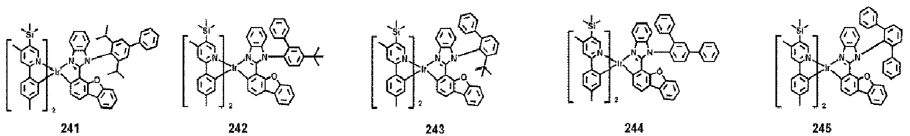 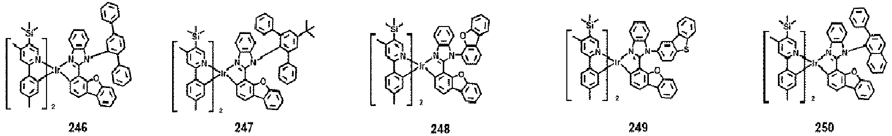 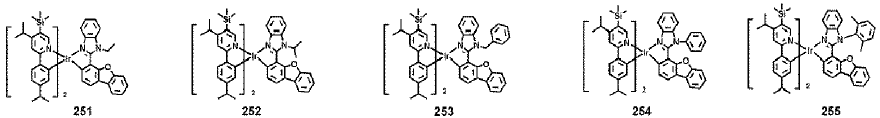 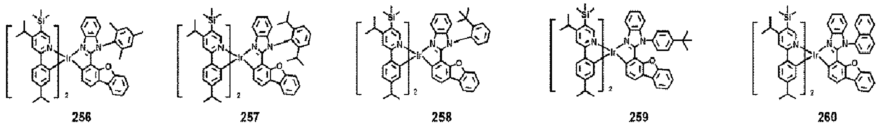 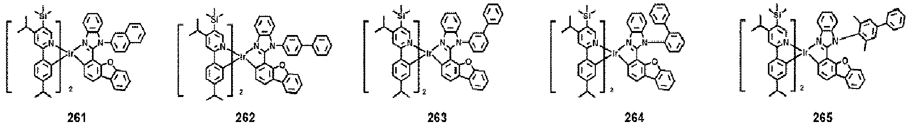 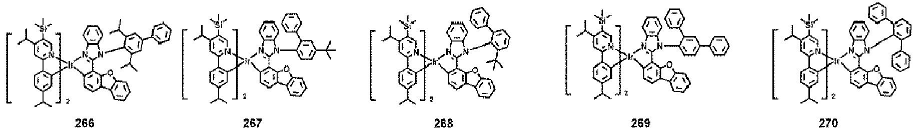 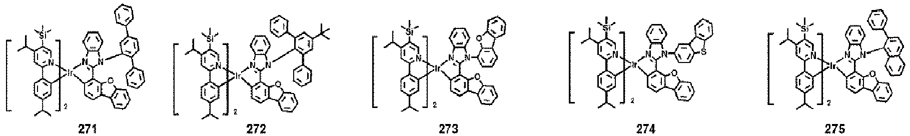 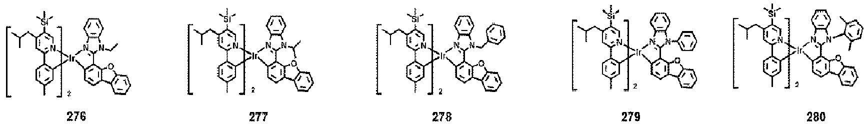 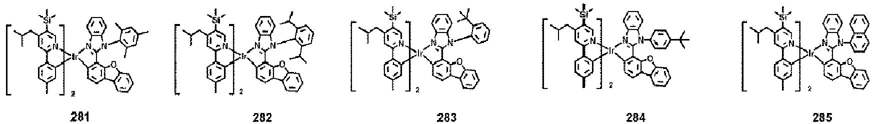 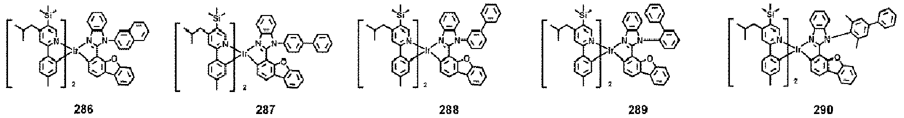 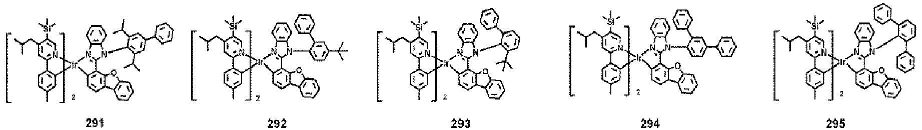 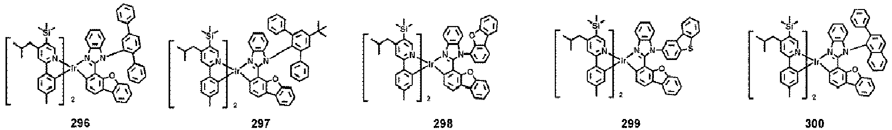 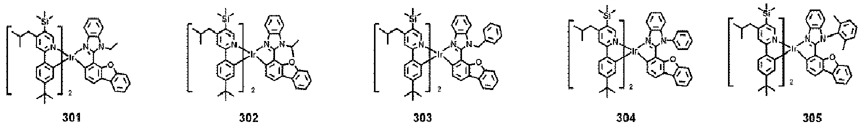 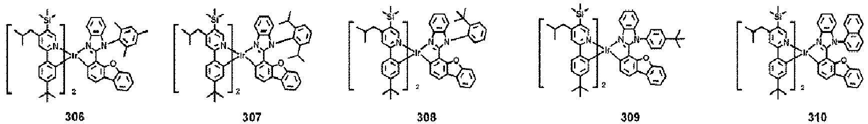 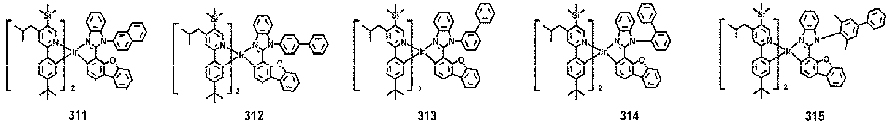 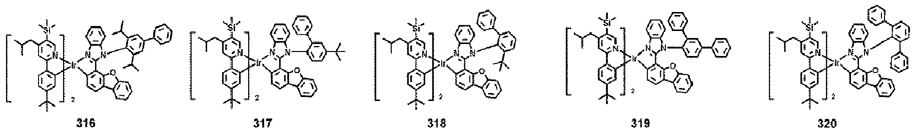 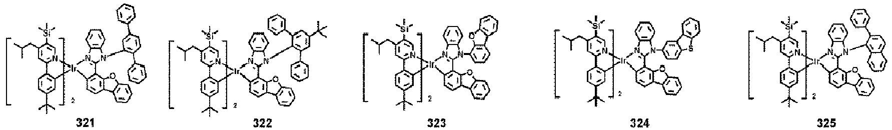 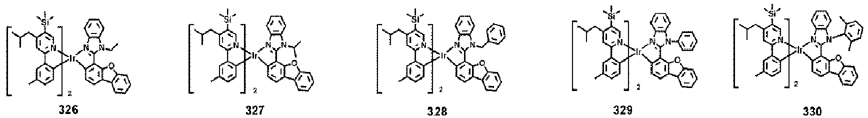 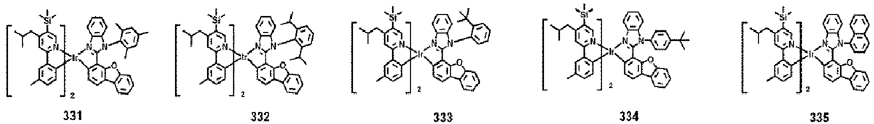 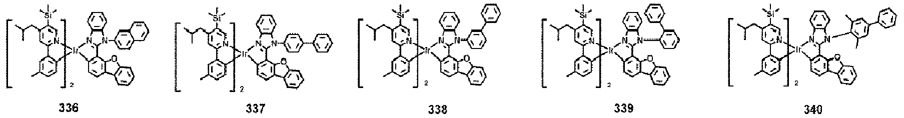 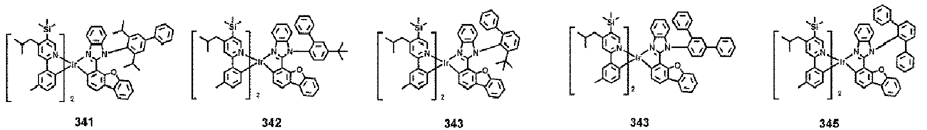 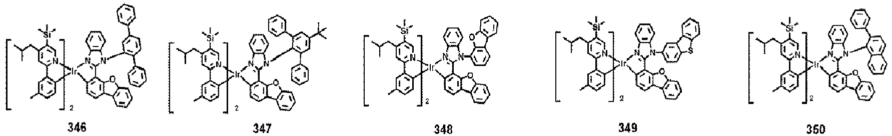 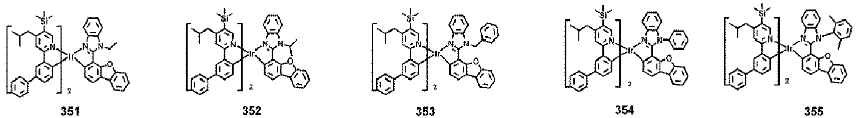 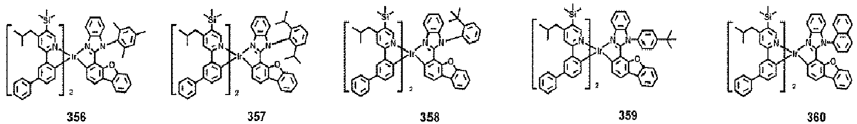 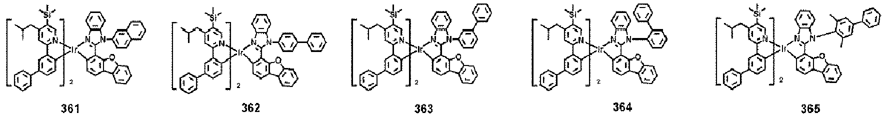 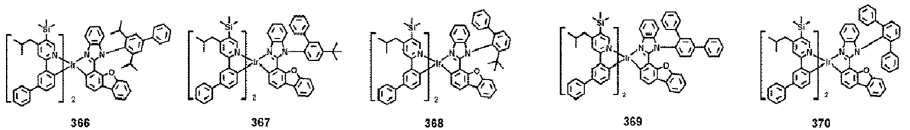 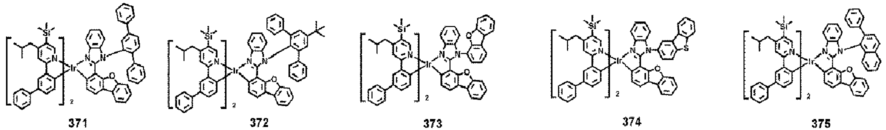 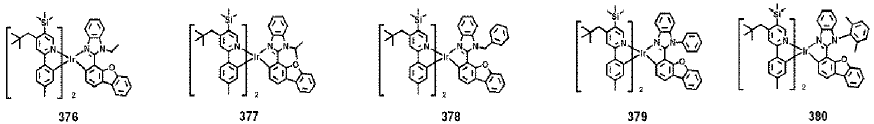 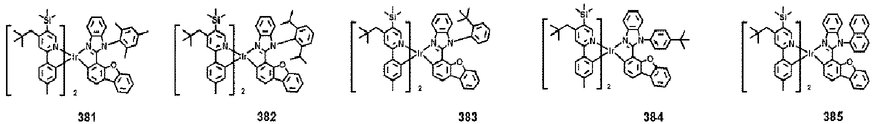 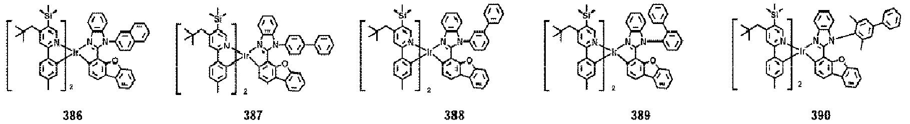 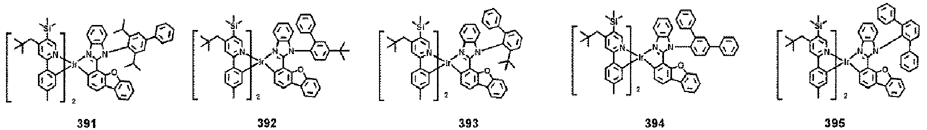 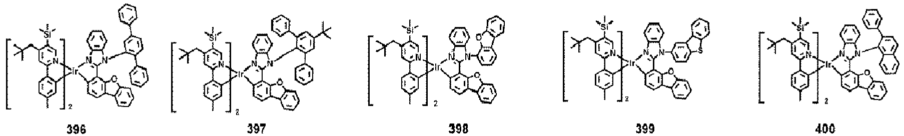 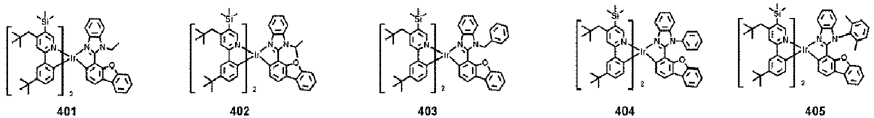 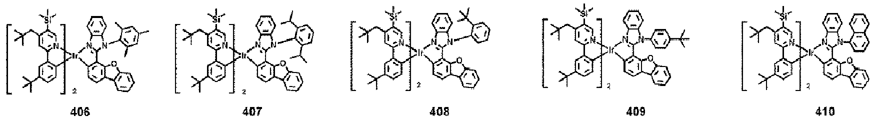 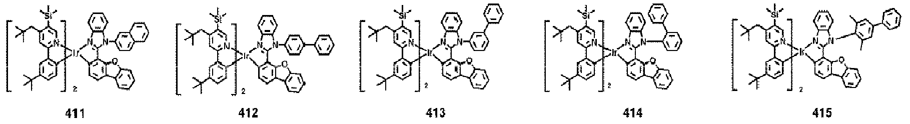 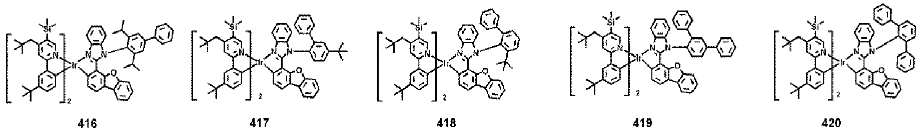 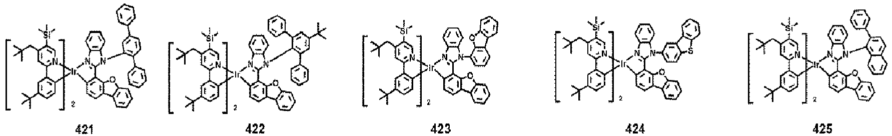 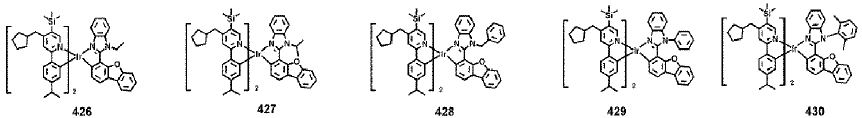 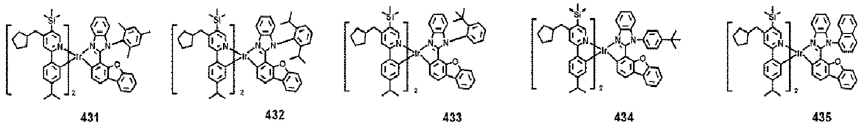 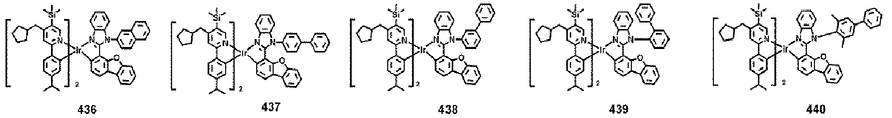 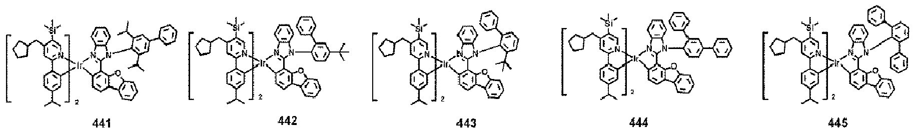 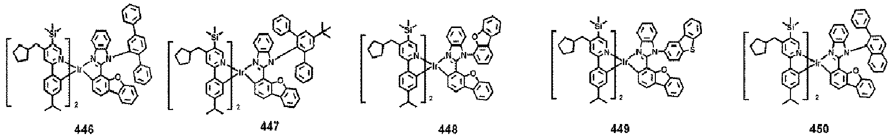 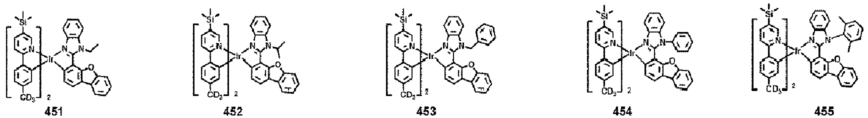 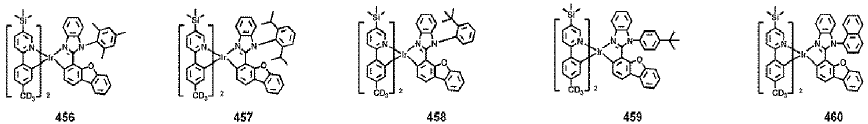 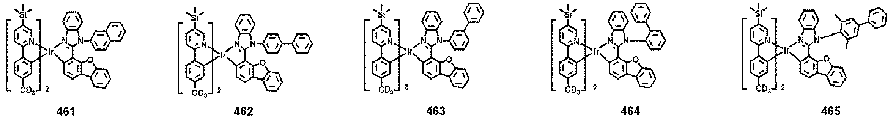 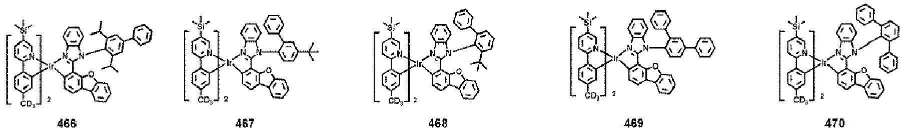 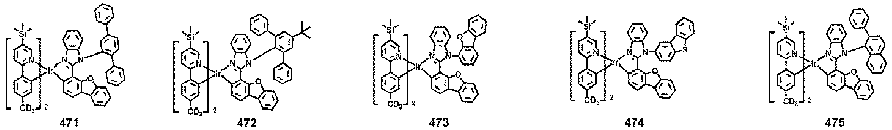 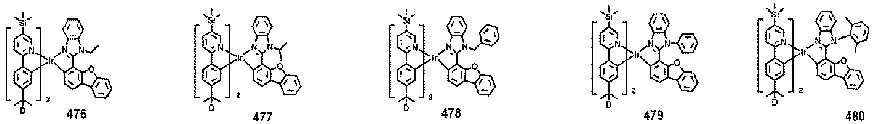 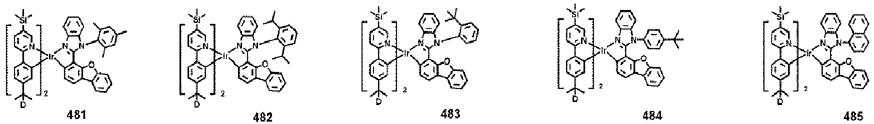 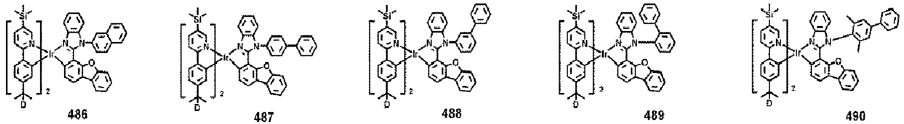 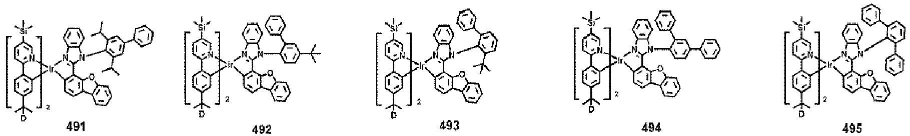 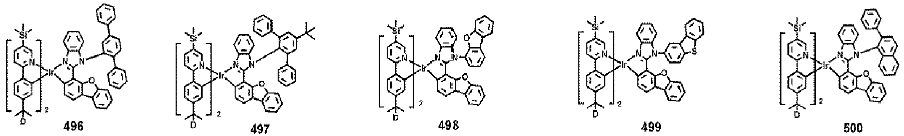 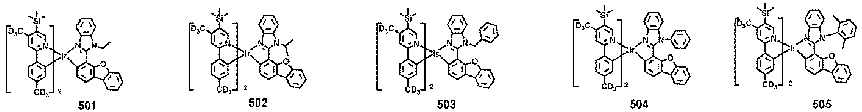 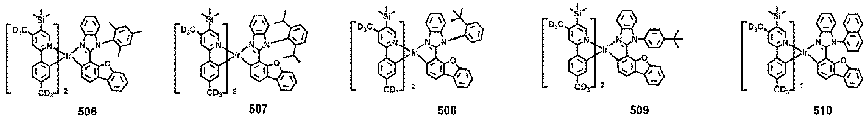 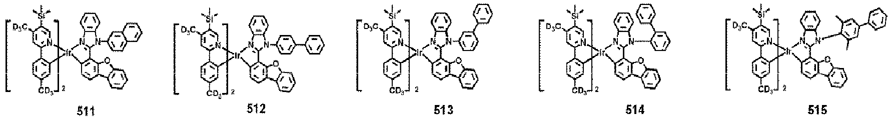 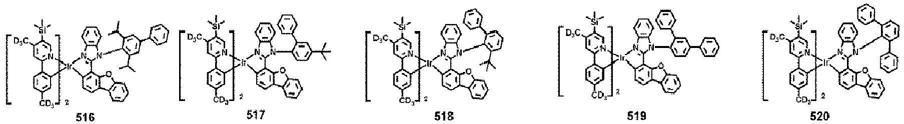 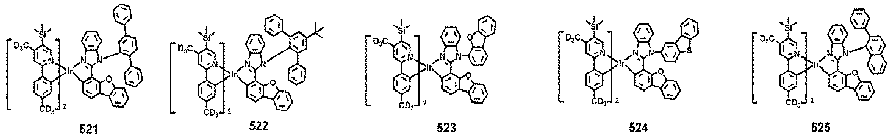 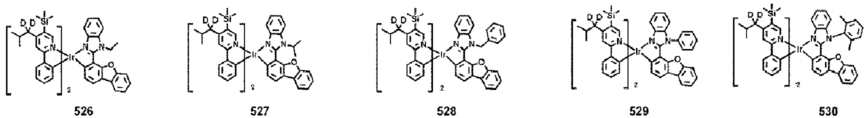 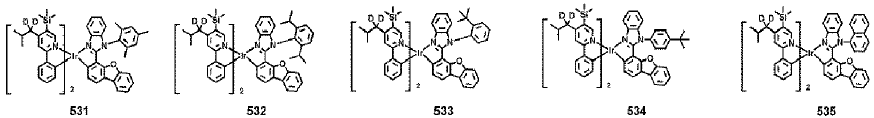 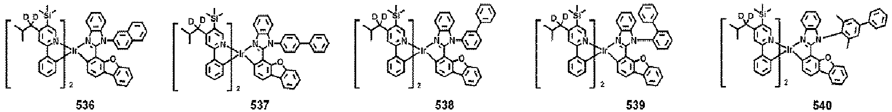 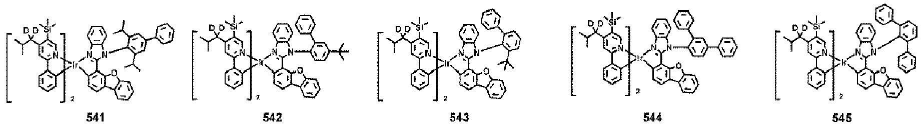 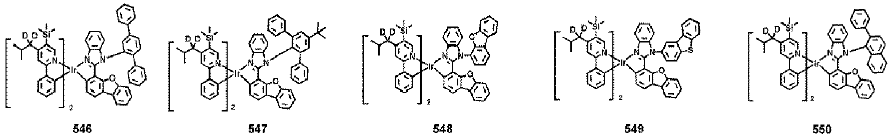 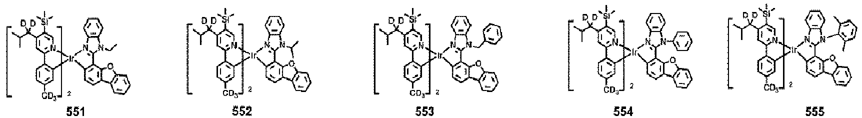 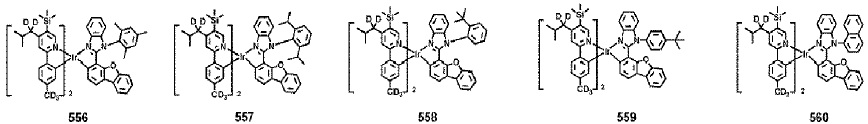 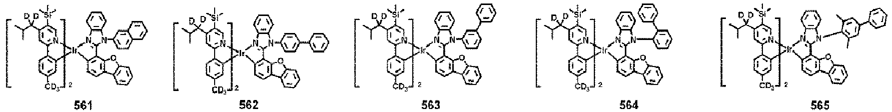 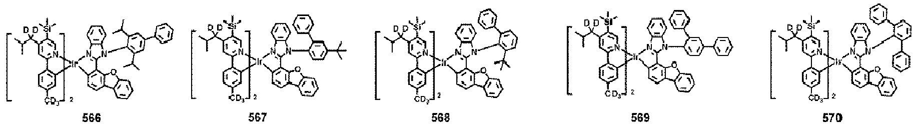 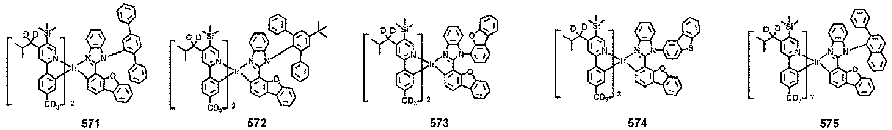 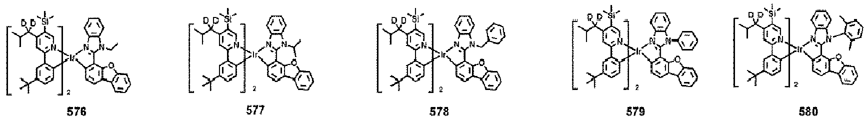 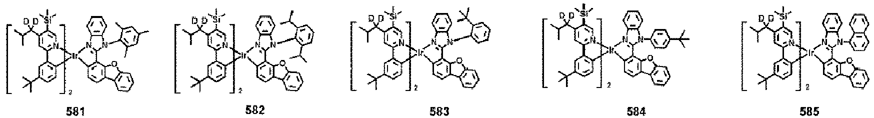 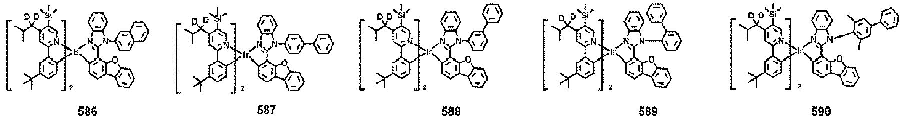 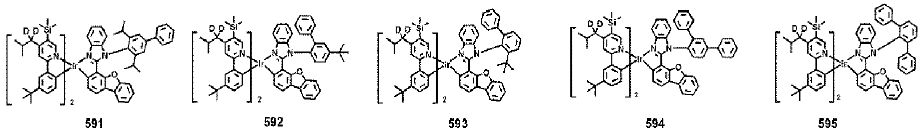 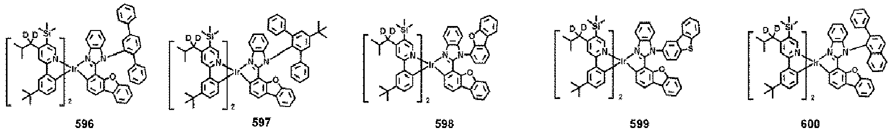 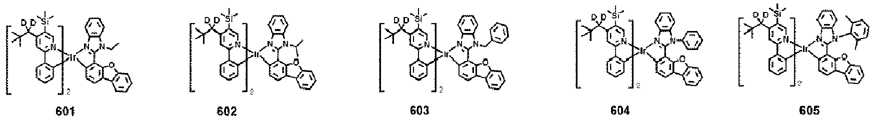 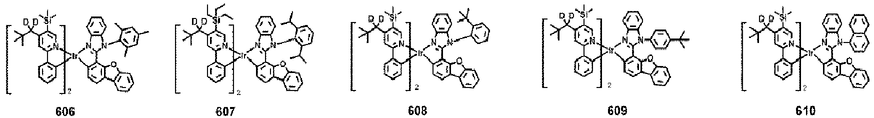 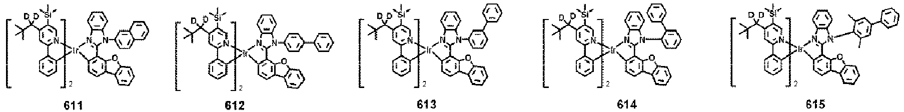 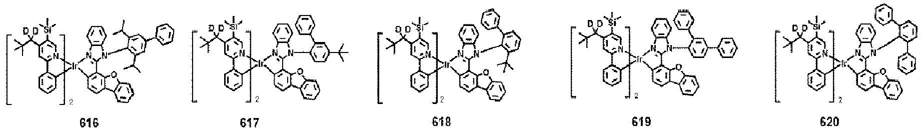 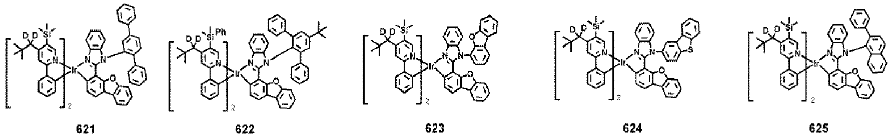 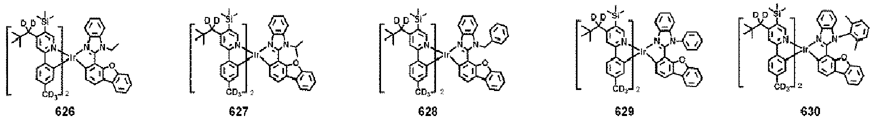 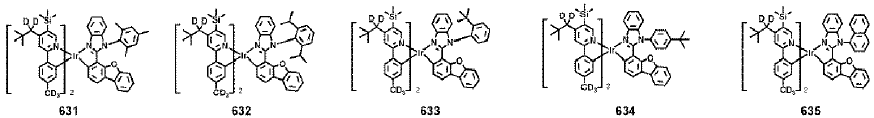 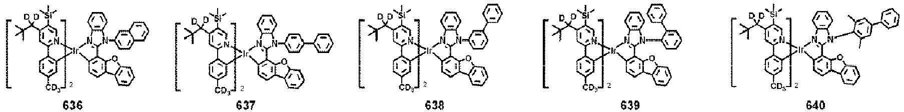 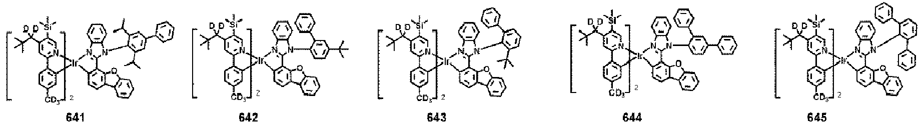 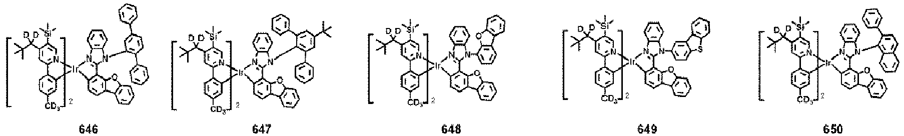 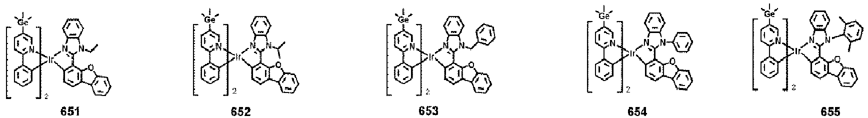 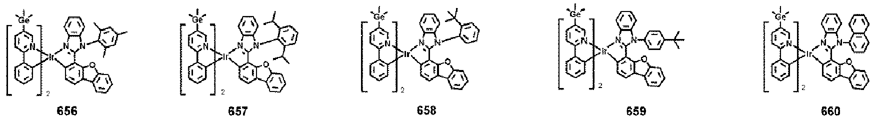 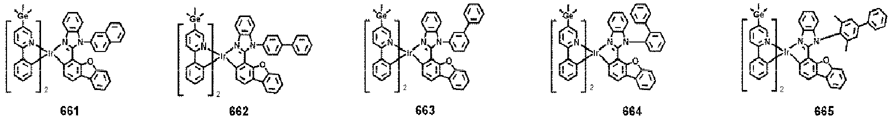 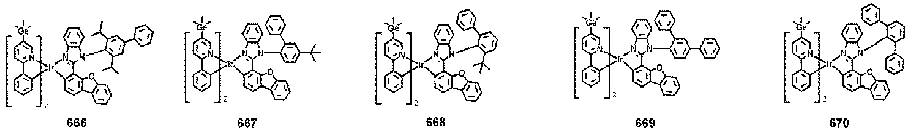 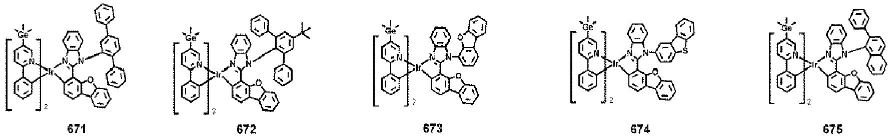 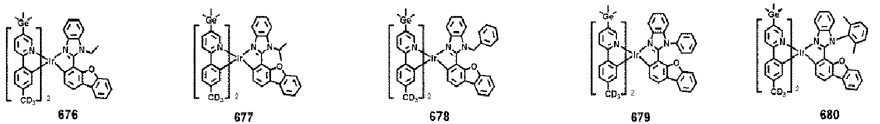 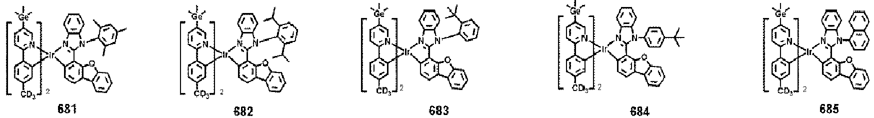 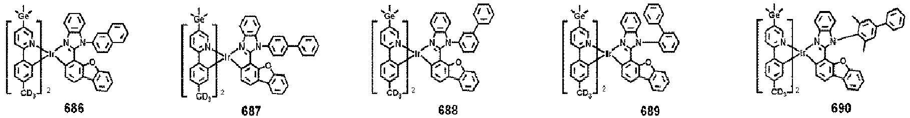 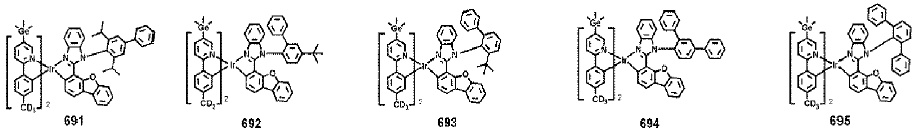 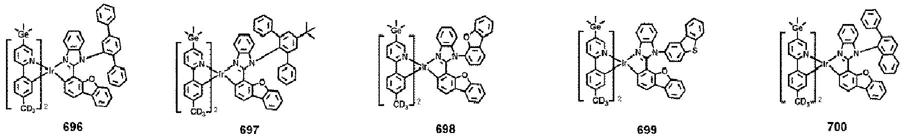 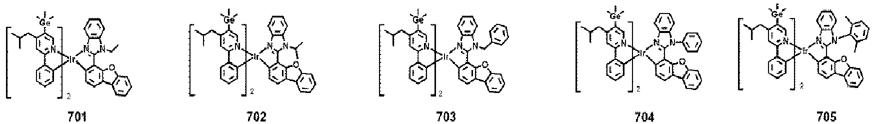 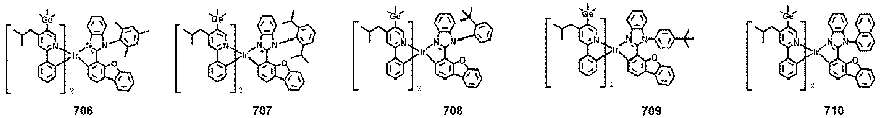 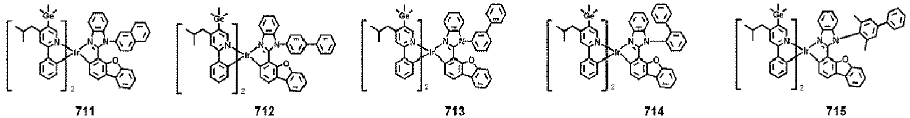 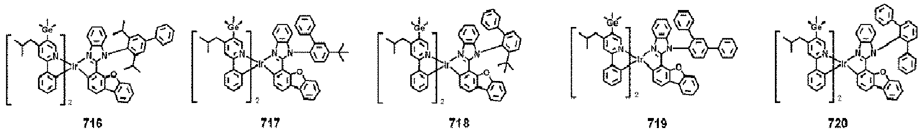 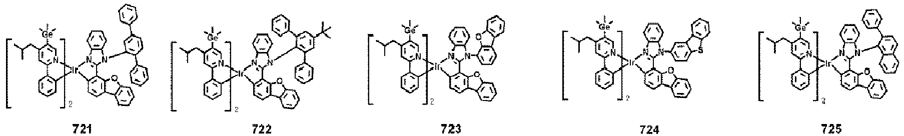 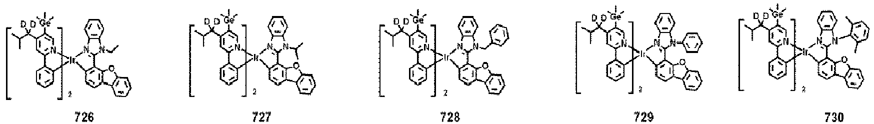 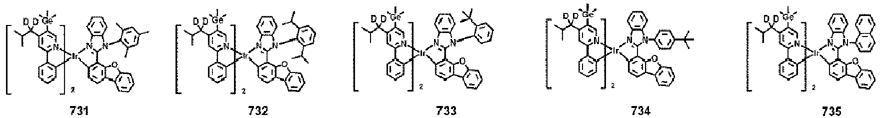 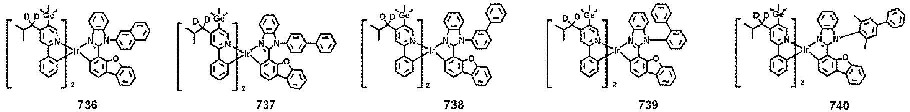 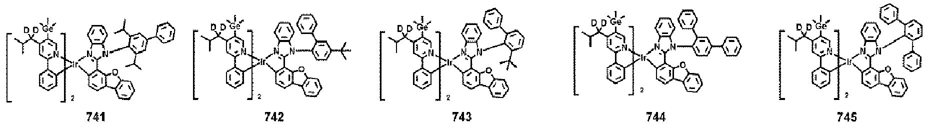 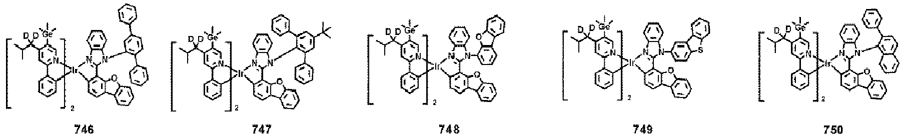 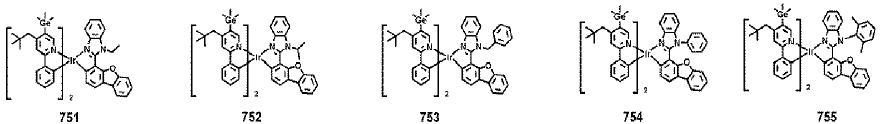 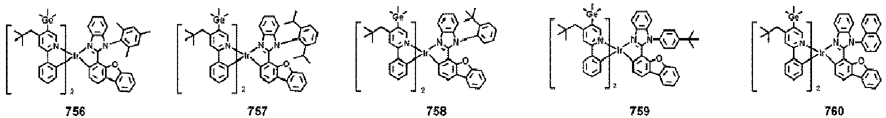 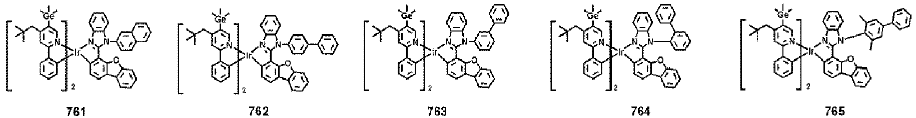 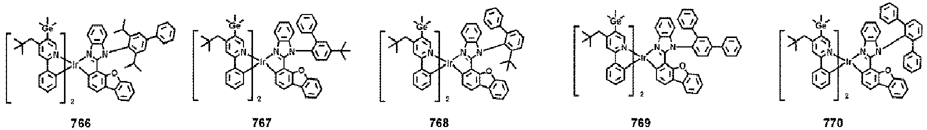 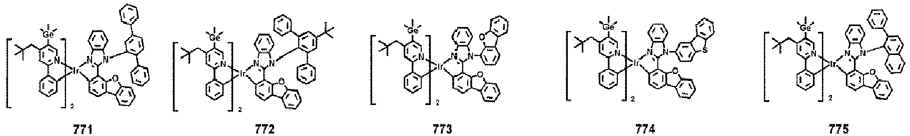 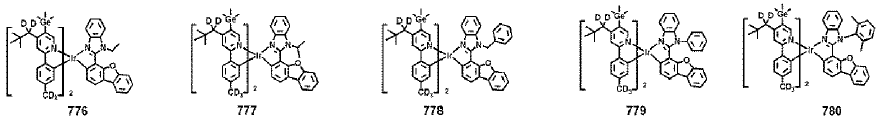 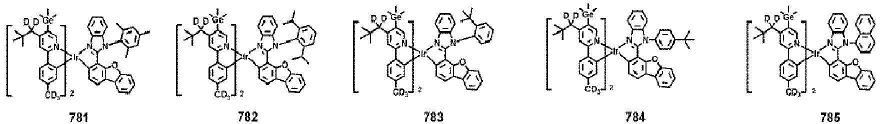 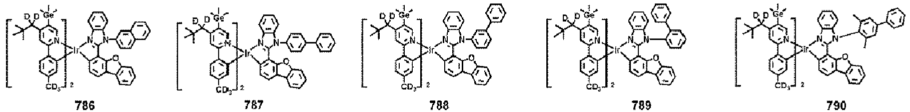 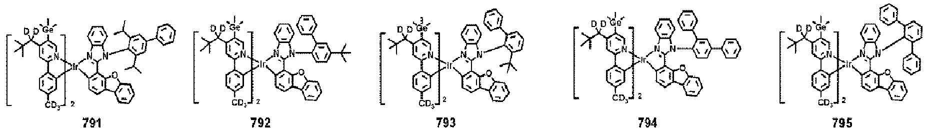 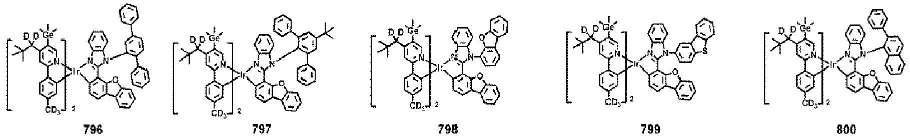 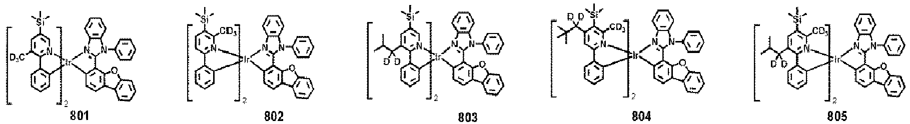 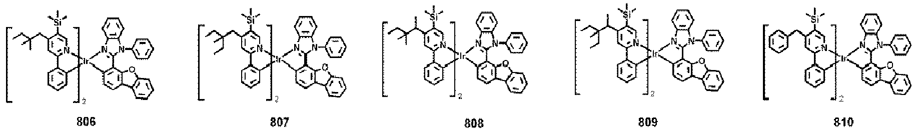 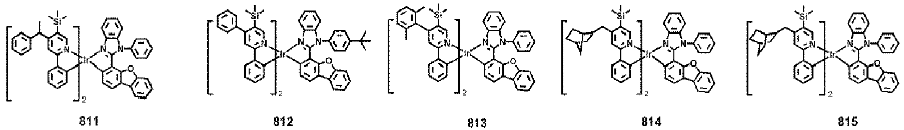 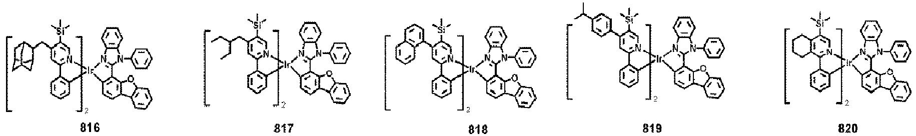 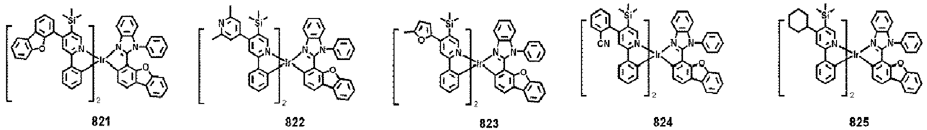 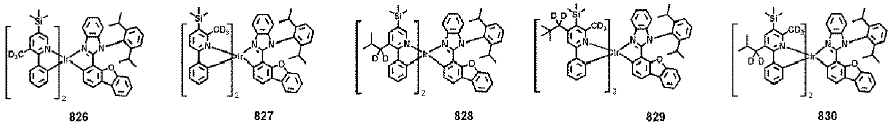 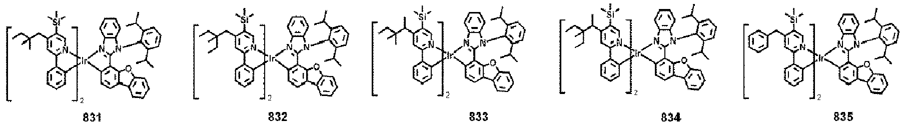 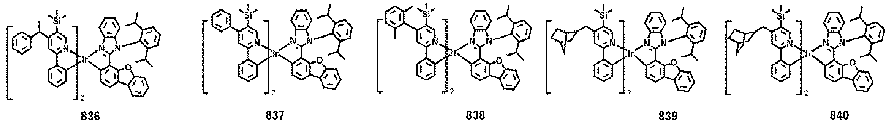 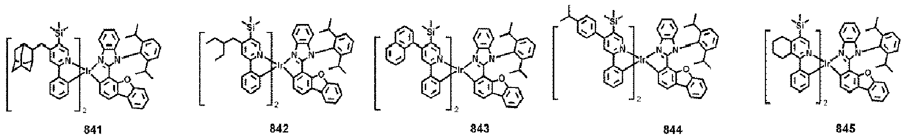 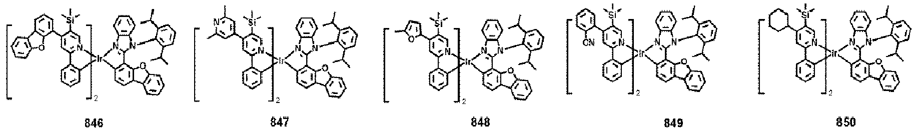 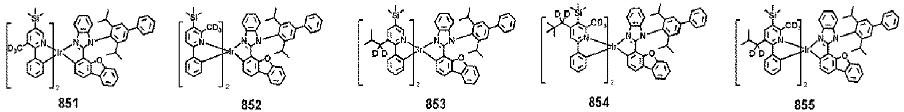 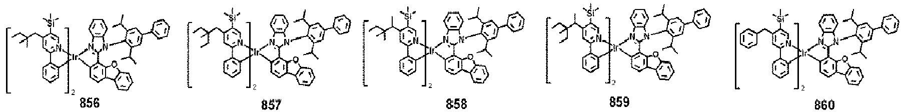 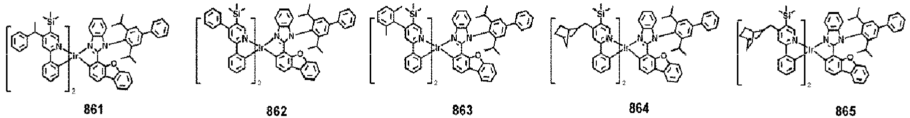 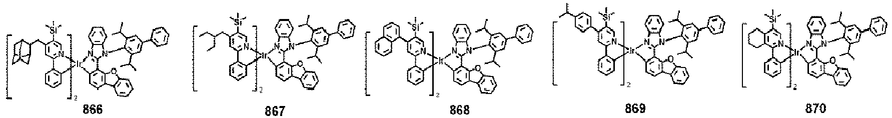 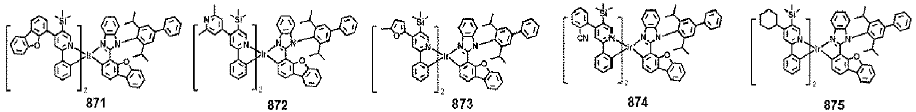 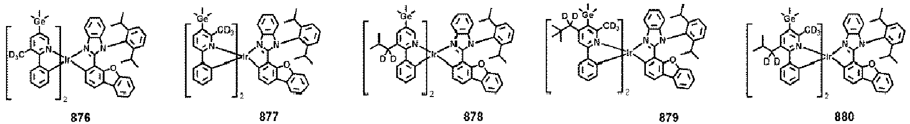 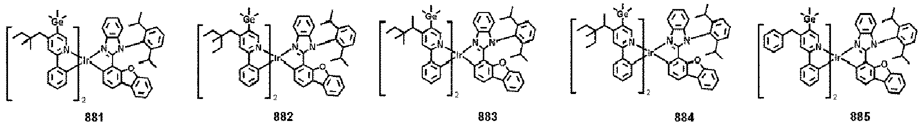 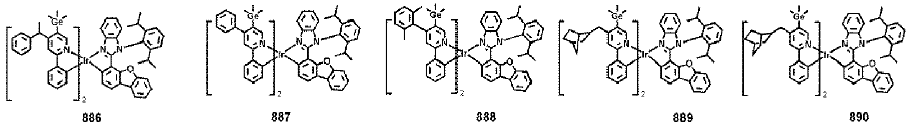 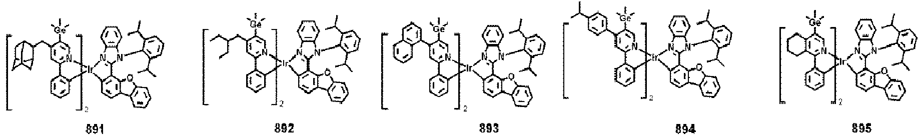 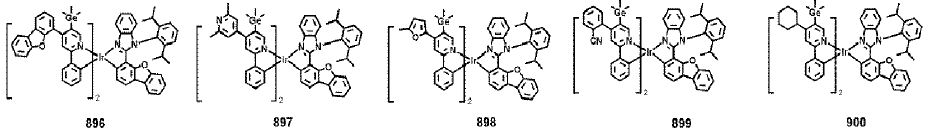 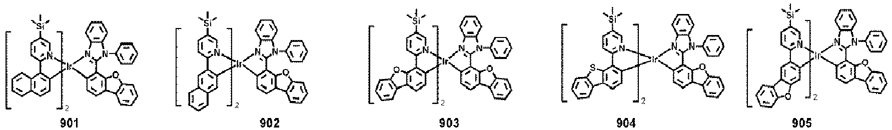 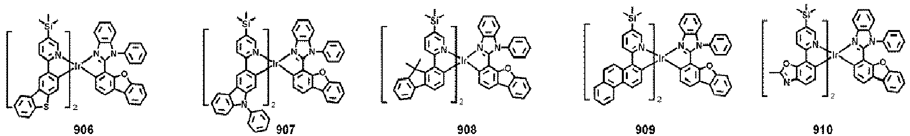 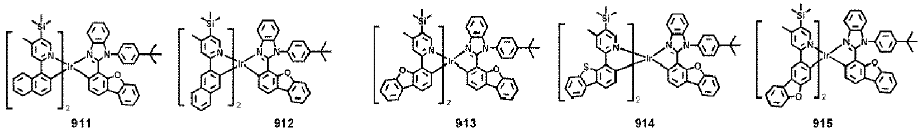 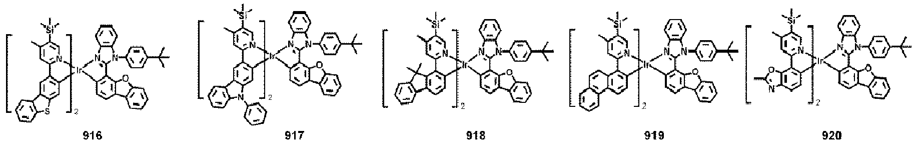 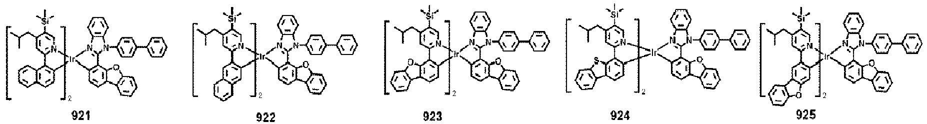 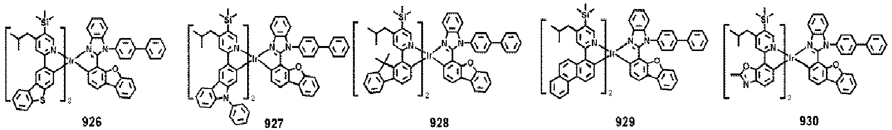 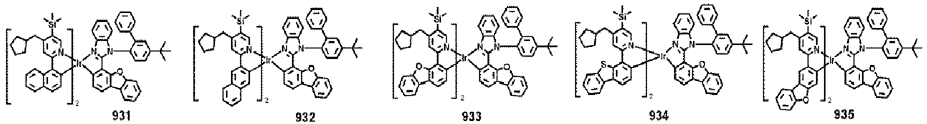 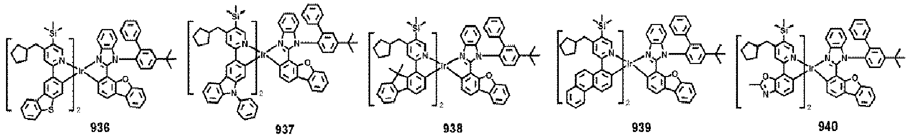 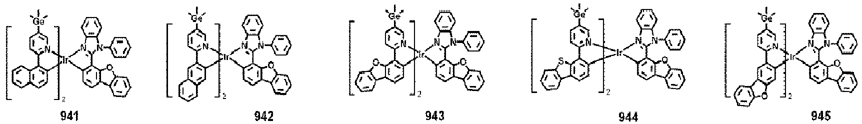 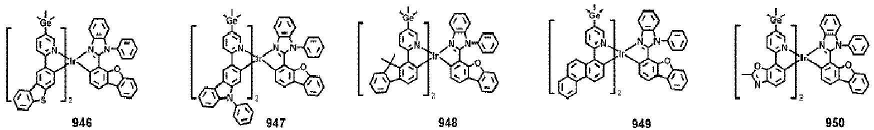 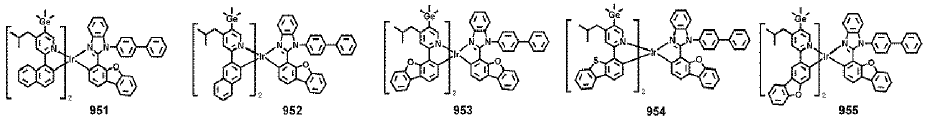 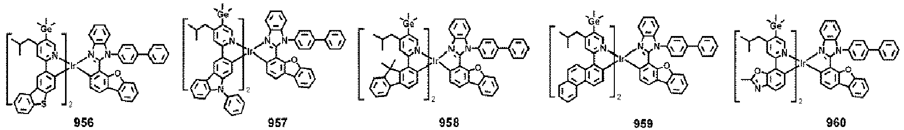 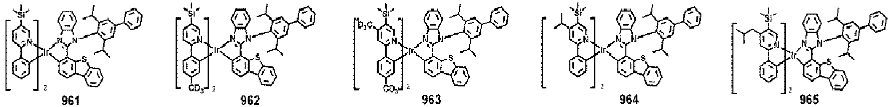 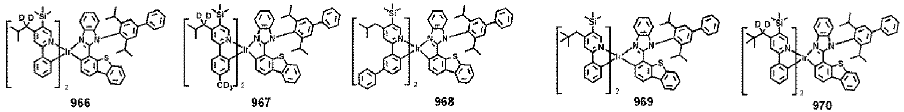 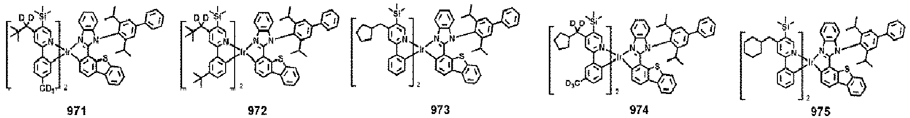 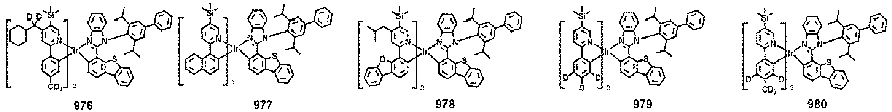 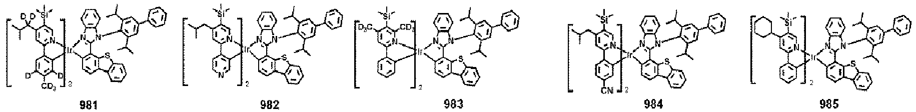 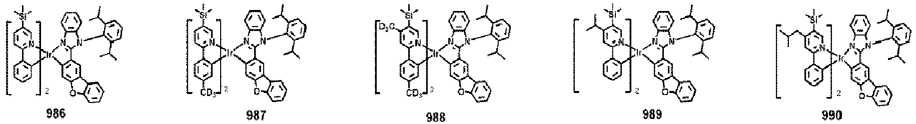 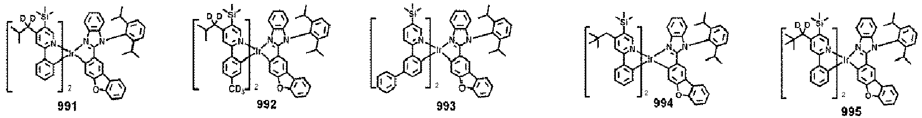 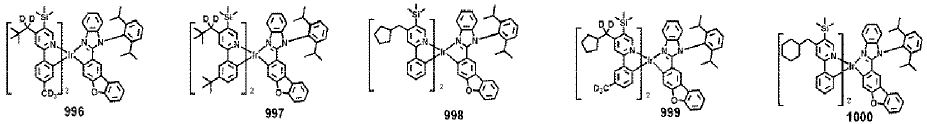 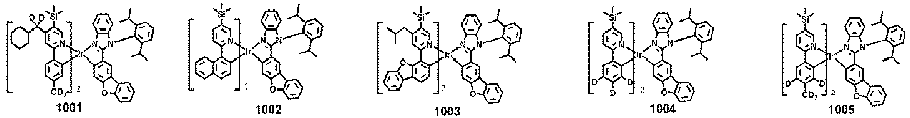 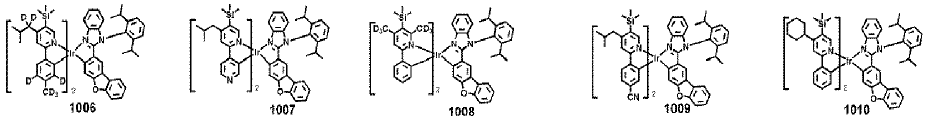 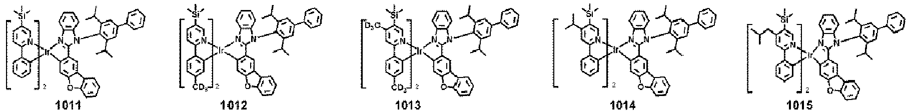 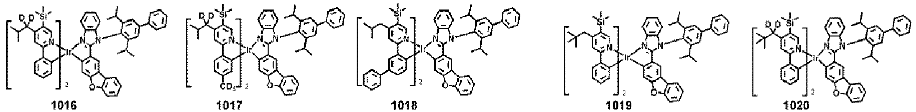 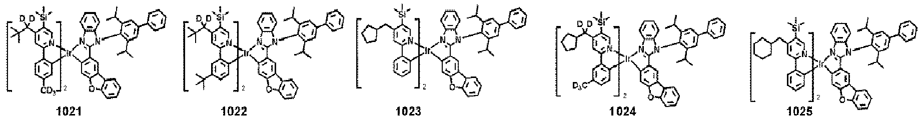 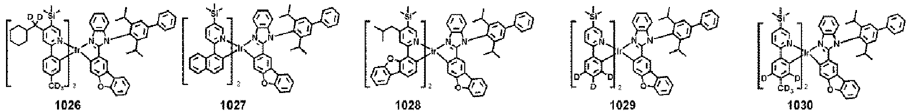 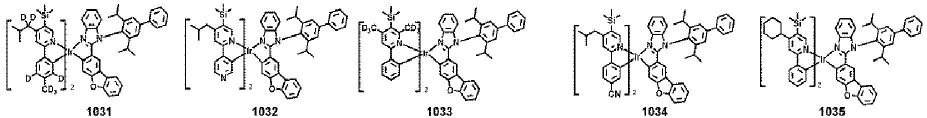 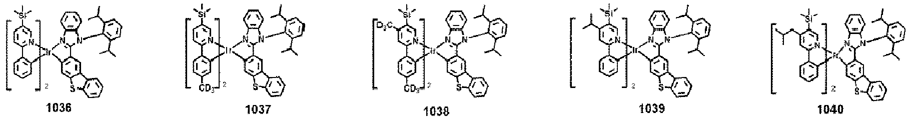 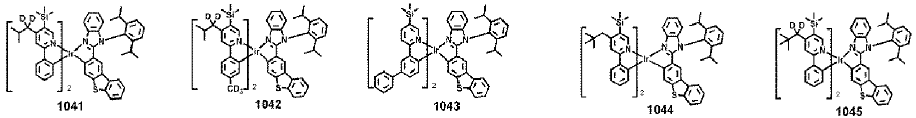 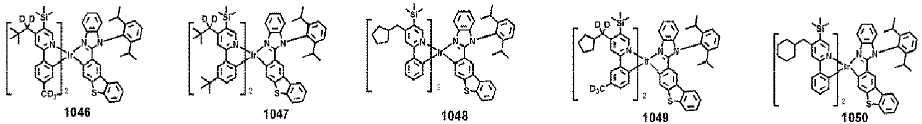 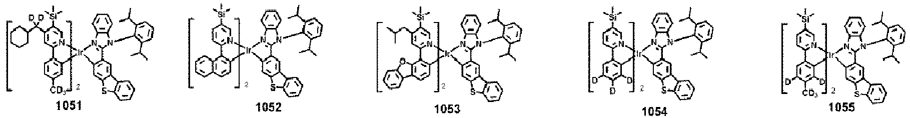 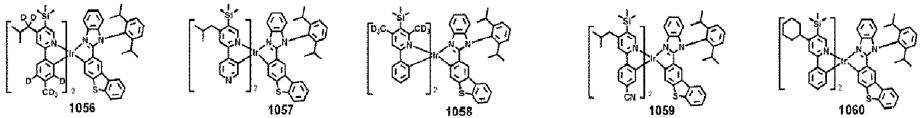 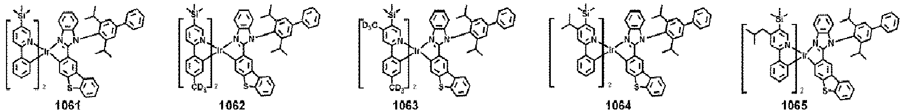 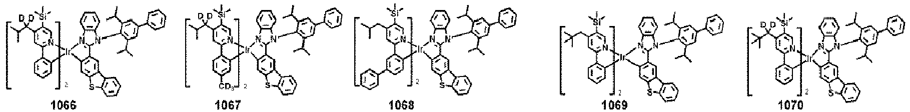 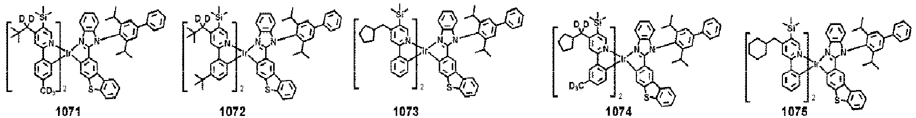 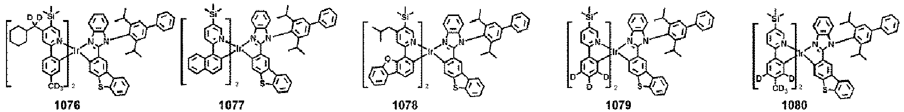 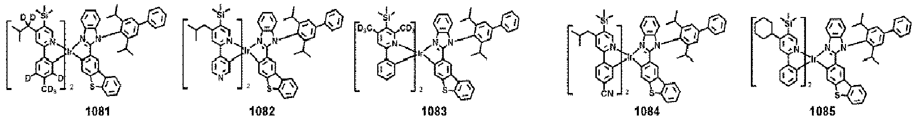 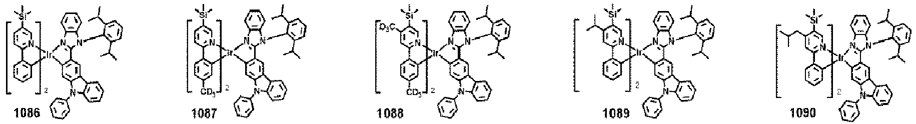 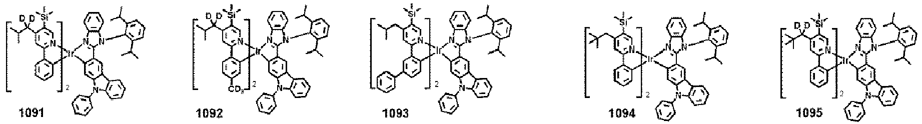 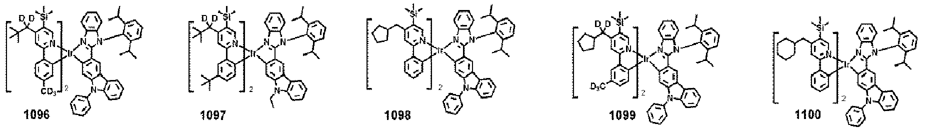 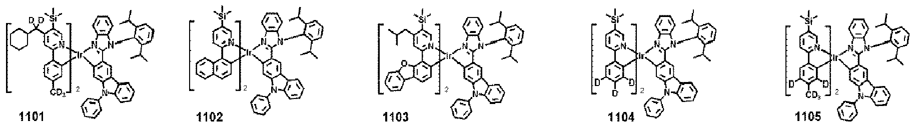 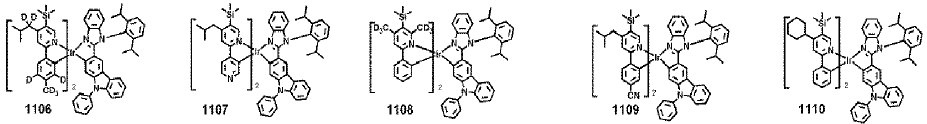 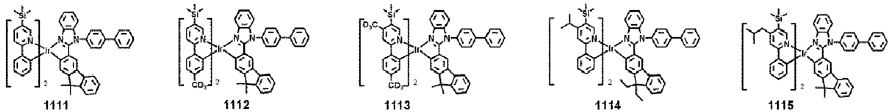 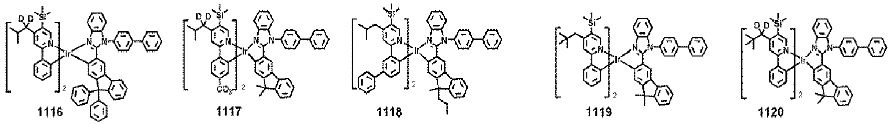 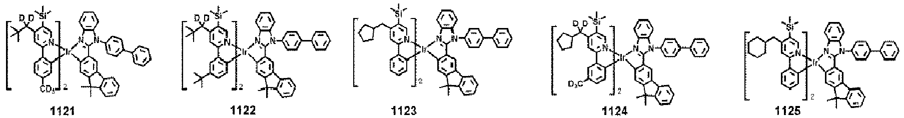 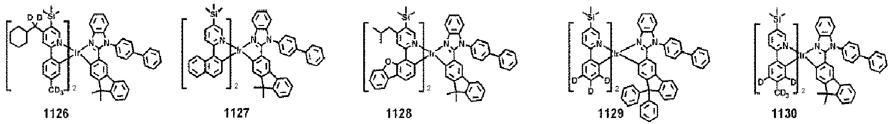 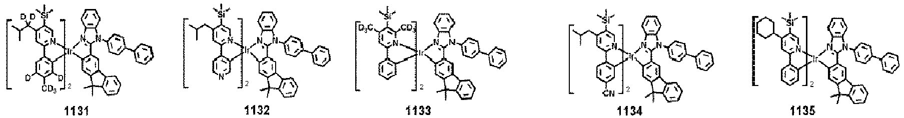 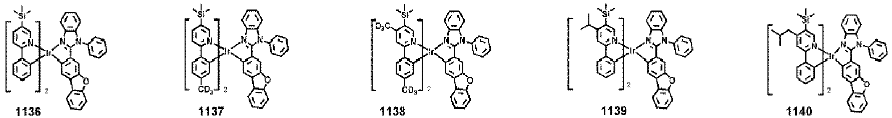 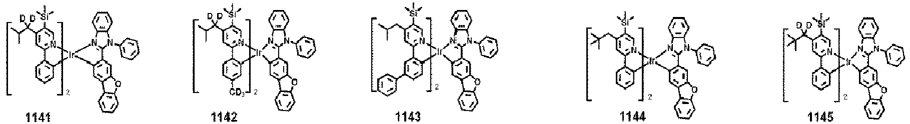 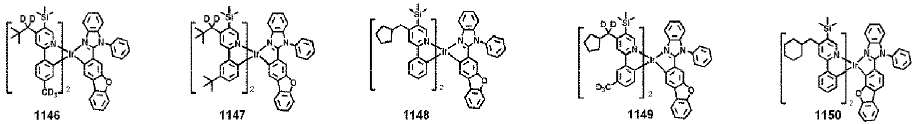 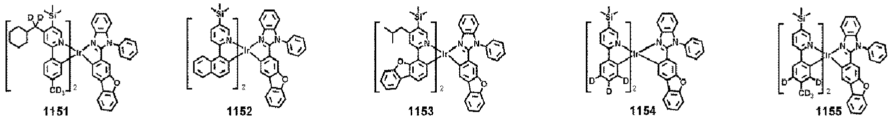 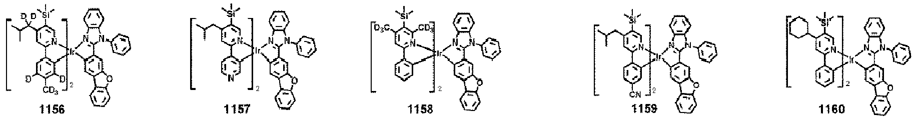 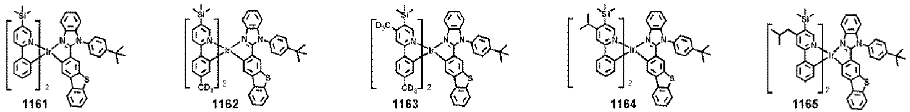 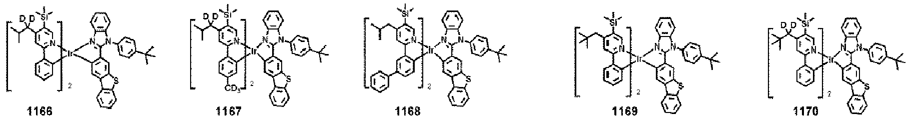 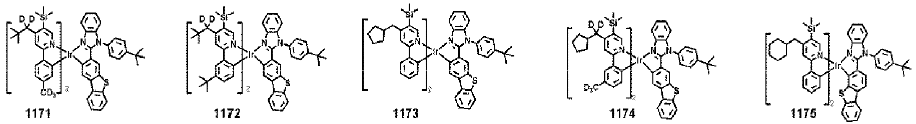 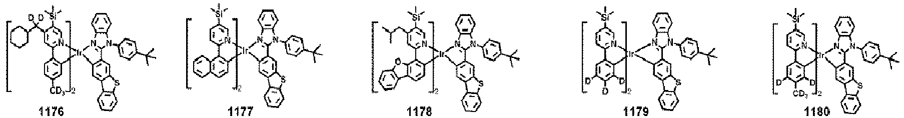 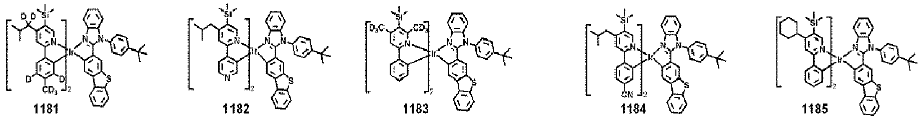 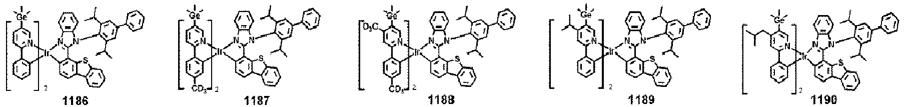 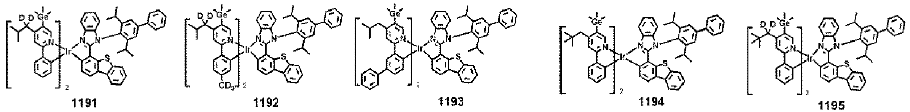 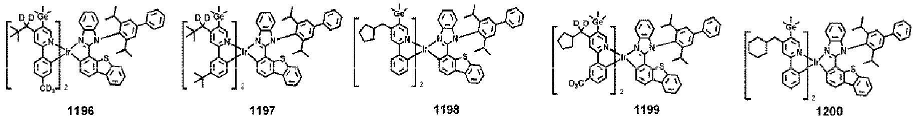 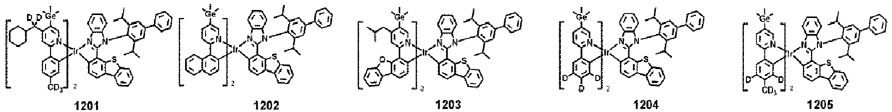 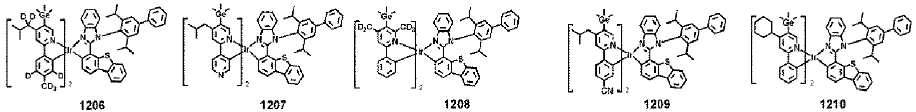 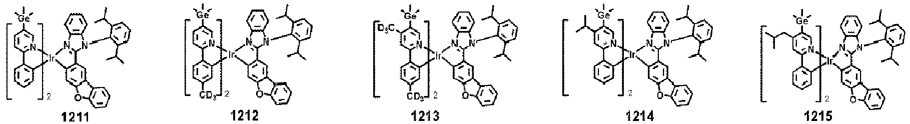 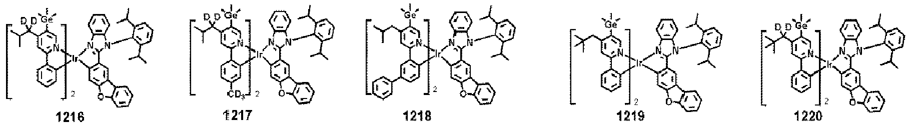 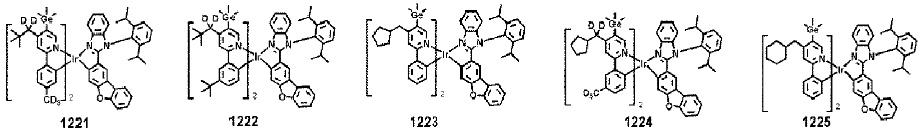 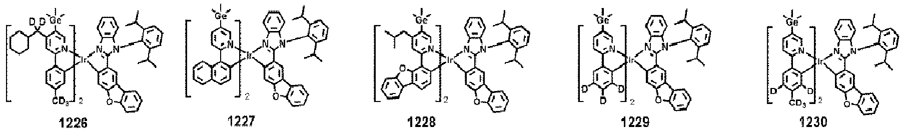 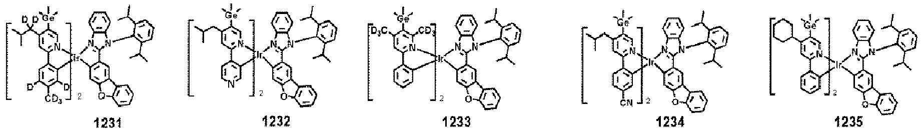 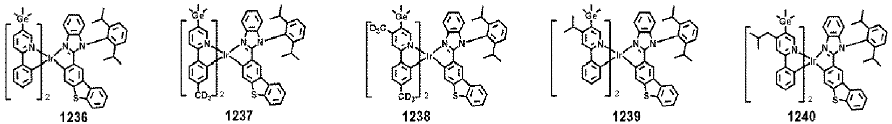 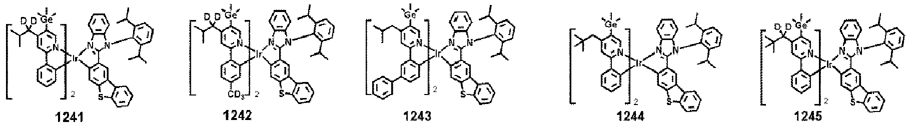 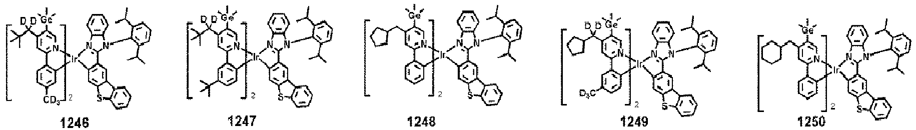 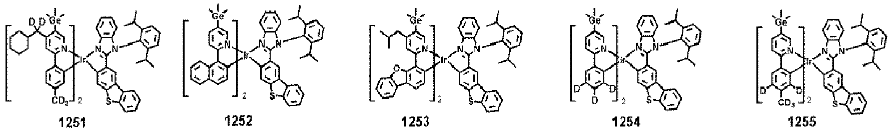 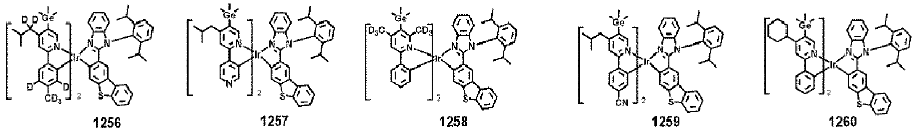 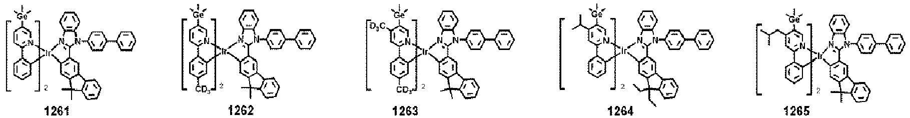 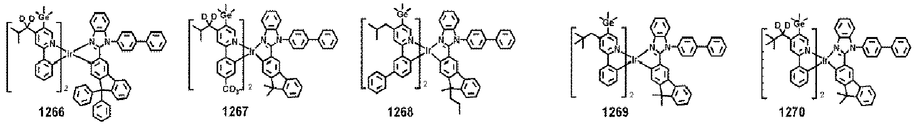 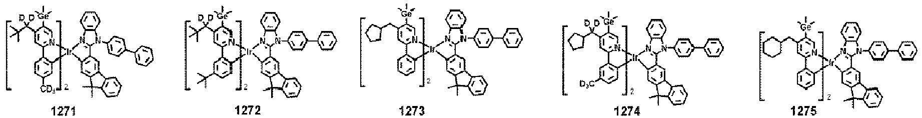 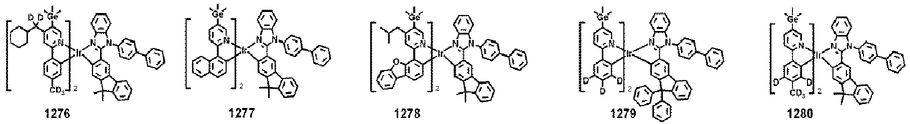 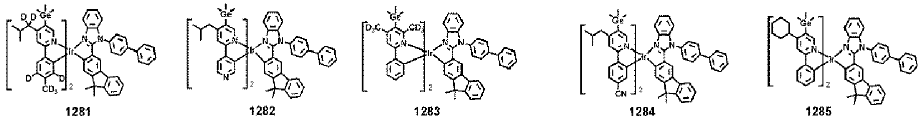 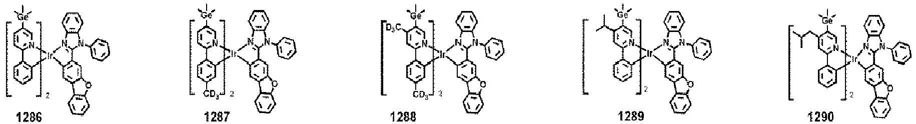 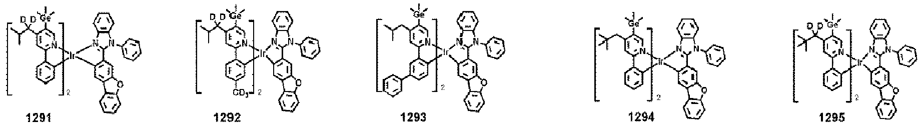 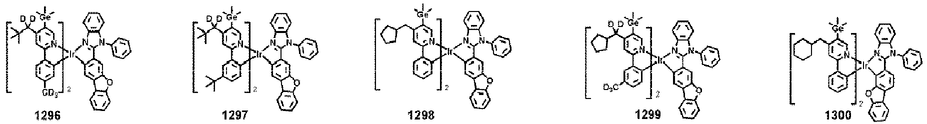 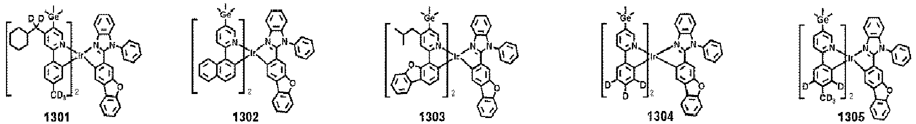 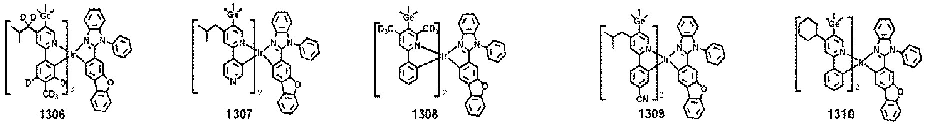 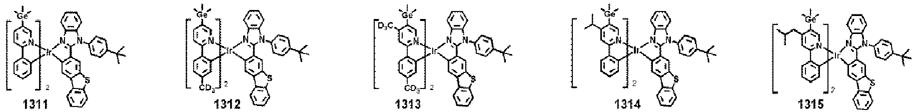 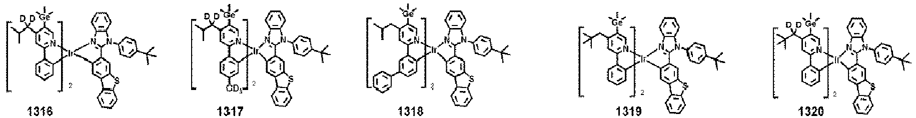 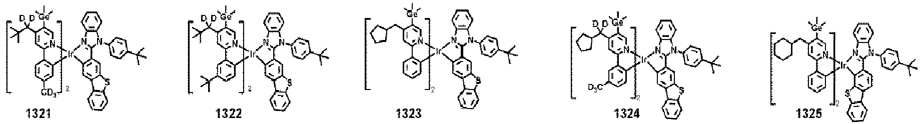 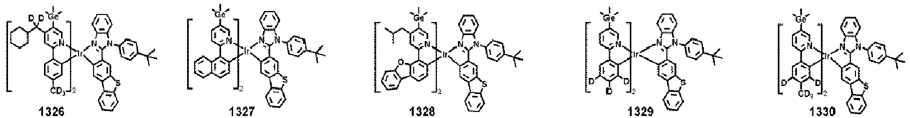 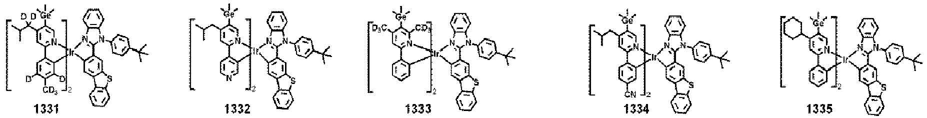 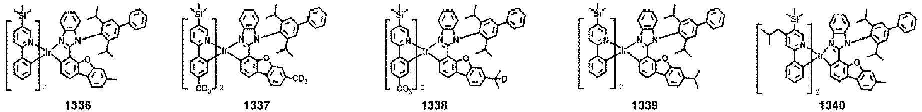 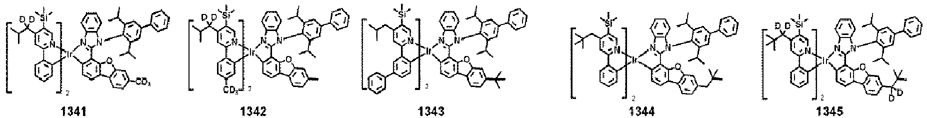 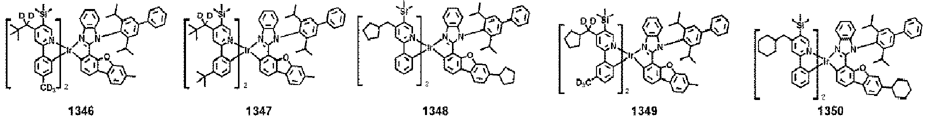 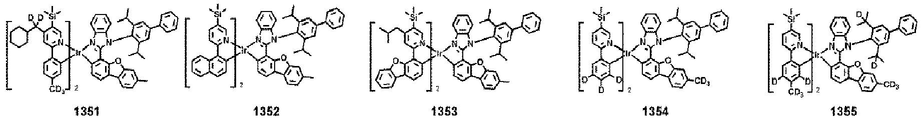 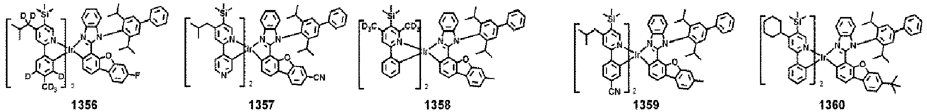 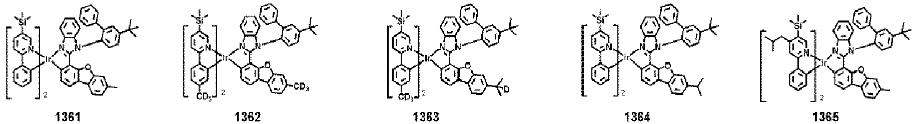 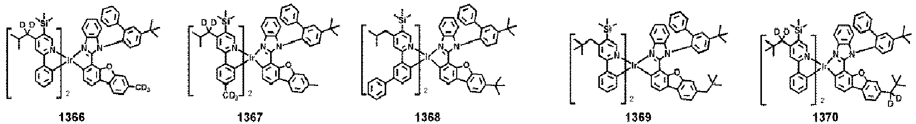 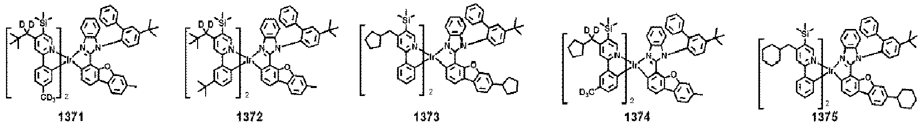 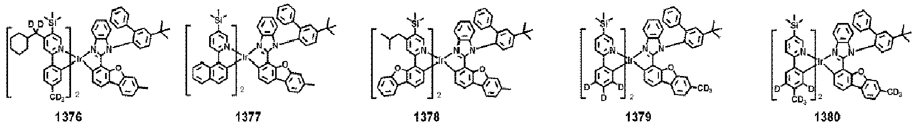 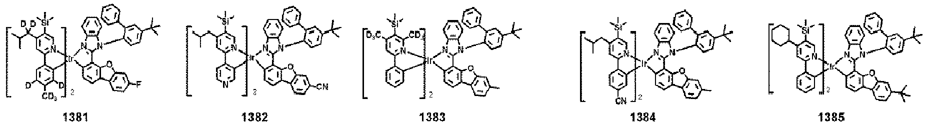 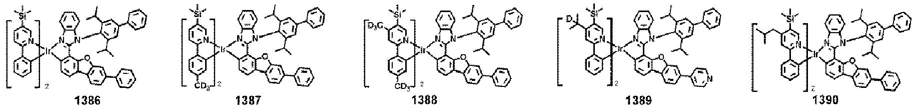 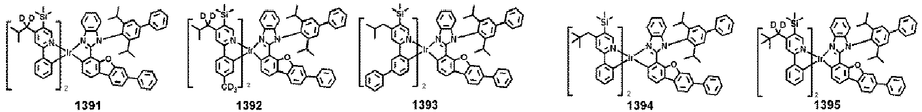 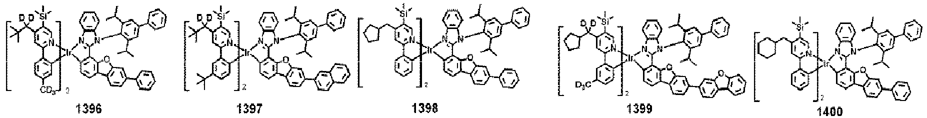 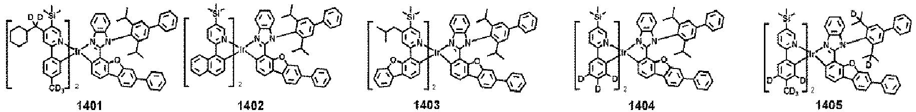 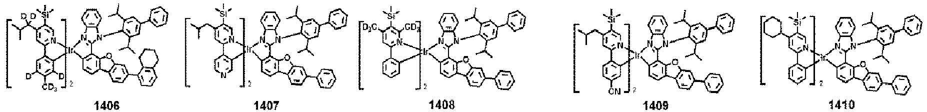 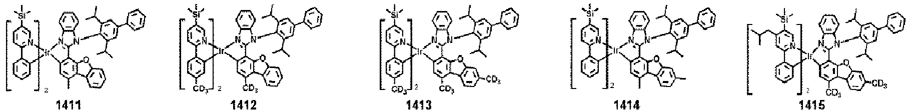 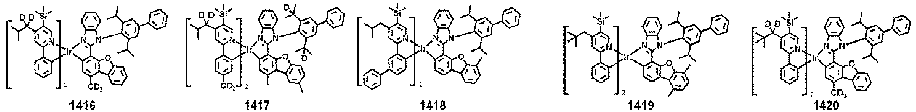 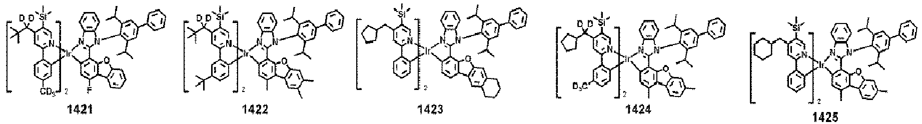 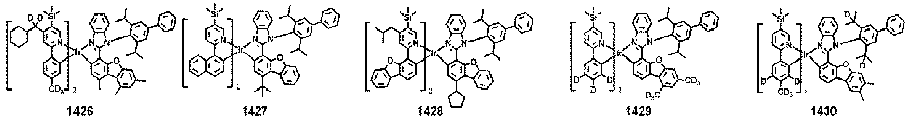 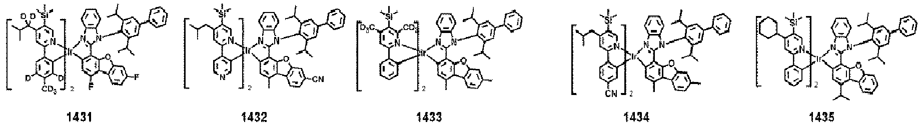 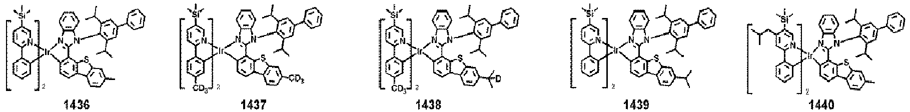 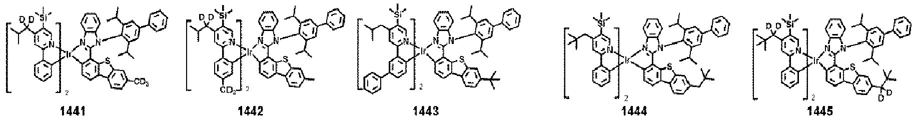 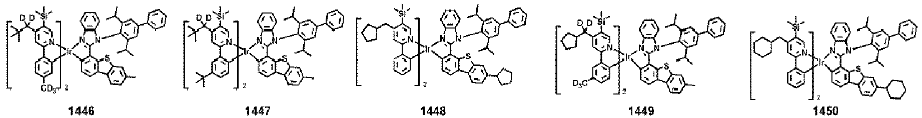 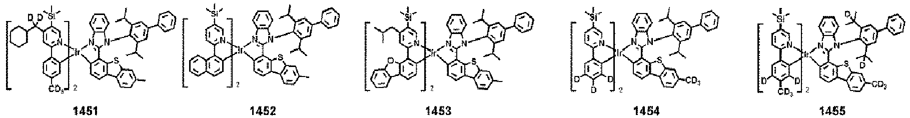 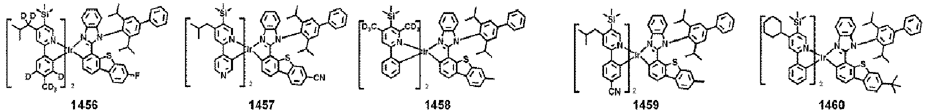 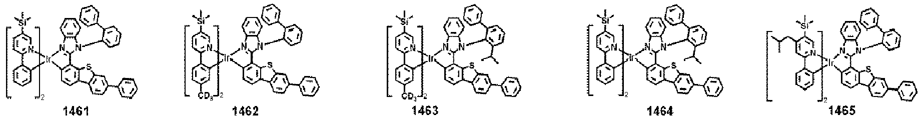 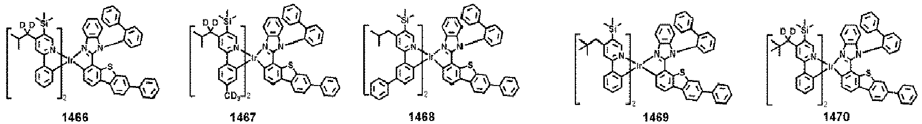 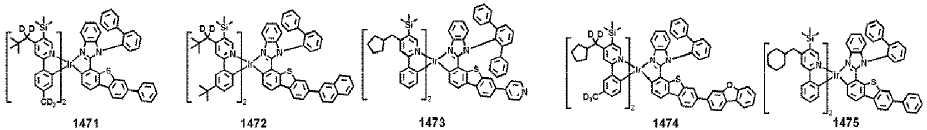 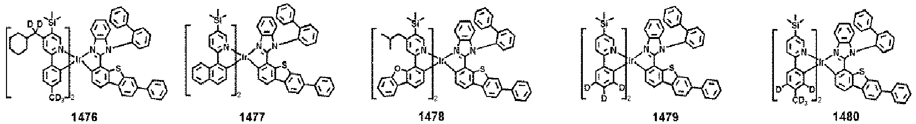 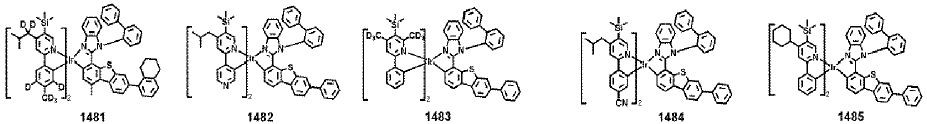 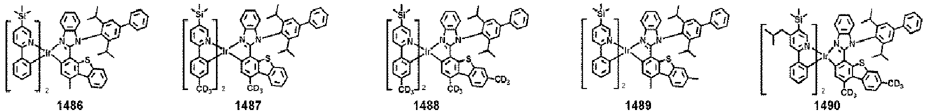 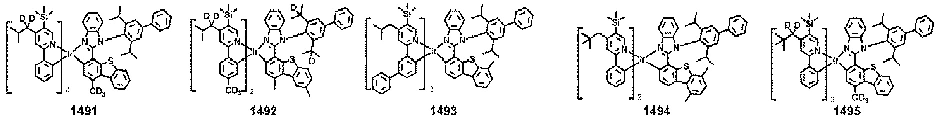 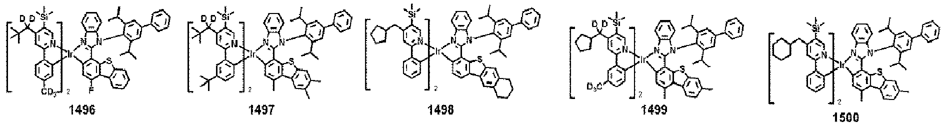 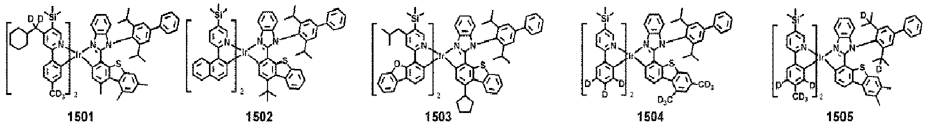 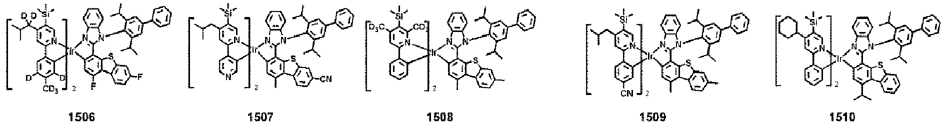 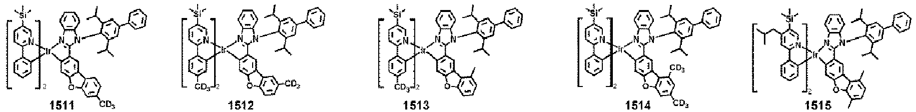 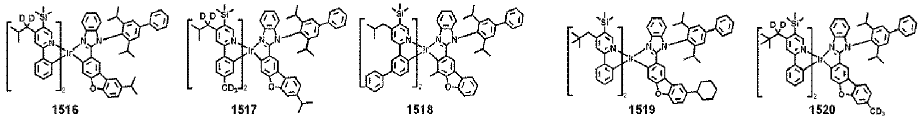 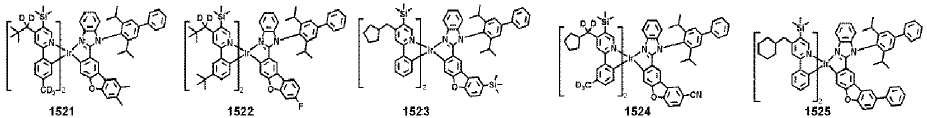 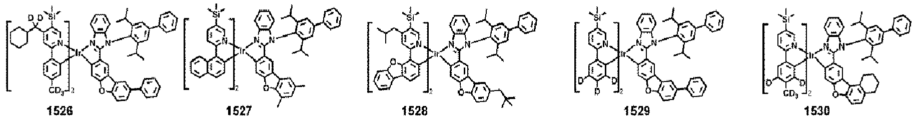 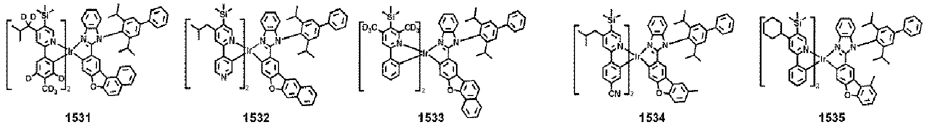 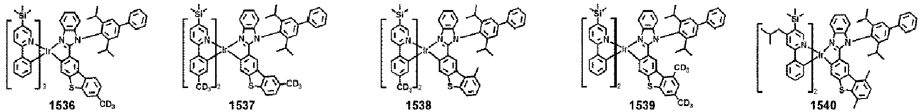 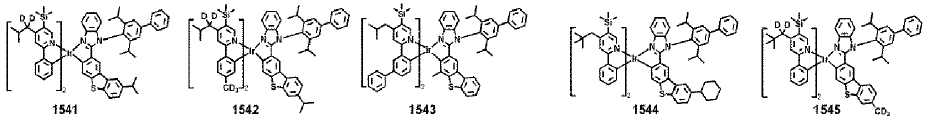 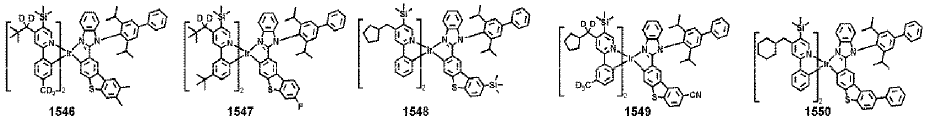 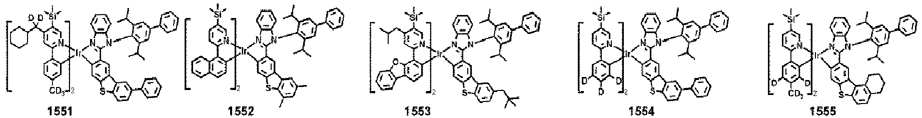 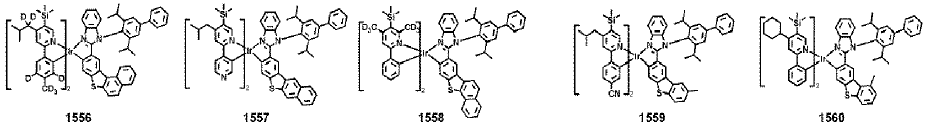 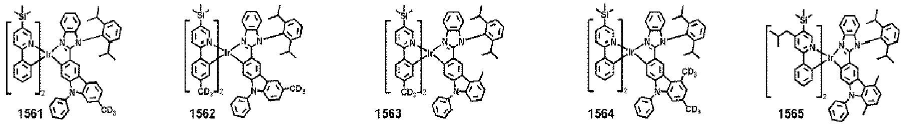 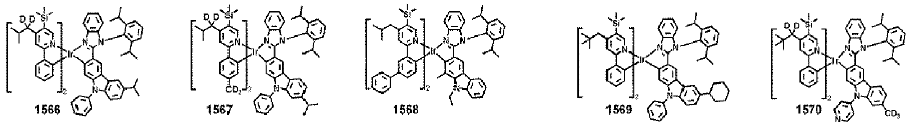 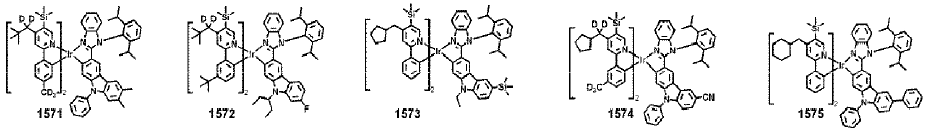 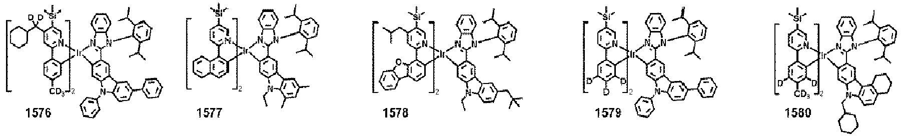 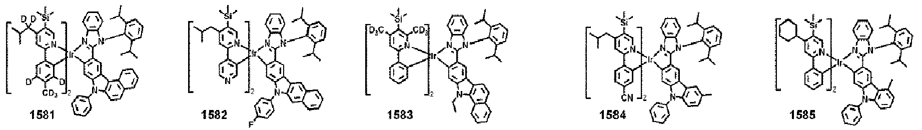 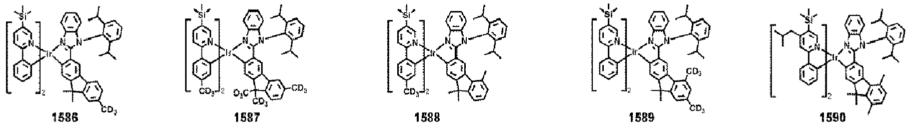 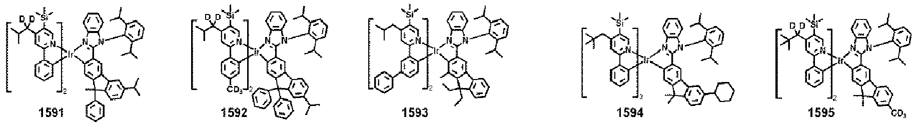 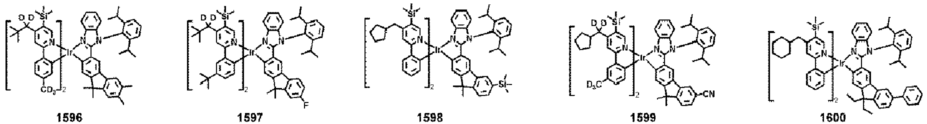 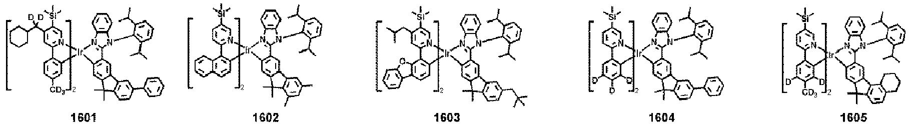 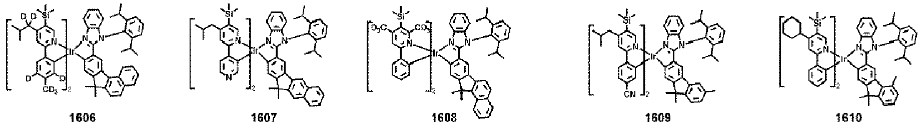 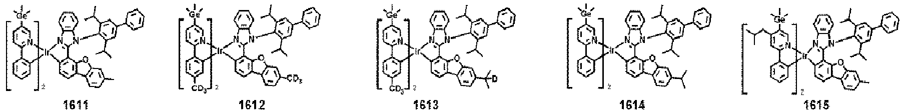 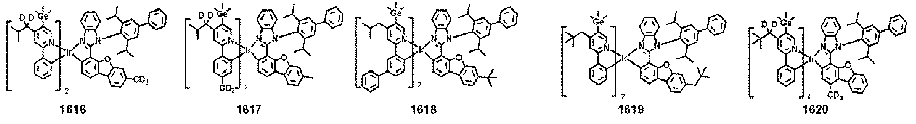 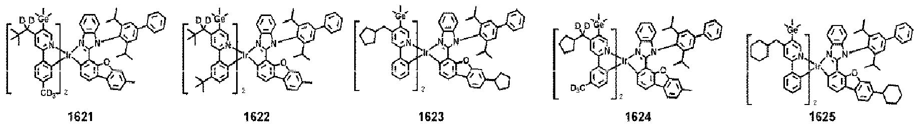 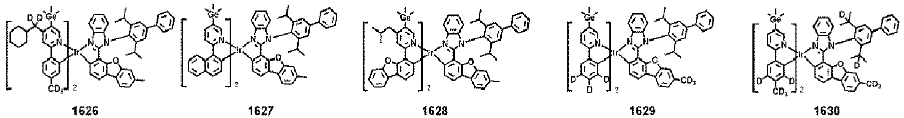 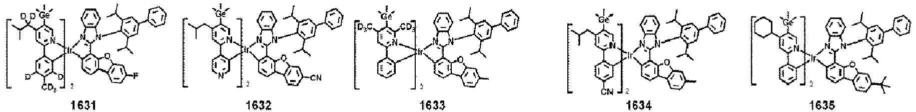 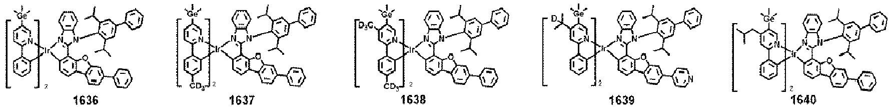 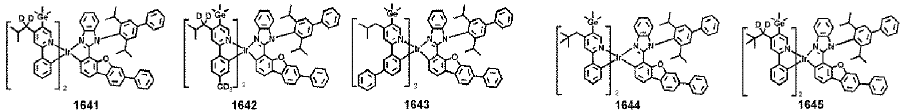 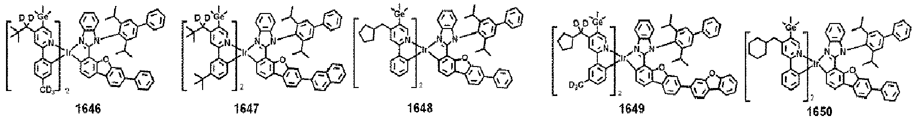 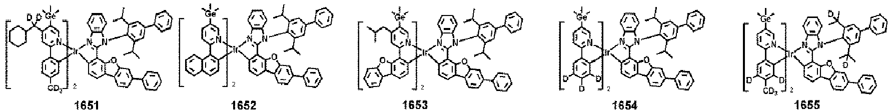 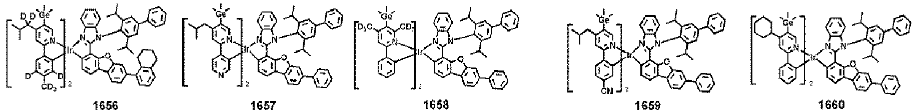 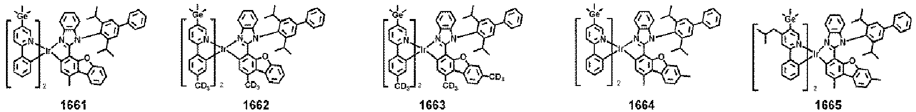 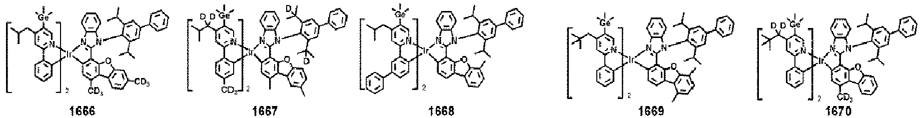 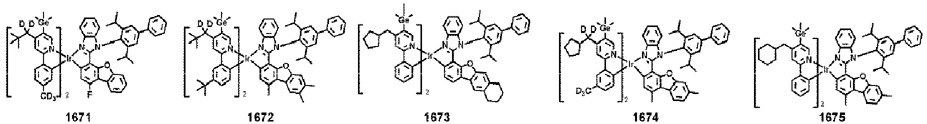 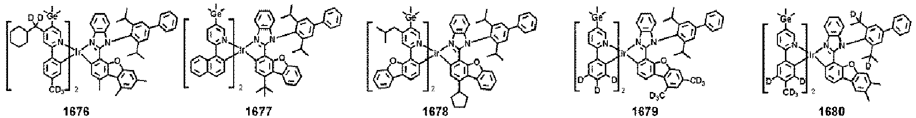 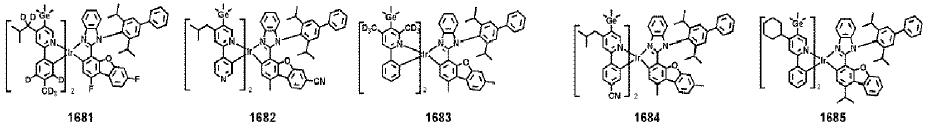 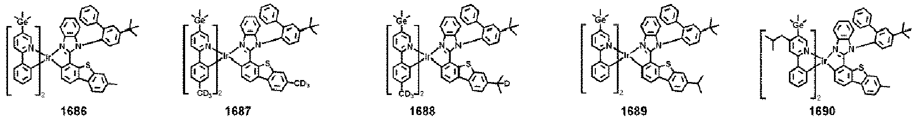 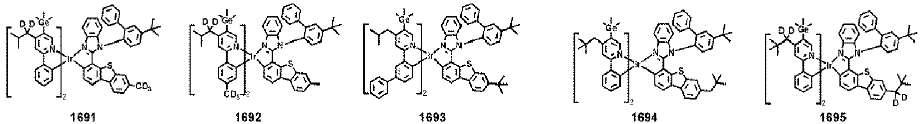 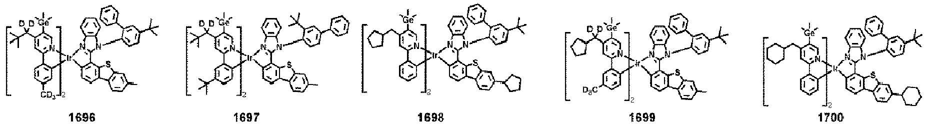 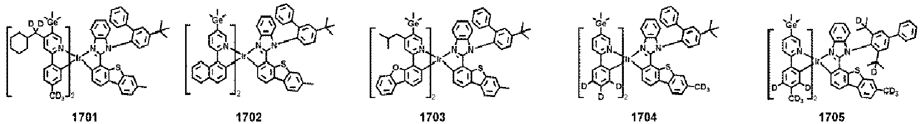 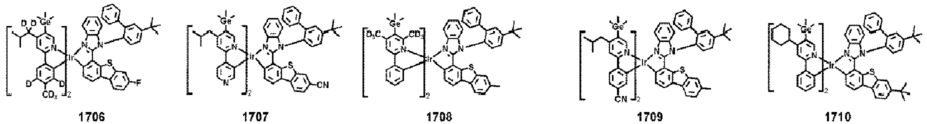 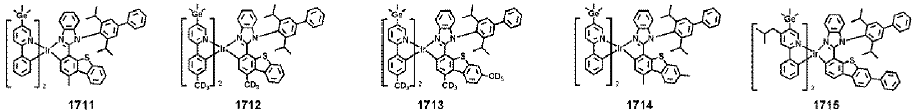 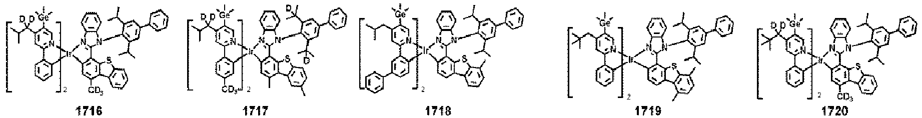 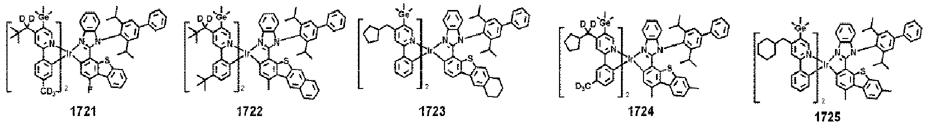 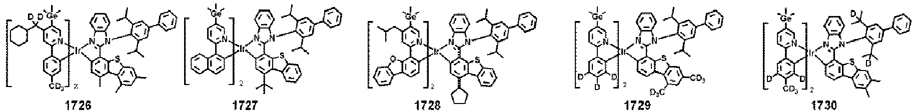 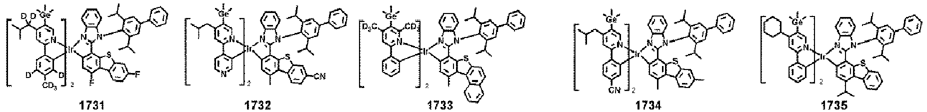 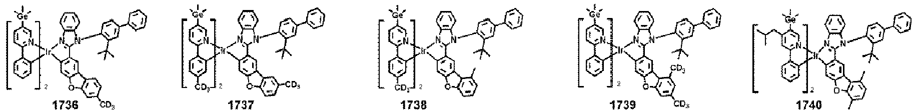 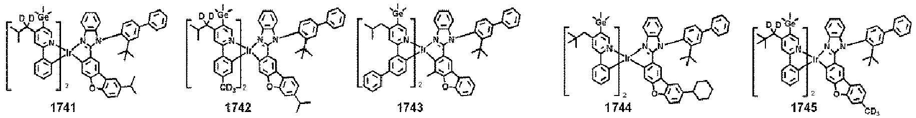 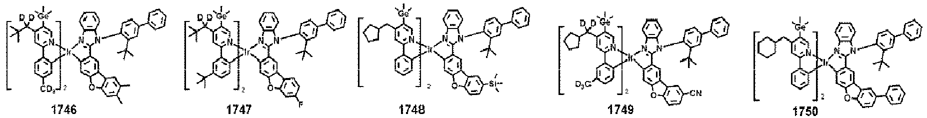 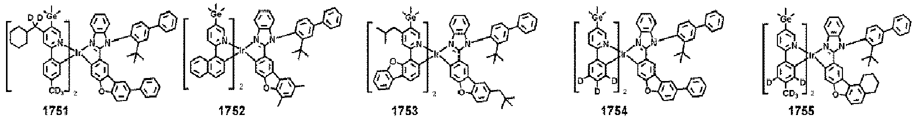 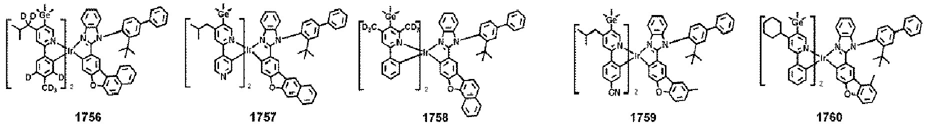 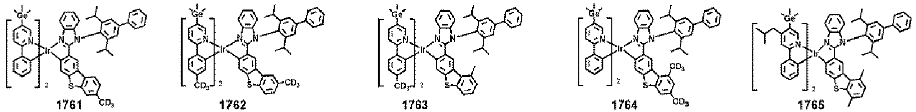 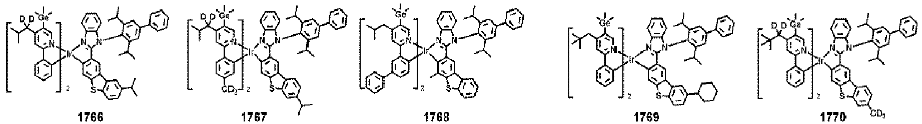 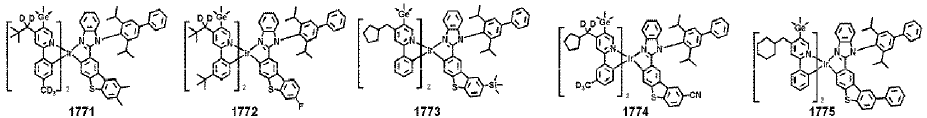 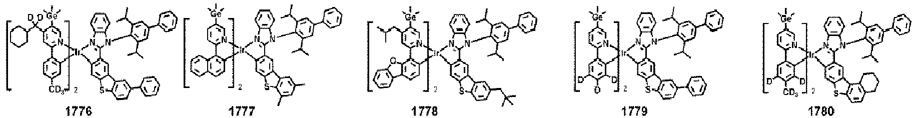 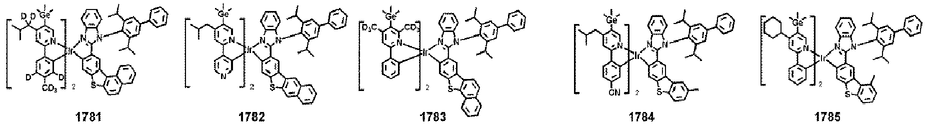 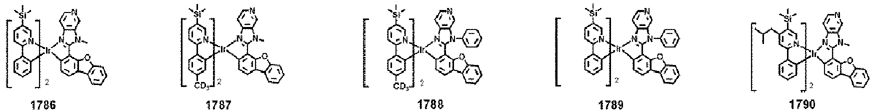 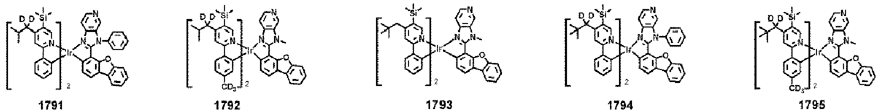 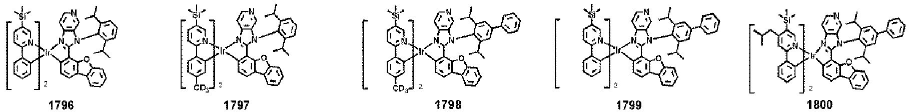 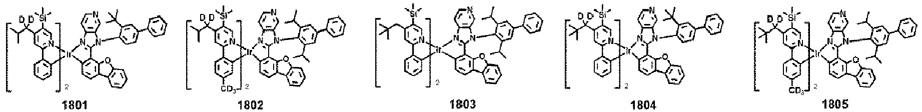 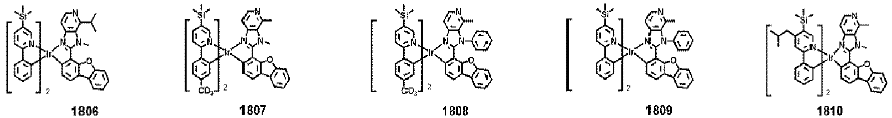 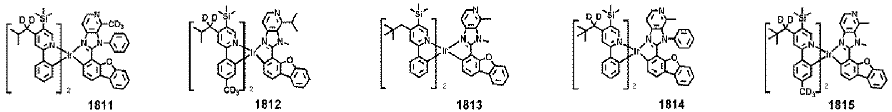 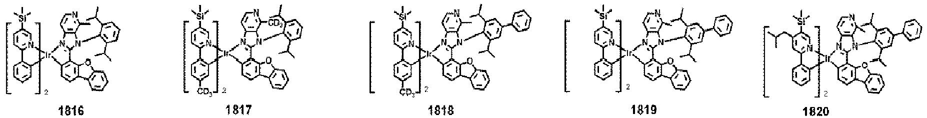 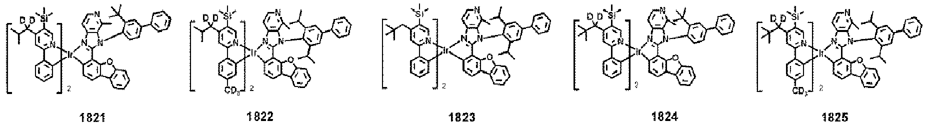 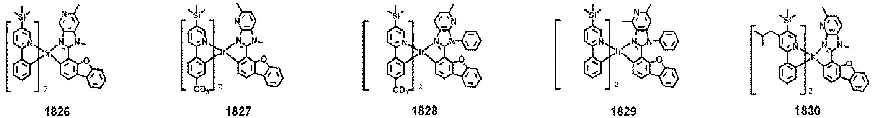 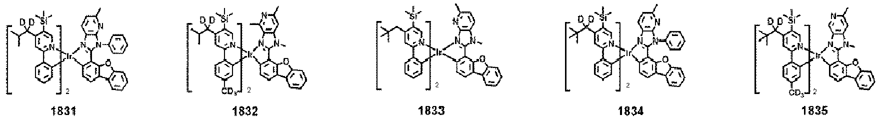 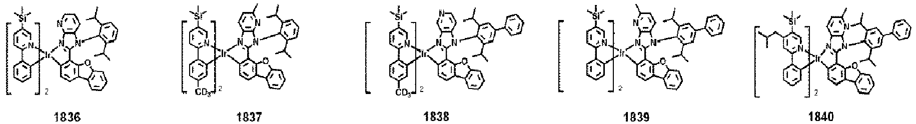 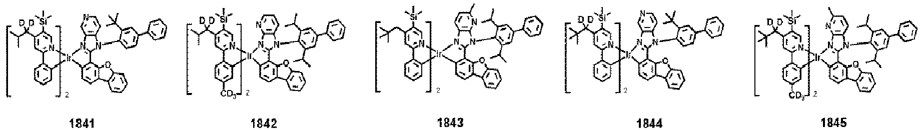 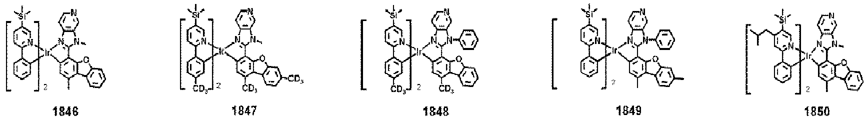 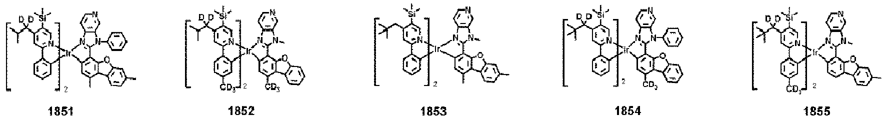 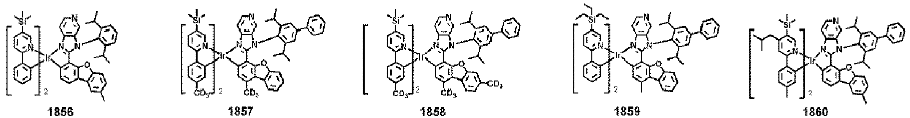 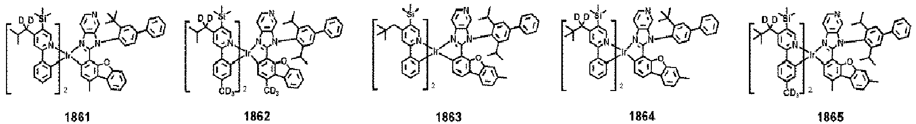 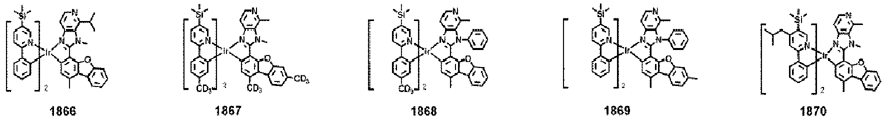 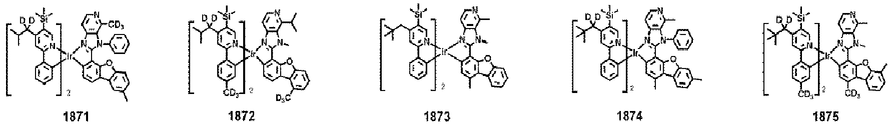 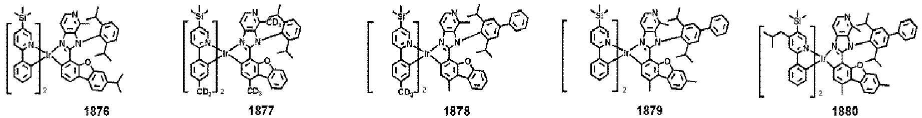 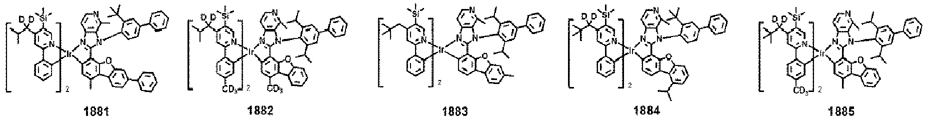 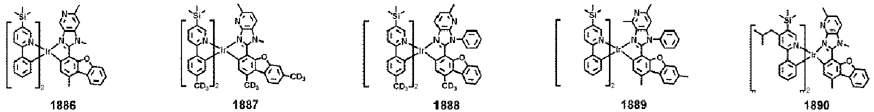 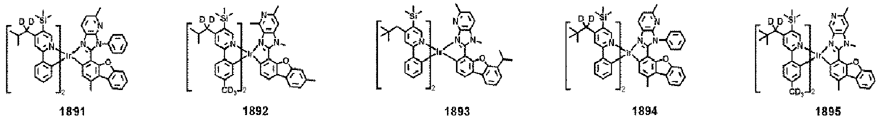 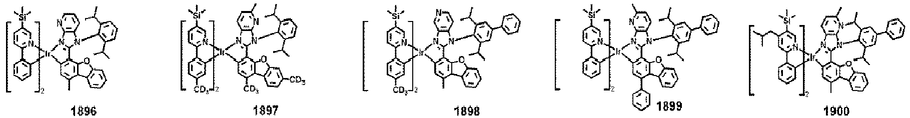 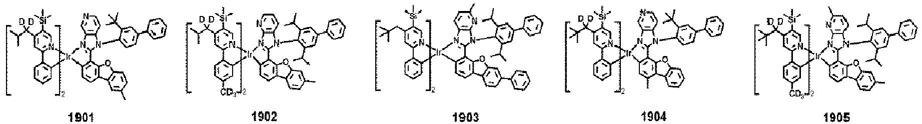 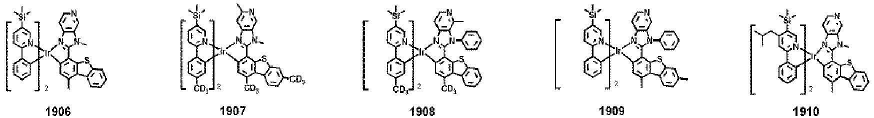 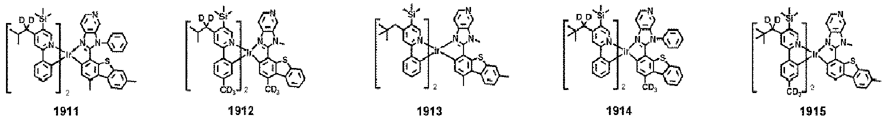 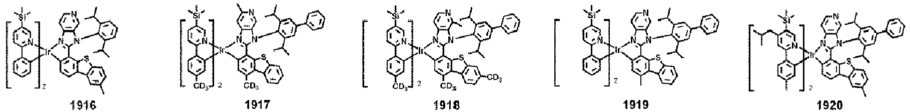 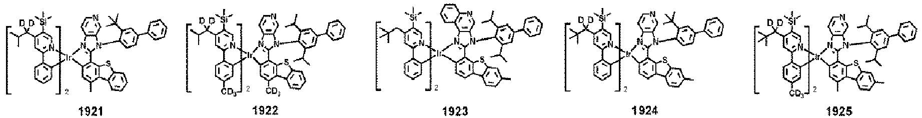 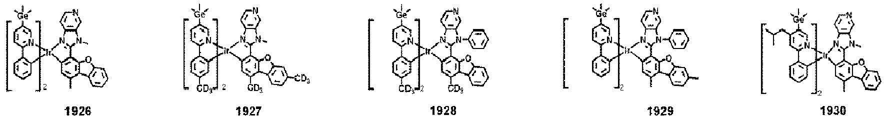 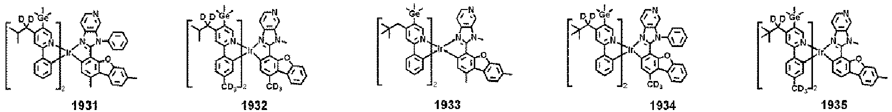 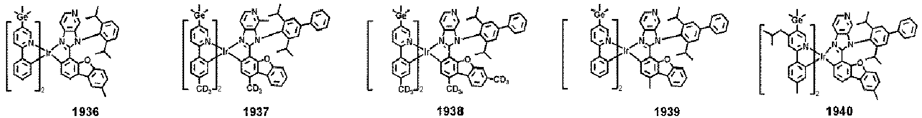 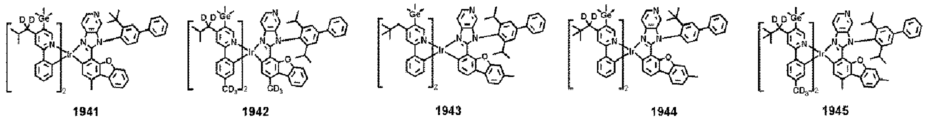 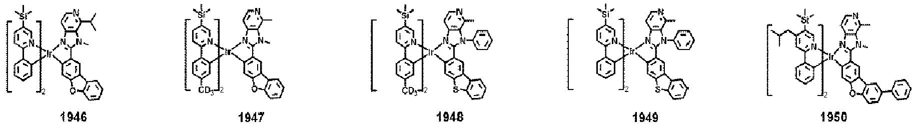 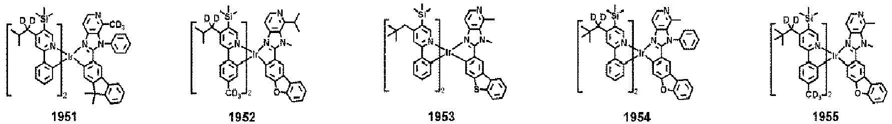 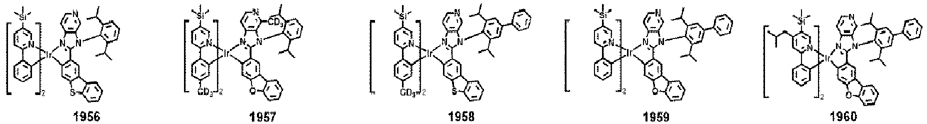 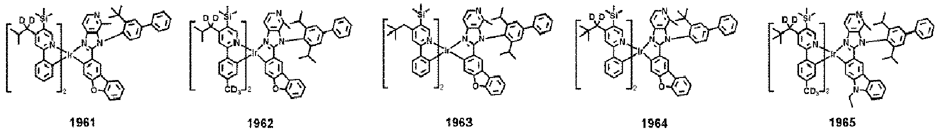 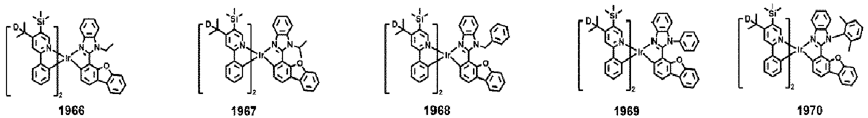 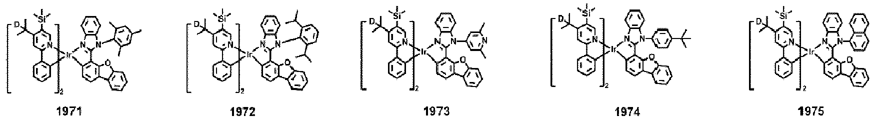 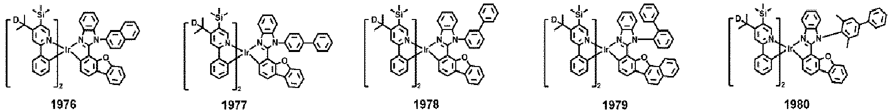 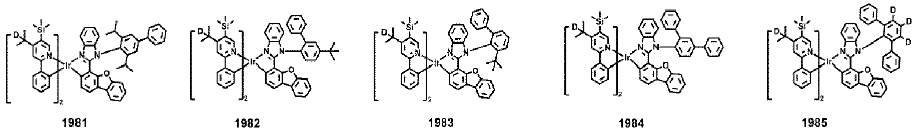 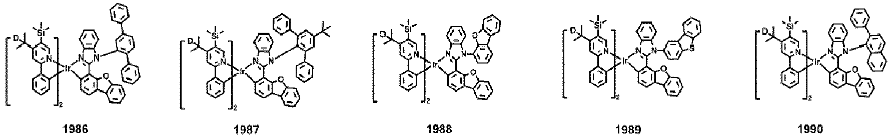 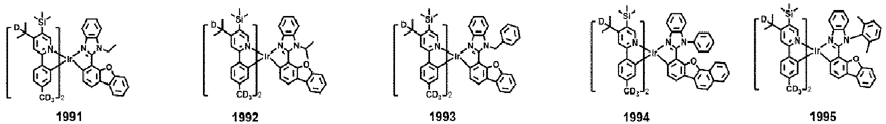 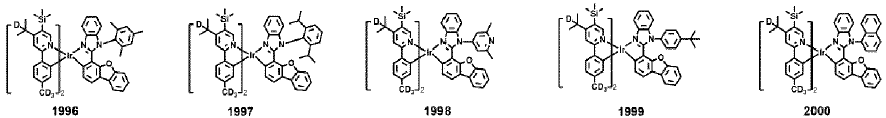 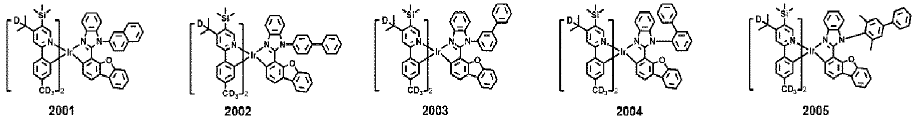 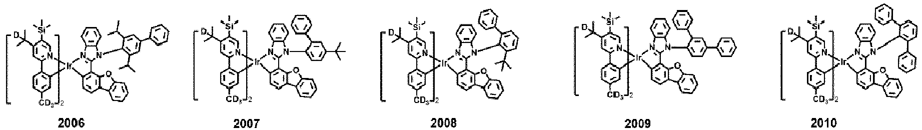 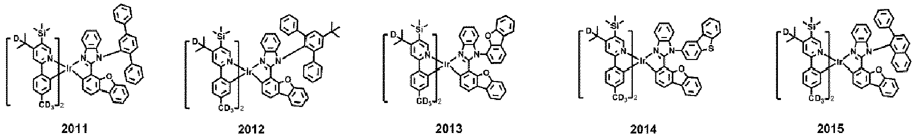 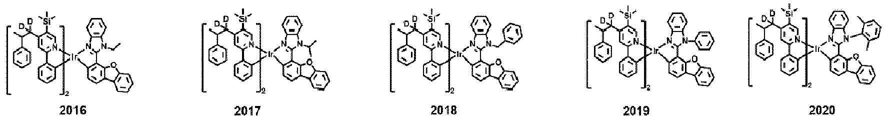 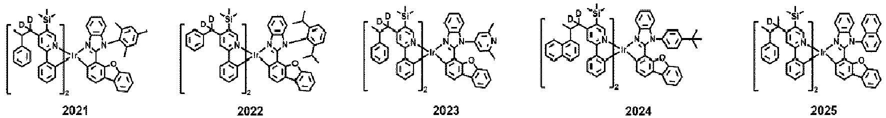 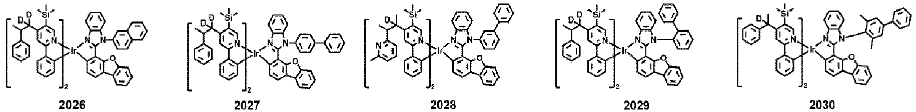 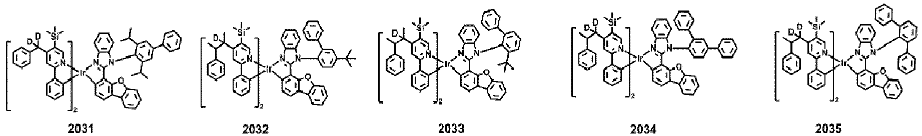 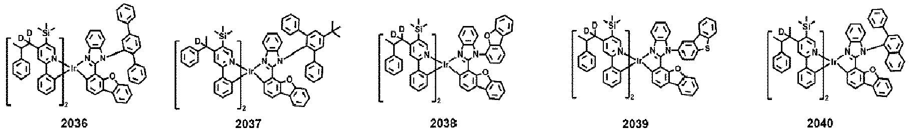 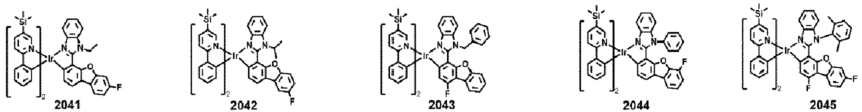 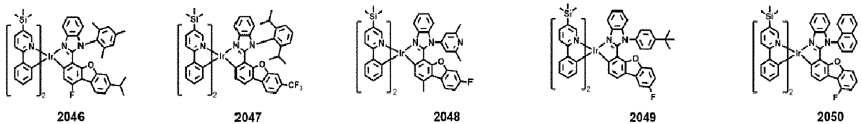 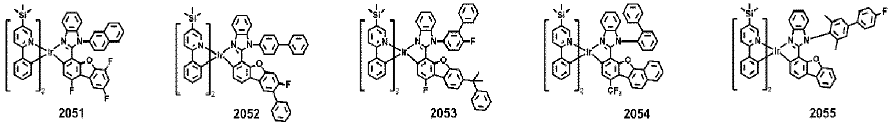 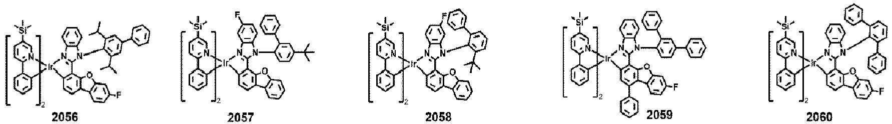 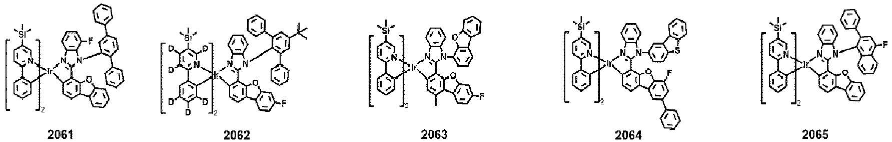 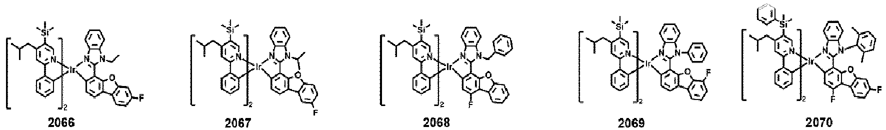 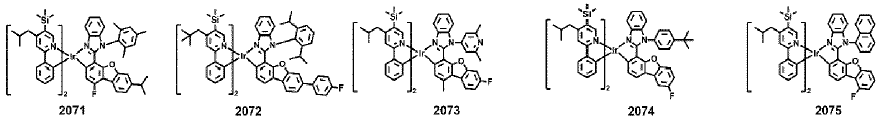 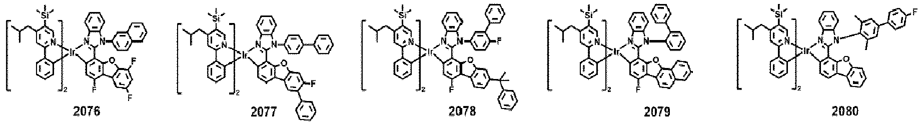 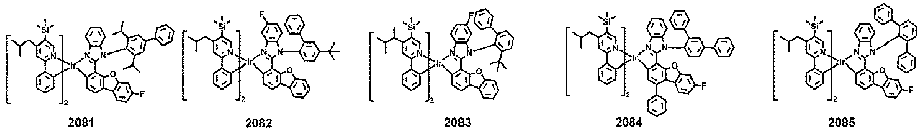 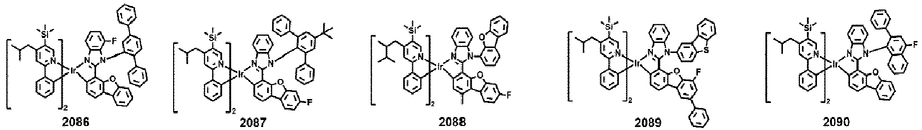 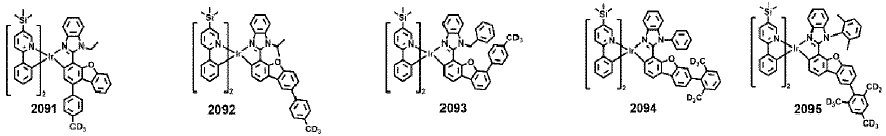 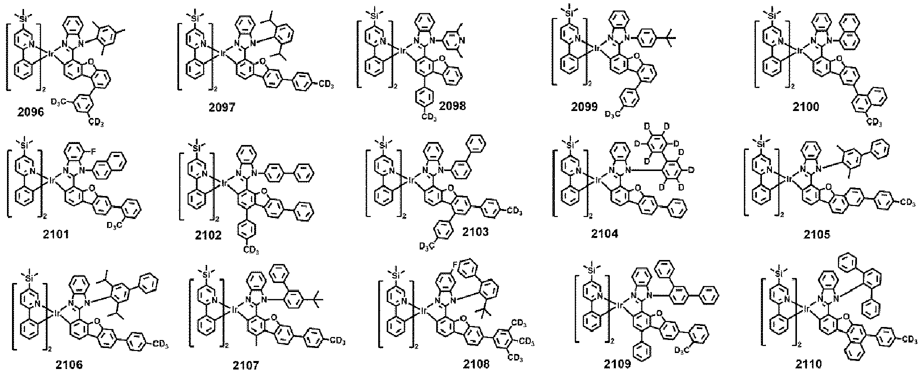 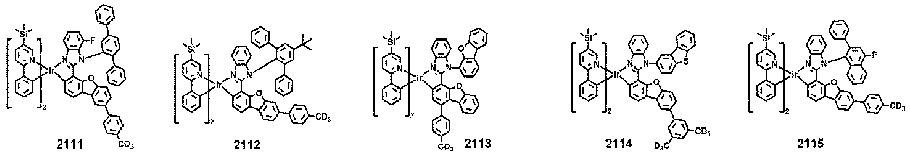 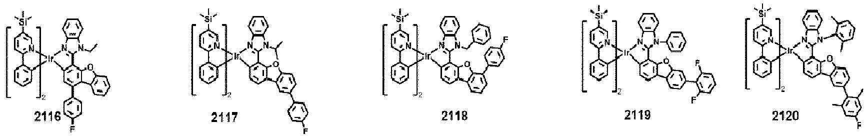 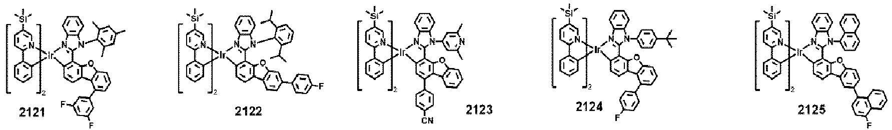 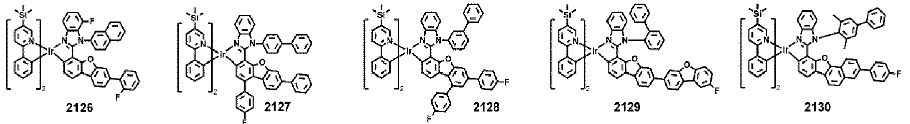 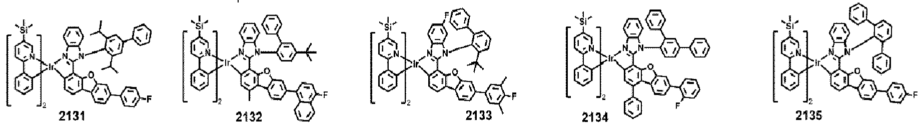 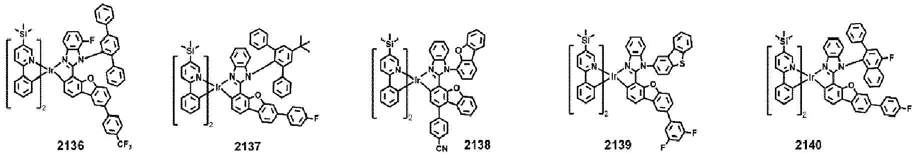 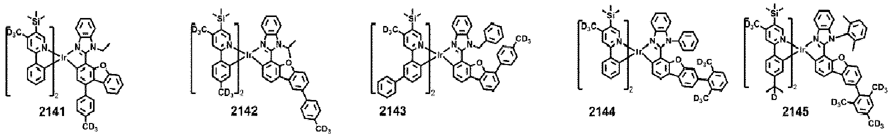 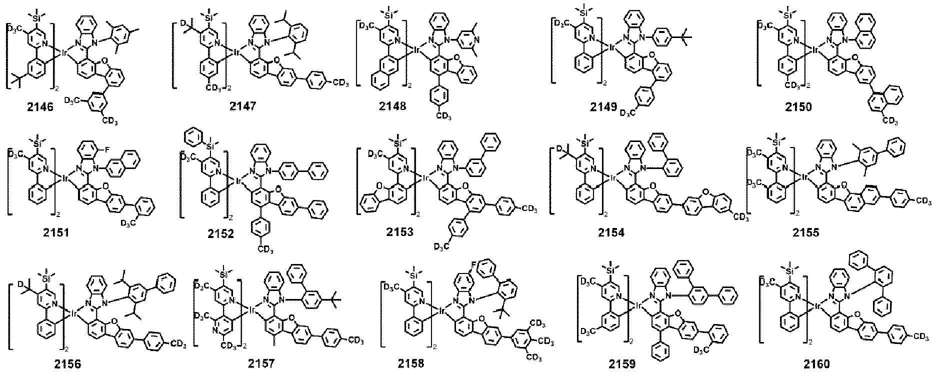 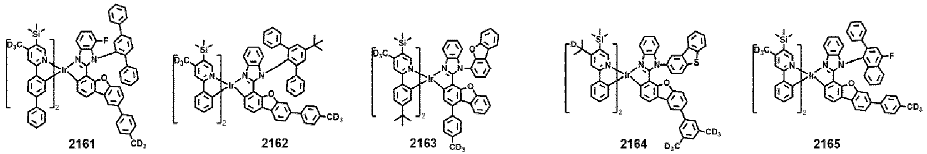 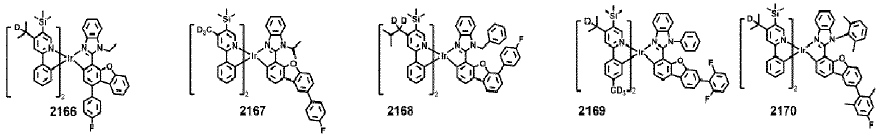 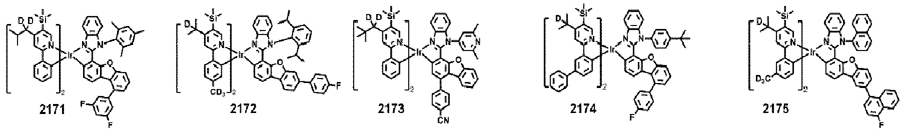 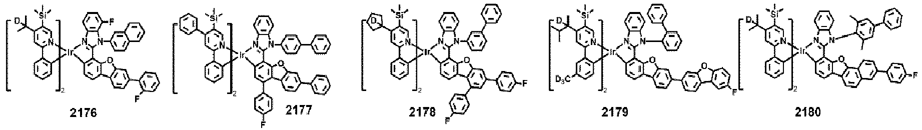 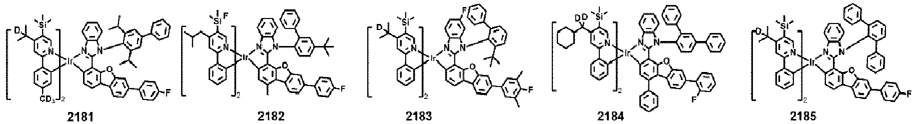 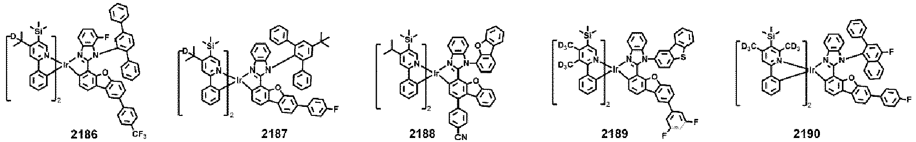 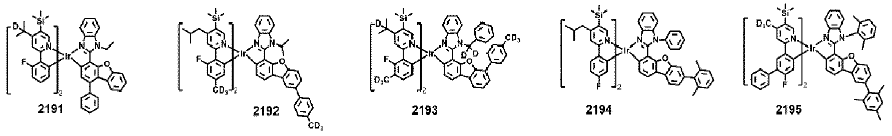 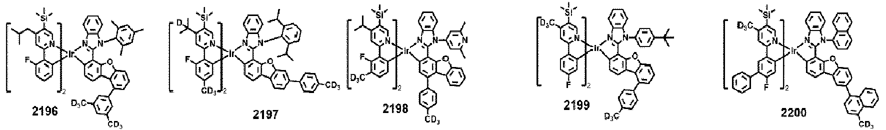 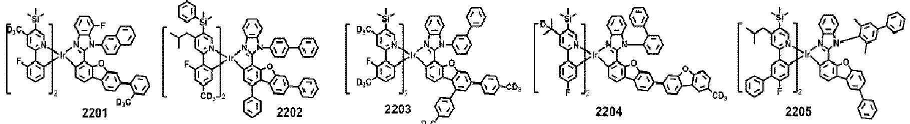 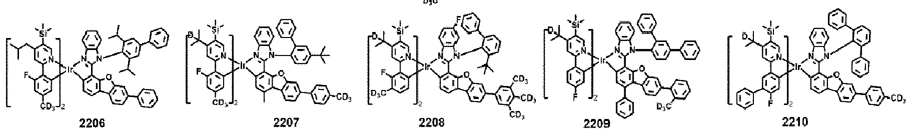 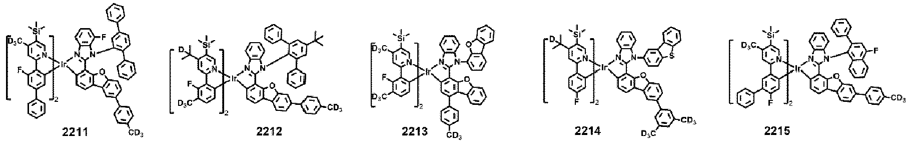 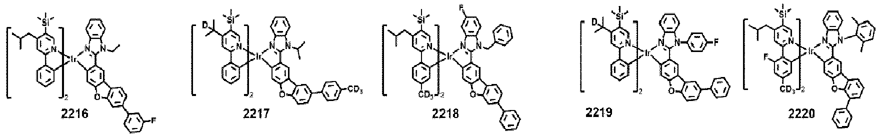 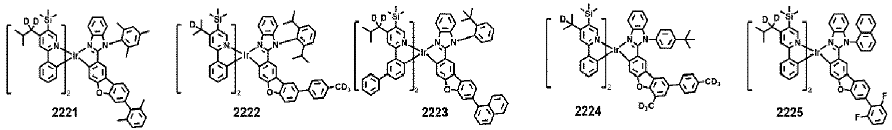 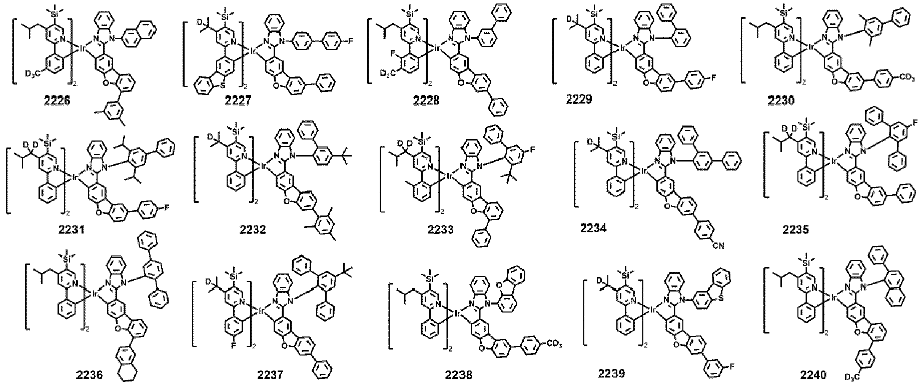 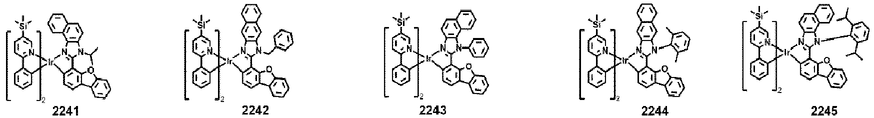 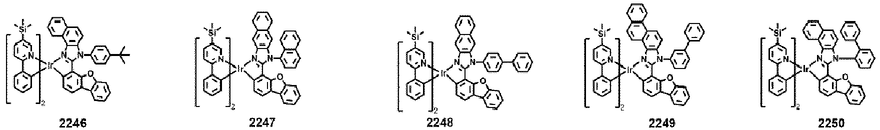 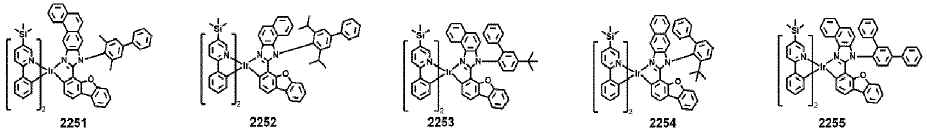 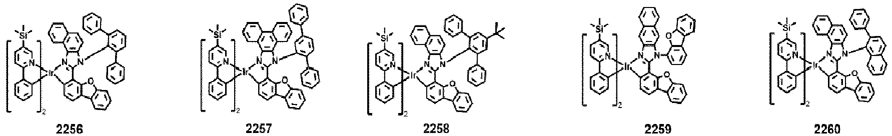 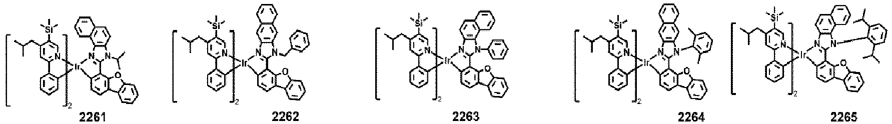 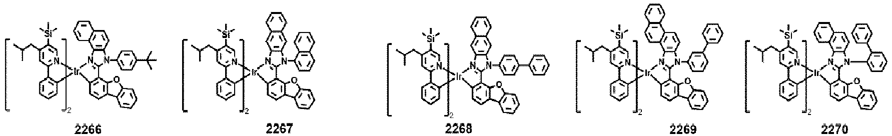 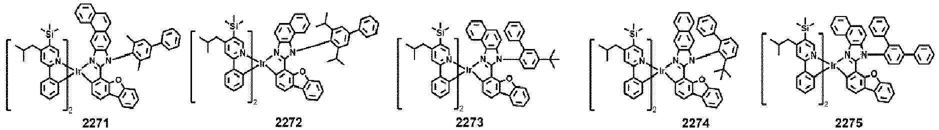 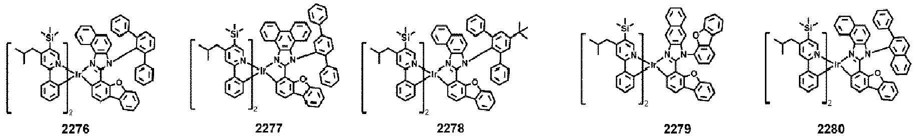 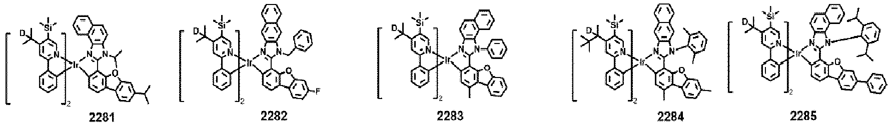 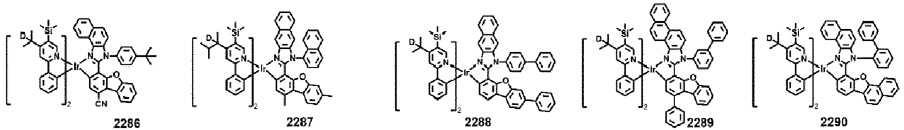 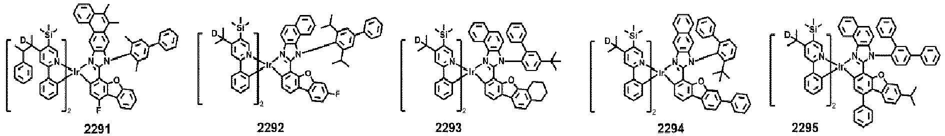 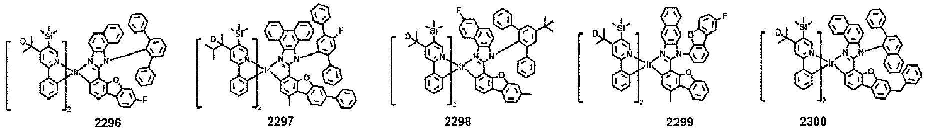 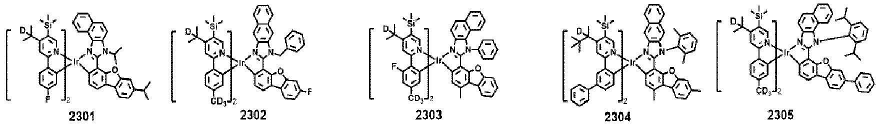 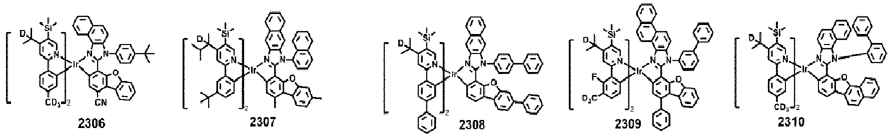 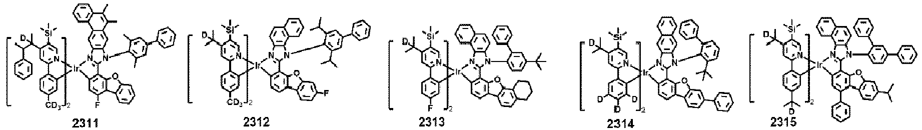 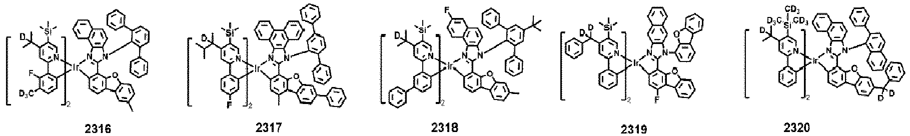 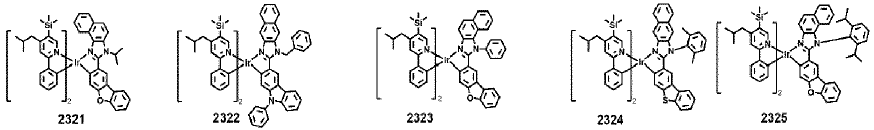 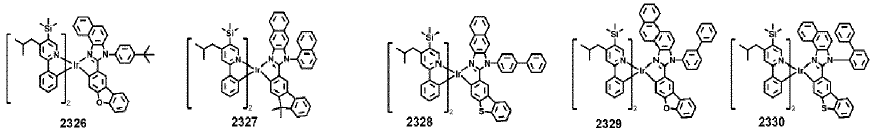 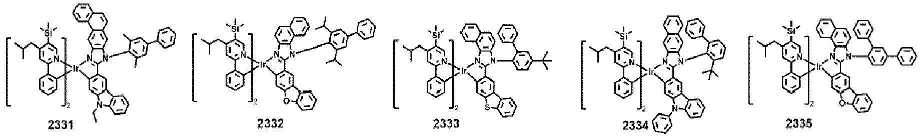 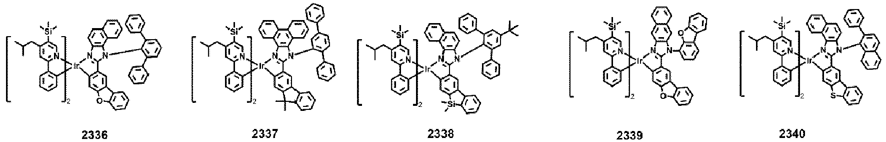 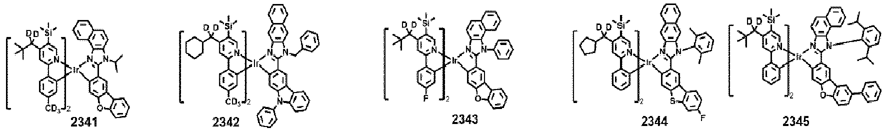 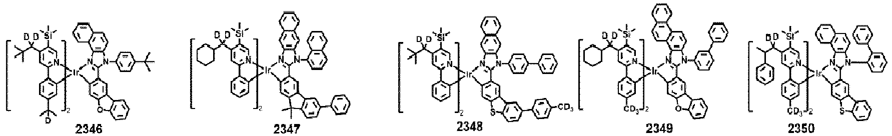 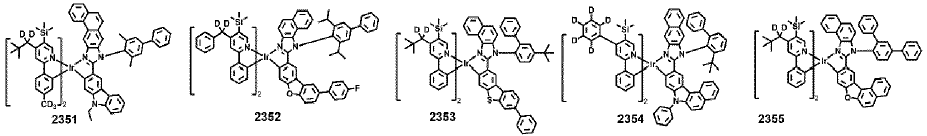 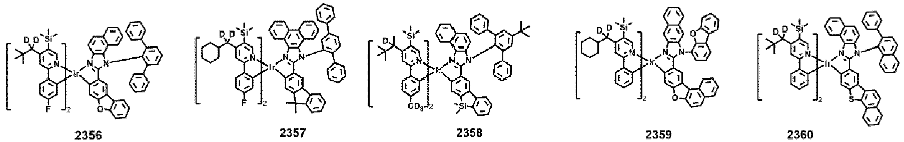 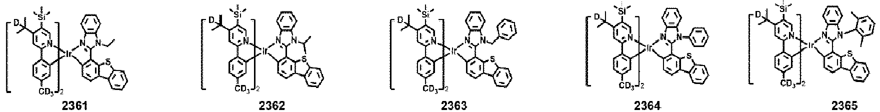 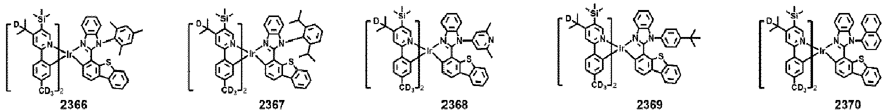 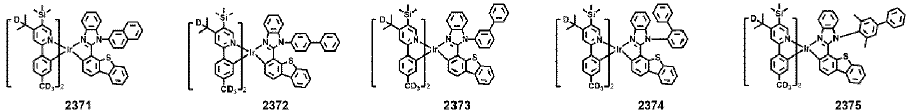 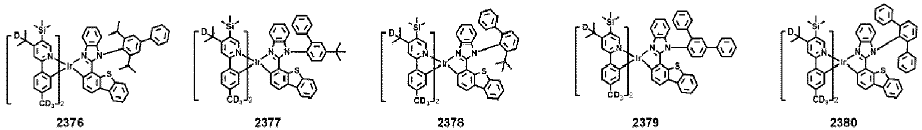 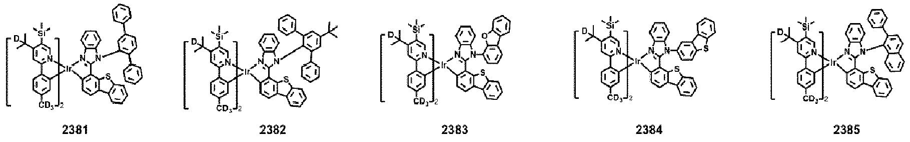 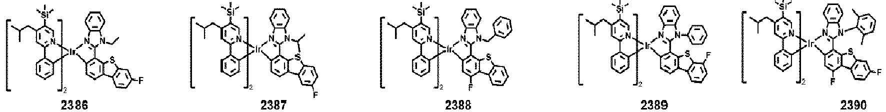 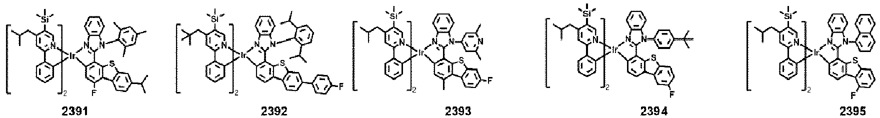 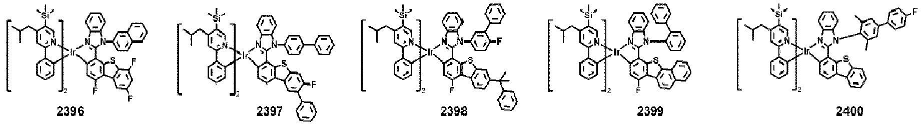 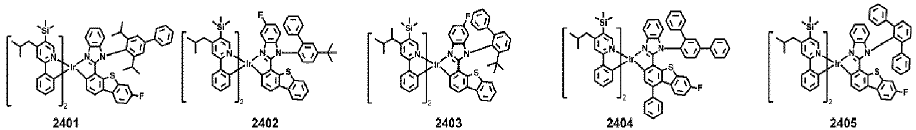 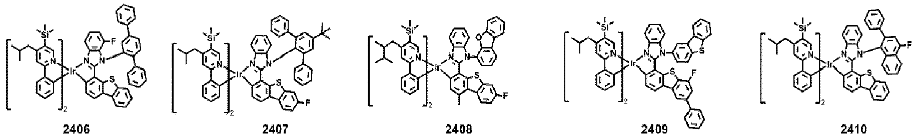 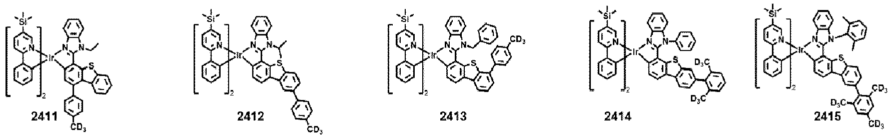 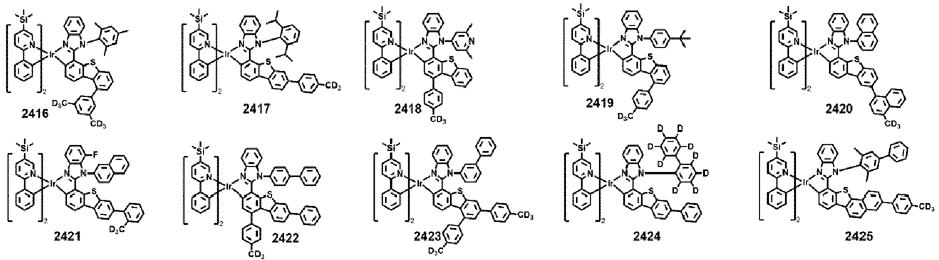 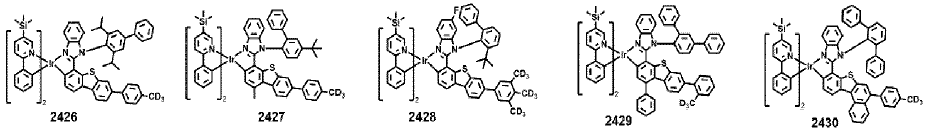 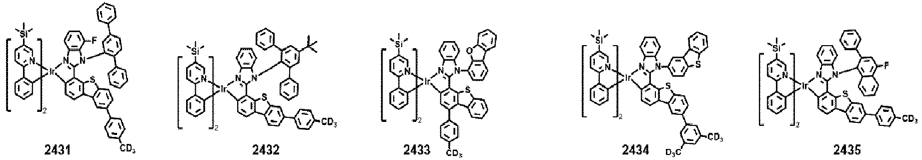 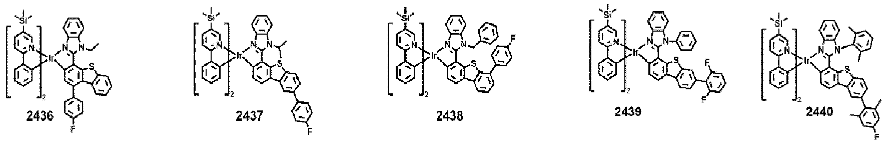 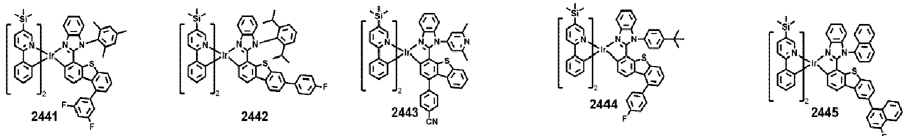 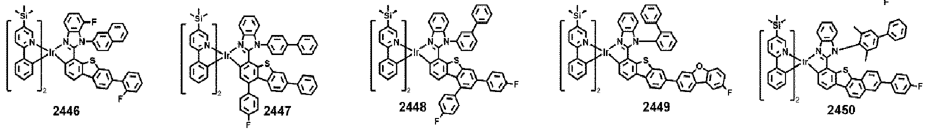 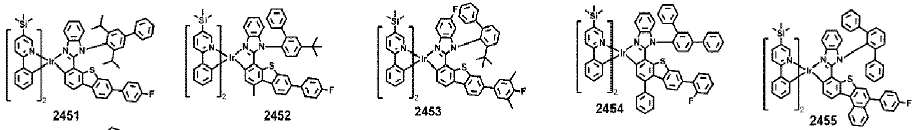 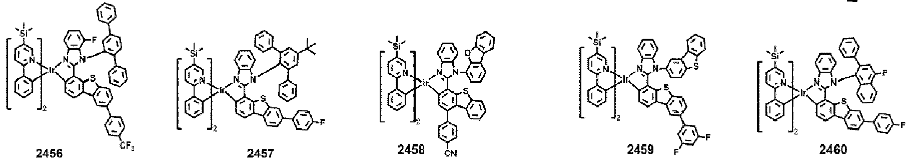 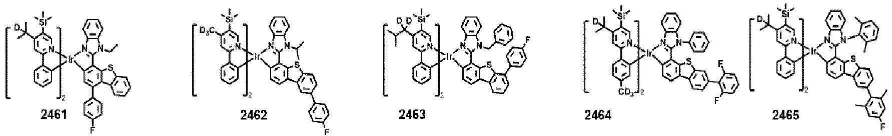 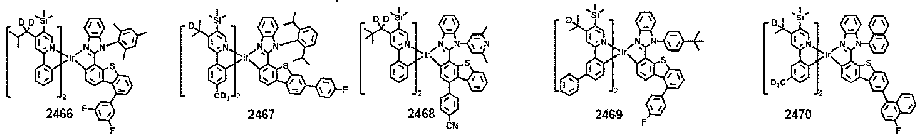 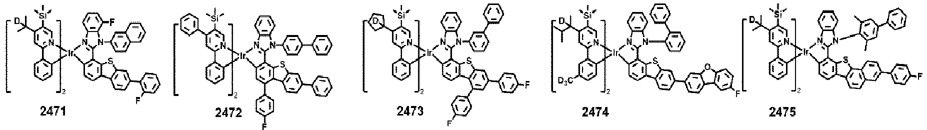 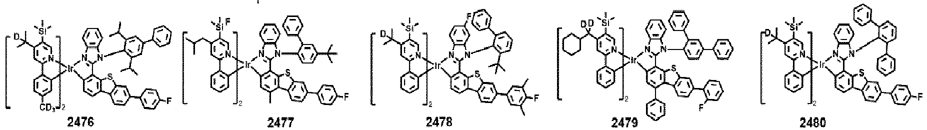 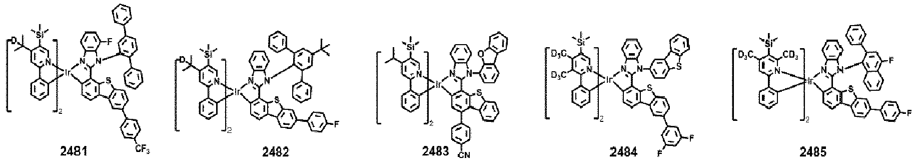 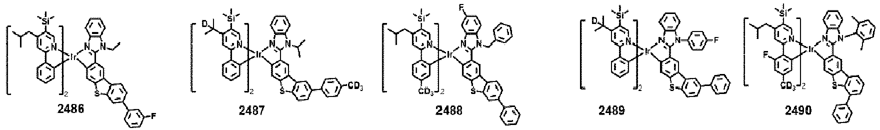 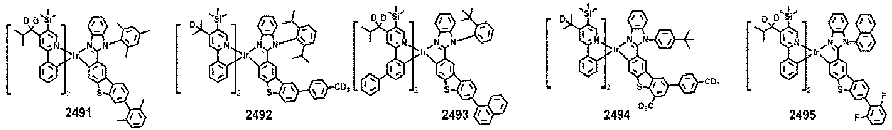 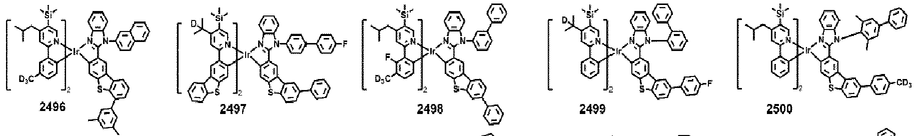 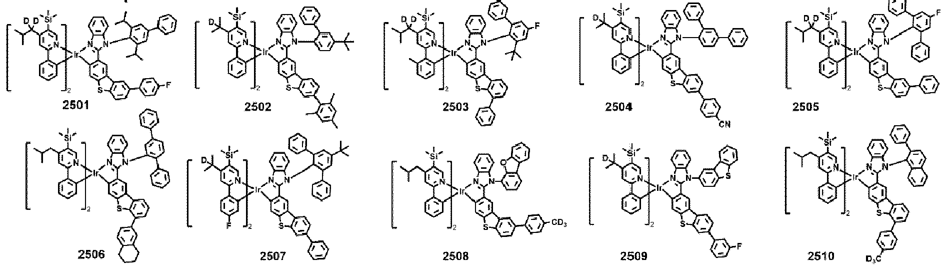 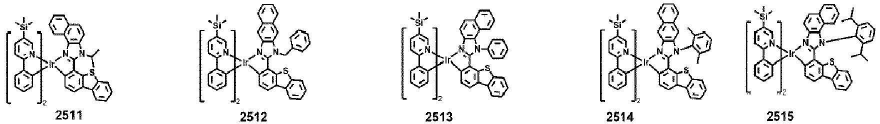 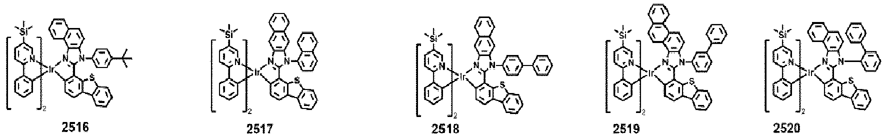 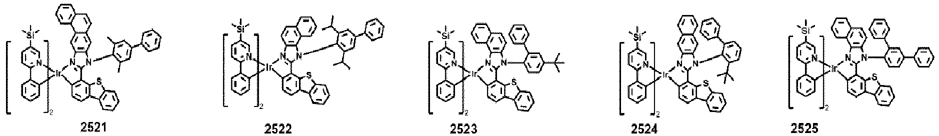 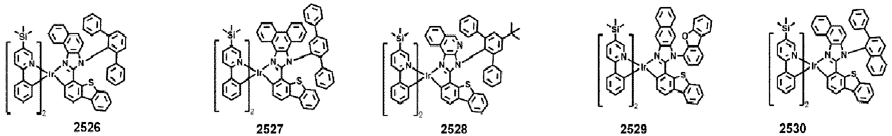 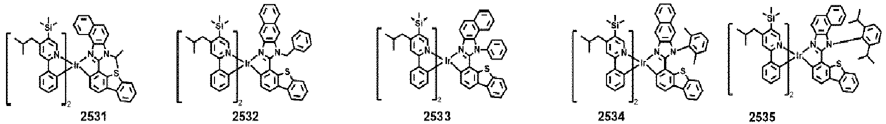 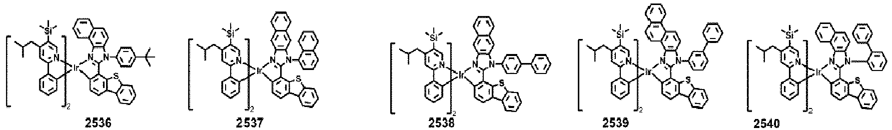 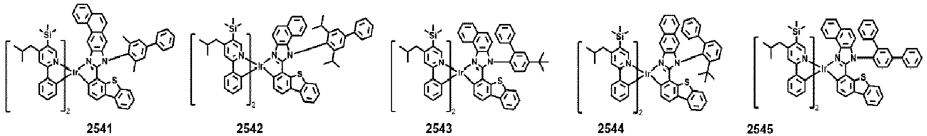 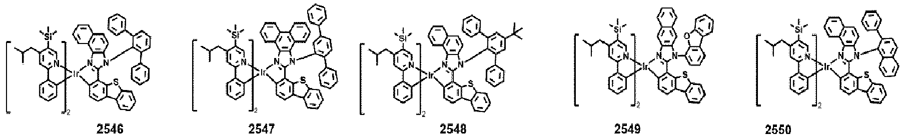 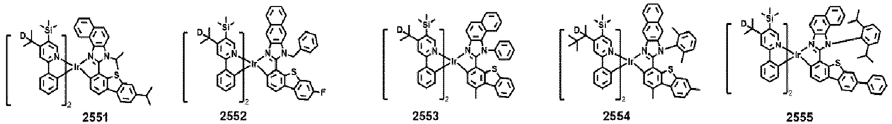 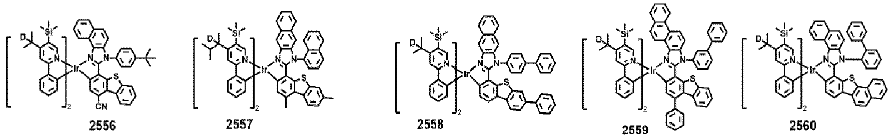 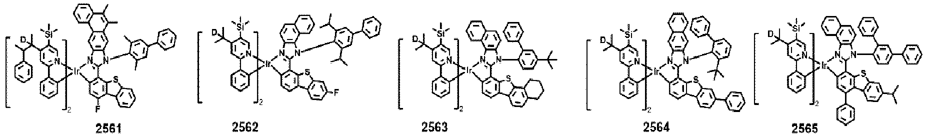 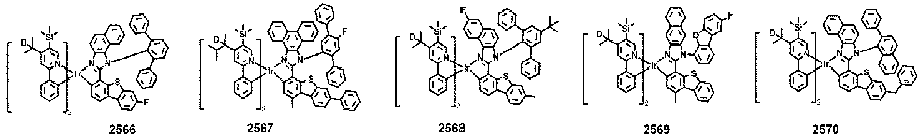 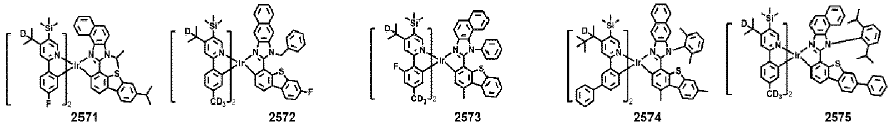 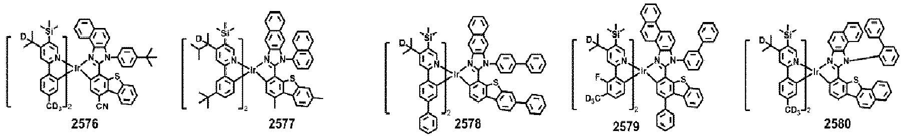 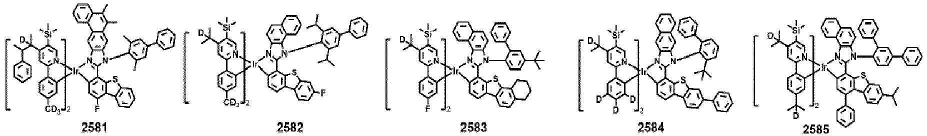 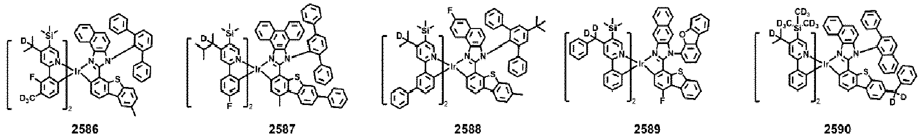 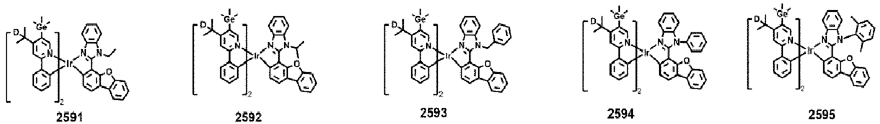 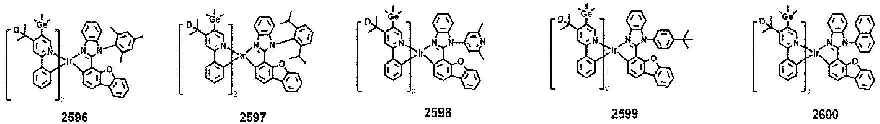 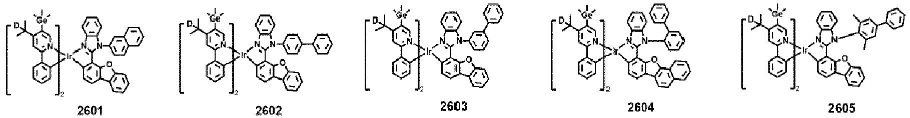 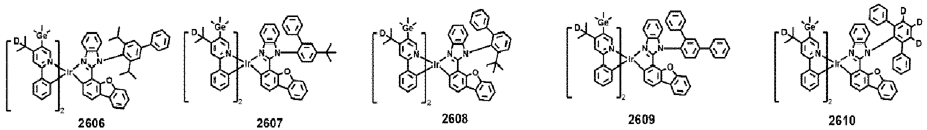 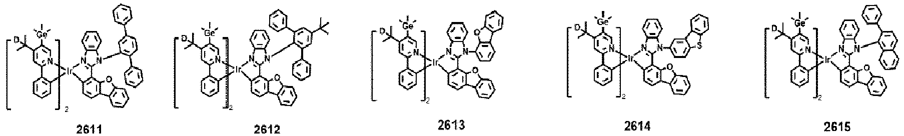 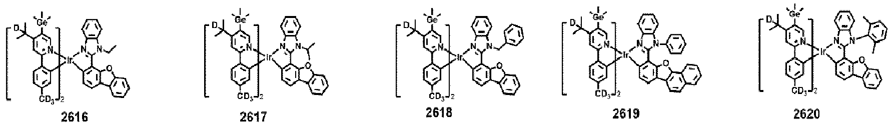 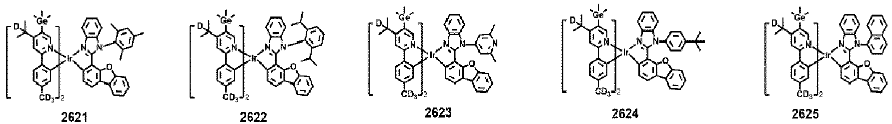 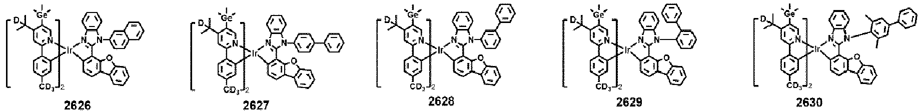 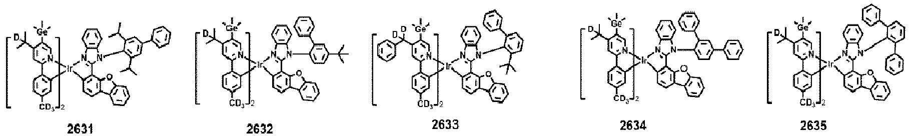 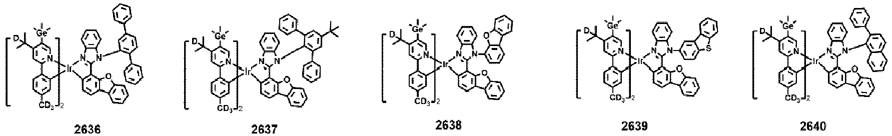 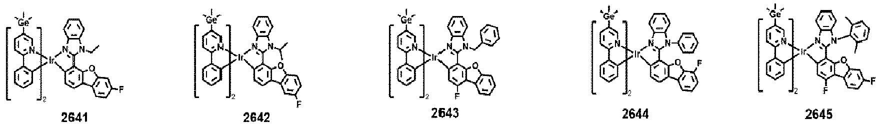 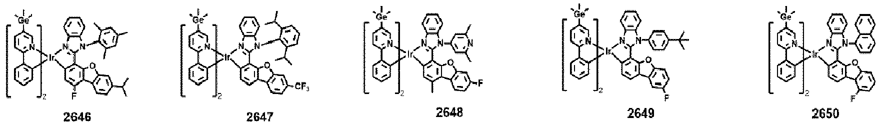 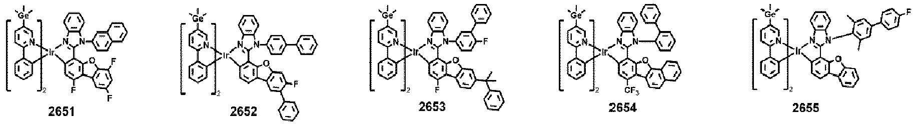 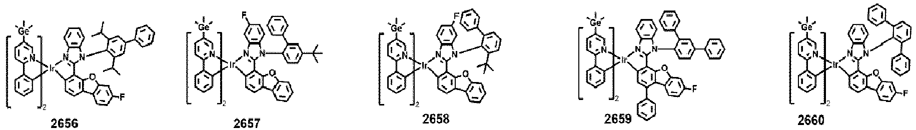 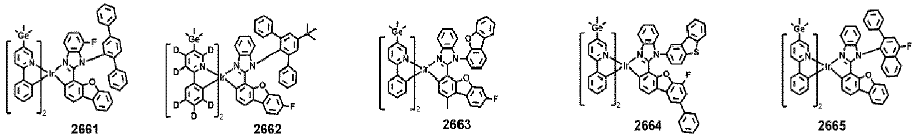 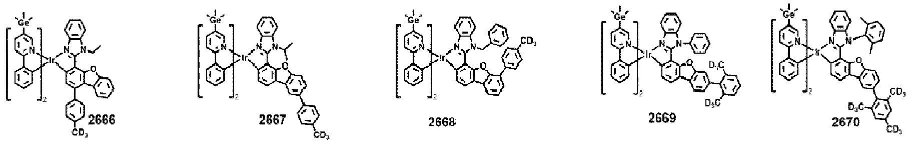 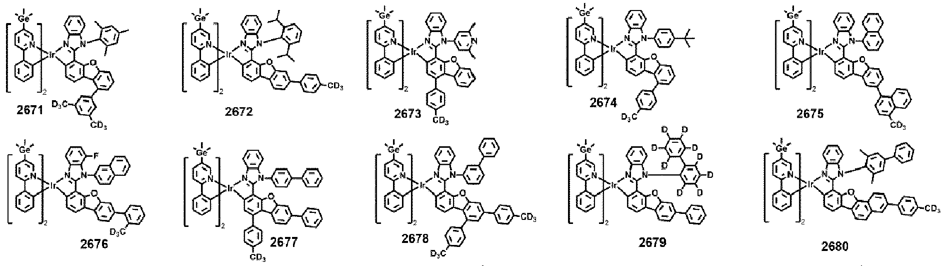 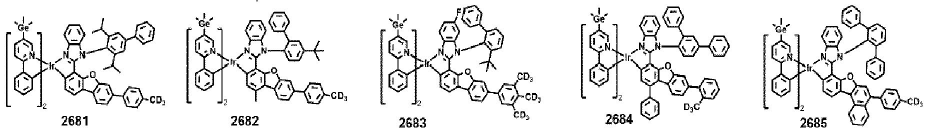 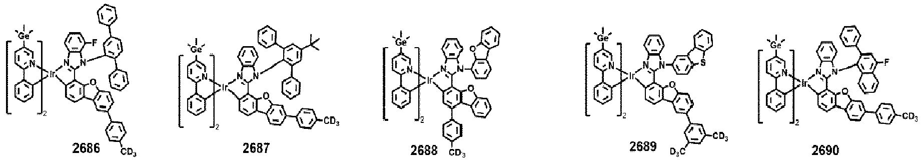 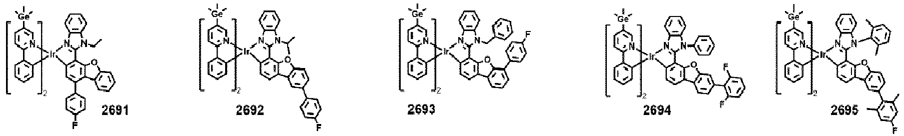 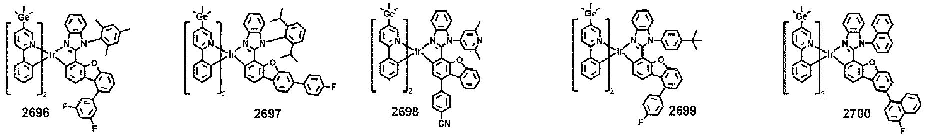 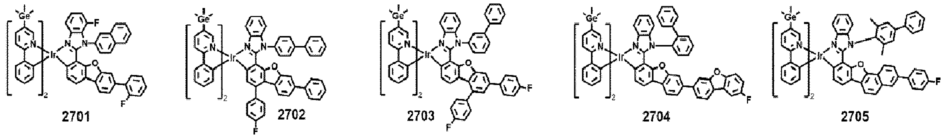 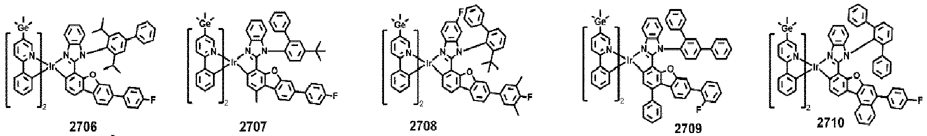 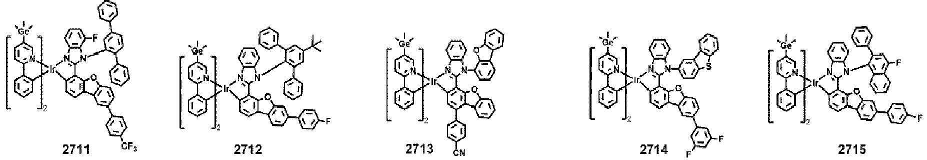 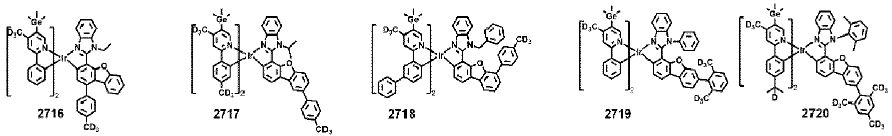 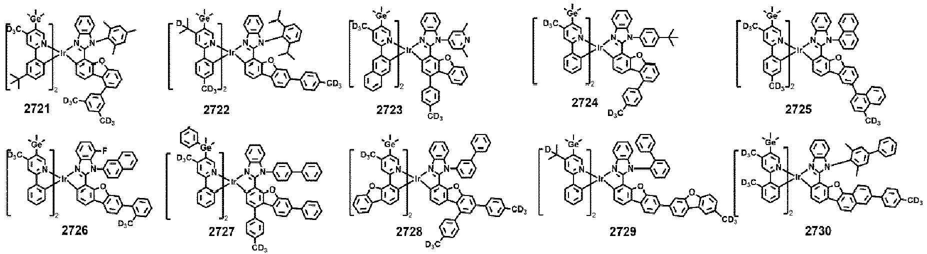 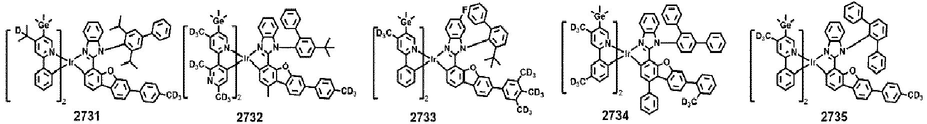 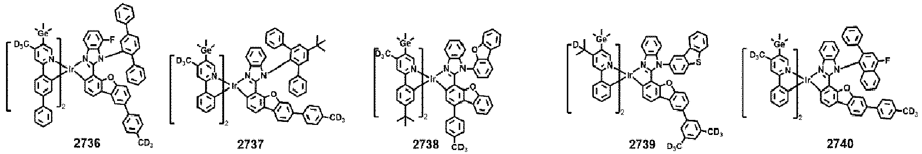 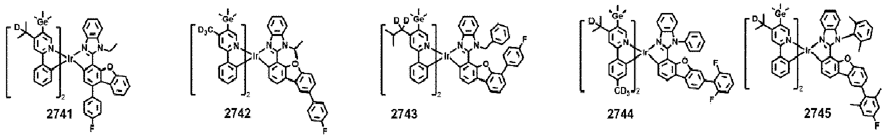 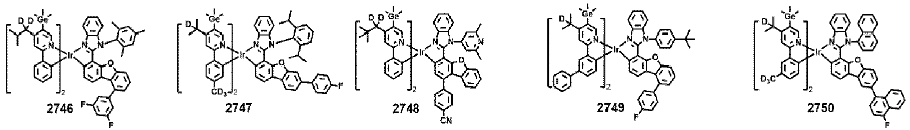 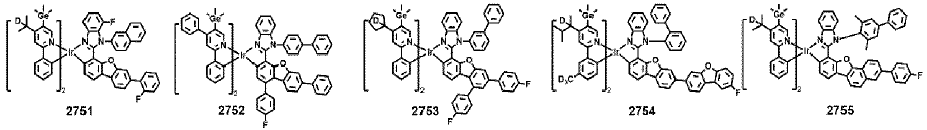 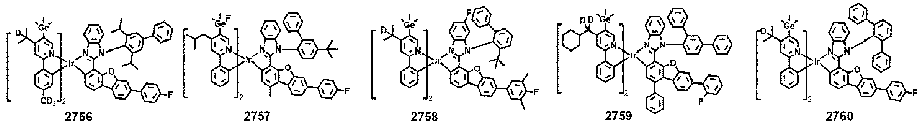 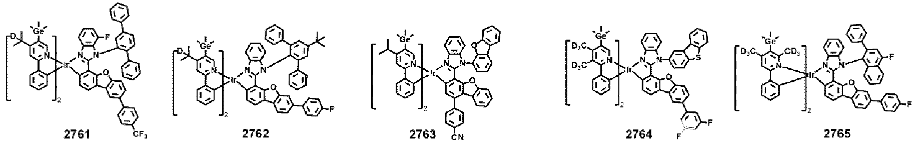 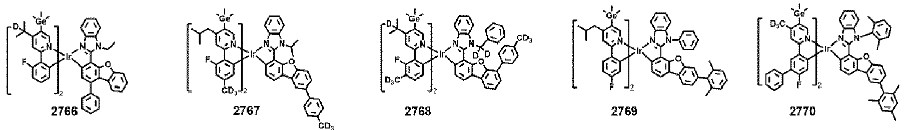 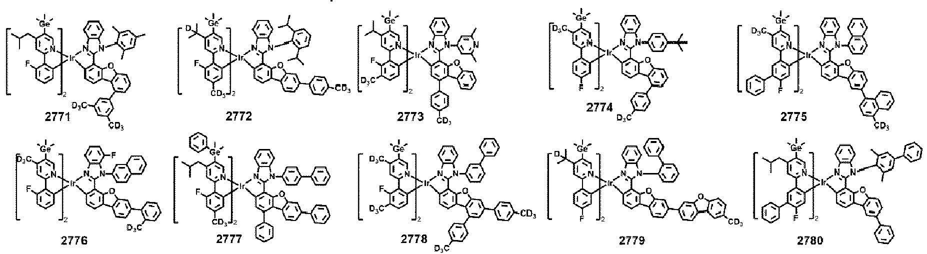 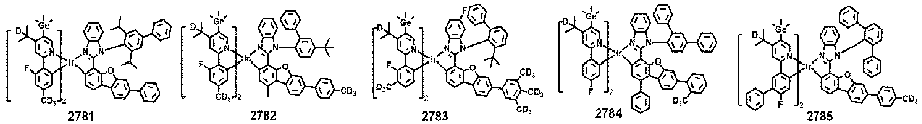 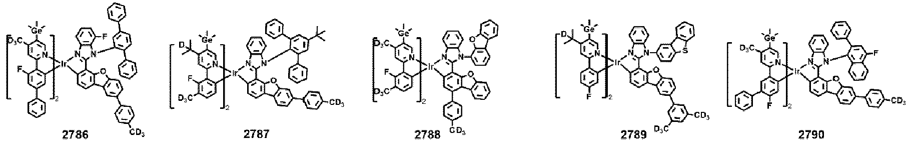 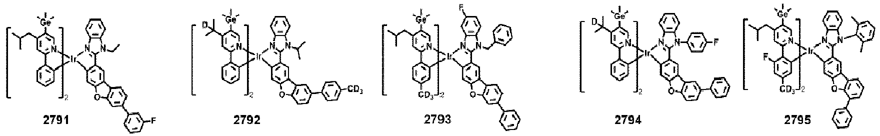 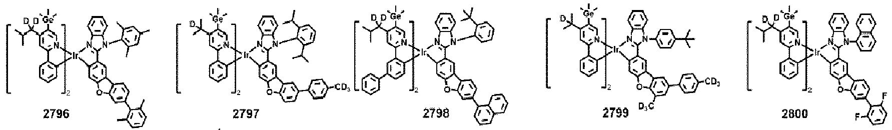 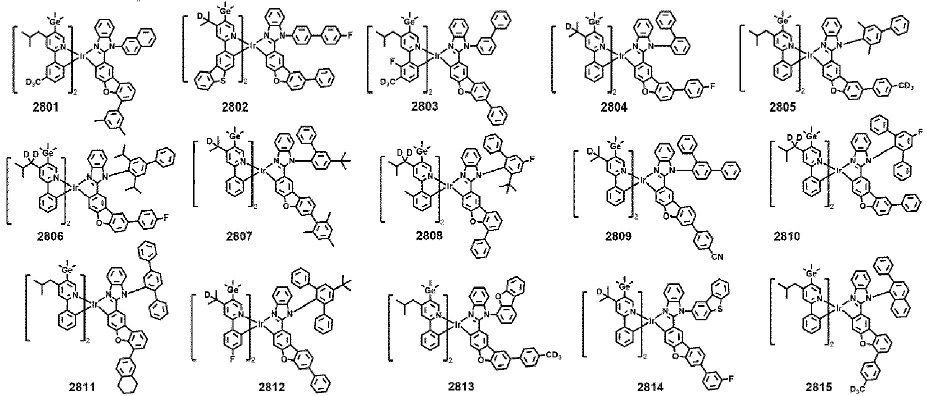 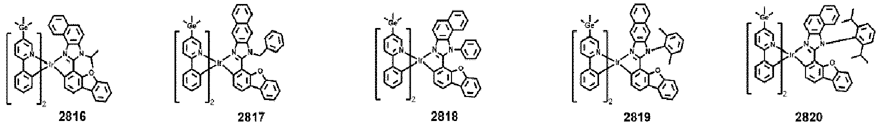 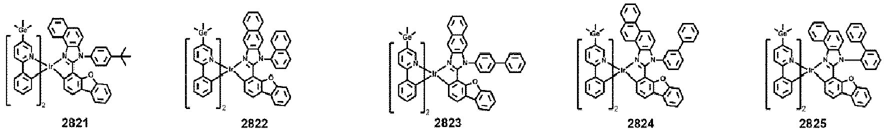 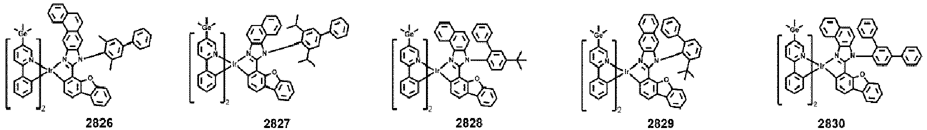 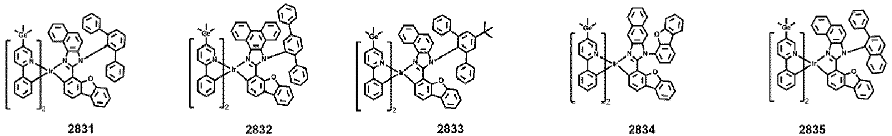 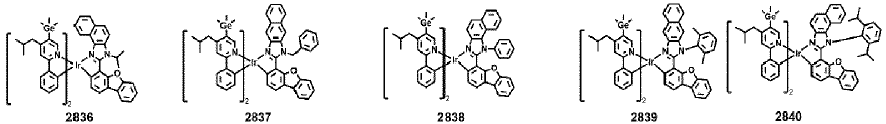 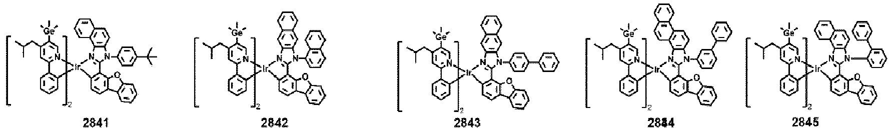 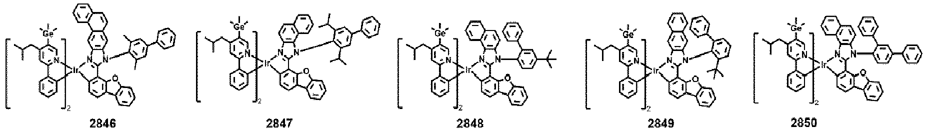 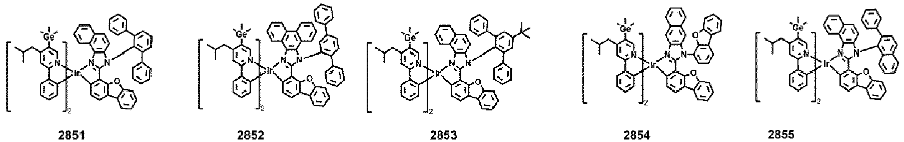 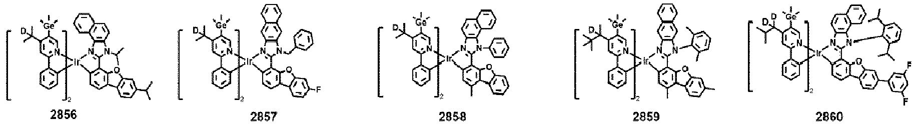 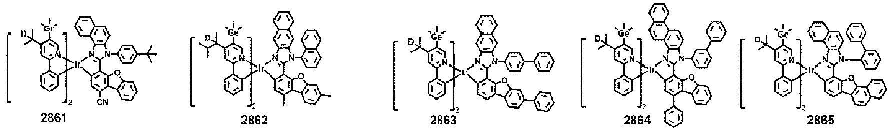 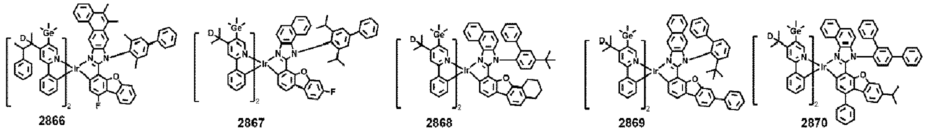 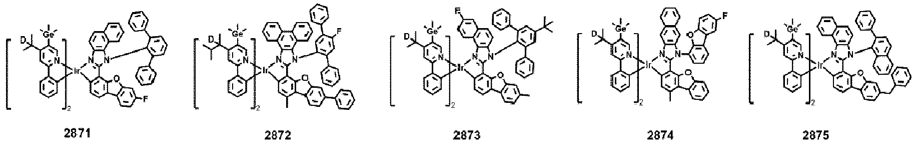 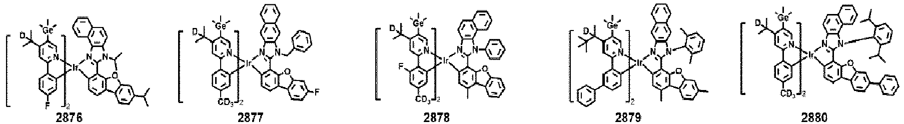 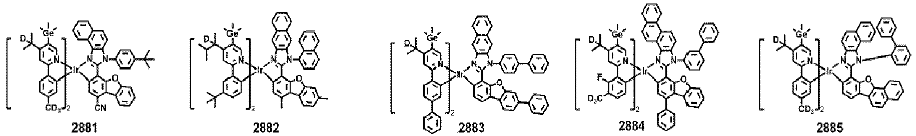 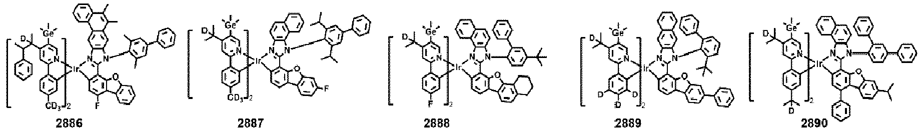 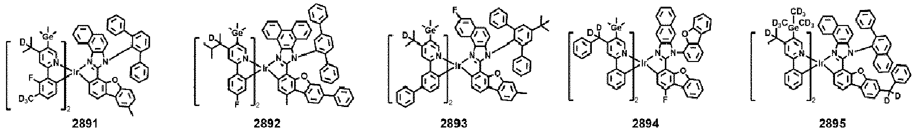 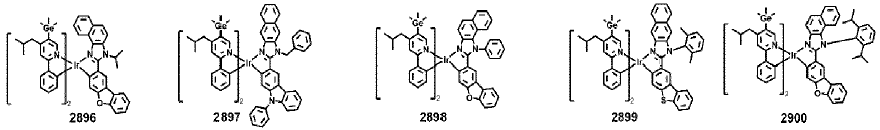 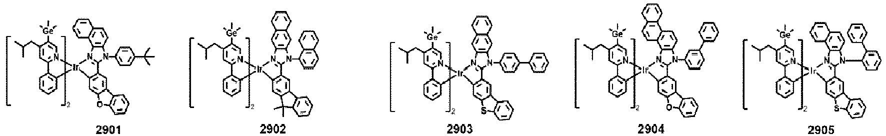 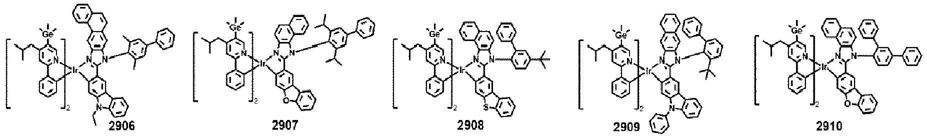 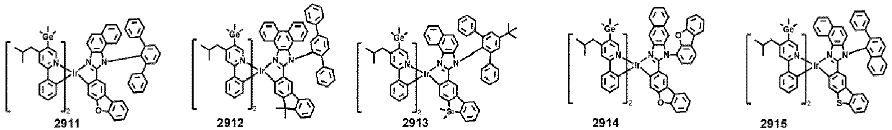 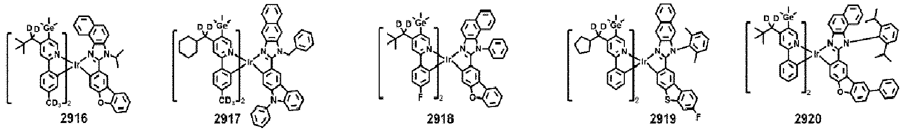 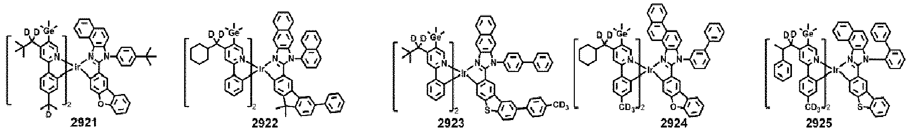 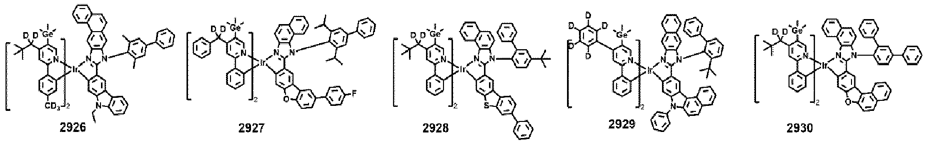 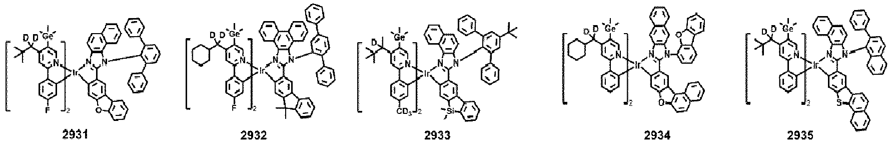 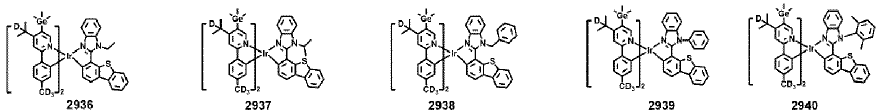 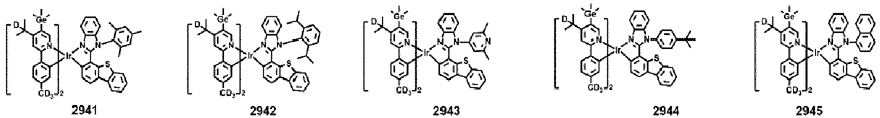 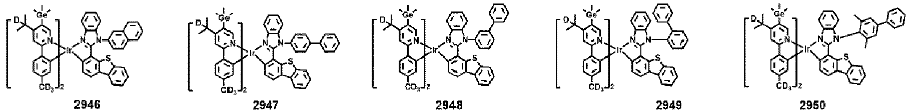 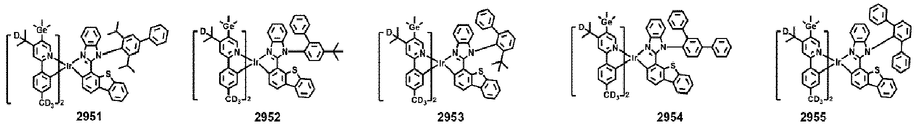 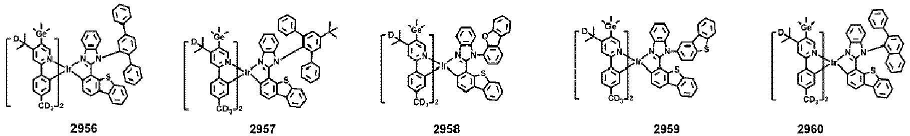 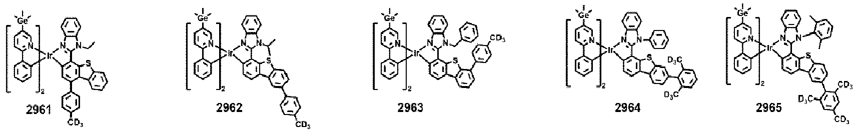 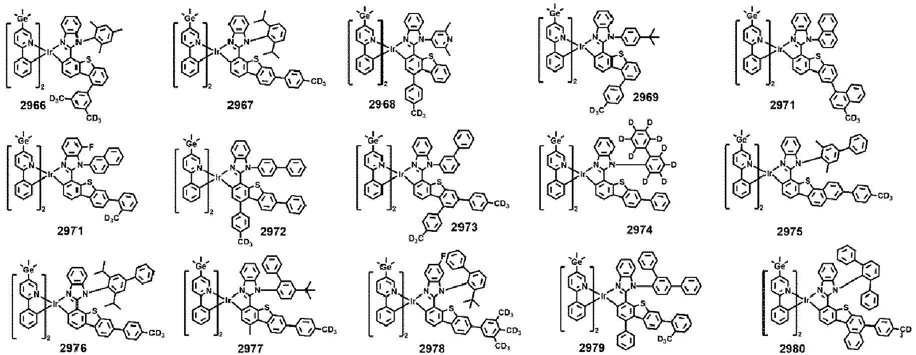 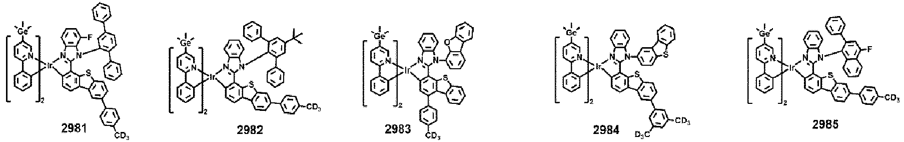 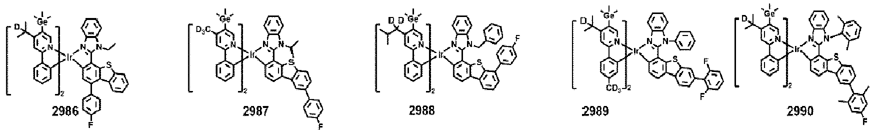 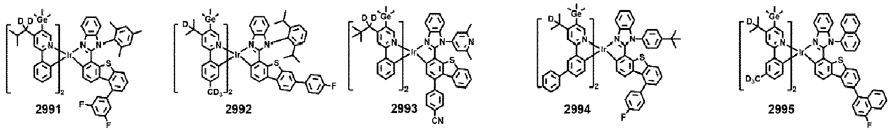 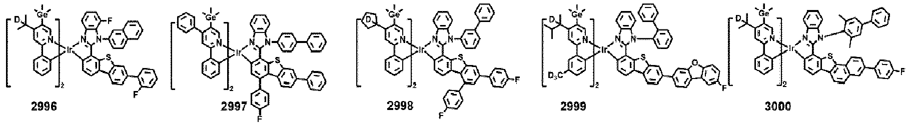 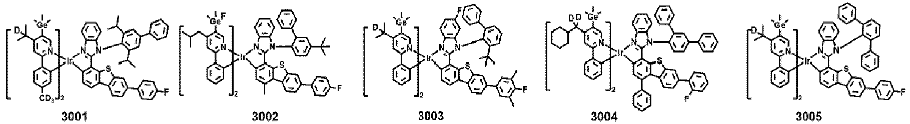 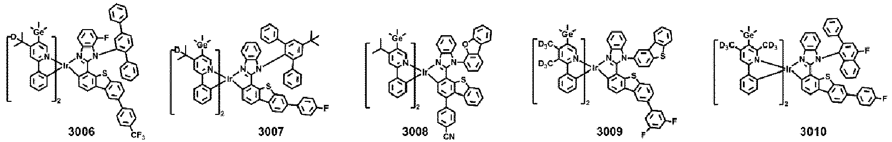 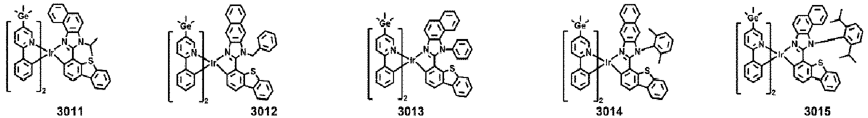 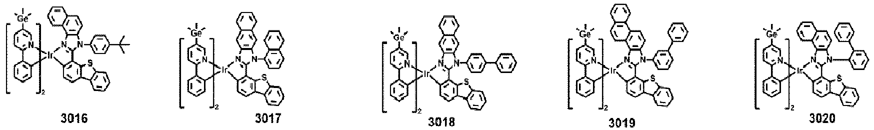 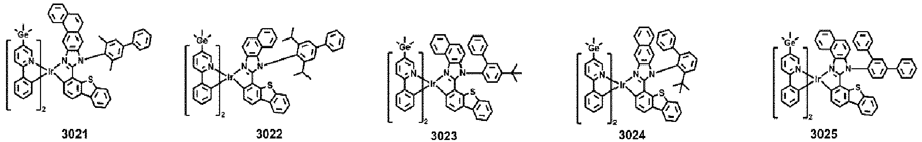 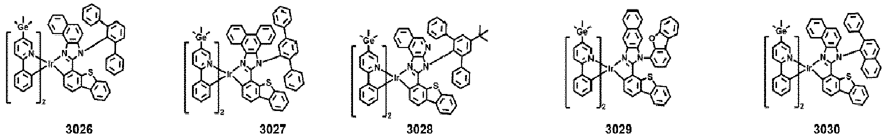 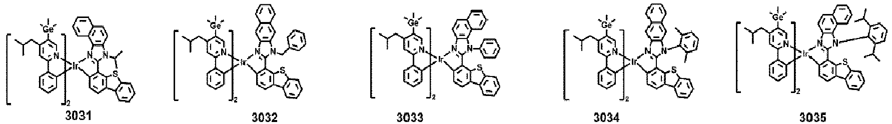 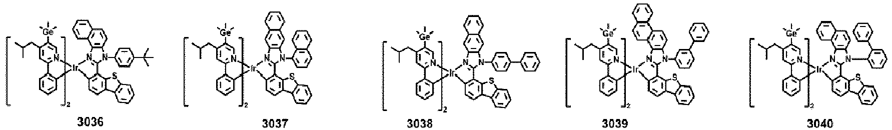 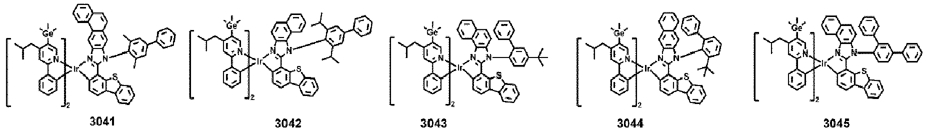 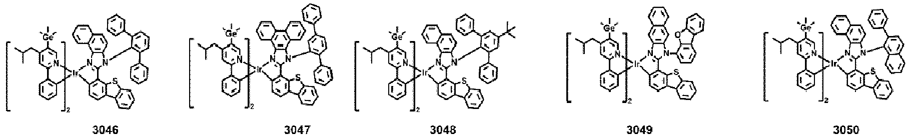 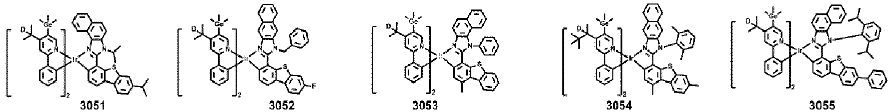 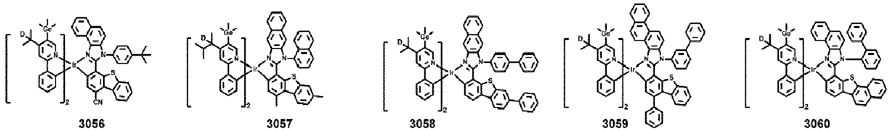 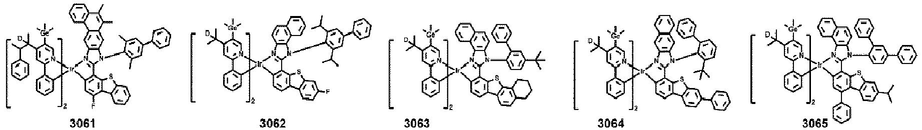 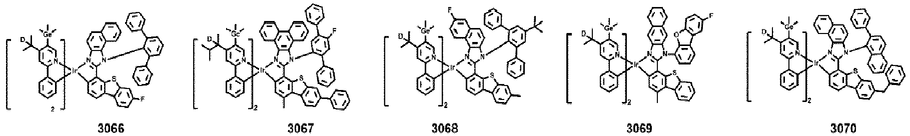 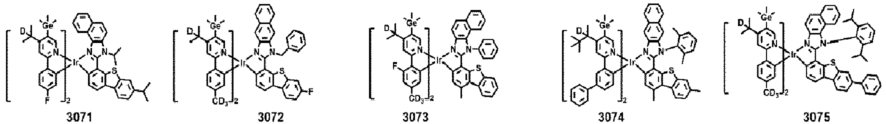 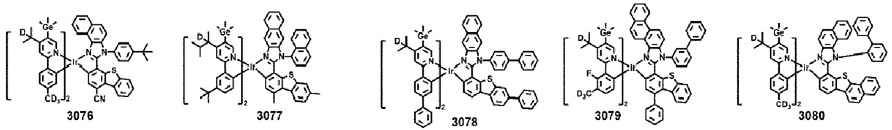 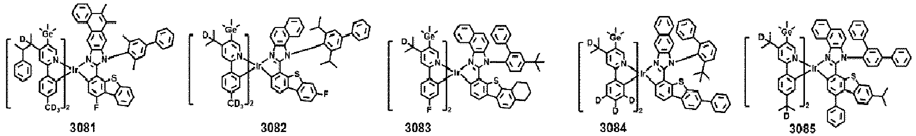 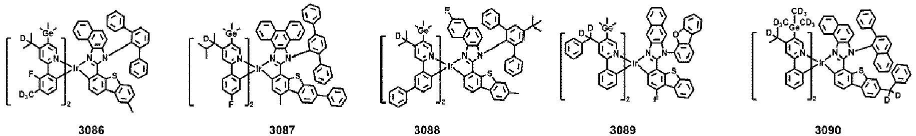 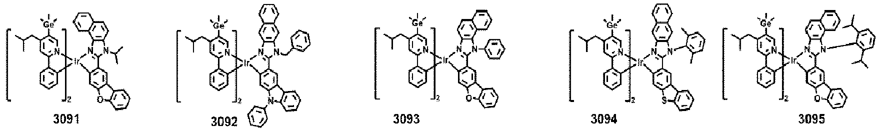 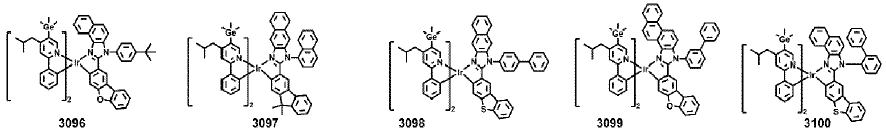 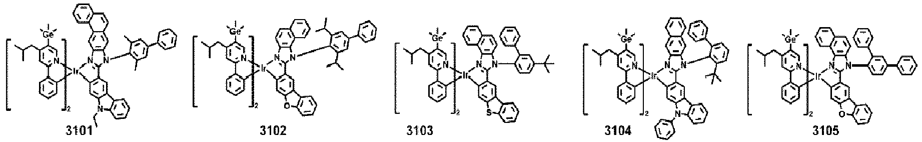 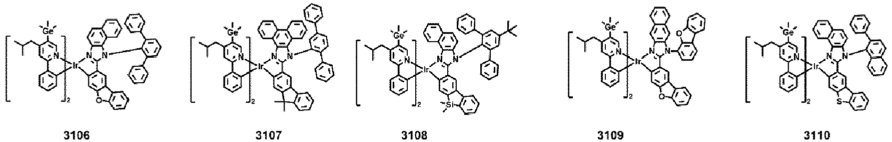 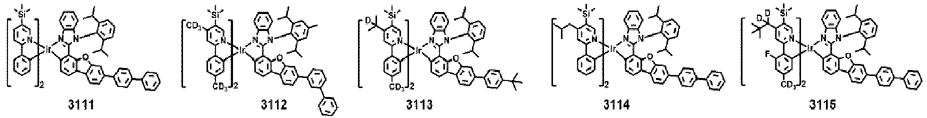 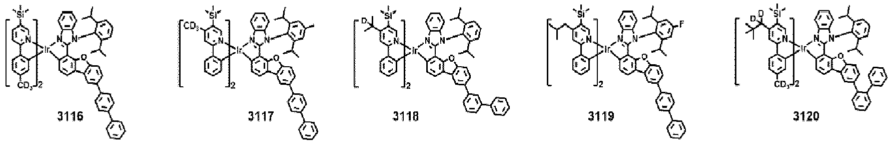 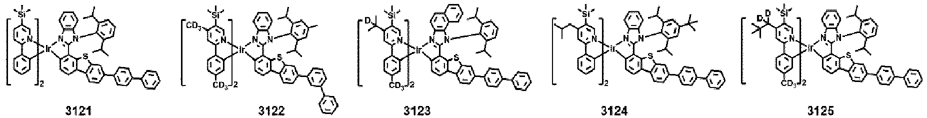 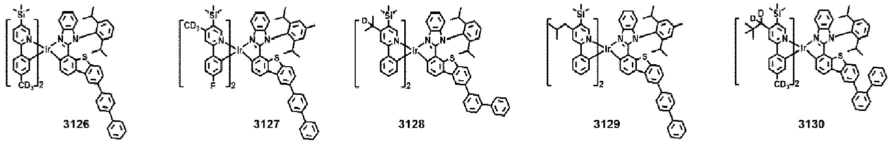 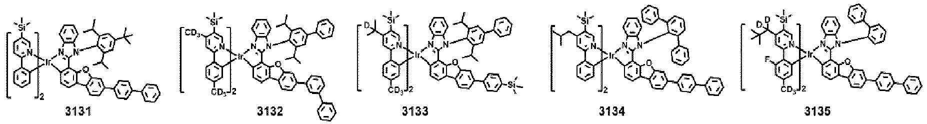 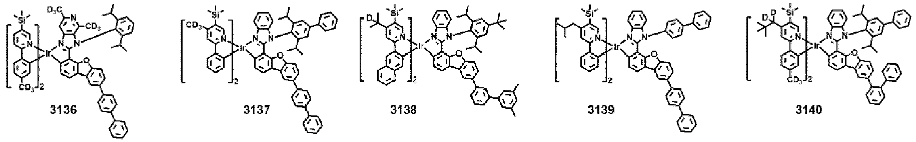 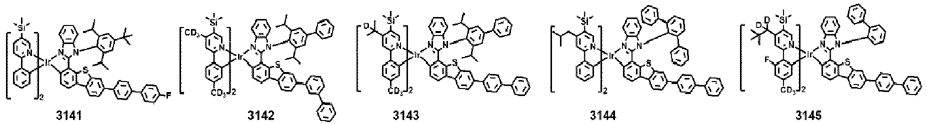 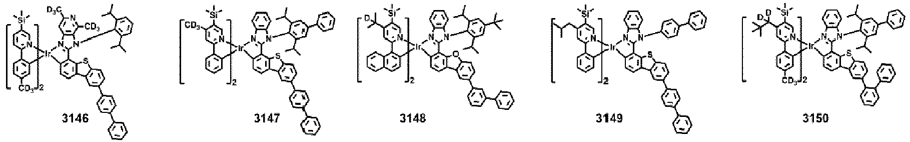 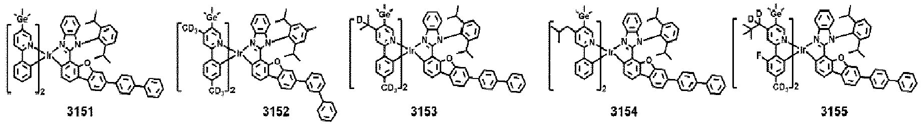 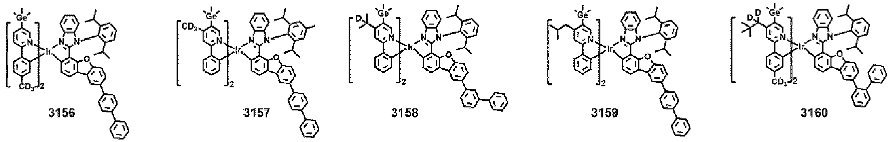 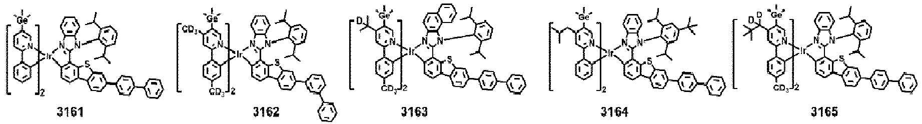 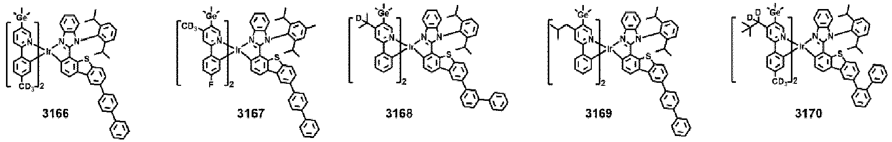 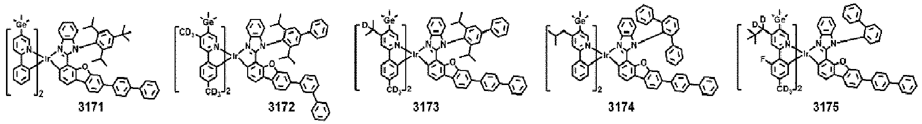 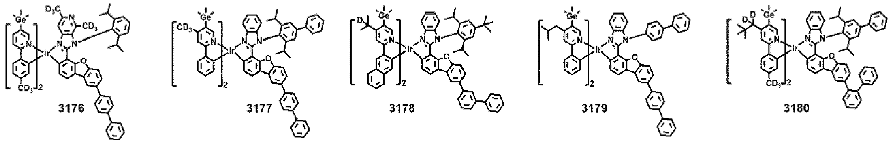 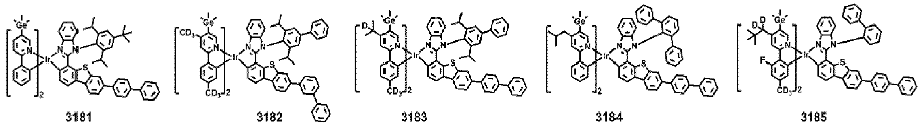 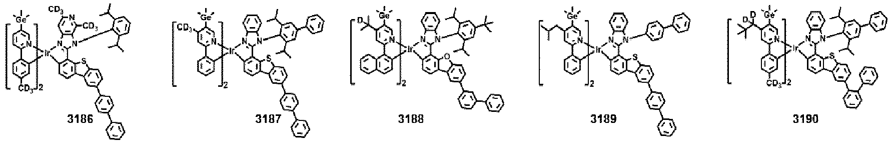 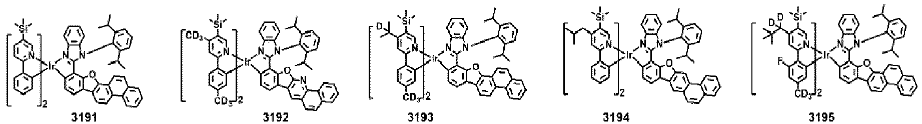 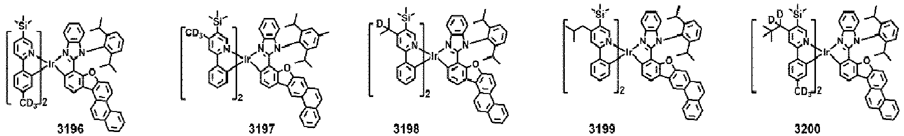 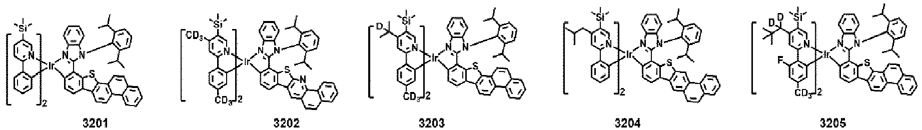 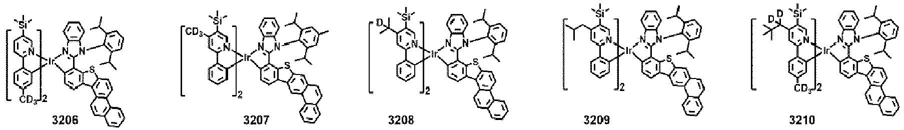 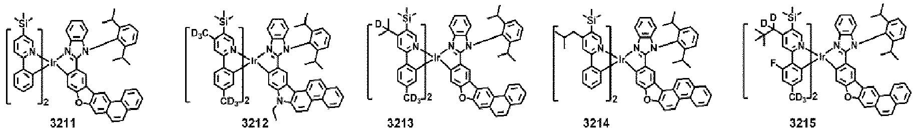 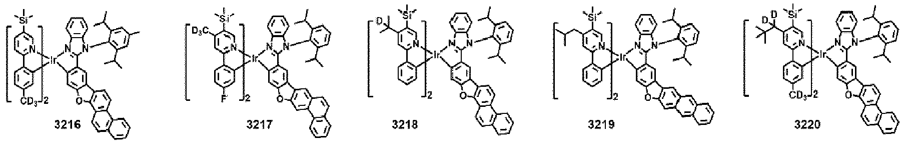 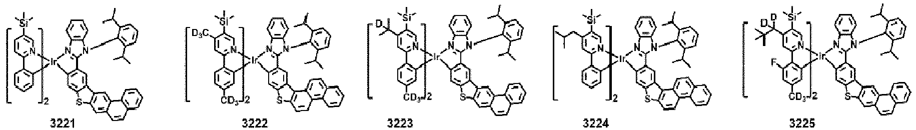 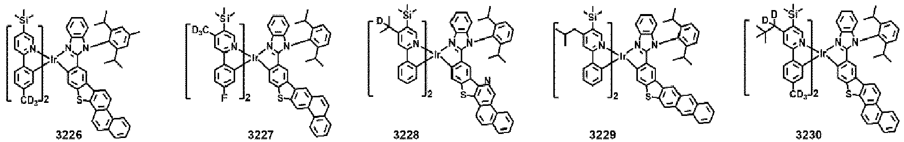 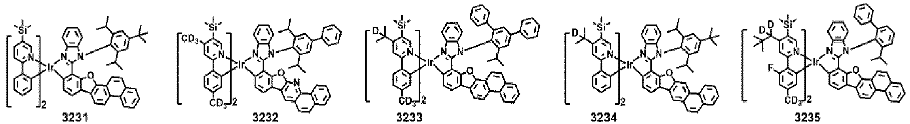 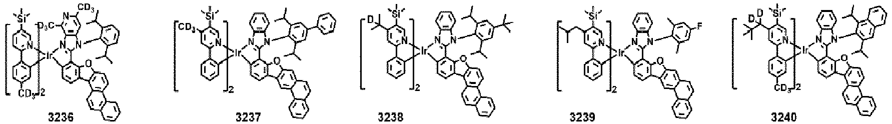 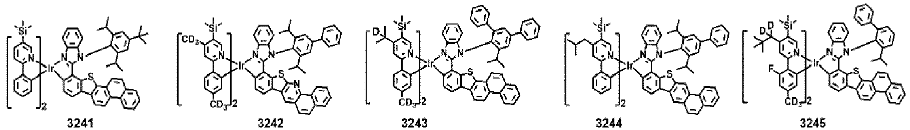 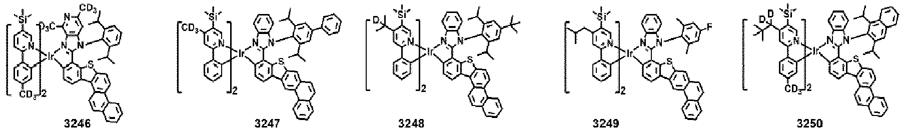 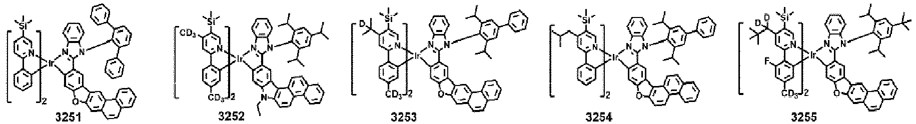 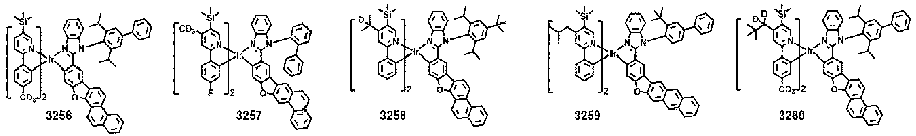 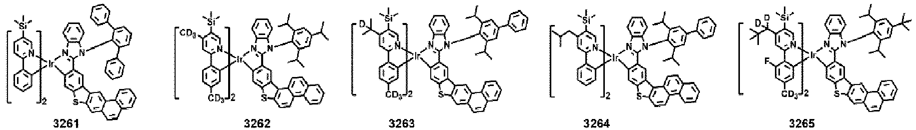 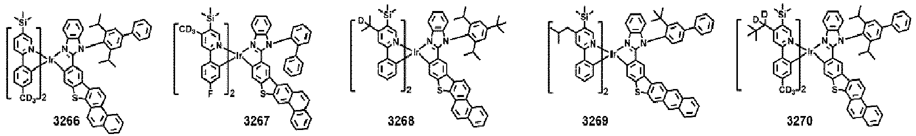 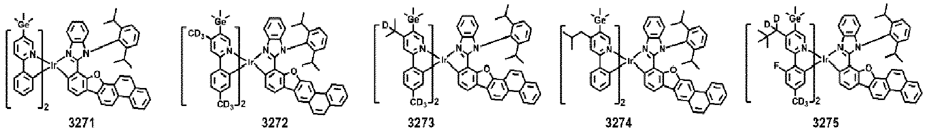 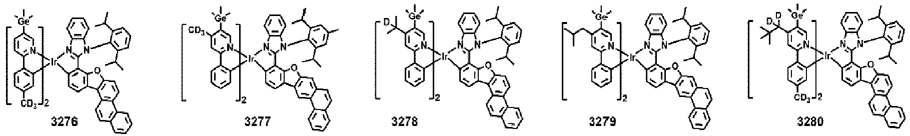 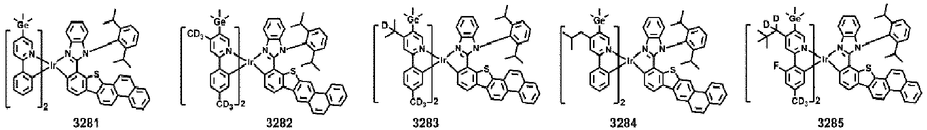 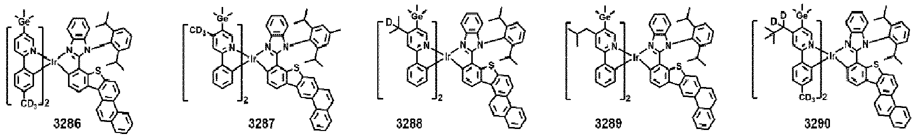 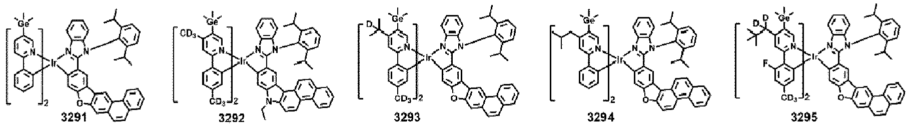 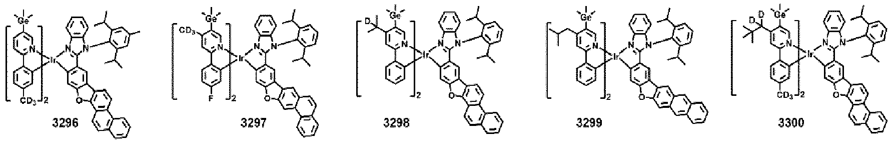 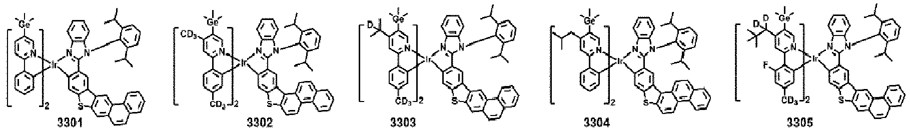 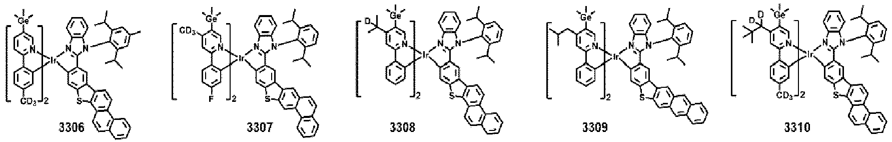 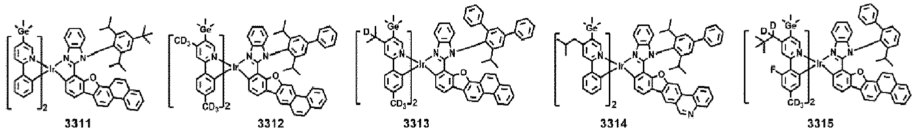 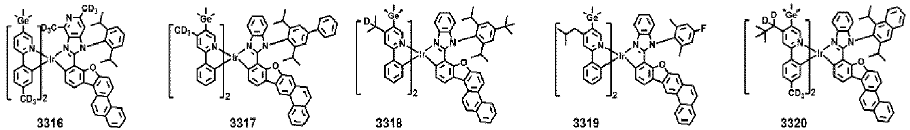 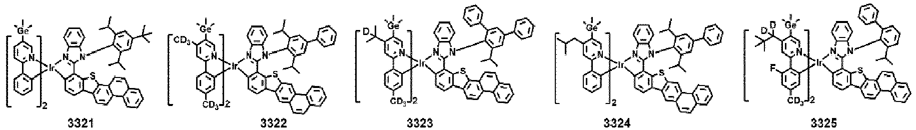 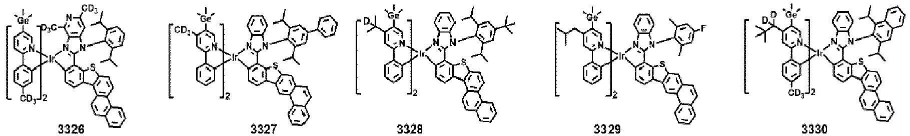 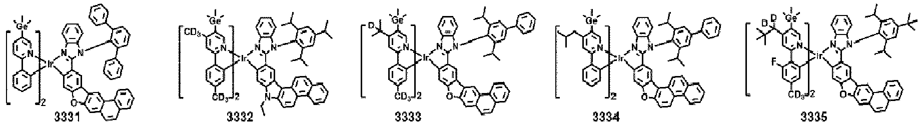 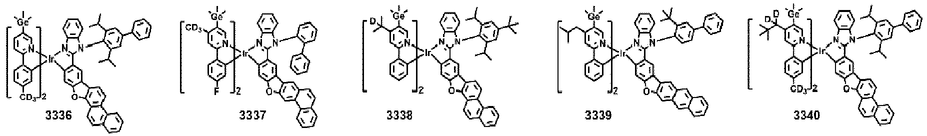 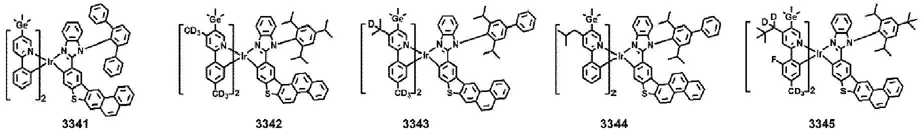 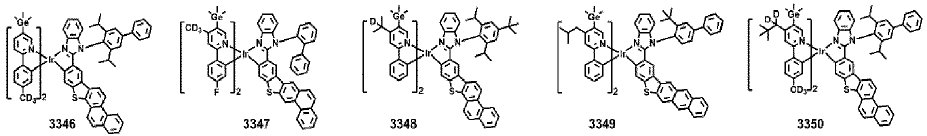
Group 2-2 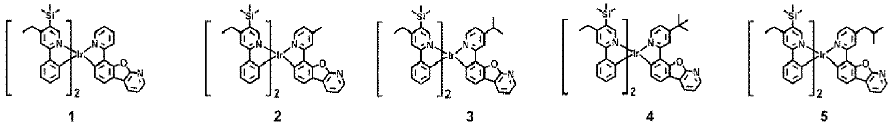 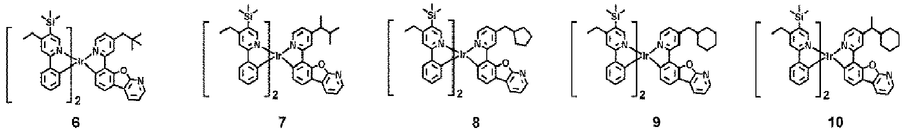 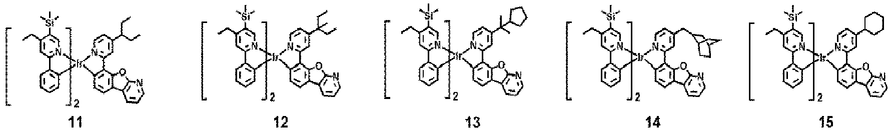 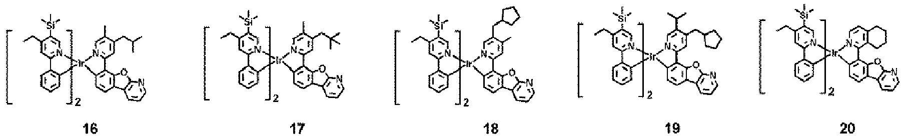 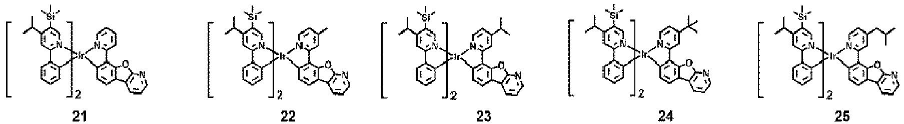 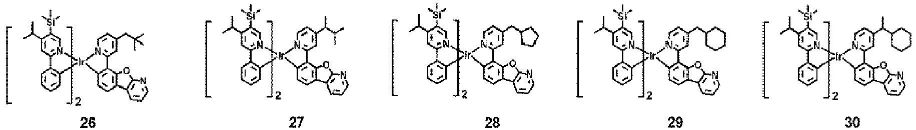 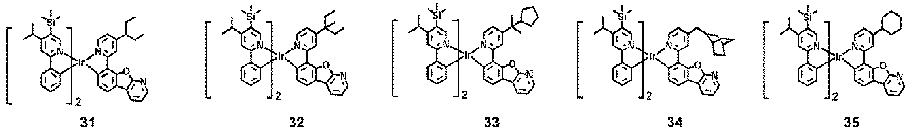 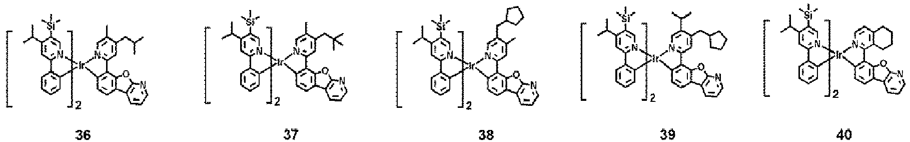 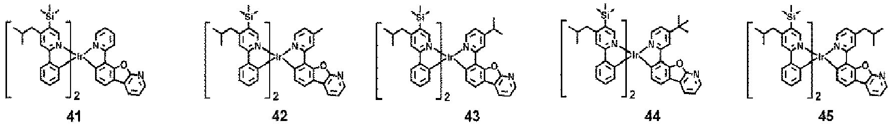 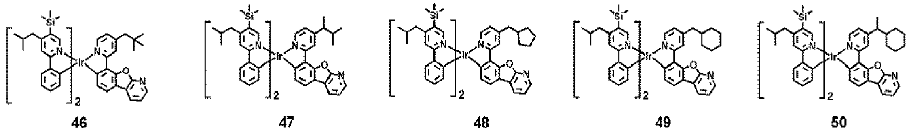 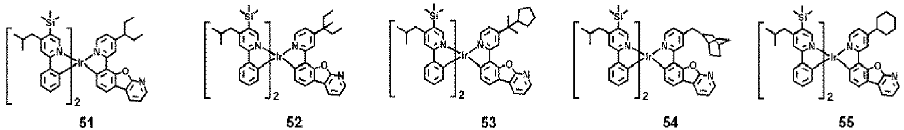 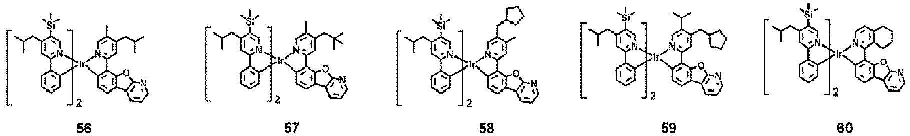 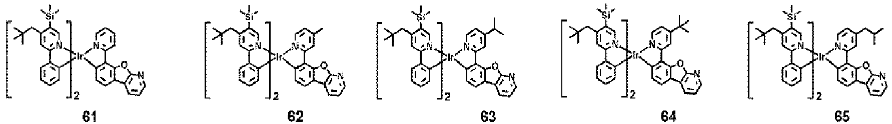 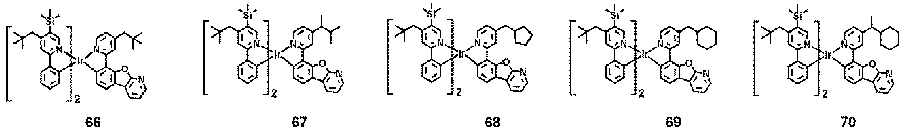 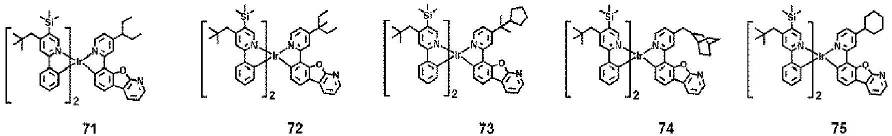 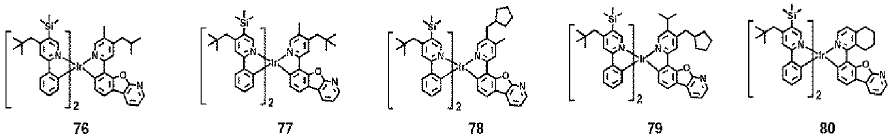 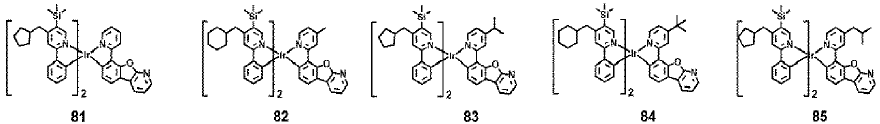 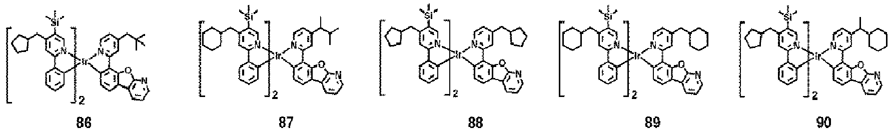 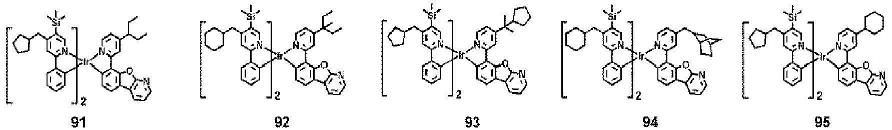 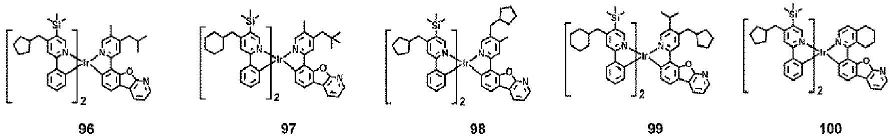 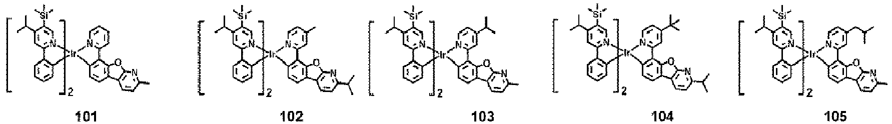 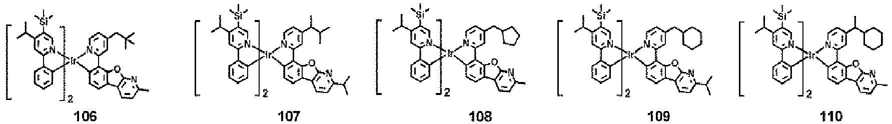 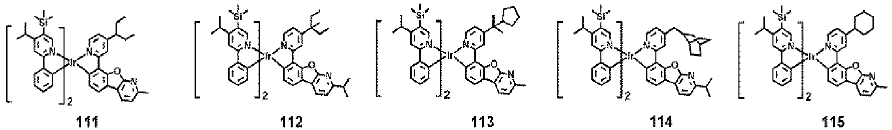 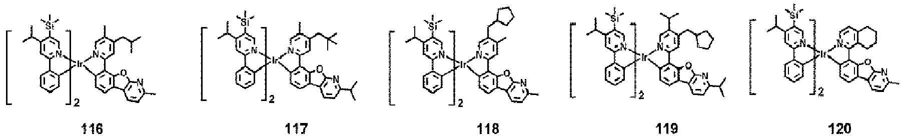 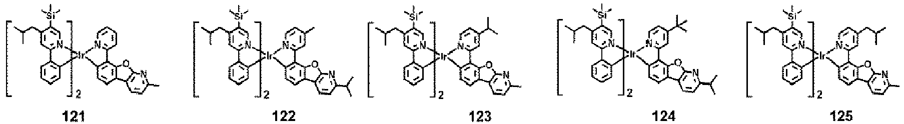 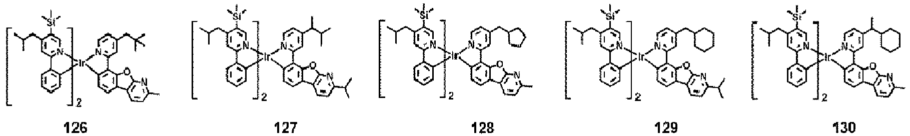 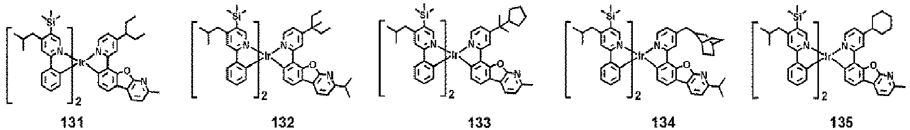 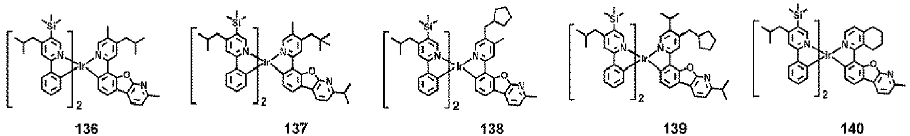 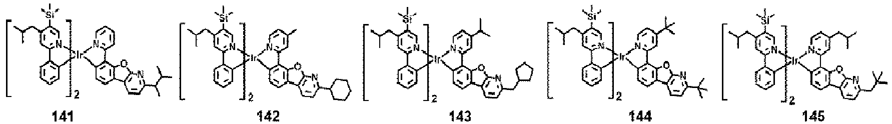 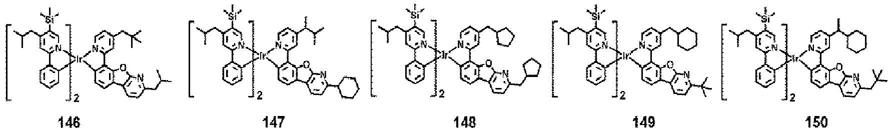 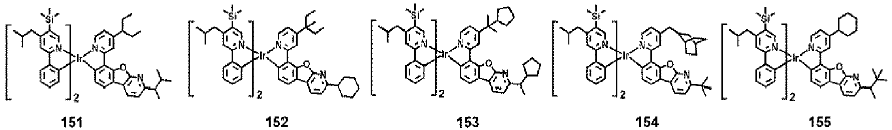 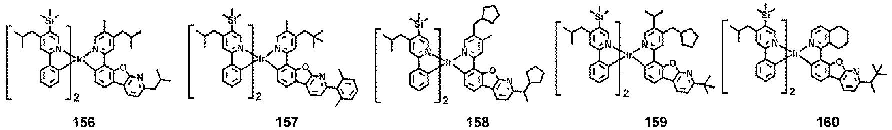 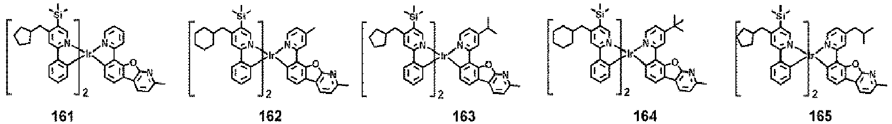 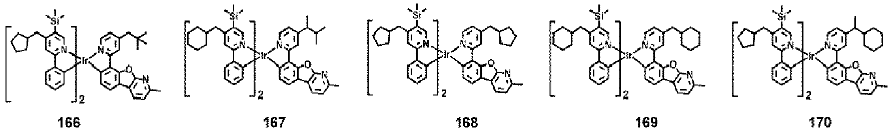 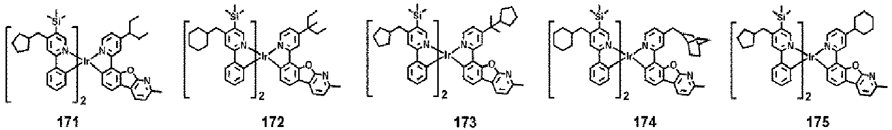 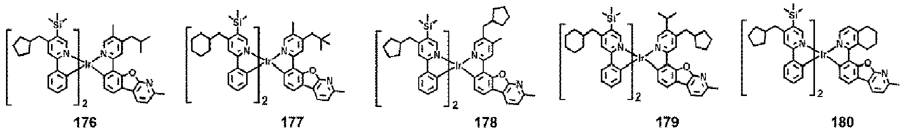 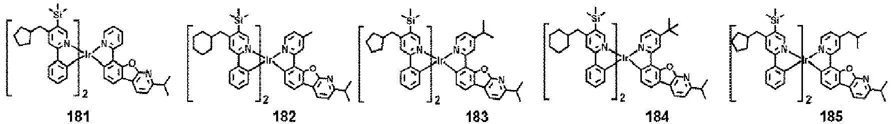 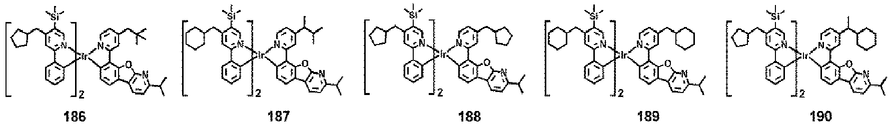 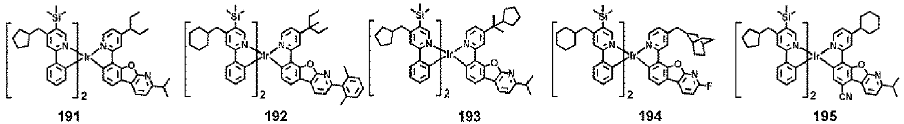 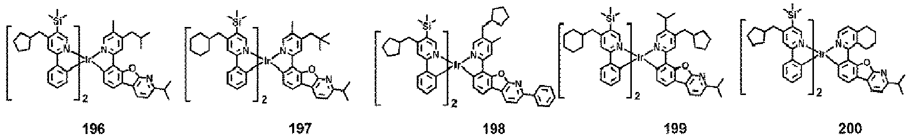 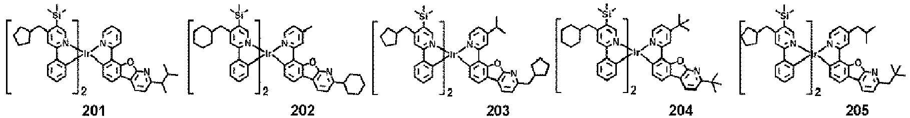 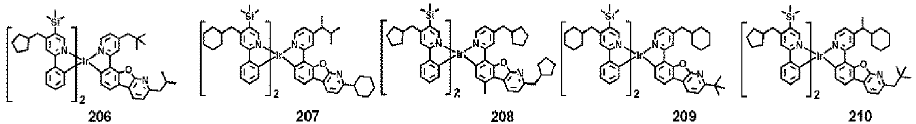 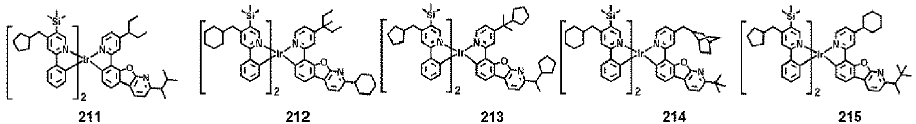 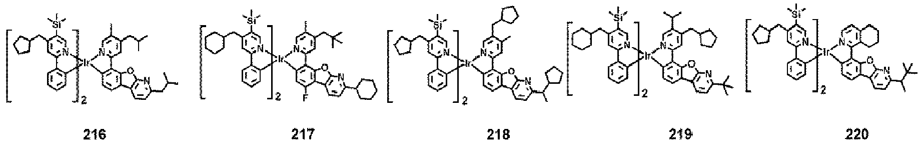 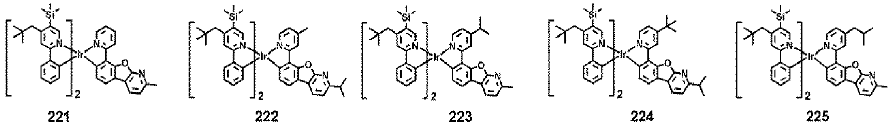 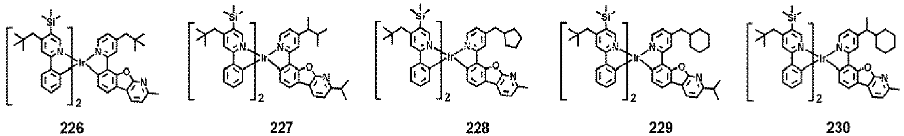 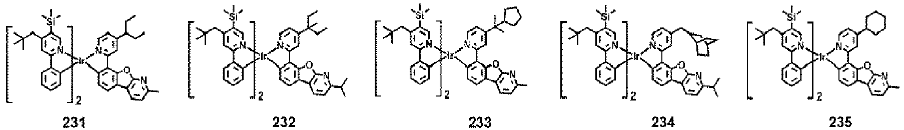 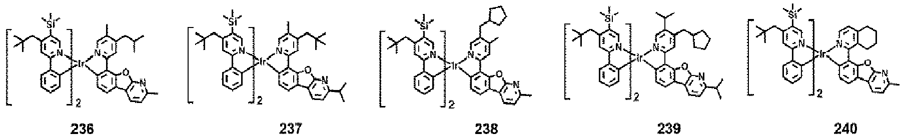 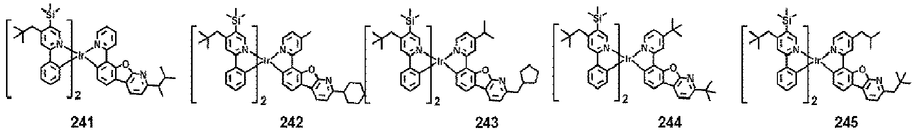 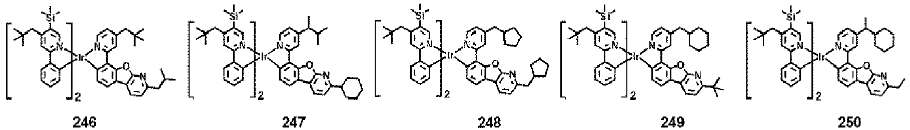 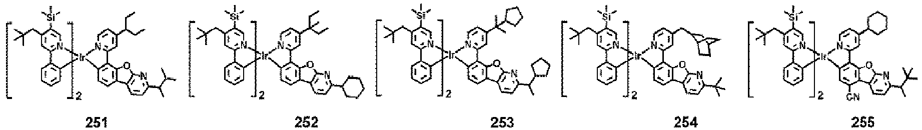 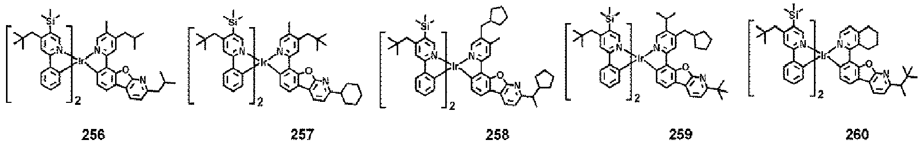 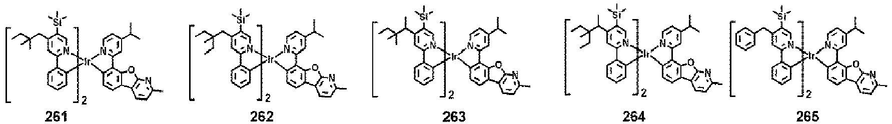 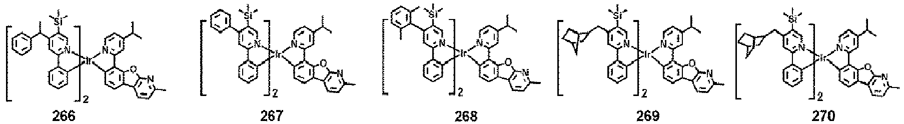 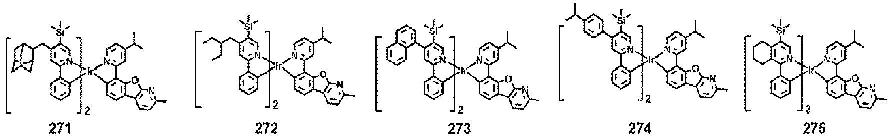 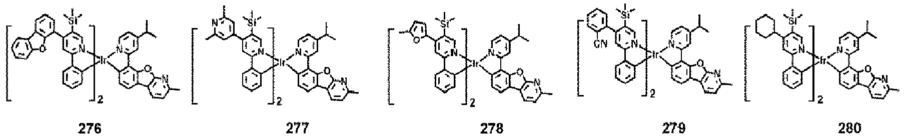 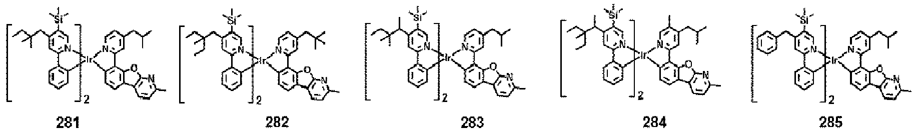 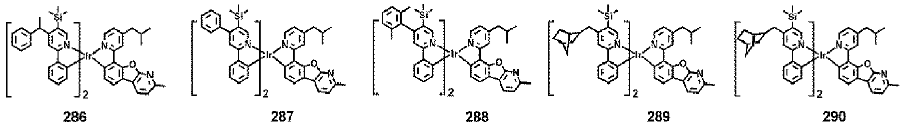 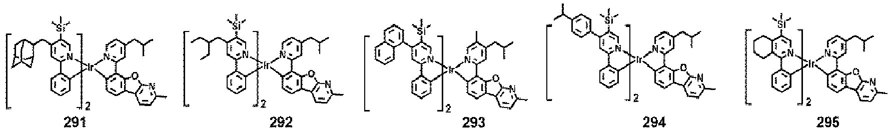 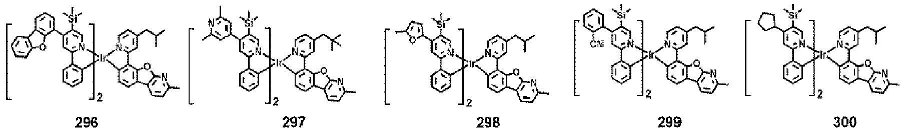 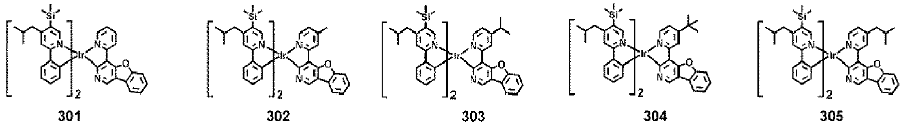 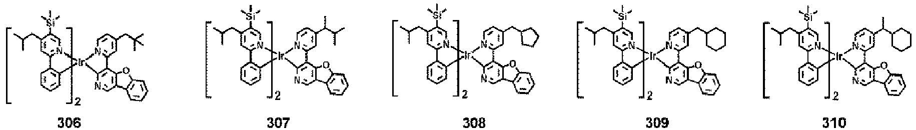 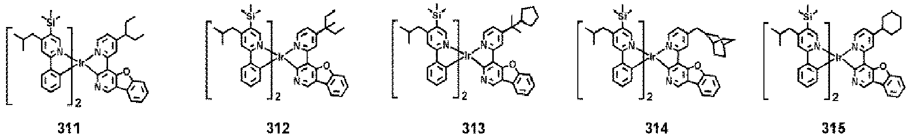 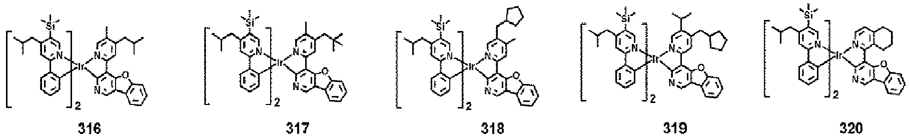 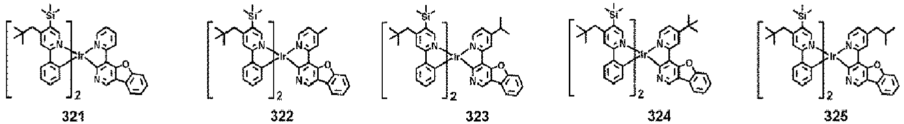 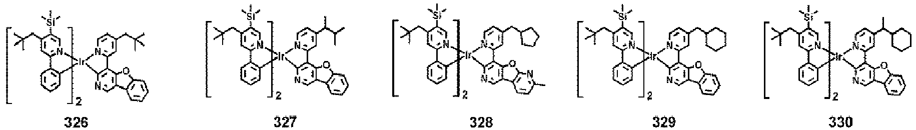 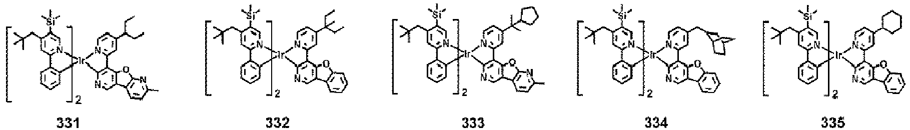 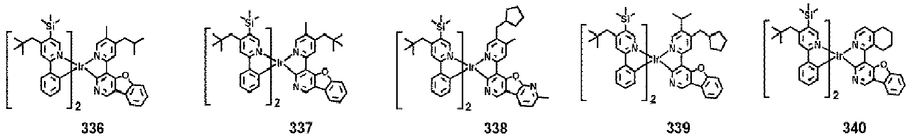 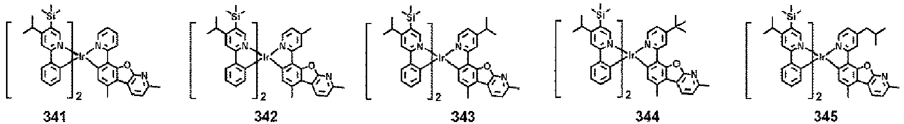 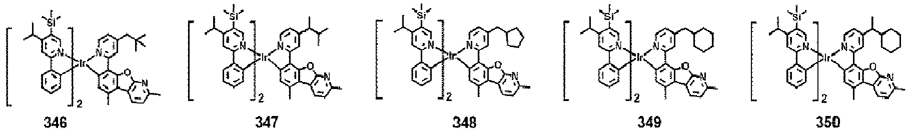 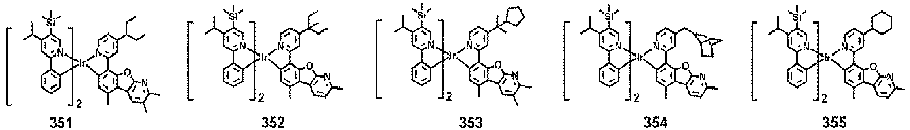 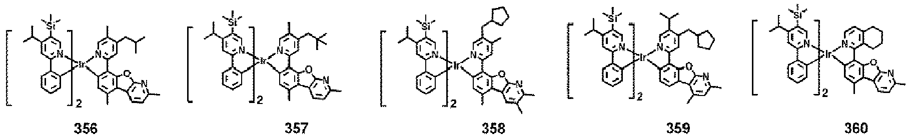 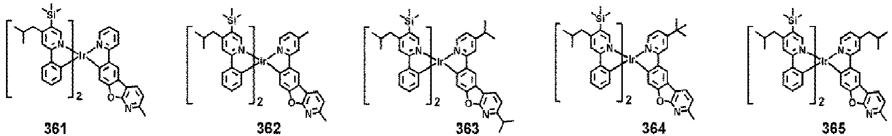 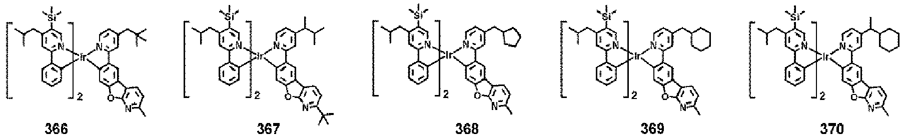 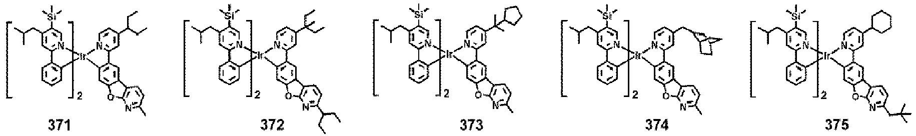 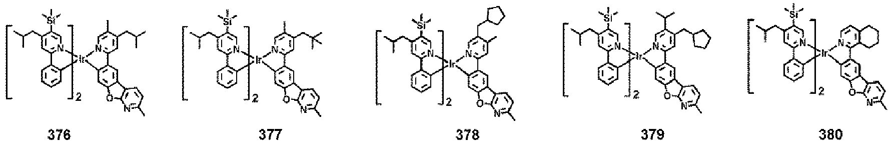 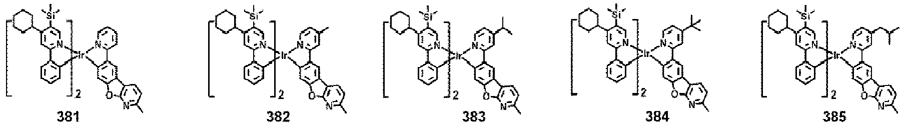 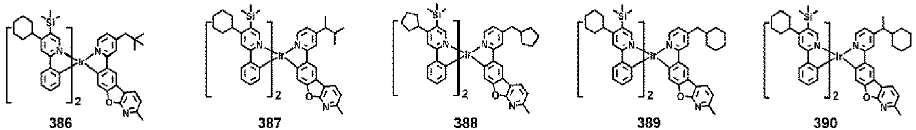 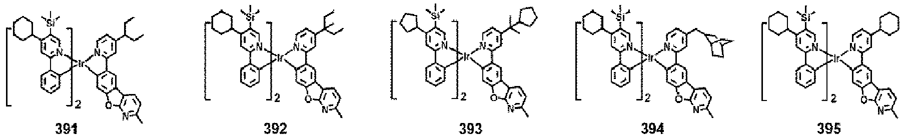 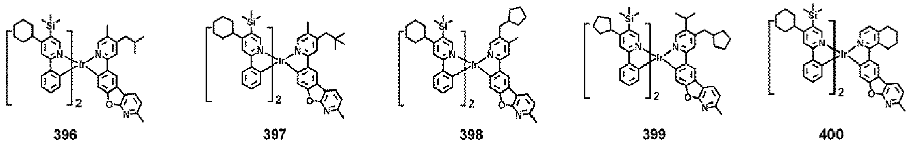 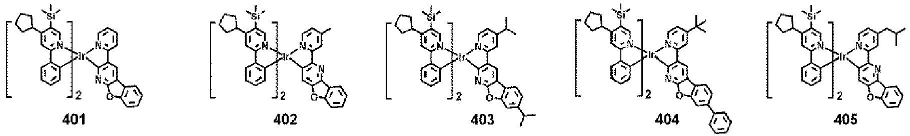 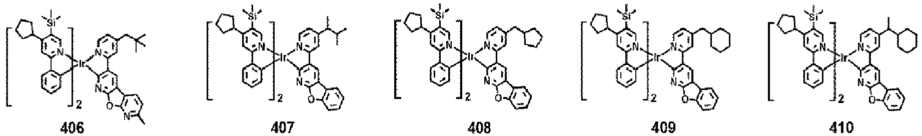 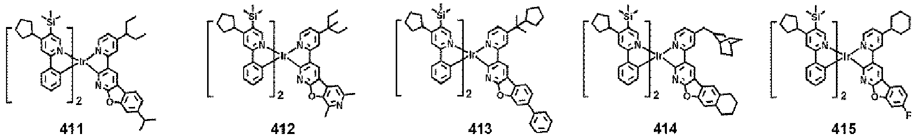 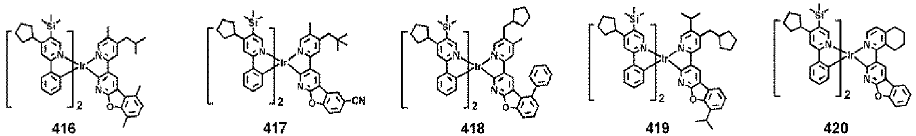 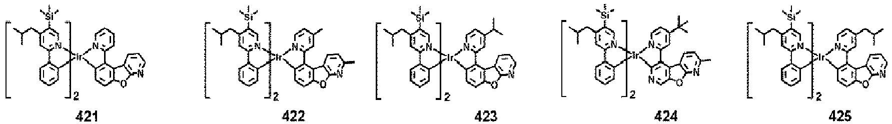 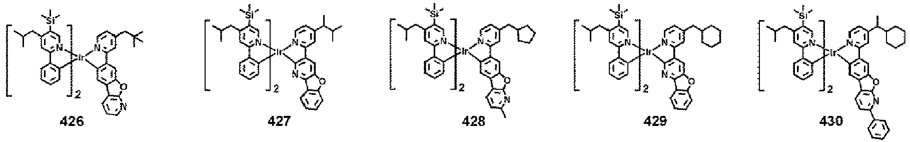 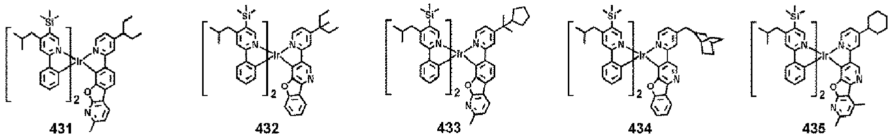 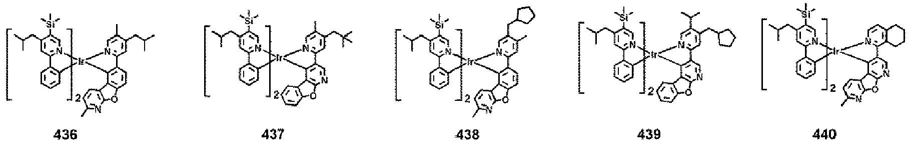 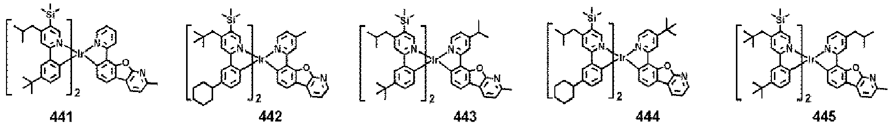 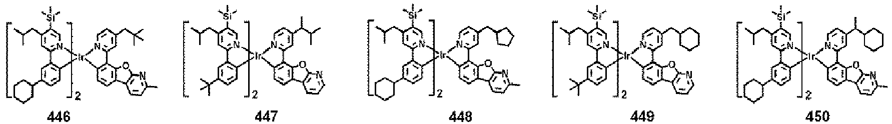 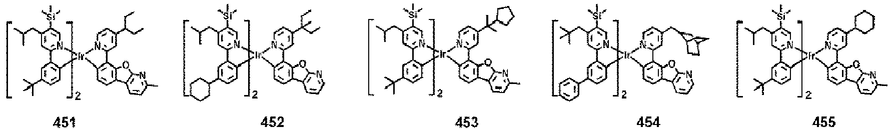 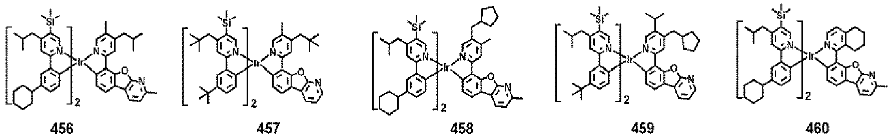 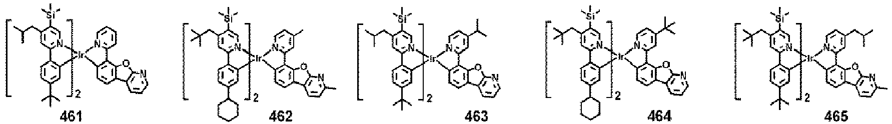 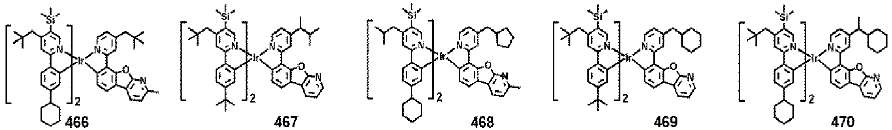 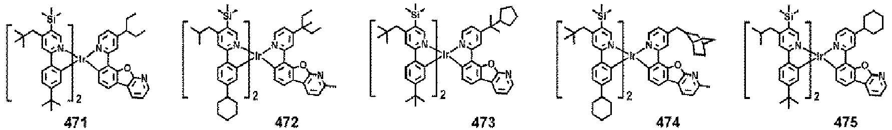 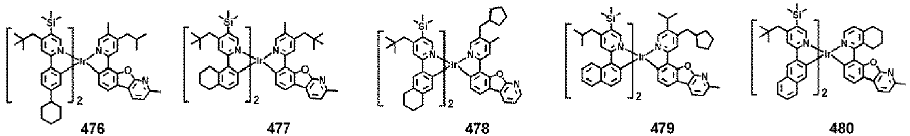 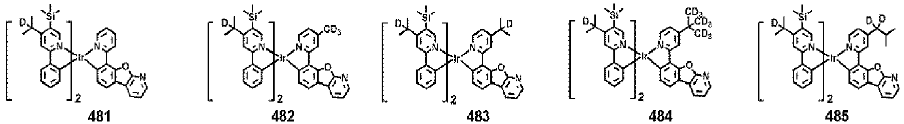 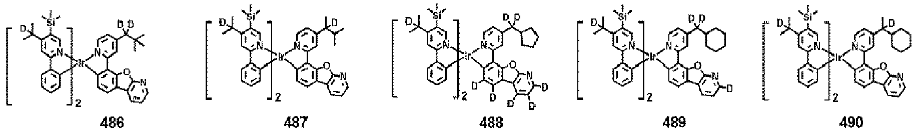 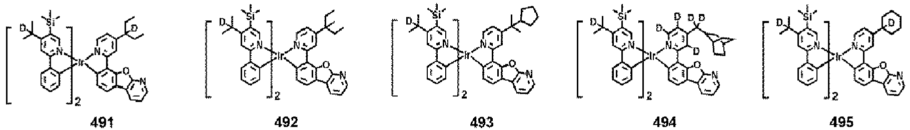 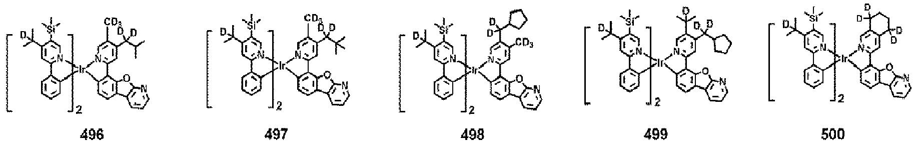 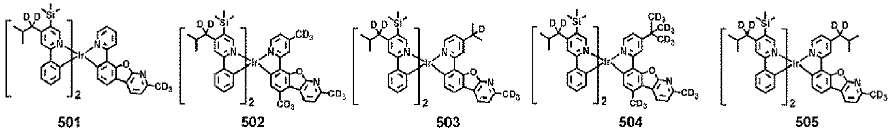 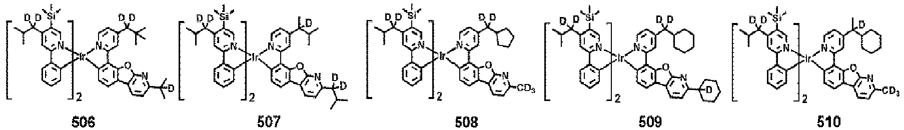 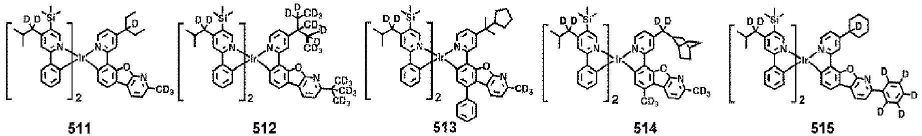 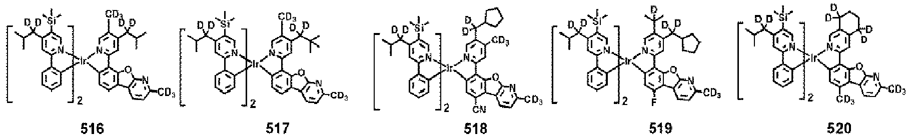 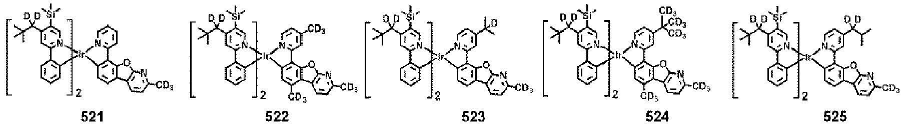 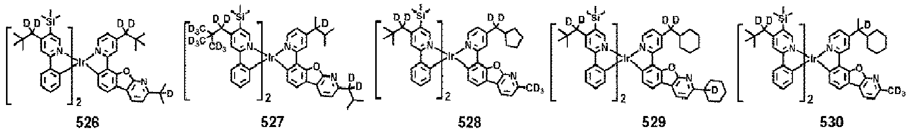 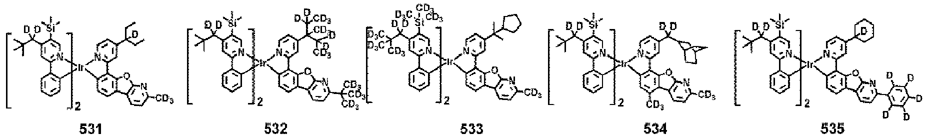 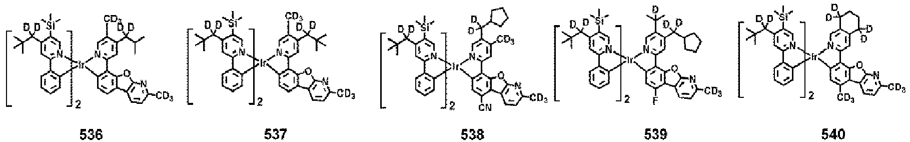 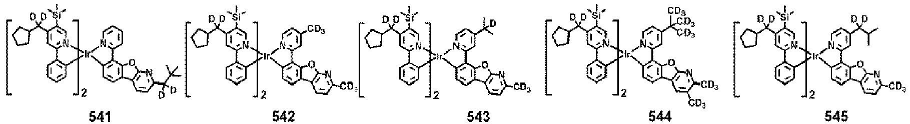 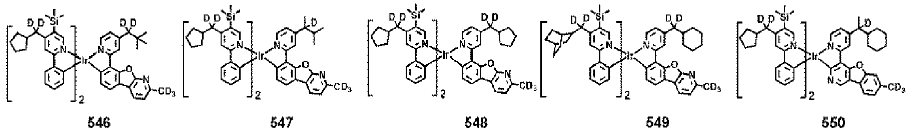 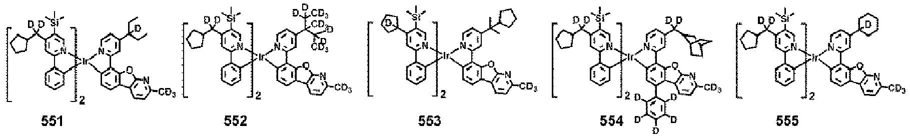 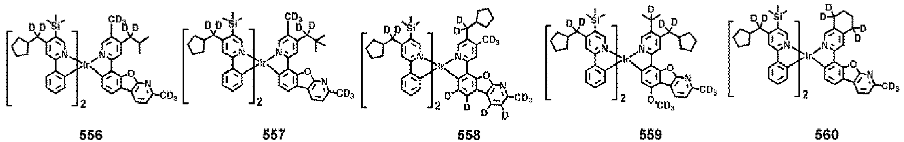 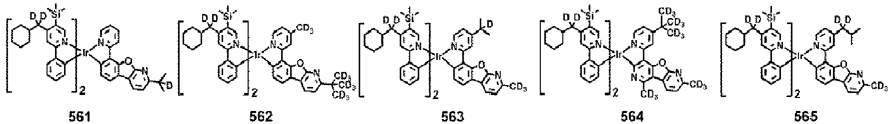 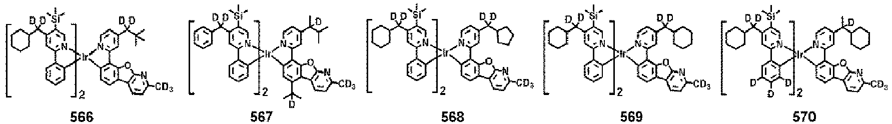 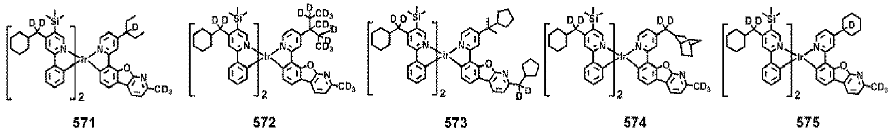 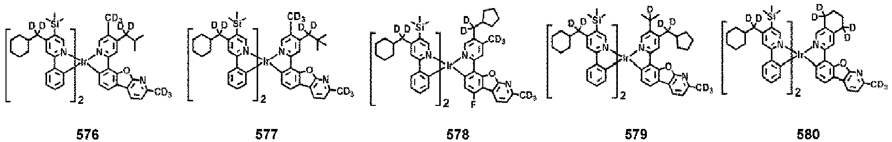 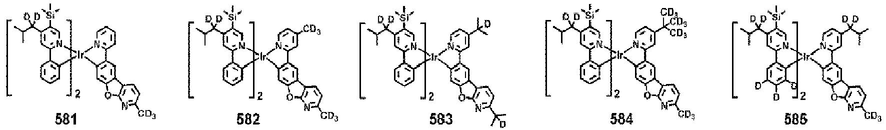 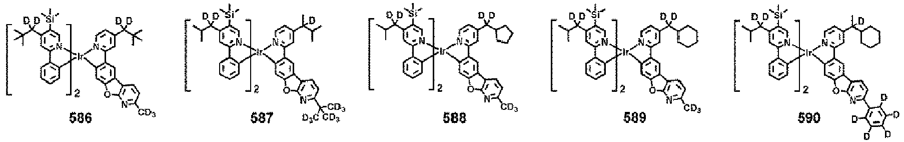 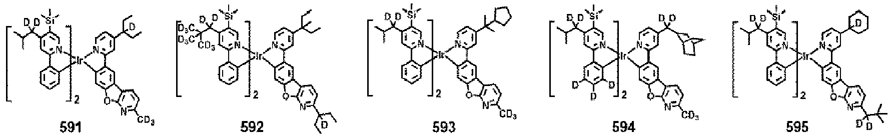 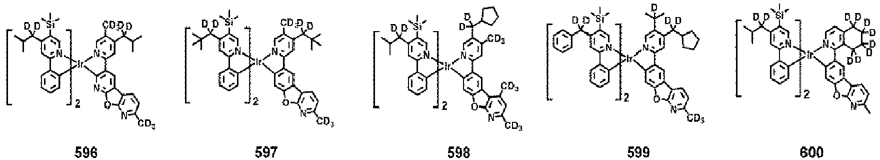 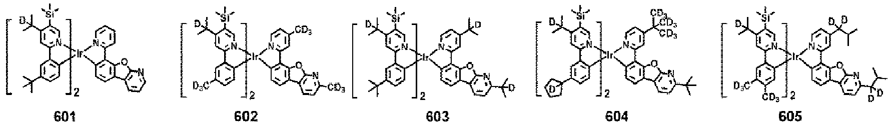 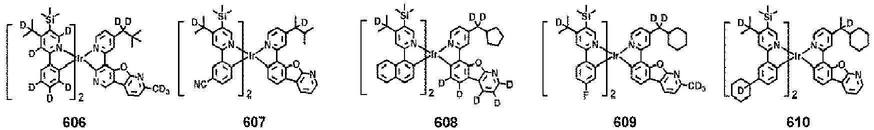 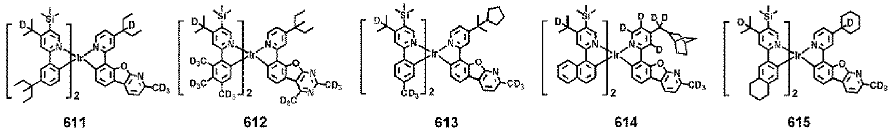 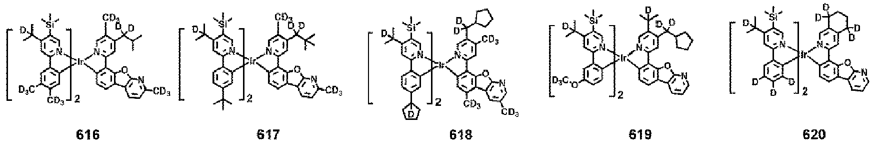 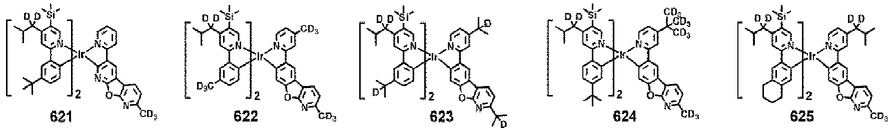 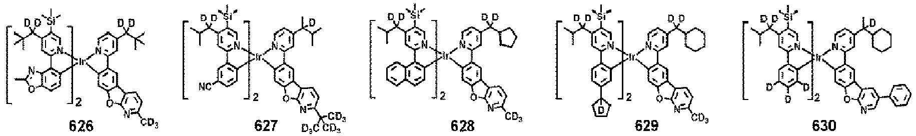 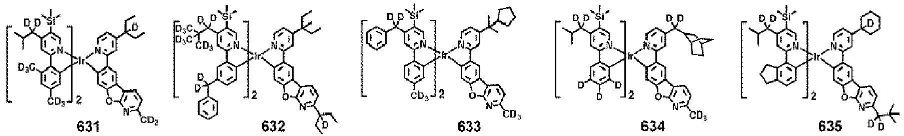 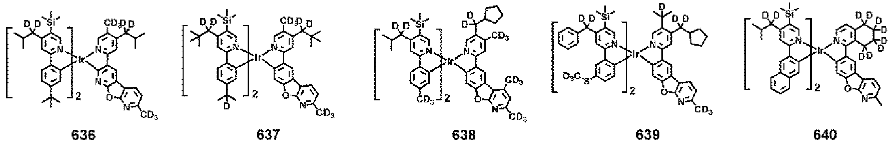 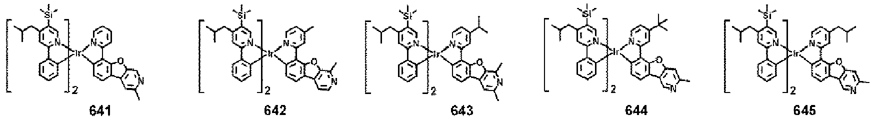 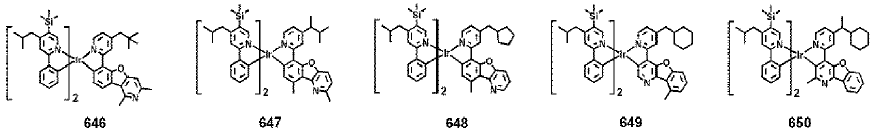 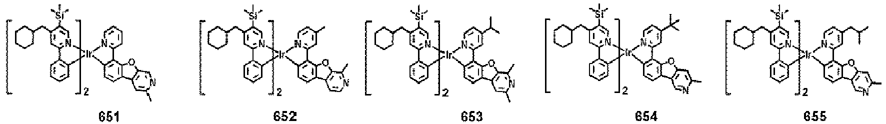 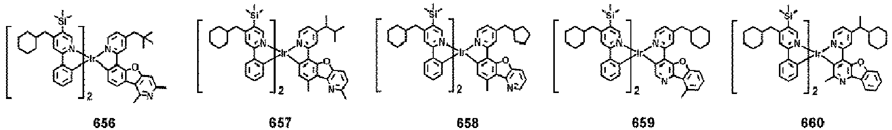 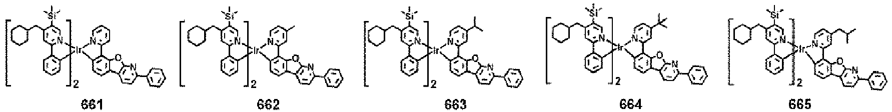 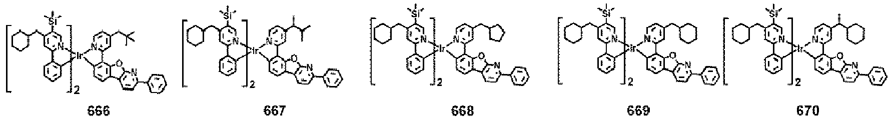 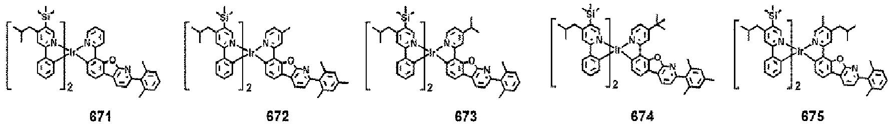 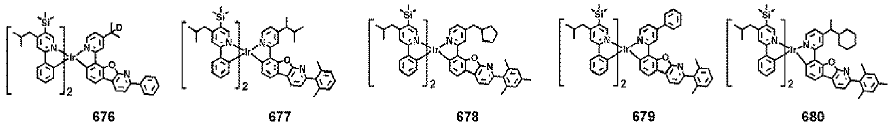 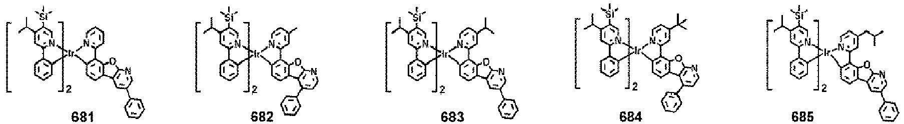 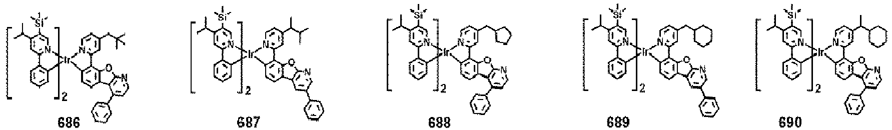 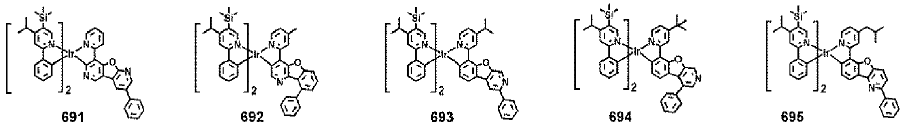 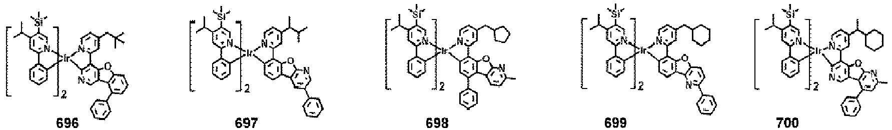 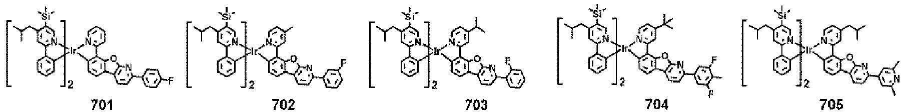 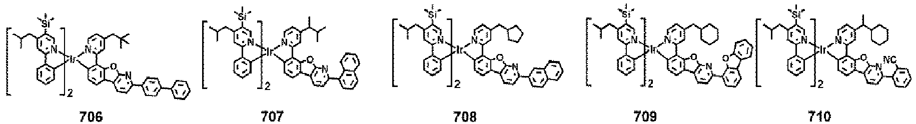 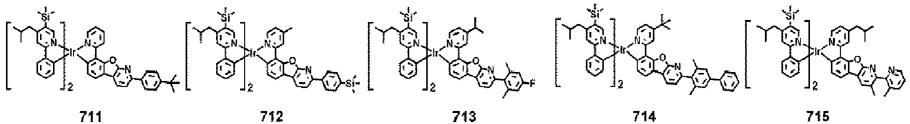 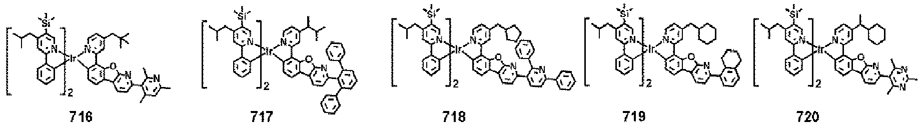 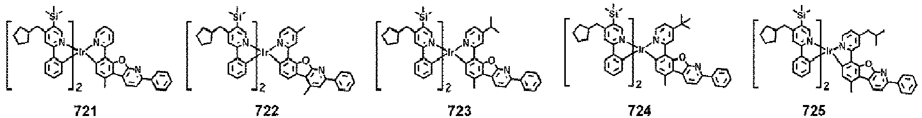 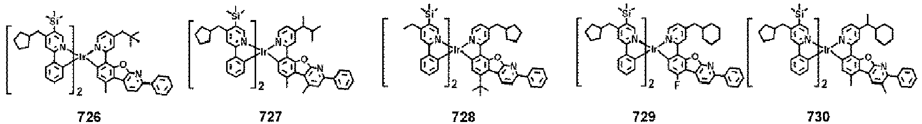 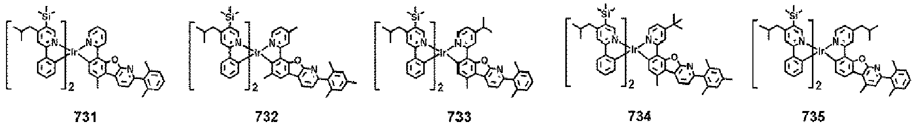 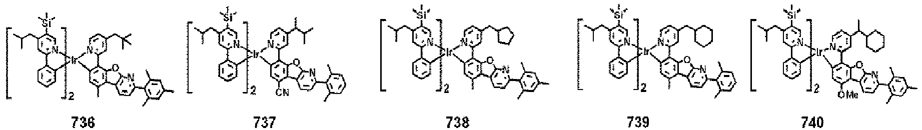 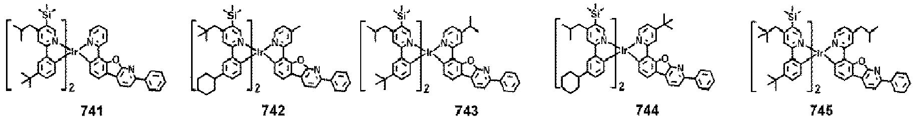 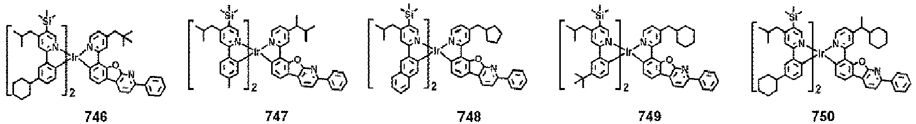 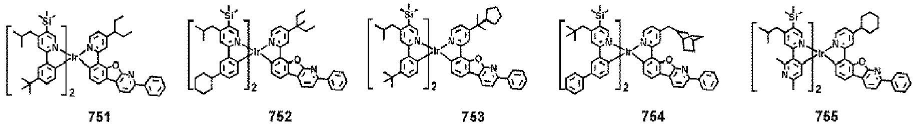 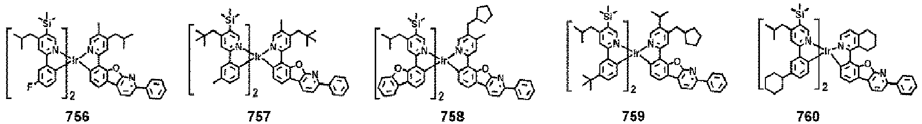 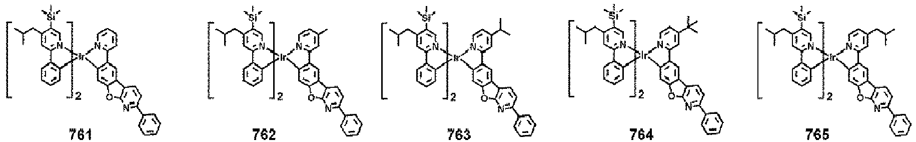 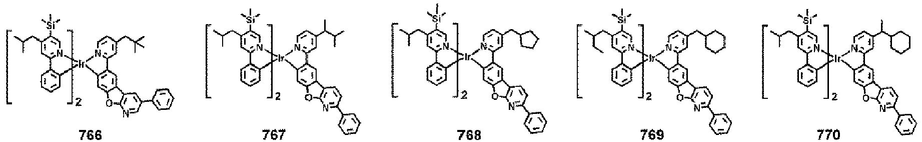 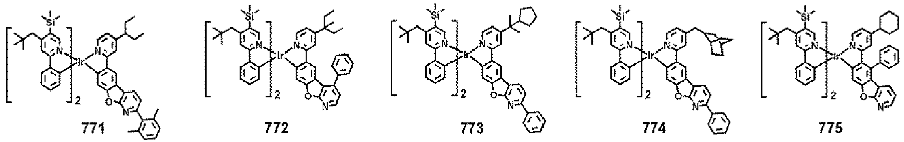 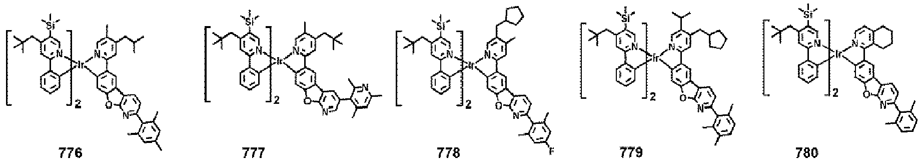 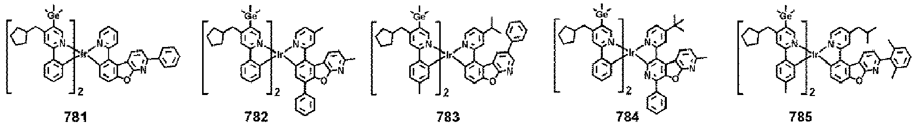 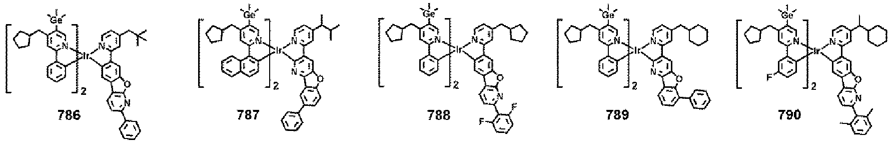 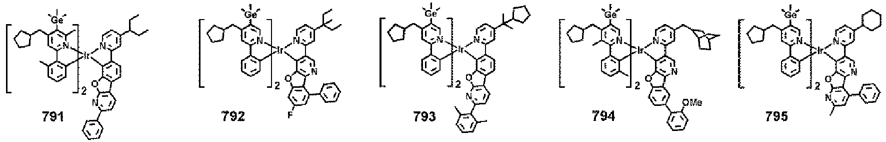 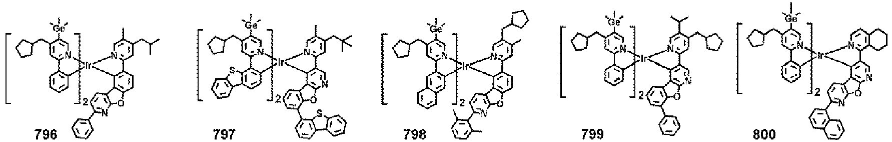 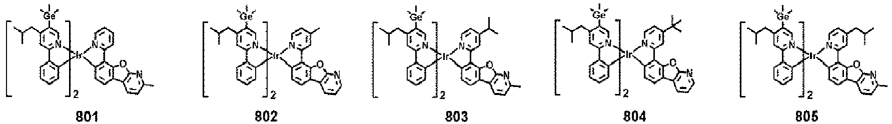 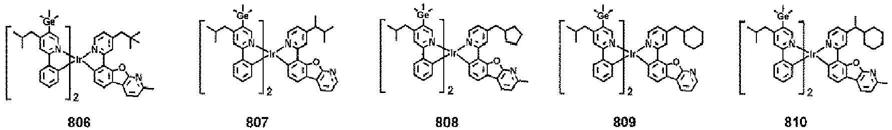 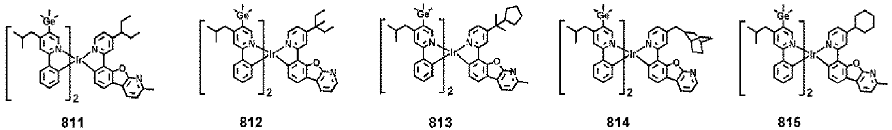 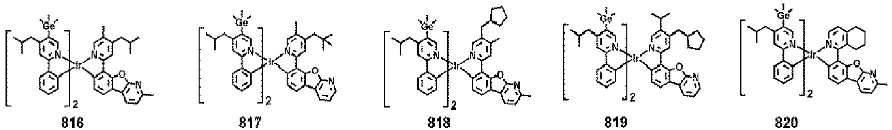 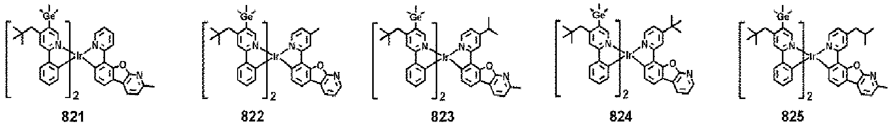 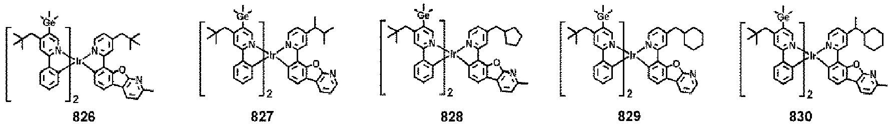 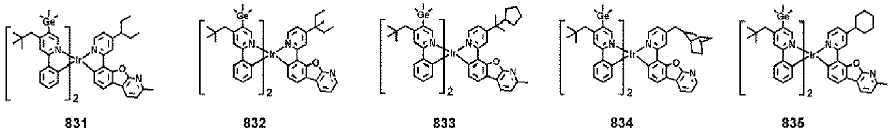 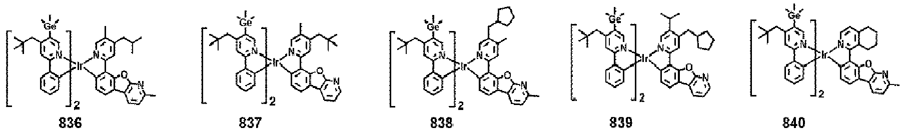 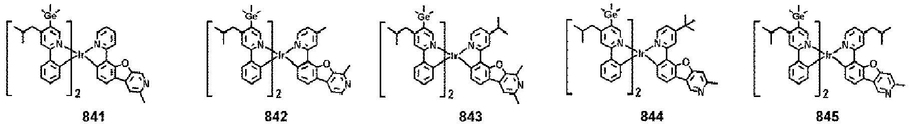 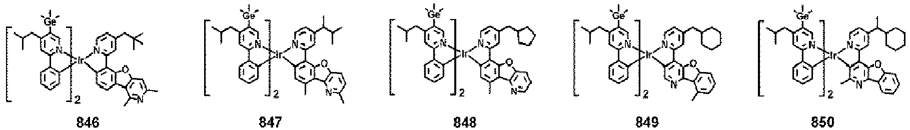 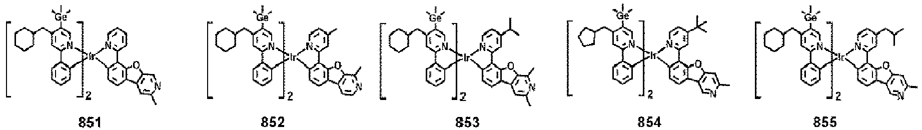 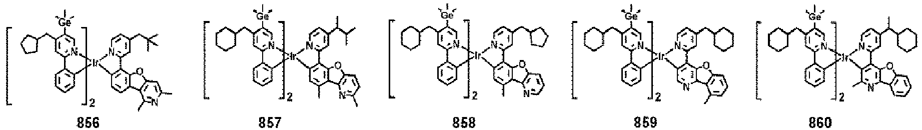 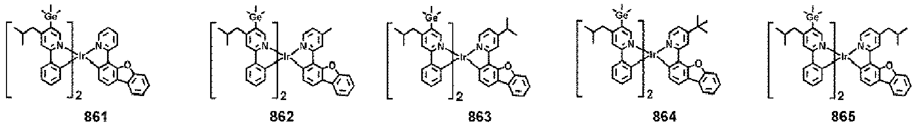 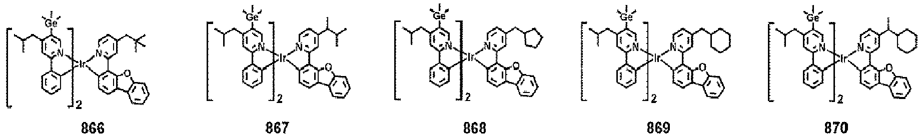 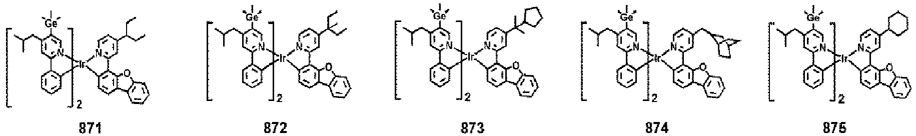 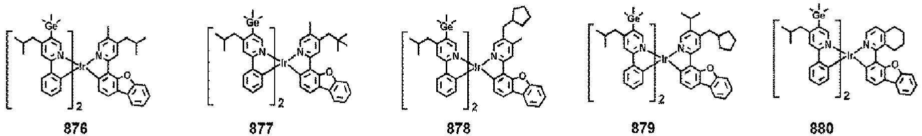 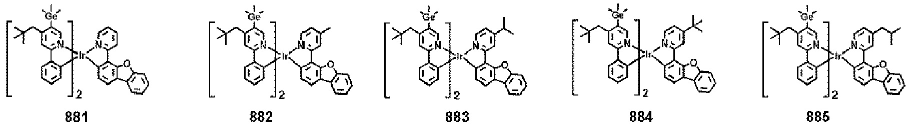 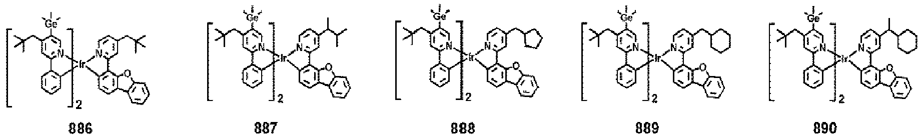 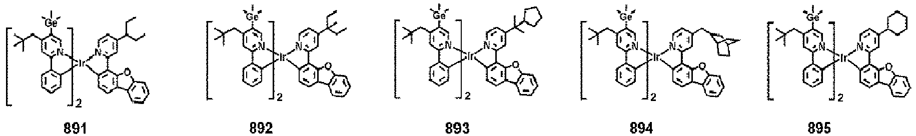 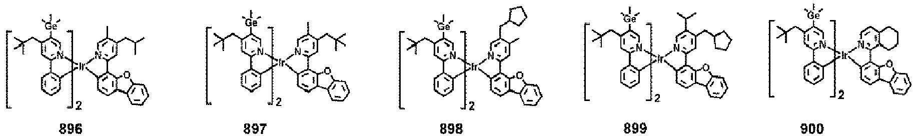 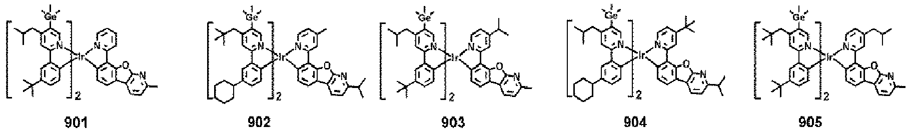 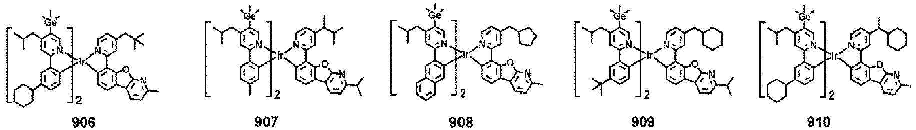 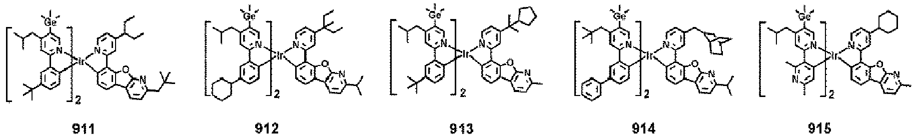 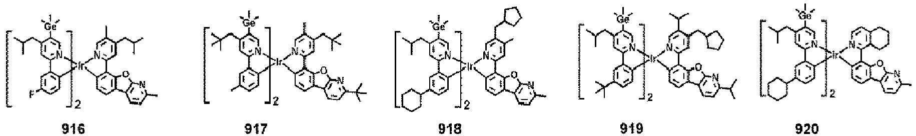 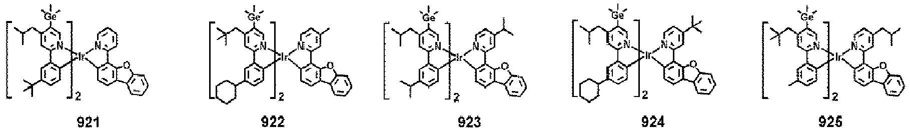 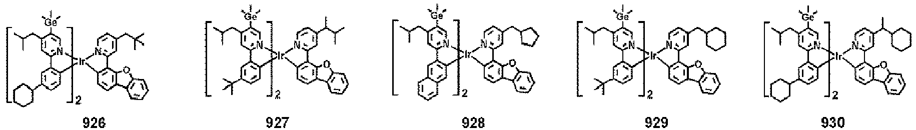 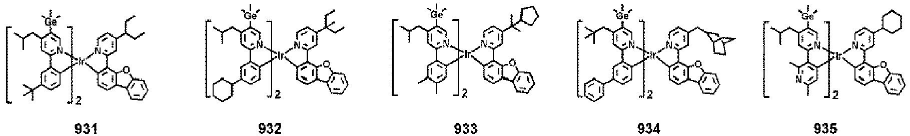 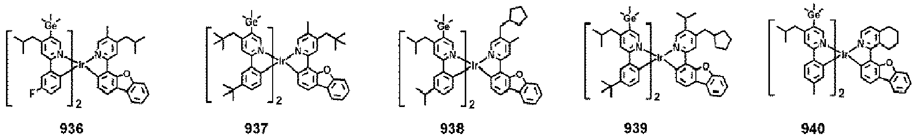 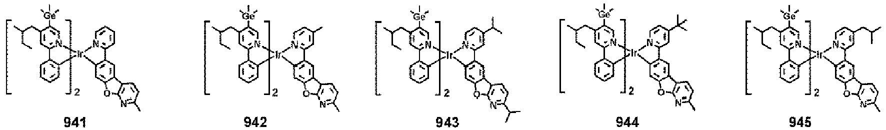 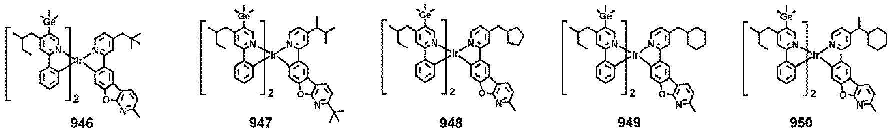 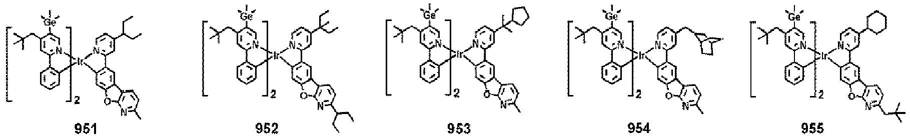 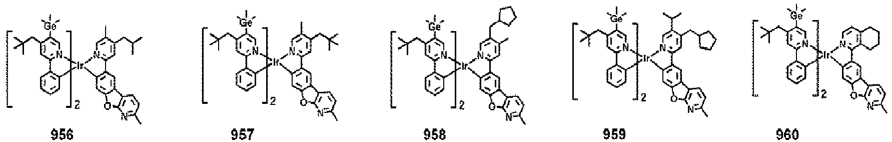 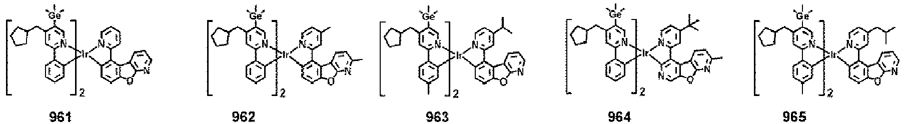 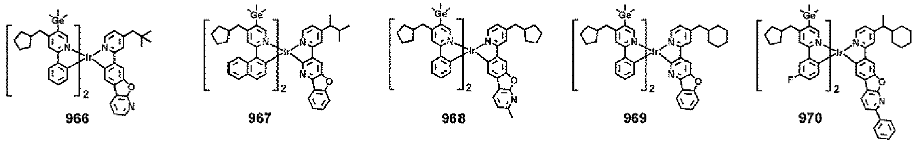 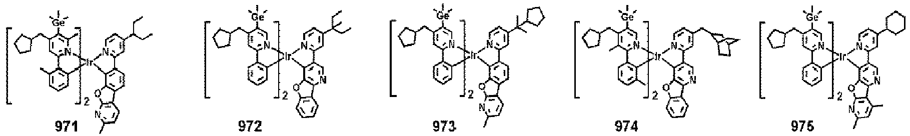 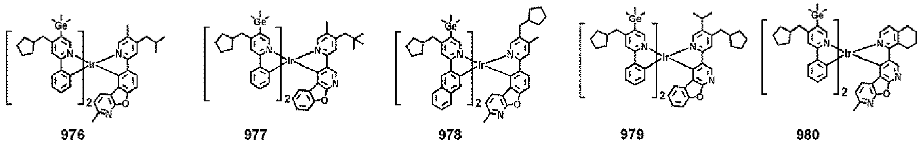 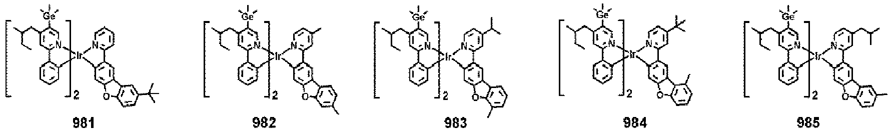 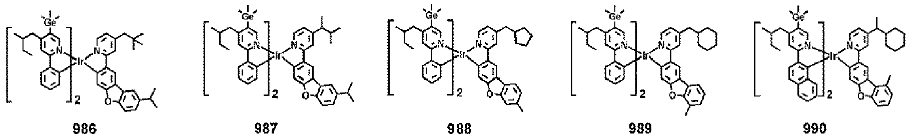 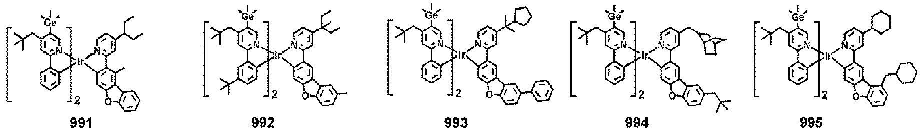 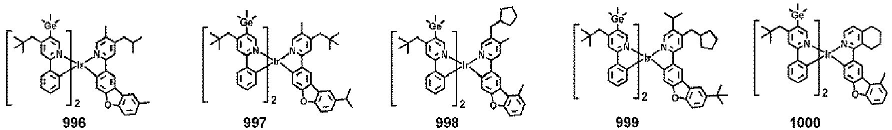 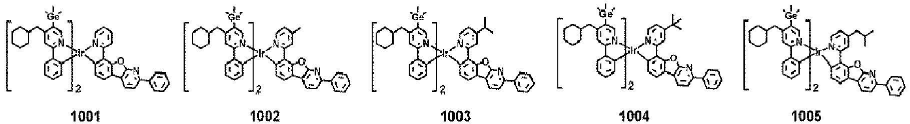 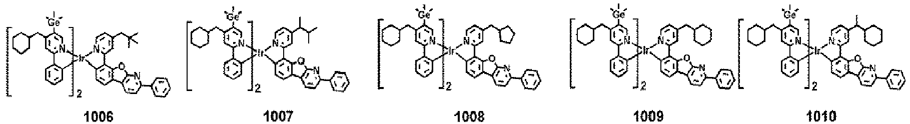 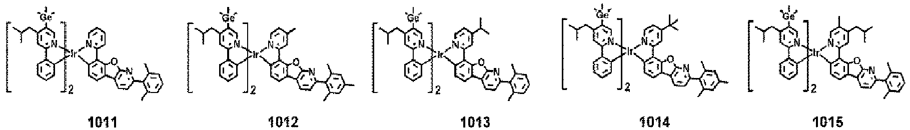 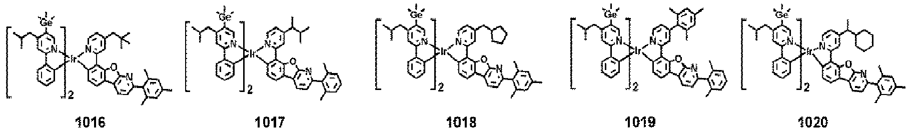 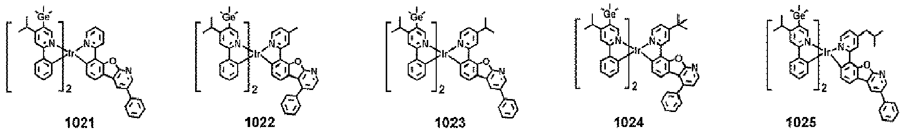 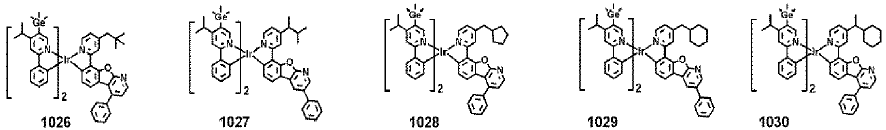 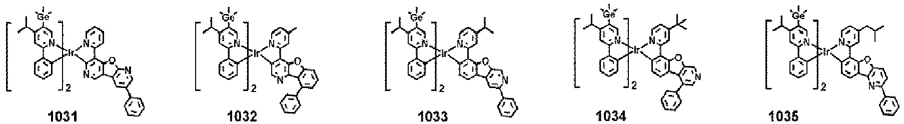 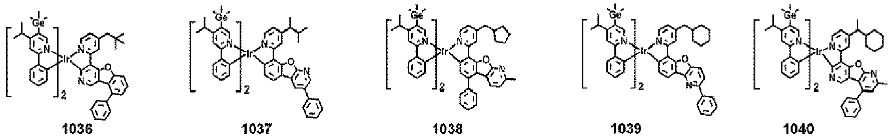 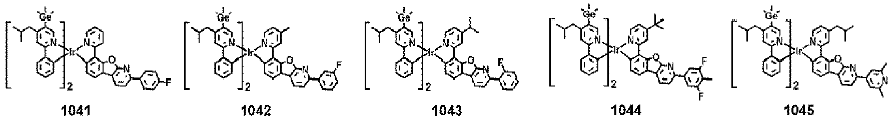 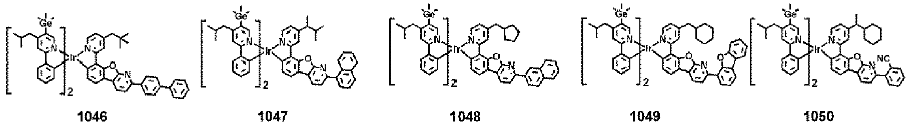 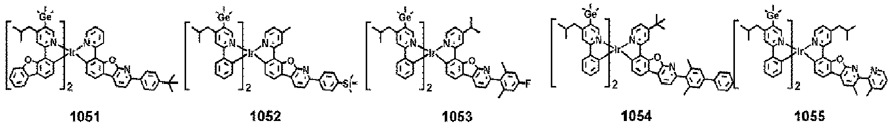 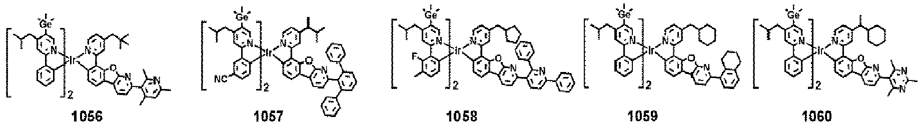 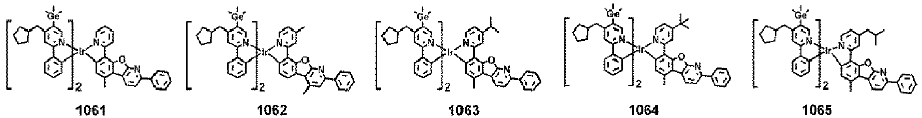 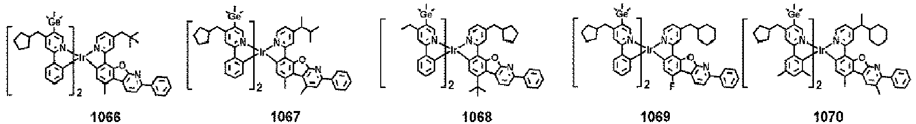 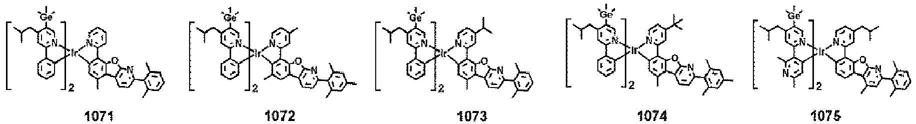 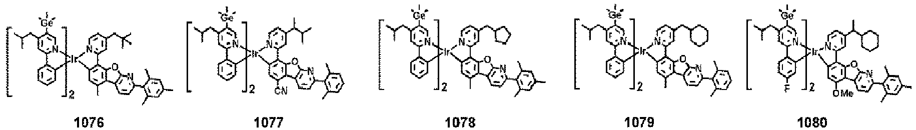 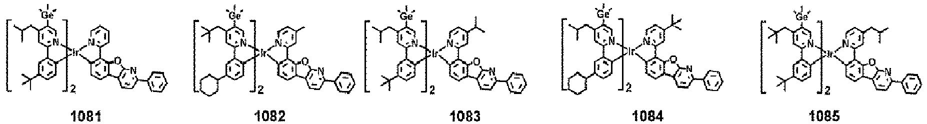 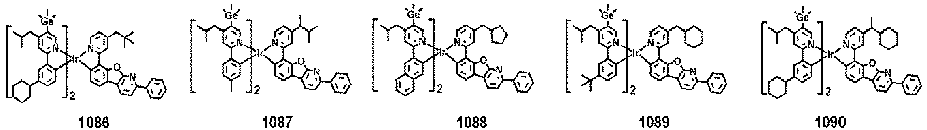 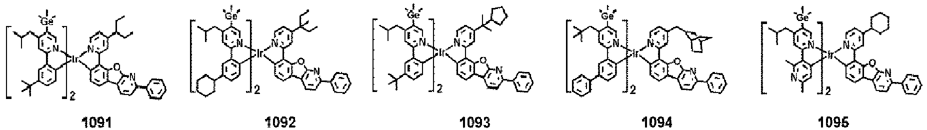 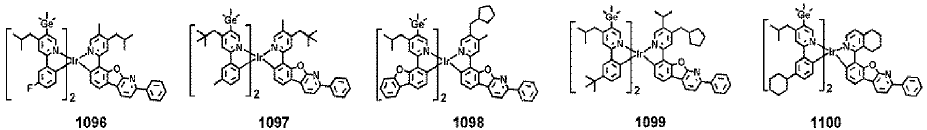 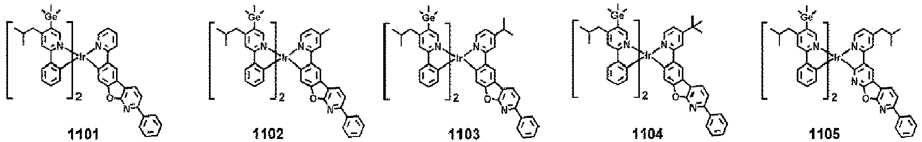 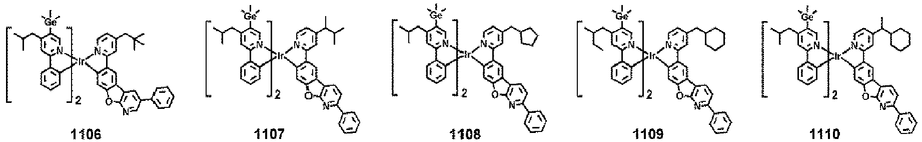 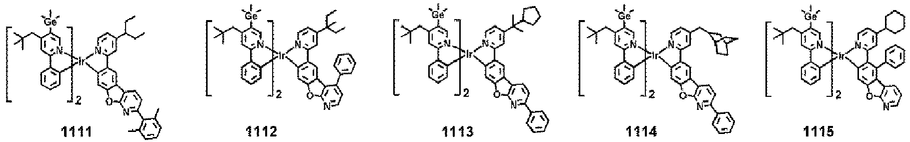 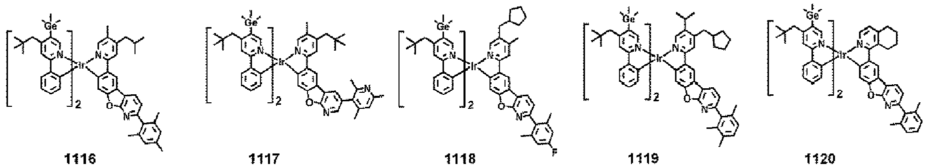 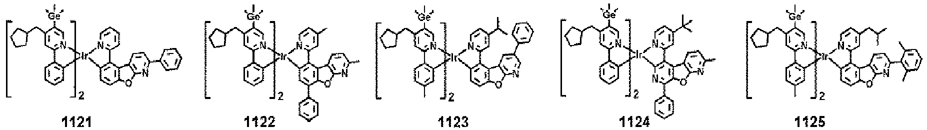 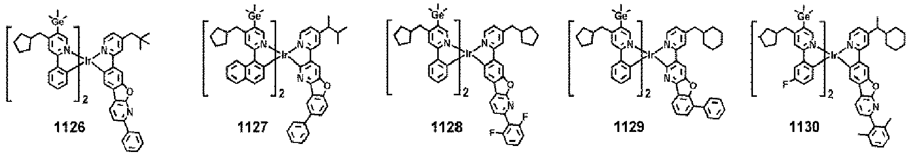 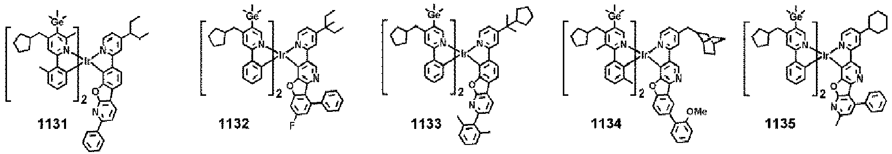 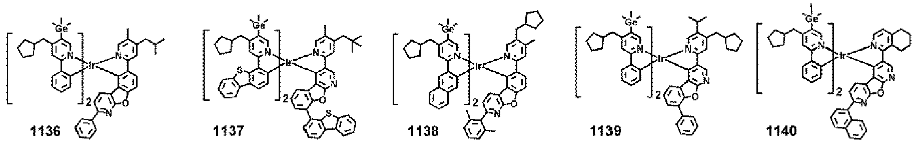 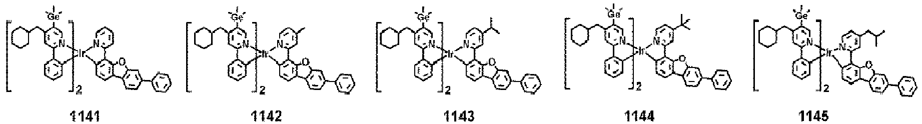 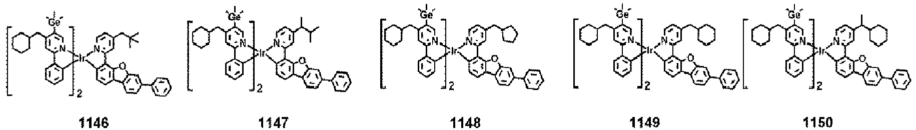 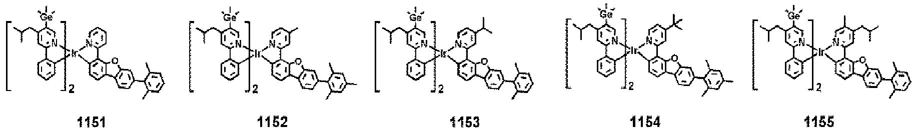 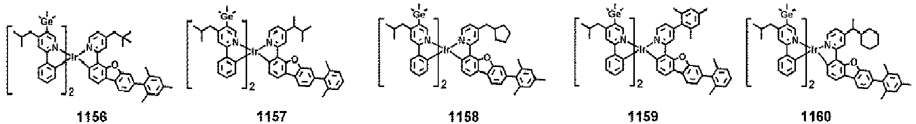 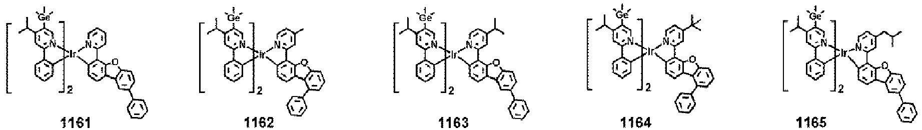 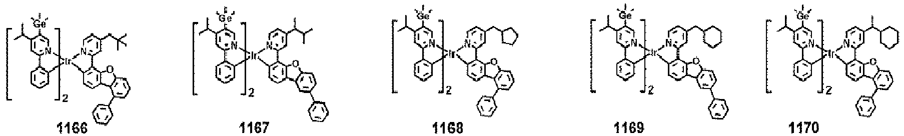 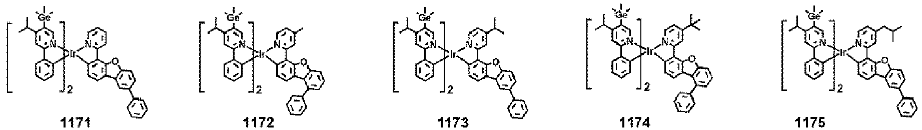 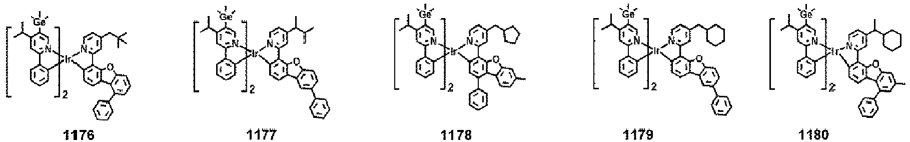 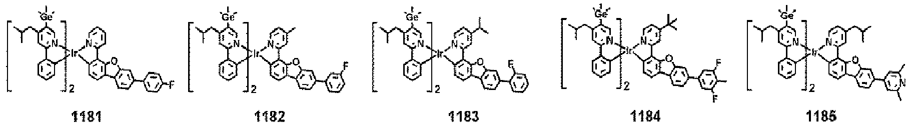 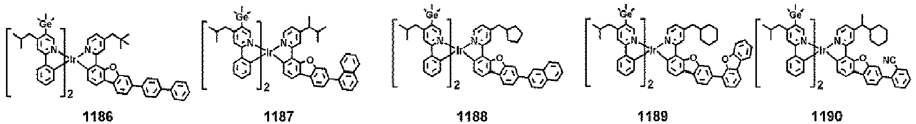 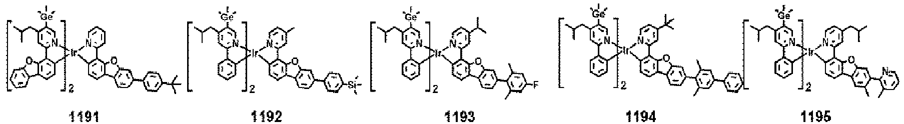 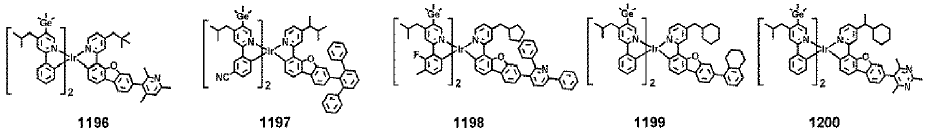 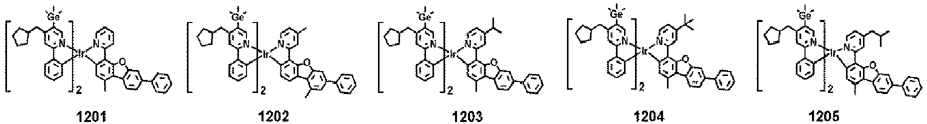 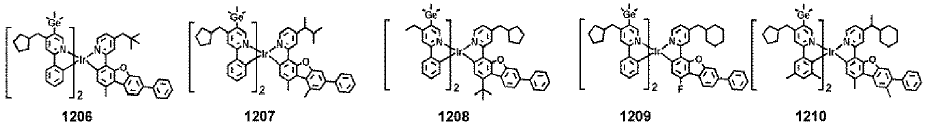 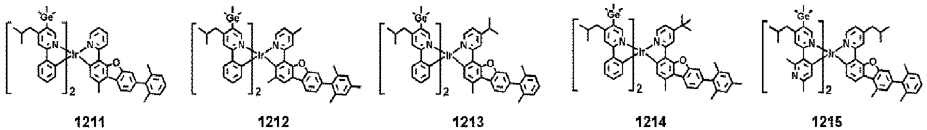 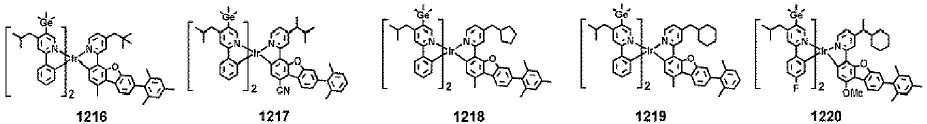 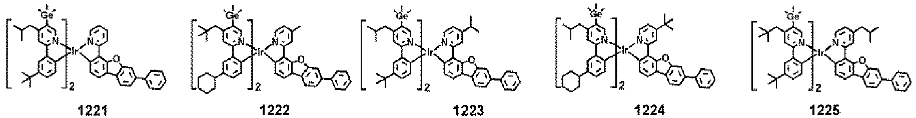 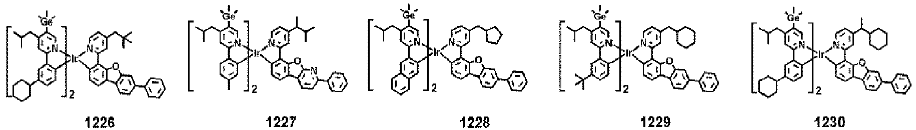 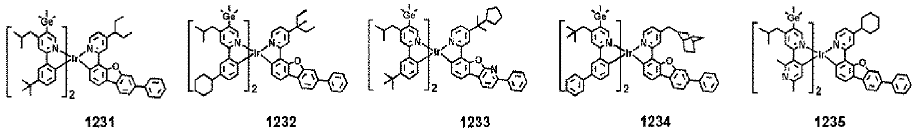 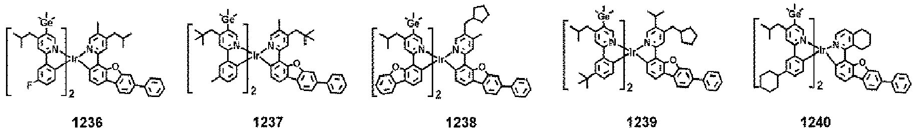 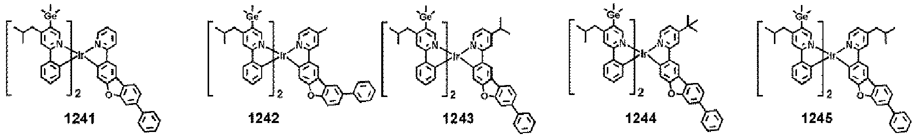 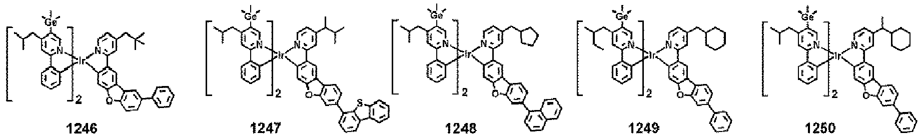 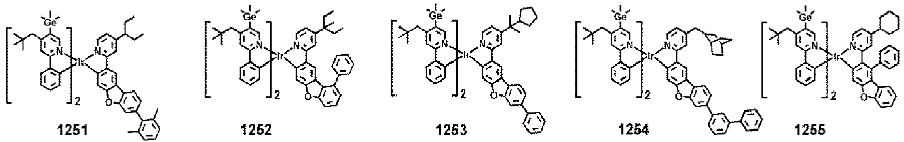 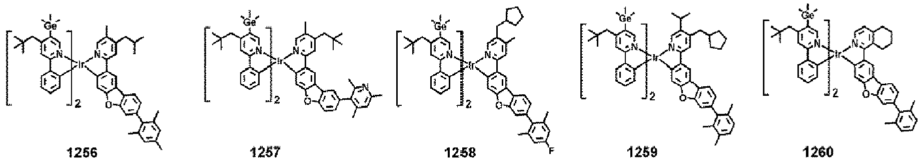 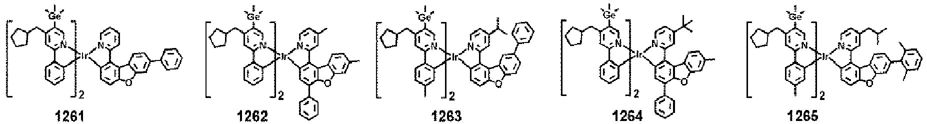 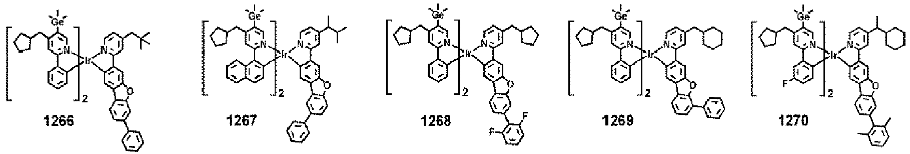 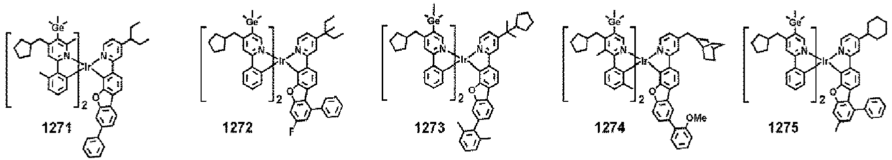 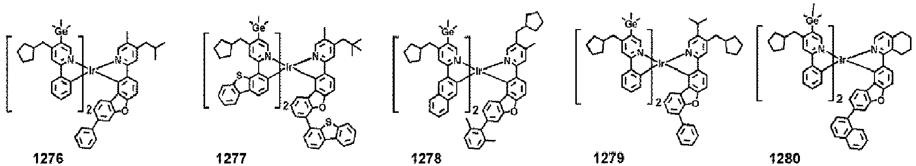 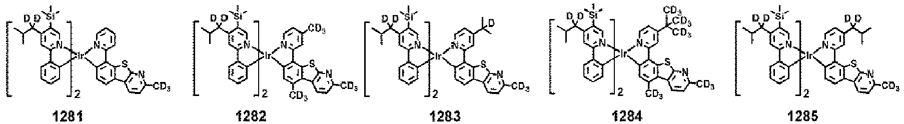 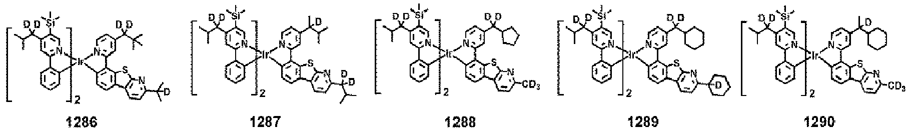 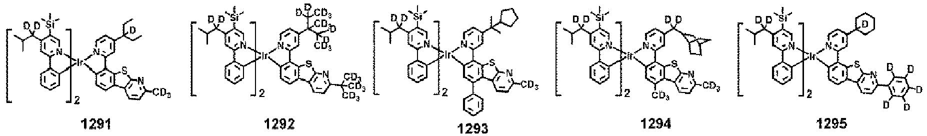 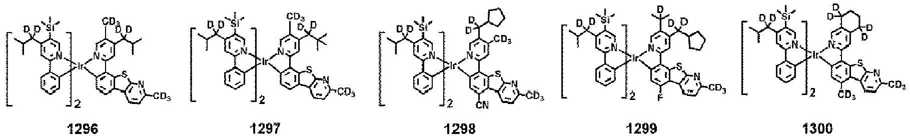 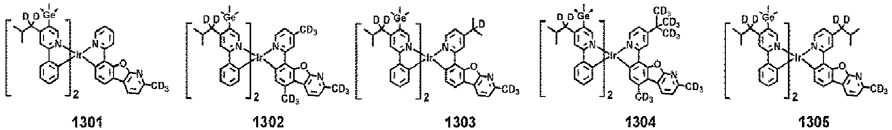 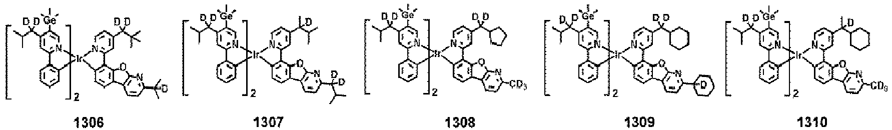 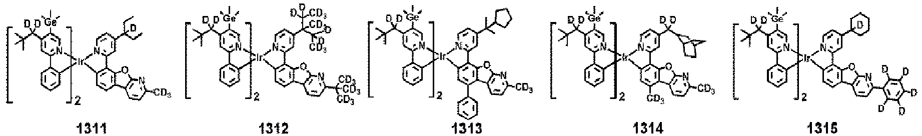 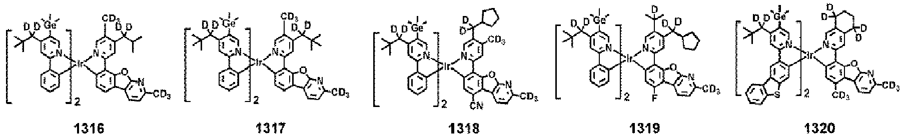 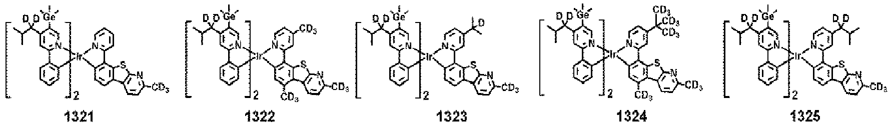 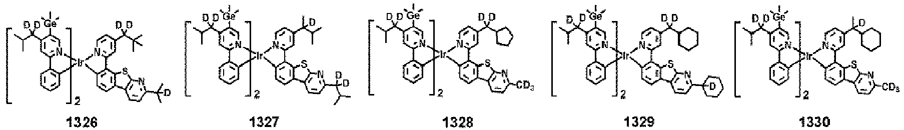 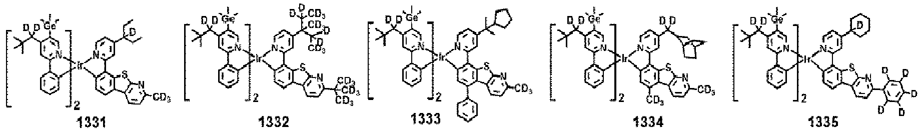 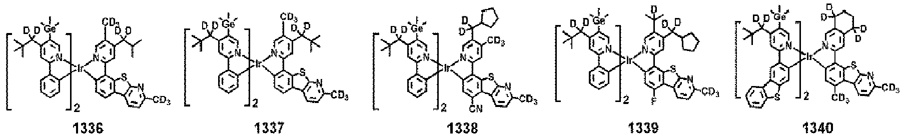 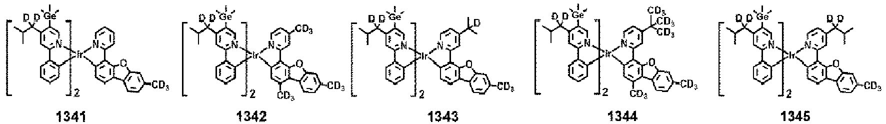 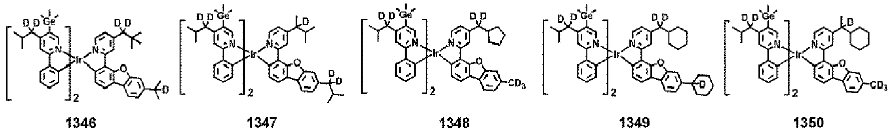 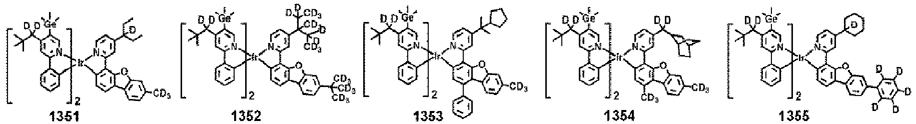 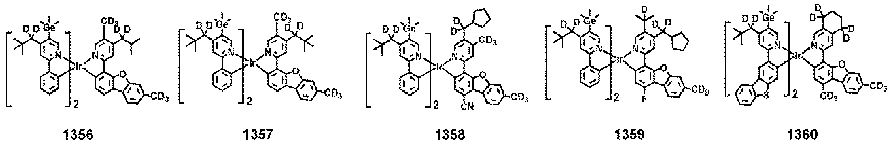 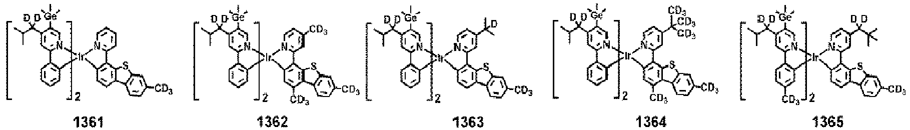 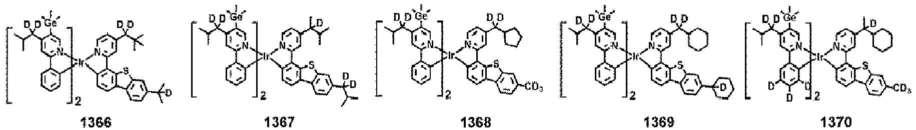 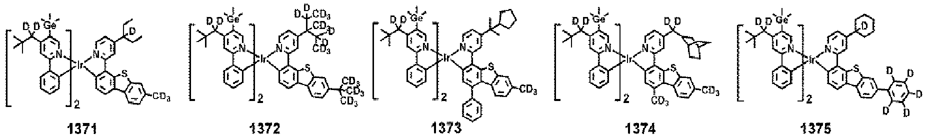 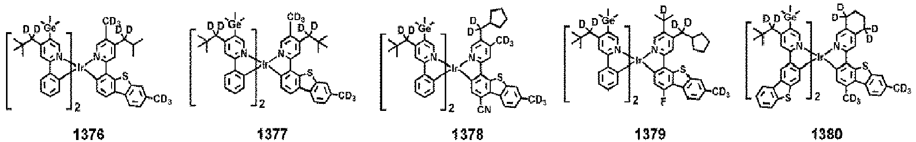 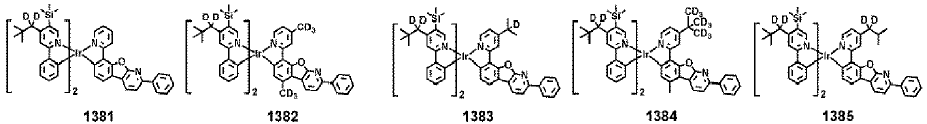 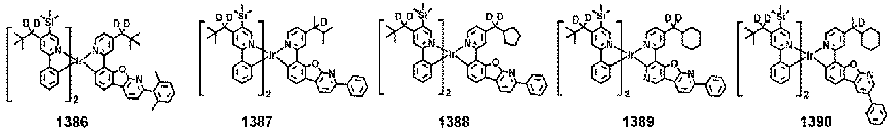 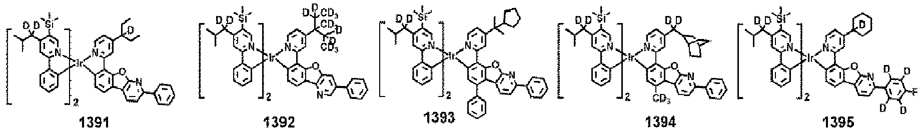 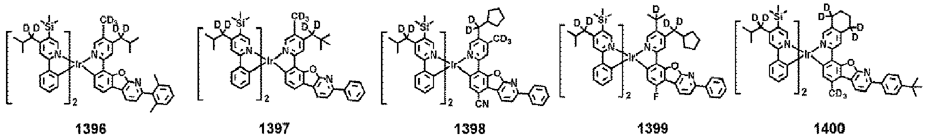 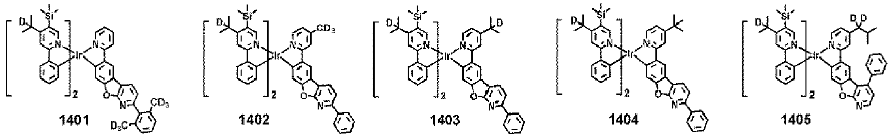 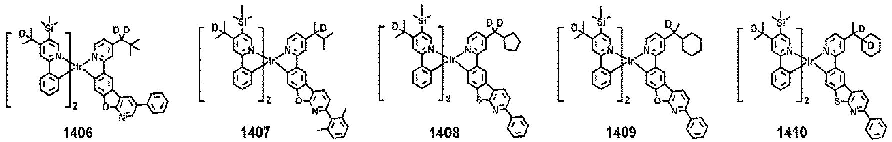 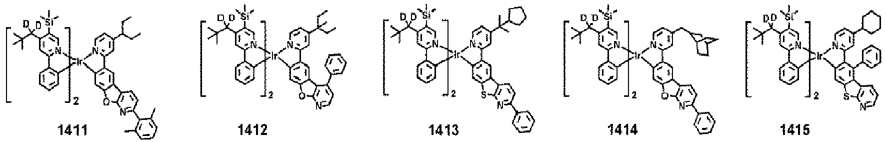 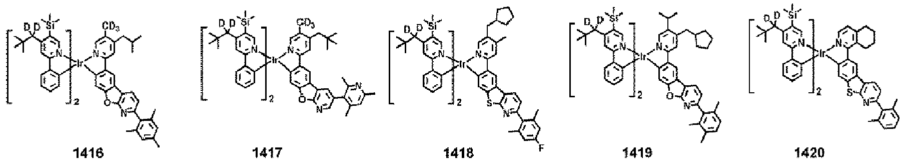 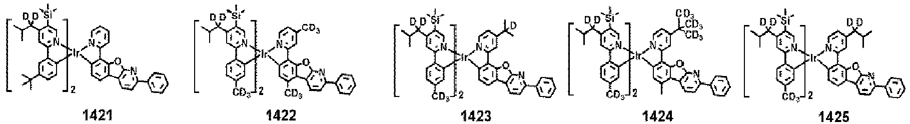 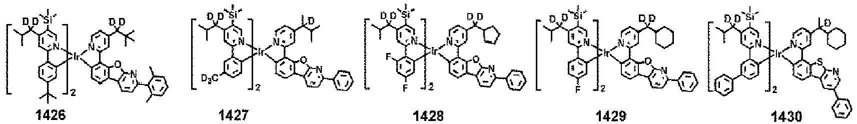 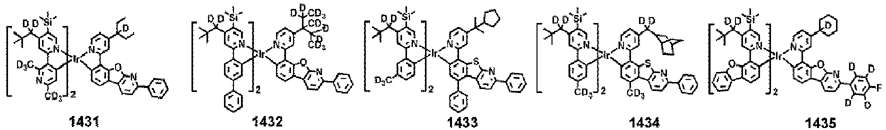 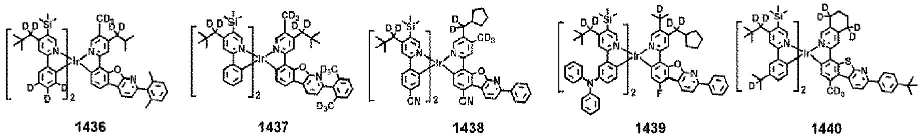 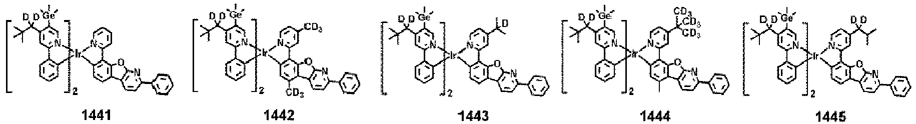 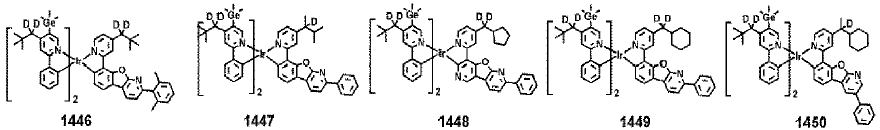 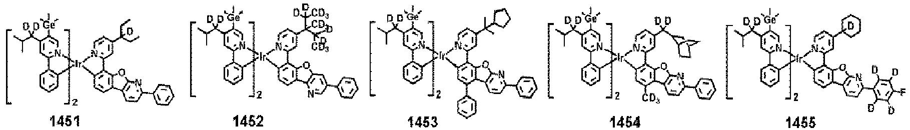 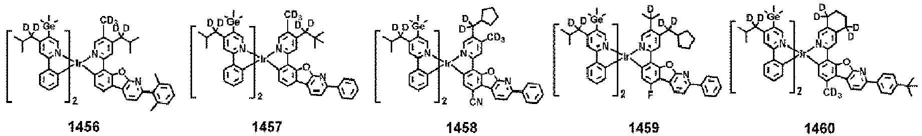 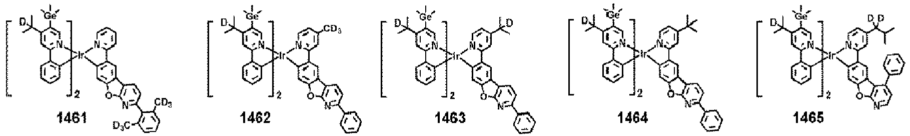 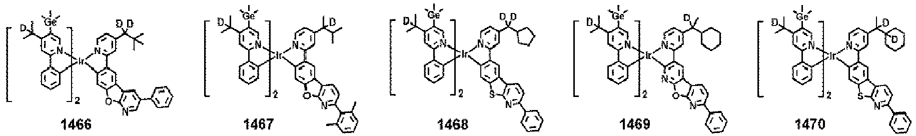 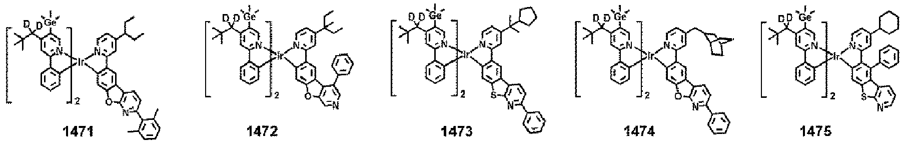 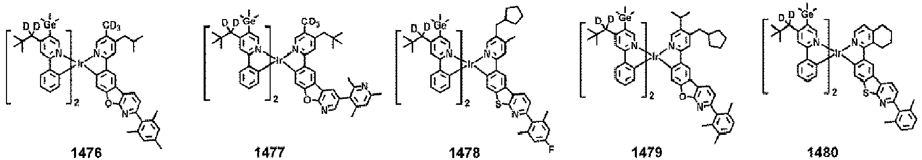 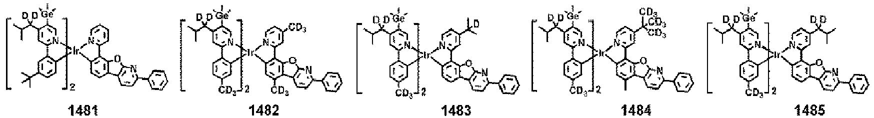 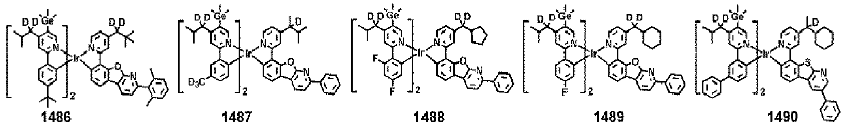 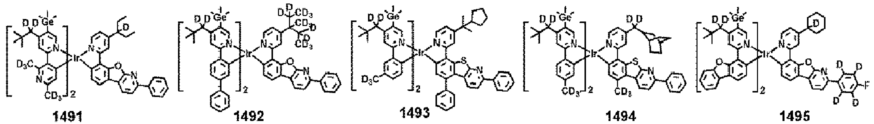 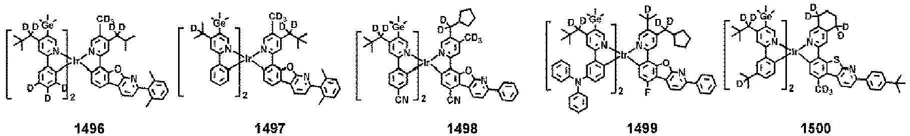 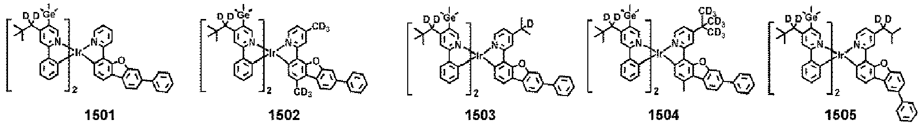 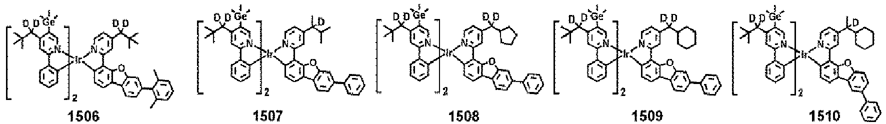 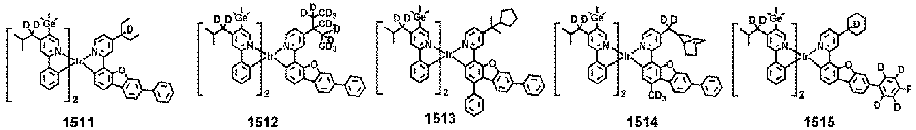 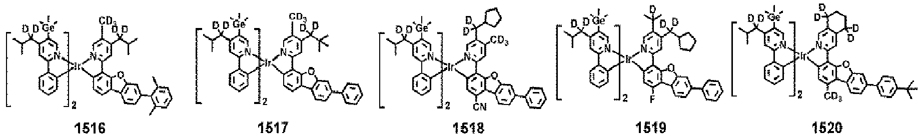 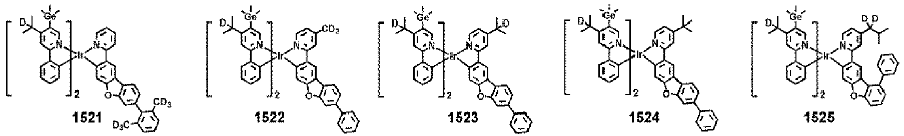 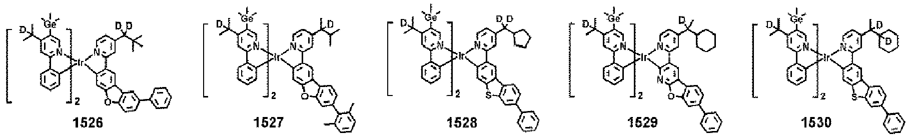 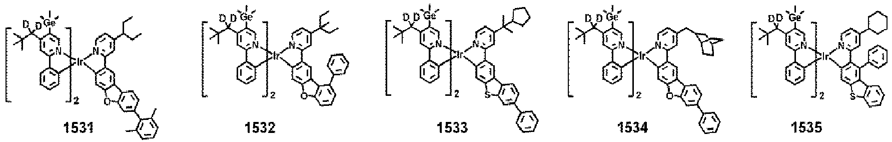 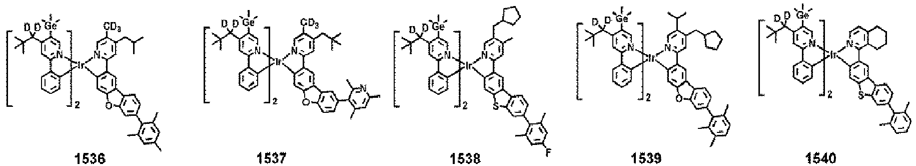 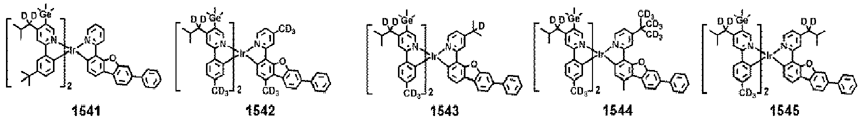 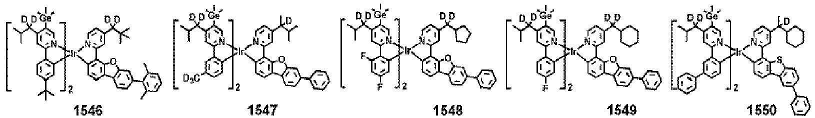 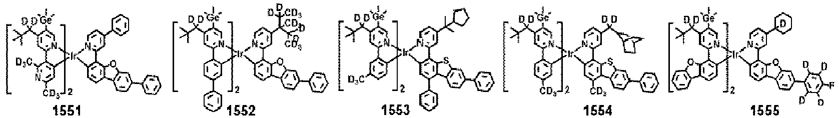 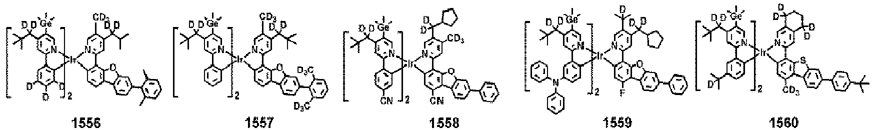 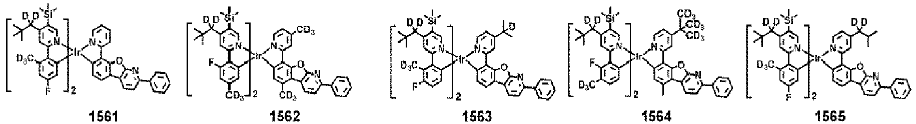 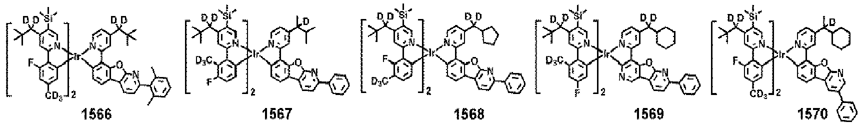 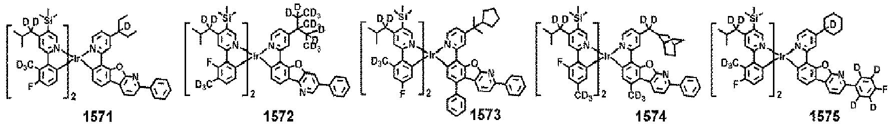 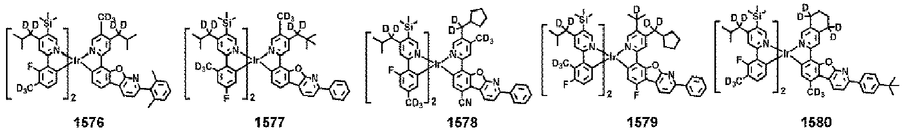 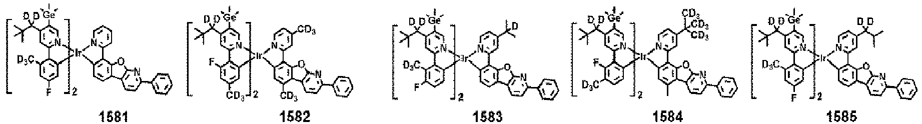 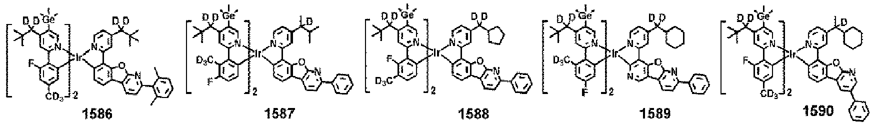 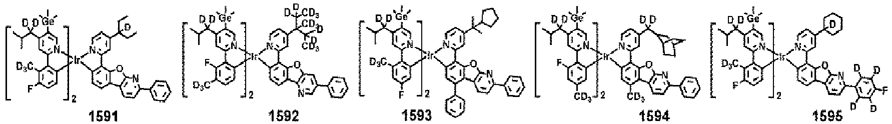 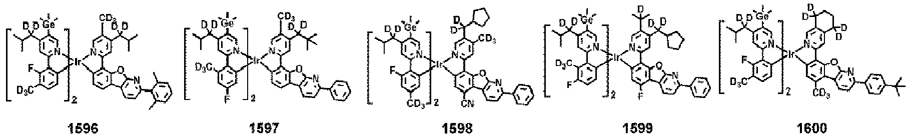 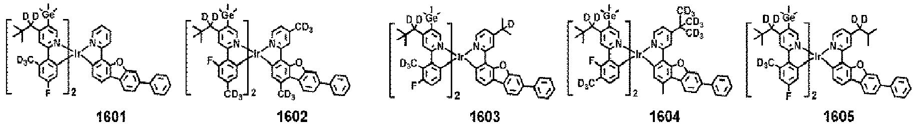 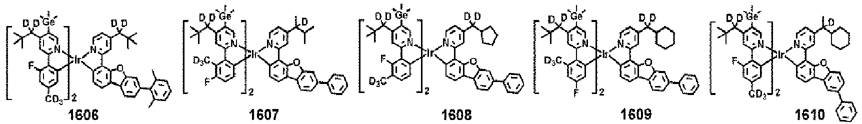 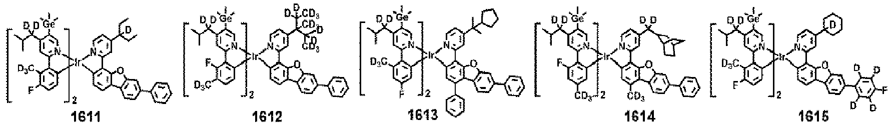 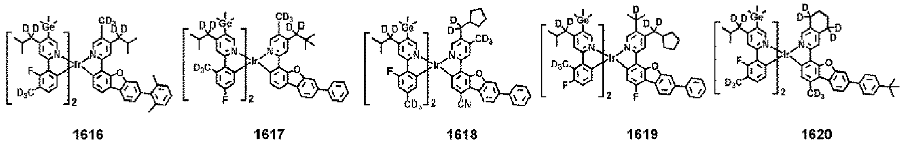
Group 2-3 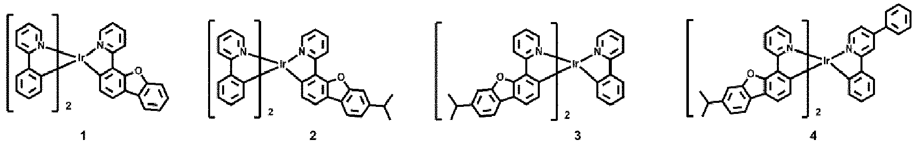 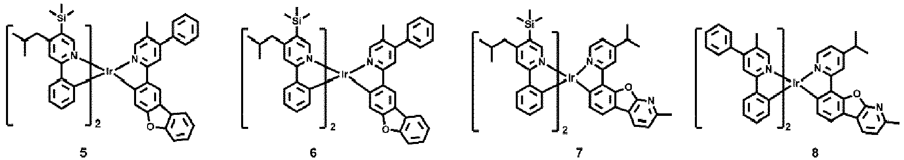 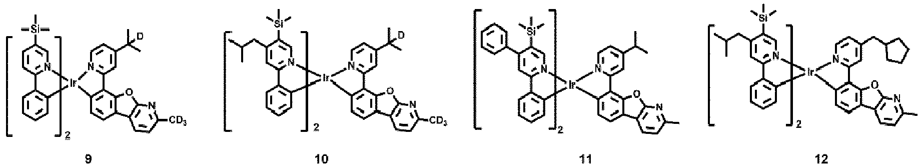 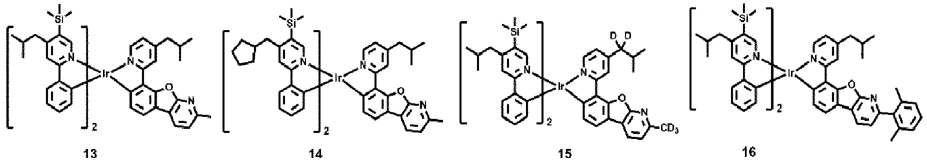 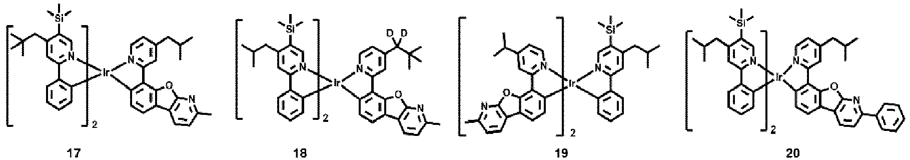 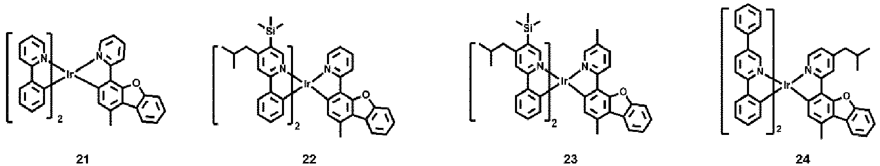 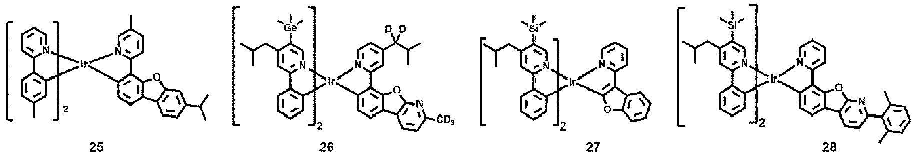 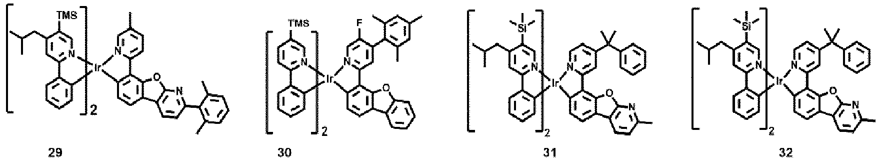 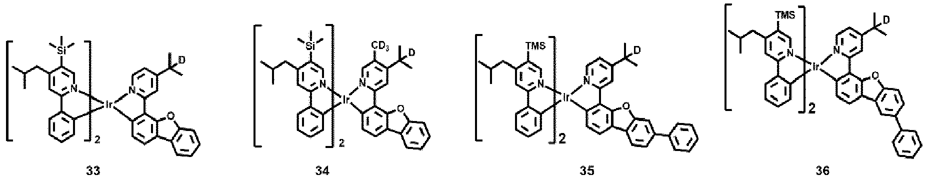 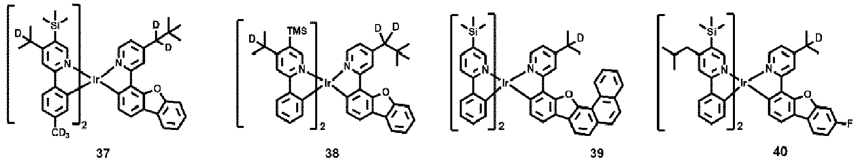 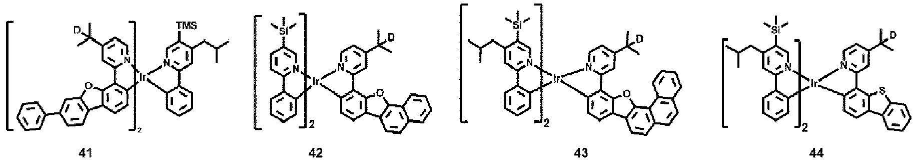 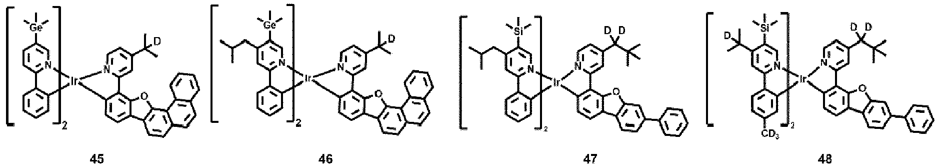 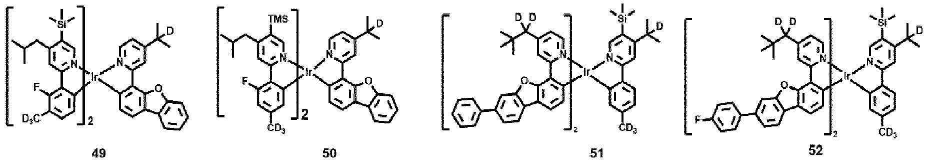 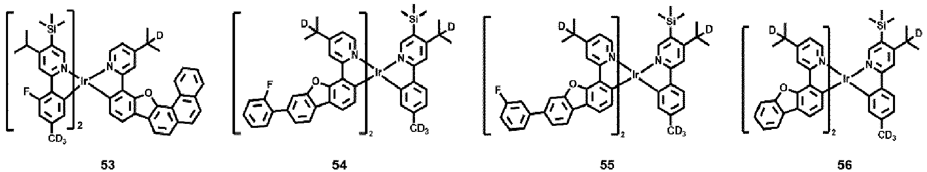 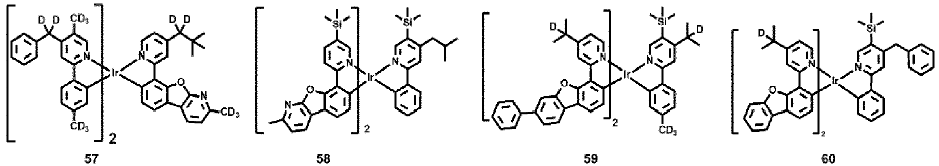 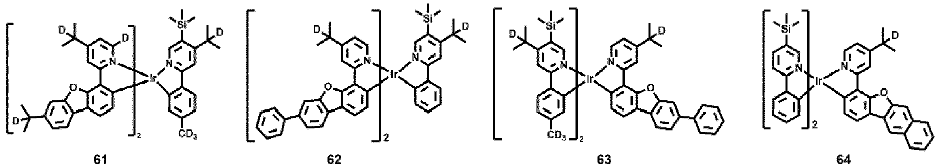 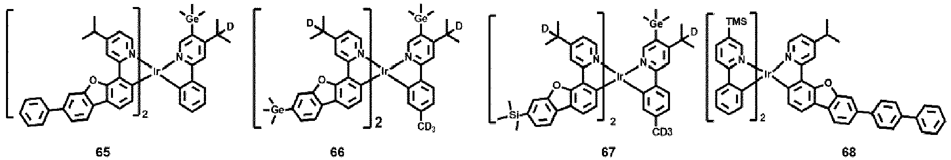 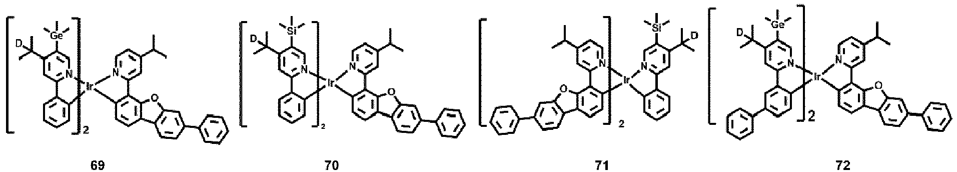 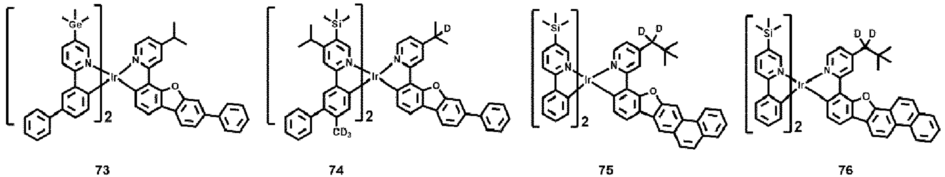 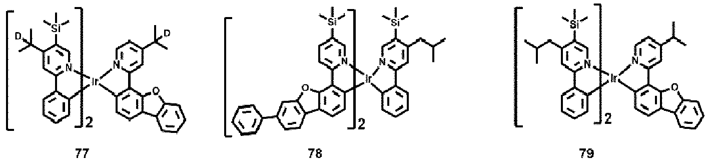
Group 2-4 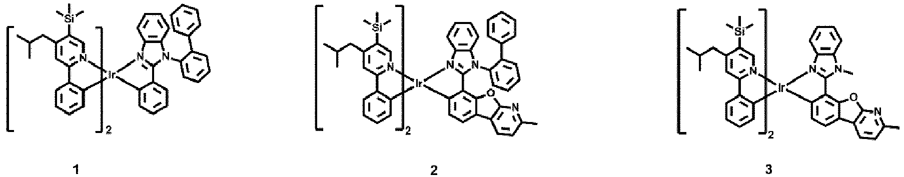 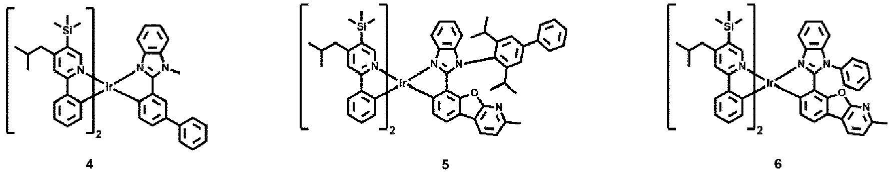 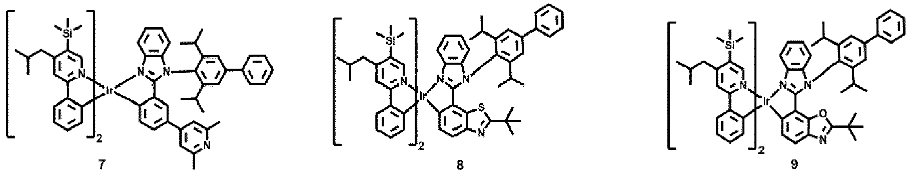 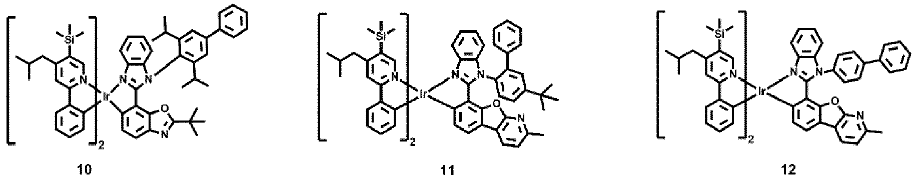 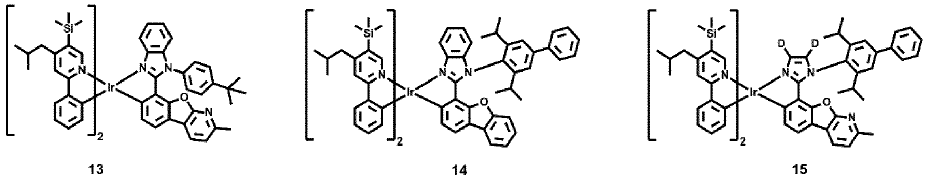 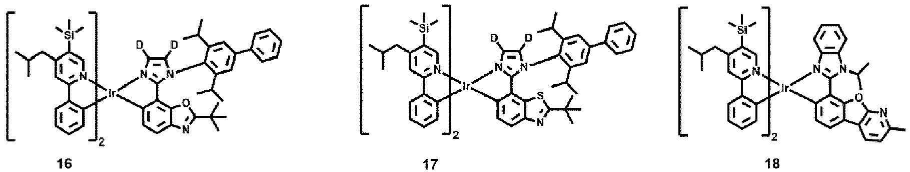 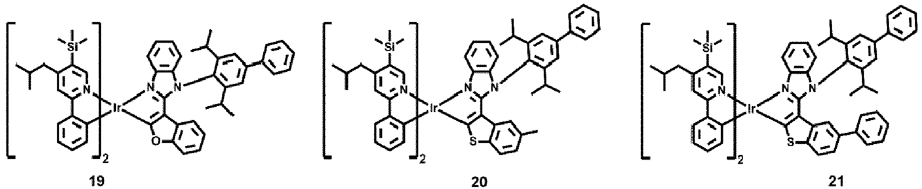 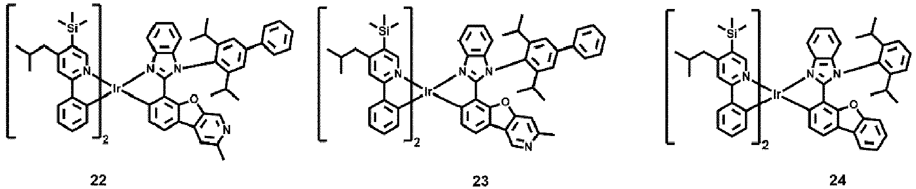 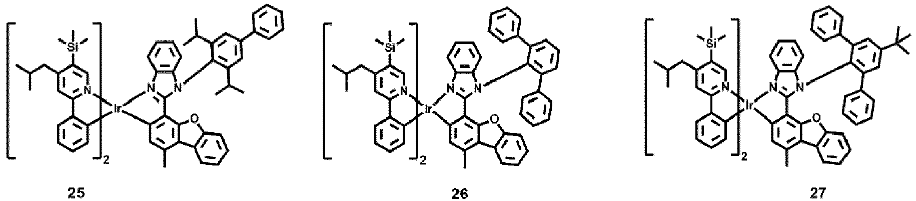 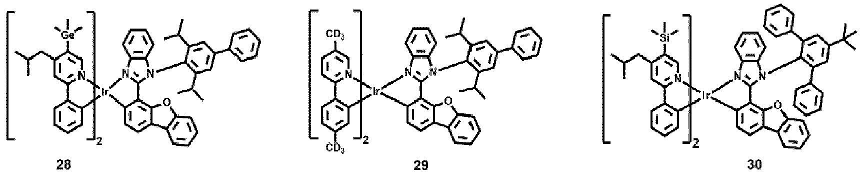 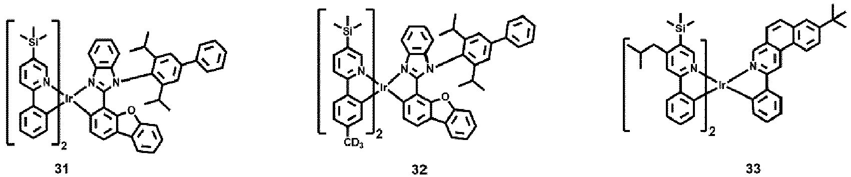 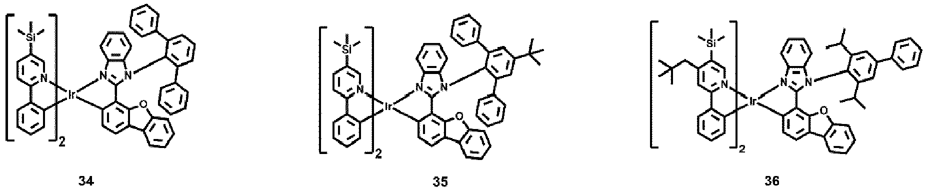 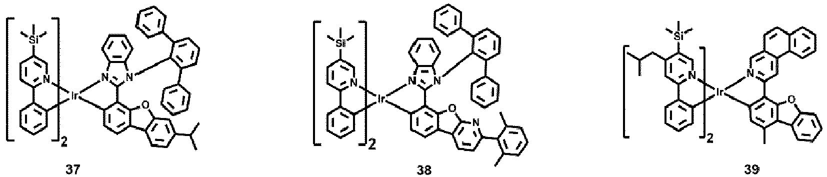 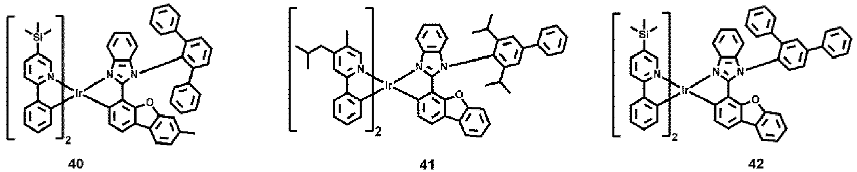 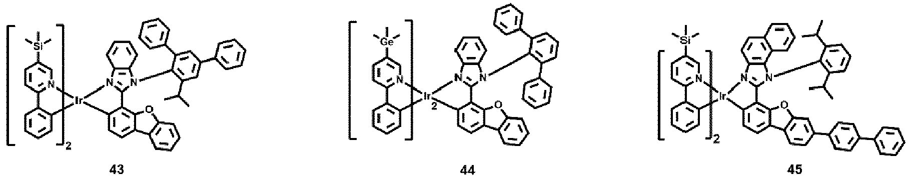 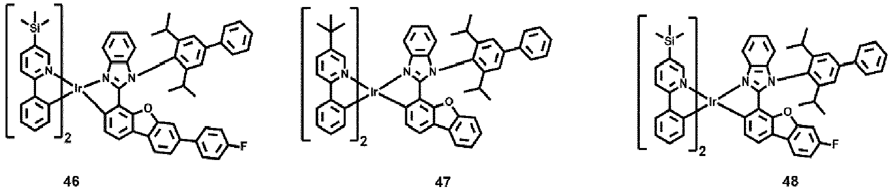 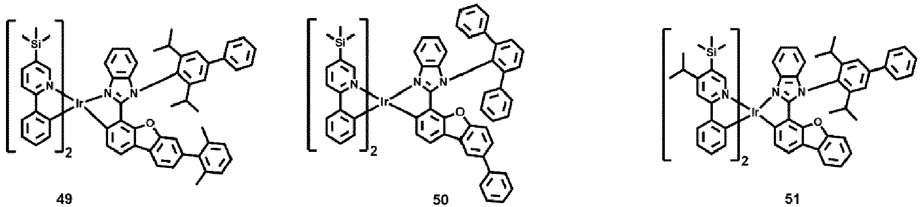 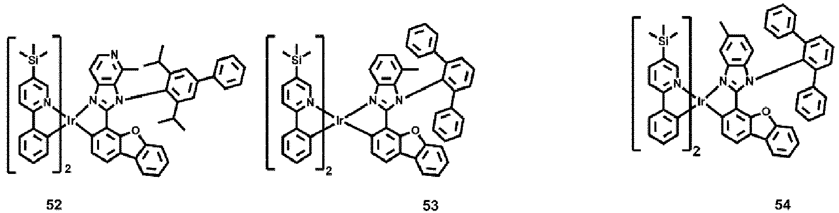 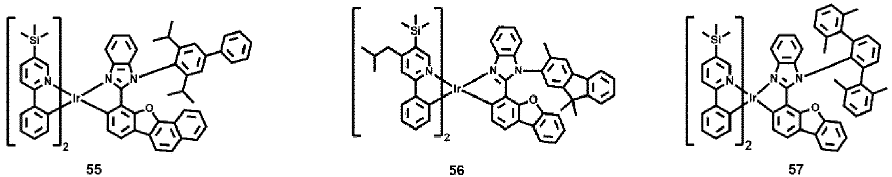 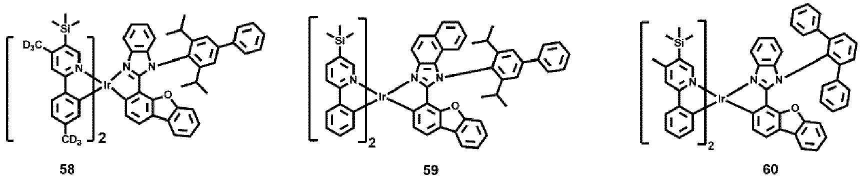 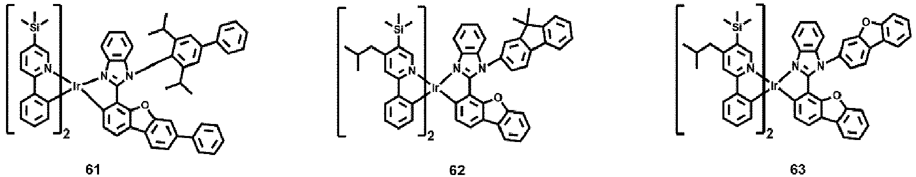 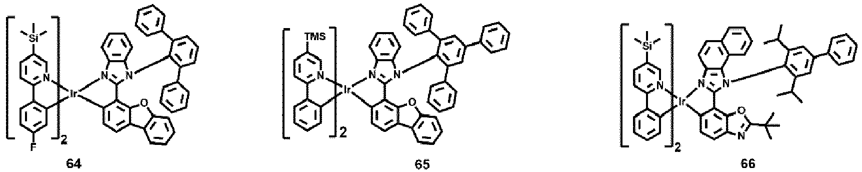 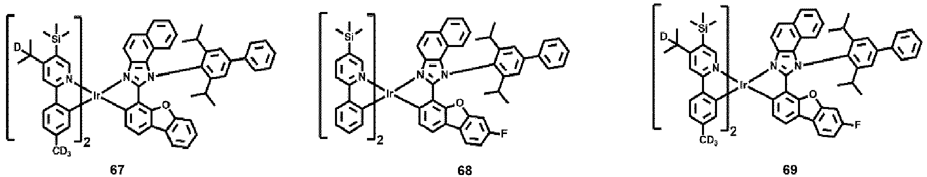 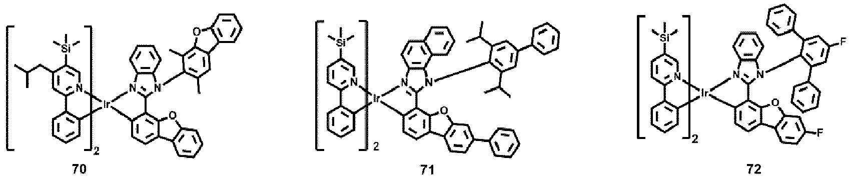 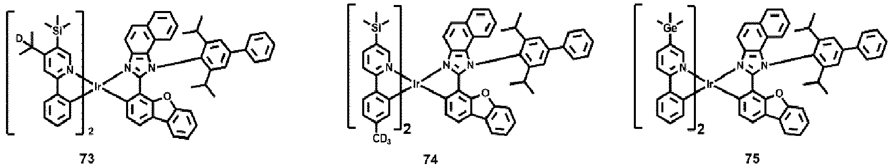 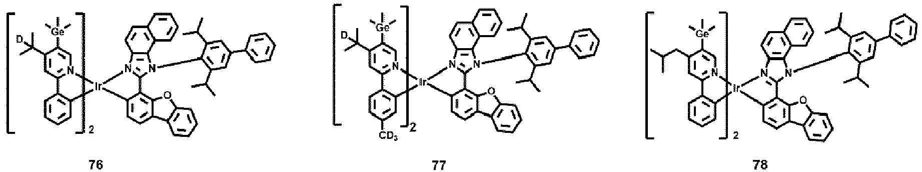 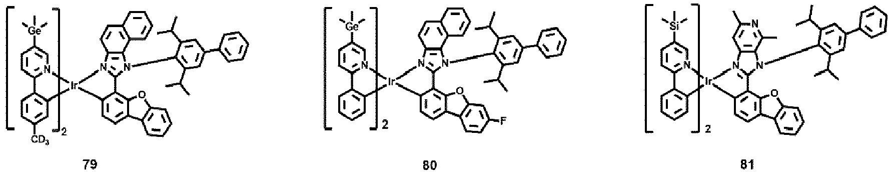 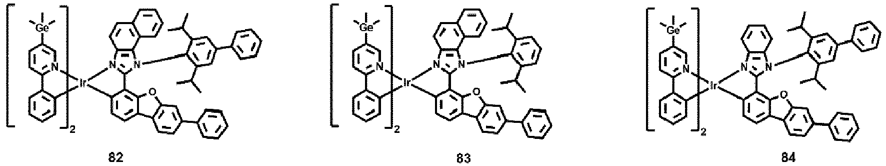 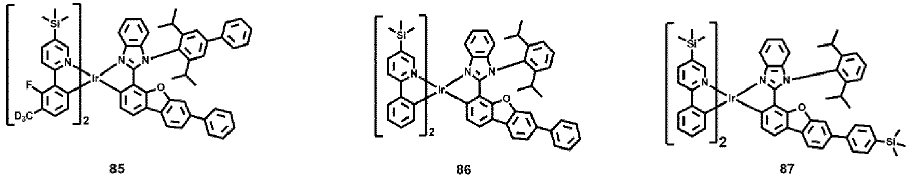 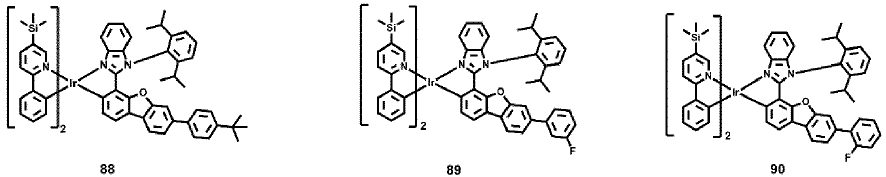 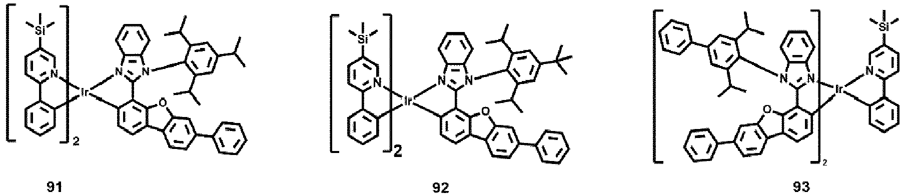 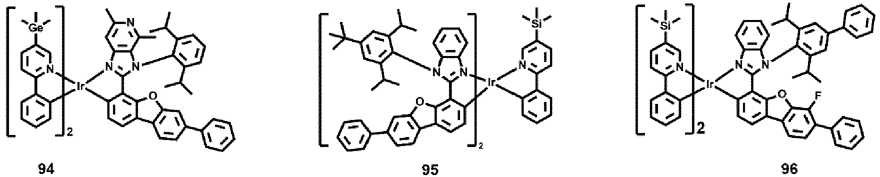 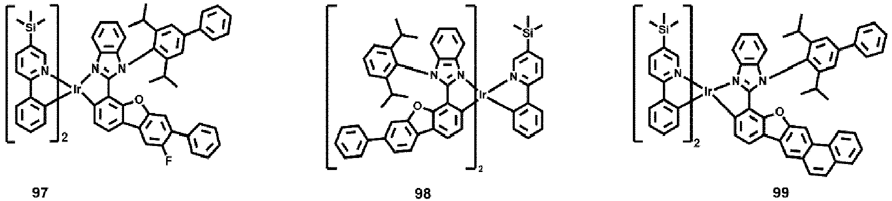 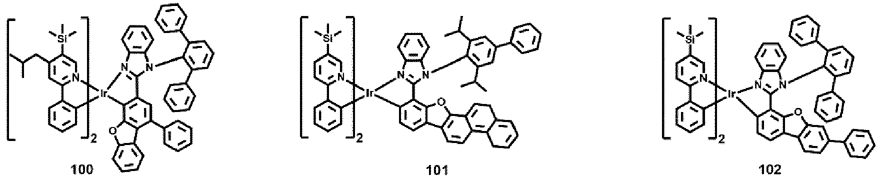 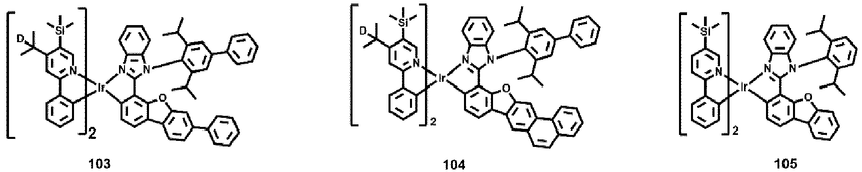 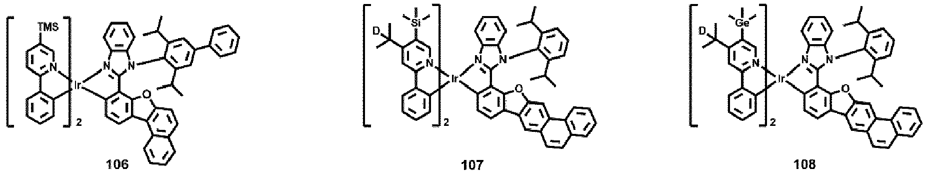 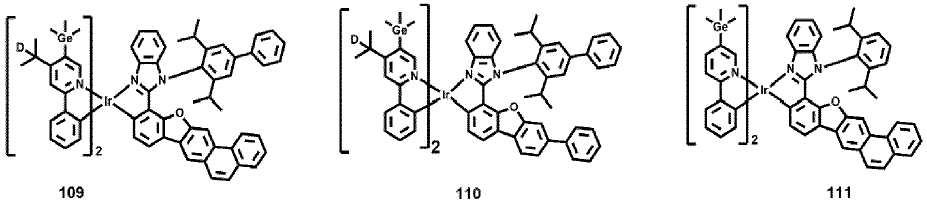 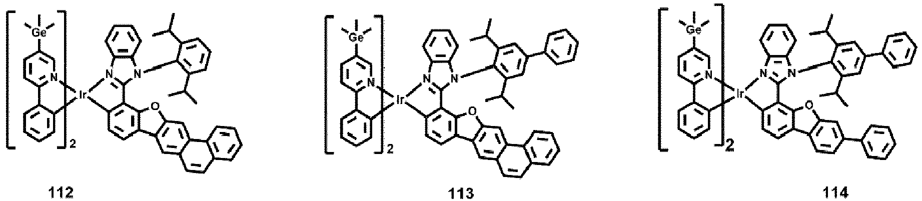 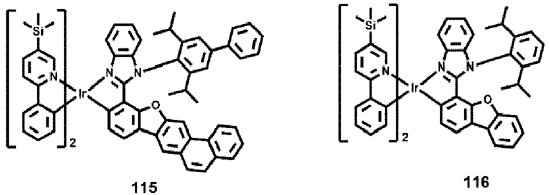
Group 2-5

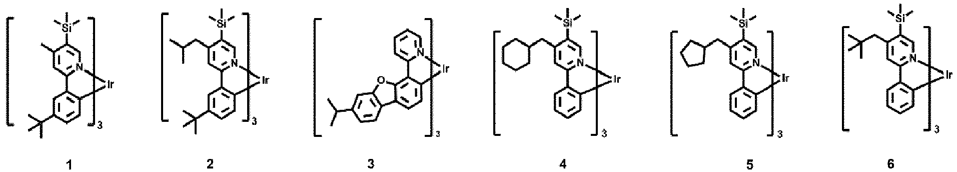

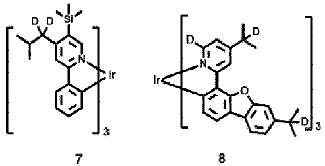

In the present specification, OMe refers to a methoxy group, TMS refers to a trimethylsilyl group, and TMG refers to a trimethylgermyl group.

In an embodiment, the first emission layer may include a first dopant and a first host, the second emission layer may include a second dopant and a second host, the first dopant may include the first compound, and the second dopant may include the second compound.

In an embodiment, the first host and the second host may be identical to each other.

In an embodiment, the first host and the second host may be different from each other.

The first host and the second host may each include a hole transport compound, an electron transport compound, a bipolar compound, or any combination thereof.

In an embodiment, the first host and the second host may each include a hole transport compound and an electron transport compound, and the hole transport compound and the electron transport compound may be different from each other.

In an embodiment, the hole transport compound may include at least one π electron-rich C₃-C₆₀ cyclic group (e.g., a carbazole group, an indolocarbazole group, a benzene group, etc.), and may not include an electron transport group. Examples of the electron transport group may include a cyano group, a fluoro group, a π electron-deficient nitrogen-containing C₁-C₆₀ cyclic group, a phosphine oxide group, and a sulfoxide group.

In an embodiment, the electron transport compound may be a compound including at least one electron transport group. The electron transport group may be a cyano group, a fluoro group, a π electron-deficient nitrogen-containing C₁-C₆₀ cyclic group, a phosphine oxide group, a sulfoxide group, or a combination thereof.

In an embodiment, the hole transport compound may be at least one of Compounds H1-1 to H1-72 of Group 5-1 and Compounds H1-1 to H1-20 of Group 5-2:
Group 5-1 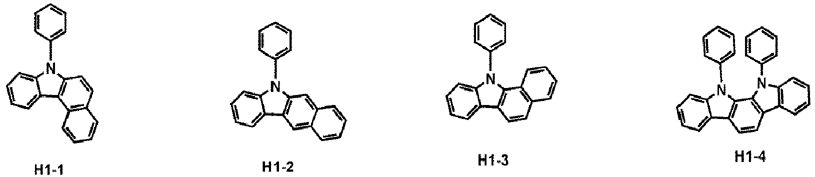 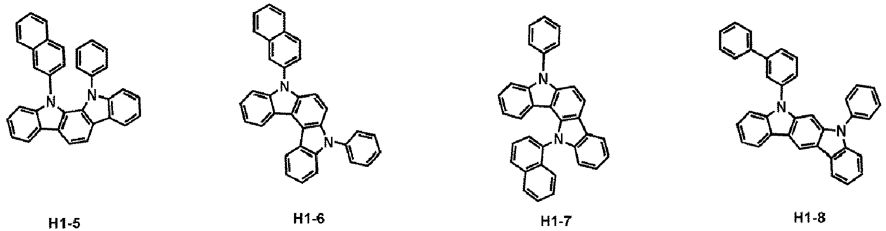 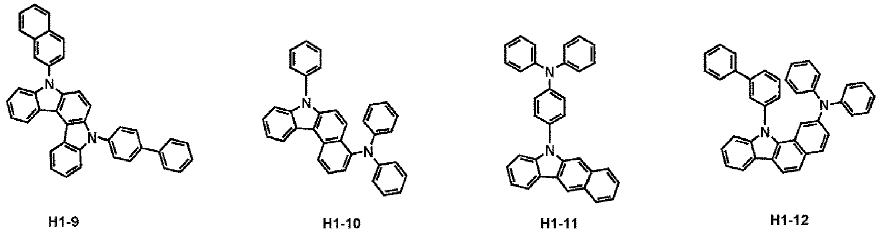 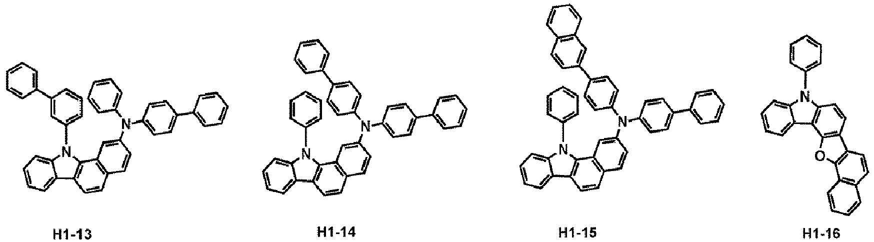 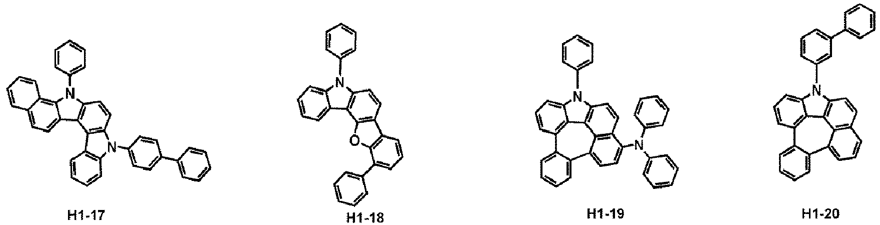 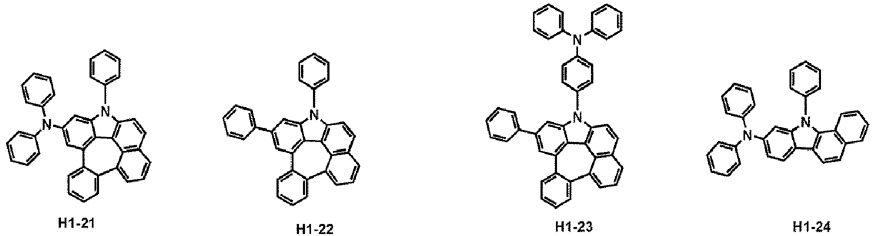 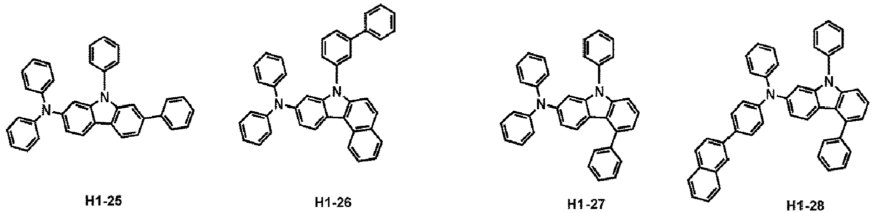 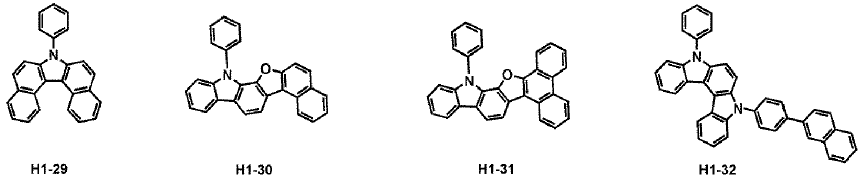 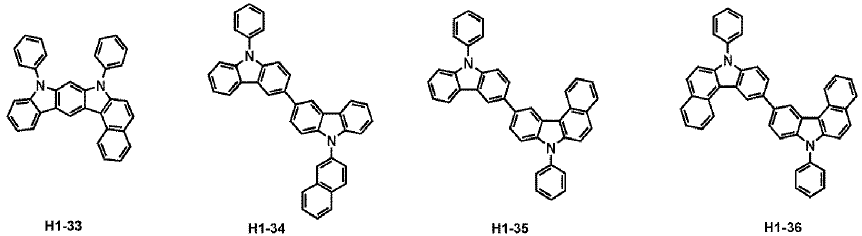 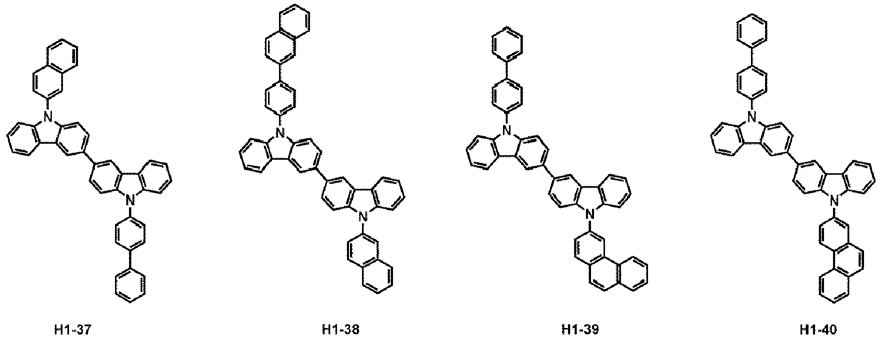 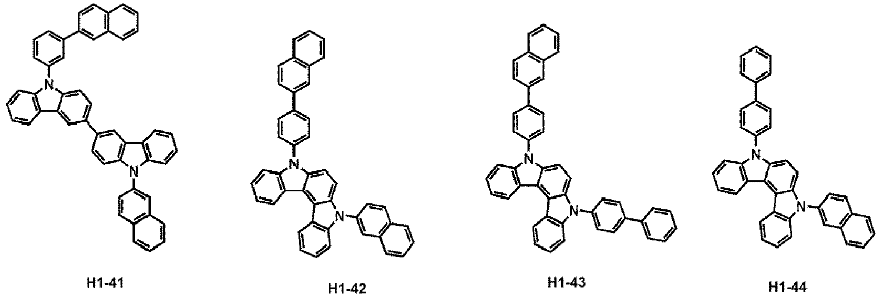 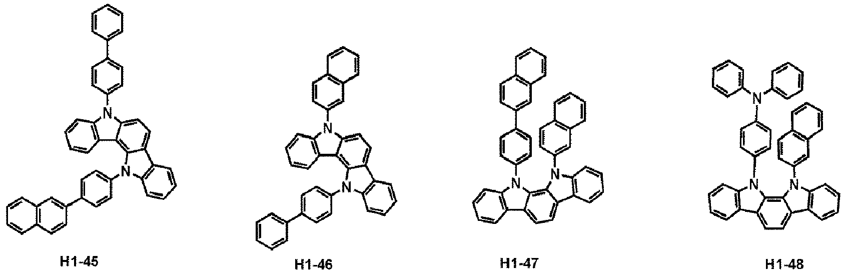 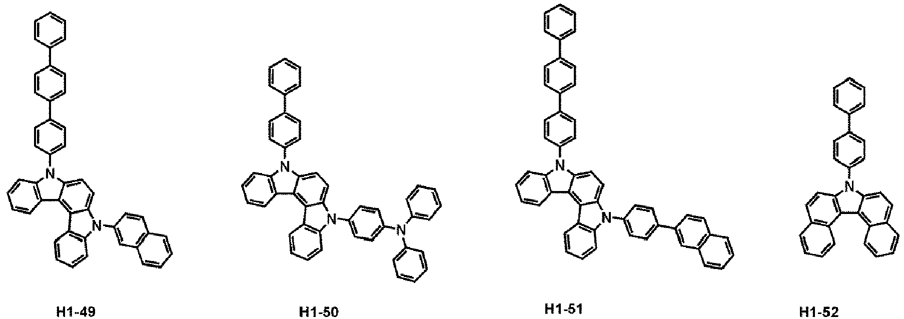 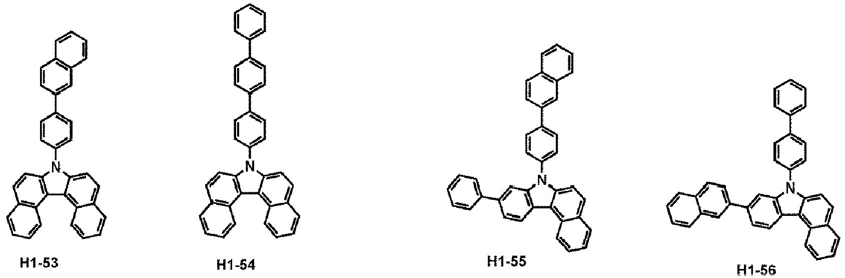 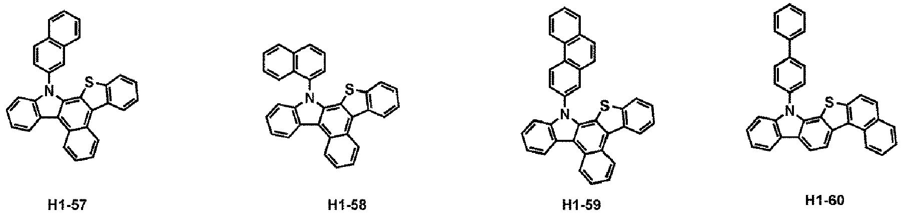 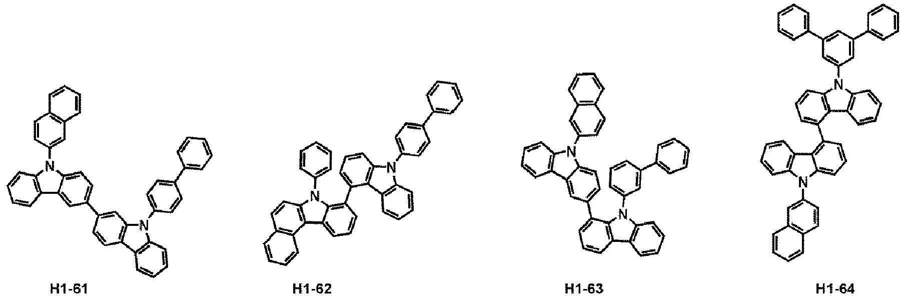 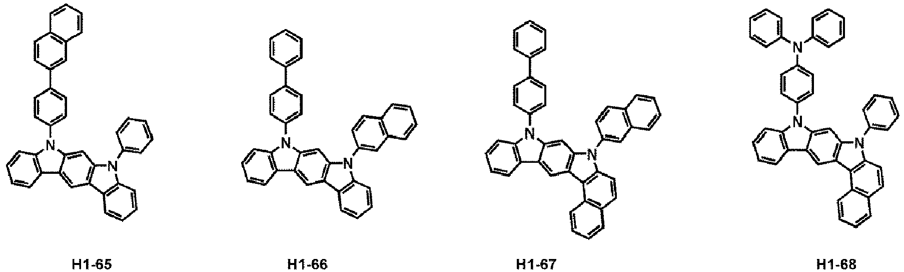 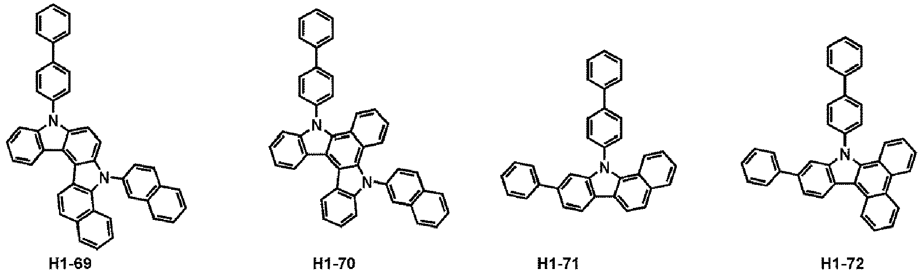
Group 5-2

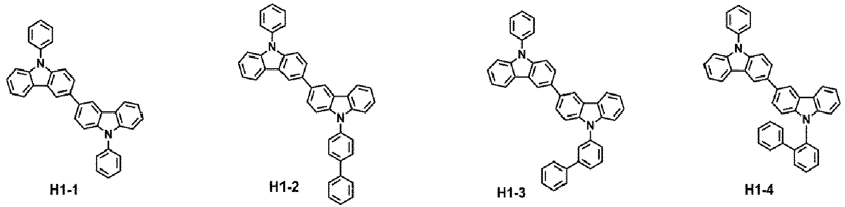

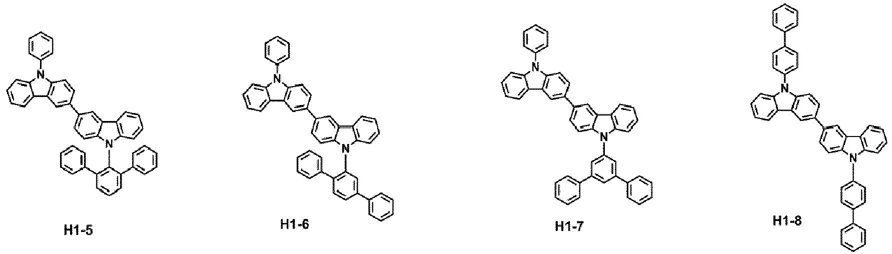

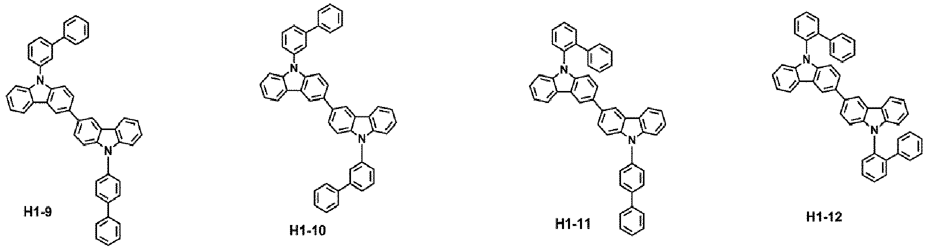

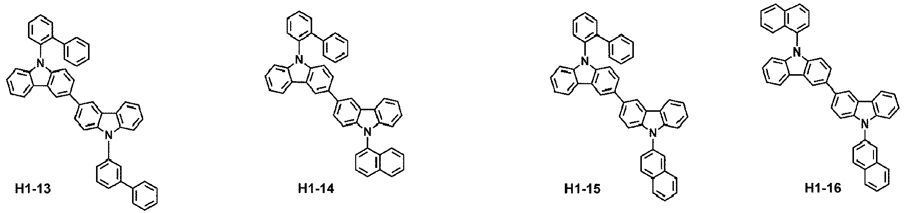

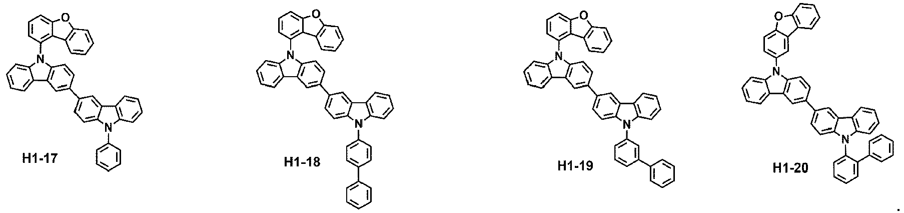

In an embodiment, the electron transport compound may be at least one of Compounds E1-1 to E1-62:

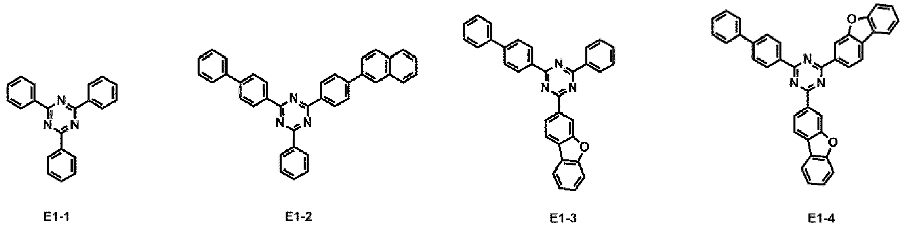

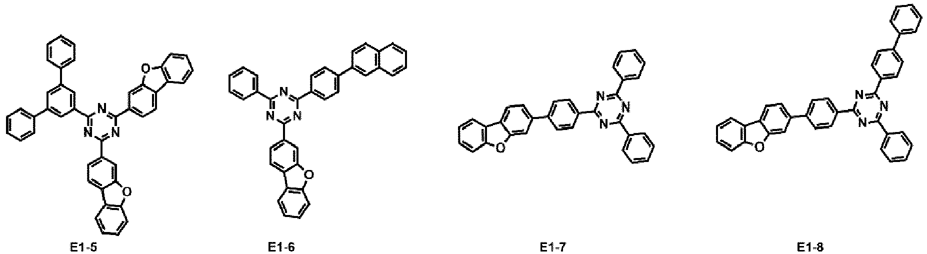

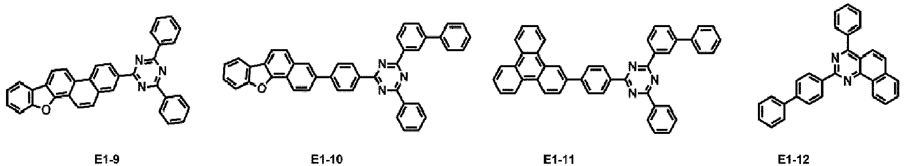

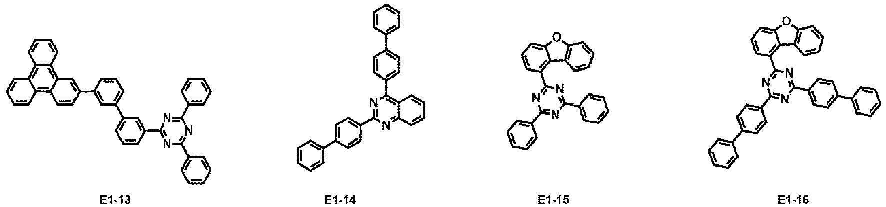

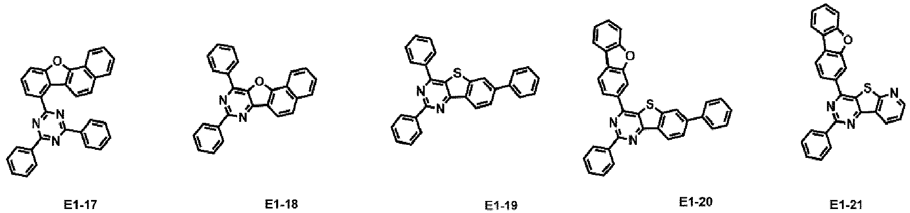

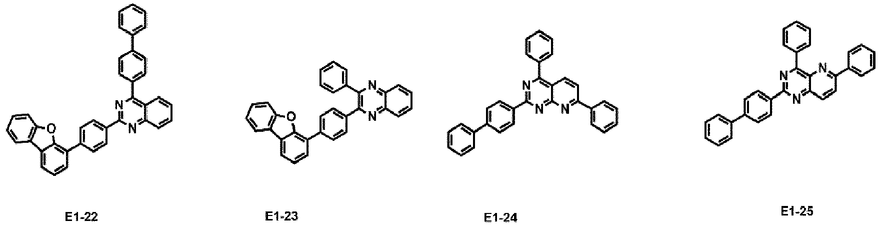

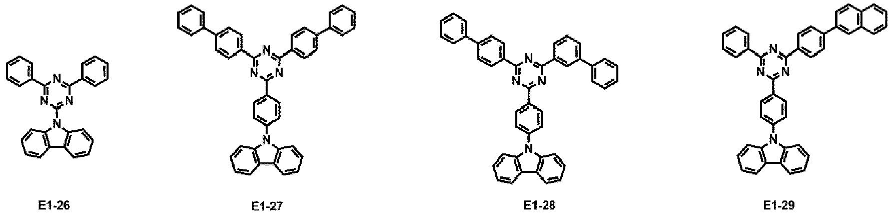

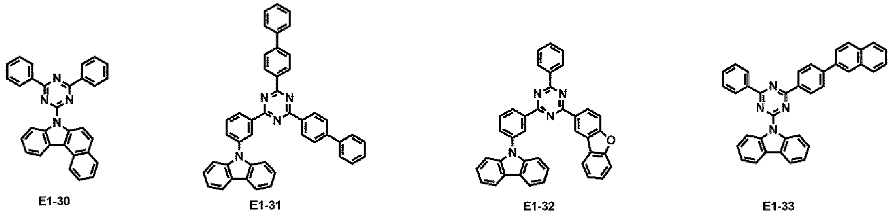

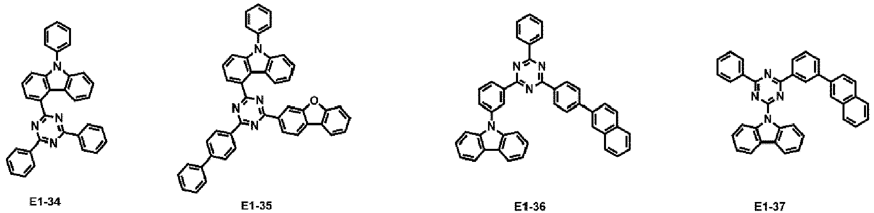

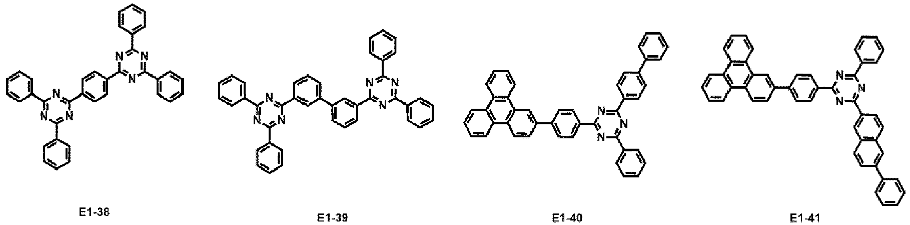

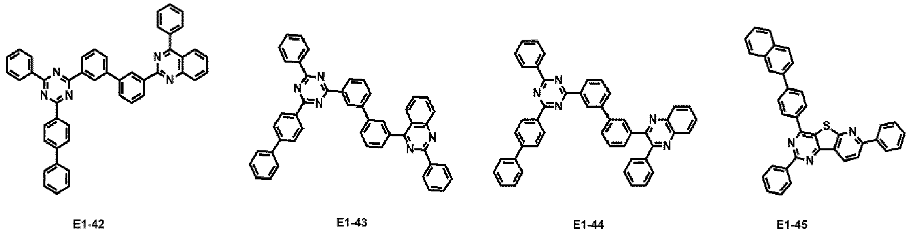

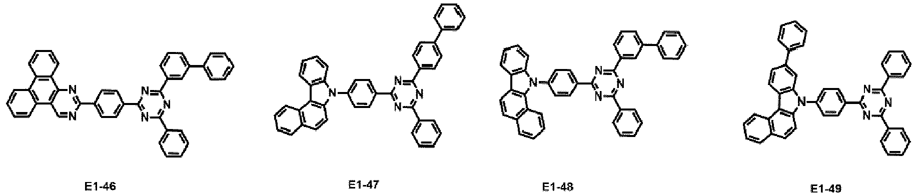

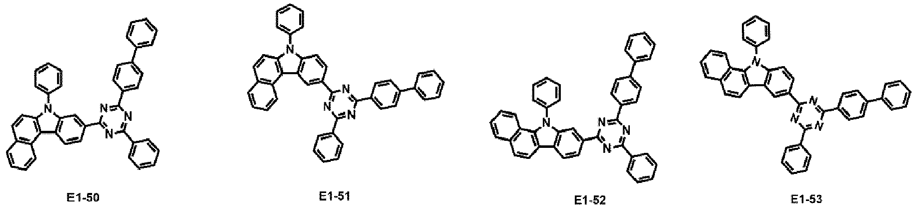

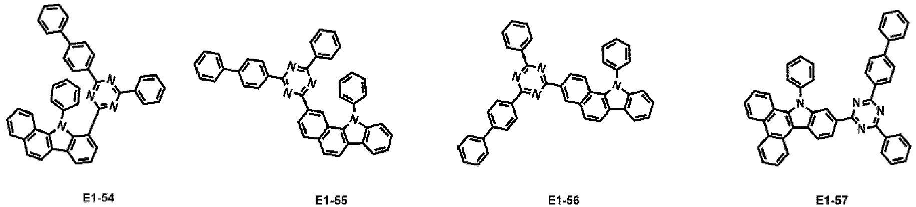

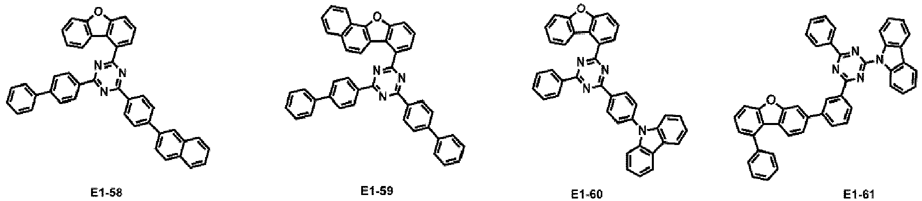

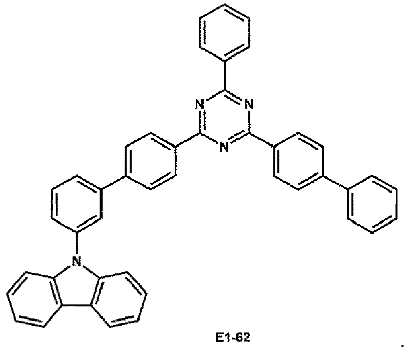

In one or more embodiments, the bipolar compound may be at least one of Compounds BP1-1 to BP1-17:

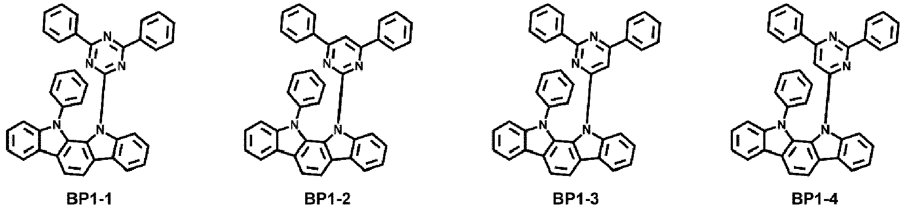

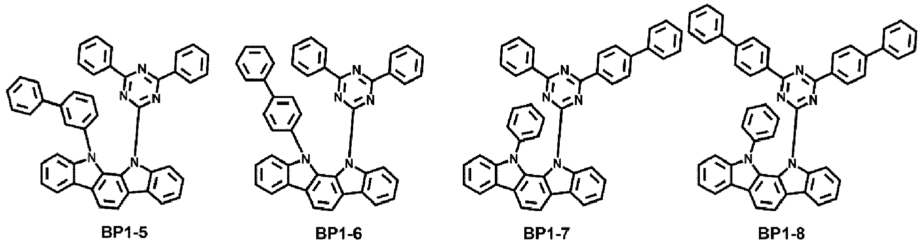

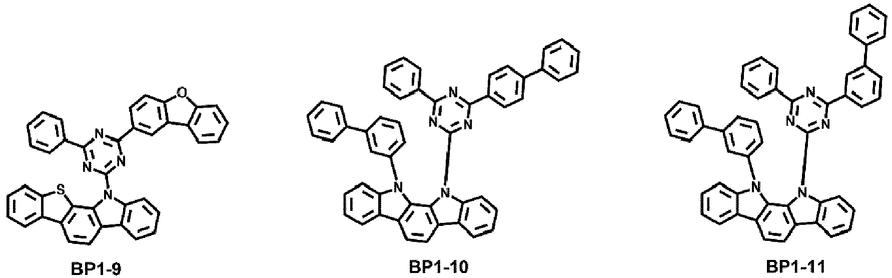

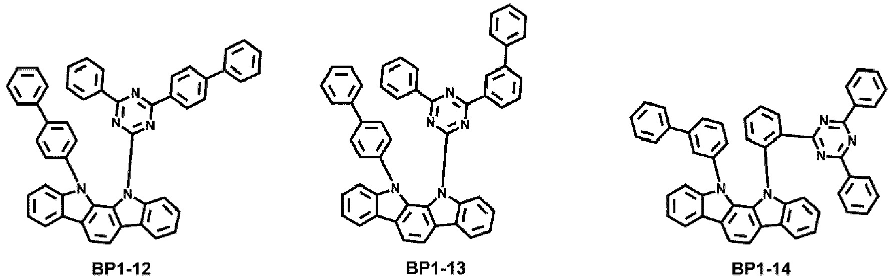

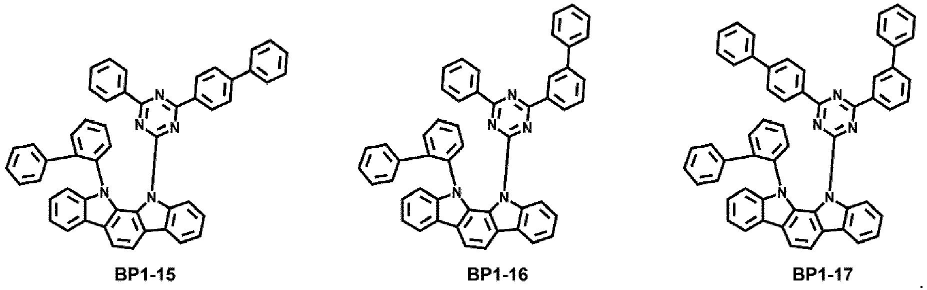

In an embodiment, the emission layer may not include compounds of Group A: Group A

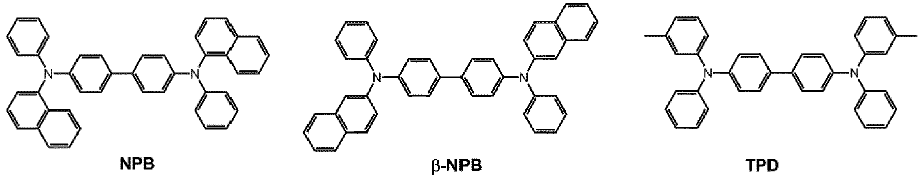

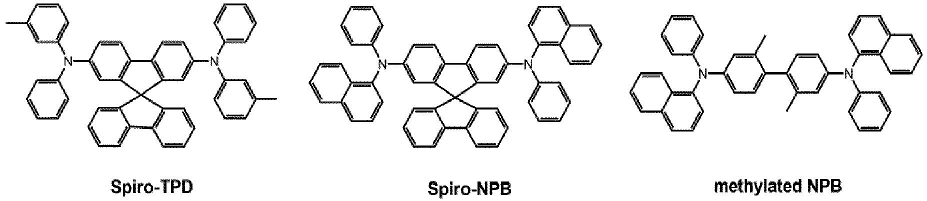

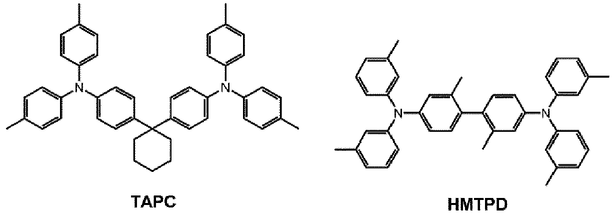

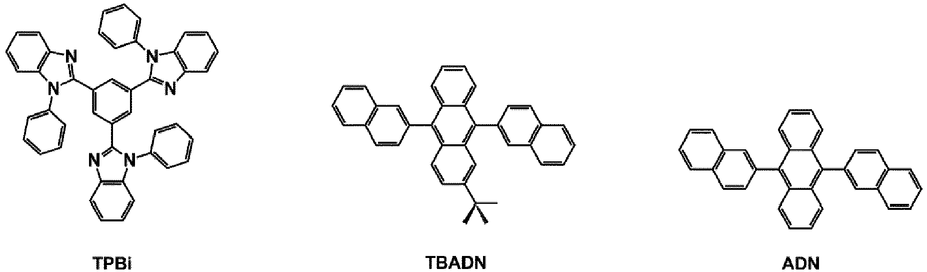

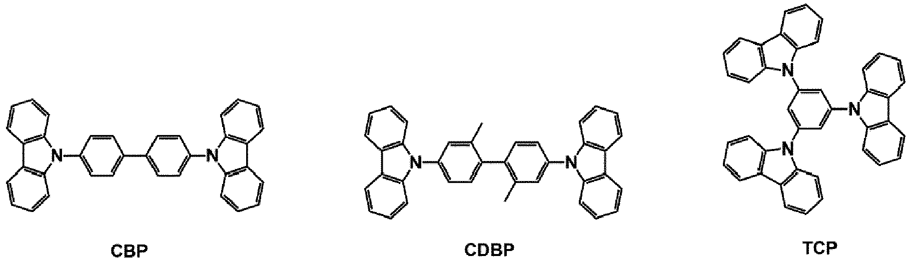

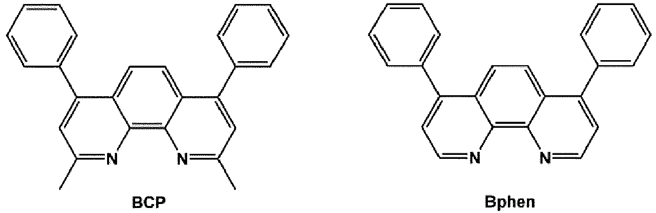

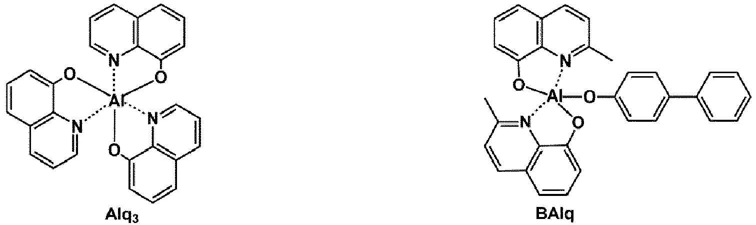

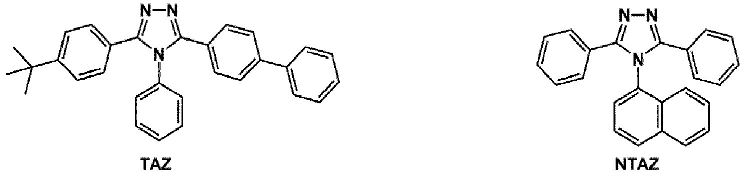

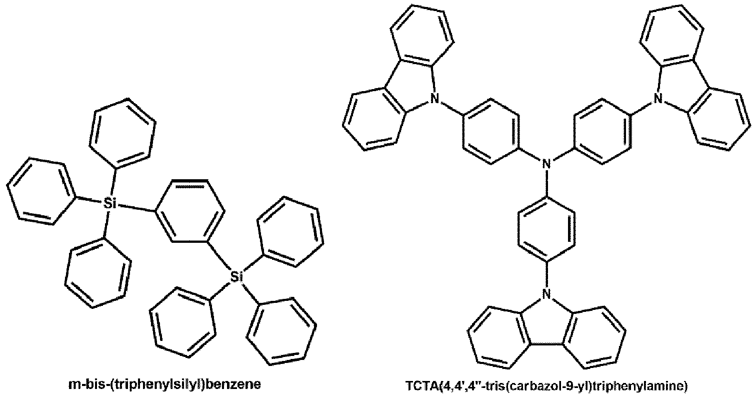

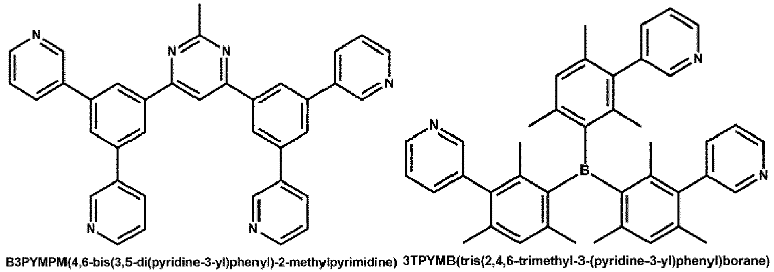

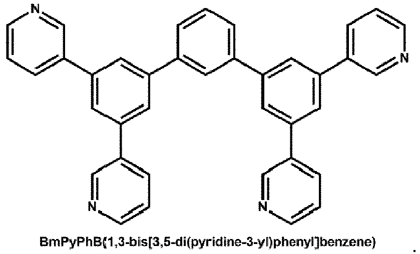

In an embodiment, the light-emitting device may further include a hole transport region between the first electrode and the emission layer and an electron transport region between the emission layer and the second electrode. The hole transport region may be the first region described in this disclosure.

The hole transport region may include a hole injection layer, a hole transport layer, an electron blocking layer, a buffer layer, or any combination thereof, and the electron transport region may include a hole blocking layer, an electron transport layer, an electron injection layer, or any combination thereof.

The term "organic layer" used herein refers to a single layer and/or a plurality of layers between the first electrode and the second electrode of the light-emitting device. The "organic layer" may include, in addition to an organic compound, an organometallic complex including metal.

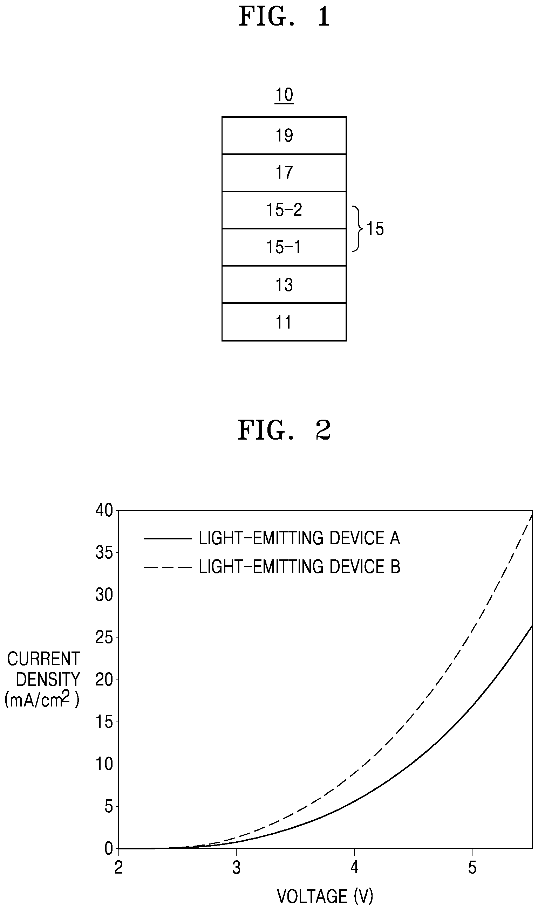

### Description of FIG. 1

FIG. 1 schematically illustrates a cross-sectional view of an organic light-emitting device 10, which is a light-emitting device according to an exemplary embodiment of the disclosure. Hereinafter, a structure and manufacturing method of an organic light-emitting device according to an embodiment of the disclosure will be described in connection with FIG. 1.

The organic light-emitting device 10 of FIG. 1 has a structure in which a first electrode 11, a hole transport region 13, an emission layer 15, an electron transport region 17, and a second electrode 19 are sequentially stacked. The emission layer 15 includes a first emission layer 15-1 and a second emission layer 15-2.

A substrate may be additionally located under the first electrode 11 or above the second electrode 19. For use as the substrate, any substrate that is used in organic light-emitting devices available in the art may be used, and the substrate may be a glass substrate or a transparent plastic substrate, each having excellent mechanical strength, thermal stability, transparency, surface smoothness, ease of handling, and water resistance.

The first electrode 11 may be formed by depositing or sputtering a material for forming the first electrode 11 on the substrate. The first electrode 11 may be an anode. The material for forming the first electrode 11 may include materials with a high work function to facilitate hole injection. The first electrode 11 may be a reflective electrode. The material for forming the first electrode 11 may be indium tin oxide (ITO), indium zinc oxide (IZO), tin oxide (SnO₂), or zinc oxide (ZnO). In an embodiment, the material for forming the first electrode 11 may be metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layered structure or a multi-layered structure including two or more layers. In an embodiment, the first electrode 11 may have a three-layered structure of ITO/Ag/ITO.

The hole transport region 13 may be located between the first electrode 11 and the emission layer 15.

The hole transport region 13 may include a hole injection layer, a hole transport layer, an electron blocking layer, a buffer layer, or a combination thereof.

The hole transport region 13 may include only a hole injection layer or only a hole transport layer. In one or more embodiments, the hole transport region 13 may have a hole injection layer/hole transport layer structure or a hole injection layer/hole transport layer/electron blocking layer structure, which are sequentially stacked in this stated order from the first electrode 11.

When the hole transport region 13 includes a hole injection layer, the hole injection layer may be formed on the first electrode 11 by using one or more suitable methods, for example, a vacuum deposition method, a spin coating method, a casting method, a Langmuir-Blodgett (LB) method, and/or an ink-jet printing method.

When a hole injection layer is formed by vacuum deposition, the deposition conditions may vary depending on a material that is used to form the hole injection layer, and the structure and thermal characteristics of the hole injection layer. For example, the deposition conditions may include a deposition temperature of about 100 °C to about 500 °C, a vacuum pressure of about 10⁻⁸ torr to about 10⁻³ torr, and a deposition rate of about 0.01 Å/sec to about 100 Å/sec.

When the hole injection layer is formed using spin coating, coating conditions may vary according to the material used to form the hole injection layer, and the structure and thermal properties of the hole injection layer. For example, a coating speed may be from about 2,000 rpm to about 5,000 rpm, and a temperature at which a heat treatment is performed to remove a solvent after coating may be from about 80 °C to about 200 °C.

The conditions for forming the hole transport layer and the electron blocking layer may be the same as the conditions for forming the hole injection layer.

The hole transport region 13 may include m-MTDATA, TDATA, 2-TNATA, NPB, β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201 below, a compound represented by Formula 202 below, or any combination thereof:

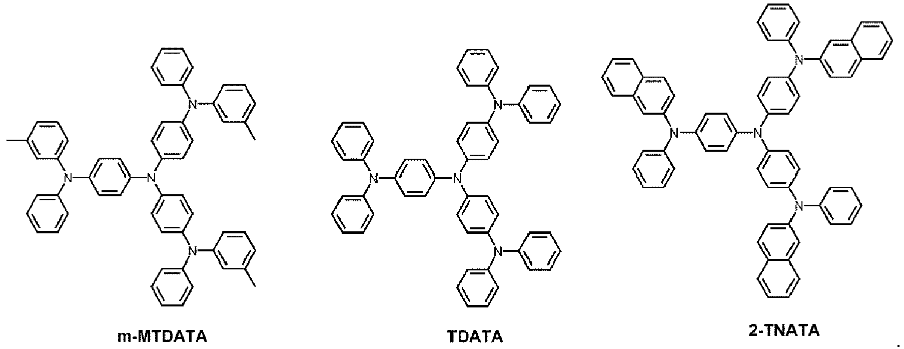

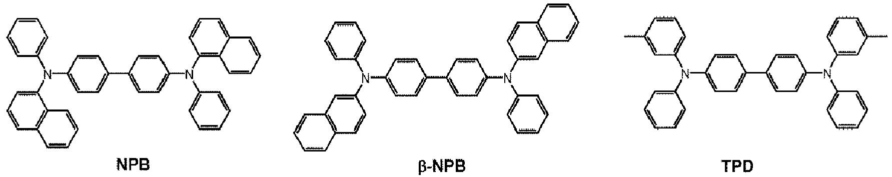

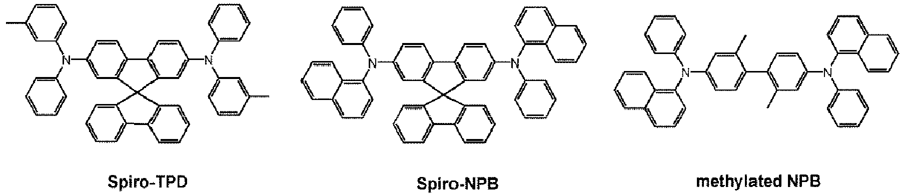

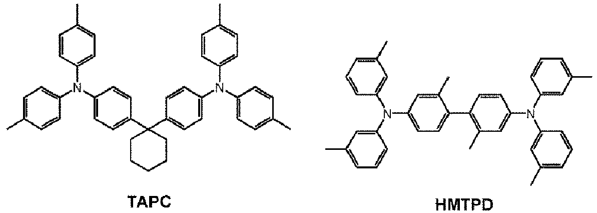

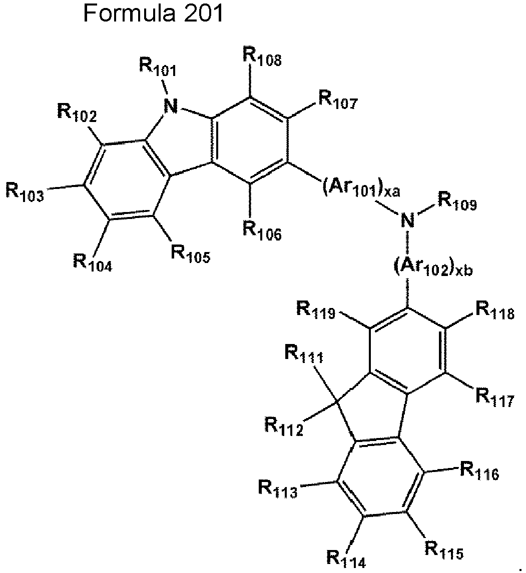

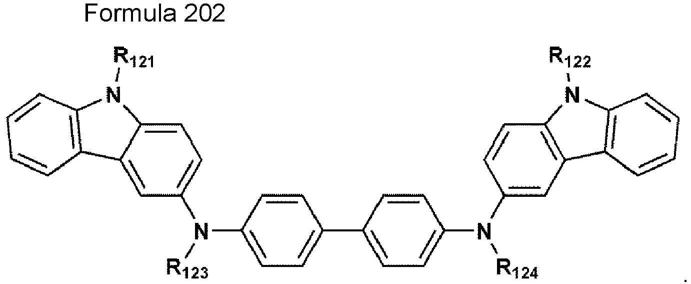

In Formula 201, Ar₁₀₁ and Ar₁₀₂ may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -CI, -Br, -I, a hydroxyl group, a cyano group, a nitro group, an amino group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, or any combination thereof.

xa and xb in Formula 201 may each independently be an integer from 0 to 5, or 0, 1, or 2. In an embodiment, xa may be 1 and xb may be 0.

R101 to R₁₀₈, R₁₁₁ to R₁₁₉, and R121 to R124 in Formulae 201 and 202 may each independently be:
hydrogen, deuterium, -F, -CI, -Br, -I, a hydroxyl group, a cyano group, a nitro group, an amino group, a C₁-C₁₀ alkyl group (for example, a methyl group, an ethyl group, a propyl group, a butyl group, a pentyl group, a hexyl group), or a C₁-C₁₀ alkoxy group(for example, a methoxy group, an ethoxy group, a propoxy group, a butoxy group, a pentoxy group);
a C₁-C₁₀ alkyl group or a C₁-C₁₀ alkoxy group, each unsubstituted or substituted with deuterium, -F, -CI, -Br, -I, a hydroxyl group, a cyano group, a nitro group, an amino group, or any combination thereof; or
a phenyl group, a naphthyl group, an anthracenyl group, a fluorenyl group, or a pyrenyl group, each unsubstituted or substituted with deuterium, - F, -CI, -Br, -I, a hydroxyl group, a cyano group, a nitro group, an amino group, a C₁-C₁₀ alkyl group, a C₁-C₁₀ alkoxy group, or any combination thereof.

In Formula 201, R₁₀₉ may be a phenyl group, a naphthyl group, an anthracenyl group, or a pyridinyl group, each unsubstituted or substituted with deuterium, -F, -CI, -Br, -I, a hydroxyl group, a cyano group, a nitro group, an amino group, a C₁-C₂₀ alkyl group, a C₁-C₂₀ alkoxy group, a phenyl group, a naphthyl group, an anthracenyl group, a pyridinyl group, or any combination thereof.

In an embodiment, the compound represented by Formula 201 may be represented by Formula 201A: 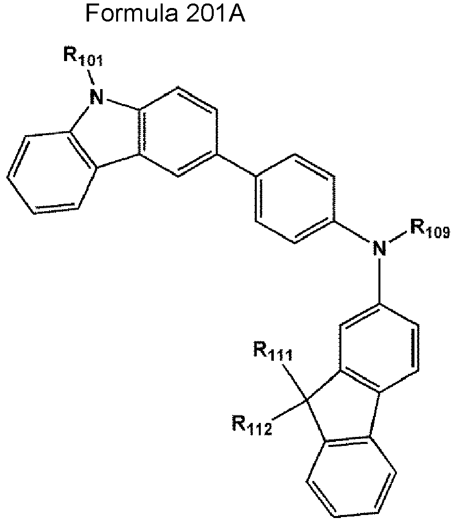 wherein R101, R111, R112, and R₁₀₉ in Formula 201A are each the same as described above.

In an embodiment, the hole transport region 13 may include one of Compounds HT1 to HT20 or any combination thereof:

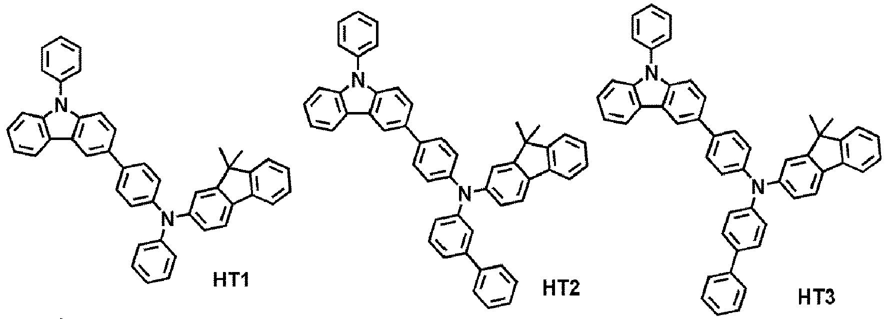

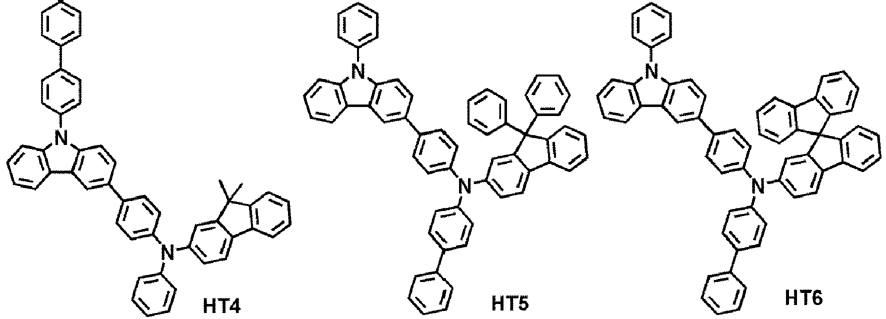

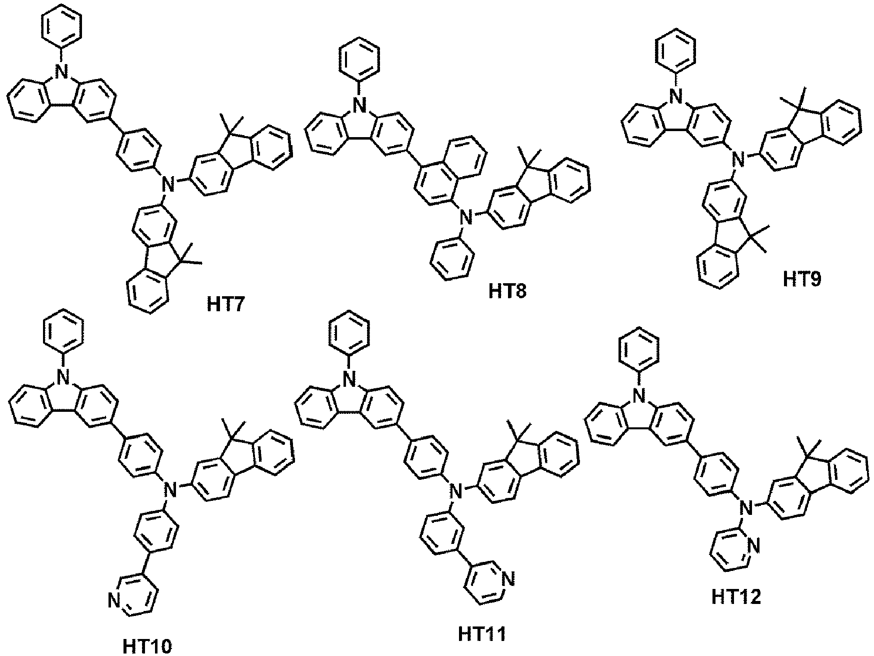

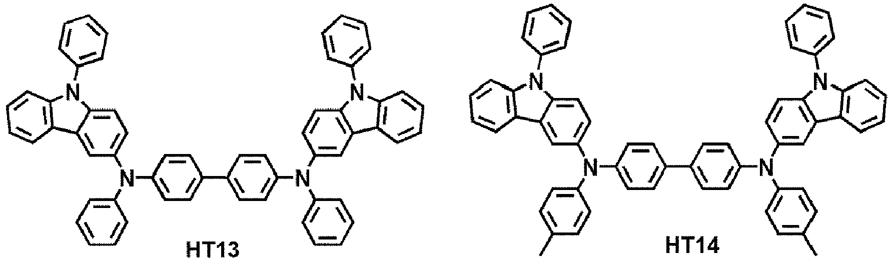

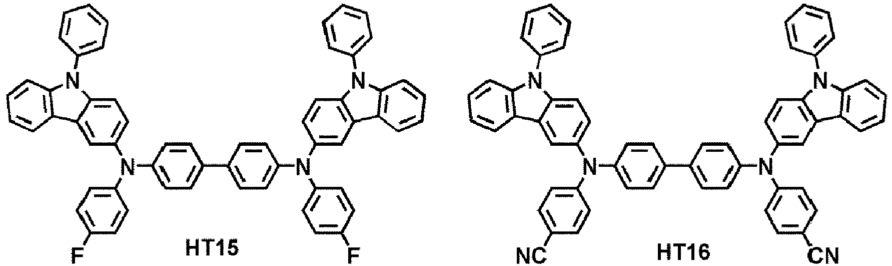

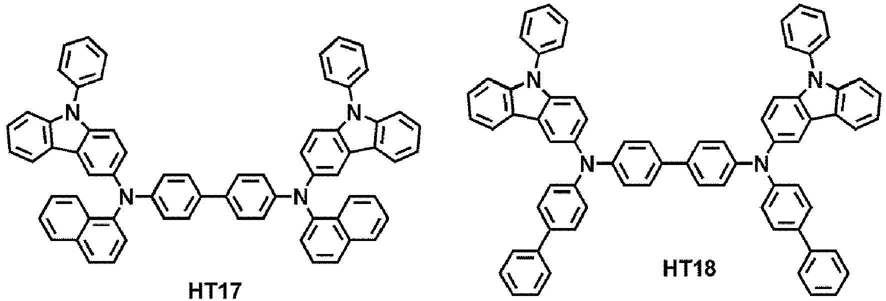

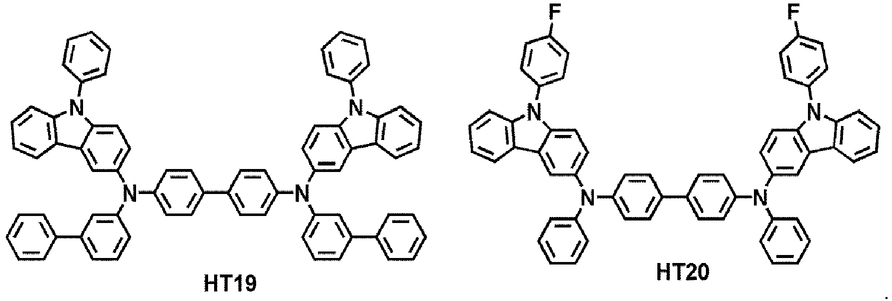

A thickness of the hole transport region 13 may be from about 100 Å to about 10,000 Å, for example, from about 100 Å to about 1,000 Å. When the hole transport region 13 includes a hole injection layer, a hole transport layer, an electron blocking layer, or a combination thereof, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region 13, the hole injection layer, and the hole transport layer are within these ranges, satisfactory hole transporting characteristics may be obtained without a substantial increase in driving voltage.

In addition to the above-described materials, the hole transport region 13 may further include a charge-generation material to improve conductivity. The charge-generation material may be homogeneously or non-homogeneously dispersed in the hole transport region.

The charge-generation material may be, for example, a p-dopant. The p-dopant may be a quinone derivative, a metal oxide, a cyano group-containing compound, or any combination thereof. In an embodiment, the p-dopant may be: a quinone derivative such as tetracyanoquinonedimethane (TCNQ), 2,3,5,6-tetrafluoro-tetracyano-1,4-benzoquinonedimethane (F4-TCNQ), or F6-TCNNQ; metal oxide, such as tungsten oxide and molybdenum oxide; a cyano group-containing compound, such as Compound HT-D1; or any combination thereof:

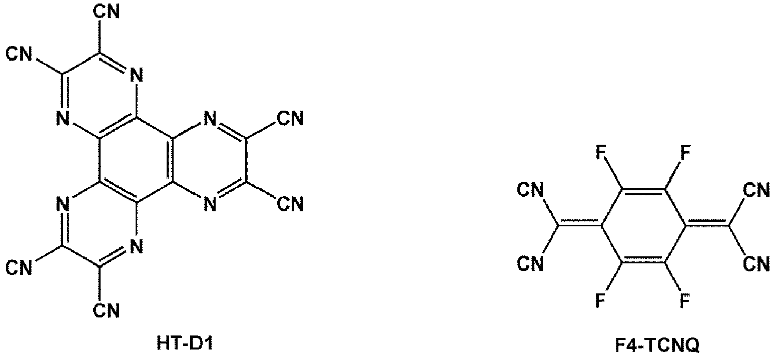

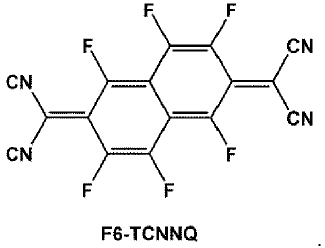

The hole transport region 13 may further include a buffer layer.

Also, the buffer layer may compensate for an optical resonance distance according to a wavelength of light emitted from the emission layer, and thus, luminescence efficiency of a light-emitting device may be improved.

Meanwhile, when the hole transport region 13 includes an electron blocking layer, the material for the electron blocking layer may include a material, a host material, or a combination thereof that can be used in the hole transport region 13 as described above. In an embodiment, when the hole transport region includes an electron blocking layer, mCP, Compound H1-8 of Group 5-2, or the like may be used as a material for the electron blocking layer.

The emission layer 15 may be formed on the hole transport region 13 by using, for example, a vacuum deposition method, a spin coating method, a cast method, an LB method, and/or an ink-jet printing method. When the emission layer 15 is formed by a vacuum deposition method or a spin coating method, the deposition or coating conditions may be similar to those applied in forming the hole injection layer although the deposition or coating conditions may vary depending on a material that is used to form the emission layer.

The emission layer 15 may include a first emission layer 15-1 and a second emission layer 15-2 as described herein.

In an embodiment, the first emission layer 15-1 may include a first dopant and a first host, the second emission layer 15-2 may include a second dopant and a second host, the first dopant may include the first compound, and the second dopant may include the second compound. The first dopant, the first host, the second dopant, the second host, the first compound, and the second compound are each the same as described in the present specification.

An amount (weight) of the first dopant in the first emission layer 15-1 may be from about 0.01 parts by weight to about 20 parts by weight based on 100 parts by weight, based on the total weight of the first host.

An amount (weight) of the second dopant in the second emission layer 15-2 may be from about 0.01 parts by weight to about 20 parts by weight based on 100 parts by weight, based on the total weight of the second host.

A thickness of the emission layer 15 may be in a range of about 100 Å to about 1,000 Å, for example, about 200 Å to about 600 Å. When the thickness of the emission layer 15 is within these ranges, excellent light-emission characteristics may be obtained without a substantial increase in driving voltage.

A thickness ratio of the first emission layer 15-1 to the second emission layer 15-2 may be 8 : 2 to 2 : 8, 7 : 3 to 3 : 7, or 6 : 4 to 4 : 6.

When the light-emitting device is a full-color light-emitting device, the emission layer 15 may be patterned into a red emission layer, a green emission layer, and/or a blue emission layer.

Next, the electron transport region 17 may be located on the emission layer 15.

The electron transport region 17 may include a hole blocking layer, an electron transport layer, an electron injection layer, or a combination thereof.

In an embodiment, the electron transport region 17 may have a hole blocking layer/electron transport layer/electron injection layer structure or an electron transport layer/electron injection layer structure. The electron transport layer may have a single-layered structure or a multi-layered structure including two or more different materials.

The conditions for the formation of the hole blocking layer, the electron transport layer, and the electron injection layer in the electron transport region 17 are the same as the conditions for the formation of the hole injection layer.

When the electron transport region 17 includes a hole blocking layer, the hole blocking layer may include, for example, BCP, Bphen, BAIq, or any combination thereof:

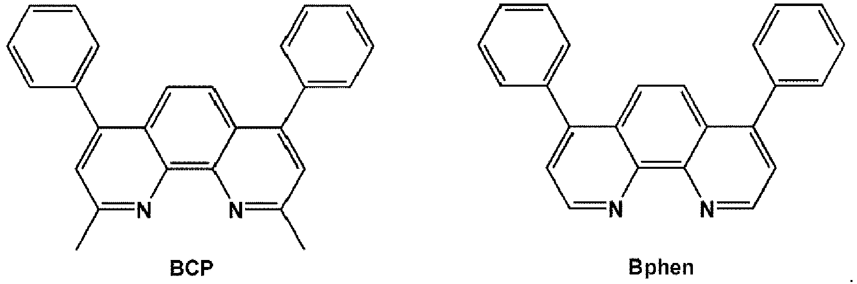

In an embodiment, the hole blocking layer may include any host material, and a material for an electron transport layer, a material for an electron injection layer, or a combination thereof, which will be described later.

A thickness of the hole blocking layer may be in a range of about 20 Å to about 1,000 Å, for example, about 30 Å to about 600 Å. When the thickness of the hole blocking layer is within these ranges, excellent hole blocking characteristics may be obtained without a substantial increase in driving voltage.

The electron transport layer may include BCP, Bphen, TPBi, Alq₃, BAIq, TAZ, NTAZ, or any combination thereof:

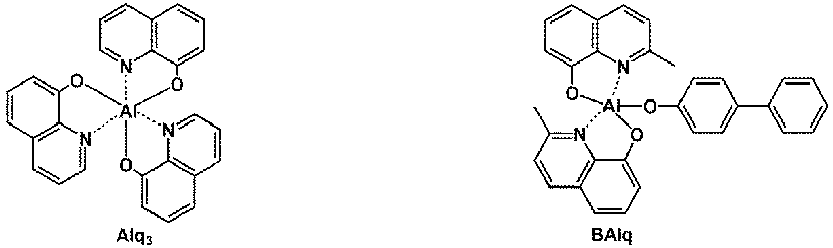

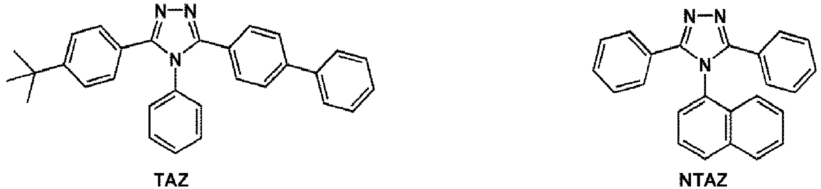

In an embodiment, the electron transport layer may include one of Compounds ET1 to ET25 or any combination thereof:

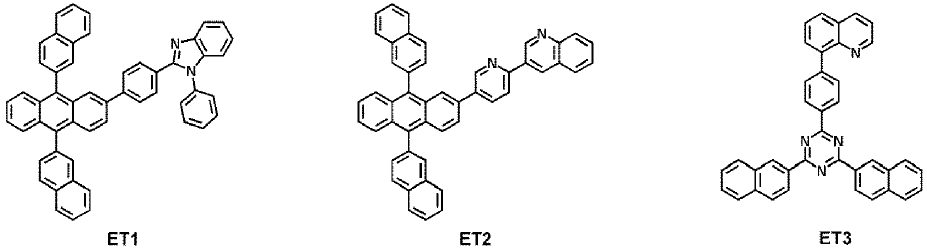

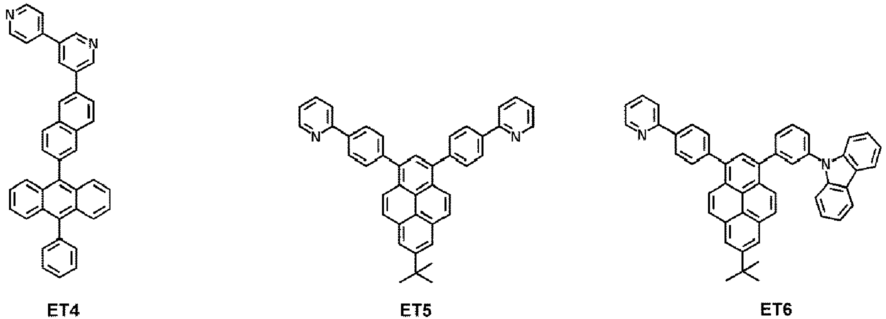

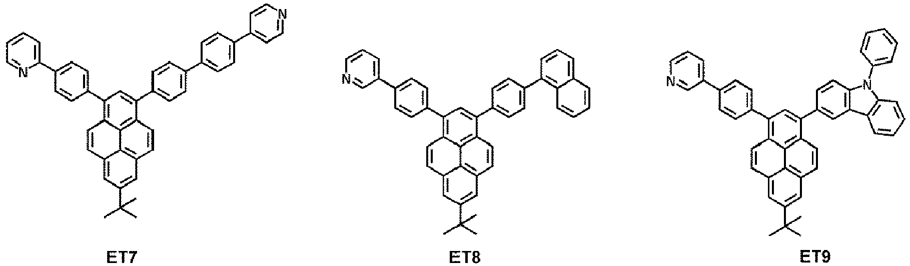

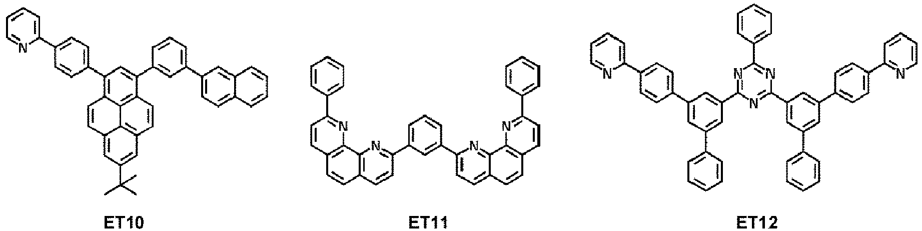

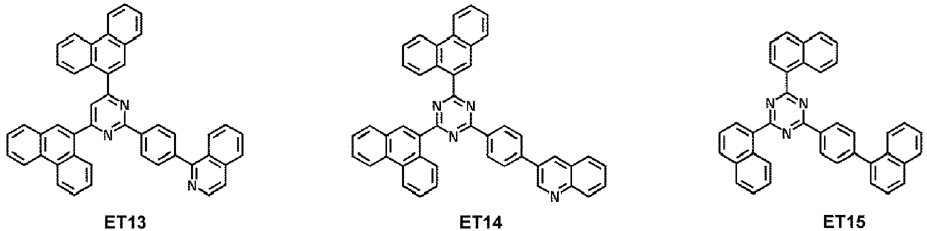

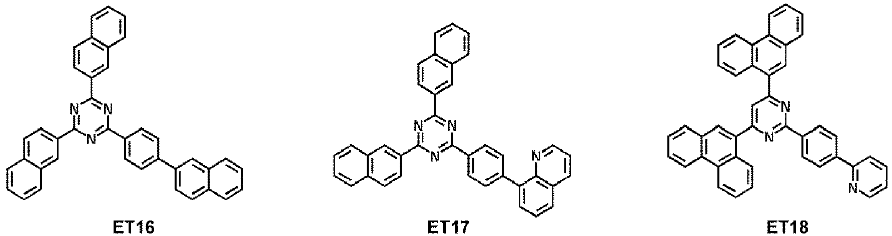

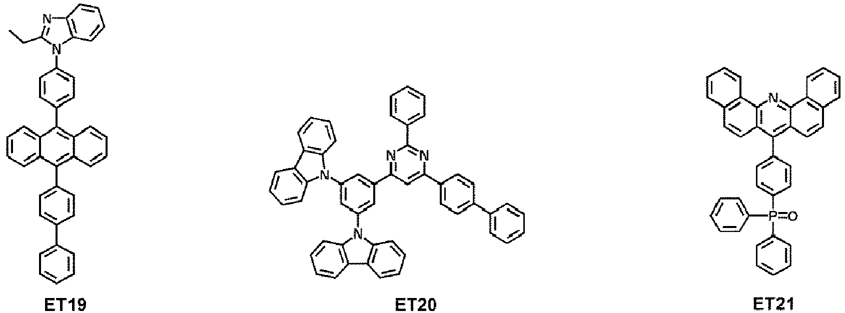

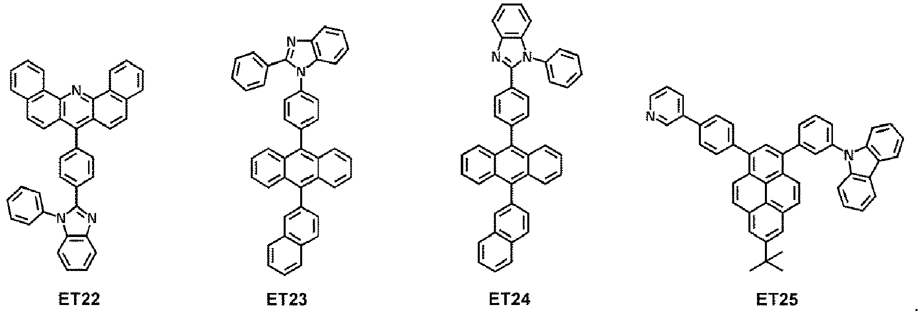

A thickness of the electron transport layer may be in the range of about 100 Å to about 1,000 Å, for example, about 150 Å to about 500 Å. When the thickness of the electron transport layer is within the range described above, the electron transport layer may have satisfactory electron transporting characteristics without a substantial increase in driving voltage.

The electron transport layer may include a metal-containing material in addition to the material as described above.

The metal-containing material may include a Li complex. The Li complex may include, for example, Compound ET-D1 or ET-D2:

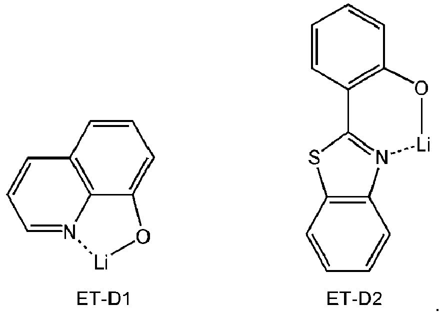

In an embodiment, the electron transport region 17 may include an electron injection layer that facilitates injection of electrons from the second electrode 19.

The electron injection layer may include LiF, NaCl, CsF, Li₂O, BaO, Yb, Compound ET-D1, Compound ET-D2, or any combination thereof.

A thickness of the electron injection layer may be in a range of about 1 Å to about 100 Å, and, for example, about 3 Å to about 90 Å. When the thickness of the electron injection layer is within the range described above, satisfactory electron injection characteristics may be obtained without a substantial increase in driving voltage.

The second electrode 19 may be provided on the electron transport region 17. The second electrode 19 may be a cathode. A material for forming the second electrode 19 may be metal, an alloy, an electrically conductive compound, or a combination thereof, which have a relatively low work function. For example, lithium (Li), magnesium (Mg), aluminum (Al), silver (Ag), aluminum-lithium (Al-Li), calcium (Ca), magnesium-indium (Mg-In), magnesium-silver (Mg-Ag), or the like may be used as the material for forming the second electrode 19. In an embodiment, to manufacture a top-emission type light-emitting device, a transparent or semi-transparent electrode formed using ITO or IZO may be used as the second electrode 19.

Hereinbefore, the light-emitting device has been described in connection with FIG. 1, but embodiments of the disclosure are not limited thereto.

According to another aspect, the light-emitting device may be included in an electronic apparatus. Thus, an electronic apparatus including the light-emitting device is provided. The electronic apparatus may include, for example, a display, an illumination, a sensor, and the like.

The term "C₁-C₆₀ alkyl group" as used herein refers to a linear or branched saturated aliphatic hydrocarbons monovalent group having 1 to 60 carbon atoms, and the term "C₁-C₆₀ alkylene group" as used here refers to a divalent group having the same structure as the C₁-C₆₀ alkyl group.

Examples of the C₁-C₆₀ alkyl group, the C₁-C₂₀ alkyl group, and/or the C₁-C₁₀ alkyl group may include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or any combination thereof. For example, Formula 9-33 is a branched C₆ alkyl group, for example, a tert-butyl group that is substituted with two methyl groups.

The term "C₁-C₆₀ alkoxy group" used herein refers to a monovalent group represented by -OA₁₀₁ (wherein A₁₀₁ is the C₁-C₆₀ alkyl group), and examples thereof may include a methoxy group, an ethoxy group, a propoxy group, a butoxy group, a pentoxy group, or the like.

The term "C₁-C₆₀ alkylthio group" as used herein refers to a monovalent group having the formula of -SA₁₀₁ (where A₁₀₁ is the C₁-C₆₀ alkyl group).

The term "C₂-C₆₀ alkenyl group" as used herein refers to a hydrocarbon group formed by substituting at least one carbon-carbon double bond in the middle or at the terminus of the C₂-C₆₀ alkyl group, and examples thereof include an ethenyl group, a propenyl group, a butenyl group, or the like. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and examples thereof include an ethynyl group, a propynyl group, or the like. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms, and the C₃-C₁₀ cycloalkylene group is a divalent group having the same structure as the C₃-C₁₀ cycloalkyl group.

Examples of the C₃-C₁₀ cycloalkyl group may include a cyclopropyl group, a cyclobutyl group, a cyclopentyl, cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, a bicyclo[2.2.2]octyl group, or the like.

The term "C₁-C₁₀ heterocycloalkyl group" as used herein refers to a monovalent saturated cyclic group that includes at least one hetero atom selected from N, O, P, Si, S, Se, Ge, and B as a ring-forming atom and 1 to 10 carbon atoms, and the term "C₁-C₁₀ heterocycloalkylene group" as used herein refers to a divalent group having the same structure as the C₁-C₁₀ heterocycloalkyl group.

Examples of the C₁-C₁₀ heterocycloalkyl group may include a silolanyl group, a silinanyl group, a tetrahydrofuranyl group, a tetrahydro-2H-pyranyl group, a tetrahydrothiophenyl group, or the like.

The term "C₃-C₁₀ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, a cycloheptenyl group, or the like. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one hetero atom selected from N, O, P, Si, S, Se, Ge, and B as a ring-forming atom, 1 to 10 carbon atoms, and at least one double bond in its ring. Examples of the C₁-C₁₀ heterocycloalkenyl group include a 2,3-dihydrofuranyl group, a 2,3-dihydrothiophenyl group, or the like. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Examples of the C₆-C₆₀ aryl group include a phenyl group, a naphthyl group, an anthracenyl group, a phenanthrenyl group, a pyrenyl group, a chrysenyl group, or the like. When the C₆-C₆₀ aryl group and the C₆-C₆₀ arylene group each include two or more rings, the rings may be fused to each other.

The C₇-C₆₀ alkylaryl group used herein refers to a C₆-C₆₀ aryl group substituted with at least one C₁-C₆₀ alkyl group.

The term "C₁-C₆₀ heteroaryl group" as used herein refers to a monovalent group that includes at least one hetero atom selected from N, O, P, Si, S, Se, Ge, and B as a ring-forming atom and a cyclic aromatic system having 1 to 60 carbon atoms, and the term "C₁-C₆₀ heteroarylene group" as used herein refers to a divalent group that includes at least one hetero atom selected from N, O, P, Si, S, Se, Ge, and B as a ring-forming atom and a cyclic aromatic system having 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₆-C₆₀ heteroaryl group and the C₆-C₆₀ heteroarylene group each include two or more rings, the two or more rings may be fused to each other.

The C₂-C₆₀ alkylheteroaryl group used herein refers to a C₁-C₆₀ heteroaryl group substituted with at least one C₁-C₆₀ alkyl group.

The term "C₆-C₆₀ aryloxy group" as used herein indicates -OA₁₀₂ (wherein A₁₀₂ indicates the C₆-C₆₀ aryl group), the C₆-C₆₀ arylthio group indicates -SA₁₀₃ (wherein A₁₀₃ indicates the C₆-C₆₀ aryl group), and the C₁-C₆₀ alkylthio group indicates -SA₁₀₄ (wherein A₁₀₄ indicates the C₁-C₆₀ alkyl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as a monovalent non-aromatic condensed polycyclic group.

The term "monovalent non-aromatic condensed heteropolycyclic group" as used herein refers to a monovalent group (for example, having 1 to 60 carbon atoms) having two or more rings condensed to each other, including at least one hetero atom selected from N, O, P, Si, S, Se, Ge, and B, other than carbon atoms, as a ring-forming atom, and having no aromaticity in its entire molecular structure. Examples of the monovalent non-aromatic condensed heteropolycyclic group include a carbazolyl group or the like. The term "divalent non-aromatic condensed heteropolycyclic group" as used herein refers to a divalent group having the same structure as a monovalent non-aromatic condensed heteropolycyclic group.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group. Examples of the "C₅-C₃₀ carbocyclic group (unsubstituted or substituted with at least one R₁₀ₐ)" used herein may include an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, and a fluorene group (each unsubstituted or substituted with at least one R₁₀ₐ).

The term "C₁-C₃₀ heterocyclic group" as used herein refers to a saturated or unsaturated cyclic group having, as a ring-forming atom, at least one heteroatom selected from N, O, P, Si, S, Se, Ge, and B other than 1 to 30 carbon atoms. The C₁-C₃₀ heterocyclic group may be a monocyclic group or a polycyclic group. The "C₁-C₃₀ heterocyclic group (unsubstituted or substituted with at least one R₁₀ₐ)" may be, for example, a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group (each unsubstituted or substituted with at least one R₁₀ₐ).

As used herein, the number of carbons in each group that is substituted (e.g., C₁-C₆₀) excludes the number of carbons in the substituent. For example, a C₁-C₆₀ alkyl group can be substituted with a C₁-C₆₀ alkyl group. The total number of carbons included in the C₁-C₆₀ alkyl group substituted with the C₁-C₆₀ alkyl group is not limited to 60 carbons. In addition, more than one C₁-C₆₀ alkyl substituent may be present on the C₁-C₆₀ alkyl group. This definition is not limited to the C₁-C₆₀ alkyl group and applies to all substituted groups that recite a carbon range.

In an embodiment, examples of the "C₅-C₃₀ carbocyclic group" and "C₁-C₃₀ heterocyclic group" as used herein include i) a first ring, ii) a second ring, iii) a condensed ring in which two or more first rings are condensed with each other, iv) a condensed ring in which two or more second rings are condensed with each other, or v) a condensed ring in which at least one first ring and at least one second ring are condensed with each other,
the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

The terms "fluorinated C₁-C₆₀ alkyl group (or a fluorinated C₁-C₂₀ alkyl group or the like)", "fluorinated C₃-C₁₀ cycloalkyl group", "fluorinated C₁-C₁₀ heterocycloalkyl group," and "fluorinated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one fluoro group (-F). For example, the term "fluorinated C₁ alkyl group (that is, a fluorinated methyl group)" includes -CF₃, -CF₂H, and -CFH₂. The "fluorinated C₁-C₆₀ alkyl group (or, a fluorinated C₁-C₂₀ alkyl group, or the like)", "the fluorinated C₃-C₁₀ cycloalkyl group", "the fluorinated C₁-C₁₀ heterocycloalkyl group", or "the fluorinated phenyl group" may be i) a fully fluorinated C₁-C₆₀ alkyl group (or, a fully fluorinated C₁-C₂₀ alkyl group, or the like), a fully fluorinated C₃-C₁₀ cycloalkyl group, a fully fluorinated C₁-C₁₀ heterocycloalkyl group, or a fully fluorinated phenyl group, wherein, in each group, all hydrogen included therein is substituted with a fluoro group, or ii) a partially fluorinated C₁-C₆₀ alkyl group (or, a partially fluorinated C₁-C₂₀ alkyl group, or the like), a partially fluorinated C₃-C₁₀ cycloalkyl group, a partially fluorinated C₁-C₁₀ heterocycloalkyl group, or partially fluorinated phenyl group, wherein, in each group, all hydrogen included therein is not substituted with a fluoro group.

The terms "deuterated C₁-C₆₀ alkyl group (or a deuterated C₁-C₂₀ alkyl group or the like)", "deuterated C₃-C₁₀ cycloalkyl group", "deuterated C₁-C₁₀ heterocycloalkyl group," and "deuterated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one deuterium. For example, the "deuterated C₁ alkyl group (that is, the deuterated methyl group)" may include - CD₃, -CD₂H, and -CDH₂, and examples of the "deuterated C₃-C₁₀ cycloalkyl group" are, for example, Formula 10-501 and the like. The "deuterated C₁-C₆₀ alkyl group (or, the deuterated C₁-C₂₀ alkyl group or the like)", "the deuterated C₃-C₁₀ cycloalkyl group", "the deuterated C₁-C₁₀ heterocycloalkyl group", or "the deuterated phenyl group" may be i) a fully deuterated C₁-C₆₀ alkyl group (or, a fully deuterated C₁-C₂₀ alkyl group or the like), a fully deuterated C₃-C₁₀ cycloalkyl group, a fully deuterated C₁-C₁₀ heterocycloalkyl group, or a fully deuterated phenyl group, in which, in each group, all hydrogen included therein are substituted with deuterium, or ii) a partially deuterated C₁-C₆₀ alkyl group (or, a partially deuterated C₁-C₂₀ alkyl group or the like), a partially deuterated C₃-C₁₀ cycloalkyl group, a partially deuterated C₁-C₁₀ heterocycloalkyl group, or a partially deuterated phenyl group, in which, in each group, all hydrogen included therein are not substituted with deuterium.

The term "(C₁-C₂₀ alkyl) 'X' group" as used herein refers to a 'X' group that is substituted with at least one C₁-C₂₀ alkyl group. For example, the term "(C₁-C₂₀ alkyl)C₃-C₁₀ cycloalkyl group" as used herein refers to a C₃-C₁₀ cycloalkyl group substituted with at least one C₁-C₂₀ alkyl group, and the term "(C₁-C₂₀ alkyl)phenyl group" as used herein refers to a phenyl group substituted with at least one C₁-C₂₀ alkyl group. An example of a (C₁ alkyl) phenyl group is a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group," in which, in each group, at least one carbon selected from ring-forming carbons is substituted with nitrogen.

The substituent of the substituted C₅-C₃₀ carbocyclic group, the substituted C₂-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted monovalent non-aromatic condensed polycyclic group, and the substituted monovalent non-aromatic condensed heteropolycyclic group may be:
deuterium, -F, -CI, -Br, -I, -CD₃, -CD₂H, -CDH₂, -CF₃, -CF₂H, -CFH₂, a hydroxyl group, a cyano group, a nitro group, a C₁-C₆₀ alkyl group, a C₂-C₆₀ alkenyl group, a C₂-C₆₀ alkynyl group, or a C₁-C₆₀ alkoxy group;
a C₁-C₆₀ alkyl group, a C₂-C₆₀ alkenyl group, a C₂-C₆₀ alkynyl group, or a C₁-C₆₀ alkoxy group, each substituted with deuterium, -F, -CI, -Br, -I, -CD₃, - CD₂H, -CDH₂, -CF₃, -CF₂H, -CFH₂, a hydroxyl group, a cyano group, a nitro group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), - Ge(Q₁₃)(Q₁₄)(Q₁₅), -B(Q₁₆)(Q₁₇), -P(=O)(Q₁₈)(Q₁₉), -P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -CI, -Br, -I, -CD₃, -CD₂H, -CDH₂, -CF₃, -CF₂H, -CFH₂, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q23)(Q24)(Q25), -Ge(Q23)(Q24)(Q25), - B(Q26)(Q27), -P(=O)(Q₂₃)(Q₂₉), -P(Q₂₈)(Q₂₉), or any combination thereof;
-N(Q₃₁)(Q₃₂), -Si(Q33)(Q34)(Q35), -Ge(Q33)(Q34)(Q35), -B(Q36)(Q37), - P(=O)(Q₃₈)(Q₃₉), or -P(Q₃₈)(Q₃₉); or
any combination thereof.
Q₁ to Q9, Q₁₁ to Q19, Q₂₁ to Q29, and Q₃₁ to Q39 in the present specification may each independently be: hydrogen; deuterium; -F; -CI; -Br; -I; a hydroxyl group; a cyano group; a nitro group; or a C₁-C₆₀ alkyl group, a C₂-C₆₀ alkenyl group, a C₂-C₆₀ alkynyl group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, or a monovalent non-aromatic condensed heteropolycyclic group, each unsubstituted or substituted with deuterium, a C₁-C₆₀ alkyl group, a C₆-C₆₀ aryl group, or any combination thereof.

For example, Q₁ to Q9, Q₁₁ to Q₁₉, Q₂₁ to Q29, and Q31 to Q39 described herein may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or any combination thereof.

Hereinafter, a light-emitting device according to embodiments of the disclosure are described in detail with reference to Examples. However, the disclosure is not limited to the following examples.

### Examples

### Synthesis Example 1 (Synthesis of Compound GD-A or Compound 79 of Group 2-3)

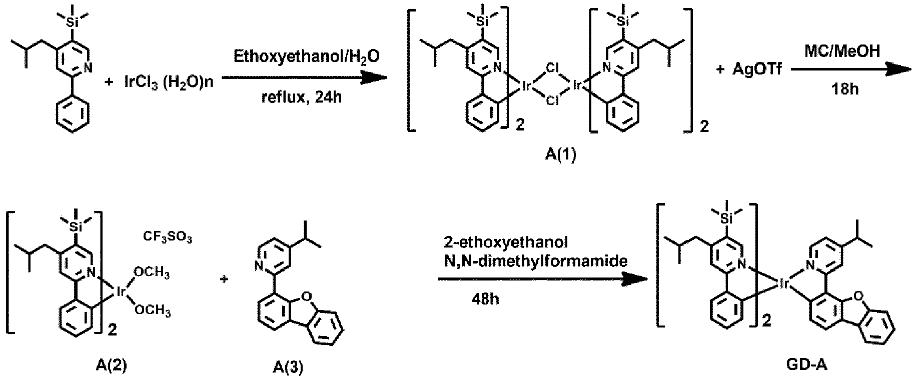

### Synthesis of Compound A(1)

4-isobutyl-2-phenyl-5-(trimethylsilyl)pyridine (8.05 g, 28.4 mmol) and iridium chloride hydrate (4.45 g, 12.6 mmol) were mixed with 120 ml of ethoxyethanol and 40 ml of distilled water and then stirred while refluxing for 24 hours, and then the temperature was lowered to room temperature. The resulting solid was separated by filtration, washed sufficiently with water, methanol, and hexane, in this stated order, and then dried in a vacuum oven to obtain 7.8 g (78 % of yield) of Compound A(1).

### Synthesis of Compound A(2)

Compound A(1) (6.54 g, 4.1 mmol) and 90 ml of methylene chloride (MC) were mixed together, and then, AgOTf (2.12 g, 8.24 mmol) and 30 ml of methanol (MeOH) were mixed together and added thereto. Afterwards, the mixture was stirred for 18 hours at room temperature while light was blocked with aluminum foil, and then filtered through Celite to remove the resulting solid, and the filtrate was subjected to reduced pressure to obtain a solid (Compound A(2)). Compound A(2) was used in the next reaction without an additional purification process.

### Synthesis of Compound GD-A

Compound A(2) (7.25 g, 7.47 mmol) and Compound A(3) (2.36 g, 8.22 mmol) were mixed with 100 ml of 2-ethoxyethanol and N,N-dimethylformamide and then stirred while refluxing for 48 hours, and then the temperature was lowered. The obtained mixture was subjected to a reduced pressure to obtain a solid, on which column chromatography (eluent : methylene chloride (MC) and hexane) was performed to obtain 2.6 g (yield of 33 %) of Compound GD-A.

### HRMS(MALDI) calcd for C₅₆H₆₄IrN₃OSi₂: m/z 1043.4217 Found: 1043.4223

### Synthesis Example 2 (Synthesis of Compound GD-B or Compound 14 of Group 2-4)

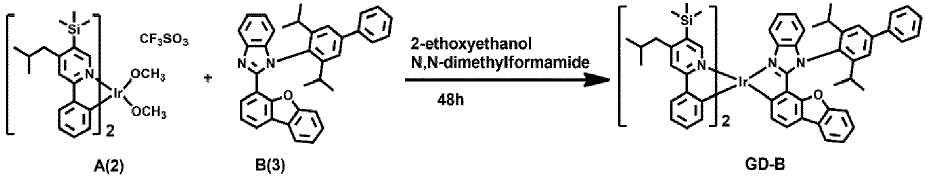

2.5 g (yield of 36 %) of Compound GD-B was obtained in the same manner as used to obtain Compound GD-A of Synthesis Example 1, except that Compound B(3) was used instead of Compound A(3).

### HRMS(MALDI) calcd for C₇₃H₇₉IrN₄OSi₂: m/z 1276.5422 Found: 1276.5418 Evaluation Example 1

On the quartz substrate, compounds shown in Table 1 below were vacuum-codeposited at a vacuum pressure of 10⁻⁷ torr at a weight ratio shown in Table 1 to manufacture films A and B each having a thickness of 40 nm. Compound HT(1) is a compound which is identical to Compound H1-8 of Group 5-2.

Subsequently, an emission spectrum of each of the films A and B was measured using a Quantaurus-QY Absolute PL quantum yield spectrometer of Hamamatsu company (on which a xenon light source, a monochromator, a photonic multichannel analyzer, and an integrating sphere are mounted and which includes PLQY measurement software (Hamamatsu Photonics, Ltd., Shizuoka, Japan). During the measurement, an excitation wavelength was scanned from 320 nm to 380 nm at 10 nm intervals, and a spectrum measured at the excitation wavelength of 320 nm was taken. Emission peak wavelengths of GD-A and GD-B included in the films A and B were evaluated and the results are shown in Table 1 below.

**Table 1**

| Film no. | Film composition (weight ratio) | Emission peak wavelength (nm) |
|---|---|---|
| A | HT(1): E1-62 : GD-A (63 : 27 : 10) | 524 nm |
| B | HT(1) : E1-62 : GD-B (66.5 : 28.5 : 5) | 529 nm |

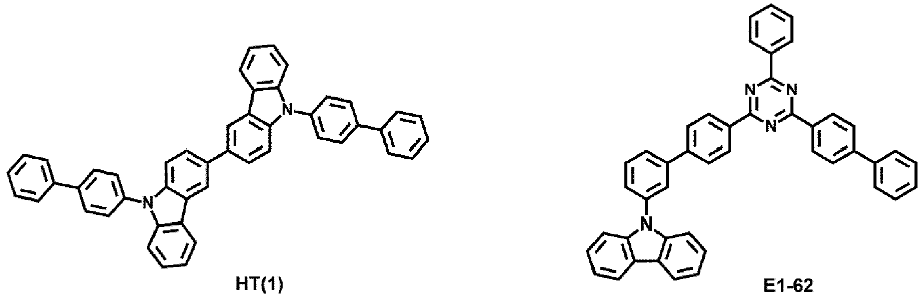

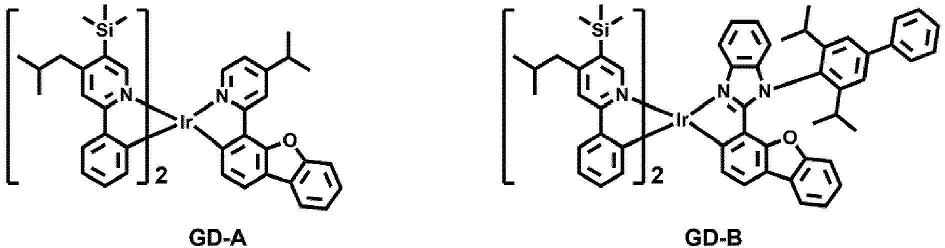

Referring to Table 1, it was confirmed that an emission peak wavelength of GD-A was less than an emission peak wavelength of GD-B.

### Evaluation Example 2

### Manufacture of light-emitting device A

As an anode, an ITO-patterned glass substrate was cut to a size of 50 mm x 50 mm x 0.5 mm, sonicated with isopropyl alcohol and pure water, each for 5 minutes, and then cleaned by irradiation of ultraviolet rays and exposure of ozone thereto for 30 minutes. The resultant glass substrate was loaded onto a vacuum deposition apparatus.

HT3 and F6-TCNNQ were vacuum-codeposited on the anode at a weight ratio of 98 : 2 to form a hole injection layer having a thickness of 10 nm, HT3 was vacuum-deposited on the hole injection layer to form a hole transport layer having a thickness of 135 nm, and HT(1) was vacuum-deposited on the hole transport layer to form an electron blocking layer having a thickness of 30 nm.

Next, compounds shown in Table 2 were co-deposited on the electron blocking layer at a weight ratio shown in Table 2 to form an emission layer EA having a thickness of 40 nm.

Afterwards, ET3 and ET-D1 were co-deposited on the emission layer EA at a volume ratio of 50 : 50 to form an electron transport layer having a thickness of 35 nm, ET-D1 was vacuum-deposited on the electron transport layer to form an electron injection layer having a thickness of 1 nm, and then Al was vacuum-deposited on the electron injection layer to form a cathode having a thickness of 100 nm, thereby completing manufacture of a light-emitting device A.

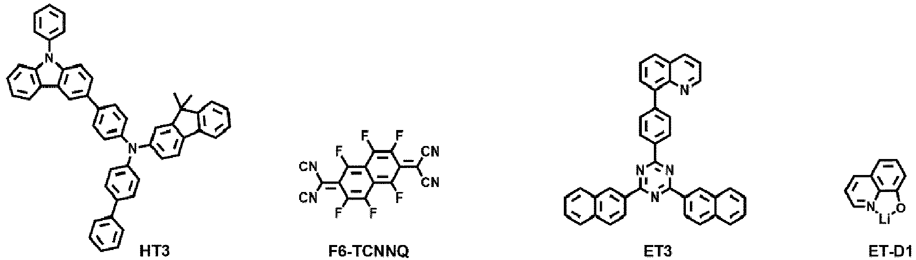

### Manufacture of light-emitting device B

A light-emitting device B was manufactured in the same manner as used to manufacture the light-emitting device A, except that compounds shown in Table 2 were co-deposited on the electron blocking layer at a weight ratio shown in Table 2 to form an emission layer EB having a thickness of 40 nm instead of the emission layer EA.

### Evaluation on current densities of light-emitting devices A and B

Current densities according to voltages of the light-emitting devices A and B were measured in a range of -6 V to 5.5 V using a current-voltage meter (Keithley 2400), and then current densities at 5.5 V were measured and shown in Table 2 below. A graph of a voltage-current density of the light-emitting devices A and B is understood with reference to FIG. 2.

**Table 2**

| Light-em itting device No. | Emission layer composition (weight ratio) | Current density at 5.5 V (mA/cm²) |
|---|---|---|
| A | HT(1) : E1-62 : GD-A (63 : 27 : 10) (composition and weight ratio of emission layer EA) | 26.5 |
| B | HT(1) : E1-62 : GD-B (66.5 : 28.5 : 5) (composition and weight ratio of emission layer EB) | 39.5 |

Referring to Table 2, it may be confirmed that the current density (at 5.5 V) of the light-emitting device B including only the emission layer EB as an emission layer is greater than the current density (at 5.5 V) of the light-emitting device A including only the emission layer EA as an emission layer.

### Manufacture of OLED 1-1

As an anode, a glass substrate with ITO/Ag/ITO deposited thereon to a thickness of 70/1,000/70 Å was cut to a size of 50 mm x 50 mm x 0.5 mm, sonicated with isopropyl alcohol and pure water each for 5 minutes, and then cleaned by irradiation of ultraviolet rays and exposure of ozone thereto for 30 minutes. Then the resultant glass substrate was loaded onto a vacuum deposition apparatus.

HT3 and F6-TCNNQ were vacuum-codeposited on the anode at a weight ratio of 98 : 2 to form a hole injection layer having a thickness of 10 nm, HT3 was vacuum-deposited on the hole injection layer to form a hole transport layer having a thickness of 128 nm, and HT(1) was vacuum-deposited on the hole transport layer to form an electron blocking layer having a thickness of 30 nm.

Next, a dopant (GD-A) and a host (HT(1) and E1-62) were co-deposited on the electron blocking layer to form a first emission layer having a thickness of 15 nm, and a dopant (GD-B) and a host (HT(1) and E1-62) were co-deposited on the first emission layer to form a second emission layer having a thickness of 18 nm, thereby completing manufacture of an emission layer. An amount of the dopant in the first emission layer was 10 parts by weight based on 100 parts by weight of the first emission layer, an amount of the dopant in the second emission layer was 5 parts by weight based on 100 parts by weight of the second emission layer, and a weight ratio of HT(1) and E1-62 in the first emission layer and the second emission layer was 7 : 3.

Afterwards, ET3 and ET-D1 were co-deposited on the emission layer at a volume ratio of 50 : 50 to form an electron transport layer having a thickness of 35 nm, LiF was vacuum-deposited on the electron transport layer to form an electron injection layer having a thickness of 1 nm, and then Mg and Ag were co-deposited on the electron injection layer at a weight ratio of 90 :10 to form a cathode having a thickness of 12 nm, thereby completing manufacture of a light-emitting device.

### Manufacture of OLEDs 1-2 to 1-4

OLEDs 1-2 to 1-4 were manufactured in the same manner as used to manufacture the OLED 1-1, except that the thickness of the hole transport layer was changed as shown in Table 3 below.

**Table 3**

| | | | OLED 1-1 | OLED 1-2 | OLED 1-3 | OLED 1-4 |
|---|---|---|---|---|---|---|
| Cathode | | Composition | Mg : Ag (90 : 10) | | | |
| | | Thickness | 12 nm | | | |
| Emission layer | Second emission layer | Dopant | GD-B | | | |
| | | Amount of dopant | 5 parts by weight based on 100 parts by weight of second emission layer | | | |
| | | Host composition (weight ratio) | HT(1) : E1-62 (7 : 3) | | | |
| | | Thickness | 18 nm | | | |
| | First emission layer | Dopant | GD-A | | | |
| | | Amount of dopant | 10 parts by weight based on 100 parts by weight of first emission layer | | | |
| | | Host composition (weight ratio) | HT(1) : E1-62 (7 : 3) | | | |
| | | Thickness | 15 nm | | | |
| Hole transport layer | | Thickness of hole transport layer | 128 nm | 132 nm | 136 nm | 140 nm |
| Anode (reflective electrode) | | Composition and thickness | ITO / Ag / ITO (70 Å / 1,000 Å / 70 Å ) | | | |

| | | | | | | |
|---|---|---|---|---|---|---|
| Manufacture of OLEDs C1-1 to C1-4 | | | | | | |

OLEDs C1-1 to C1-4 were manufactured in the same manner as used to manufacture the OLEDs 1-1 to 1-4, except that the configuration of the emission layer was changed as shown in Table 4 below.

**Table 4**

| | | OLED C1-1 | OLED C1-2 | OLED C1-3 | OLED C1-4 |
|---|---|---|---|---|---|
| cathode | Composition | Mg : Ag (90 : 10) | | | |
| | Thickness | 12 nm | | | |
| Emission layer | Dopant | GD-A | | | |
| | Amount of dopant | 10 parts by weight based on 100 parts by weight of emission layer | | | |

| | Host composition (weight ratio) | HT(1) : E1-62 (7 : 3) | | | |
|---|---|---|---|---|---|
| | Thickness | 33 nm | | | |
| Hole transport layer | Thickness of hole transport layer | 128 nm | 132 nm | 136 nm | 140 nm |
| Anode (reflective electrode) | Composition and thickness | ITO / Ag / ITO (70 Å / 1,000 Å / 70 Å) | | | |

| | | | | | |
|---|---|---|---|---|---|
| Manufacture of OLEDs C2-1 to C2-4 | | | | | |

OLEDs C2-1 to C2-4 were manufactured in the same manner as used to manufacture the OLEDs 1-1 to 1-4, except that the configuration of the emission layer was changed as shown in Table 5 below.

**Table 5**

| | | OLED C2-1 | OLED C2-2 | OLED C2-3 | OLED C2-4 |
|---|---|---|---|---|---|
| Cathode | Composition | Mg : Ag (90 : 10) | | | |
| | Thickness | 12 nm | | | |
| Emission layer | Dopant | GD-B | | | |
| | Amount of dopant | 5 parts by weight based on 100 parts by weight of emission layer | | | |
| | Host composition (weight ratio) | HT(1) : E1-62 (7 : 3) | | | |
| | Thickness | 33 nm | | | |
| Hole transport layer | Thickness of hole transport layer | 128 nm | 132 nm | 136 nm | 140 nm |
| Anode (reflective electrode) | Composition and thickness | ITO / Ag / ITO (70 Å / 1,000 Å / 70 A) | | | |

| | | | | | |
|---|---|---|---|---|---|
| Manufacture of OLEDs C3-1 to C3-4 | | | | | |

OLEDs C3-1 to C3-4 were manufactured in the same manner as used to manufacture the OLEDs 1-1 to 1-4, except that the configuration of the emission layer was changed as shown in Table 6 below.

**Table 6**

| | | | OLED C3-1 | OLED C3-2 | OLED C3-3 | OLED C3-4 |
|---|---|---|---|---|---|---|
| Cathode | | Composition | Mg : Ag (90 : 10) | | | |
| | | Thickness | 12 nm | | | |
| Emission layer | Second emission layer | Dopant | GD-A | | | |
| | | Amount of dopant | 10 parts by weight based on 100 parts by weight of second emission layer | | | |
| | | Host composition (weight ratio) | HT(1) : E1-62 (7 : 3) | | | |
| | | Thickness | 18 nm | | | |
| | First emission layer | Dopant | GD-B | | | |
| | | Amount of dopant | 5 parts by weight based on 100 parts by weight of first emission layer | | | |
| | | Host composition (weight ratio) | HT(1) : E1-62 (7 : 3) | | | |
| | | Thickness | 15 nm | | | |
| Hole transport layer | | Thickness of hole transport layer | 128 nm | 132 nm | 136 nm | 140 nm |
| Anode (reflective electrode) | | Composition and thickness | ITO / Ag / ITO (70 Å / 1,000 Å / 70 Å ) | | | |

### Evaluation Example 3

For each of the OLEDs 1-1 to 1-4, the OLEDs C1-1 to C1-4, the OLEDs C2-1 to C2-4, and the OLEDs C3-1 to C3-4, an emission peak wavelength (nm) of an electroluminescence (EL) spectrum, x coordinate (CIEx) of CIE color coordinates, and luminescence efficiency (cd/A) (at 15,000 nit) relative to current density were evaluated, and the results are shown in Table 7. As evaluation apparatuses, a current-voltage meter (Keithley 2400) and a luminance meter (Minolta Cs-1000A) were used.

**Table 7**

| | Thickness of hole transport layer (nm) | Emission peak wavelength (nm) of EL spectrum | CIEx | Luminescence efficiency (cd/A @Op.) |
|---|---|---|---|---|
| OLED 1-1 | 128 | 525 | 0.195 | 143.0 |
| OLED 1-2 | 132 | 527 | 0.209 | 153.0 |
| OLED 1-3 | 136 | 529 | 0.232 | 169.3 |
| OLED 1-4 | 140 | 533 | 0.262 | 173.4 |
| OLED C1-1 | 128 | 521 | 0.192 | 107.7 |
| OLED C1-2 | 132 | 523 | 0.205 | 134.0 |
| OLED C1-3 | 136 | 526 | 0.226 | 153.8 |
| OLED C1-4 | 140 | 529 | 0.251 | 165.5 |
| OLED C2-1 | 128 | 527 | 0.213 | 117.6 |
| OLED C2-2 | 132 | 528 | 0.226 | 147.8 |
| OLED C2-3 | 136 | 530 | 0.244 | 172.9 |
| OLED C2-4 | 140 | 532 | 0.265 | 180.0 |
| OLED C3-1 | 128 | 525 | 0.211 | 97.3 |
| OLED C3-2 | 132 | 527 | 0.219 | 122.7 |
| OLED C3-3 | 136 | 528 | 0.232 | 152.4 |
| OLED C3-4 | 140 | 530 | 0.249 | 168.2 |

Next, 1) a CIEx-luminescence efficiency curve (see "curve 1" of FIG. 3) of a light-emitting device including the emission layer of the OLEDs 1-1 to 1-4 (hereinafter, referred to as "OLED 1") was obtained from CIEx and luminescence efficiency data of each of the OLEDs 1-1 to 1-4 of Table 7,
2) a CIEx-luminescence efficiency curve (see "curve C1" of FIG. 3) of a light-emitting device including the emission layer of the OLEDs C1-1 to C1-4 (hereinafter, referred to as "OLED C1") was obtained from CIEx and luminescence efficiency data of each of the OLEDs C1-1 to C1-4 of Table 7,
3) a CIEx-luminescence efficiency curve (see "curve C2" of FIG. 3) of a light-emitting device including the emission layer of the OLEDs C2-1 to C2-4 (hereinafter, referred to as "OLED C2") was obtained from CIEx and luminescence efficiency data of each of the OLEDs C2-1 to C2-4 of Table 7, and
4) a CIEx-luminescence efficiency curve (see "curve C3" of FIG. 3) of a light-emitting device including the emission layer of the OLEDs C3-1 to C3-4 (hereinafter, referred to as "OLED C3") was obtained from CIEx and

luminescence efficiency data of each of the OLEDs C3-1 to C3-4 of Table 7.

Referring to FIG. 3, it may be confirmed that the curve 1 has a gentler curvature than the curves C1 to C3. That is, it may be confirmed that the OLED 1 has a smaller amount of change in luminescence efficiency with respect to the change in CIEx resulting from a change in a resonance distance (e.g., a change in a resonance distance due to a change in a thickness of a hole transport layer) than that that of each of the OLEDs C1 to C3, and thus, a luminescence efficiency deviation according to the change in color coordinates is improved.

Also, referring to FIG. 3, it may be confirmed that the OLED 1 has improved luminescence efficiency in all CIEx ranges compared to the OLED C1.

The light-emitting device according to embodiments of the disclosure has excellent luminescence efficiency sensitivity according to emission color, excellent luminescence efficiency, and an excellent side luminance ratio. Accordingly, a high-quality electronic apparatus may be manufactured using the light-emitting device.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A light-emitting device comprising:
a first electrode;
a second electrode facing the first electrode; and
an emission layer between the first electrode and the second electrode, wherein
the first electrode is a reflective electrode,
the emission layer comprises: i) a first emission layer, and ii) a second emission layer between the first emission layer and the second electrode,
the first emission layer comprises a first compound capable of emitting a first light having a first spectrum, and λP(1) is an emission peak wavelength in nm of the first spectrum,
the second emission layer comprises a second compound capable of emitting a second light having a second spectrum, and λP(2) is an emission peak wavelength in nm of the second spectrum,
the emission layer emits a third light having a third spectrum, and λP(3) is an emission peak wavelength in nm of the third spectrum,
λP(1) is less than λP(2),
|λP(1) - λP(2)| is greater than 0 nm and less than or equal to 30 nm,
each of |λP(2) - λP(3)| and |λP(3) - λP(1)| is greater than or equal to 0 nm and less than or equal to 30 nm,
λP(1) and λP(2) are evaluated from photoluminescence spectra measured for a first film and a second film, respectively,
the first film comprises a first compound,
the second film comprises a second compound, and
λP(3) is evaluated from an electroluminescence spectrum of the light-emitting device.

2. The light-emitting device of claim 1, wherein the third light is extracted to outside through the second electrode; and/or
wherein the second electrode is a transparent electrode or a semi-transparent electrode; and/or
wherein the first electrode is an anode, and the second electrode is a cathode.

3. The light-emitting device of claims 1 or 2, wherein |λP(1) - λP(2)| is greater than 0 nm and less than or equal to 10 nm; and/or
wherein each of |λP(2) - λP(3)| and |λP(3) - λP(1)| is greater than or equal to 0 nm and less than or equal to 15 nm.

4. The light-emitting device of any of claims 1-3, wherein
i) λP(1) < λP(2) ≤ λP(3),
ii) λP(1) ≤ λP(3) < λP(2),
iii) λP(1) < λP(3) ≤ λP(2), or
iv) λP(3) ≤ λP(1) < λP(2).

5. The light-emitting device of any of claims 1-4, wherein each of λP(1), λP(2), and λP(3) is 500 nm to 570 nm.

6. The light-emitting device of any of claims 1-5, wherein i) λP(1) is 510 nm to 530 nm, λP(2) is 520 nm to 540 nm, and λP(3) is 500 nm to 540 nm, or ii) λP(1) is 540 nm to 560 nm, λP(2) is 550 nm to 570 nm, and λP(3) is 540 nm to 570 nm.

7. The light-emitting device of any of claims 1-6, wherein each of λP(1), λP(2), and λP(3) is 570 nm to 650 nm.

8. The light-emitting device of any of claims 1-7, wherein λP(1) is 570 nm to 630 nm, λP(2) is 620 nm to 650 nm, and λP(3) is 570 nm to 650 nm.

9. The light-emitting device of any of claims 1-8, wherein each of λP(1), λP(2), and λP(3) is 400 nm to 500 nm.

10. The light-emitting device of any of claims 1-9, wherein λP(1) is 430 nm to 480 nm, λP(2) is 470 nm to 500 nm, and λP(3) is 400 nm to 500 nm.

11. The light-emitting device of any of claims 1-10, wherein Condition A is satisfied:
Condition A
CD(1) < CD(2)
wherein, in Condition A,
CD(1) is a current density in mA/cm² of the first light-emitting device,
CD(2) is a current density in mA/cm² of the second light-emitting device,
CD(1) and CD(2) are evaluated by measuring current densities of the first light-emitting device and the second light-emitting device under the same voltage,
the first light-emitting device comprises:
a first electrode;
a second electrode facing the first electrode; and
an emission layer E1 between the first electrode and the second electrode,
the emission layer E1 of the first light-emitting device comprises a first emission layer,
the emission layer E1 of the first light-emitting device does not comprise a second emission layer,
the second light-emitting device comprises:
a first electrode;
a second electrode facing the first electrode, and
an emission layer E2 between the first electrode and the second electrode,
the emission layer E2 of the second light-emitting device does not comprise a first emission layer,
the emission layer E2 of the second light-emitting device comprises a second emission layer, and
a structure of the first light-emitting device excluding the emission layer E1 and a structure of the second light-emitting device excluding the emission layer E2 are identical to each other.

12. The light-emitting device of any of claims 1-11, wherein the third spectrum comprises a main emission peak having λP(3), and
the third spectrum does not comprise an additional emission peak having an emission peak wavelength of λP(3) + 50 nm or more or λP(3) - 50 nm or less.

13. The light-emitting device of any of claims 1-12, wherein the first compound is an organometallic compound comprising a transition metal; and/or
wherein the second compound is an organometallic compound comprising a transition metal; and/or
wherein the light-emitting device further comprises a hole transport region between the first electrode and the emission layer and an electron transport region between the emission layer and the second electrode.

14. The light-emitting device of any of claims 1-13, wherein the first emission layer comprises a first dopant and a first host,
the second emission layer comprises a second dopant and a second host,
the first dopant comprises the first compound, and
the second dopant comprises the second compound.

15. An electronic apparatus comprising the light-emitting device of any of claims 1-14.
